# EUROPEAN PATENT APPLICATION

(11) **EP 4 671 254 A1**
(43) Date of publication of application: **31.12.2025**
(21) Application number: 24874817.0
(22) Date of filing: 24.05.2024
(51) Int. Cl.: C07F 7/08, C07F 5/02, H10K 85/60, H10K 85/40, H10K 50/11, H10K 50/18

(54) **COMPOUND AND ORGANIC LIGHT-EMITTING ELEMENT COMPRISING SAME**

(30) Priority: 06.10.2023 KR 20230133061; 10.05.2024 KR 20240061695
(71) Applicant: LG Chem, Ltd., Yeongdeungpo-gu Seoul 07336 (KR)
(72) Inventor: KIM, Moung Gon, Daejeon 34122 (KR); KIM, Kyunghee, Daejeon 34122 (KR); LEE, Woochul, Daejeon 34122 (KR); CHA, Yongbum, Daejeon 34122 (KR); HWANG, Sunghyun, Daejeon 34122 (KR)
(74) Representative: Hoffmann Eitle
(86) International application number: PCT/KR2024/007094
(87) International publication number: WO 2025/075258

(57) **Abstract**

The present specification provides a compound represented by Chemical Formula 1, in which at least one of three benzene rings directly or indirectly linked to boron is substituted with at least one carbazole group and at least one of an aryl group, a silyl group, or a heterocyclic group, and an organic light emitting device including the compound.

## Description

### [Technical Field]

This application claims priority to and the benefit of Korean Patent Application Nos. 10-2023-0133061 and 10-2024-0061695 filed in the Korean Intellectual Property Office on October 6, 2023 and May 10, 2024, respectively, the entire contents of which are incorporated herein by reference.

The present specification relates to a compound and an organic light emitting device including the same.

### [Background Art]

An organic light emission phenomenon generally refers to a phenomenon converting electrical energy to light energy using an organic material. An organic light emitting device using an organic light emission phenomenon normally has a structure including a positive electrode, a negative electrode, and an organic material layer therebetween. Here, the organic material layer has in many cases a multi-layered structure composed of different materials in order to improve the efficiency and stability of the organic light emitting device, and for example, may be composed of a hole injection layer, a hole transport layer, a light emitting layer, an electron transport layer, an electron injection layer, and the like. In such a structure of the organic light emitting device, if a voltage is applied between the two electrodes, holes are injected from the positive electrode into the organic material layer and electrons are injected from the negative electrode into the organic material layer, and when the injected holes and electrons meet each other, an exciton is formed, and light is emitted when the exciton falls down again to a ground state.

There is a continuous need for developing a new material for the aforementioned organic light emitting device.

### [Detailed Description of the Invention]

### [Technical Problem]

The present specification provides a compound and an organic light emitting device including the same.

### [Technical Solution]

An exemplary embodiment of the present specification provides a compound represented by the following Chemical Formula 1.

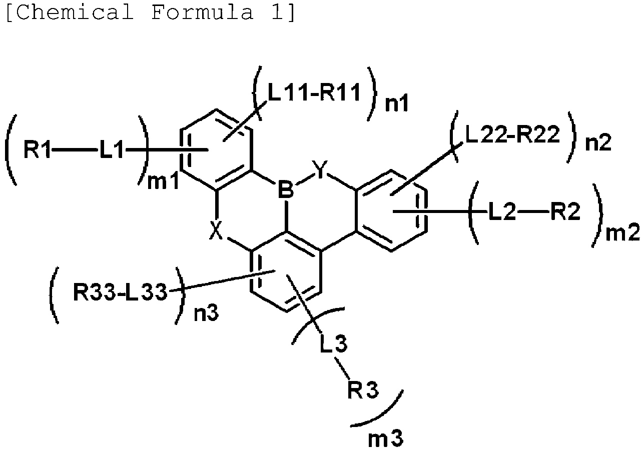

In Chemical Formula 1,
X is NR; or S,
Y is NR'; O; or S,
R and R' are the same as or different from each other, and are each independently hydrogen; deuterium; a substituted or unsubstituted alkyl group; a substituted or unsubstituted silyl group; or a substituted or unsubstituted aryl group,
L1 to L3 and L11 to L33 are the same as or different from each other, and are each independently a direct bond; a substituted or unsubstituted arylene group; or a substituted or unsubstituted divalent heterocyclic group,
R1 to R3 and R11 to R33 are the same as or different from each other, and are each independently hydrogen; deuterium; a halogen group; a nitrile group; a substituted or unsubstituted silyl group; a substituted or unsubstituted alkyl group; a substituted or unsubstituted cycloalkyl group; a substituted or unsubstituted aryl group; or a substituted or unsubstituted heterocyclic group,
at least one of R1 to R3 is a substituted or unsubstituted carbazole group,
at least one of R11 to R33 is a substituted or unsubstituted silyl group; a substituted or unsubstituted aryl group; or a substituted or unsubstituted heterocyclic group,
n1, n2, m1, and m2 are each an integer from 1 to 4,
n3 and m3 are each an integer from 1 to 3,
when n1 to n3 and m1 to m3 are each 2 or higher, substituents in the parenthesis are each the same as or different from each other, and
n1+m1 is 4 or less, n2+m2 is 4 or less, and n3+m3 is 3 or less.

Further, an exemplary embodiment of the present specification provides an organic light emitting device including a first electrode; a second electrode; and an organic material layer having one or more layers provided between the first electrode and the second electrode, in which one or more layers of the organic material layer include the compound represented by Chemical Formula 1.

### [Advantageous Effects]

The compound described in the present specification can be used as a material for an organic material layer of an organic light emitting device. The compound according to at least one exemplary embodiment of the present specification may improve the efficiency, achieve low driving voltage and/or improve service life characteristics in the organic light emitting device. In particular, the compound described in the present specification may be used as a material for light emission or hole blocking.

### [Brief Description of Drawings]

FIG. 1 illustrates an example of an organic light emitting device in which a substrate 1, a first electrode 2, a light emitting layer 6, and a second electrode 9 are sequentially stacked.
FIG. 2 illustrates an example of an organic light emitting device in which a substrate 1, a first electrode 2, a hole injection layer 3, a hole transport layer 4, an electron blocking layer 5, a light emitting layer 6, a hole blocking layer 7, an electron injection and transport layer 8, and a second electrode 9 are sequentially stacked.

### [Best Mode]

Hereinafter, the present specification will be described in more detail.

When one part "includes" one constituent element in the present specification, unless otherwise specifically described, this does not mean that another constituent element is excluded, but means that another constituent element may be further included.

When one member is disposed "on" another member in the present specification, this includes not only a case where the one member is brought into contact with another member, but also a case where still another member is present between the two members.

In the present specification, " 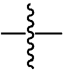 " or a dotted line means a position bonded to a chemical formula or a compound.

In the present specification, N% substitution with deuterium means that N% of hydrogen available in the corresponding structure is substituted with deuterium. For example, 25% substitution of dibenzofuran with deuterium means that two of eight hydrogens of dibenzofuran are substituted with deuteriums.

In the present specification, the degree of deuteration may be confirmed by a publicly-known method such as nuclear magnetic resonance spectroscopy (1H NMR) or GC/MS.

Examples of the substituents in the present specification will be described below, but are not limited thereto.

The term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more are substituted, the two or more substituents may be the same as or different from each other.

In the present specification, the term "substituted or unsubstituted" means being substituted with one or two or more substituents selected from the group consisting of deuterium; a halogen group; a nitrile group; a silyl group; an alkyl group; a cycloalkyl group; an arylalkyl group; an aryl group; and a heterocyclic group, being substituted with a substituent to which two or more substituents among the exemplified substituents are linked, or having no substituent.

In the present specification, the term "substituted or unsubstituted" means being substituted with one or two or more substituents selected from the group consisting of deuterium; a silyl group; an alkyl group; an aryl group; and a heterocyclic group, being substituted with a substituent to which two or more substituents among the exemplified substituents are linked, or having no substituent.

Examples of the substituents will be described below; however, the substituents are not limited thereto.

In the present specification, examples of a halogen group include fluorine (-F), chlorine (-Cl), bromine (-Br) or iodine (-I).

In the present specification, a silyl group may be represented by a chemical formula of -SiYₐY_{b}Y_{c}, and the Yₐ, Y_{b}, and Y_{c} may be each hydrogen; a substituted or unsubstituted alkyl group; or a substituted or unsubstituted aryl group. Specific examples of the silyl group include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and the like, but are not limited thereto.

In the present specification, the alkyl group may be straight-chained or branched, and the number of carbon atoms thereof is not particularly limited, but is preferably 1 to 60. According to an exemplary embodiment, the number of carbon atoms of the alkyl group is 1 to 30. According to another exemplary embodiment, the number of carbon atoms of the alkyl group is 1 to 20. According to still another exemplary embodiment, the number of carbon atoms of the alkyl group is 1 to 10. Specific examples of the alkyl group include a methyl group, an ethyl group, a propyl group, an n-propyl group, an isopropyl group, a butyl group, an n-butyl group, an isobutyl group, a tert-butyl group, a pentyl group, an n-pentyl group, a hexyl group, an n-hexyl group, a heptyl group, an n-heptyl group, an octyl group, an n-octyl group, and the like, but are not limited thereto.

In the present specification, the above-described description on the alkyl group may be applied to an arylalkyl group, except that the arylalkyl group is substituted with an aryl group.

Substituents including an alkyl group and other alkyl group moieties described in the present specification include both a straight-chained form and a branched form.

In the present specification, a cycloalkyl group is not particularly limited, but has preferably 3 to 60 carbon atoms, and according to an exemplary embodiment, the number of carbon atoms of the cycloalkyl group is 3 to 30. According to another exemplary embodiment, the number of carbon atoms of the cycloalkyl group is 3 to 20. According to another embodiment, the number of carbon atoms of the cycloalkyl group is from 3 to 6. Specific examples thereof may include a cyclopropyl group, a cyclobutyl group, a cyclopentyl group, a cyclohexyl group, a cycloheptyl group, a cyclooctyl group and the like, but are not limited thereto.

In the present specification, an aryl group is not particularly limited, but has preferably 6 to 60 carbon atoms. According to an exemplary embodiment, the number of carbon atoms of the aryl group is from 6 to 30. According to an exemplary embodiment, the number of carbon atoms of the aryl group is from 6 to 20. The aryl group may be an aryl group composed of a single ring or a polycyclic aryl group (a bicyclic or more aryl group). The aryl group composed of the single ring may also be represented by a monocyclic aryl group, and may mean a phenyl group; or a group to which two or more phenyl groups are linked. Examples of the aryl group composed of the single ring include a phenyl group, a biphenyl group, a terphenyl group, a quarterphenyl group, and the like, but are not limited thereto. The polycyclic aryl group may mean a group in which two or more monocyclic rings such as a naphthyl group and a phenanthrenyl group are fused. Examples of the polycyclic aryl group include a naphthyl group, an anthracenyl group, a phenanthrenyl group, a pyrenyl group, a perylenyl group, a chrysenyl group, a fluorenyl group, a triphenylenyl group, and the like, but are not limited thereto.

In the present specification, a fluorenyl group may be substituted, and two substituents may be bonded to each other to form a spiro structure. In this case, the spiro structure may be an aromatic hydrocarbon ring or an aliphatic hydrocarbon ring.

When the fluorenyl group is substituted, the substituent may be a spirofluorenyl group such as 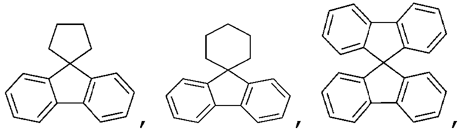 and a substituted fluorenyl group such as 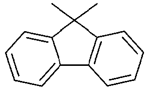 (a 9,9-dimethylfluorenyl group), and 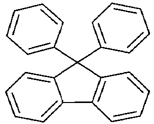 (a 9,9-diphenylfluorenyl group). However, the fluorenyl group is not limited thereto.

In the present specification, a heterocyclic group is a cyclic group including one or more of N, O, P, S, Si, and Se as a heteroatom, and the number of carbon atoms thereof is not particularly limited, but is preferably 2 to 60. According to one embodiment, the number of carbon atoms of the heterocyclic group is from 2 to 30. According to one embodiment, the number of carbon atoms of the heterocyclic group is from 2 to 20. Examples of the heterocyclic group include a pyridine group, a pyrrole group, a pyrimidine group, a quinoline group, a pyridazinyl group, a furan group, a thiophene group, an imidazole group, a pyrazole group, a dibenzofuran group, a dibenzothiophene group, a carbazole group, a benzocarbazole group, a naphthobenzofuran group, a benzonaphthothiophene group, an indenocarbazole group, a triazinyl group, and the like, but are not limited thereto.

In the present specification, the above-described description on the heterocyclic group may be applied to a heteroaryl group except for an aromatic heteroaryl group.
In the present specification, the description on the aryl group may be applied to an arylene group except for a divalent arylene group.

In the present specification, the description on the heterocyclic group may be applied to a divalent heterocyclic group except for a divalent heterocyclic group.

In the present specification, in a substituted or unsubstituted ring formed by bonding adjacent groups, the "ring" means a hydrocarbon ring; or a hetero ring.

In the present specification, the term "a ring fused with N rings" means a ring fused with N monocyclic rings, where the monocyclic ring may be a pentagonal or hexagonal ring, and N is an integer of 1 or higher. Examples of the ring fused with N rings include diazanaphthalene, indole, indolizine, benzothiazole, benzoxazole, benzimidazole, benzothiophene, benzofuran, dibenzothiophene, dibenzofuran, carbazole, benzocarbazole, dibenzocarbazole, imidazopyridine, phenoxazine, indolocarbazole, indenocarbazole, and the like, but are not limited thereto.

The hydrocarbon ring may be an aromatic ring, an aliphatic ring, or a fused ring of the aromatic ring and the aliphatic ring, and may be selected from the examples of the cycloalkyl group or the aryl group.

In the present specification, being bonded to an adjacent group to form a ring means being bonded to an adjacent group to form a substituted or unsubstituted aliphatic hydrocarbon ring; a substituted or unsubstituted aromatic hydrocarbon ring; a substituted or unsubstituted aliphatic hetero ring; a substituted or unsubstituted aromatic hetero ring; or a fused ring thereof. The hydrocarbon ring means a ring composed only of carbon and hydrogen atoms. The hetero ring means a ring including one or more selected from elements such as N, O, P, S, Si and Se. In the present specification, the aliphatic hydrocarbon ring, the aromatic hydrocarbon ring, the aliphatic hetero ring, and the aromatic hetero ring may be monocyclic or polycyclic.

In the present specification, the aliphatic hydrocarbon ring means a ring composed only of carbon and hydrogen atoms as a nonaromatic ring. Examples of the aliphatic hydrocarbon ring include cyclopropane, cyclobutane, cyclobutene, cyclopentane, cyclopentene, cyclohexane, cyclohexene, 1,4-cyclohexadiene, cycloheptane, cycloheptene, cyclooctane, cyclooctene, and the like, but are not limited thereto.

In the present specification, an aromatic hydrocarbon ring means an aromatic ring composed only of carbon and hydrogen atoms. Examples of the aromatic hydrocarbon ring include benzene, naphthalene, anthracene, phenanthrene, perylene, fluoranthene, triphenylene, phenalene, pyrene, tetracene, chrysene, pentacene, fluorene, indene, acenaphthylene, benzofluorene, spirofluorene, and the like, but are not limited thereto. In the present specification, the aromatic hydrocarbon ring may be interpreted to have the same meaning as the aryl group.

In the present specification, an aliphatic hetero ring means an aliphatic ring including one or more of hetero atoms. Examples of the aliphatic hetero ring include oxirane, tetrahydrofuran, 1,4-dioxane, pyrrolidine, piperidine, morpholine, oxepane, azocane, thiocane, and the like, but are not limited thereto.

In the present specification, an aromatic hetero ring means an aromatic ring including one or more of hetero atoms. Examples of the aromatic hetero ring include pyridine, pyrrole, pyrimidine, pyridazine, furan, thiophene, imidazole, pyrazole, oxazole, isoxazole, thiazole, isothiazole, triazole, oxadiazole, thiadiazole, dithiazole, tetrazole, pyran, thiopyran, diazine, oxazine, thiazine, dioxine, triazine, tetrazine, isoquinoline, quinoline, quinone, quinazoline, quinoxaline, naphthyridine, acridine, phenanthridine, diaza naphthalene, triazaindene, indole, indolizine, benzothiazole, benzoxazole, benzoimidazole, benzothiophene, benzofuran, dibenzothiophene, dibenzofuran, carbazole, benzocarbazole, dibenzocarbazole, phenazine, imidazopyridine, phenoxazine, indolocarbazole, indenocarbazole, and the like, but are not limited thereto.

Hereinafter, preferred exemplary embodiments of the present invention will be described in detail. However, the exemplary embodiments of the present invention may be modified into various other forms, and the scope of the present invention is not limited to the exemplary embodiments which will be described below.

Chemical Formula 1 of the present invention is characterized in that at least one of the benzene rings included in a core structure is substituted with a carbazole group, and at least one of the other benzene rings may be substituted with a silyl group, an aryl group, or a heterocyclic group to stabilize the unstable structure and add hole characteristics, and when the compound represented by Chemical Formula 1 is applied to an organic light emitting device, an organic light emitting device having high efficiency, low voltage and/or long service life characteristics may be obtained.

Hereinafter, Chemical Formula 1 will be described in detail.

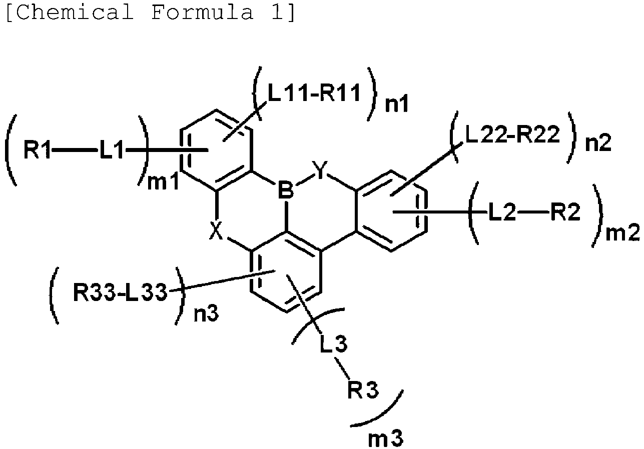

In Chemical Formula 1,
X is NR; or S,
Y is NR'; O; or S,
R and R' are the same as or different from each other, and are each independently hydrogen; deuterium; a substituted or unsubstituted alkyl group; a substituted or unsubstituted silyl group; or a substituted or unsubstituted aryl group,
L1 to L3 and L11 to L33 are the same as or different from each other, and are each independently a direct bond; a substituted or unsubstituted arylene group; or a substituted or unsubstituted divalent heterocyclic group,
R1 to R3 and R11 to R33 are the same as or different from each other, and are each independently hydrogen; deuterium; a halogen group; a nitrile group; a substituted or unsubstituted silyl group; a substituted or unsubstituted alkyl group; a substituted or unsubstituted cycloalkyl group; a substituted or unsubstituted aryl group; or a substituted or unsubstituted heterocyclic group,
at least one of R1 to R3 is a substituted or unsubstituted carbazole group,
at least one of R11 to R33 is a substituted or unsubstituted silyl group; a substituted or unsubstituted aryl group; or a substituted or unsubstituted heterocyclic group,
n1, n2, m1, and m2 are each an integer from 1 to 4,
n3 and m3 are each an integer from 1 to 3,
when n1 to n3 and m1 to m3 are each 2 or higher, substituents in the parenthesis are each the same as or different from each other, and
n1+m1 is 4 or less, n2+m2 is 4 or less, and n3+m3 is 3 or less.

In an exemplary embodiment of the present specification, X is NR, and Y is NR'.

In an exemplary embodiment of the present specification, X is NR, and Y is O.

In an exemplary embodiment of the present specification, X is NR, and Y is S.

In an exemplary embodiment of the present specification, X is S, and Y is NR'.

In an exemplary embodiment of the present specification, X is S, and Y is O.

In an exemplary embodiment of the present specification, X is S, and Y is S.

In an exemplary embodiment of the present specification, R and R' are the same as or different from each other, and are each independently hydrogen; deuterium; a substituted or unsubstituted alkyl group having 1 to 30 carbon atoms; a substituted or unsubstituted alkylsilyl group having 1 to 30 carbon atoms; a substituted or unsubstituted arylsilyl group having 6 to 30 carbon atoms; or a substituted or unsubstituted aryl group having 6 to 30 carbon atoms.

In an exemplary embodiment of the present specification, R and R' are the same as or different from each other, and are each independently hydrogen; deuterium; a substituted or unsubstituted alkyl group having 1 to 20 carbon atoms; a substituted or unsubstituted alkylsilyl group having 1 to 20 carbon atoms; a substituted or unsubstituted arylsilyl group having 6 to 20 carbon atoms; or a substituted or unsubstituted aryl group having 6 to 20 carbon atoms.

In an exemplary embodiment of the present specification, R and R' are the same as or different from each other, and are each independently hydrogen; deuterium; a substituted or unsubstituted alkyl group having 1 to 10 carbon atoms; or a substituted or unsubstituted aryl group having 6 to 12 carbon atoms.

In an exemplary embodiment of the present specification, R and R' are the same as or different from each other, and are each independently hydrogen; deuterium; a substituted or unsubstituted methyl group; a substituted or unsubstituted ethyl group; a substituted or unsubstituted propyl group; a substituted or unsubstituted butyl group; a substituted or unsubstituted phenyl group; a substituted or unsubstituted biphenyl group; a substituted or unsubstituted terphenyl group; or a substituted or unsubstituted naphthyl group.

In an exemplary embodiment of the present specification, R and R' are the same as or different from each other, and are each independently hydrogen; deuterium; or a substituted or unsubstituted phenyl group.

In an exemplary embodiment of the present specification, R and R' are the same as or different from each other, and are each independently hydrogen; deuterium; an alkyl group having 1 to 10 carbon atoms, which is unsubstituted or substituted with deuterium; or an aryl group having 6 to 12 carbon atoms, which is unsubstituted or substituted with deuterium.

In an exemplary embodiment of the present specification, R and R' are the same as or different from each other, and are each independently hydrogen; deuterium; a butyl group unsubstituted or substituted with deuterium; a phenyl group unsubstituted or substituted with deuterium; a substituted or unsubstituted biphenyl group; or a substituted or unsubstituted naphthyl group.

In an exemplary embodiment of the present specification, R and R' are the same as or different from each other, and are each independently hydrogen; deuterium; or a phenyl group unsubstituted or substituted with deuterium.

In an exemplary embodiment of the present specification, R and R' are the same as or different from each other, and are each independently hydrogen; deuterium; or a phenyl group.

In an exemplary embodiment of the present specification, R and R' are the same as or different from each other, and are each independently hydrogen; or a phenyl group.

In an exemplary embodiment of the present specification, R and R' are the same as or different from each other, and are each independently a phenyl group; or a phenyl group substituted with deuterium.

In an exemplary embodiment of the present specification, L1 to L3 and L11 to L33 are the same as or different from each other, and are each independently a direct bond; an arylene group; or a divalent heterocyclic group.

In an exemplary embodiment of the present specification, L1 to L3 and L11 to L33 are the same as or different from each other, and are each independently a direct bond; a substituted or unsubstituted arylene group having 6 to 30 carbon atoms; or a substituted or unsubstituted divalent heterocyclic group having 2 to 30 carbon atoms.

In an exemplary embodiment of the present specification, L1 to L3 and L11 to L33 are the same as or different from each other, and are each independently a direct bond; a substituted or unsubstituted arylene group having 6 to 20 carbon atoms; or a substituted or unsubstituted divalent heterocyclic group having 2 to 20 carbon atoms.

In an exemplary embodiment of the present specification, L1 to L3 and L11 to L33 are the same as or different from each other, and are each independently a direct bond; a substituted or unsubstituted arylene group having 6 to 30 carbon atoms; or a substituted or unsubstituted divalent heterocyclic group having 2 to 30 carbon atoms, which includes one or more of N, O, S, and Si as a heteroatom.

In an exemplary embodiment of the present specification, L1 to L3 and L11 to L33 are the same as or different from each other, and are each independently a direct bond; a substituted or unsubstituted arylene group having 6 to 20 carbon atoms; or a substituted or unsubstituted divalent heterocyclic group having 2 to 20 carbon atoms, which includes one or more of N, O, and S as a heteroatom.

In an exemplary embodiment of the present specification, L1 to L3 and L11 to L33 are the same as or different from each other, and are each independently a direct bond; a substituted or unsubstituted phenylene group; a substituted or unsubstituted biphenylene group; a substituted or unsubstituted naphthalene group; a substituted or unsubstituted divalent dibenzofuran group; a substituted or unsubstituted divalent dibenzothiophene group; or a substituted or unsubstituted divalent carbazole group.

In an exemplary embodiment of the present specification, L1 to L3 and L11 to L33 are the same as or different from each other, and are each independently a direct bond; a substituted or unsubstituted phenylene group; a substituted or unsubstituted divalent dibenzofuran group; or a substituted or unsubstituted divalent carbazole group.

In an exemplary embodiment of the present specification, L1 to L3 and L11 to L33 are the same as or different from each other, and are each independently a direct bond; an arylene group having 6 to 20 carbon atoms, which is unsubstituted or substituted with deuterium; or a divalent heterocyclic group having 2 to 20 carbon atoms, which is unsubstituted or substituted with deuterium.

In an exemplary embodiment of the present specification, L1 to L3 and L11 to L33 are the same as or different from each other, and are each independently a direct bond; an arylene group having 6 to 20 carbon atoms, which is unsubstituted or substituted with deuterium; or a divalent heterocyclic group having 2 to 20 carbon atoms, which includes one or more of N, O, and S as a heteroatom and is unsubstituted or substituted with deuterium.

In an exemplary embodiment of the present specification, L1 to L3 and L11 to L33 are the same as or different from each other, and are each independently a direct bond; a phenylene group unsubstituted or substituted with deuterium; a biphenylene group unsubstituted or substituted with deuterium; a naphthalene group unsubstituted or substituted with deuterium; a divalent dibenzofuran group unsubstituted or substituted with deuterium; a divalent dibenzothiophene group unsubstituted or substituted with deuterium; or a divalent carbazole group unsubstituted or substituted with deuterium.

In an exemplary embodiment of the present specification, L1 to L3 and L11 to L33 are the same as or different from each other, and are each independently a direct bond; a phenylene group unsubstituted or substituted with deuterium; a divalent dibenzofuran group unsubstituted or substituted with deuterium; or a divalent carbazole group unsubstituted or substituted with deuterium.

In an exemplary embodiment of the present specification, L1 to L3 and L11 to L33 are the same as or different from each other, and are each independently a direct bond; a phenylene group; a divalent dibenzofuran group; or a divalent carbazole group.

In an exemplary embodiment of the present specification, L1 to L3 are the same as or different from each other, and are each independently a direct bond; a substituted or unsubstituted phenylene group; a substituted or unsubstituted divalent dibenzofuran group; a substituted or unsubstituted divalent dibenzothiophene group; or a substituted or unsubstituted divalent carbazole group.

In an exemplary embodiment of the present specification, L1 to L3 are the same as or different from each other, and are each independently a direct bond; a substituted or unsubstituted phenylene group; or a substituted or unsubstituted divalent carbazole group.

In an exemplary embodiment of the present specification, L1 to L3 are the same as or different from each other, and are each independently a direct bond; a phenylene group unsubstituted or substituted with deuterium; a divalent dibenzofuran group unsubstituted or substituted with deuterium; a divalent dibenzothiophene group unsubstituted or substituted with deuterium; or a divalent carbazole group unsubstituted or substituted with deuterium.

In an exemplary embodiment of the present specification, L1 to L3 are the same as or different from each other, and are each independently a direct bond; a phenylene group unsubstituted or substituted with deuterium; or a divalent carbazole group unsubstituted or substituted with deuterium.

In an exemplary embodiment of the present specification, L1 to L3 are the same as or different from each other, and are each independently a direct bond; a phenylene group; a divalent dibenzofuran group; a divalent dibenzothiophene group; or a divalent carbazole group.

In an exemplary embodiment of the present specification, L1 to L3 are the same as or different from each other, and are each independently a direct bond; a phenylene group; or a divalent carbazole group.

In an exemplary embodiment of the present specification, L11 to L33 are the same as or different from each other, and are each independently a direct bond; a substituted or unsubstituted phenylene group; or a substituted or unsubstituted divalent carbazole group.

In an exemplary embodiment of the present specification, L11 to L33 are the same as or different from each other, and are each independently a direct bond; or a substituted or unsubstituted phenylene group.

In an exemplary embodiment of the present specification, L11 to L33 are the same as or different from each other, and are each independently a direct bond; a phenylene group unsubstituted or substituted with deuterium; or a divalent carbazole group unsubstituted or substituted with deuterium.

In an exemplary embodiment of the present specification, L11 to L33 are the same as or different from each other, and are each independently a direct bond; or a phenylene group unsubstituted or substituted with deuterium.

In an exemplary embodiment of the present specification, L11 to L33 are the same as or different from each other, and are each independently a direct bond; a phenylene group; or a divalent carbazole group.

In an exemplary embodiment of the present specification, L11 to L33 are the same as or different from each other, and are each independently a direct bond; or a phenylene group.

In an exemplary embodiment of the present specification, R1 to R3 and R11 to R33 are the same as or different from each other, and are each independently hydrogen; deuterium; a halogen group; a nitrile group; a substituted or unsubstituted silyl group; a substituted or unsubstituted alkyl group having 1 to 30 carbon atoms; a substituted or unsubstituted cycloalkyl group having 3 to 30 carbon atoms; a substituted or unsubstituted aryl group having 6 to 30 carbon atoms; or a substituted or unsubstituted heterocyclic group having 2 to 30 carbon atoms, at least one of R1 to R3 is a substituted or unsubstituted carbazole group, and at least one of R11 to R33 is a substituted or unsubstituted silyl group; a substituted or unsubstituted aryl group having 6 to 30 carbon atoms; or a substituted or unsubstituted heterocyclic group having 2 to 30 carbon atoms.

In an exemplary embodiment of the present specification, R1 to R3 and R11 to R33 are the same as or different from each other, and are each independently hydrogen; deuterium; a halogen group; a nitrile group; a substituted or unsubstituted alkylsilyl group having 1 to 20 carbon atoms; a substituted or unsubstituted arylsilyl group having 6 to 20 carbon atoms; a substituted or unsubstituted alkyl group having 1 to 20 carbon atoms; a substituted or unsubstituted cycloalkyl group having 3 to 20 carbon atoms; a substituted or unsubstituted aryl group having 6 to 20 carbon atoms; or a substituted or unsubstituted heterocyclic group having 2 to 30 carbon atoms, at least one of R1 to R3 is a substituted or unsubstituted carbazole group, and at least one of R11 to R33 is a substituted or unsubstituted alkylsilyl group having 1 to 20 carbon atoms; a substituted or unsubstituted arylsilyl group having 6 to 20 carbon atoms; a substituted or unsubstituted aryl group having 6 to 20 carbon atoms; or a substituted or unsubstituted heterocyclic group having 2 to 30 carbon atoms.

In an exemplary embodiment of the present specification, R1 to R3 and R11 to R33 are the same as or different from each other, and are each independently hydrogen; deuterium; an alkylsilyl group having 1 to 20 carbon atoms, which is unsubstituted or substituted with deuterium; an arylsilyl group having 6 to 20 carbon atoms, which is unsubstituted or substituted with deuterium; an alkyl group having 1 to 20 carbon atoms, which is unsubstituted or substituted with deuterium; a cycloalkyl group having 3 to 20 carbon atoms, which is unsubstituted or substituted with deuterium; an aryl group having 6 to 20 carbon atoms, which is unsubstituted or substituted with deuterium; or a heterocyclic group having 2 to 30 carbon atoms, which is unsubstituted or substituted with deuterium, at least one of R1 to R3 is a carbazole group unsubstituted or substituted with deuterium, and at least one of R11 to R33 is an alkylsilyl group having 1 to 20 carbon atoms, which is unsubstituted or substituted with deuterium; an arylsilyl group having 6 to 20 carbon atoms, which is unsubstituted or substituted with deuterium; an aryl group having 6 to 20 carbon atoms, which is unsubstituted or substituted with deuterium; or a heterocyclic group having 2 to 30 carbon atoms, which is unsubstituted or substituted with deuterium.

In an exemplary embodiment of the present specification, R1 to R3 and R11 to R33 are the same as or different from each other, and are each independently hydrogen; deuterium; an alkylsilyl group having 1 to 20 carbon atoms; an arylsilyl group having 6 to 20 carbon atoms; an alkyl group having 1 to 20 carbon atoms; a cycloalkyl group having 3 to 20 carbon atoms; an aryl group having 6 to 20 carbon atoms; or a heterocyclic group having 2 to 30 carbon atoms, at least one of R1 to R3 is a carbazole group, and at least one of R11 to R33 is an alkylsilyl group having 1 to 20 carbon atoms; an arylsilyl group having 6 to 20 carbon atoms; an aryl group having 6 to 20 carbon atoms; or a heterocyclic group having 2 to 30 carbon atoms.

In an exemplary embodiment of the present specification, at least one of R1 to R3 is a substituted or unsubstituted carbazole group, and the others are the same as or different from each other, and are each independently hydrogen; or deuterium.

In an exemplary embodiment of the present specification, at least two of R1 to R3 are a substituted or unsubstituted carbazole group, and the other is hydrogen; or deuterium.

In an exemplary embodiment of the present specification, one or two of R1 to R3 is or are a substituted or unsubstituted carbazole group.

In an exemplary embodiment of the present specification, all of R1 to R3 are a substituted or unsubstituted carbazole group.

In an exemplary embodiment of the present specification, at least one of R1 to R3 is a carbazole group unsubstituted or substituted with deuterium, and the others are the same as or different from each other, and are each independently hydrogen; or deuterium.

In an exemplary embodiment of the present specification, at least two of R1 to R3 are a carbazole group unsubstituted or substituted with deuterium, and the others are hydrogen; or deuterium.

In an exemplary embodiment of the present specification, all of R1 to R3 are a carbazole group unsubstituted or substituted with deuterium.

In an exemplary embodiment of the present specification, at least one of R1 to R3 is a carbazole group, and the others are the same as or different from each other, and are each independently hydrogen; or deuterium.

In an exemplary embodiment of the present specification, at least two of R1 to R3 are a carbazole group, and the other is hydrogen; or deuterium.

In an exemplary embodiment of the present specification, at least one of R11 to R33 is a substituted or unsubstituted silyl group; a substituted or unsubstituted aryl group; or a substituted or unsubstituted heterocyclic group, and the others are the same as or different from each other, and are each independently hydrogen; or deuterium.

In an exemplary embodiment of the present specification, at least one of R11 to R33 is a substituted or unsubstituted alkylsilyl group having 1 to 20 carbon atoms; a substituted or unsubstituted arylsilyl group having 6 to 20 carbon atoms; a substituted or unsubstituted aryl group having 6 to 20 carbon atoms; or a substituted or unsubstituted heterocyclic group having 2 to 30 carbon atoms, and the others are the same as or different from each other, and are each independently hydrogen; or deuterium.

In an exemplary embodiment of the present specification, at least one of R11 to R33 is a substituted or unsubstituted alkylsilyl group having 1 to 20 carbon atoms; a substituted or unsubstituted arylsilyl group having 6 to 20 carbon atoms; a substituted or unsubstituted aryl group having 6 to 20 carbon atoms; or a substituted or unsubstituted heterocyclic group having 2 to 30 carbon atoms, which includes one or more of N, O, and S as a heteroatom, and the others are the same as or different from each other, and are each independently hydrogen; or deuterium.

In an exemplary embodiment of the present specification, at least one of R11 to R33 is a substituted or unsubstituted triphenylsilyl group; a substituted or unsubstituted phenyl group; a substituted or unsubstituted biphenyl group; a substituted or unsubstituted terphenyl group; a substituted or unsubstituted naphthyl group; a substituted or unsubstituted phenanthrenyl group; a substituted or unsubstituted carbazole group; a substituted or unsubstituted benzofuran group; a substituted or unsubstituted dibenzofuran group; a substituted or unsubstituted benzothiophene group; a substituted or unsubstituted dibenzothiophene group; or a substituted or unsubstituted heterocyclic group including one or more of N and O as a heteroatom and having four or more fused rings, and the others are the same as or different from each other, and are each independently hydrogen; or deuterium.
In an exemplary embodiment of the present specification, at least one of R11 to R33 is a substituted or unsubstituted triphenylsilyl group; a substituted or unsubstituted phenyl group; a substituted or unsubstituted biphenyl group; a substituted or unsubstituted naphthyl group; a substituted or unsubstituted carbazole group; a substituted or unsubstituted dibenzofuran group; a substituted or unsubstituted dibenzothiophene group; or a substituted or unsubstituted heterocyclic group including one or more of N and O as a heteroatom and having four to seven fused rings, and the others are the same as or different from each other, and are each independently hydrogen; or deuterium.

In an exemplary embodiment of the present specification, at least one of R11 to R33 is a substituted or unsubstituted triphenylsilyl group; a substituted or unsubstituted phenyl group; a substituted or unsubstituted carbazole group; a substituted or unsubstituted dibenzofuran group; a substituted or unsubstituted dibenzothiophene group; or a substituted or unsubstituted heterocyclic group including one or more of N and O as a heteroatom and having five or seven fused rings, and the others are the same as or different from each other, and are each independently hydrogen; or deuterium.

In an exemplary embodiment of the present specification, at least one of R11 to R33 is a silyl group unsubstituted or substituted with deuterium; an aryl group unsubstituted or substituted with deuterium; or a heterocyclic group unsubstituted or substituted with deuterium, and the others are the same as or different from each other, and are each independently hydrogen; or deuterium.

In an exemplary embodiment of the present specification, at least one of R11 to R33 is an alkylsilyl group having 1 to 20 carbon atoms, which is unsubstituted or substituted with deuterium; an arylsilyl group having 6 to 20 carbon atoms, which is unsubstituted or substituted with deuterium; an aryl group having 6 to 20 carbon atoms, which is unsubstituted or substituted with deuterium; or a heterocyclic group having 2 to 30 carbon atoms, which is unsubstituted or substituted with deuterium, and the others are the same as or different from each other, and are each independently hydrogen; or deuterium.

In an exemplary embodiment of the present specification, at least one of R11 to R33 is an alkylsilyl group having 1 to 20 carbon atoms, which is unsubstituted or substituted with deuterium; an arylsilyl group having 6 to 20 carbon atoms, which is unsubstituted or substituted with deuterium; an aryl group having 6 to 20 carbon atoms, which is unsubstituted or substituted with deuterium; or a heterocyclic group having 2 to 30 carbon atoms, which includes one or more of N, O, and S as a heteroatom and is unsubstituted or substituted with deuterium, and the others are the same as or different from each other, and are each independently hydrogen; or deuterium.

In an exemplary embodiment of the present specification, at least one of R11 to R33 is a triphenylsilyl group substituted or unsubstituted with deuterium; a phenyl group substituted or unsubstituted with deuterium; a biphenyl group substituted or unsubstituted with deuterium; a terphenyl group substituted or unsubstituted with deuterium; a naphthyl group substituted or unsubstituted with deuterium; a phenanthrenyl group substituted or unsubstituted with deuterium; a carbazole group substituted or unsubstituted with deuterium; a benzofuran group substituted or unsubstituted with deuterium; a dibenzofuran group substituted or unsubstituted with deuterium; a benzothiophene group substituted or unsubstituted with deuterium; a dibenzothiophene group substituted or unsubstituted with deuterium; or a heterocyclic group which includes one or more of N and O as a heteroatom, has four or more fused rings, and is substituted or unsubstituted with deuterium, and the others are the same as or different from each other, and are each independently hydrogen; or deuterium.

In an exemplary embodiment of the present specification, at least one of R11 to R33 is a triphenylsilyl group unsubstituted or substituted with deuterium; a phenyl group unsubstituted or substituted with deuterium; a biphenyl group unsubstituted or substituted with deuterium; a naphthyl group unsubstituted or substituted with deuterium; a carbazole group unsubstituted or substituted with deuterium; a dibenzofuran group unsubstituted or substituted with deuterium; a dibenzothiophene group unsubstituted or substituted with deuterium; or a heterocyclic group which includes one or more of N and O as a heteroatom, has four to seven fused rings, and is unsubstituted or substituted with deuterium, and the others are the same as or different from each other, and are each independently hydrogen; or deuterium.

In an exemplary embodiment of the present specification, at least one of R11 to R33 is a triphenylsilyl group unsubstituted or substituted with deuterium; a phenyl group unsubstituted or substituted with deuterium; a carbazole group unsubstituted or substituted with deuterium; a dibenzofuran group unsubstituted or substituted with deuterium; a dibenzothiophene group unsubstituted or substituted with deuterium; or a heterocyclic group which includes one or more of N and O as a heteroatom, has five or seven fused rings, and is unsubstituted or substituted with deuterium, and the others are the same as or different from each other, and are each independently hydrogen; or deuterium.

In an exemplary embodiment of the present specification, at least one of R11 to R33 is an alkylsilyl group having 1 to 20 carbon atoms; an arylsilyl group having 6 to 20 carbon atoms; an aryl group having 6 to 20 carbon atoms; or a heterocyclic group having 2 to 30 carbon atoms, and the others are the same as or different from each other, and are each independently hydrogen; or deuterium.

In an exemplary embodiment of the present specification, at least one of R11 to R33 is an alkylsilyl group having 1 to 20 carbon atoms; an arylsilyl group having 6 to 20 carbon atoms; an aryl group having 6 to 20 carbon atoms; or a heterocyclic group having 2 to 30 carbon atoms, which includes one or more of N, O, and S as a heteroatom, and the others are the same as or different from each other, and are each independently hydrogen; or deuterium.

In an exemplary embodiment of the present specification, at least one of R11 to R33 is a triphenylsilyl group; a phenyl group; a biphenyl group; a terphenyl group; a naphthyl group; a phenanthrenyl group; a carbazole group; a benzofuran group; a dibenzofuran group; a benzothiophene group; a dibenzothiophene group; or a heterocyclic group including one or more of N and O as a heteroatom and having four or more fused rings, and the others are the same as or different from each other, and are each independently hydrogen; or deuterium.

In an exemplary embodiment of the present specification, at least one of R11 to R33 is a triphenylsilyl group; a phenyl group; a biphenyl group; a naphthyl group; a carbazole group; a dibenzofuran group; a dibenzothiophene group; or a heterocyclic group including one or more of N and O as a heteroatom and having four to seven fused rings, and the others are the same as or different from each other, and are each independently hydrogen; or deuterium.

In an exemplary embodiment of the present specification, at least one of R11 to R33 is a triphenylsilyl group; a phenyl group; a carbazole group; a dibenzofuran group; a dibenzothiophene group; or a heterocyclic group including one or more of N and O as a heteroatom and having five or seven fused rings, and the others are the same as or different from each other, and are each independently hydrogen; or deuterium.

In an exemplary embodiment of the present specification, at least two of R11 to R33 are a substituted or unsubstituted silyl group; a substituted or unsubstituted aryl group; or a substituted or unsubstituted heterocyclic group.

In an exemplary embodiment of the present specification, at least two of R11 to R33 are a substituted or unsubstituted triphenylsilyl group; a substituted or unsubstituted phenyl group; a substituted or unsubstituted carbazole group; a substituted or unsubstituted dibenzofuran group; a substituted or unsubstituted dibenzothiophene group; or a substituted or unsubstituted heterocyclic group including one or more of N and O as a heteroatom and having five or seven fused rings, and the others are the same as or different from each other, and are each independently hydrogen; or deuterium.

In an exemplary embodiment of the present specification, at least two of R11 to R33 are a triphenylsilyl group unsubstituted or substituted with deuterium; a phenyl group unsubstituted or substituted with deuterium; a carbazole group unsubstituted or substituted with deuterium; a dibenzofuran group unsubstituted or substituted with deuterium; a dibenzothiophene group unsubstituted or substituted with deuterium; or a heterocyclic group which includes one or more of N and O as a heteroatom, has five or seven fused rings, and is unsubstituted or substituted with deuterium, and the others are the same as or different from each other, and are each independently hydrogen; or deuterium.

In an exemplary embodiment of the present specification, at least two of R11 to R33 are a triphenylsilyl group; a phenyl group; a carbazole group; a dibenzofuran group; a dibenzothiophene group; or a heterocyclic group including one or more of N and O as a heteroatom and having five or seven fused rings, and the others are the same as or different from each other, and are each independently hydrogen; or deuterium.

In an exemplary embodiment of the present specification, at least one of R11 to R33 is a group represented by the following structural formula; a substituted or unsubstituted aryl group; or a substituted or unsubstituted heterocyclic group.

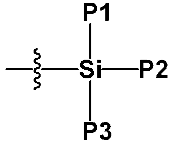

In the structural formula, P1 to P3 are a substituted or unsubstituted aryl group, and 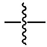 means a position bonded to L11 to L33.

In an exemplary embodiment of the present specification, P1 to P3 are a substituted or unsubstituted aryl group having 6 to 60 carbon atoms.

In an exemplary embodiment of the present specification, P1 to P3 are a substituted or unsubstituted aryl group having 6 to 30 carbon atoms.

In an exemplary embodiment of the present specification, P1 to P3 are a substituted or unsubstituted aryl group having 6 to 20 carbon atoms.

In an exemplary embodiment of the present specification, P1 to P3 are a substituted or unsubstituted phenyl group.

In an exemplary embodiment of the present specification, P1 to P3 are a phenyl group unsubstituted or substituted with deuterium.

In an exemplary embodiment of the present specification, P1 to P3 are a phenyl group.

In an exemplary embodiment of the present specification, n1 is an integer from 1 to 4.

In an exemplary embodiment of the present specification, n1 is an integer from 1 to 3.

In an exemplary embodiment of the present specification, n1 is 3.

In an exemplary embodiment of the present specification, n1 is 2.

In an exemplary embodiment of the present specification, n1 is 1.

In an exemplary embodiment of the present specification, n2 is an integer from 1 to 4.

In an exemplary embodiment of the present specification, n2 is an integer from 1 to 3.

In an exemplary embodiment of the present specification, n2 is 3.

In an exemplary embodiment of the present specification, n2 is 2.

In an exemplary embodiment of the present specification, n2 is 1.

In an exemplary embodiment of the present specification, n3 is an integer from 1 to 3.

In an exemplary embodiment of the present specification, n3 is an integer from 1 to 2.

In an exemplary embodiment of the present specification, n3 is 2.

In an exemplary embodiment of the present specification, n3 is 1.

In an exemplary embodiment of the present specification, m1 is an integer from 1 to 4.

In an exemplary embodiment of the present specification, m1 is an integer from 1 to 3.

In an exemplary embodiment of the present specification, m1 is 3.

In an exemplary embodiment of the present specification, m1 is 2.

In an exemplary embodiment of the present specification, m1 is 1.

In an exemplary embodiment of the present specification, m2 is an integer from 1 to 4.

In an exemplary embodiment of the present specification, m2 is an integer from 1 to 3.

In an exemplary embodiment of the present specification, m2 is 3.

In an exemplary embodiment of the present specification, m2 is 2.

In an exemplary embodiment of the present specification, m2 is 1.

In an exemplary embodiment of the present specification, m3 is an integer from 1 to 3.

In an exemplary embodiment of the present specification, m3 is an integer from 1 to 2.

In an exemplary embodiment of the present specification, m3 is 2.

In an exemplary embodiment of the present specification, m3 is 1.

In an exemplary embodiment of the present specification, n1+m1 is 2 or higher and 4 or less.

In an exemplary embodiment of the present specification, n1+m1 is 3 or higher and 4 or less.

In an exemplary embodiment of the present specification, n1+m1 is 4.

In an exemplary embodiment of the present specification, n1+m1 is 3.

In an exemplary embodiment of the present specification, n1+m1 is 2.

In an exemplary embodiment of the present specification, n2+m2 is 2 or higher and 4 or less.

In an exemplary embodiment of the present specification, n2+m2 is 3 or higher and 4 or less.

In an exemplary embodiment of the present specification, n2+m2 is 4.

In an exemplary embodiment of the present specification, n2+m2 is 3.

In an exemplary embodiment of the present specification, n2+m2 is 2.

In an exemplary embodiment of the present specification, n3+m3 is 2 or 3.

In an exemplary embodiment of the present specification, n3+m3 is 3.

In an exemplary embodiment of the present specification, n3+m3 is 2.

In an exemplary embodiment of the present specification, m1, n2, and n3 are 1.

In an exemplary embodiment of the present specification, n1, m2, and n3 are 1.

In an exemplary embodiment of the present specification, n1, n2, and m3 are 1.

In an exemplary embodiment of the present specification, n1, m2, and m3 are 1.

In an exemplary embodiment of the present specification, m1, n2, and m3 are 1.

In an exemplary embodiment of the present specification, m1, m2, and n3 are 1.

In an exemplary embodiment of the present specification, Chemical Formula 1 is represented by any one of the following Chemical Formulae 1-1 to 1-6.

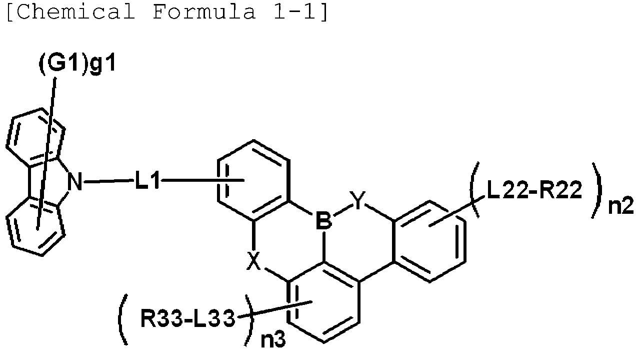

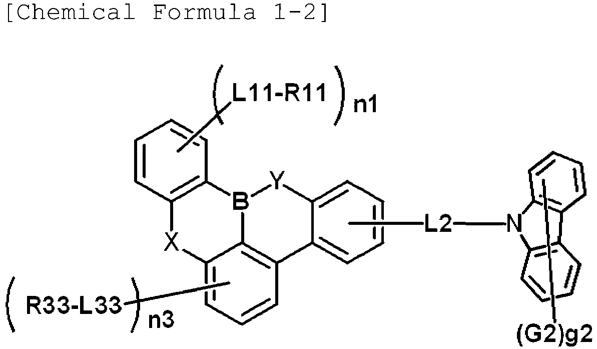

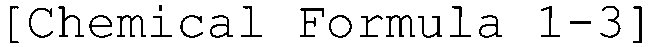

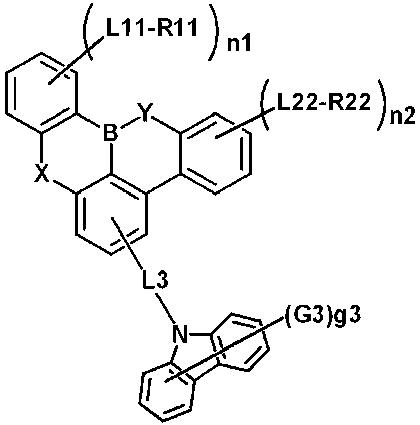

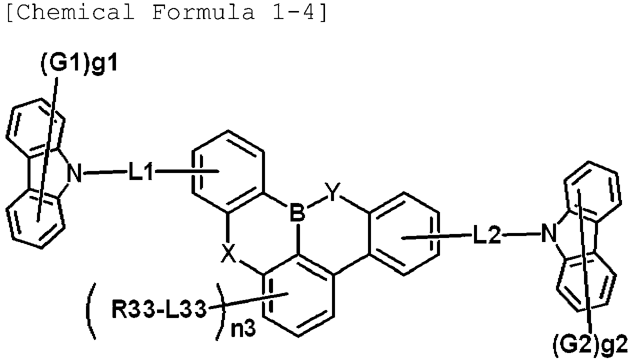

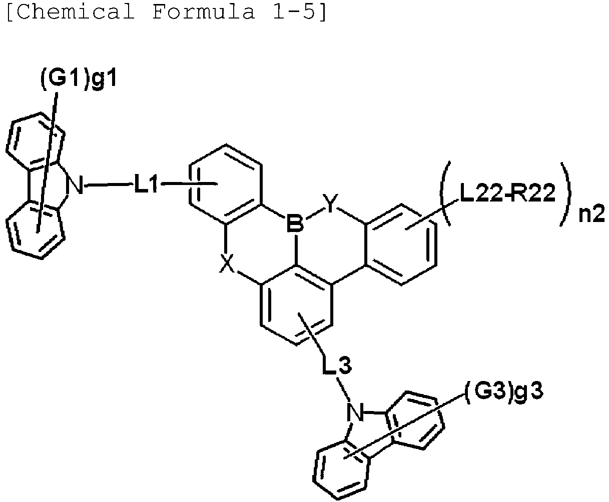

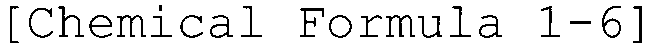

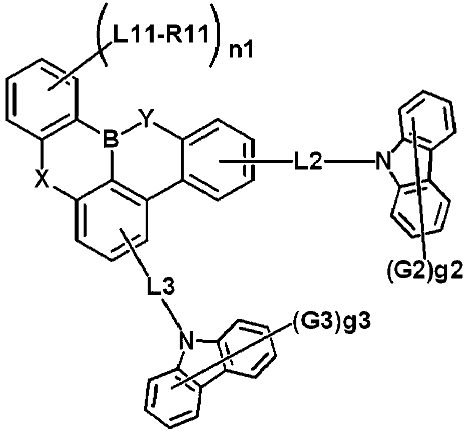

In Chemical Formulae 1-1 to 1-6,
the definitions of X, Y, R11 to R33, L1 to L3, L11 to L33, and n1 to n3 are the same as the definitions in Chemical Formula 1,
G1 to G3 are the same as or different from each other, and are each independently hydrogen; deuterium; a halogen group; a nitrile group; a substituted or unsubstituted silyl group; a substituted or unsubstituted alkyl group; a substituted or unsubstituted cycloalkyl group; a substituted or unsubstituted aryl group; or a substituted or unsubstituted heterocyclic group, and
g1 to g3 are each an integer from 1 to 8, and when g1 to g3 are each 2 or higher, G1 to G3 are each the same as or different from each other.

In an exemplary embodiment of the present specification, G1 to G3 are the same as or different from each other, and are each independently hydrogen; deuterium; a halogen group; a nitrile group; a substituted or unsubstituted silyl group; a substituted or unsubstituted alkyl group having 1 to 30 carbon atoms; a substituted or unsubstituted cycloalkyl group having 3 to 30 carbon atoms; a substituted or unsubstituted aryl group having 6 to 30 carbon atoms; or a substituted or unsubstituted heterocyclic group having 2 to 30 carbon atoms.

In an exemplary embodiment of the present specification, G1 to G3 are the same as or different from each other, and are each independently hydrogen; deuterium; a halogen group; a nitrile group; a substituted or unsubstituted silyl group; a substituted or unsubstituted alkyl group having 1 to 20 carbon atoms; a substituted or unsubstituted cycloalkyl group having 3 to 20 carbon atoms; a substituted or unsubstituted aryl group having 6 to 20 carbon atoms; or a substituted or unsubstituted heterocyclic group having 2 to 20 carbon atoms.

In an exemplary embodiment of the present specification, G1 to G3 are the same as or different from each other, and are each independently hydrogen; deuterium; a substituted or unsubstituted methyl group; a substituted or unsubstituted ethyl group; a substituted or unsubstituted propyl group; a substituted or unsubstituted butyl group; a substituted or unsubstituted phenyl group; a substituted or unsubstituted biphenyl group; a substituted or unsubstituted naphthyl group; a substituted or unsubstituted carbazole group; a substituted or unsubstituted benzofuran group; a substituted or unsubstituted dibenzofuran group; a substituted or unsubstituted benzothiophene group; or a substituted or unsubstituted dibenzothiophene group.

In an exemplary embodiment of the present specification, G1 to G3 are the same as or different from each other, and are each independently hydrogen; deuterium; a halogen group; a nitrile group; an alkylsilyl group having 1 to 20 carbon atoms, which is unsubstituted or substituted with deuterium; an arylsilyl group having 6 to 20 carbon atoms, which is unsubstituted or substituted with deuterium; an alkyl group having 1 to 20 carbon atoms, which is unsubstituted or substituted with deuterium; a cycloalkyl group having 3 to 20 carbon atoms, which is unsubstituted or substituted with deuterium; an aryl group having 6 to 20 carbon atoms, which is unsubstituted or substituted with deuterium; or a heterocyclic group having 2 to 20 carbon atoms, which is unsubstituted or substituted with deuterium.

In an exemplary embodiment of the present specification, G1 to G3 are the same as or different from each other, and are each independently hydrogen; deuterium; a butyl group unsubstituted or substituted with deuterium; a phenyl group unsubstituted or substituted with deuterium; a biphenyl group unsubstituted or substituted with deuterium; a naphthyl group unsubstituted or substituted with deuterium; a carbazole group unsubstituted or substituted with deuterium; a dibenzofuran group unsubstituted or substituted with deuterium; or a dibenzothiophene group unsubstituted or substituted with deuterium.

In an exemplary embodiment of the present specification, G1 to G3 are the same as or different from each other, and are each independently hydrogen; deuterium; a butyl group; a phenyl group; a biphenyl group; a naphthyl group; a carbazole group; a dibenzofuran group; or a dibenzothiophene group.

In an exemplary embodiment of the present specification, G1 to G3 are the same as or different from each other, and are each independently hydrogen; or deuterium.

In an exemplary embodiment of the present specification, G1 to G3 are hydrogen.

In an exemplary embodiment of the present specification, G1 to G3 are deuterium.

In an exemplary embodiment of the present specification, g1 to g3 are 1.

In an exemplary embodiment of the present specification, g1 to g3 are 2.

In an exemplary embodiment of the present specification, g1 to g3 are 3.

In an exemplary embodiment of the present specification, g1 to g3 are 4.

In an exemplary embodiment of the present specification, g1 to g3 are 5.

In an exemplary embodiment of the present specification, g1 to g3 are 6.

In an exemplary embodiment of the present specification, g1 to g3 are 7.

In an exemplary embodiment of the present specification, g1 to g3 are 8.

In an exemplary embodiment of the present specification, Chemical Formula 1 is represented by any one of the following Chemical Formulae 1-A-1 to 1-A-3.

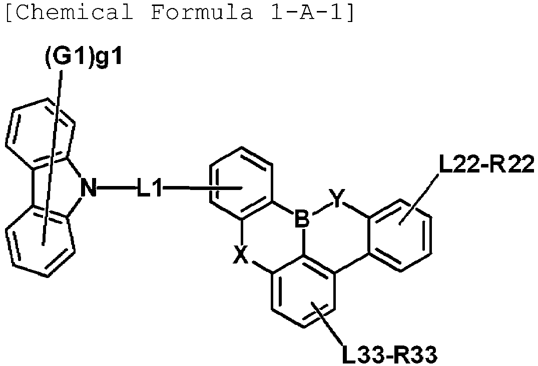

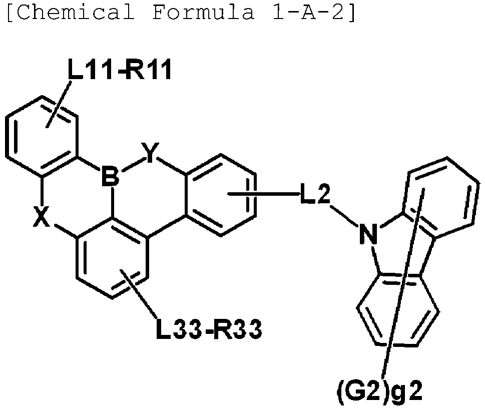

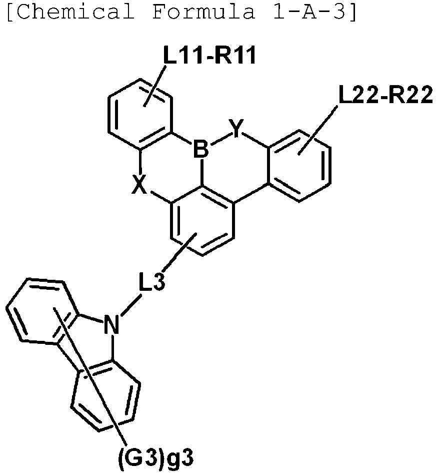

In Chemical Formulae 1-A-1 to 1-A-3,
the definitions of X, Y, R11 to R33, L1 to L3, and L11 to L33 are the same as the definitions in Chemical Formula 1, and the definitions of G1 to G3 and g1 to g3 are the same as the definitions in Chemical Formulae 1-1 to 1-6.

In an exemplary embodiment of the present specification, Chemical Formula 1 is represented by any one of the following Chemical Formulae 1-B-1 to 1-B-3.

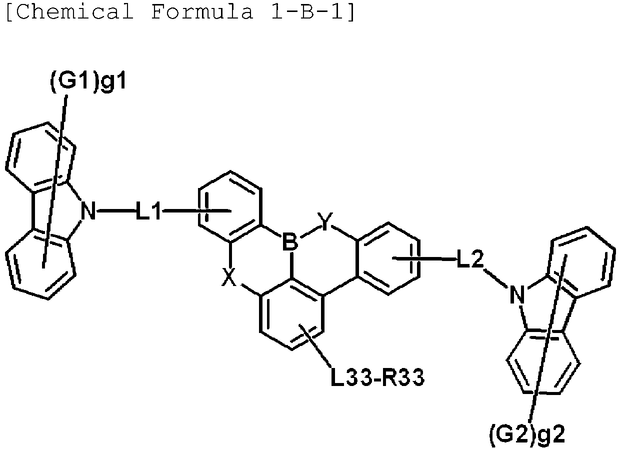

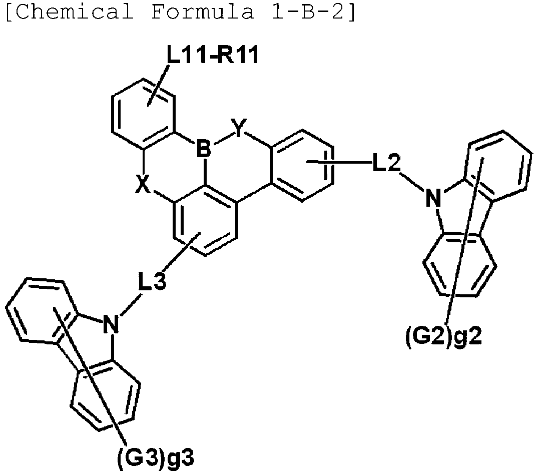

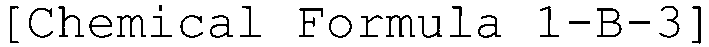

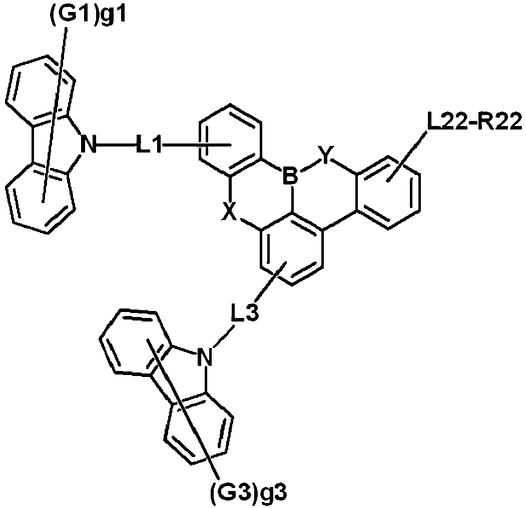

In Chemical Formulae 1-B-1 to 1-B-3,
the definitions of X, Y, R11 to R33, L1 to L3, and L11 to L33 are the same as the definitions in Chemical Formula 1, and the definitions of G1 to G3 and g1 to g3 are the same as the definitions in Chemical Formulae 1-1 to 1-6.

In an exemplary embodiment of the present specification, 20% or more of the compound represented by Chemical Formula 1 is substituted with deuterium. In another exemplary embodiment, 30% or more of the compound represented by Chemical Formula 1 is substituted with deuterium. In still another exemplary embodiment, 40% or more of the compound represented by Chemical Formula 1 is substituted with deuterium. In yet another exemplary embodiment, 50% or more of the compound represented by Chemical Formula 1 is substituted with deuterium. In still yet another exemplary embodiment, 60% or more of the compound represented by Chemical Formula 1 is substituted with deuterium. In a further exemplary embodiment, 70% or more of the compound represented by Chemical Formula 1 is substituted with deuterium. In another further exemplary embodiment, 80% or more of the compound represented by Chemical Formula 1 is substituted with deuterium. In still another further exemplary embodiment, 90% or more of the compound represented by Chemical Formula 1 is substituted with deuterium. In yet another further exemplary embodiment, 100% of the compound represented by Chemical Formula 1 is substituted with deuterium.

In an exemplary embodiment of the present specification, the compound represented by Chemical Formula 1 includes 40% to 60% of deuterium. In another exemplary embodiment, the compound represented by Chemical Formula 1 includes 40% to 80% of deuterium. In still another exemplary embodiment, the compound represented by Chemical Formula 1 includes 60% to 80% of deuterium. In yet another exemplary embodiment, the compound represented by Chemical Formula 1 includes 80% to 100% of deuterium.
In an exemplary embodiment of the present specification, Chemical Formula 1 is represented by any one of the following compounds.

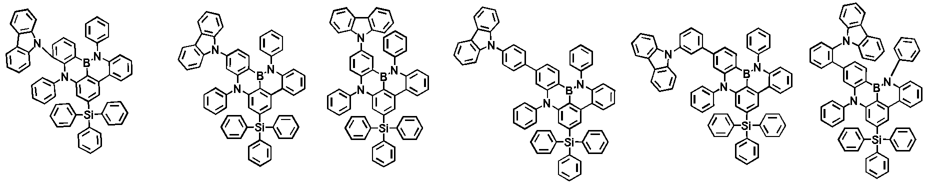

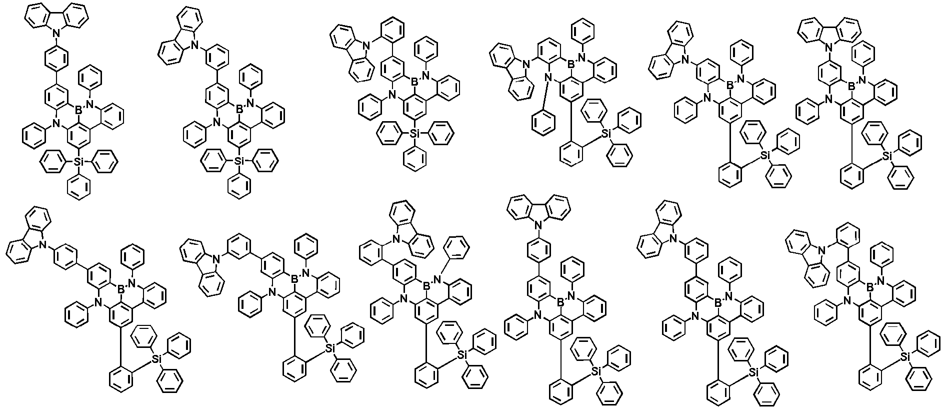

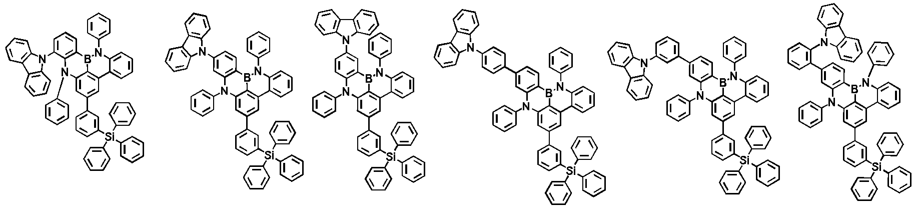

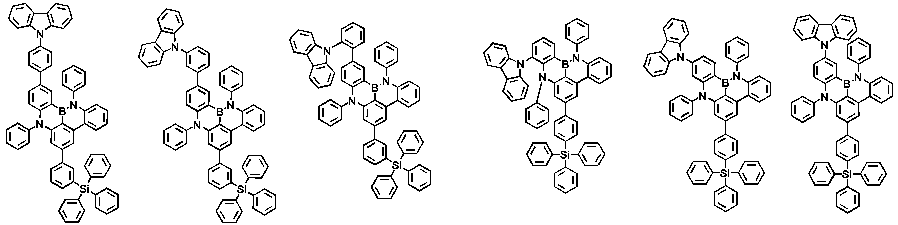

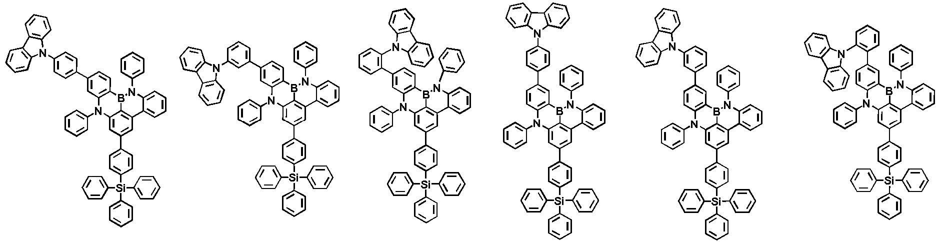

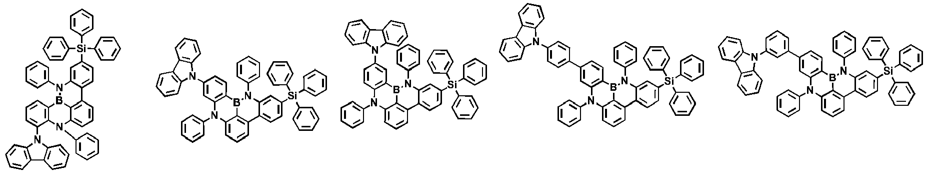

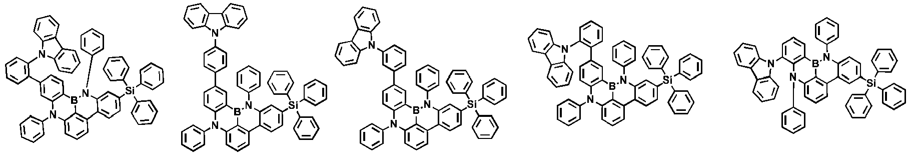

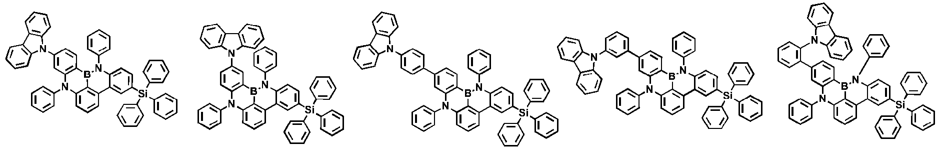

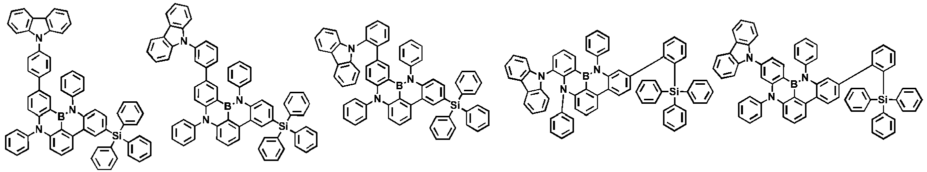

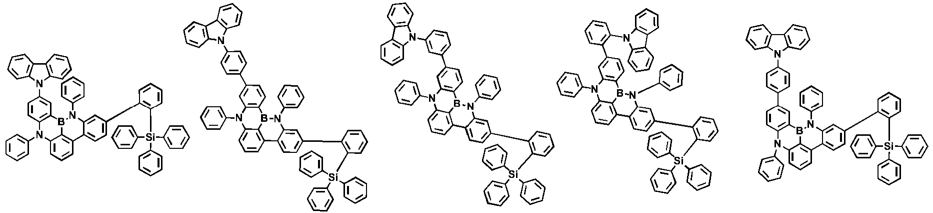

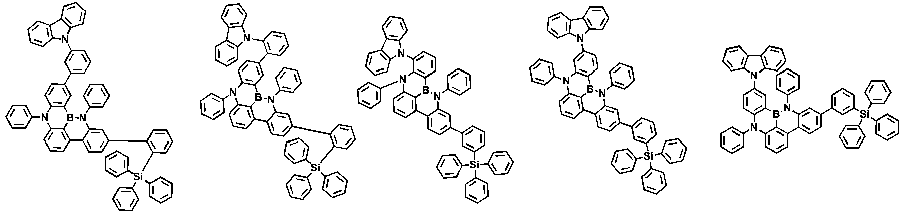

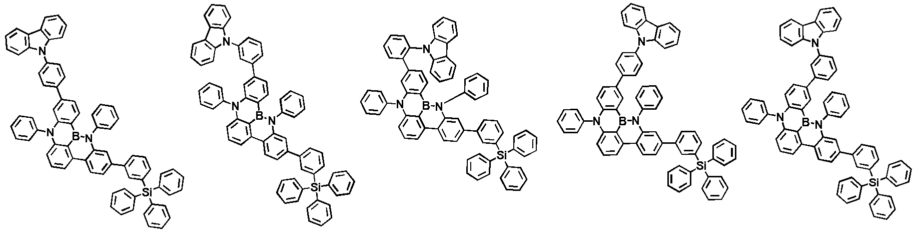

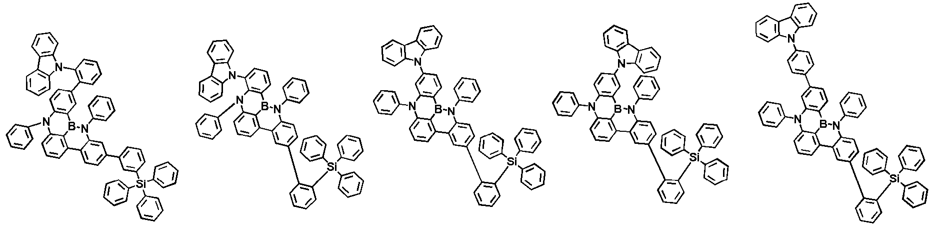

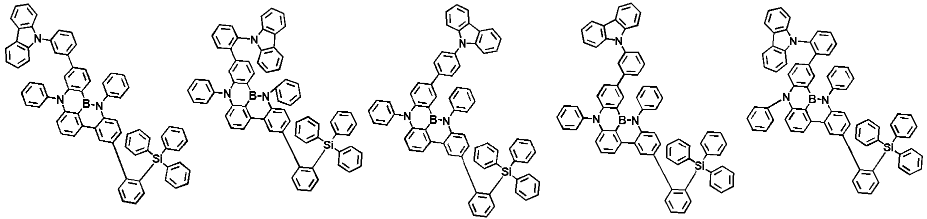

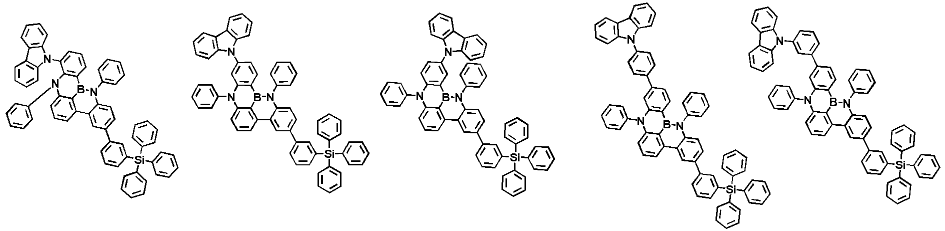

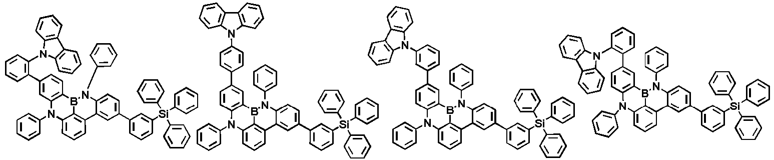

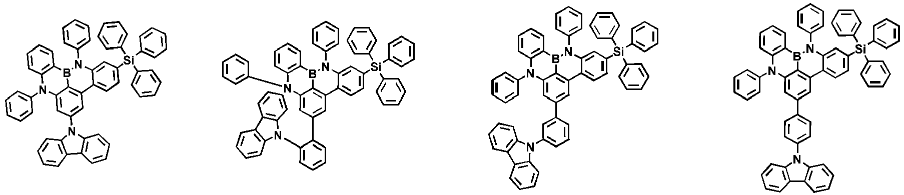

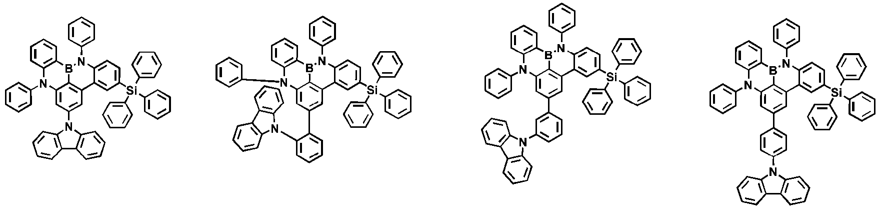

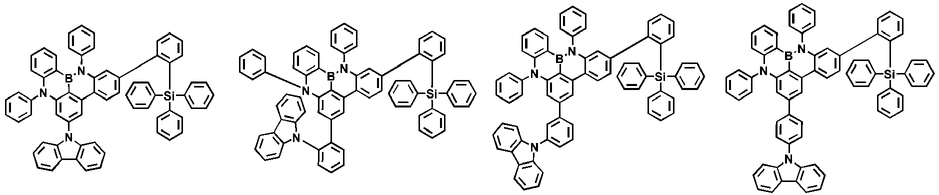

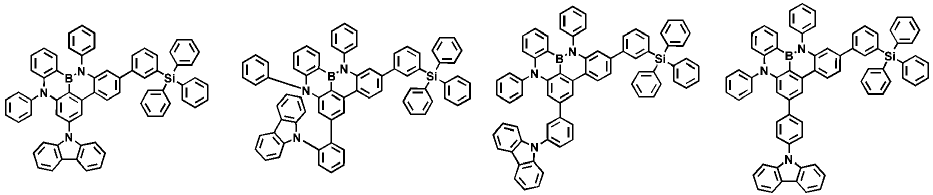

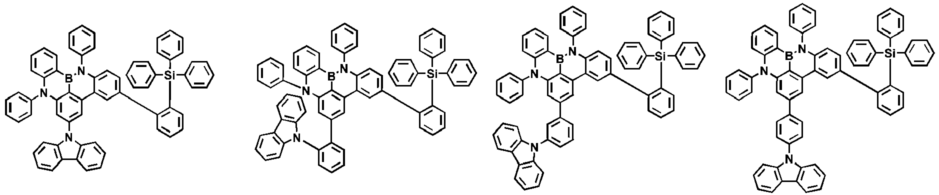

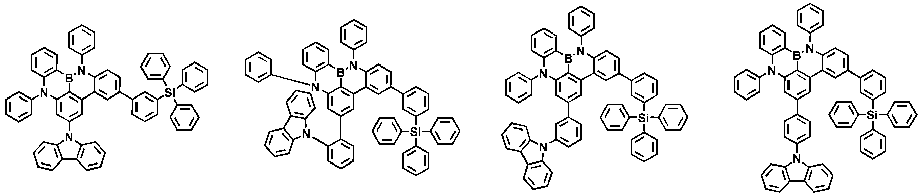

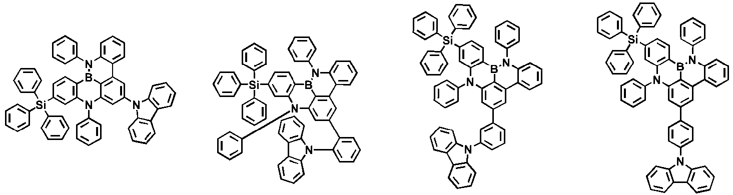

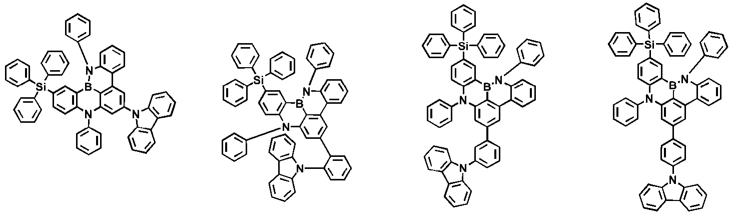

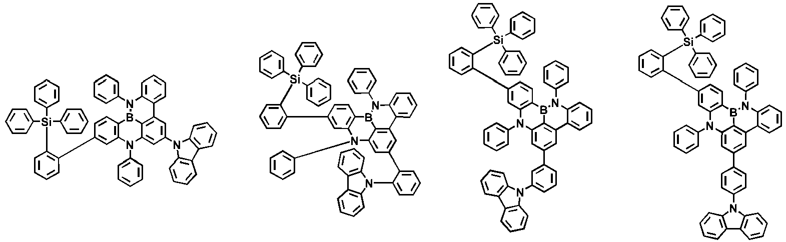

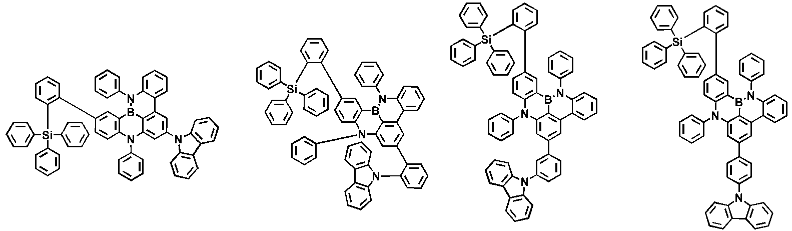

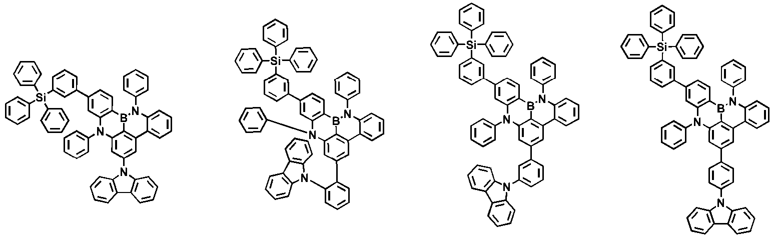

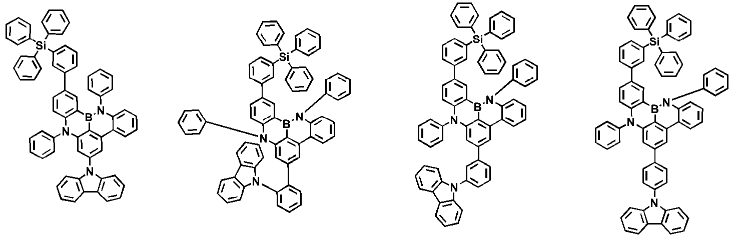

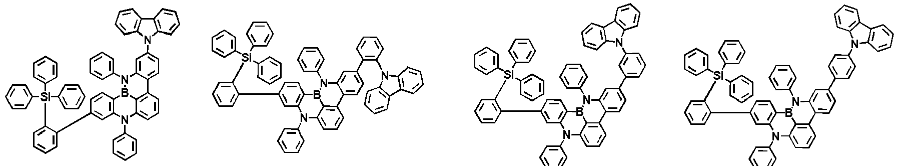

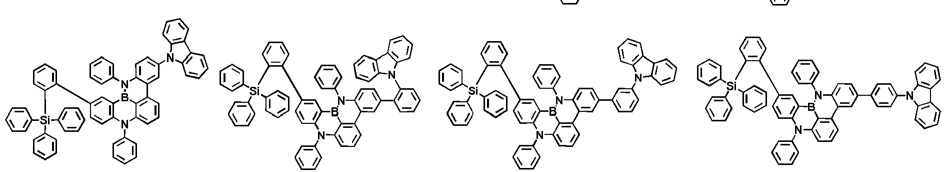

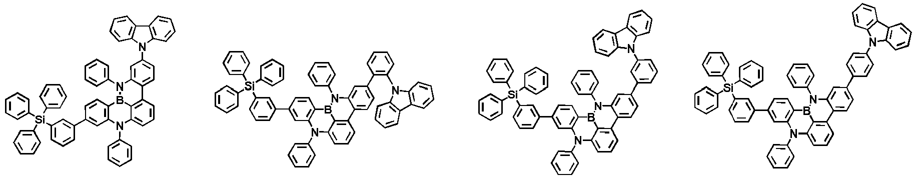

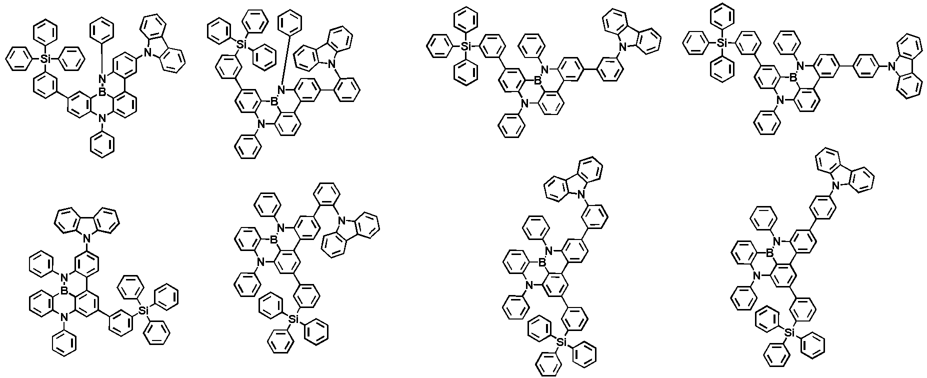

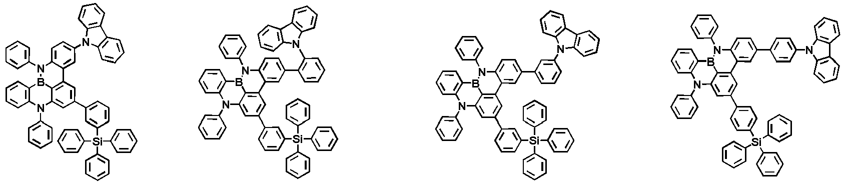

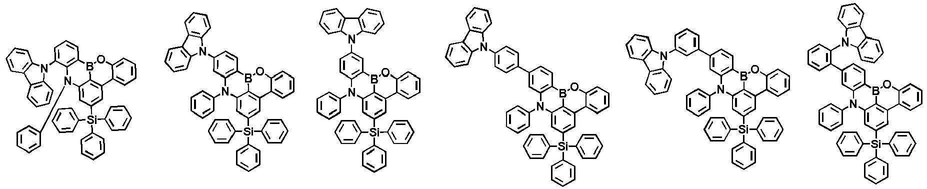

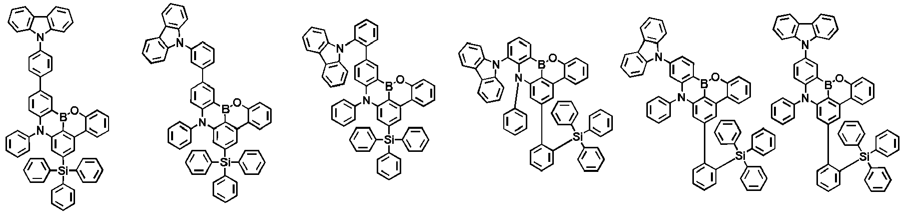

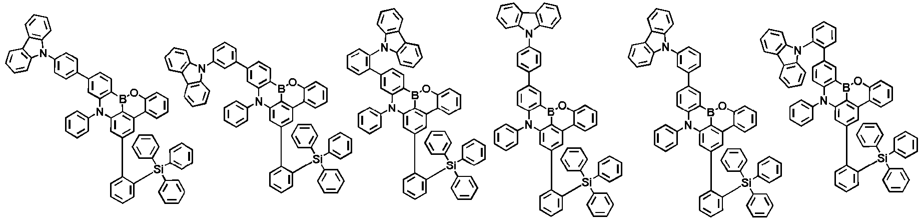

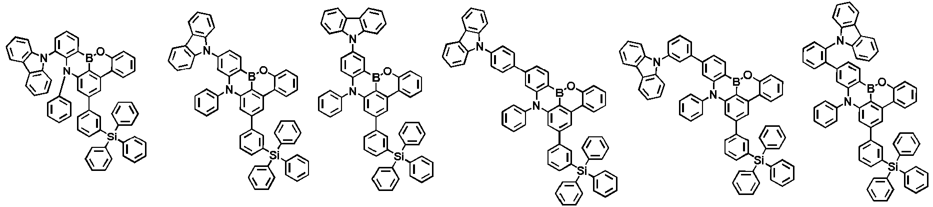

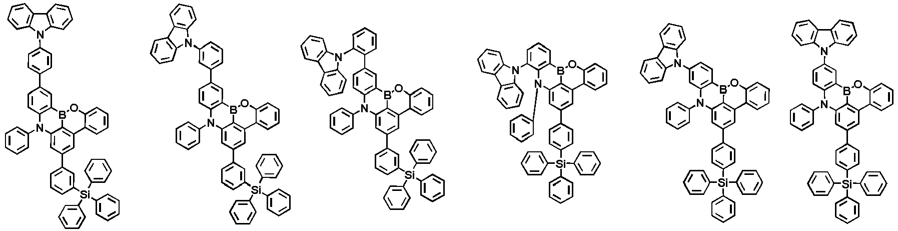

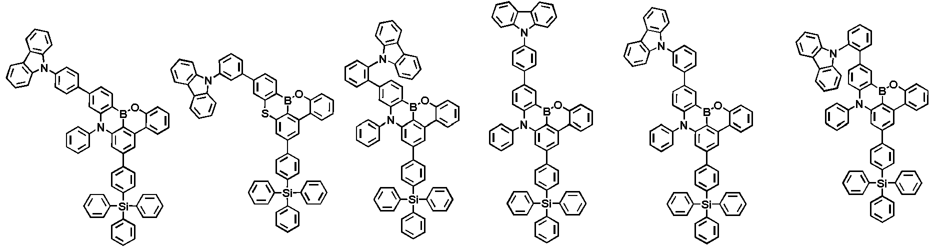

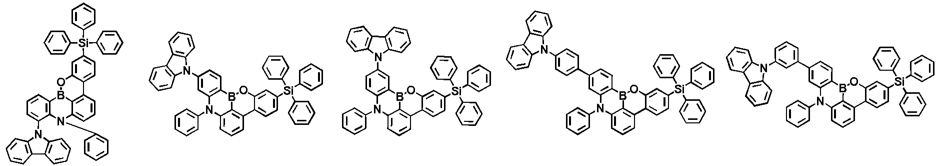

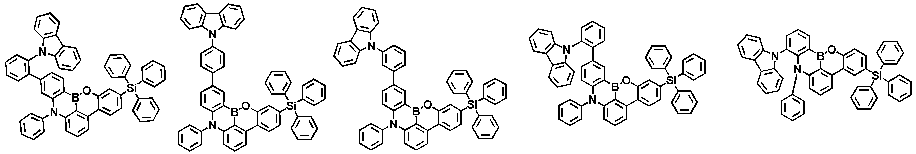

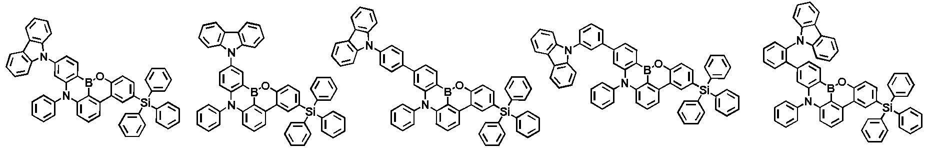

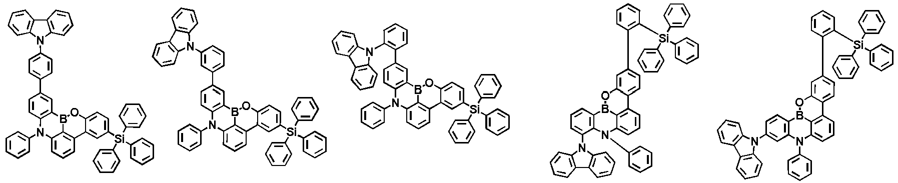

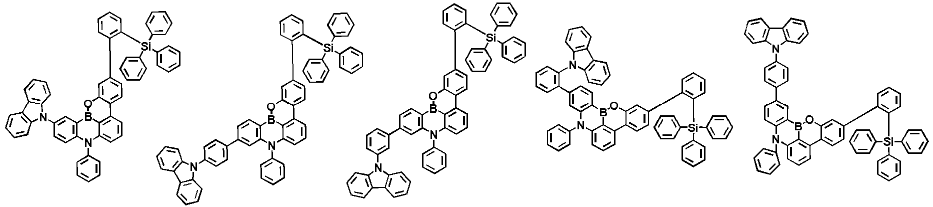

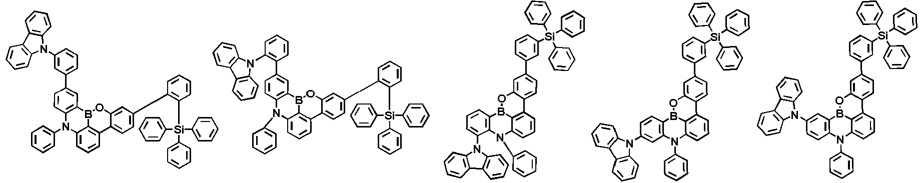

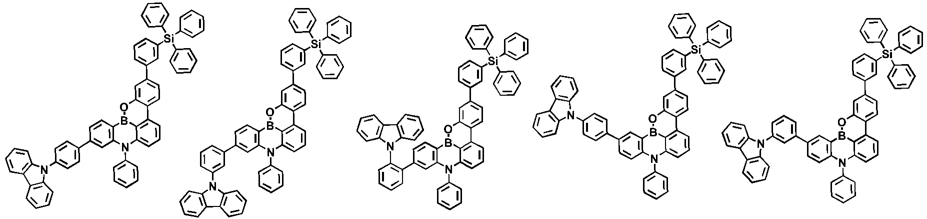

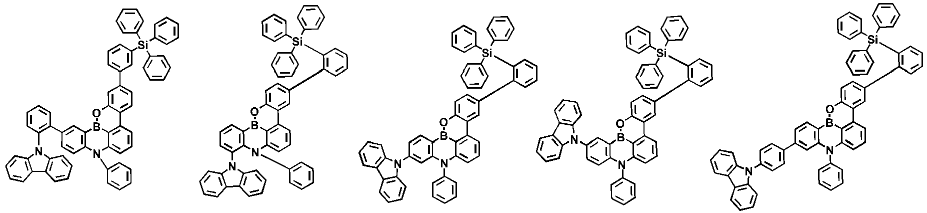

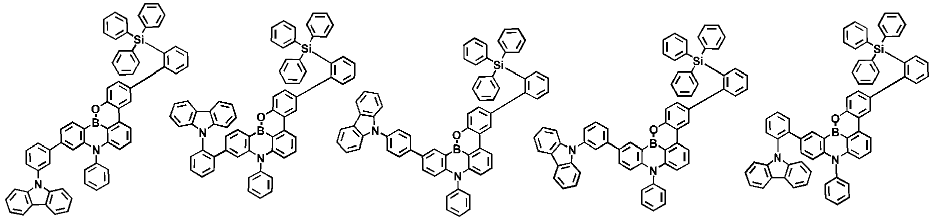

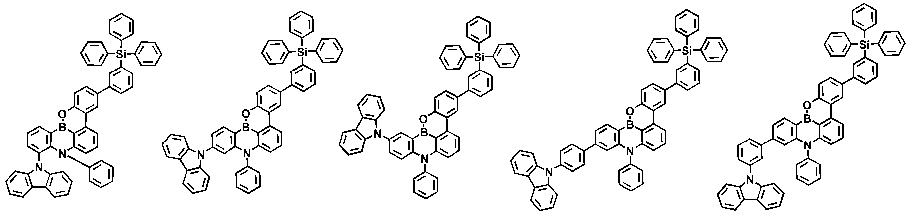

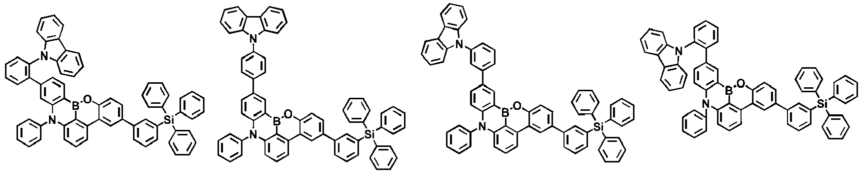

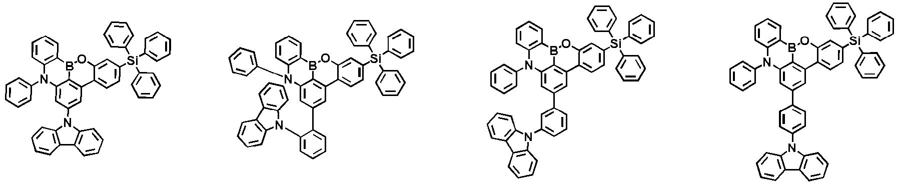

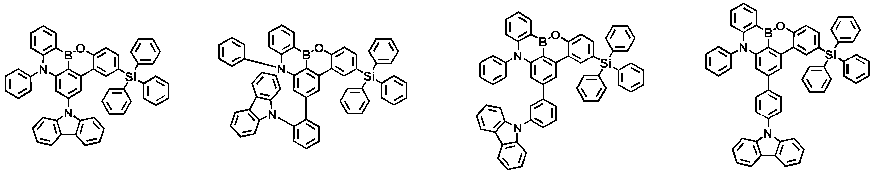

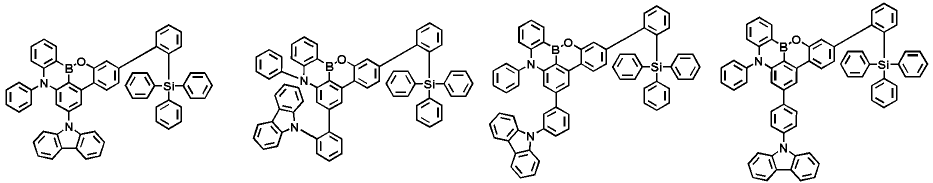

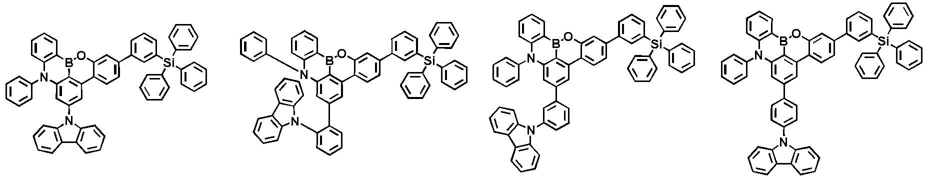

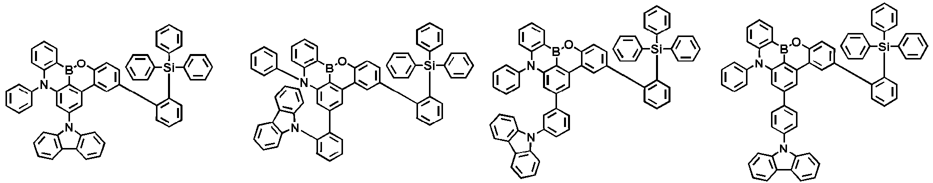

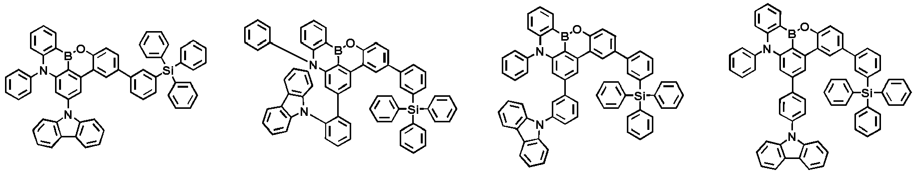

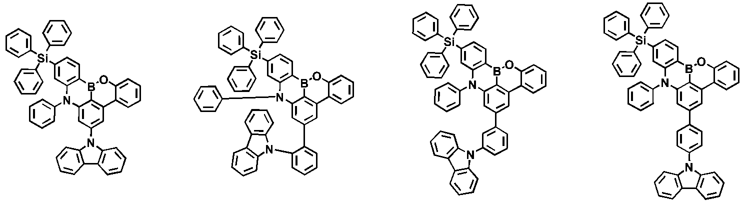

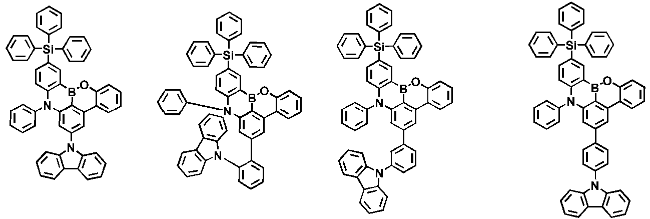

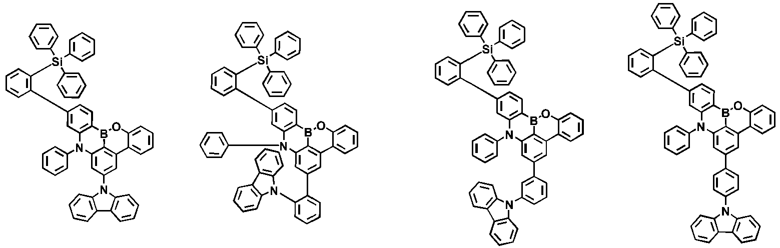

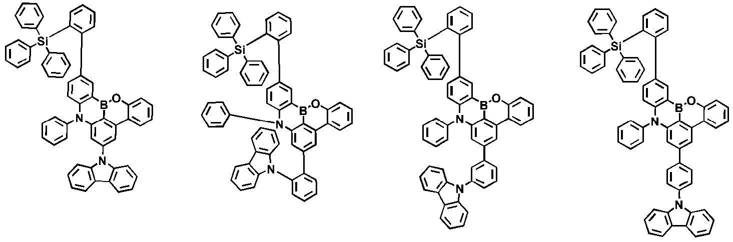

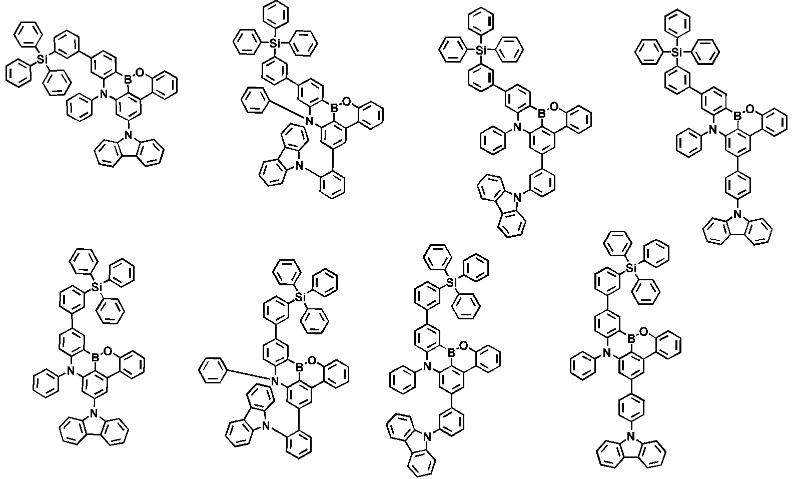

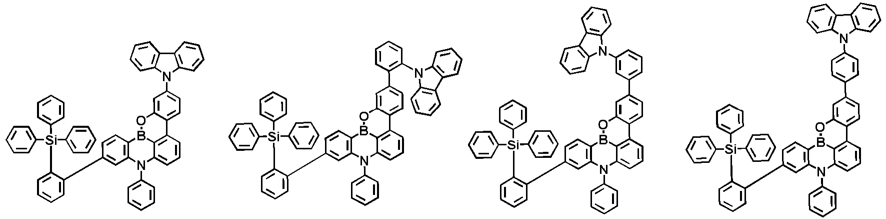

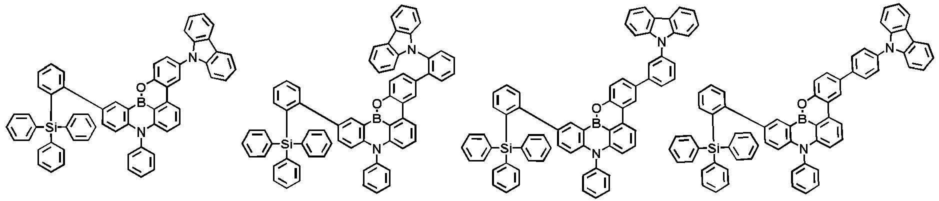

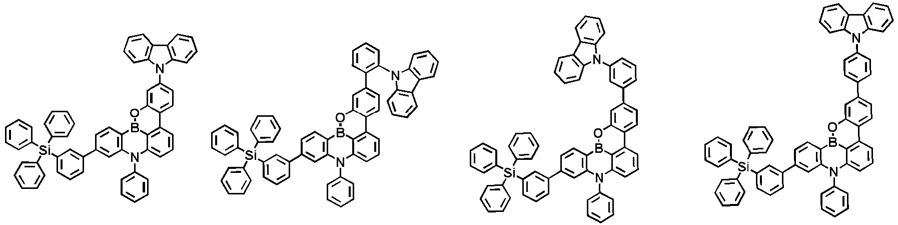

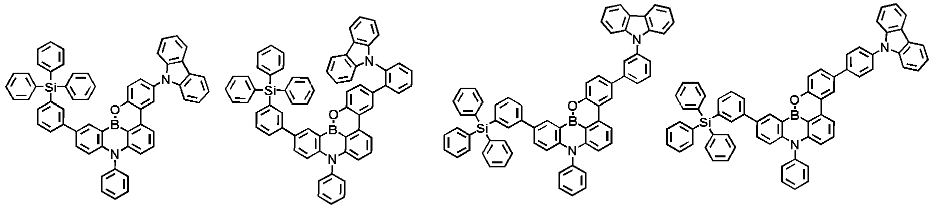

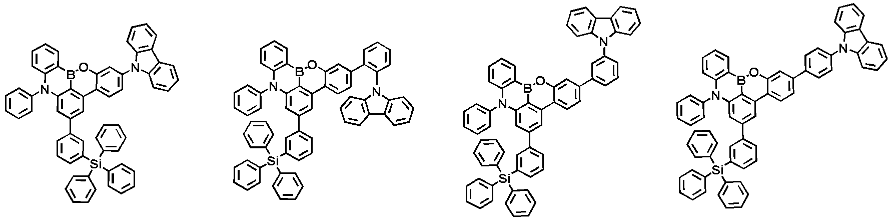

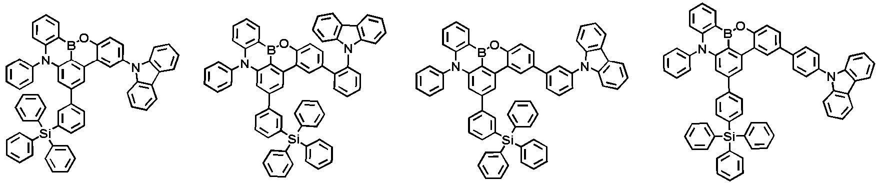

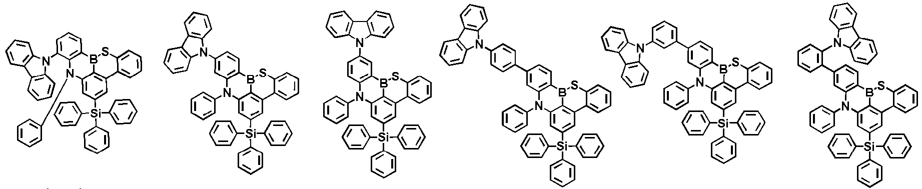

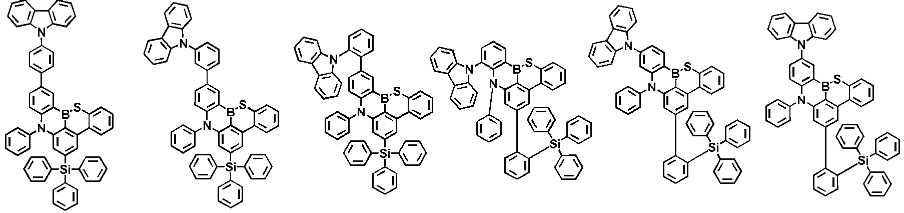

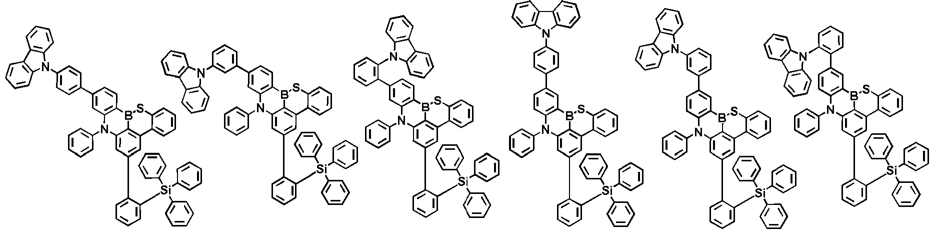

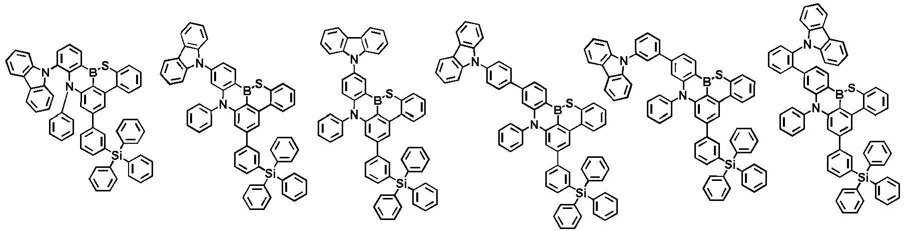

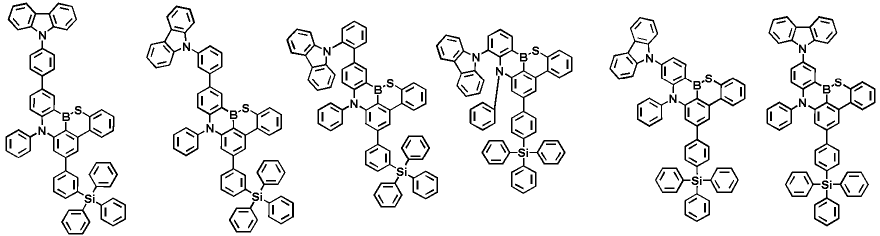

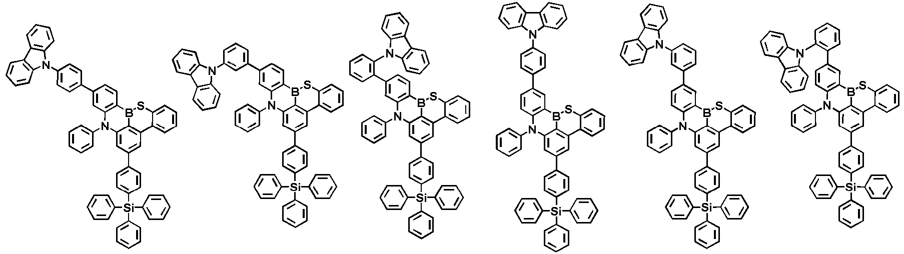

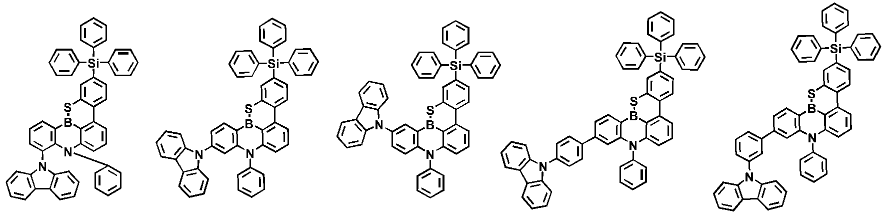

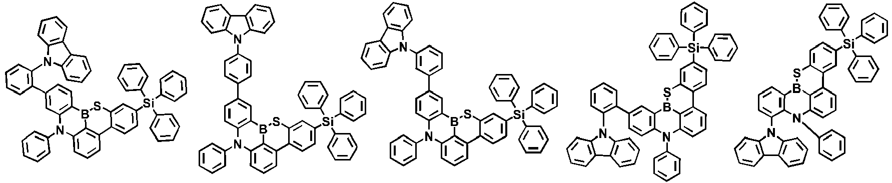

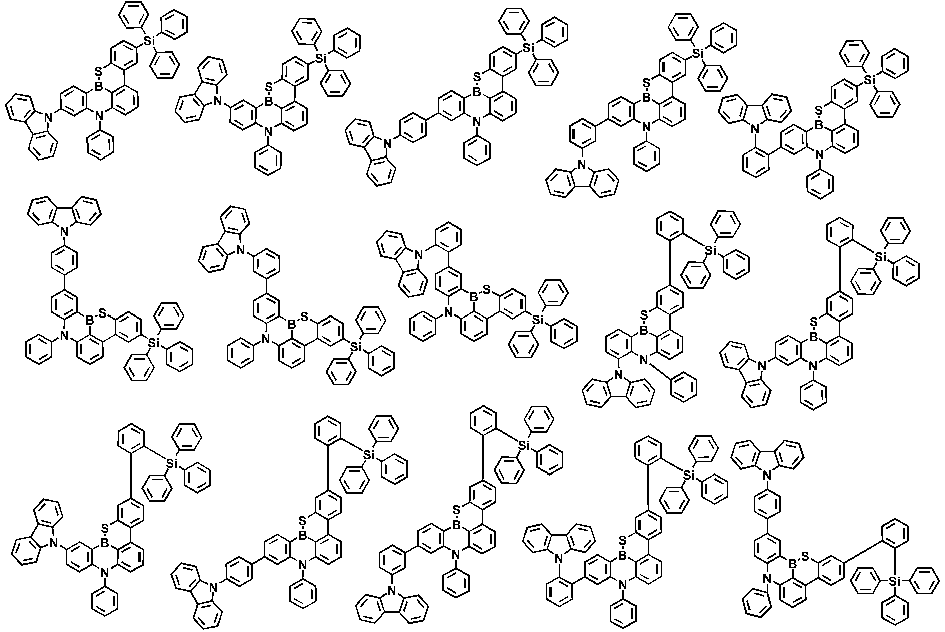

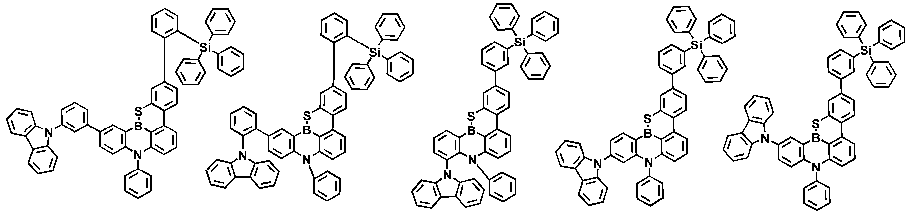

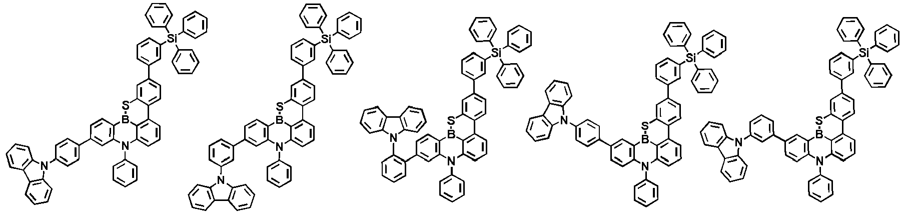

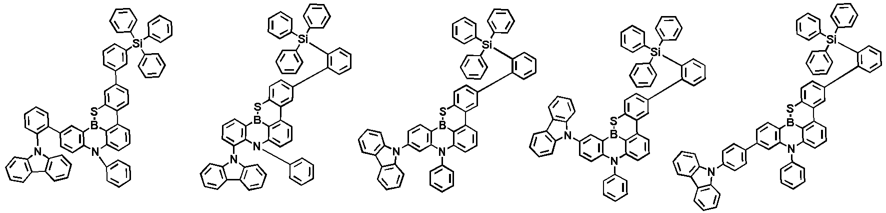

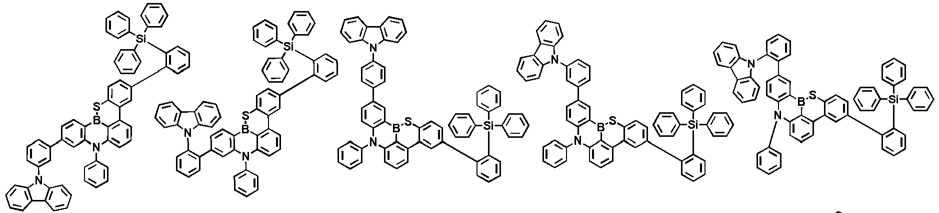

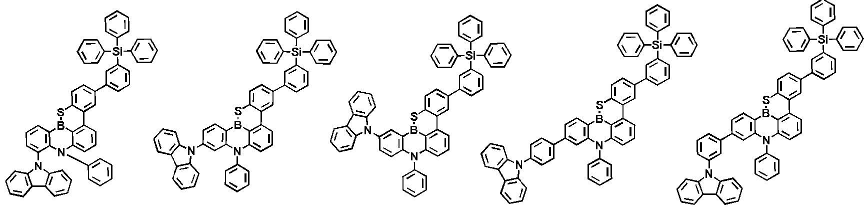

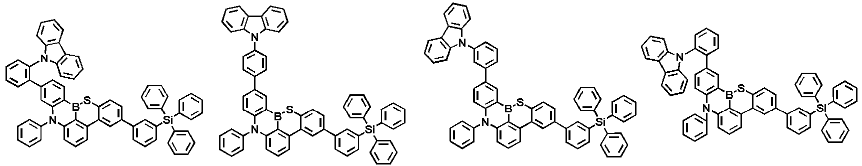

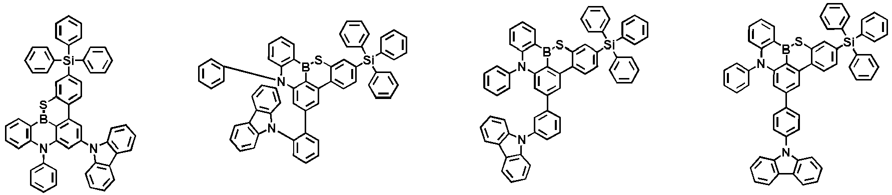

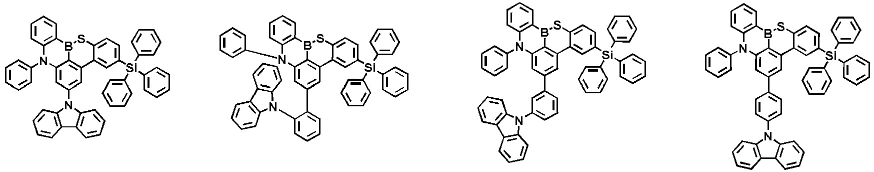

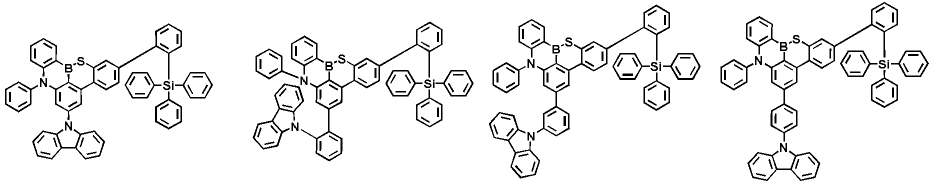

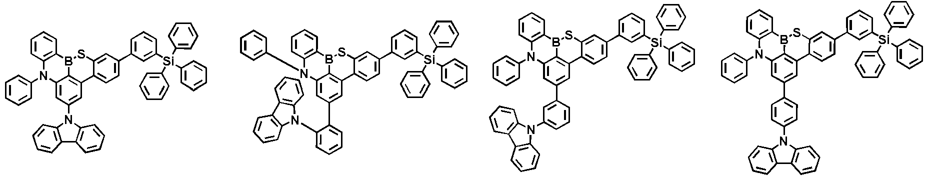

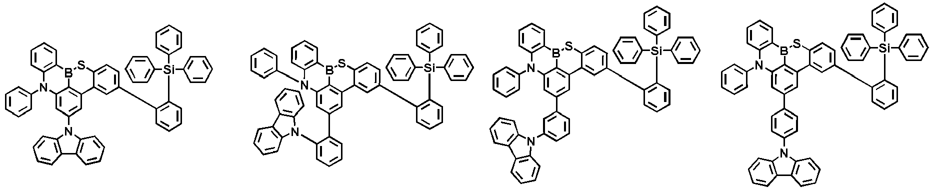

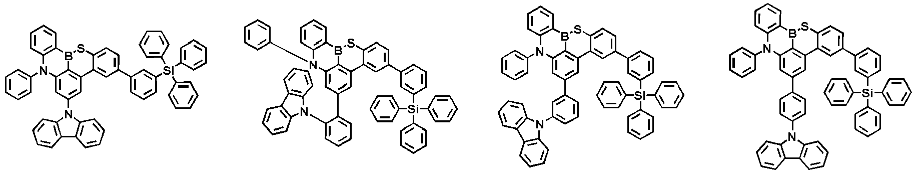

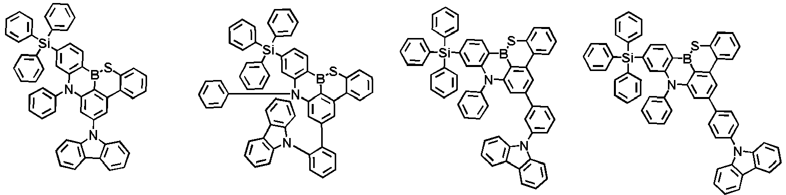

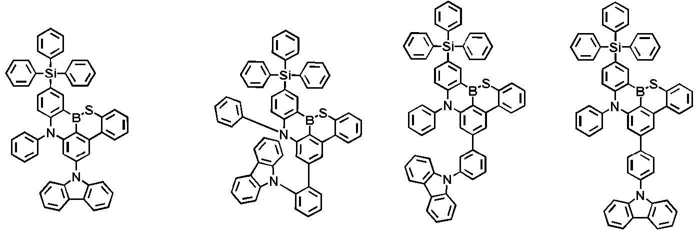

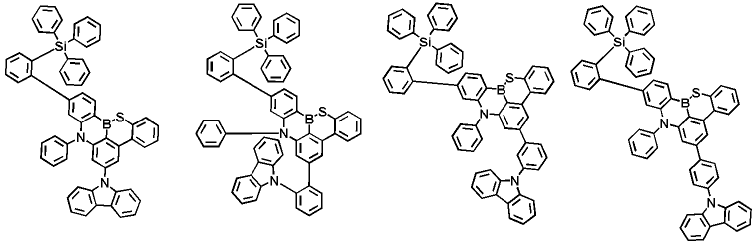

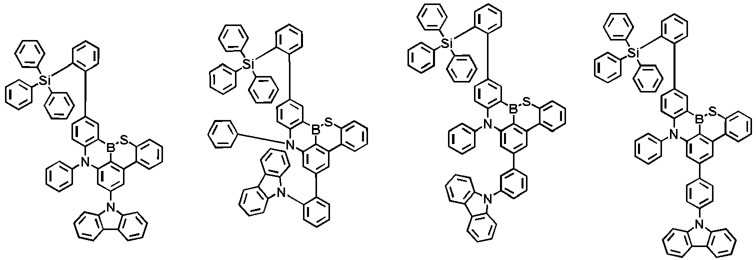

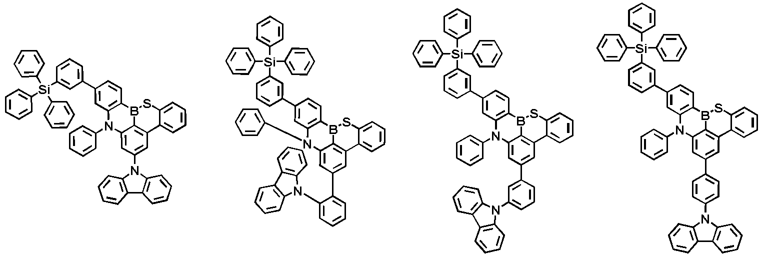

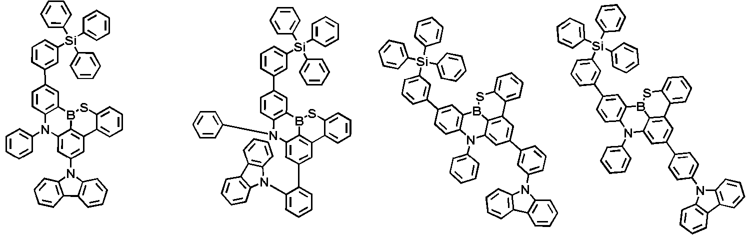

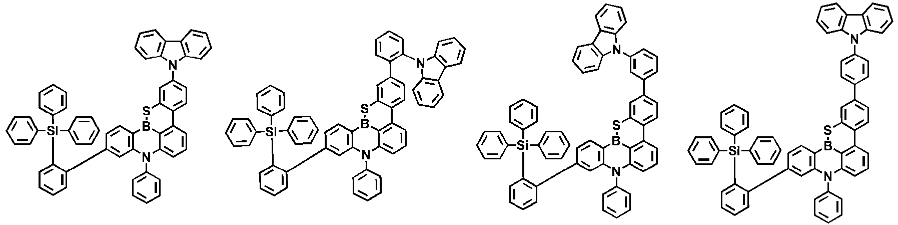

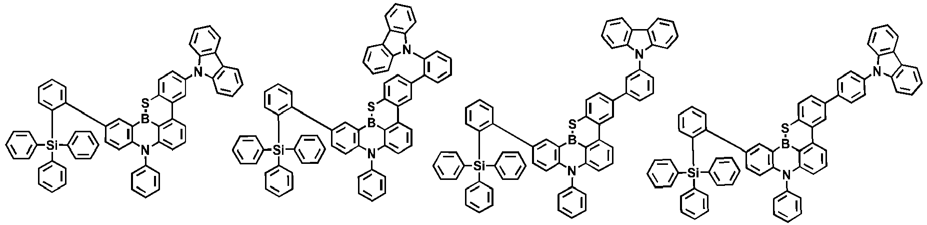

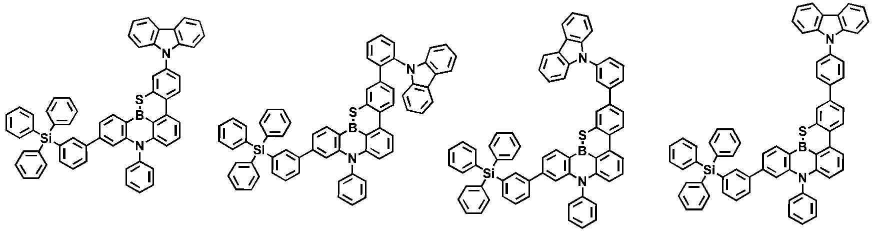

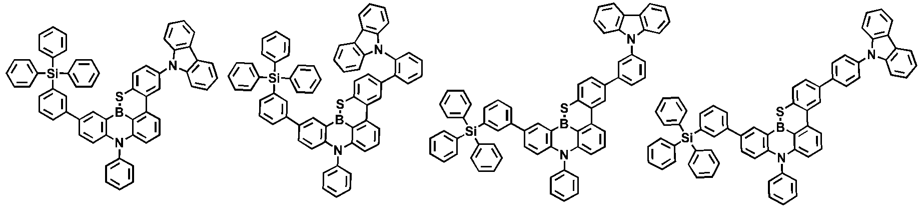

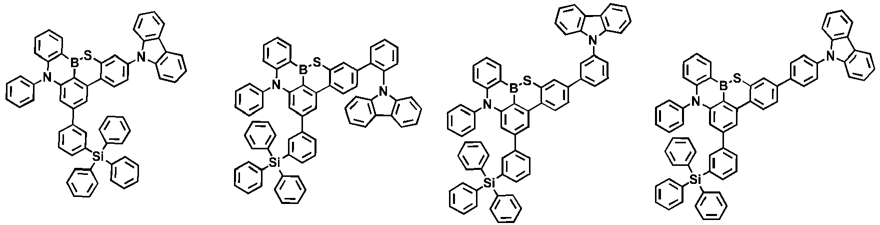

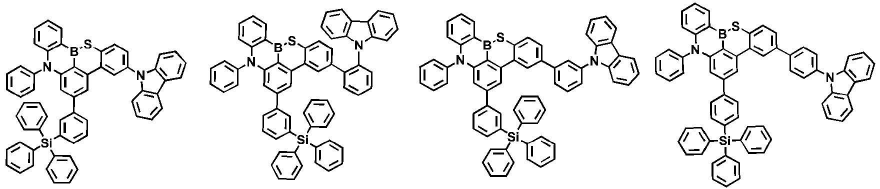

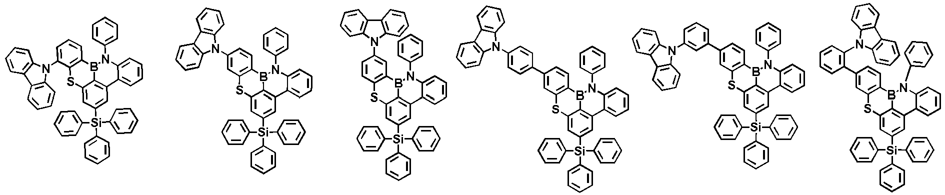

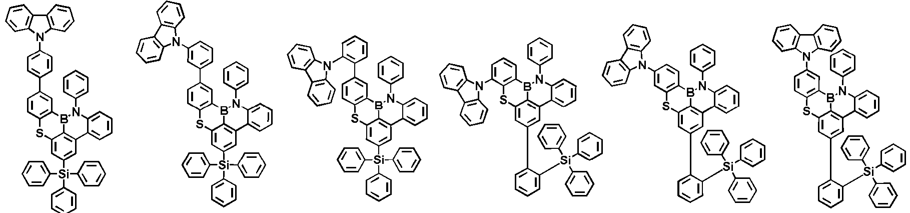

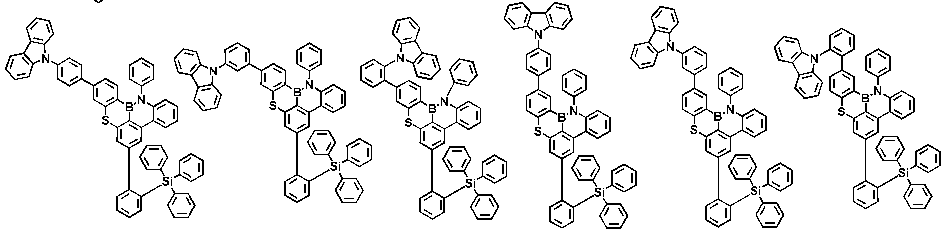

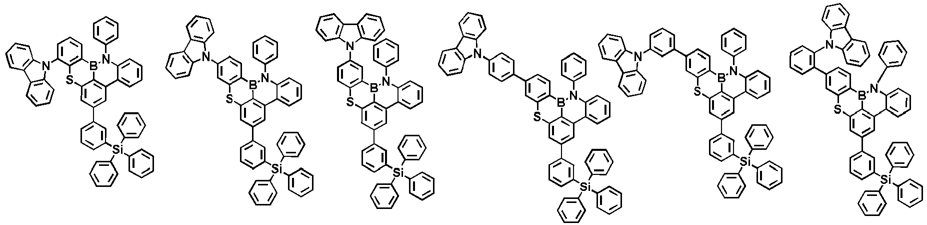

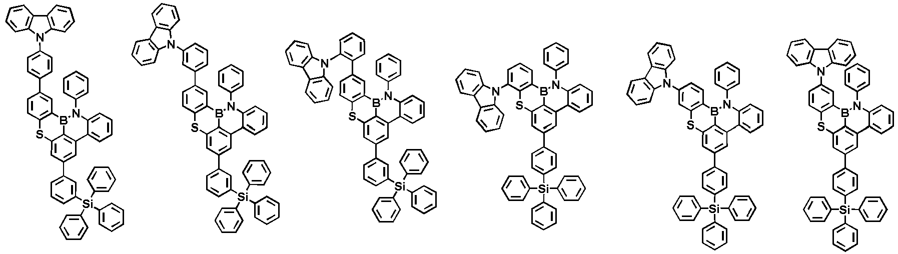

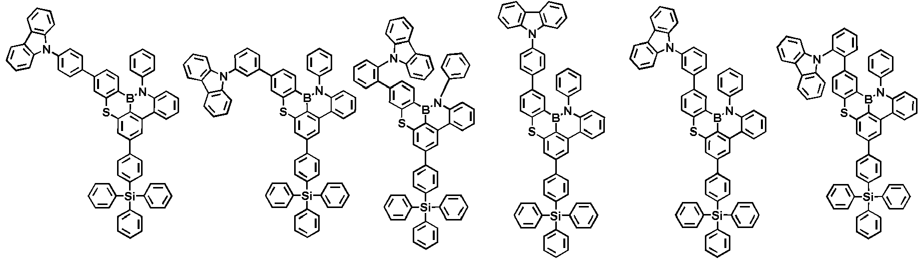

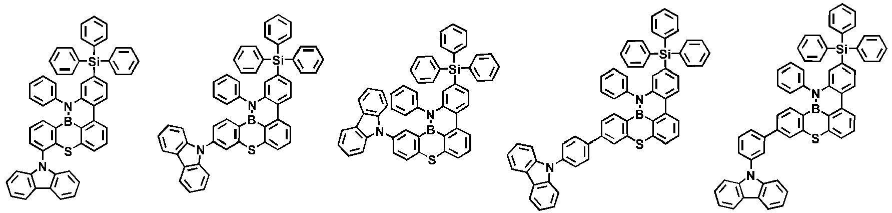

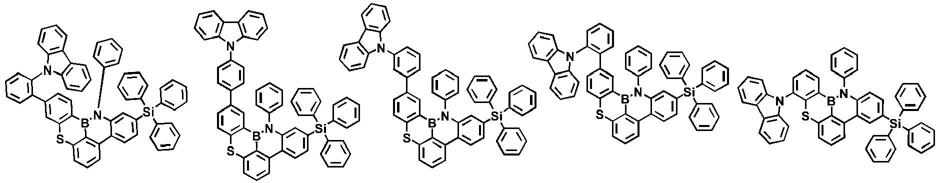

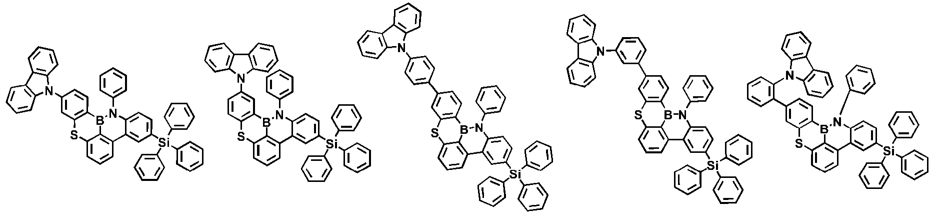

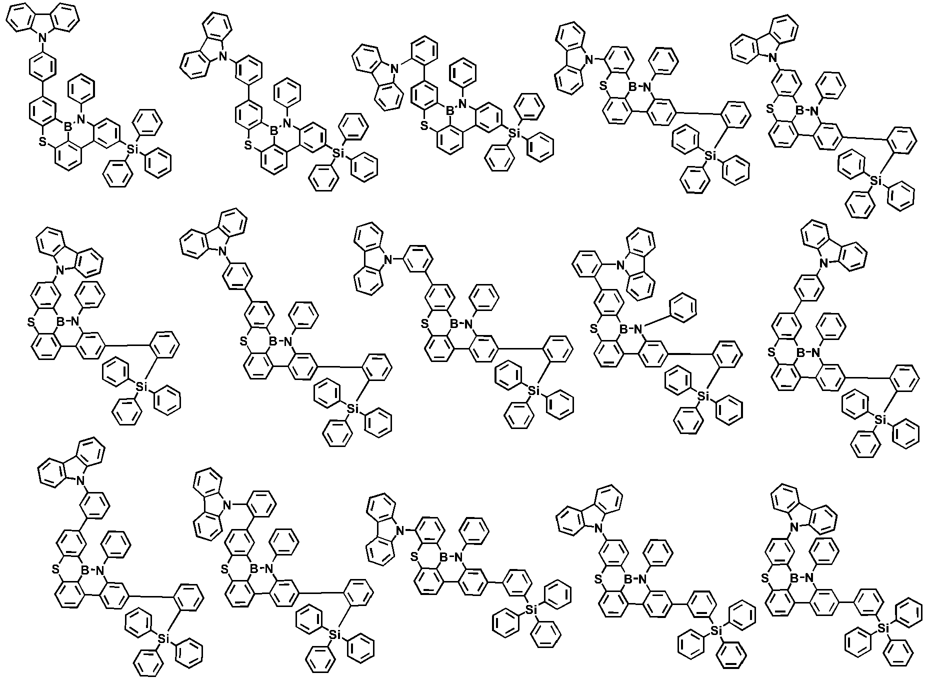

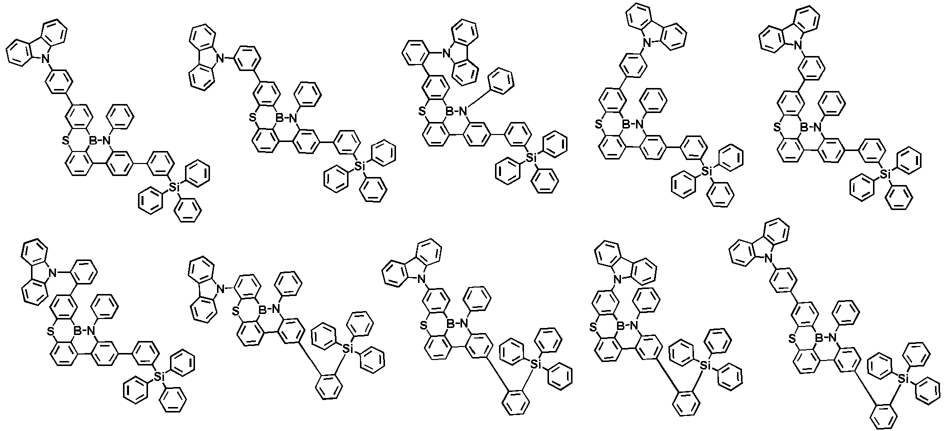

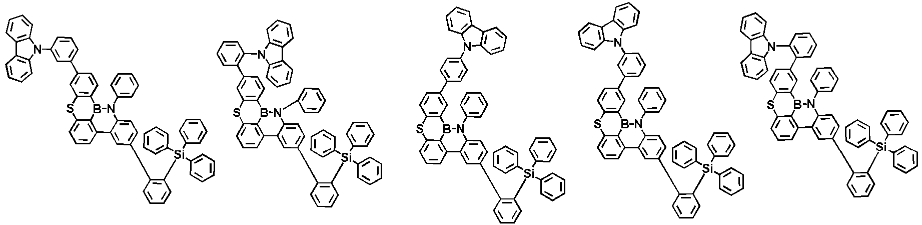

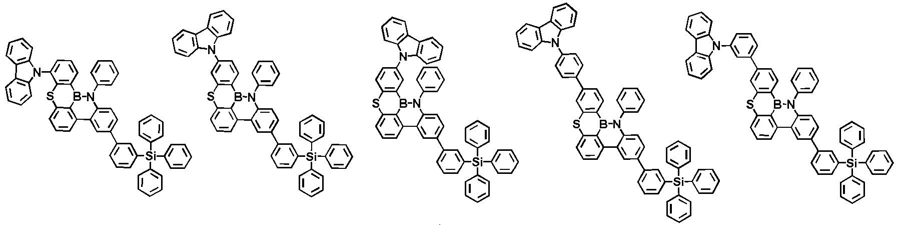

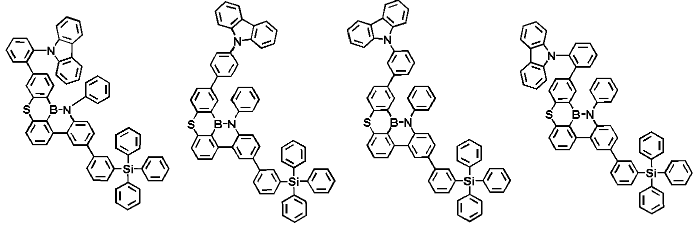

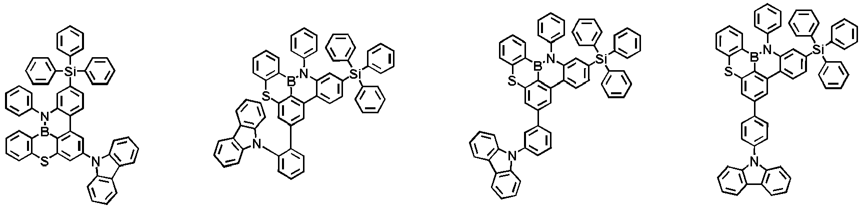

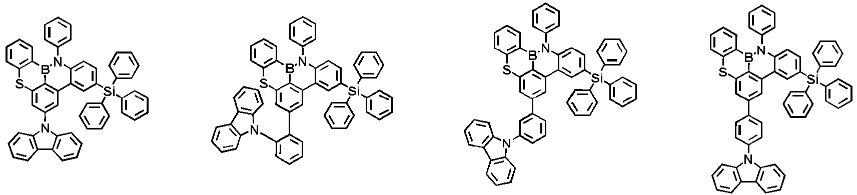

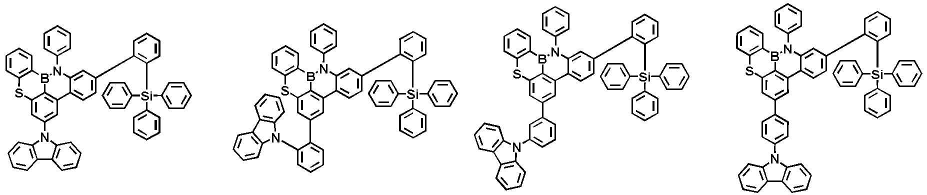

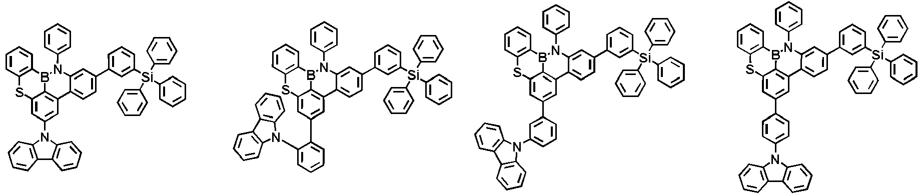

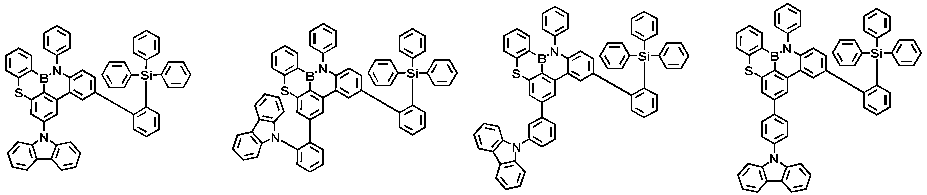

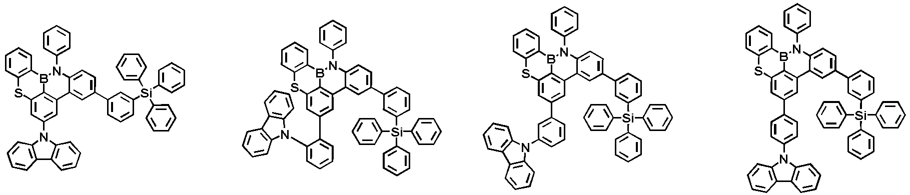

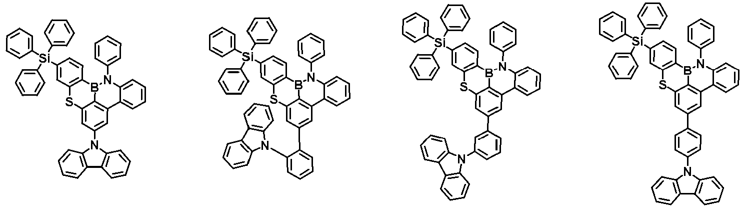

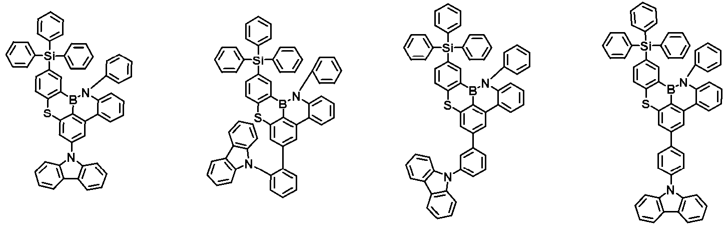

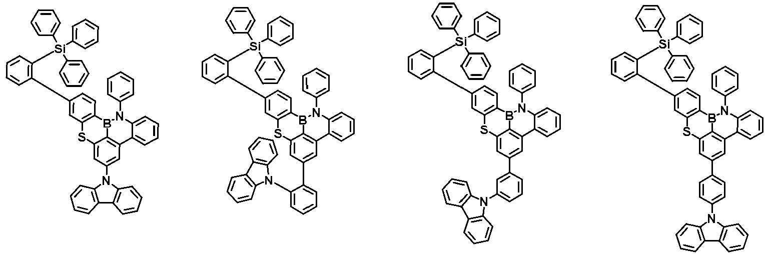

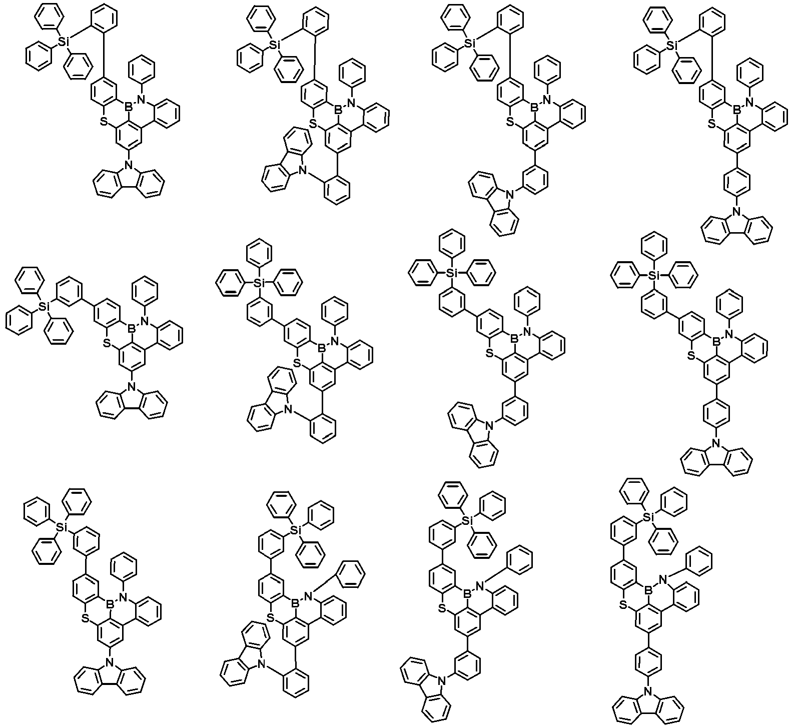

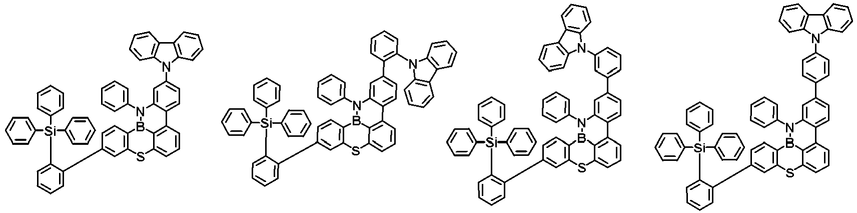

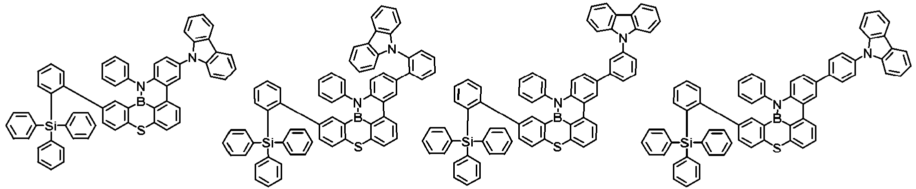

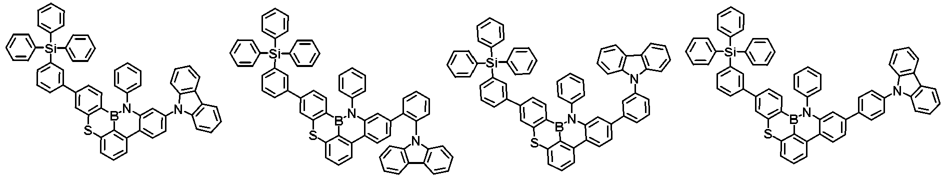

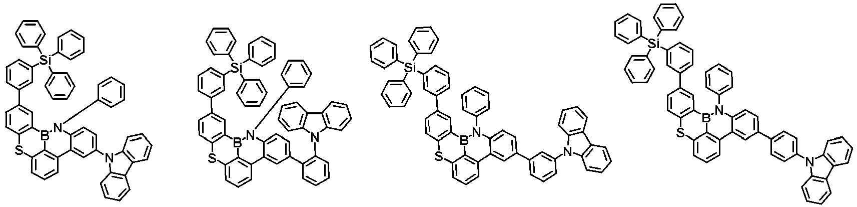

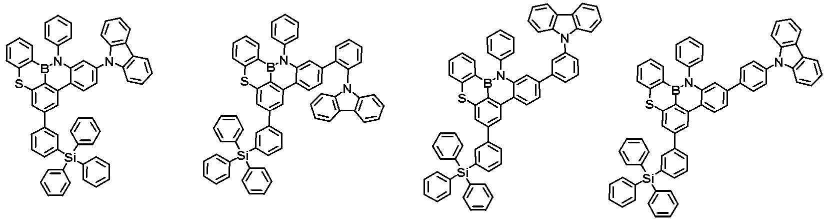

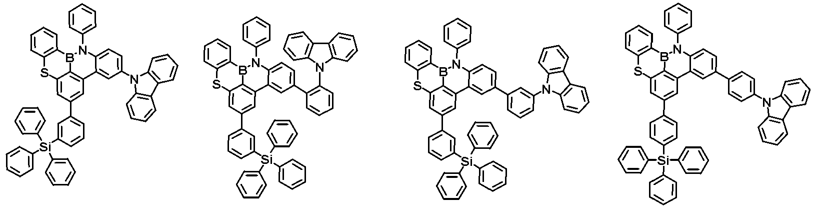

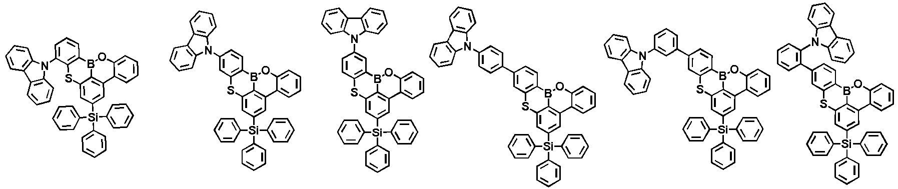

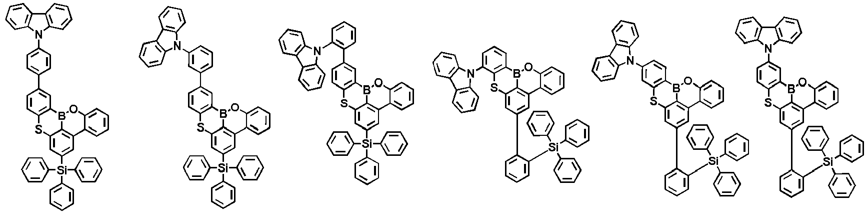

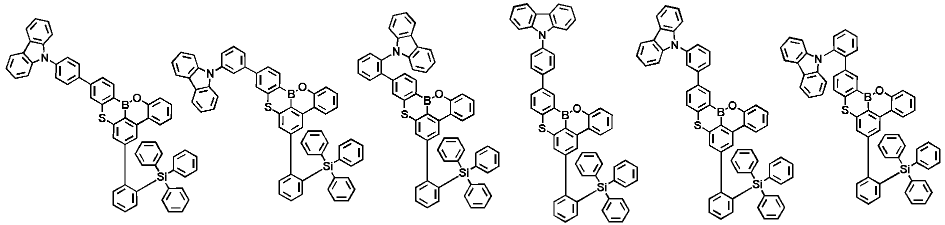

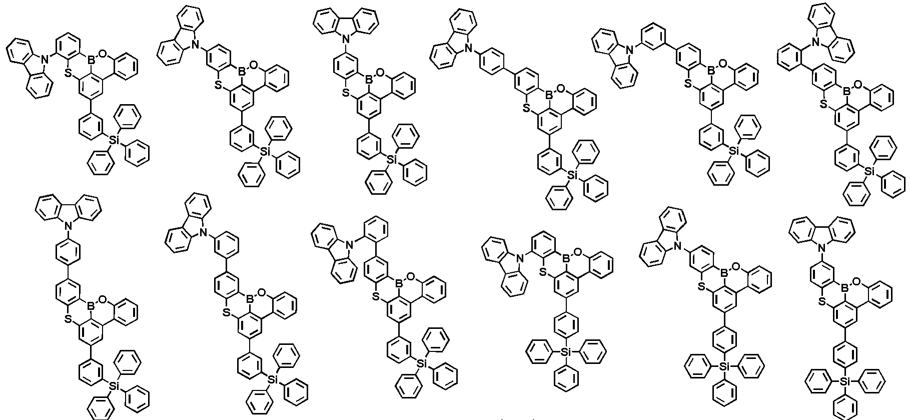

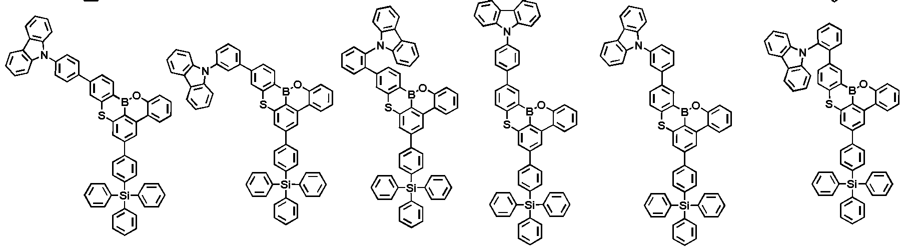

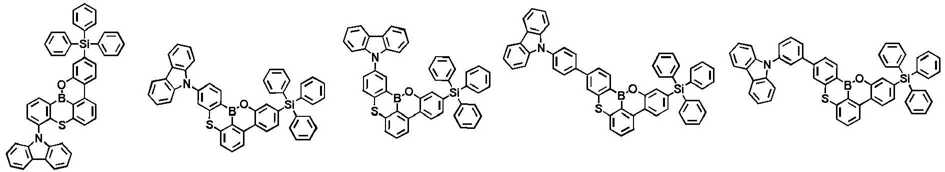

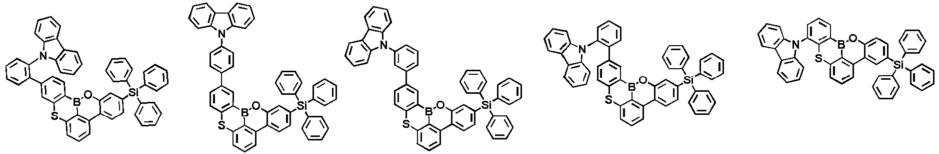

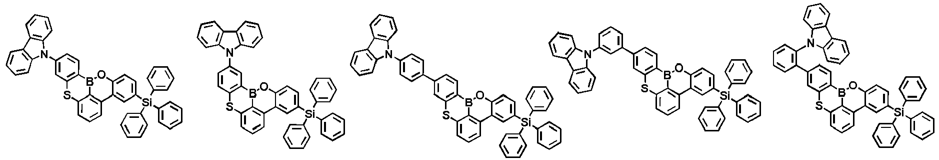

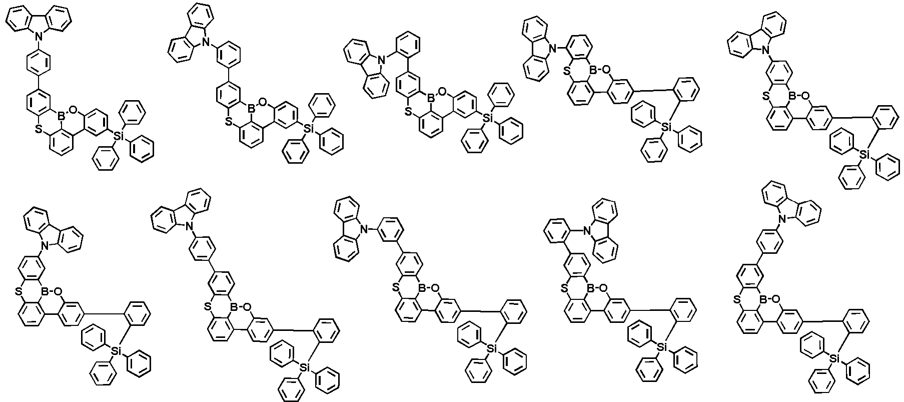

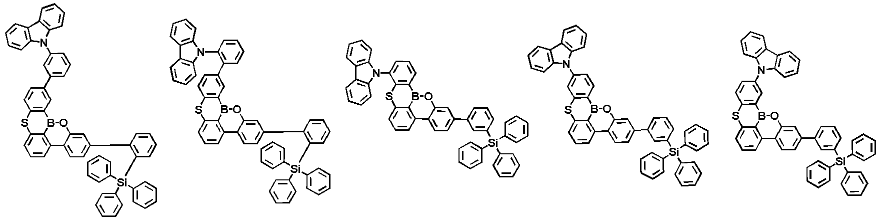

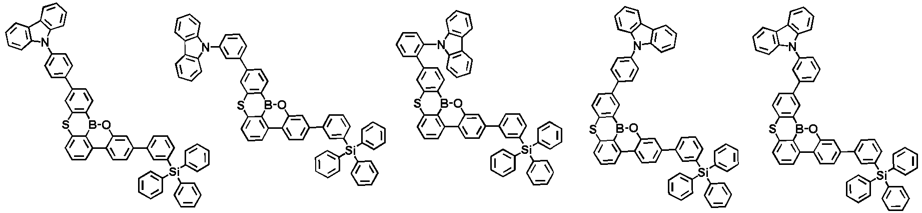

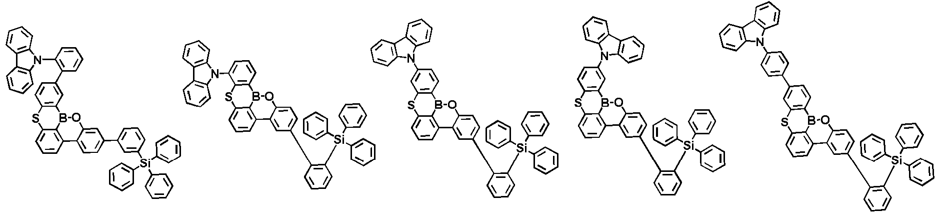

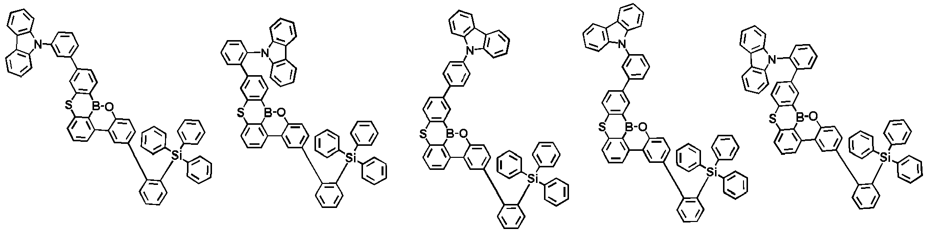

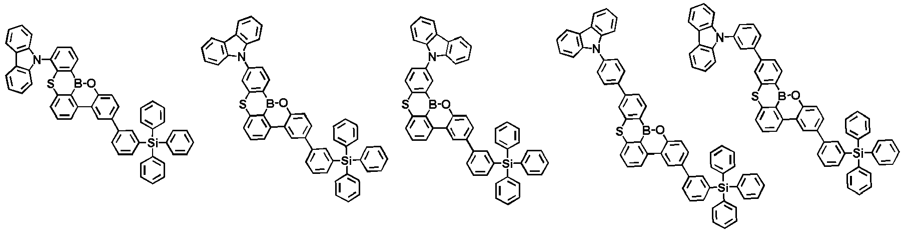

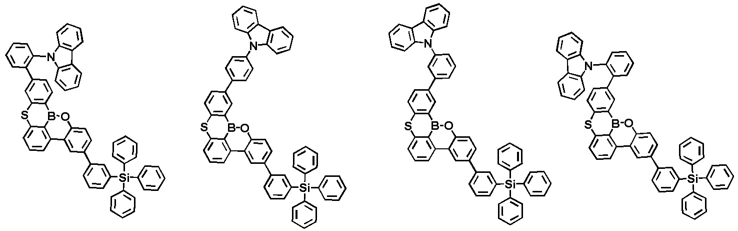

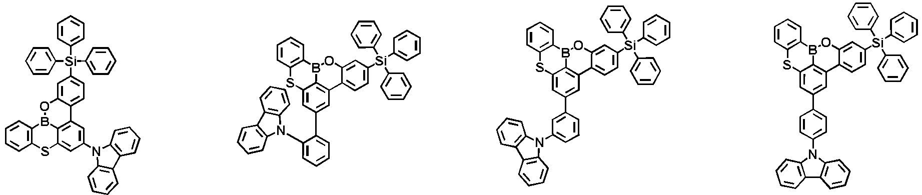

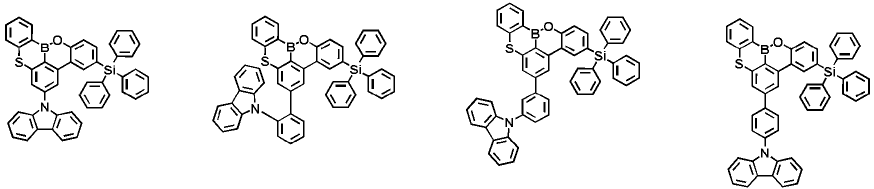

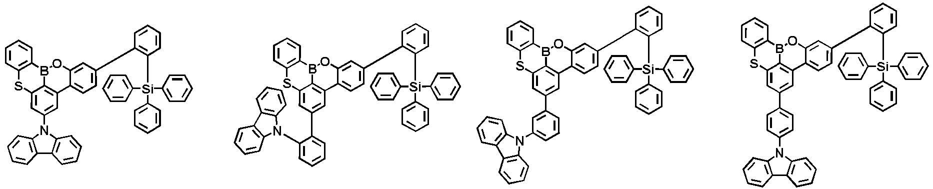

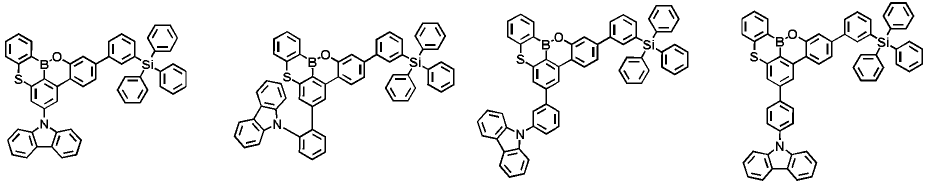

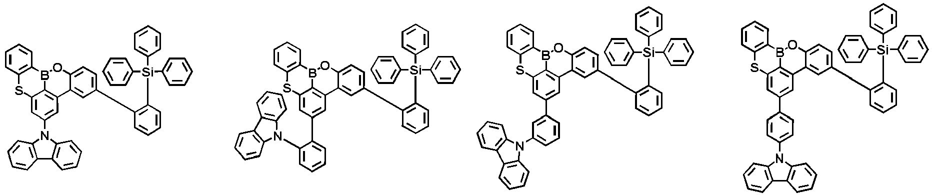

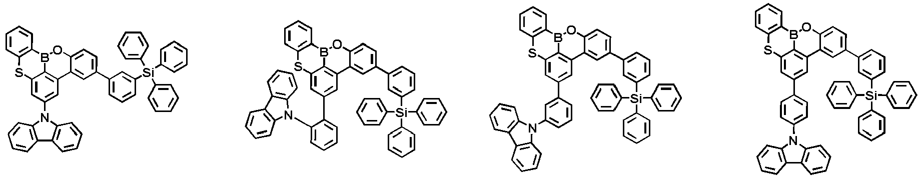

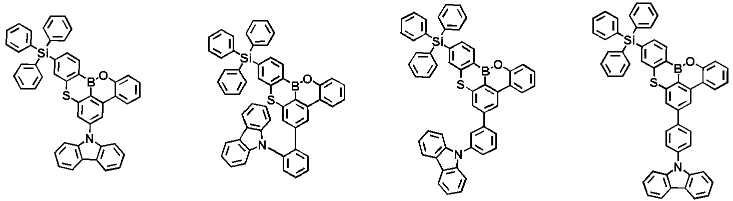

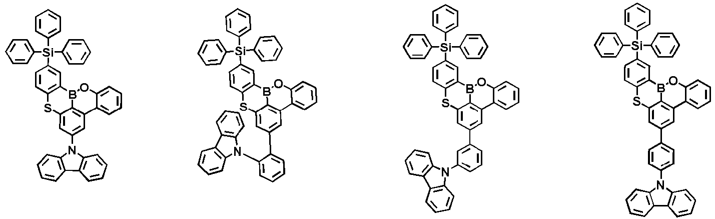

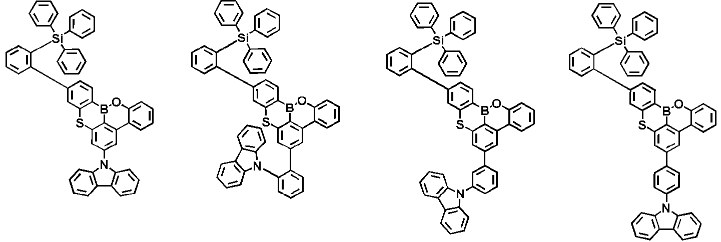

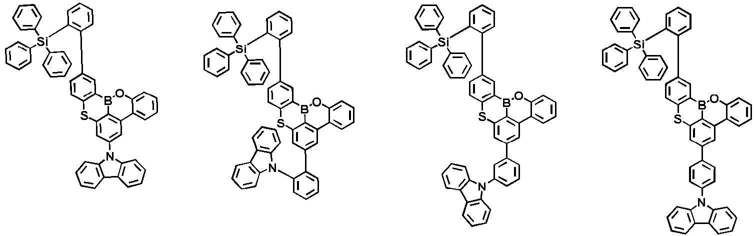

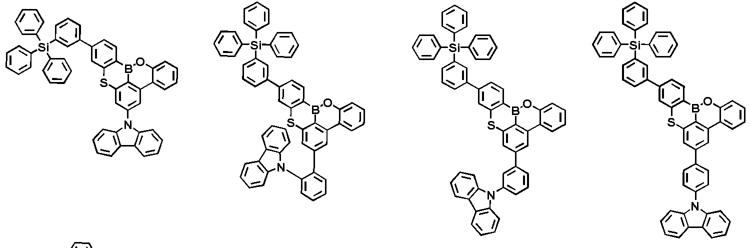

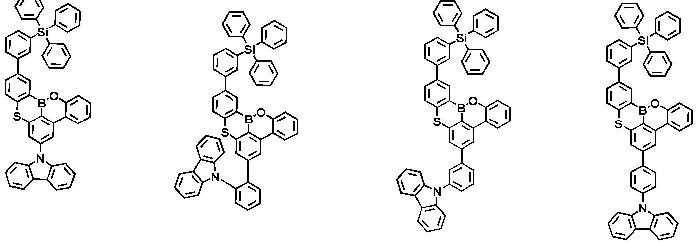

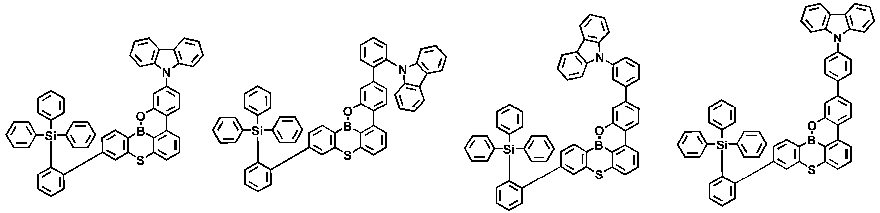

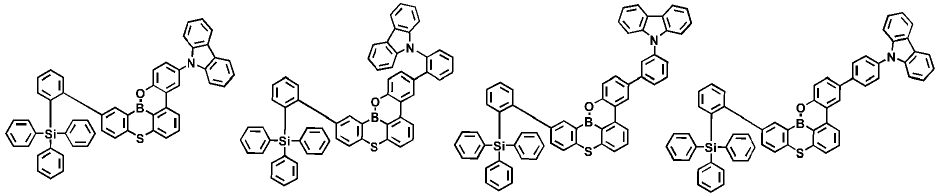

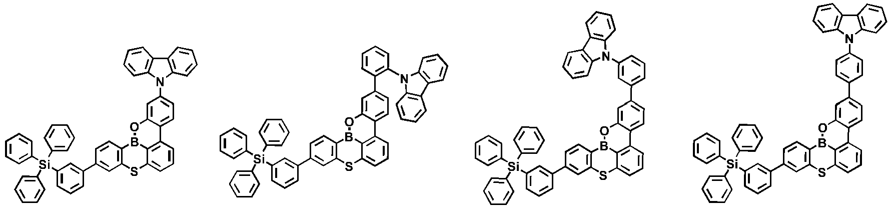

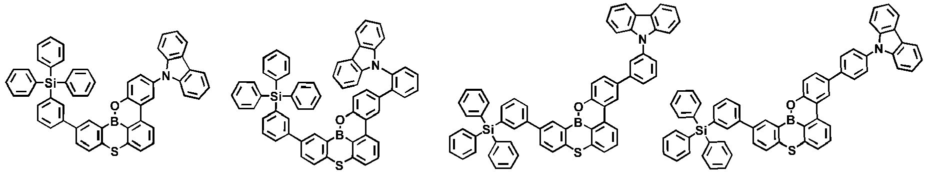

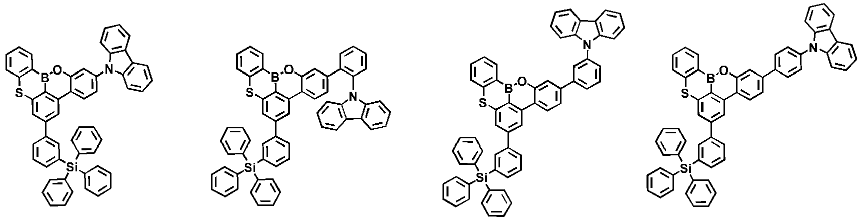

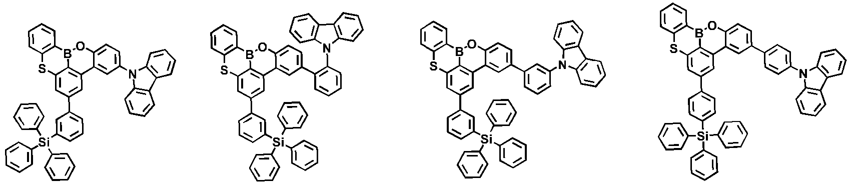

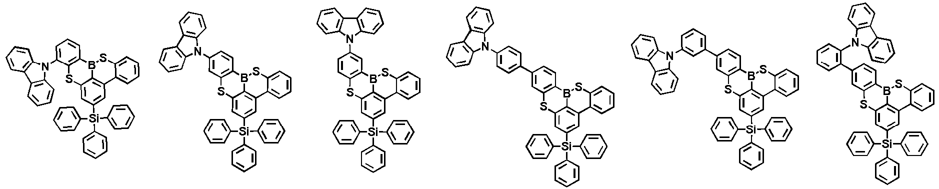

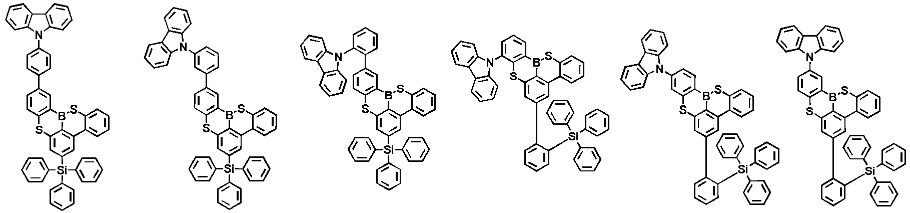

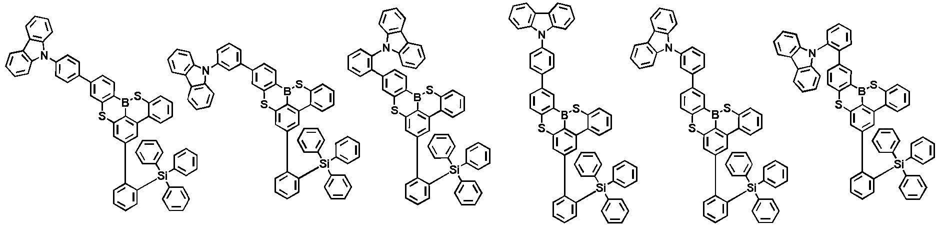

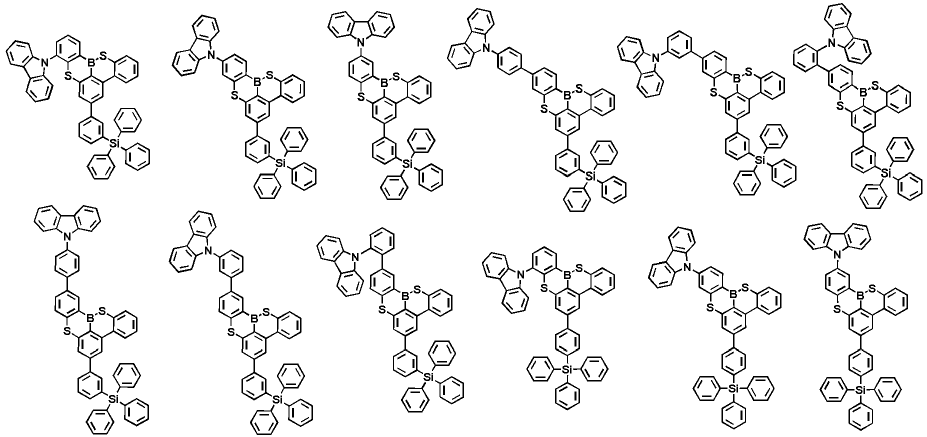

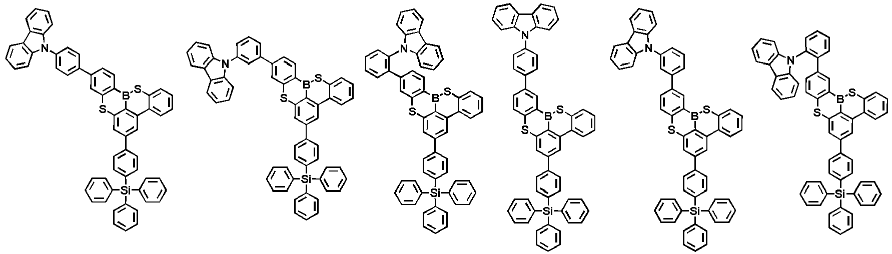

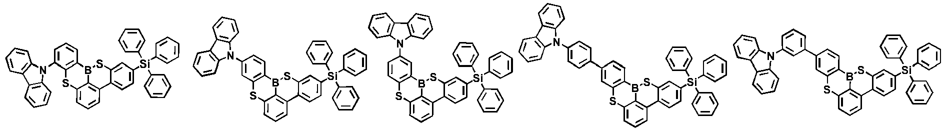

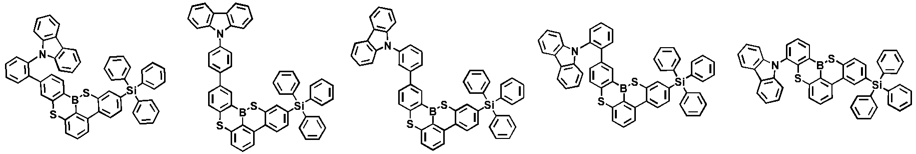

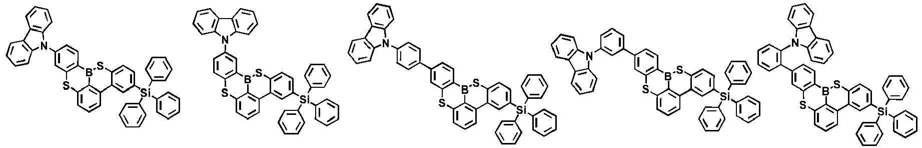

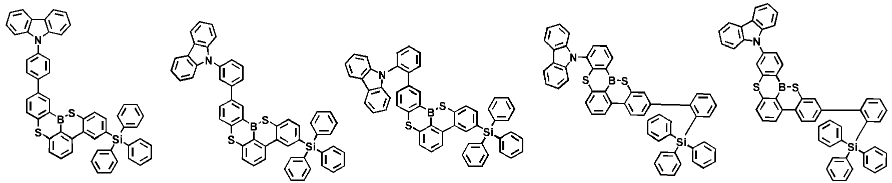

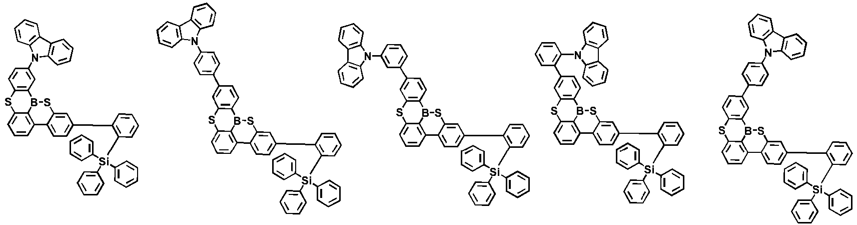

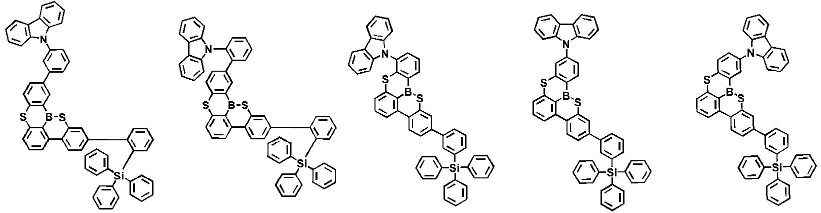

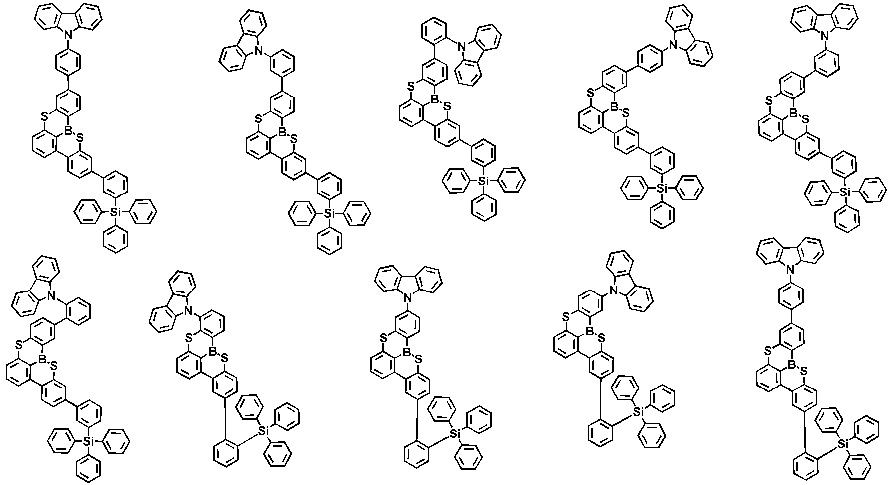

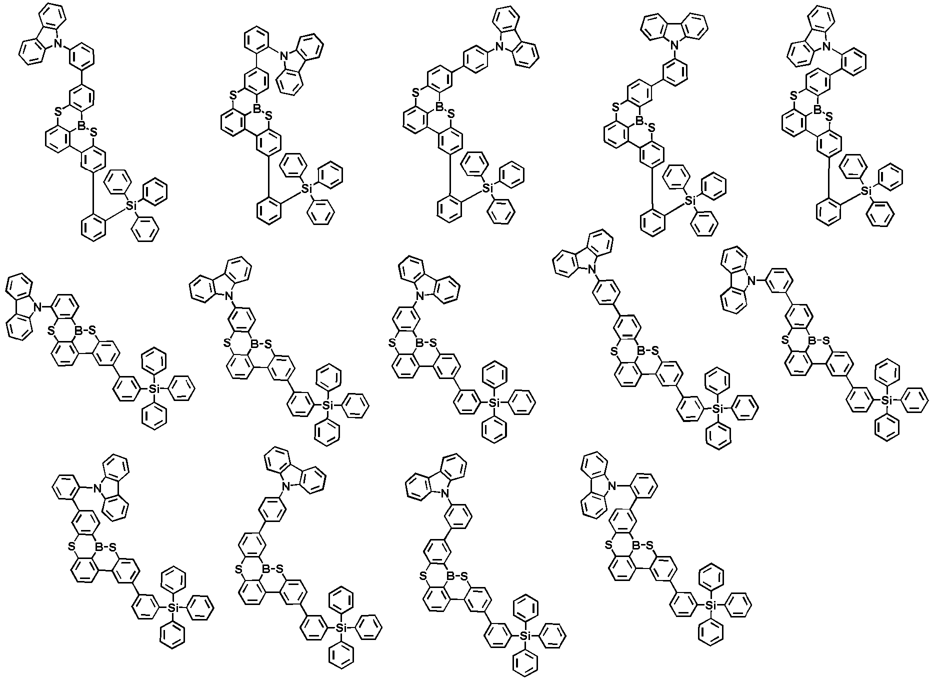

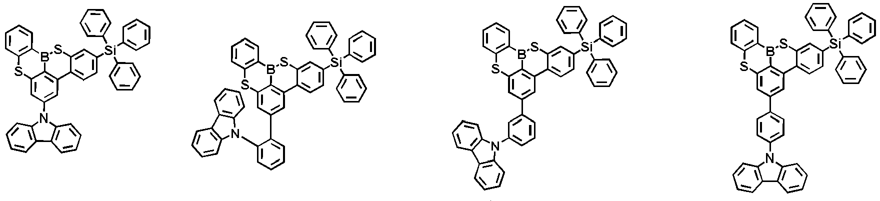

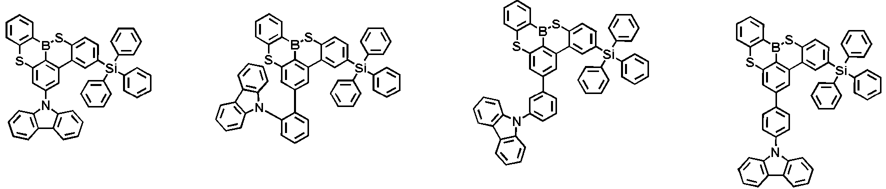

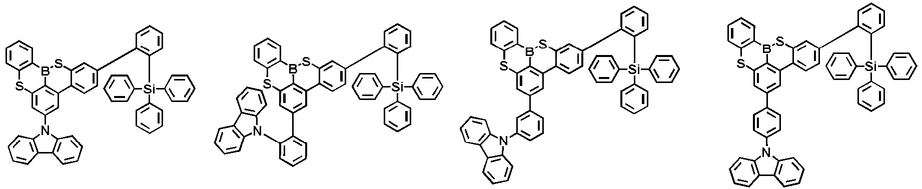

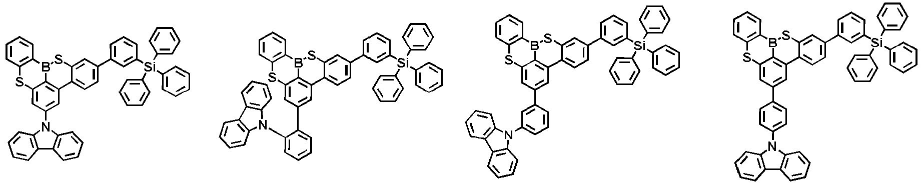

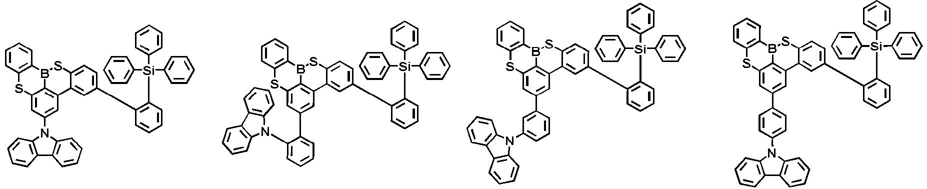

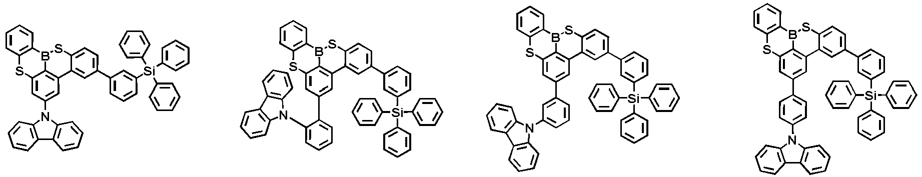

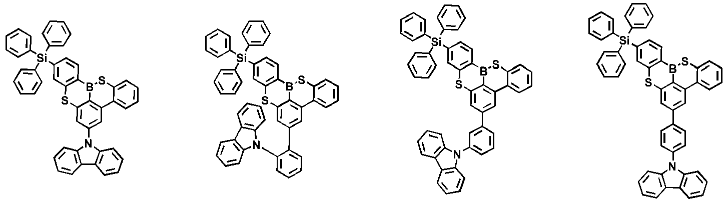

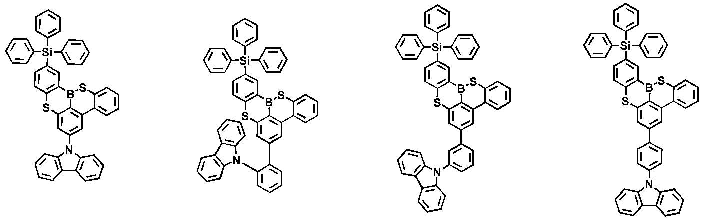

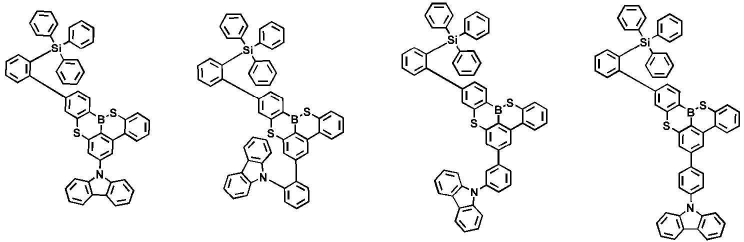

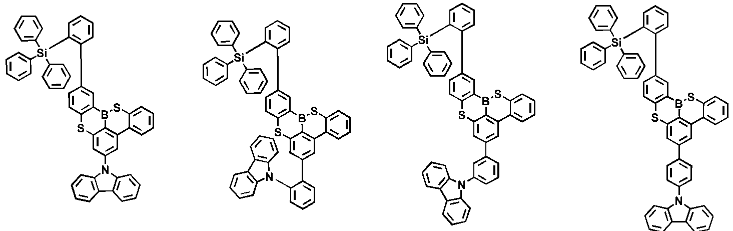

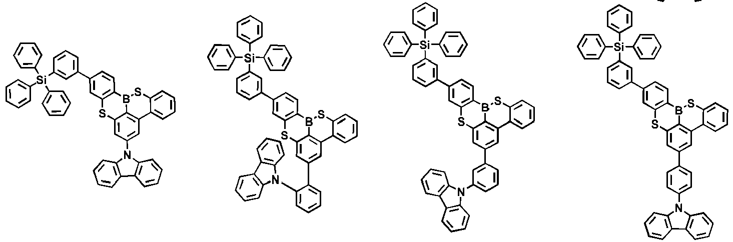

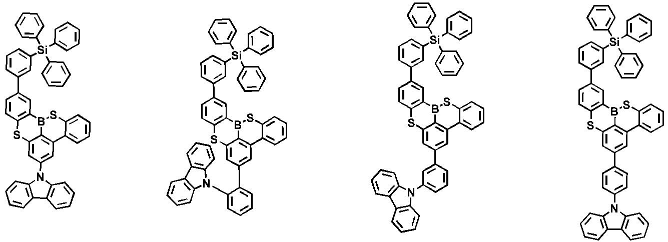

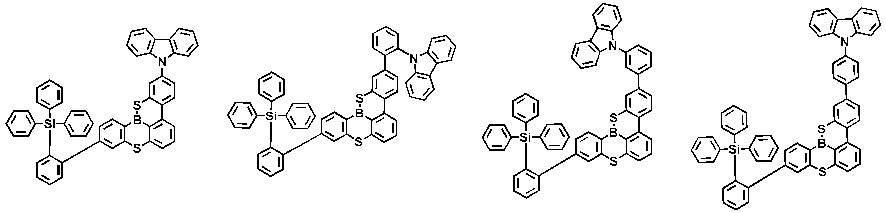

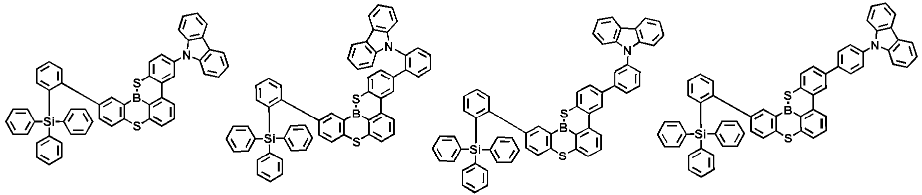

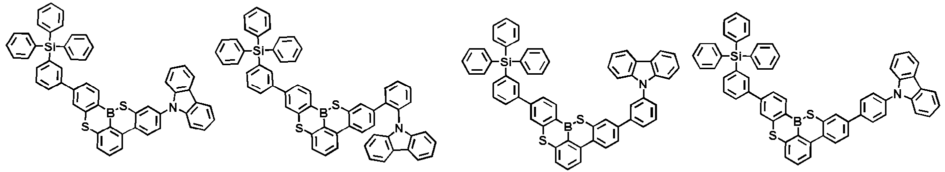

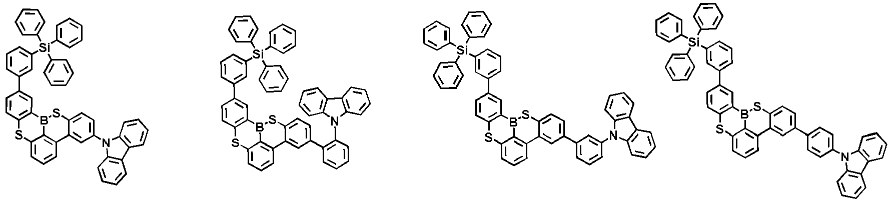

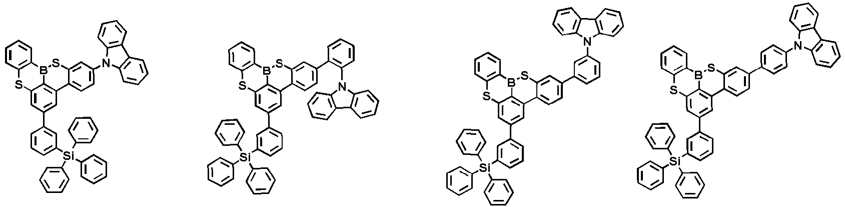

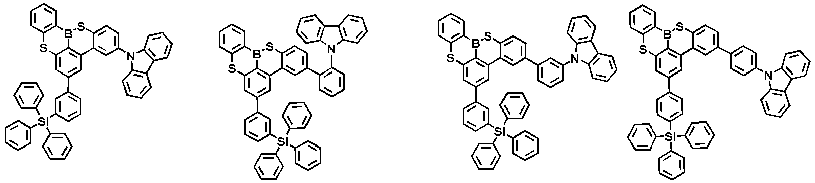

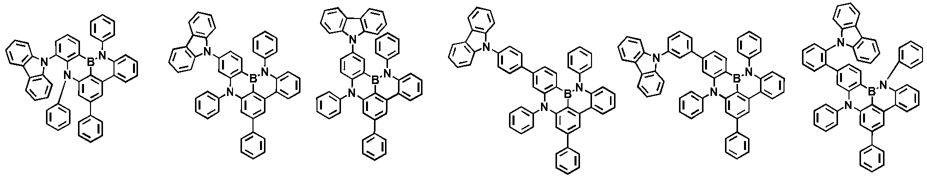

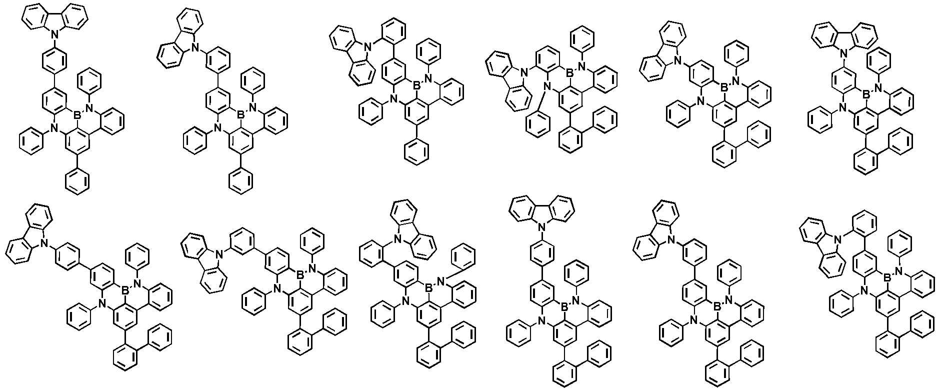

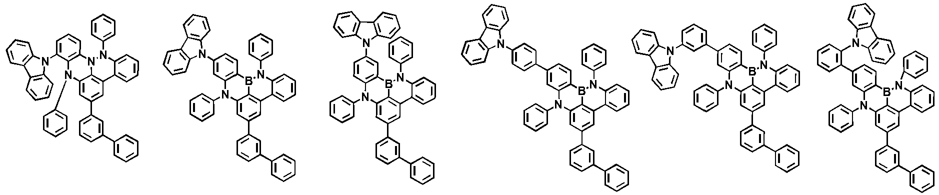

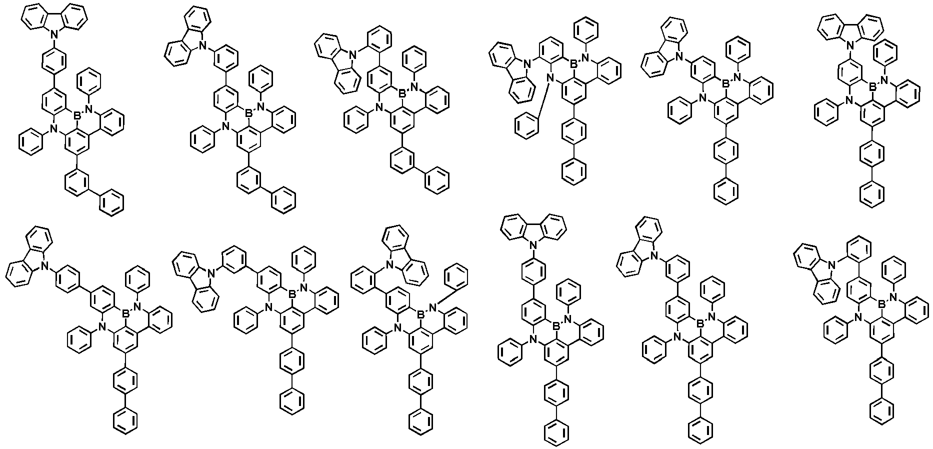

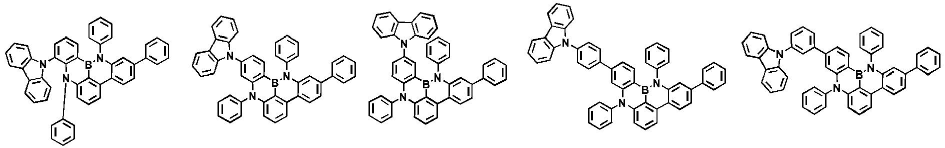

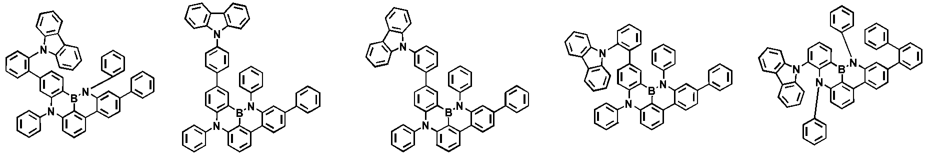

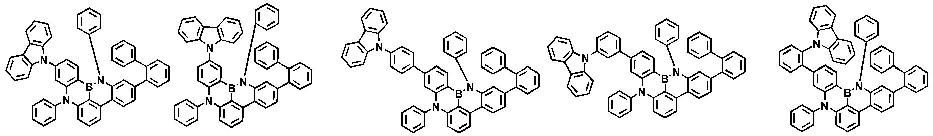

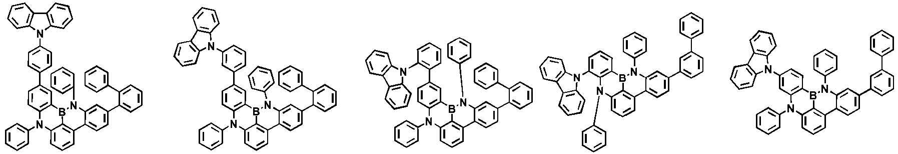

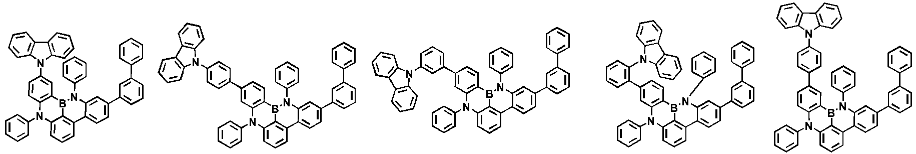

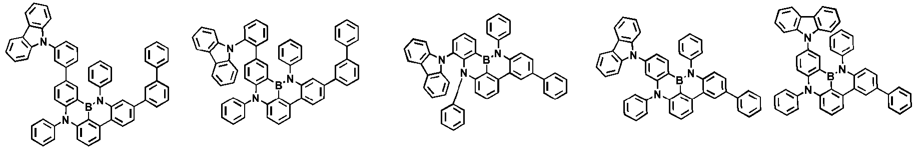

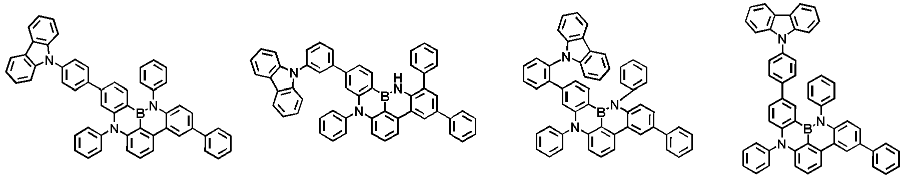

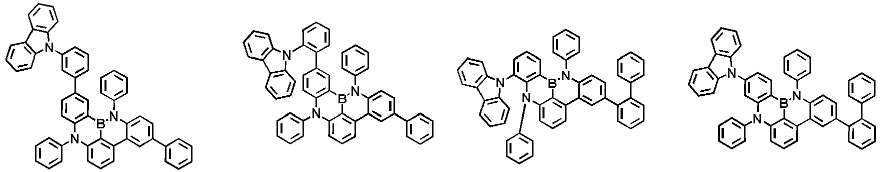

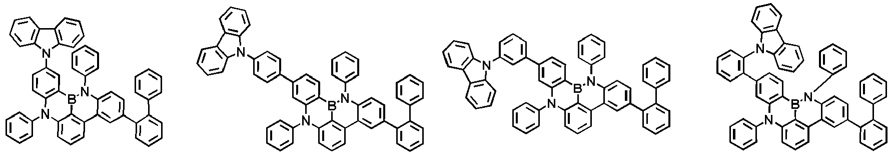

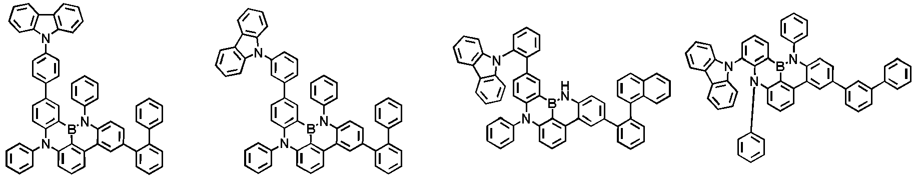

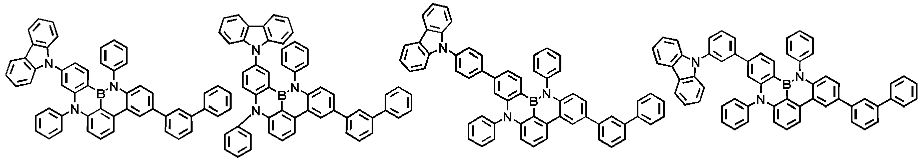

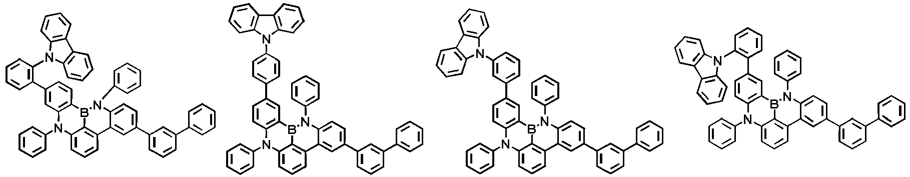

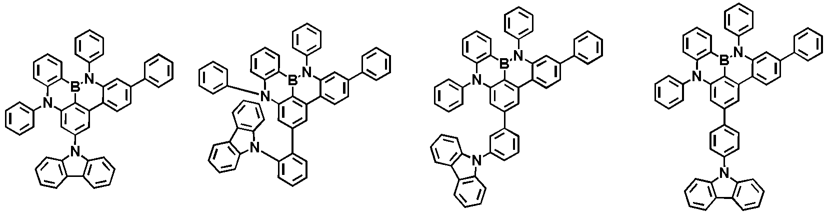

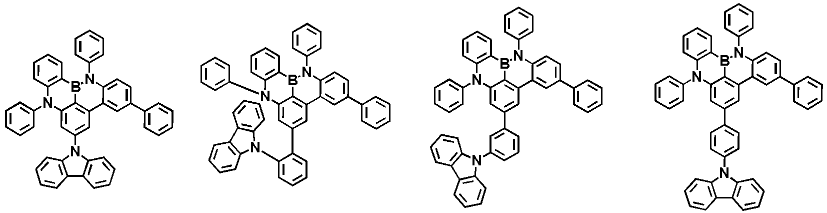

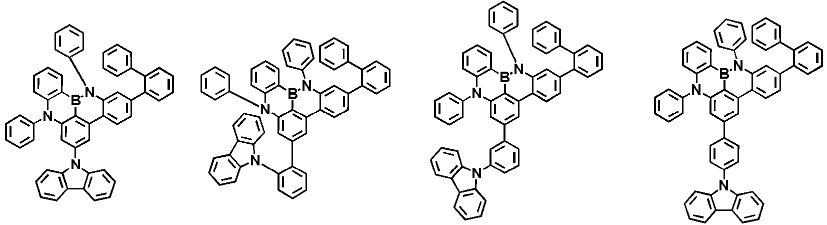

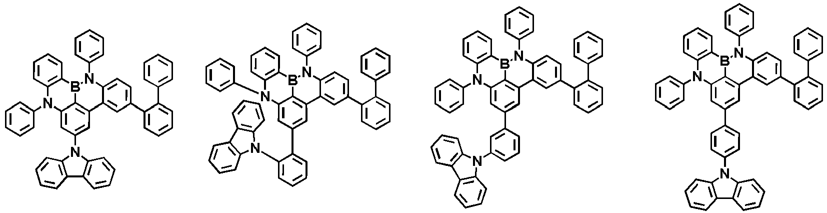

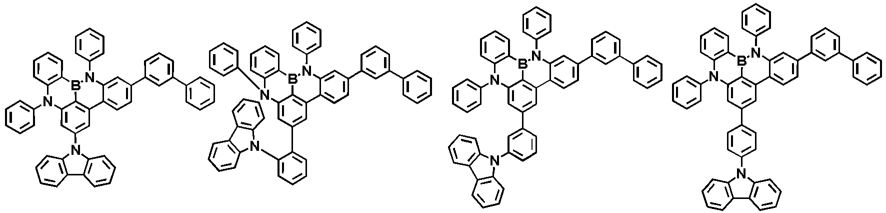

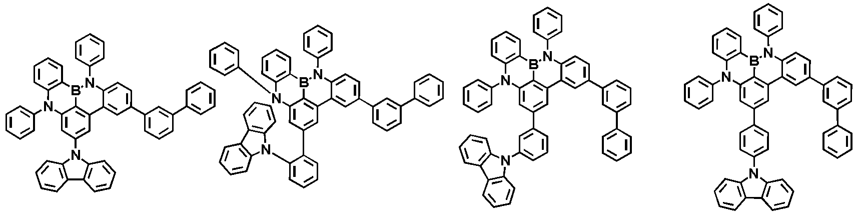

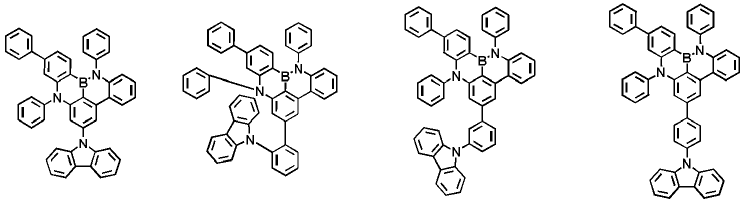

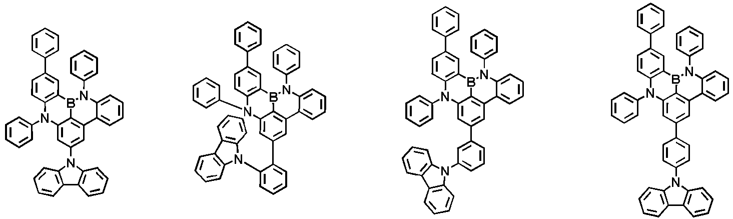

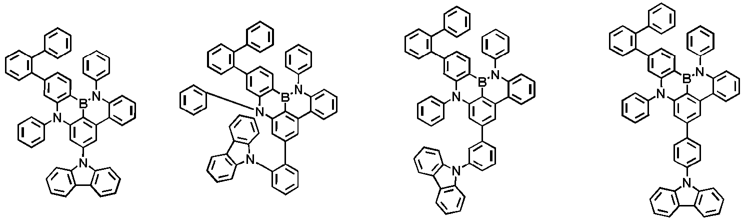

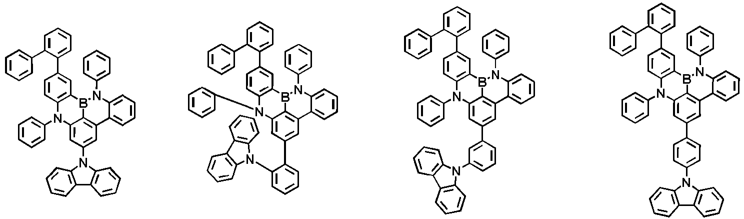

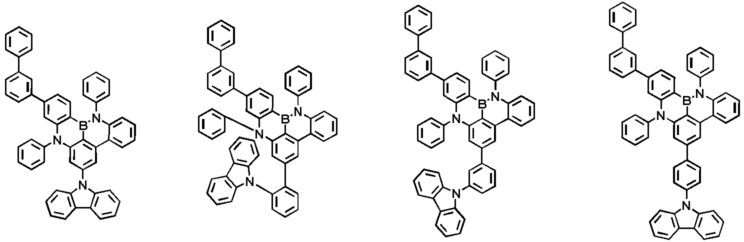

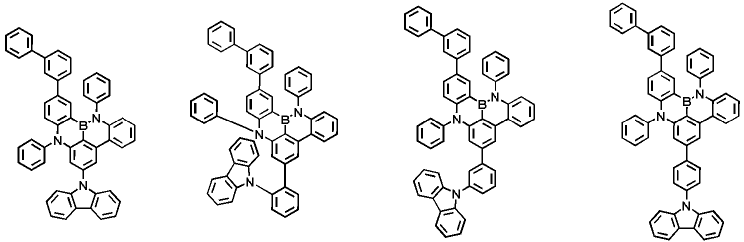

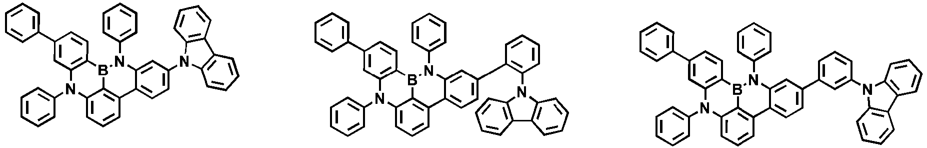

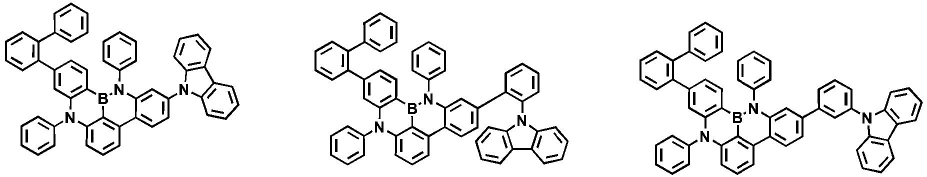

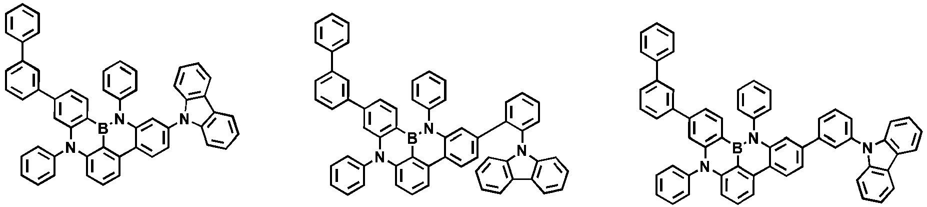

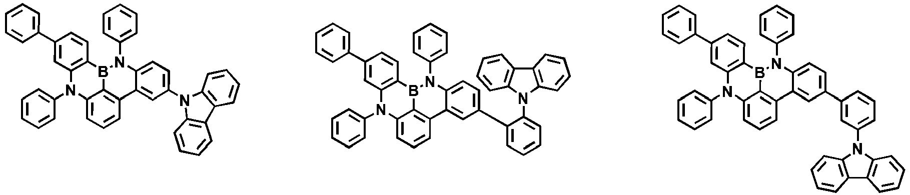

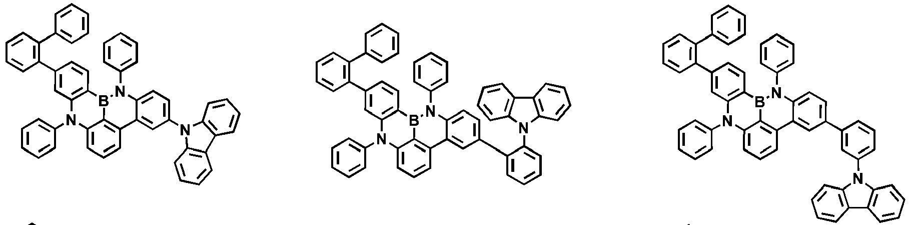

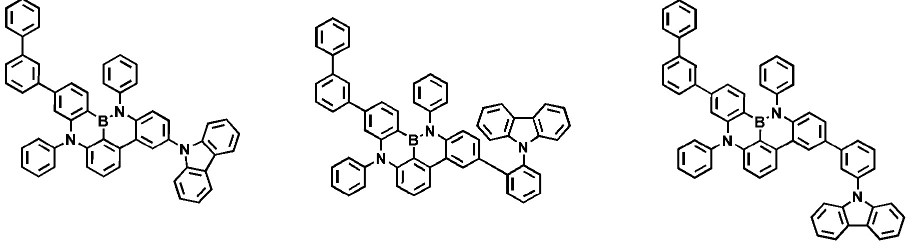

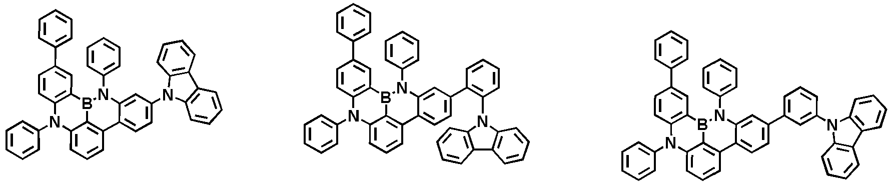

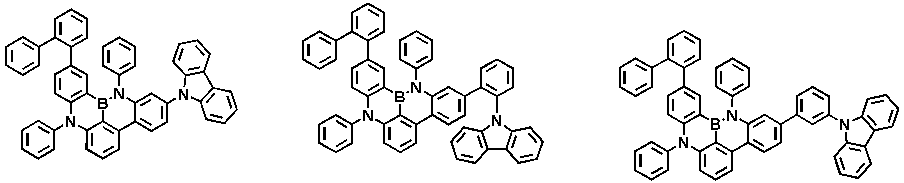

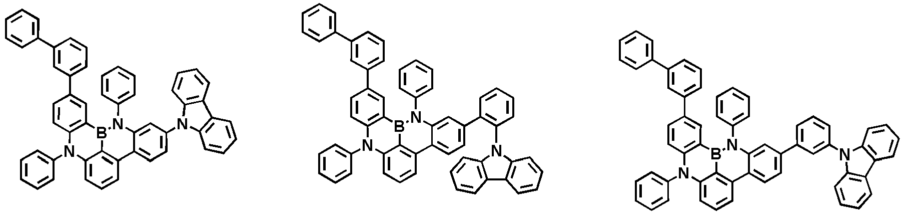

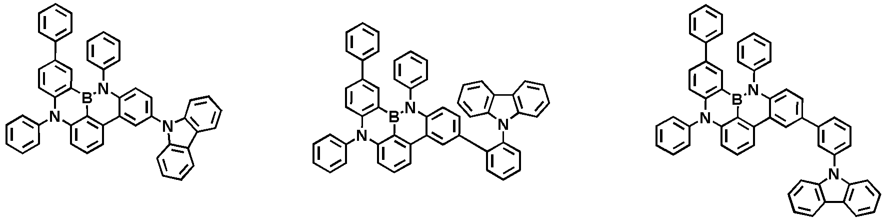

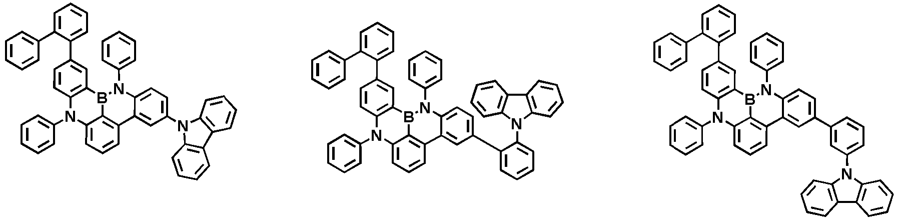

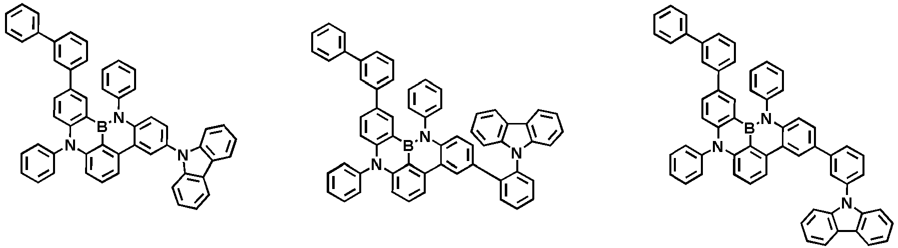

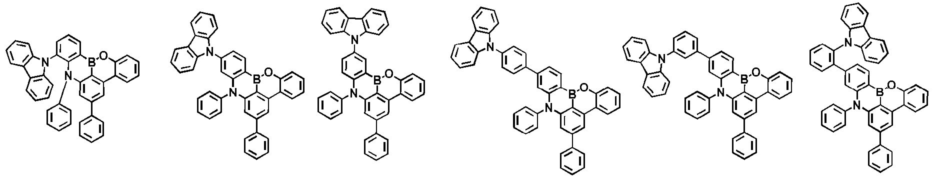

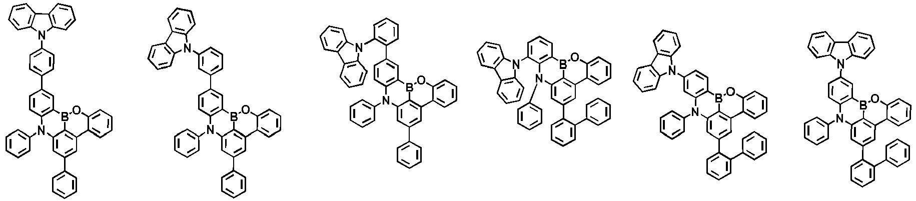

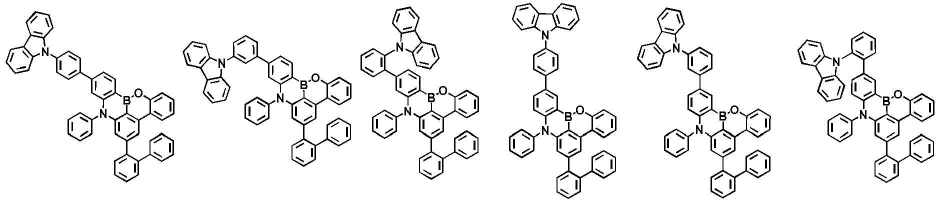

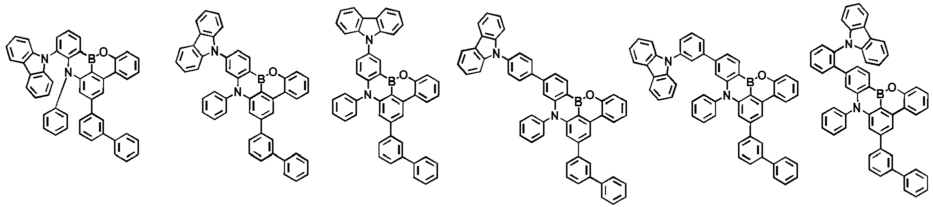

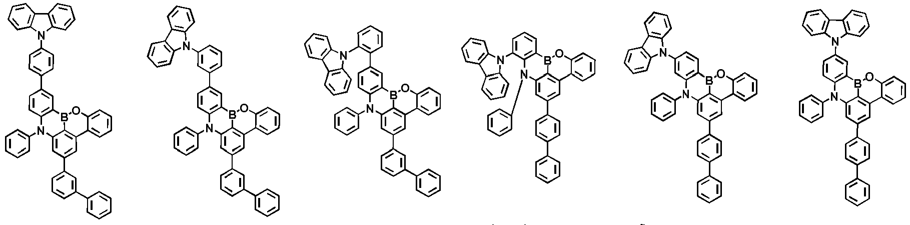

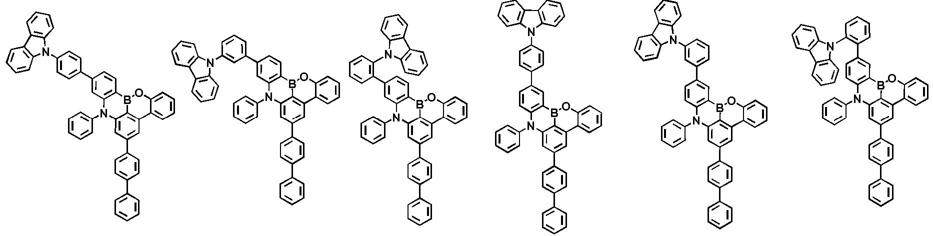

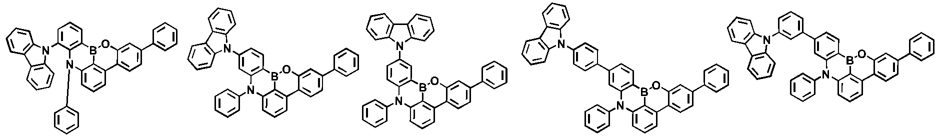

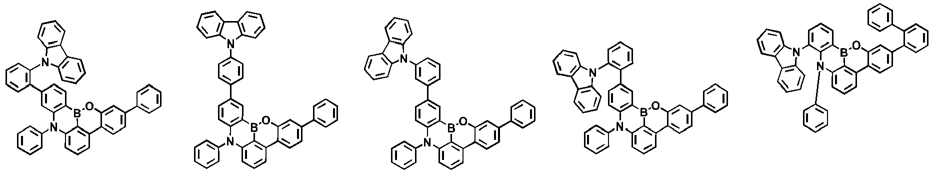

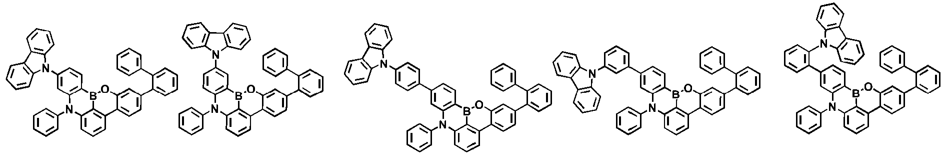

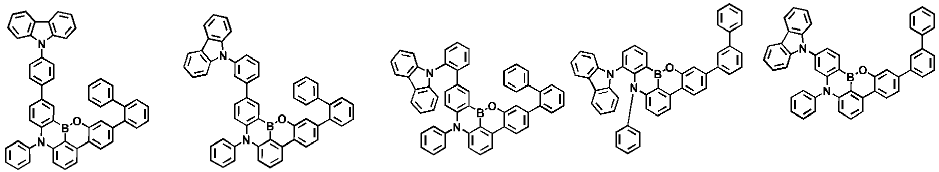

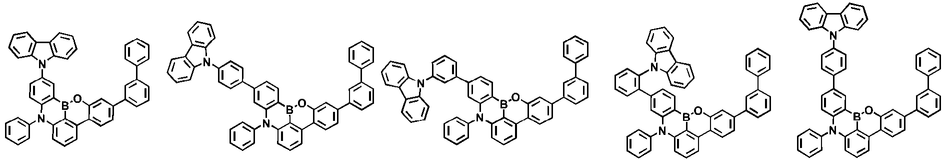

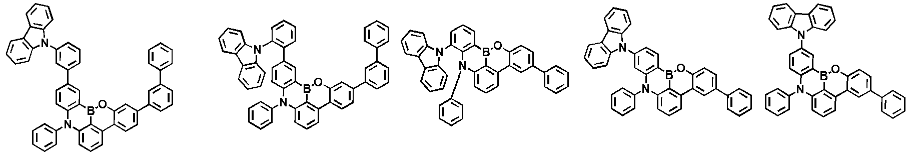

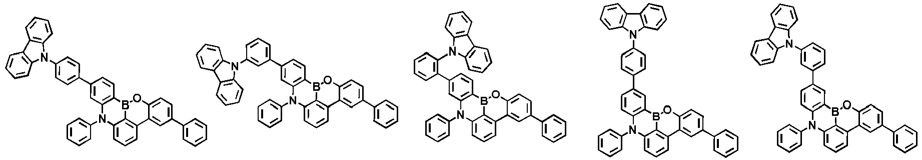

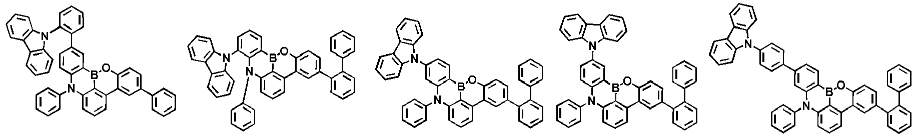

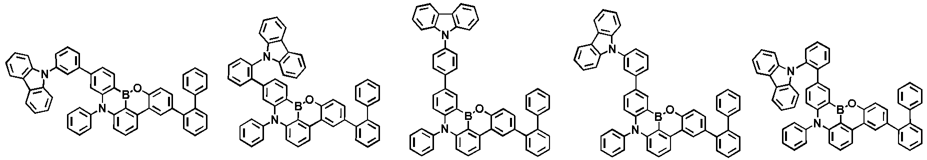

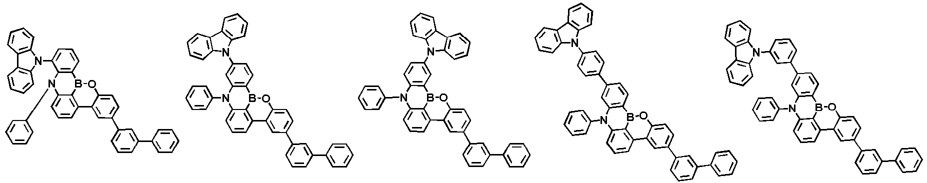

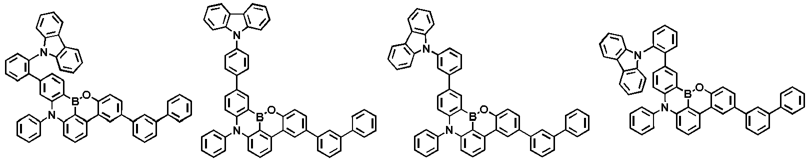

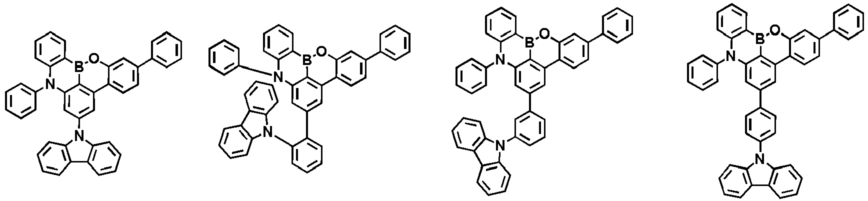

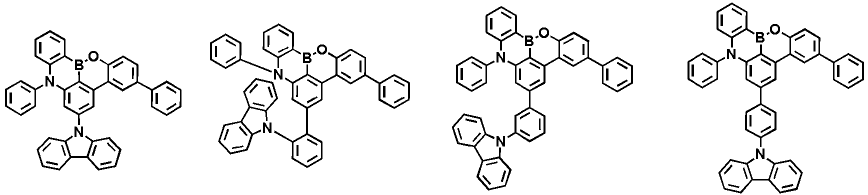

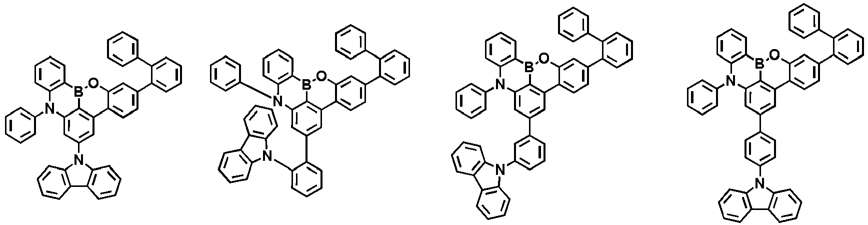

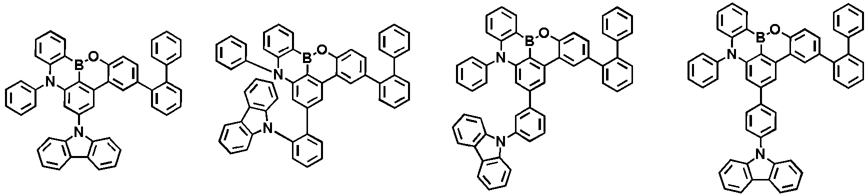

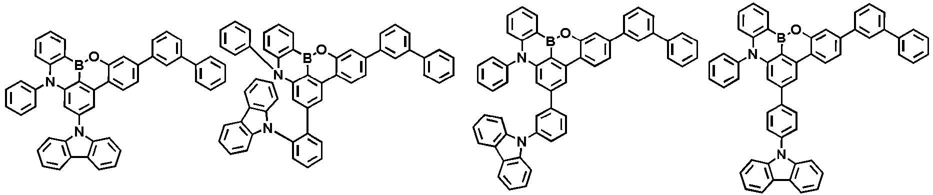

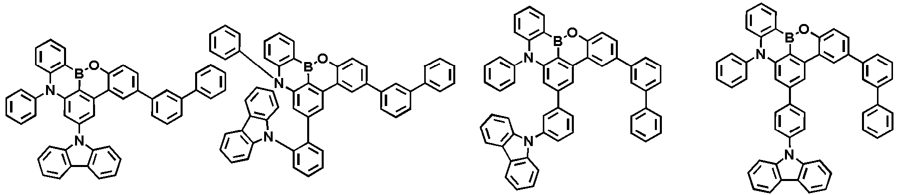

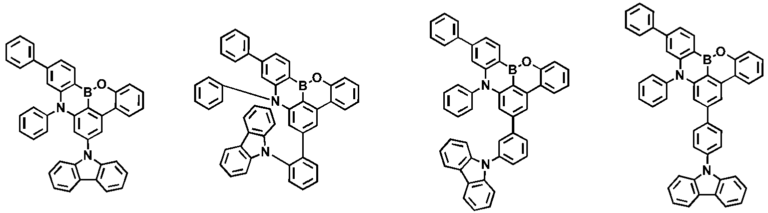

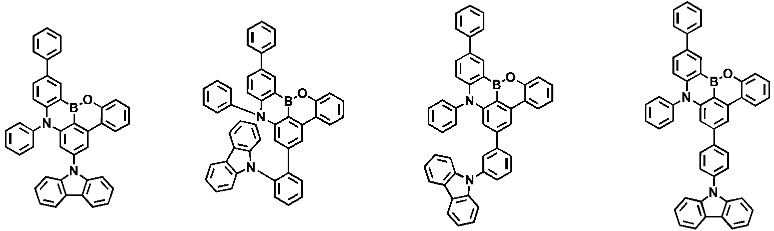

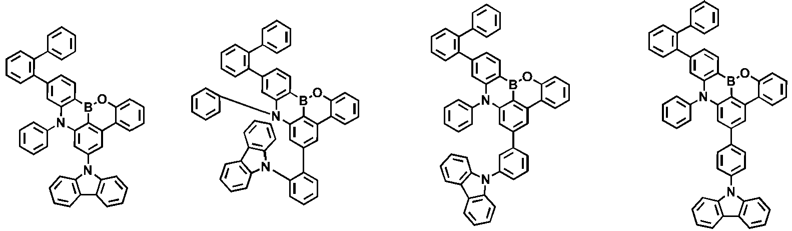

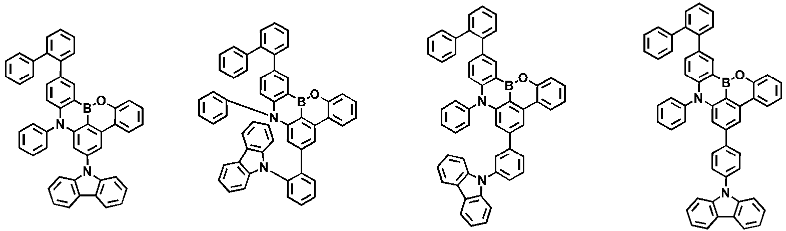

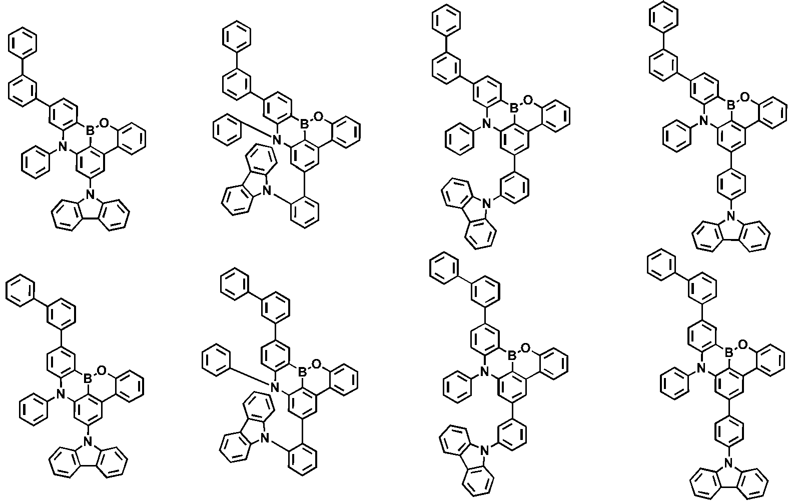

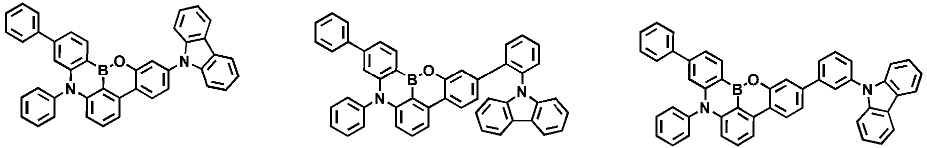

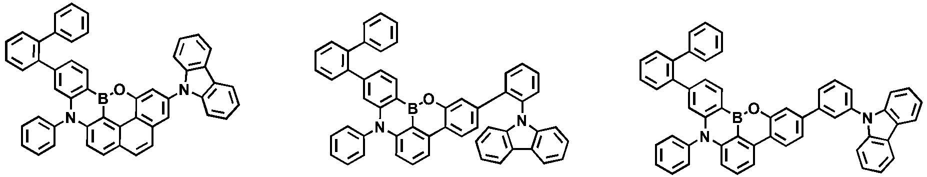

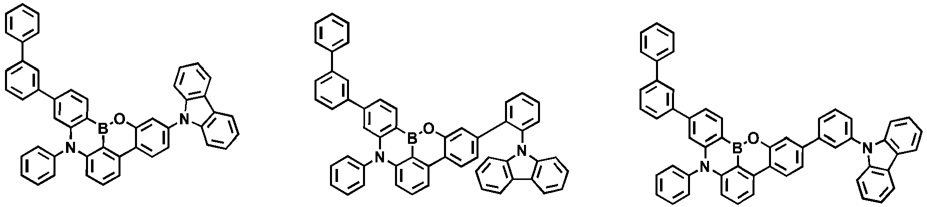

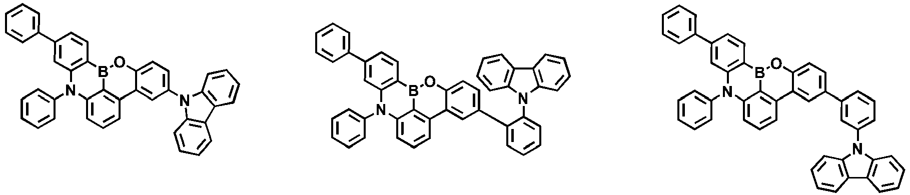

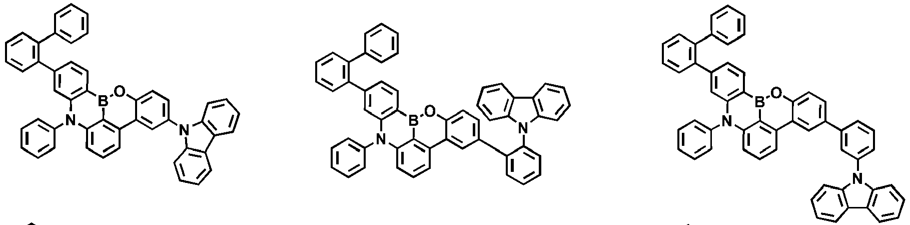

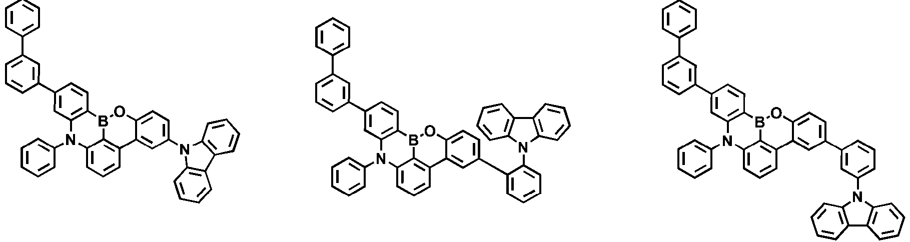

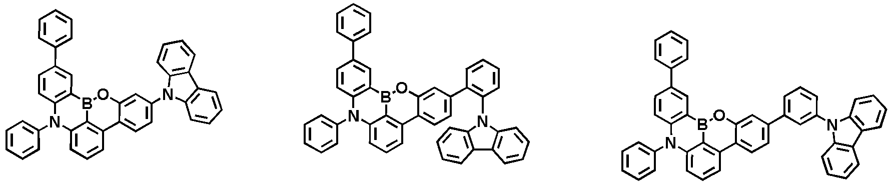

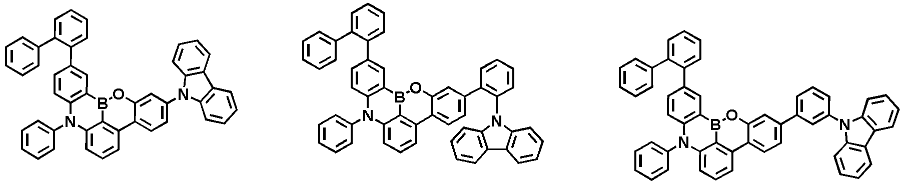

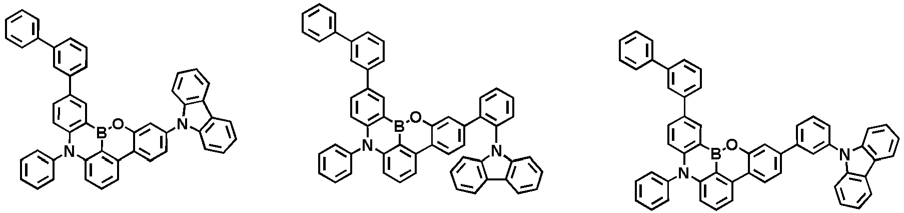

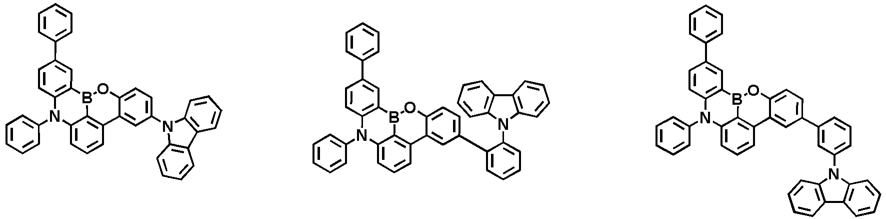

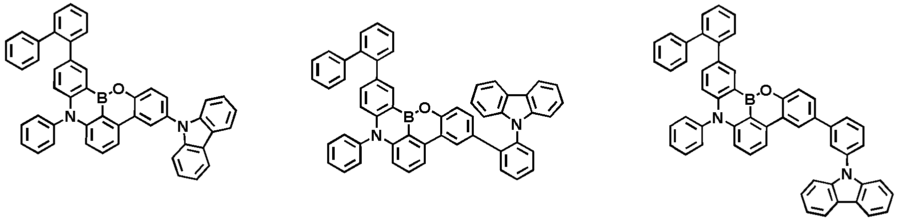

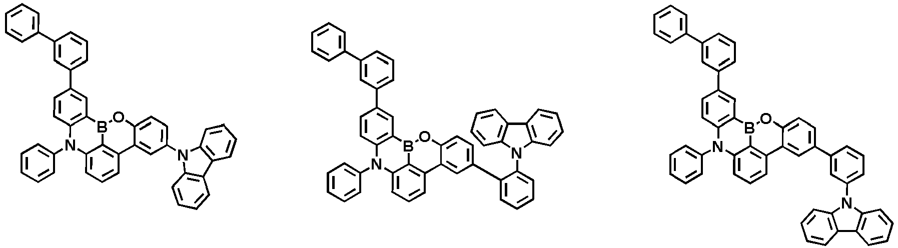

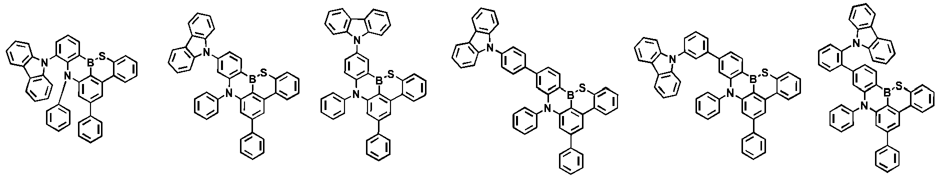

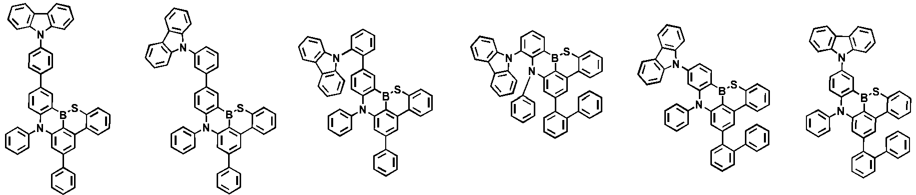

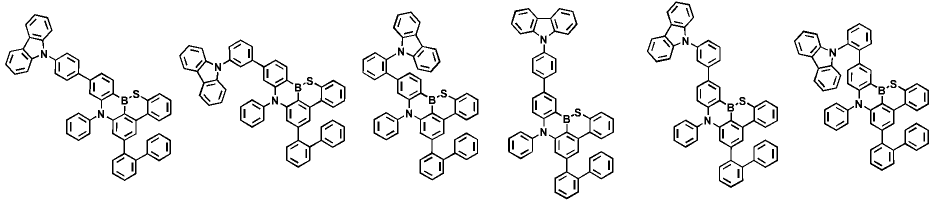

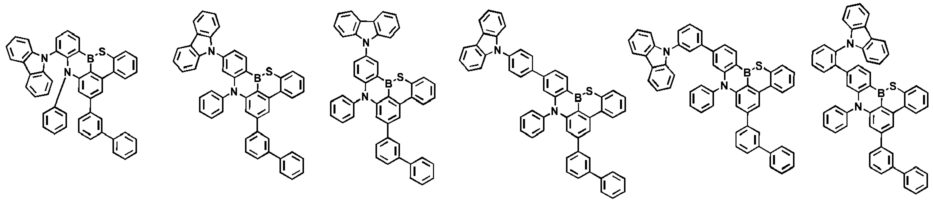

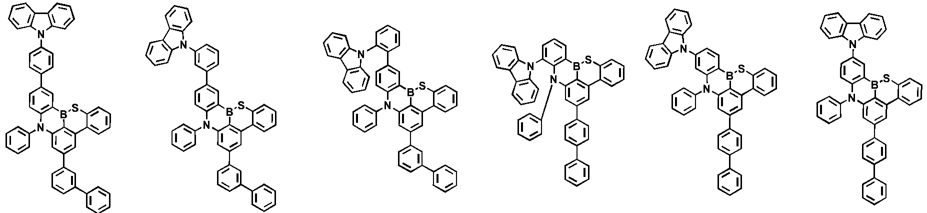

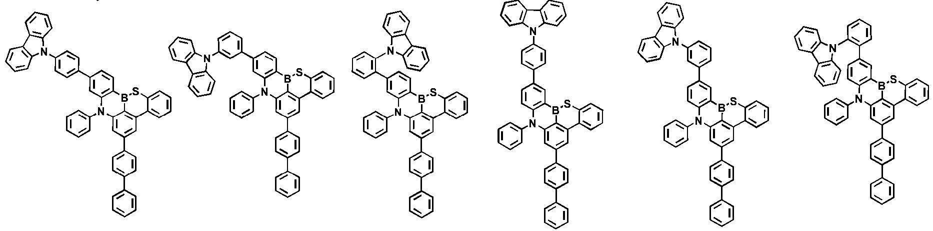

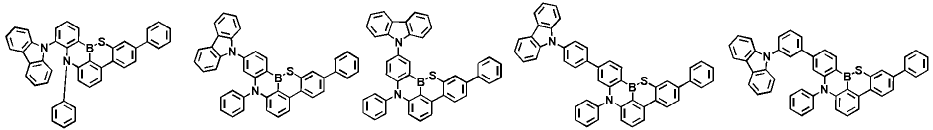

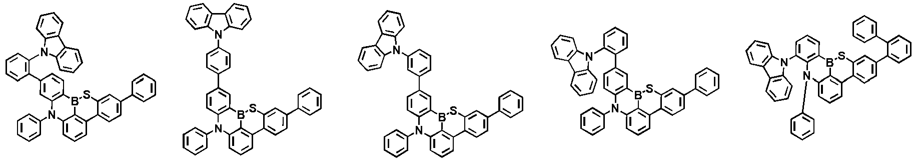

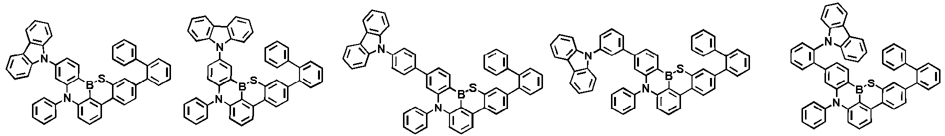

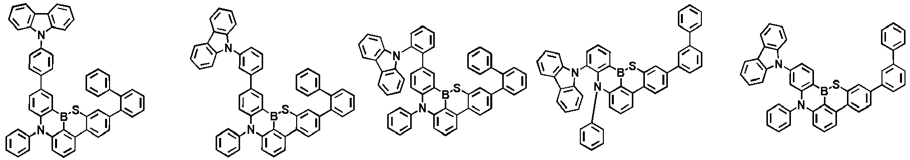

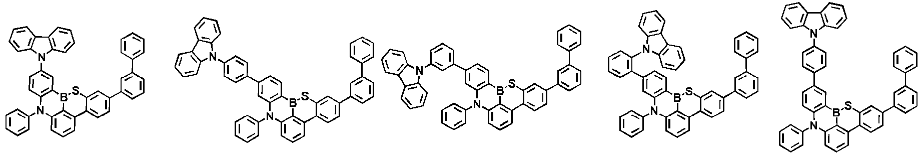

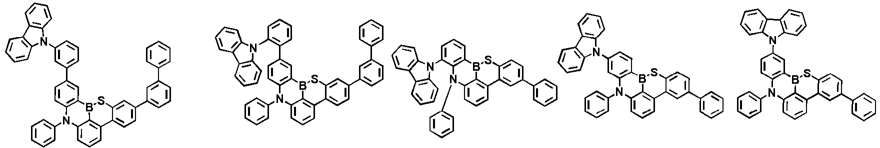

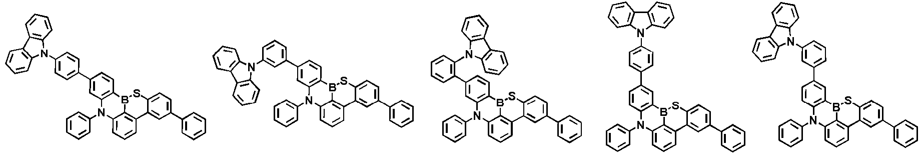

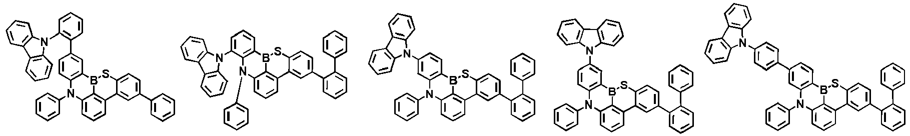

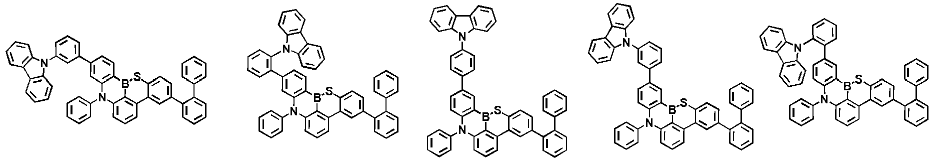

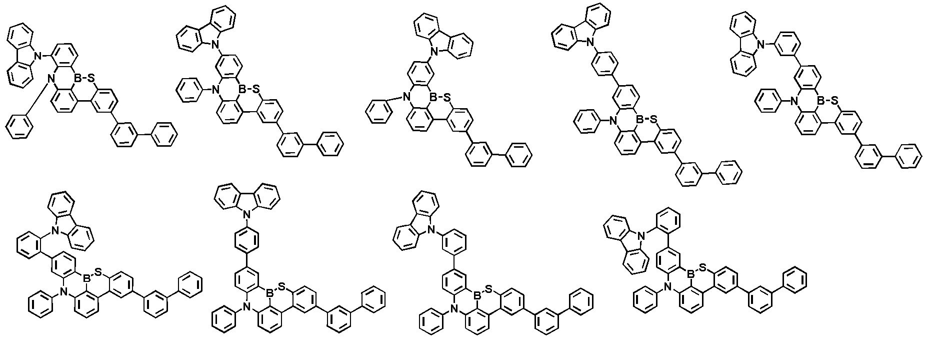

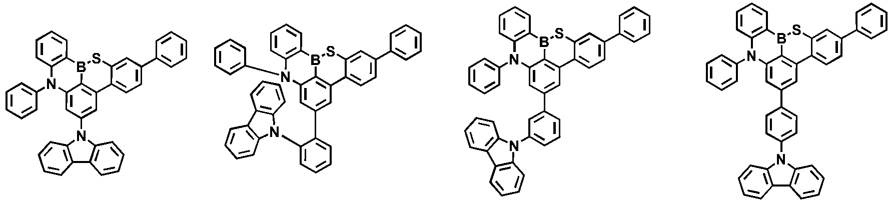

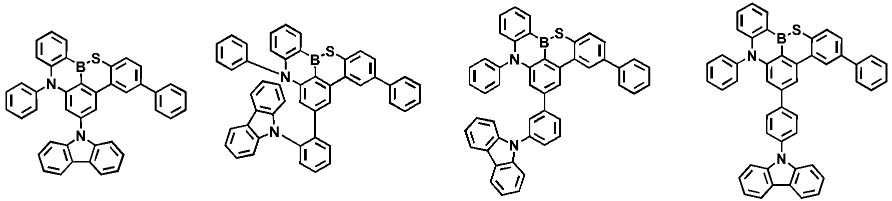

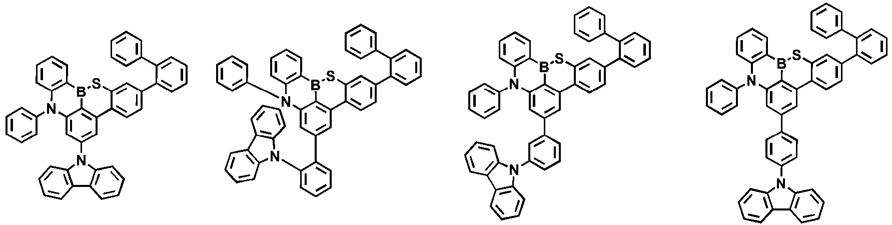

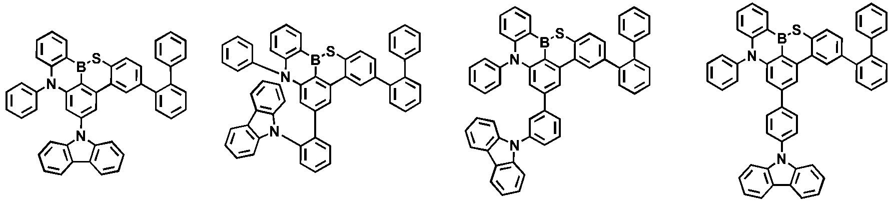

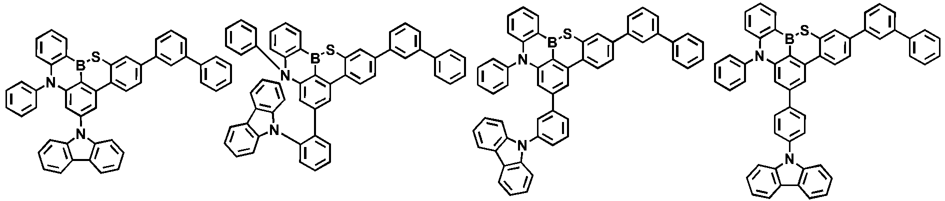

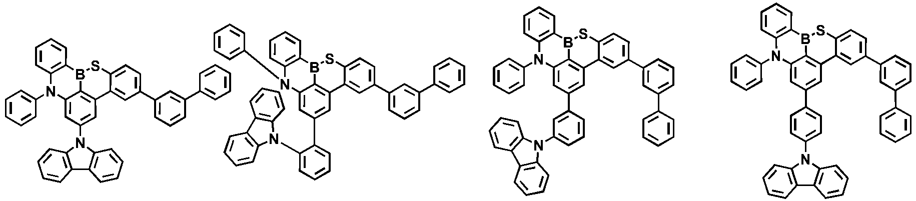

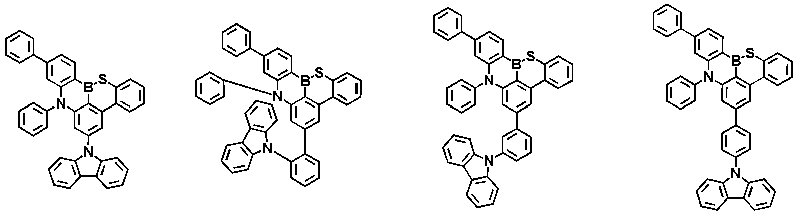

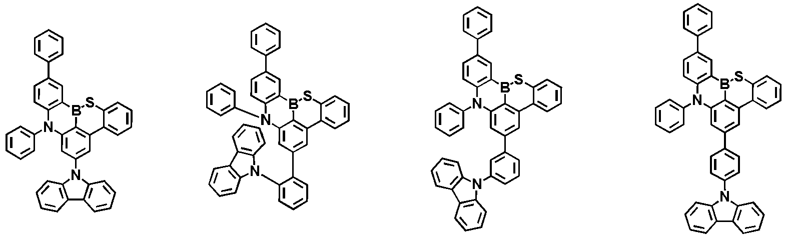

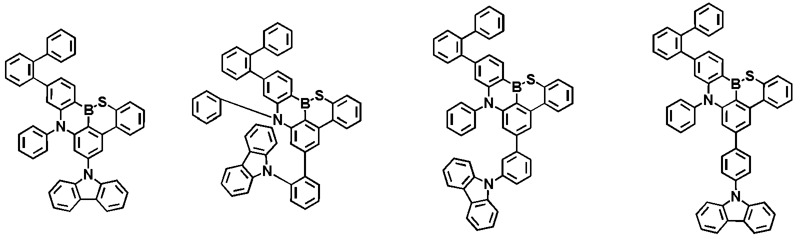

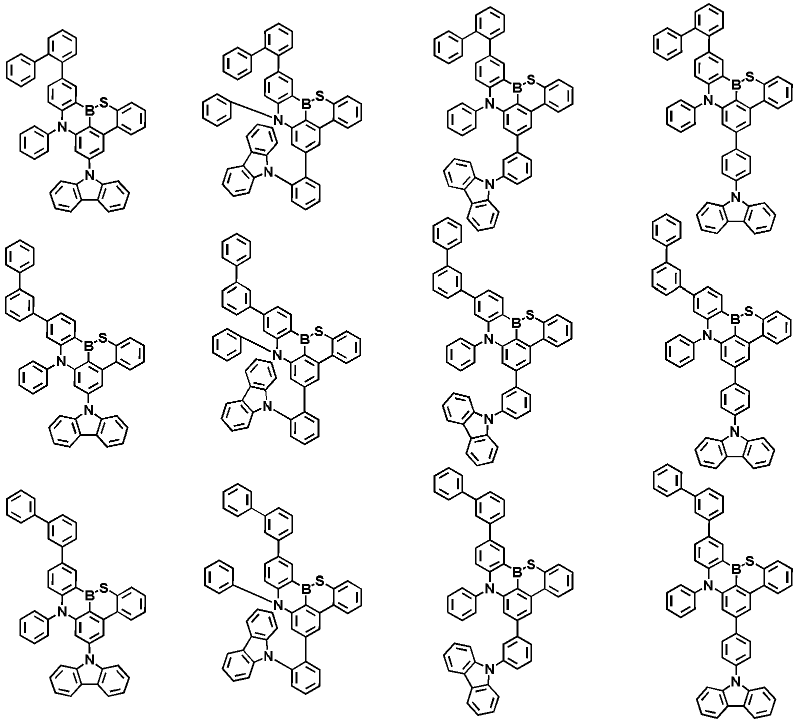

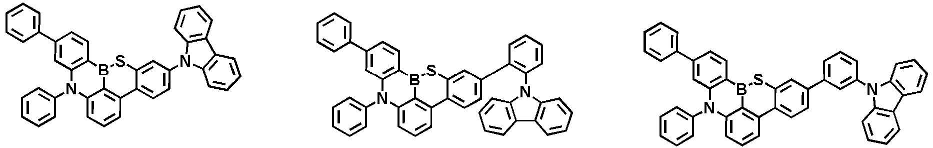

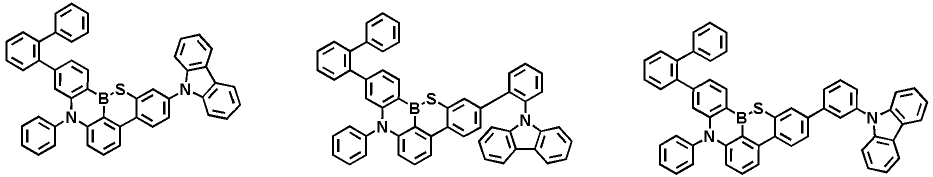

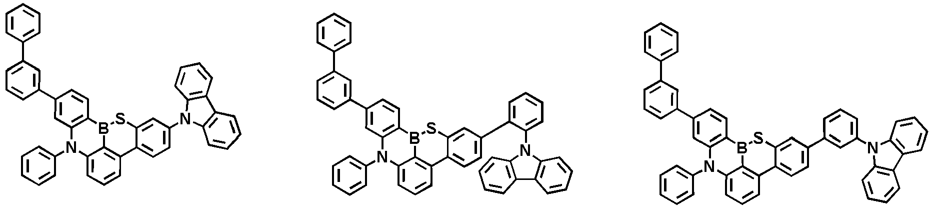

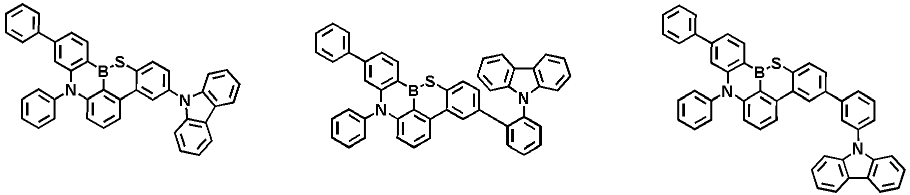

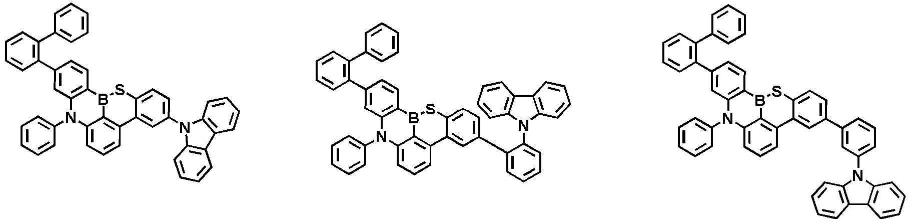

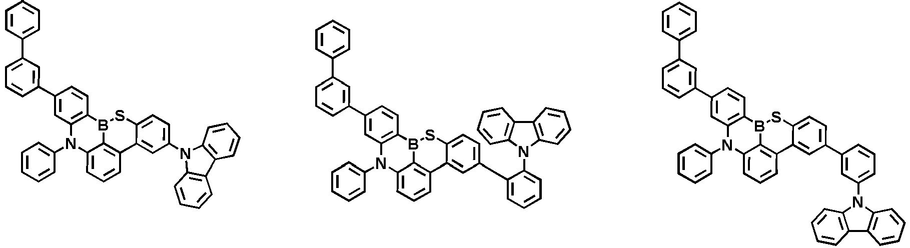

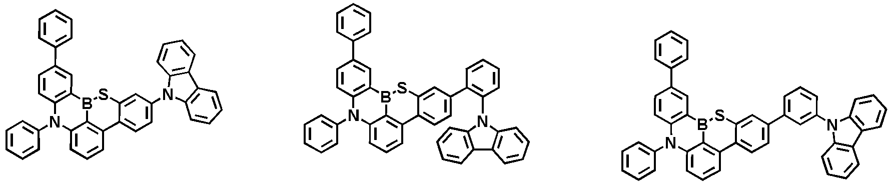

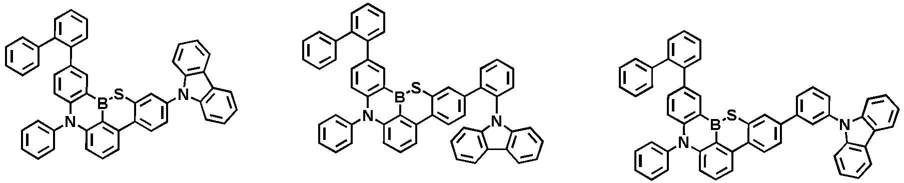

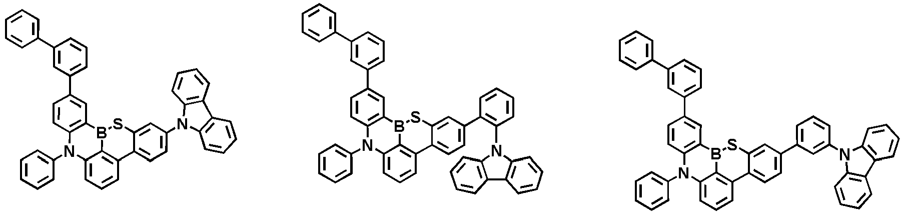

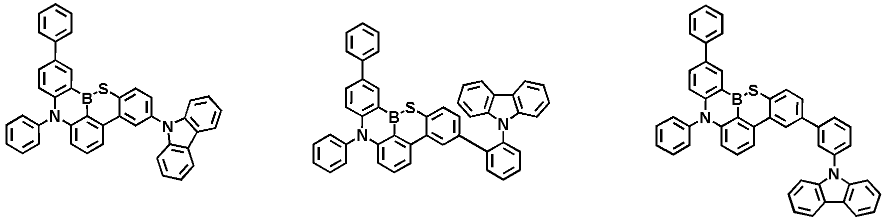

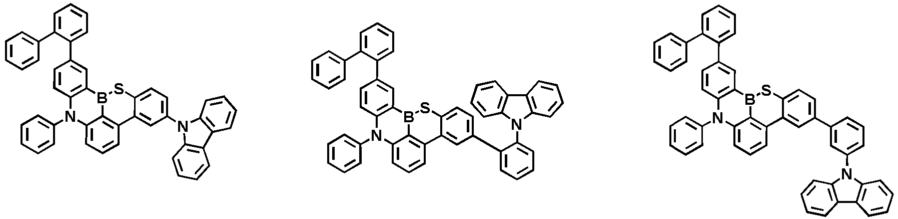

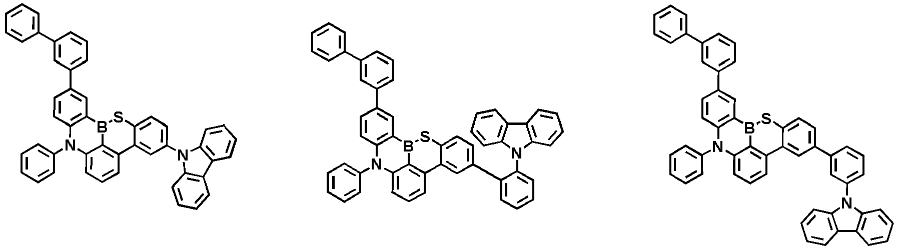

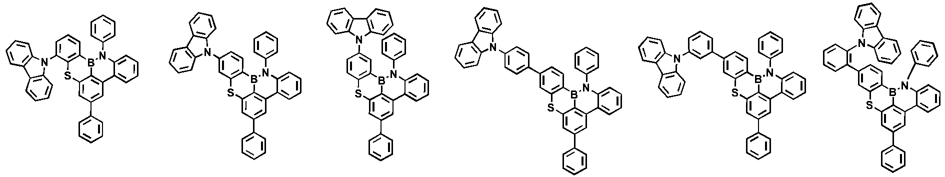

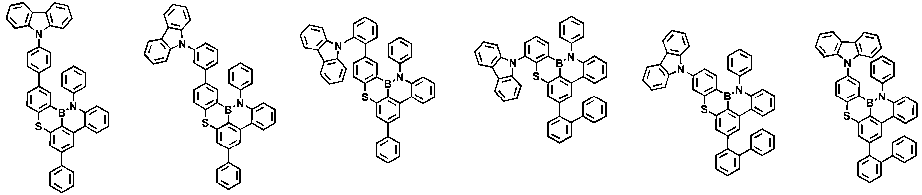

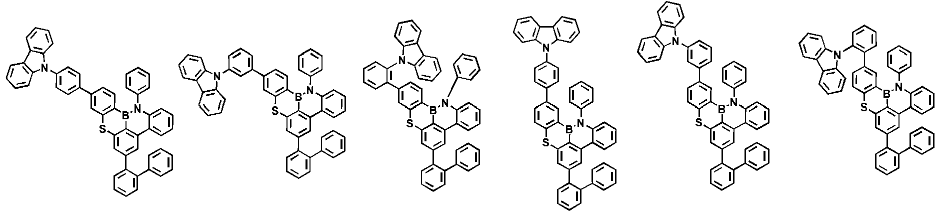

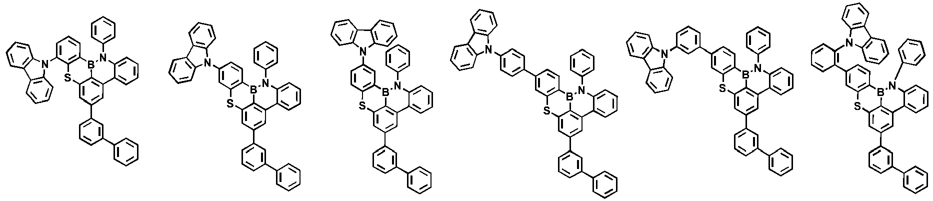

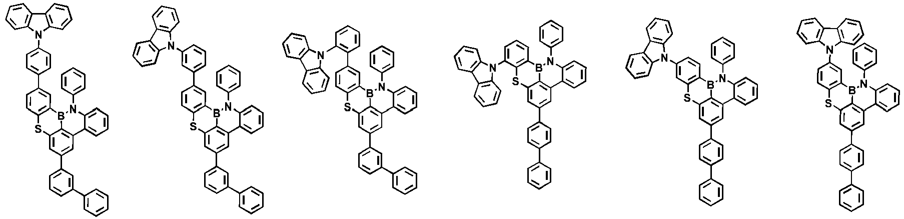

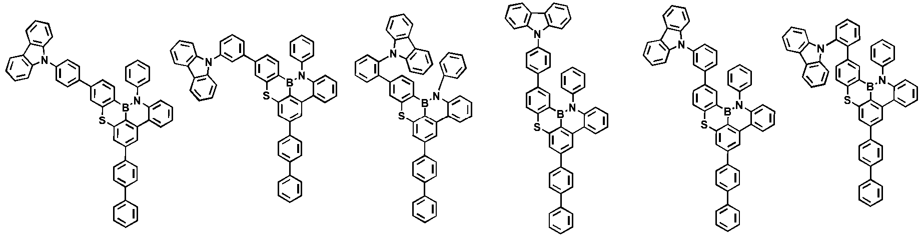

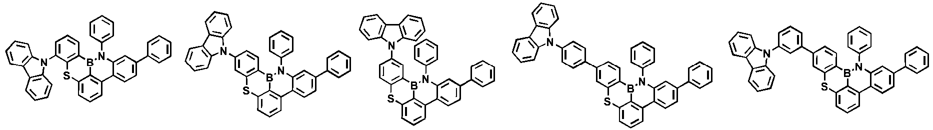

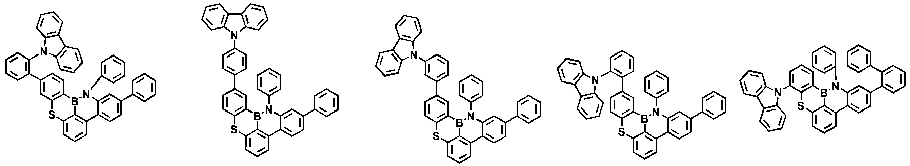

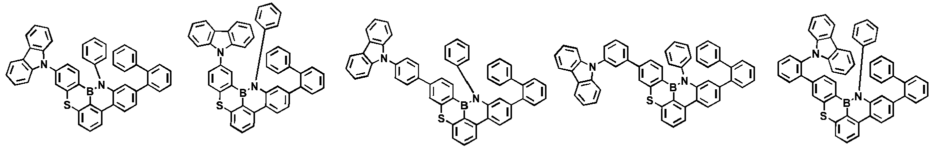

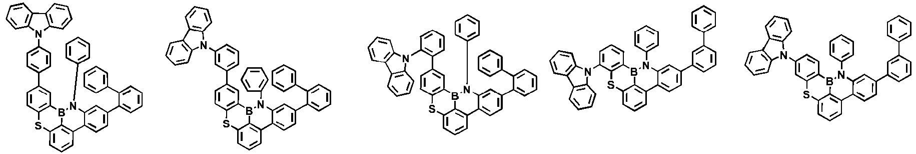

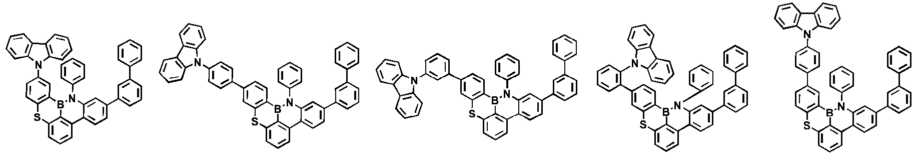

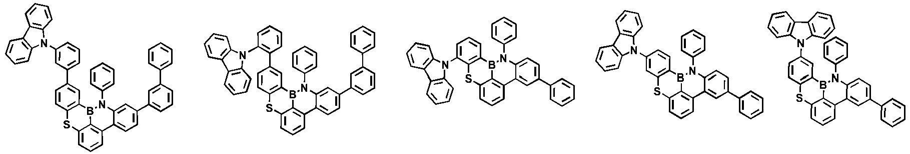

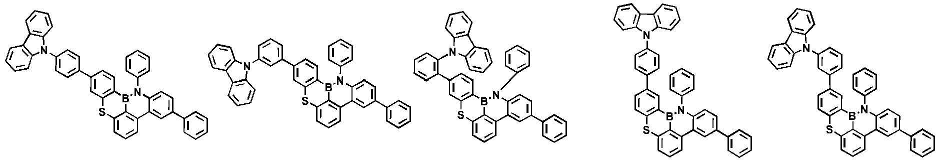

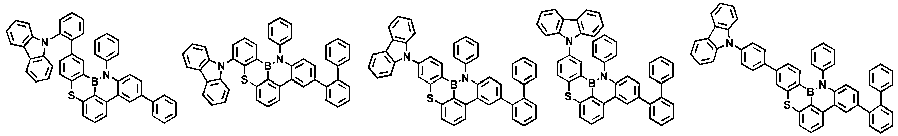

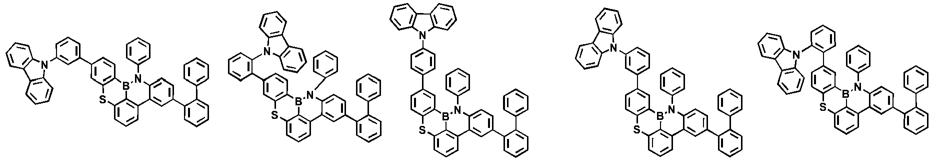

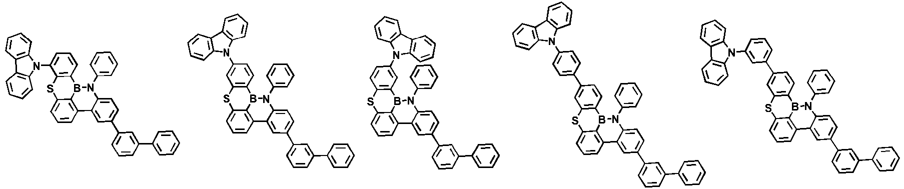

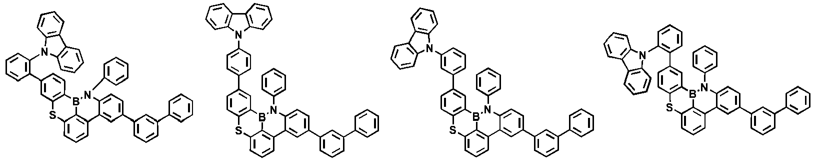

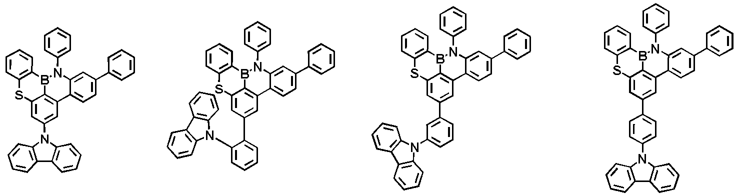

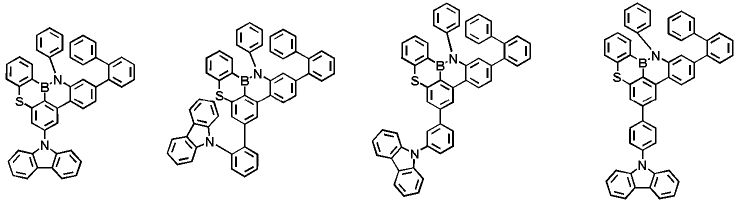

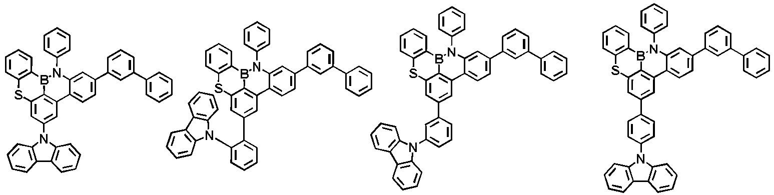

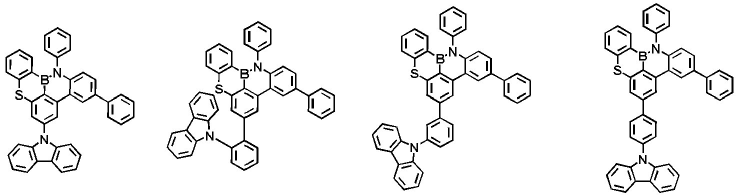

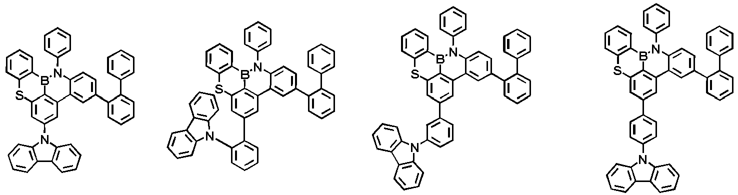

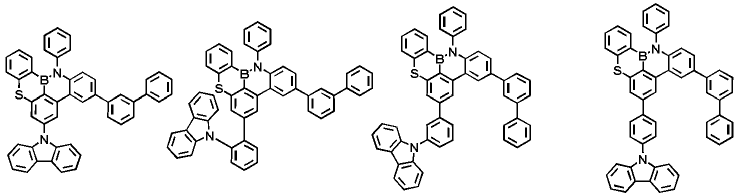

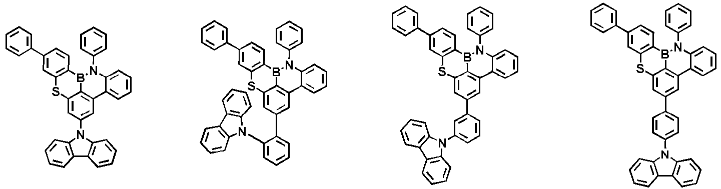

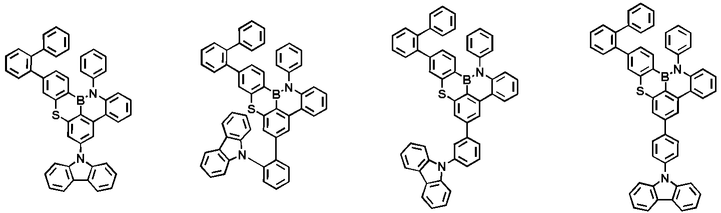

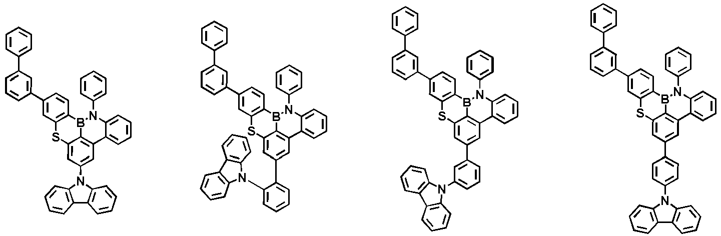

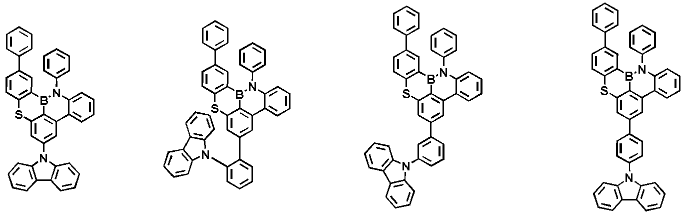

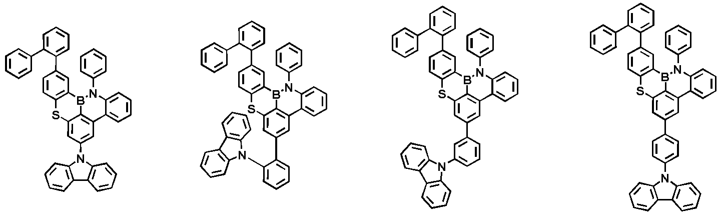

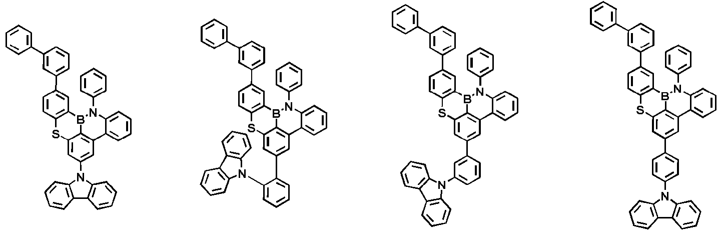

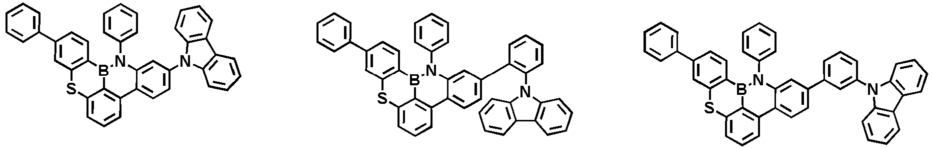

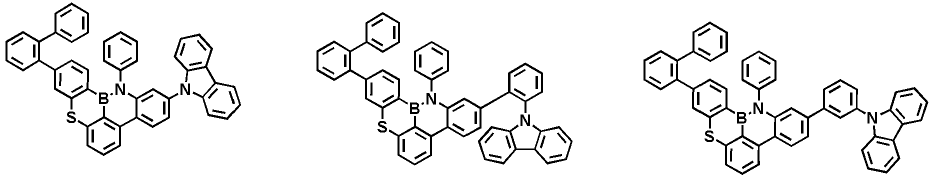

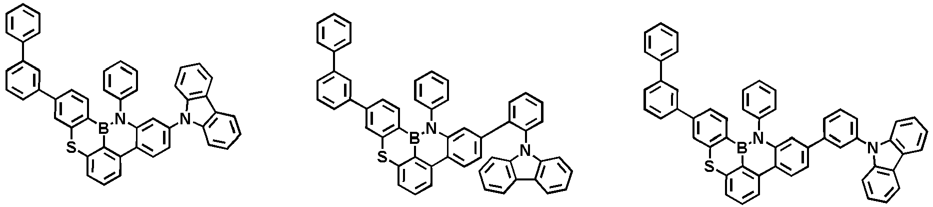

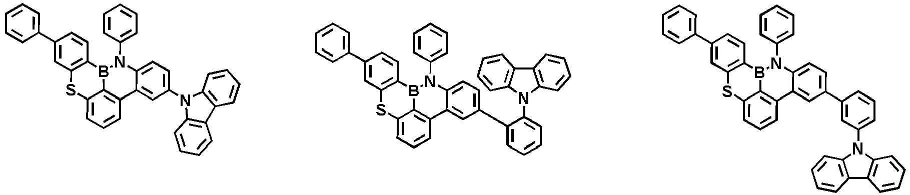

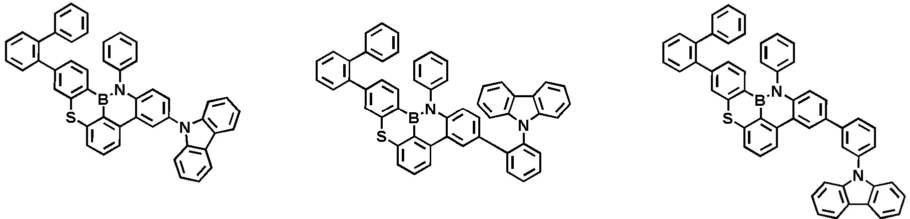

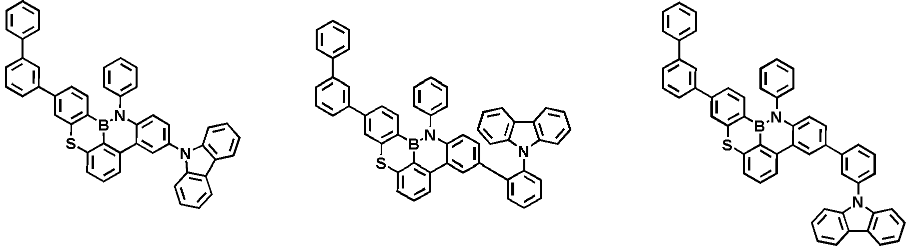

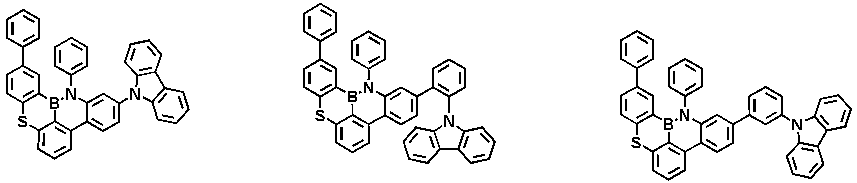

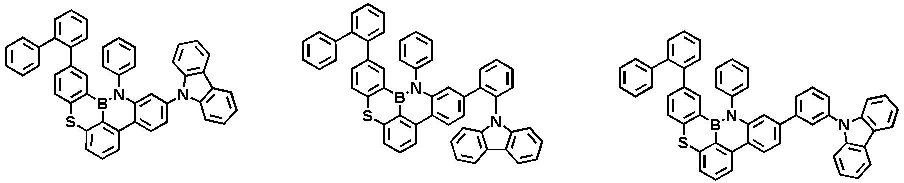

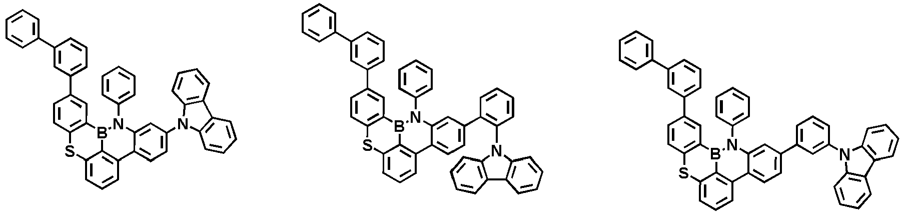

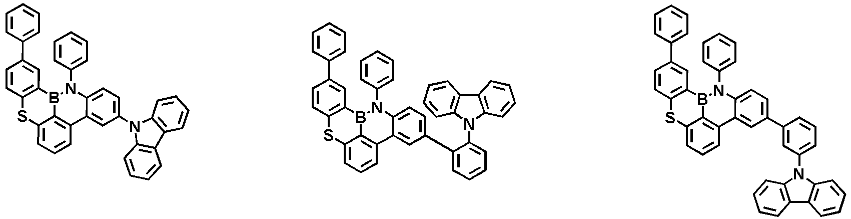

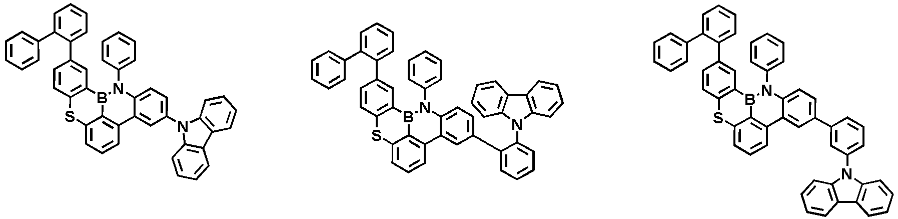

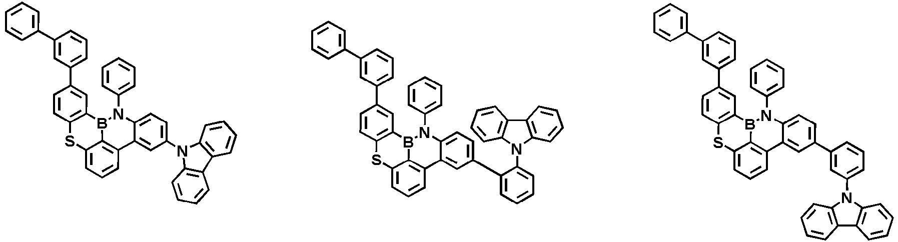

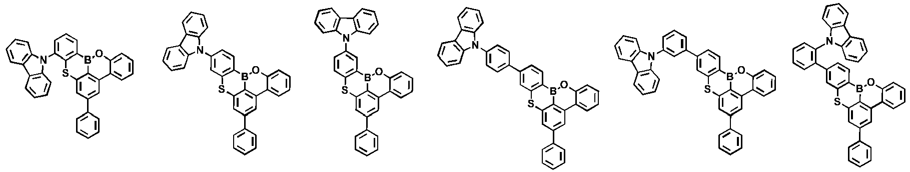

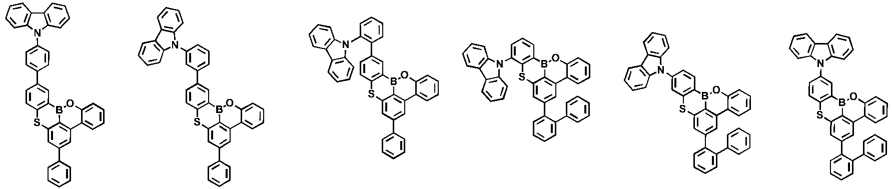

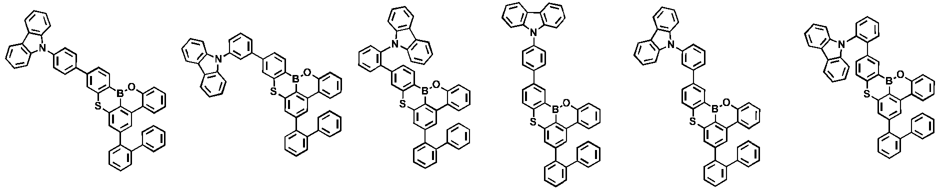

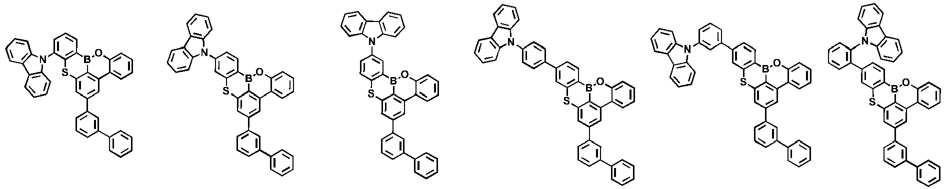

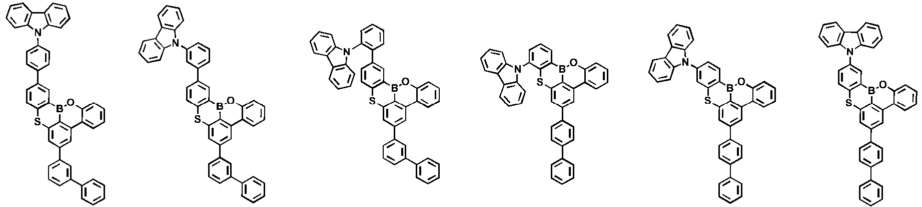

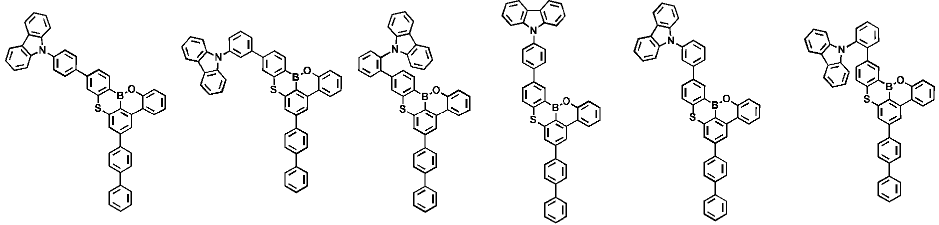

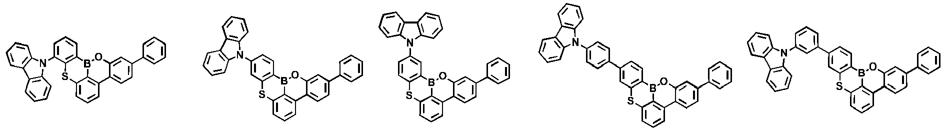

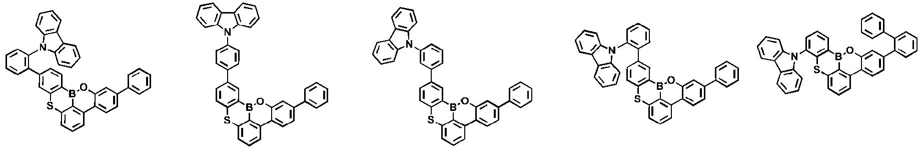

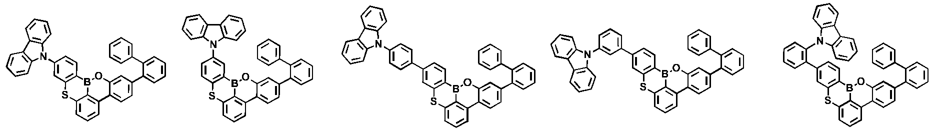

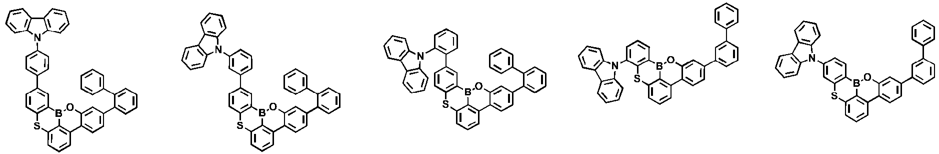

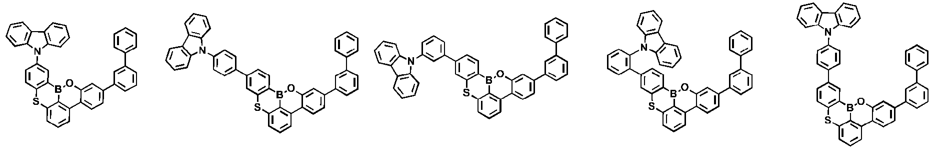

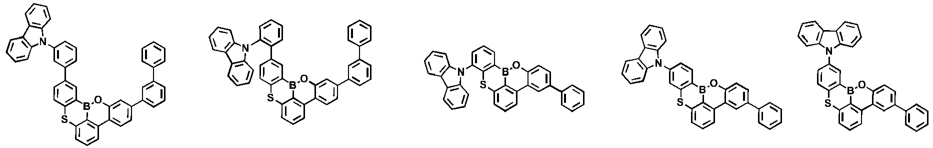

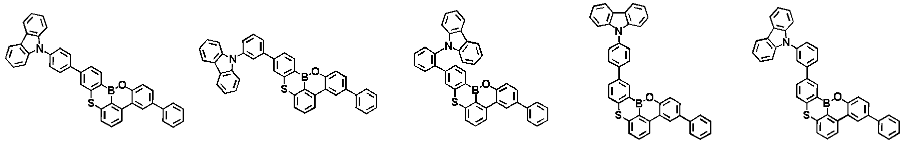

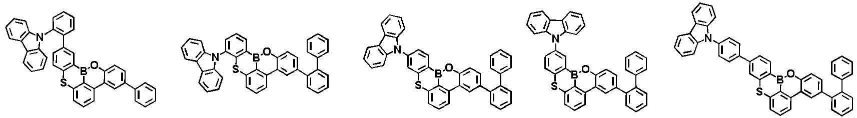

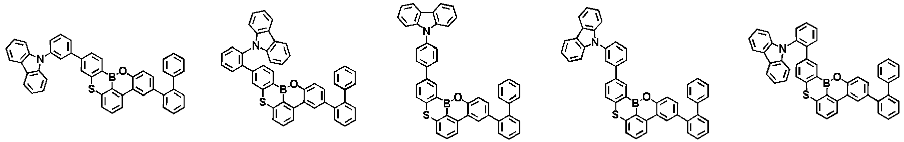

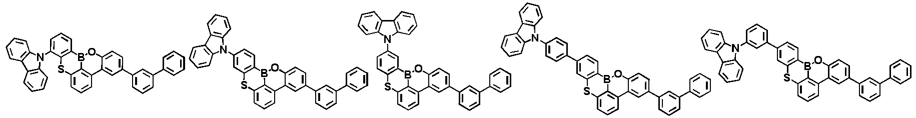

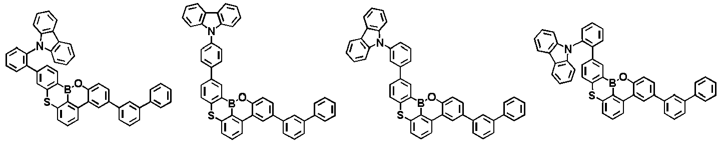

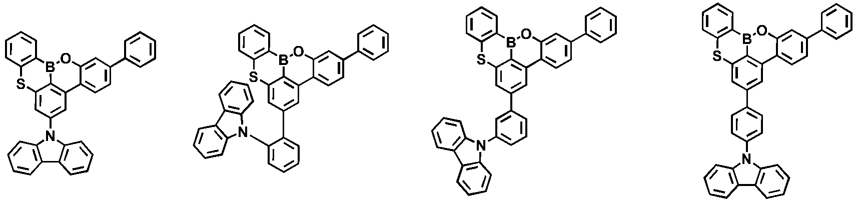

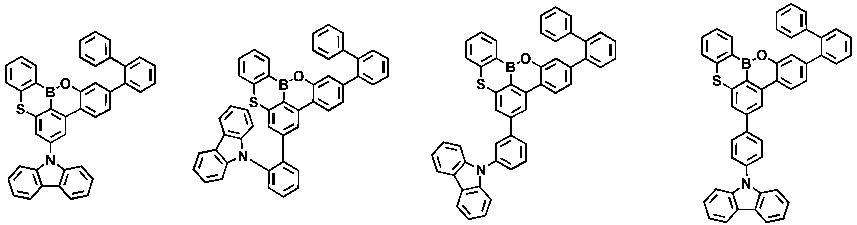

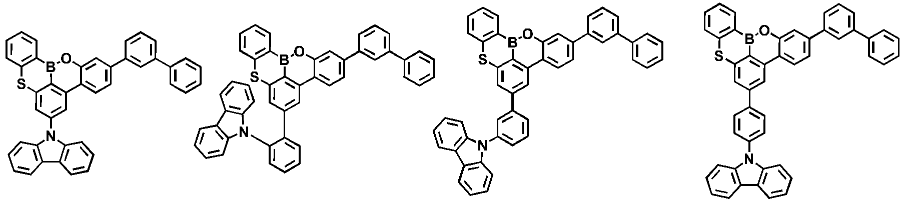

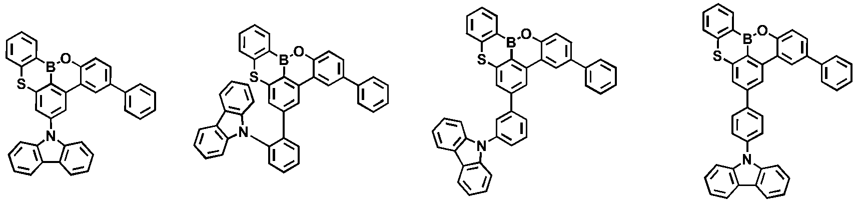

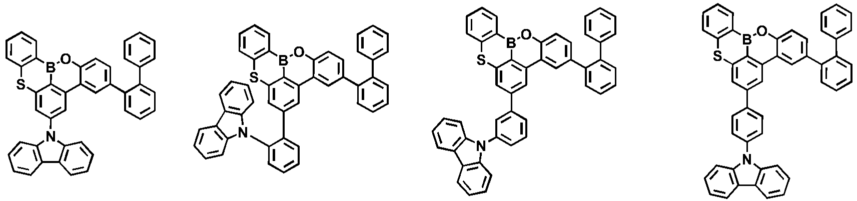

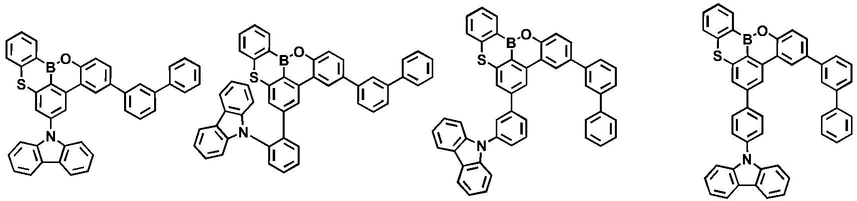

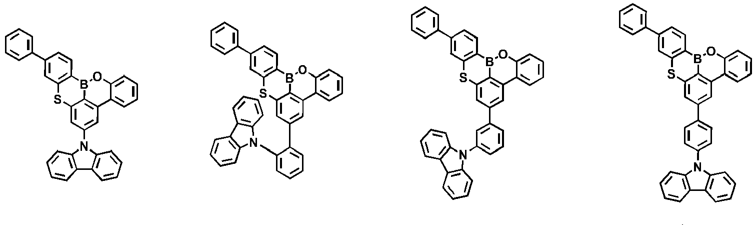

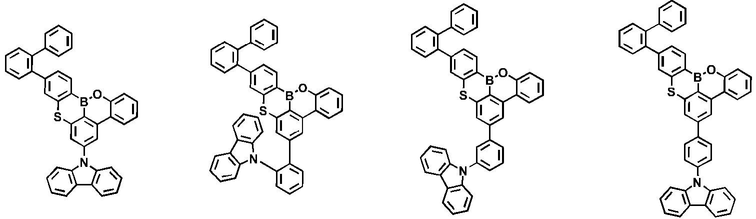

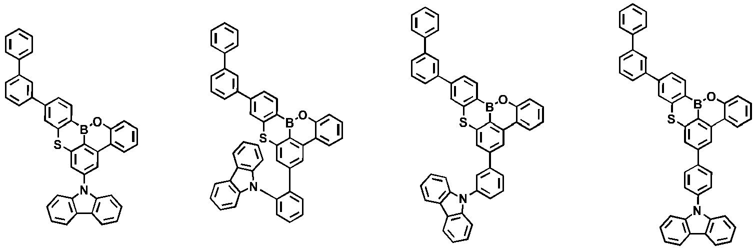

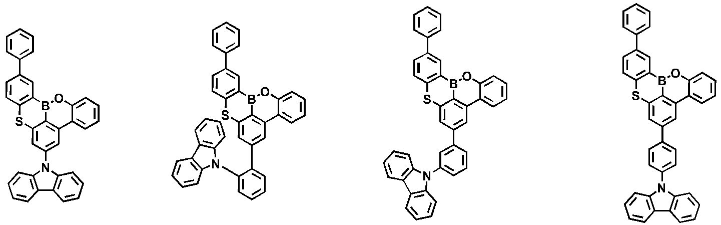

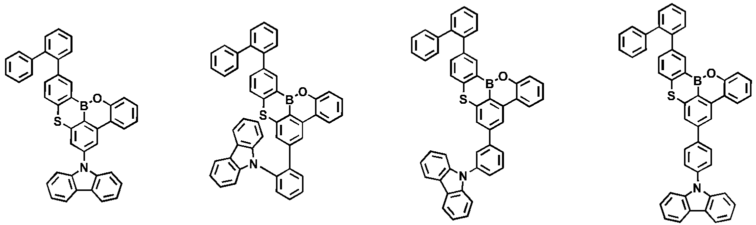

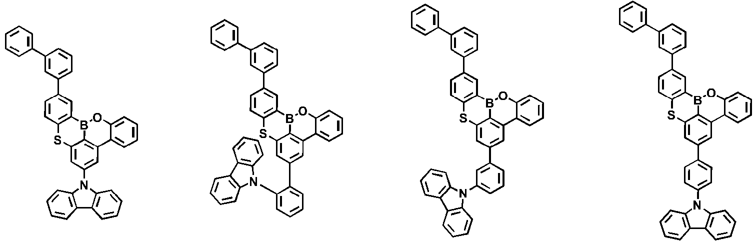

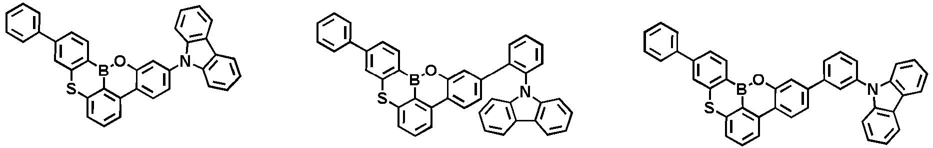

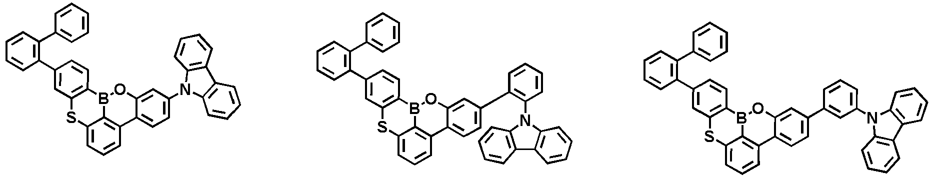

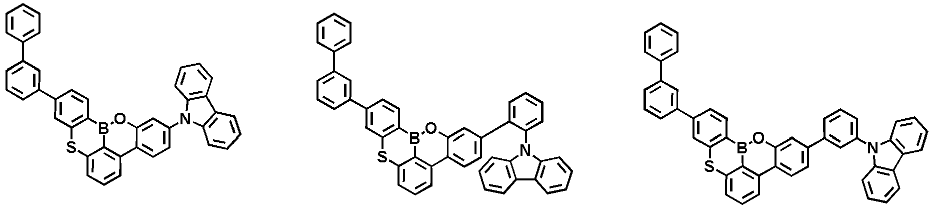

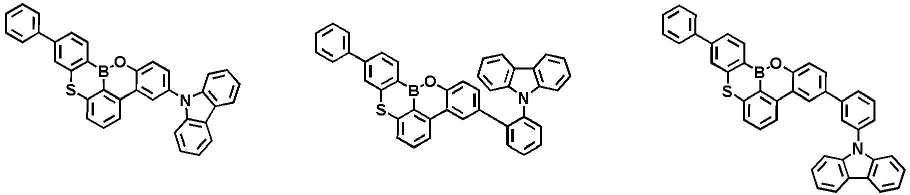

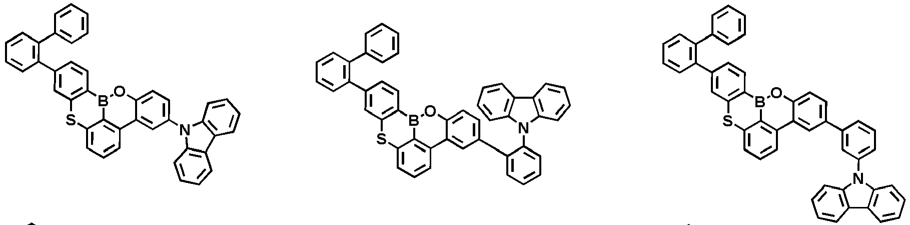

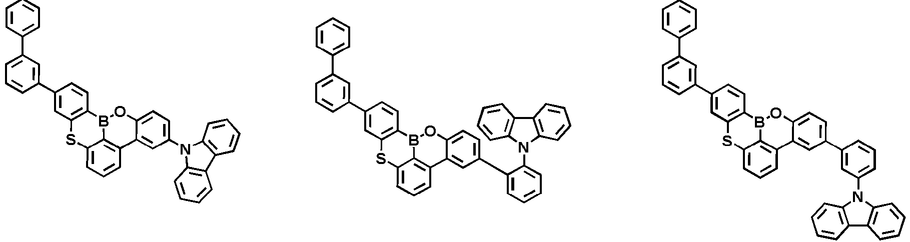

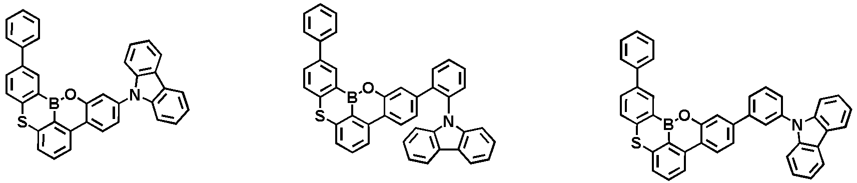

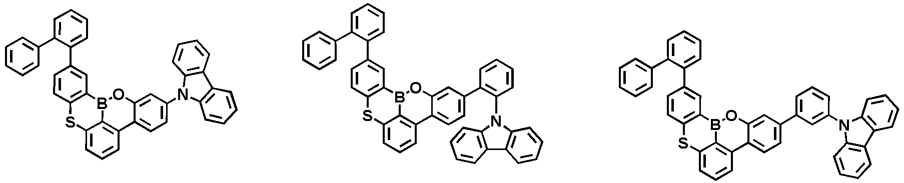

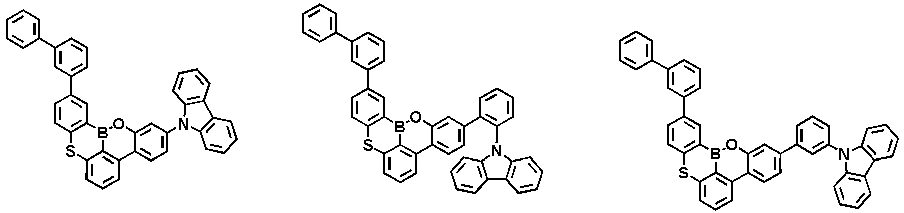

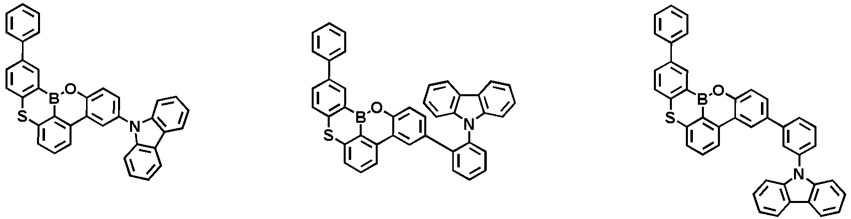

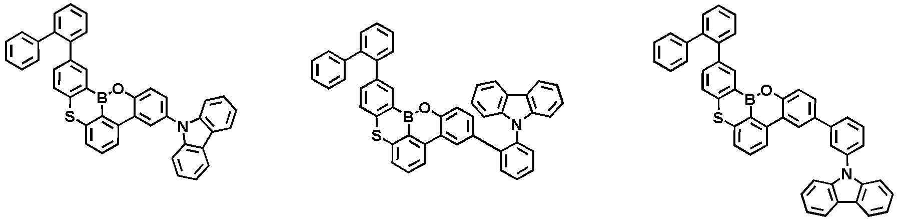

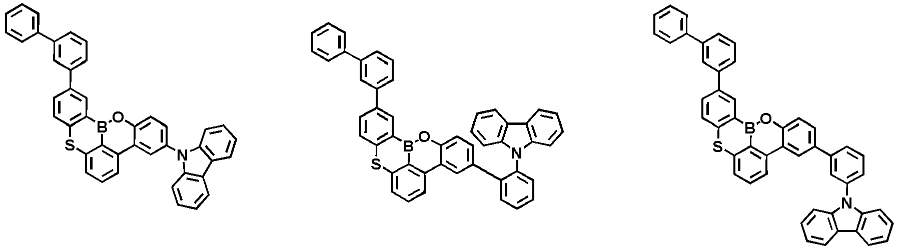

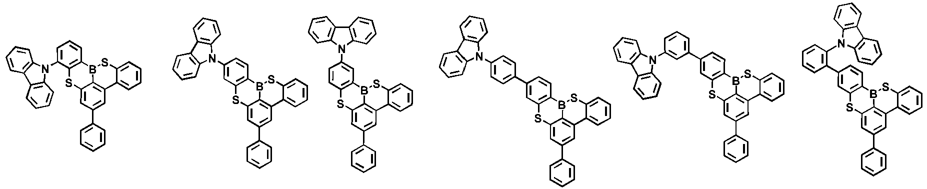

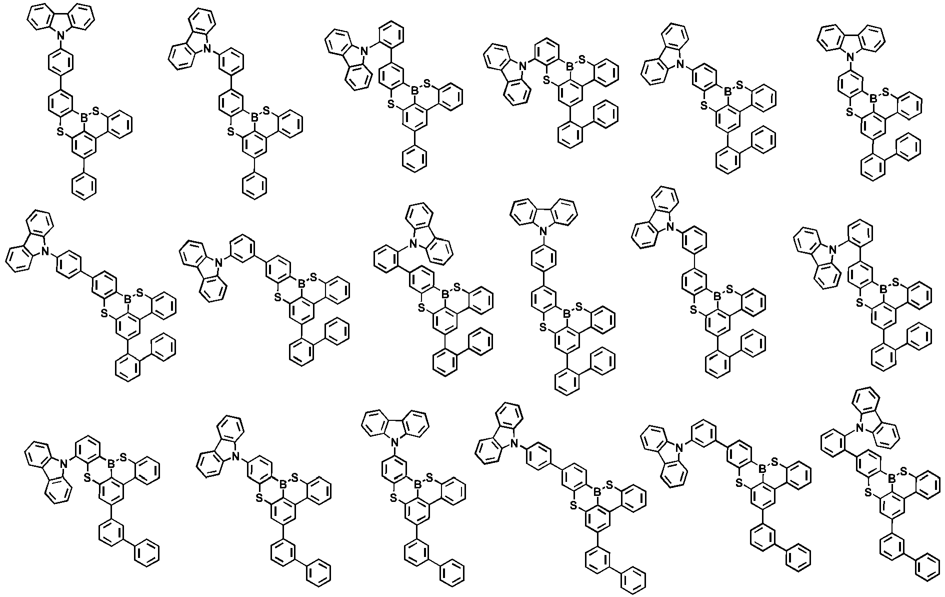

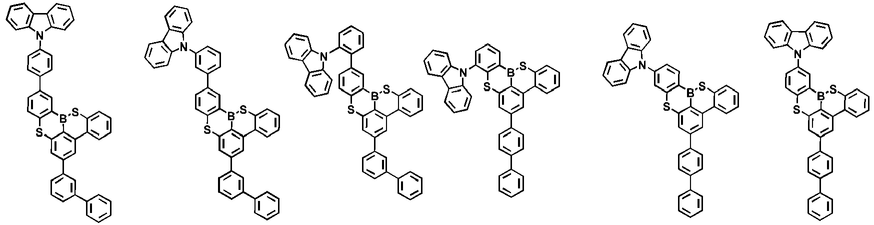

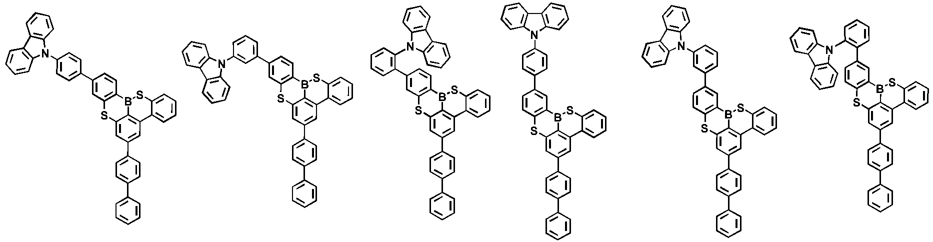

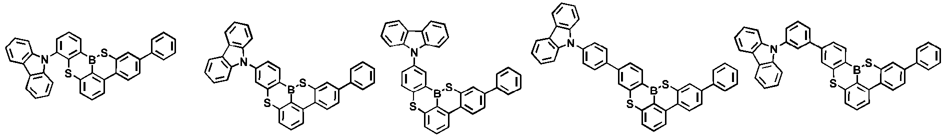

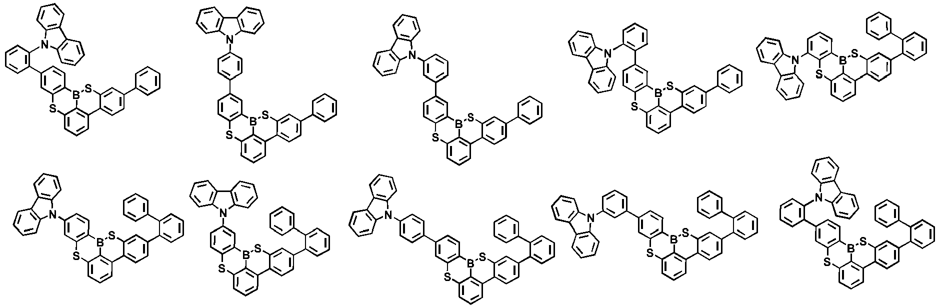

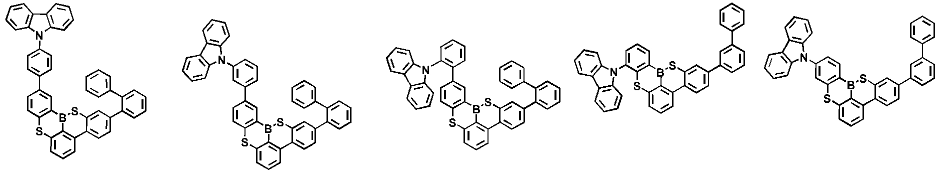

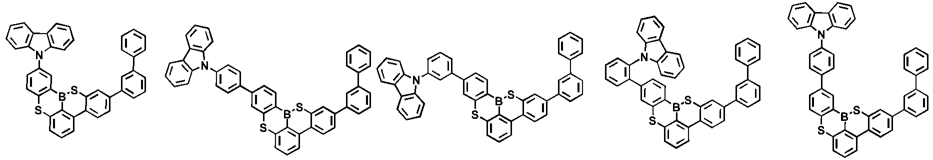

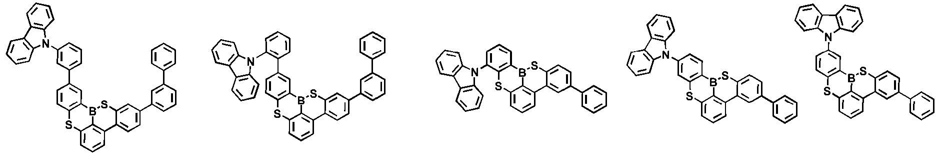

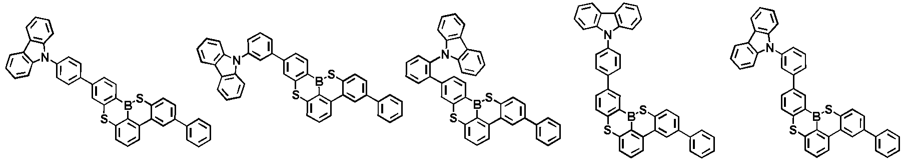

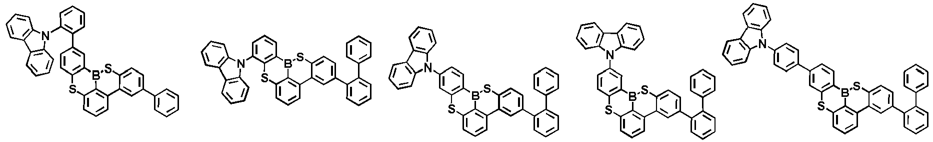

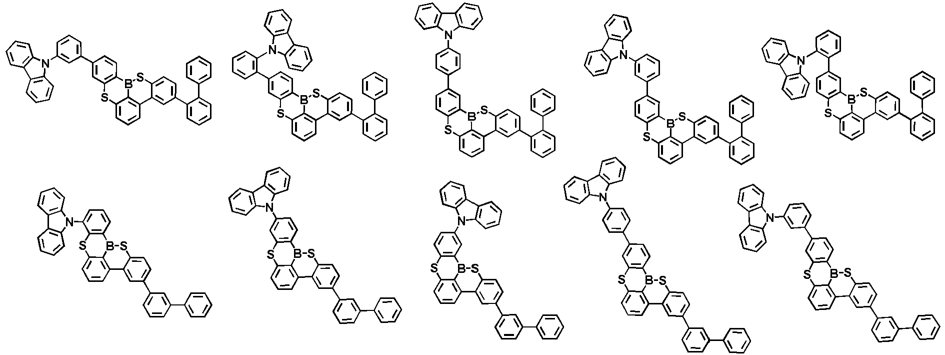

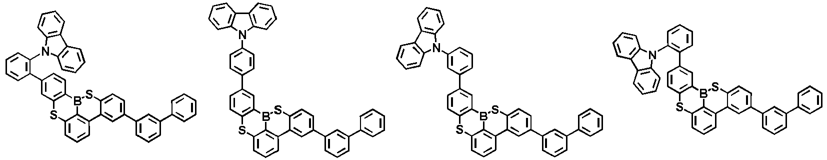

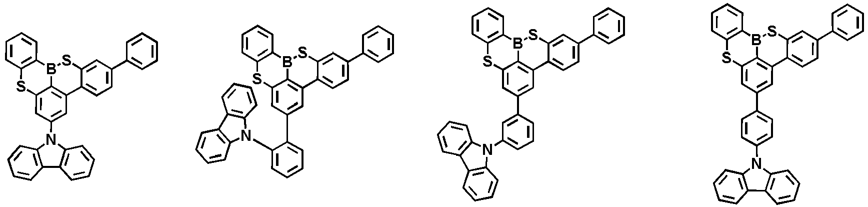

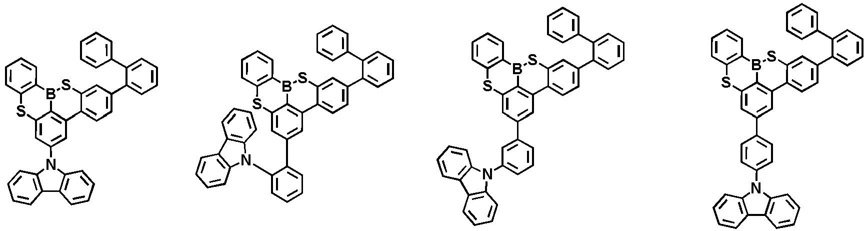

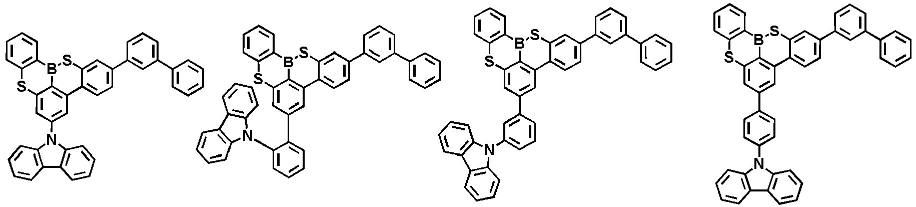

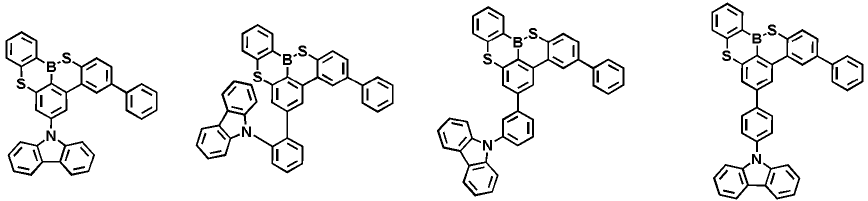

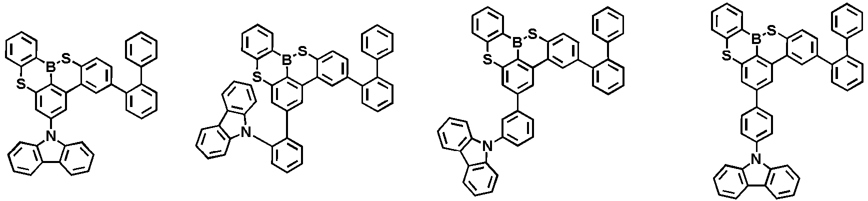

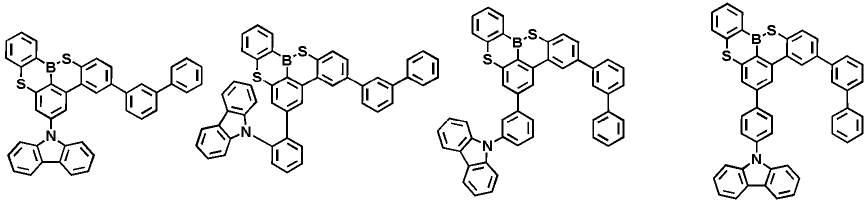

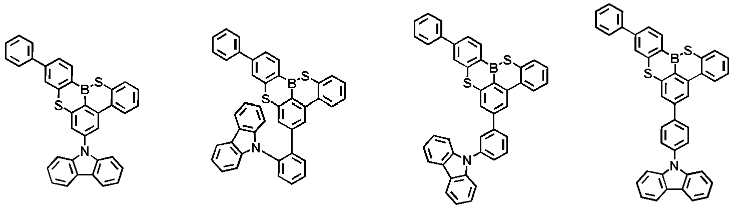

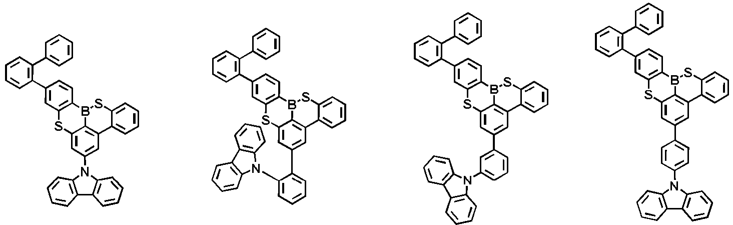

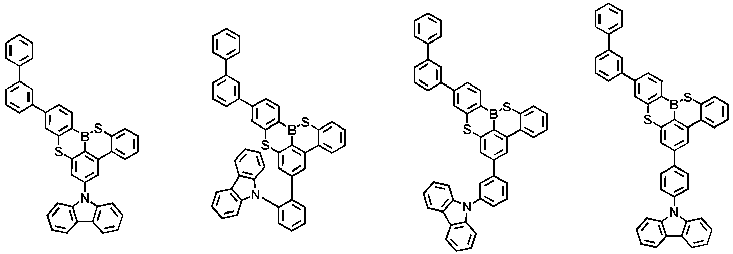

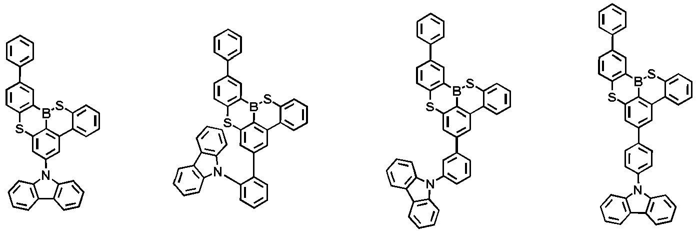

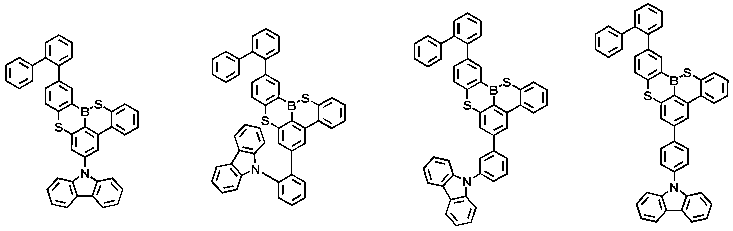

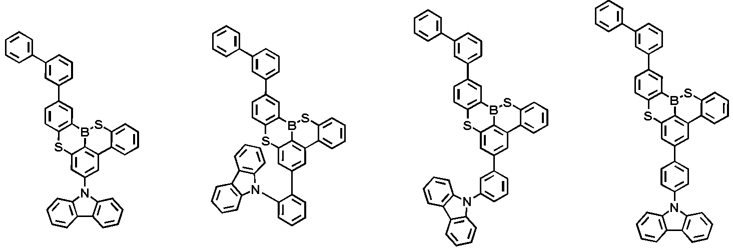

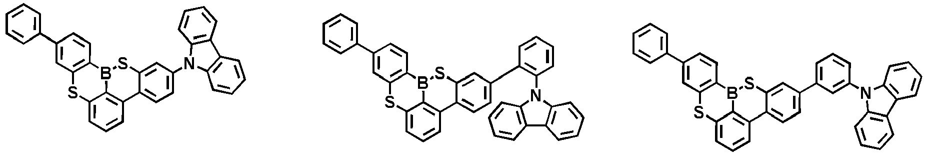

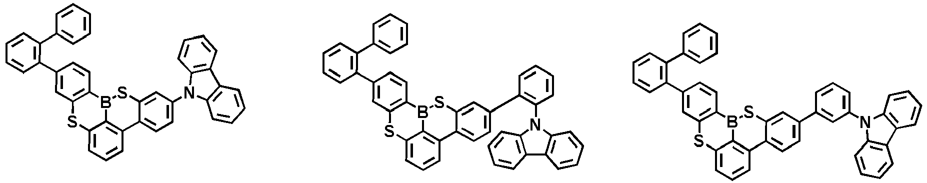

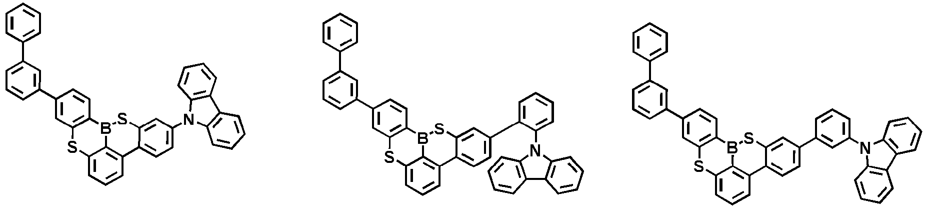

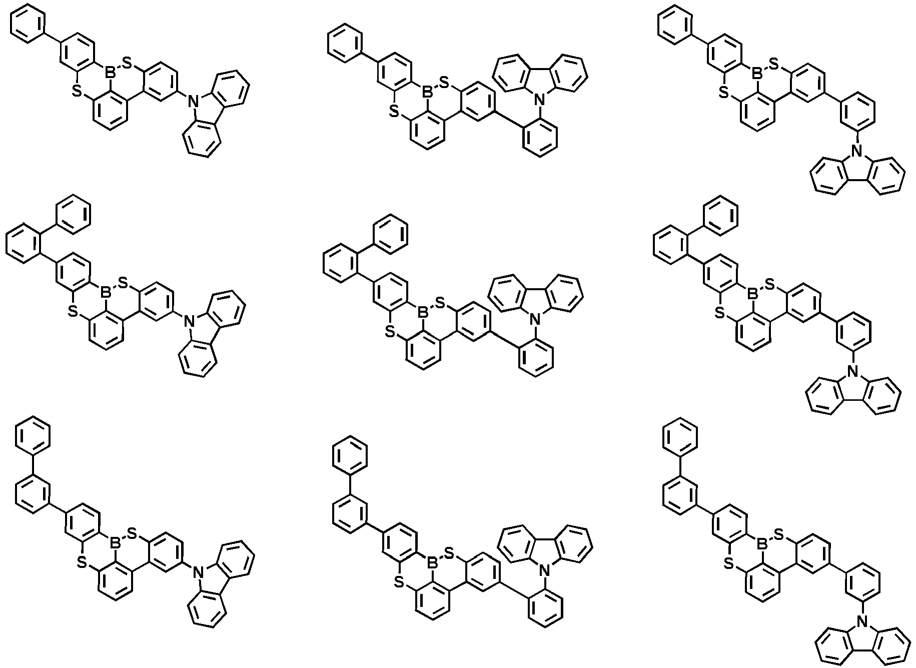

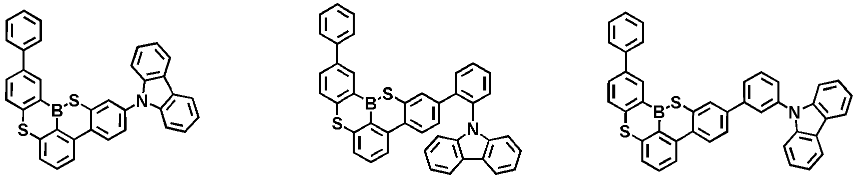

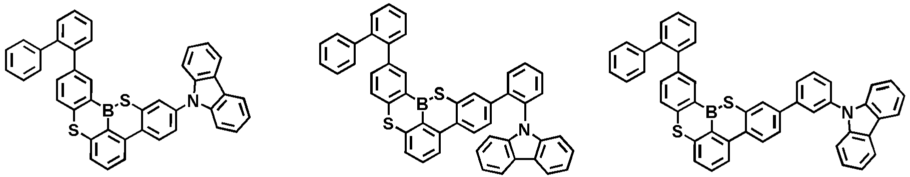

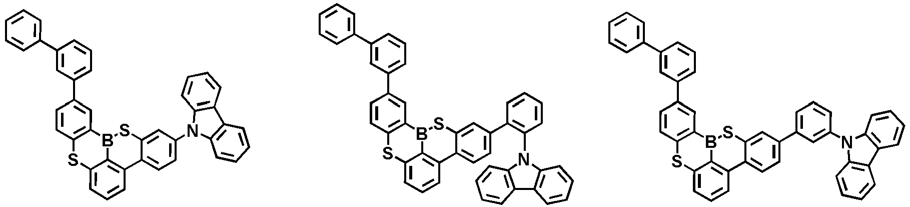

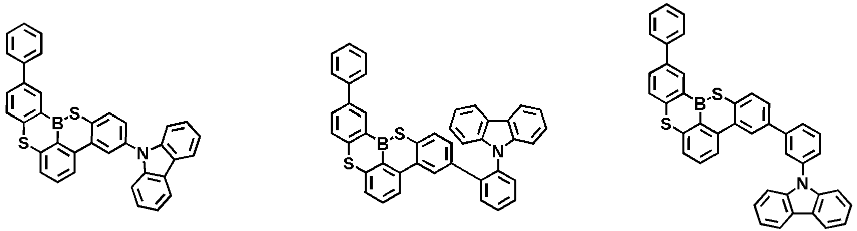

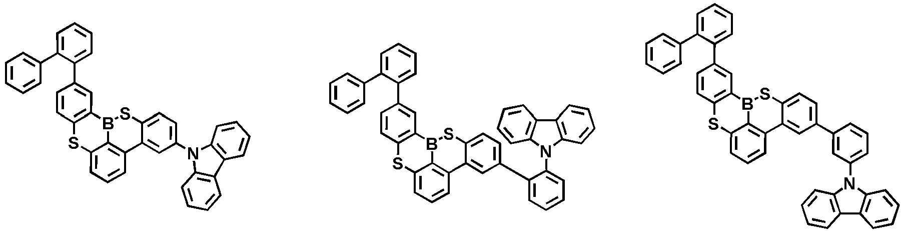

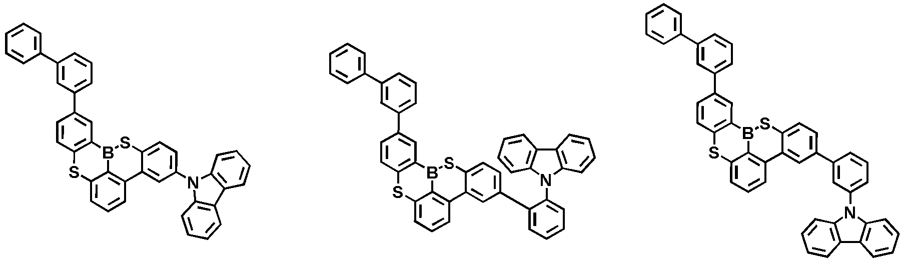

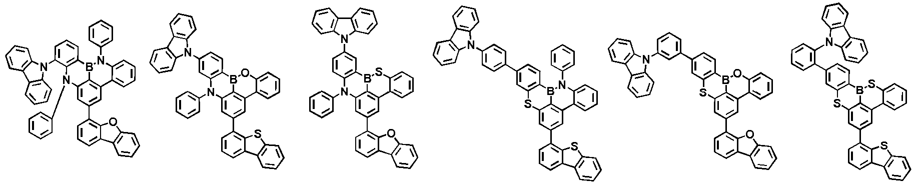

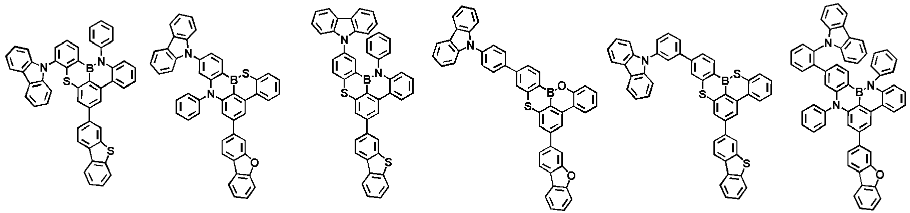

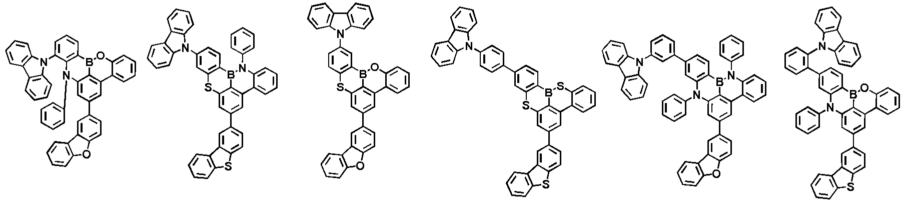

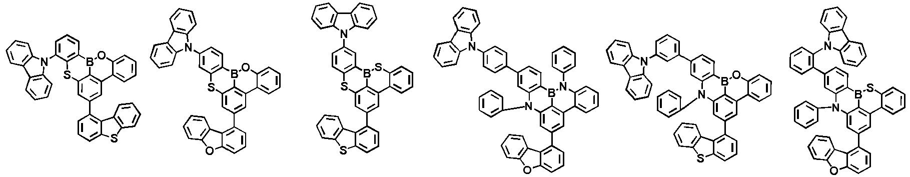

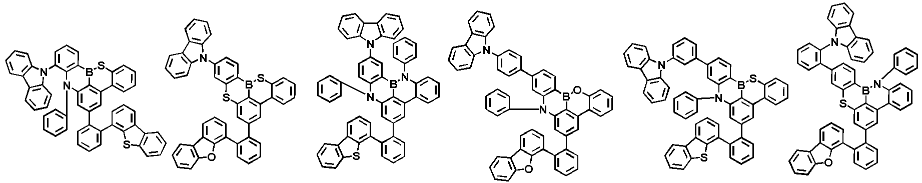

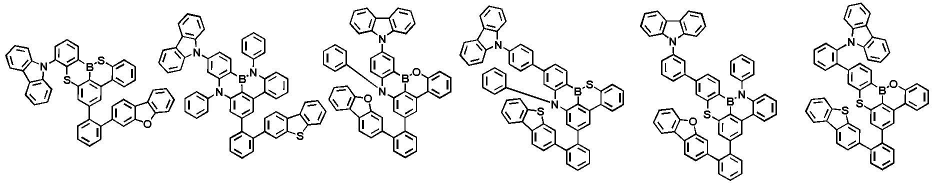

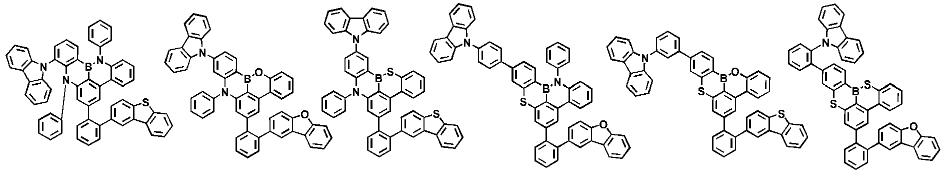

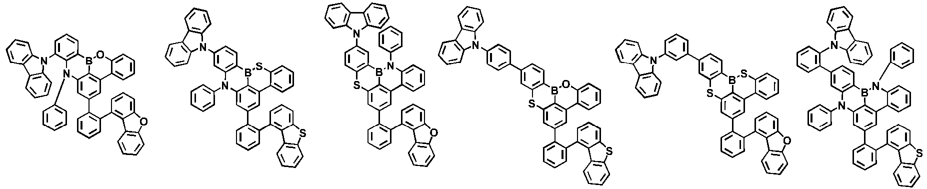

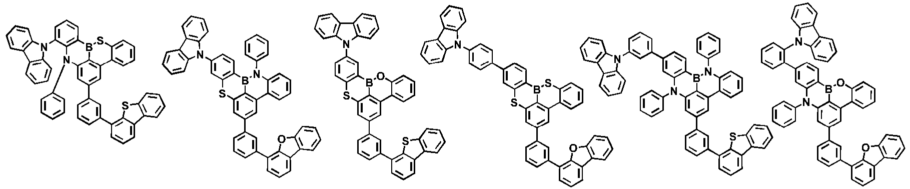

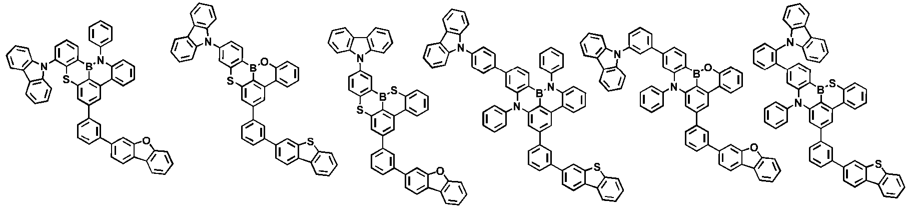

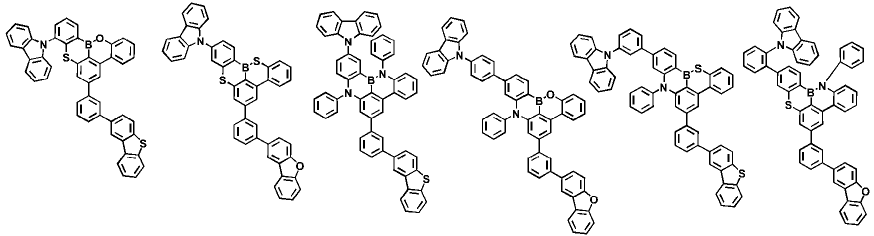

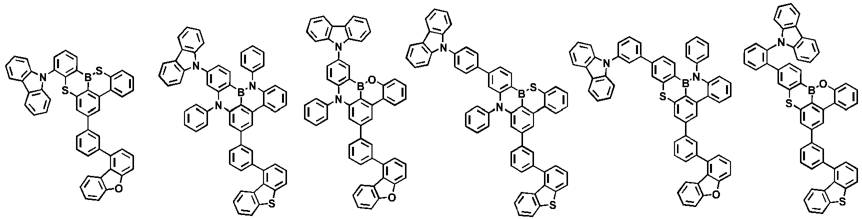

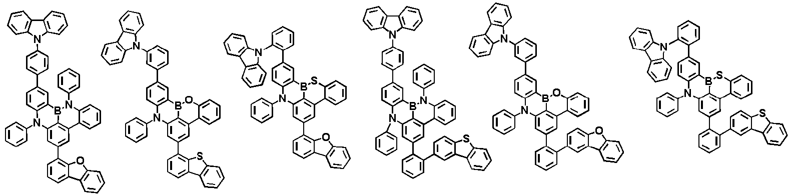

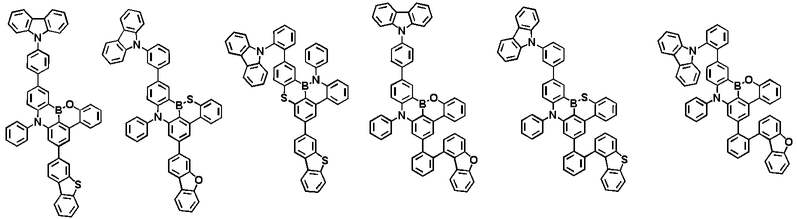

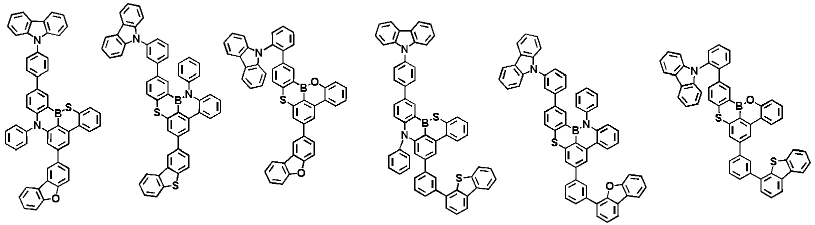

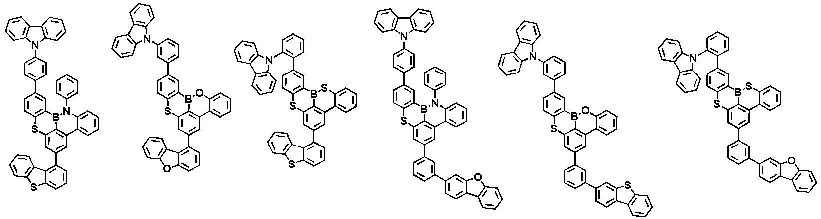

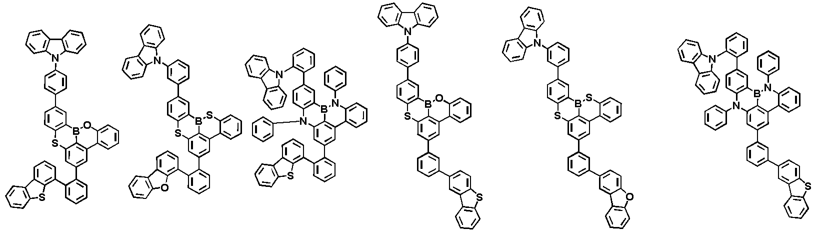

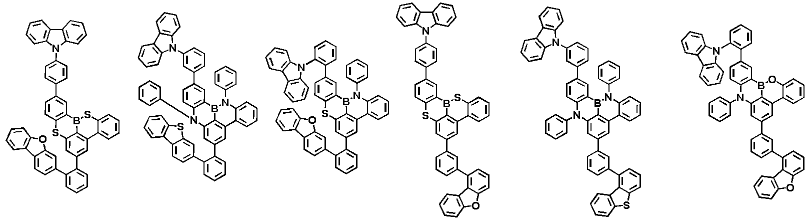

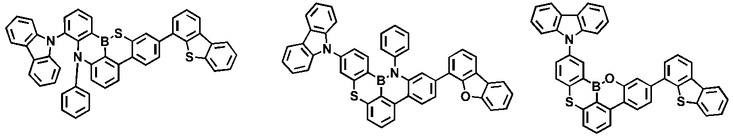

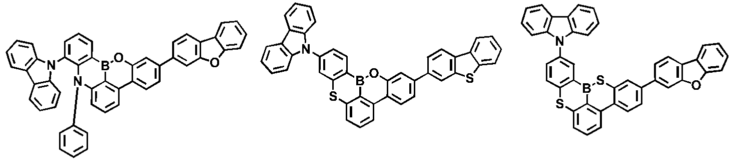

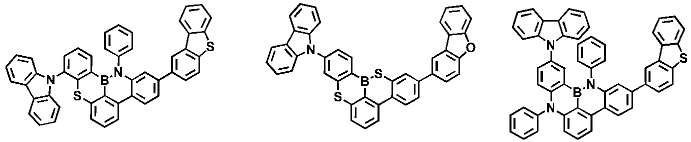

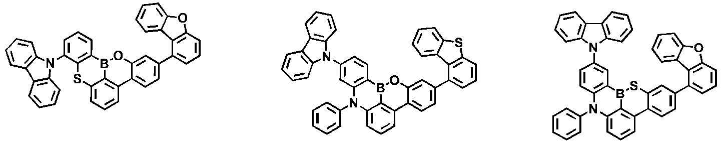

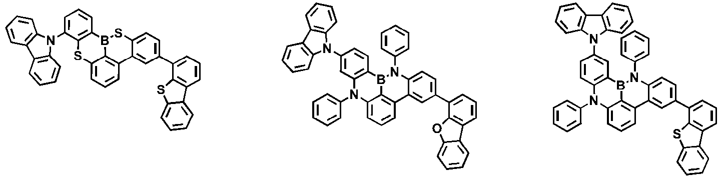

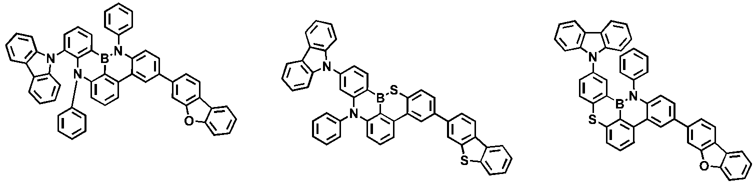

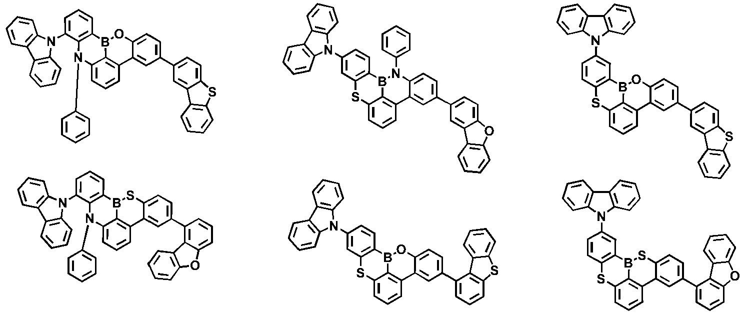

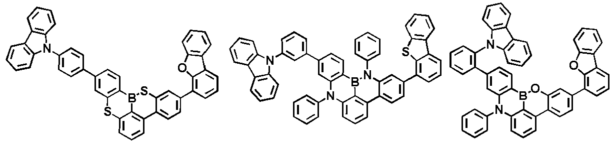

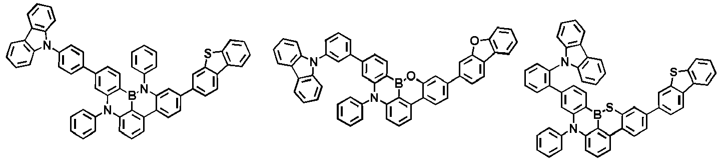

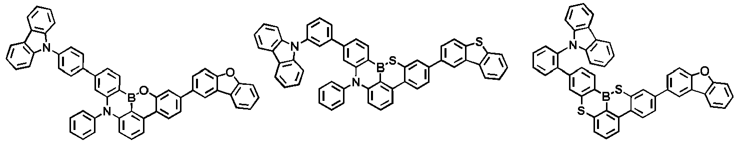

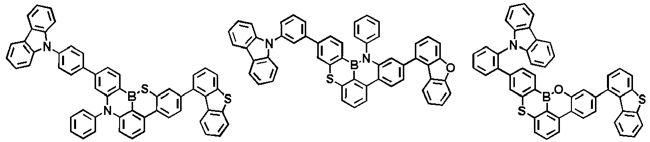

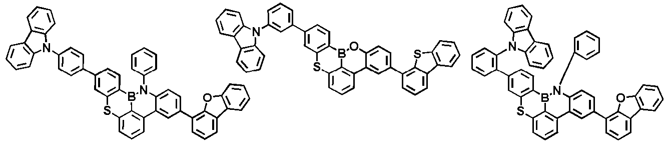

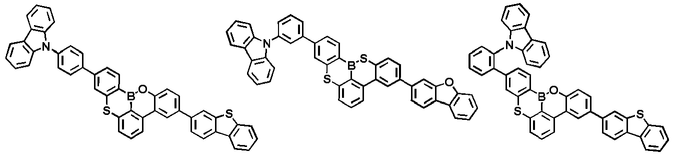

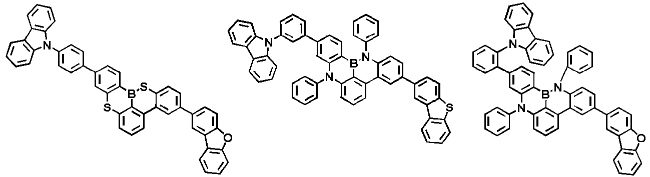

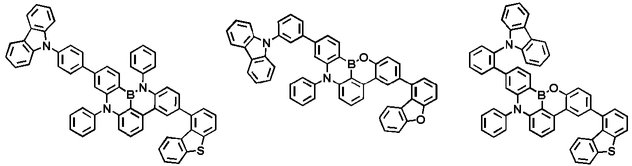

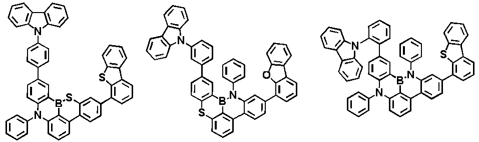

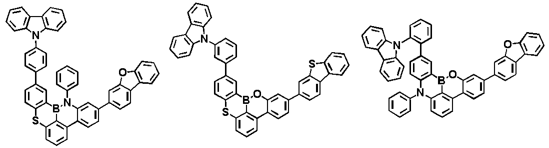

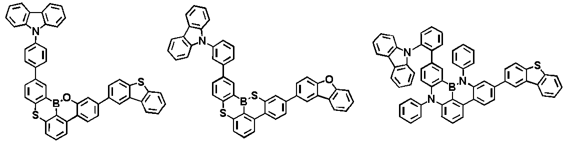

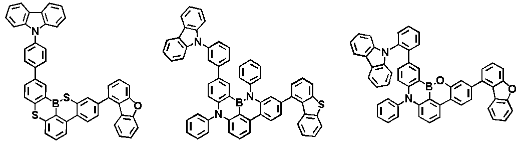

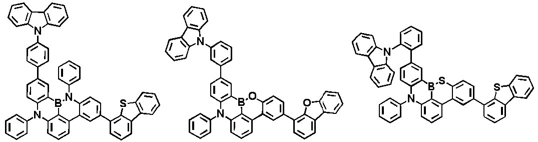

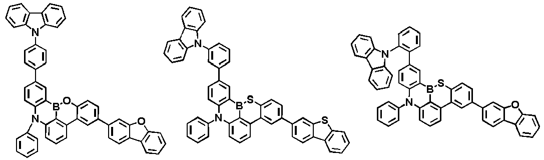

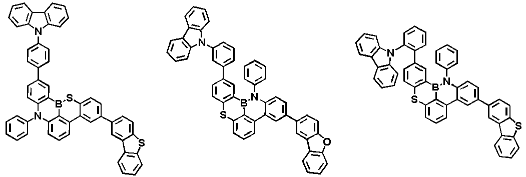

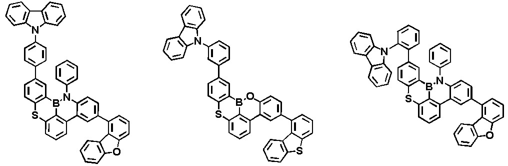

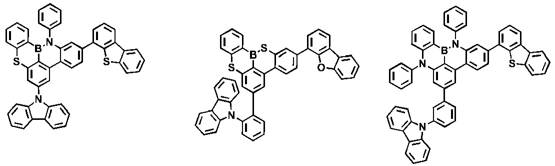

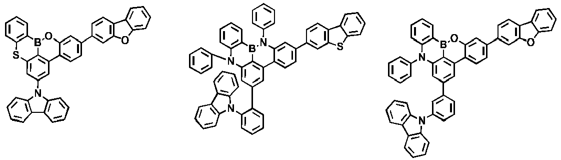

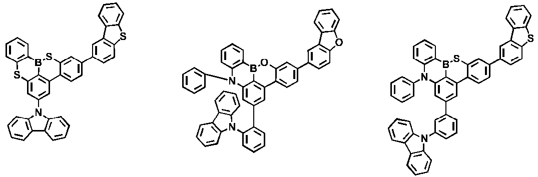

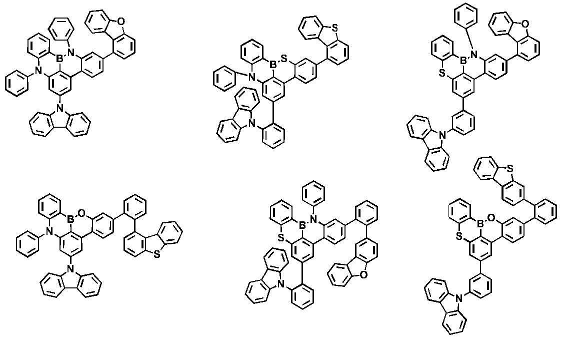

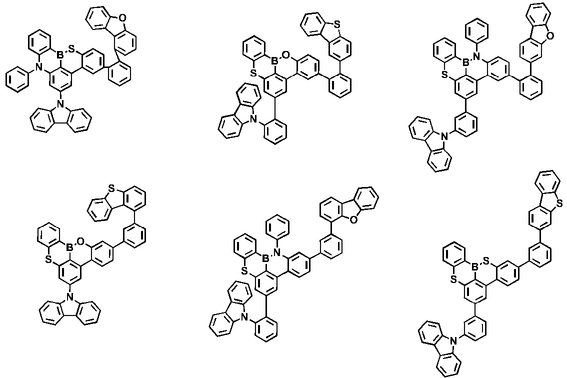

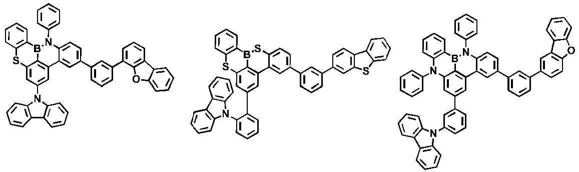

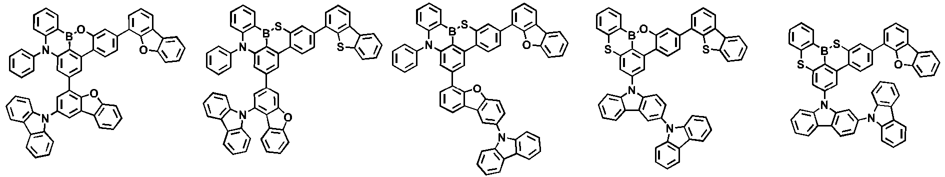

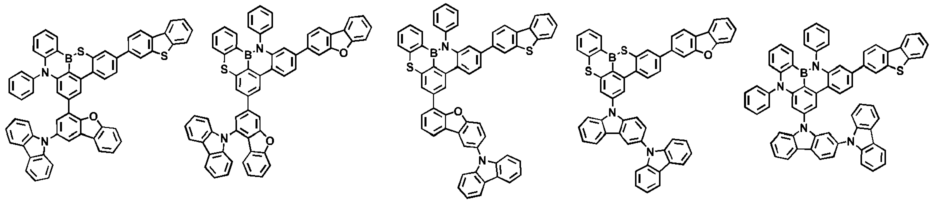

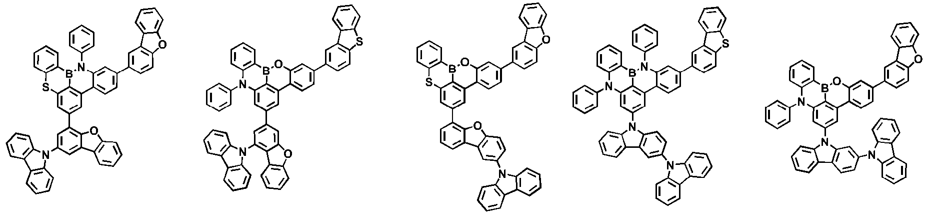

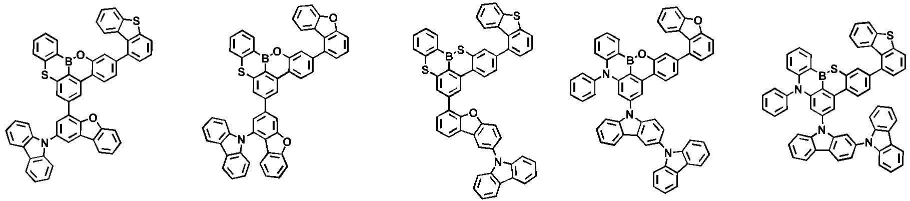

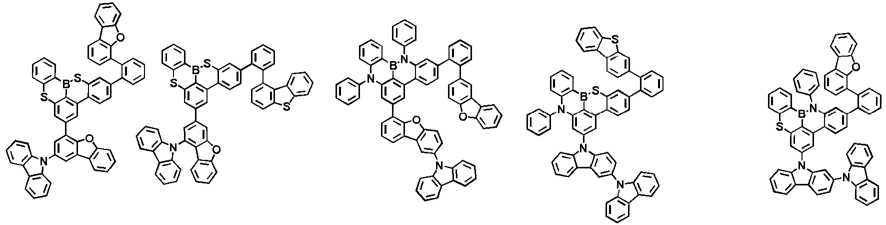

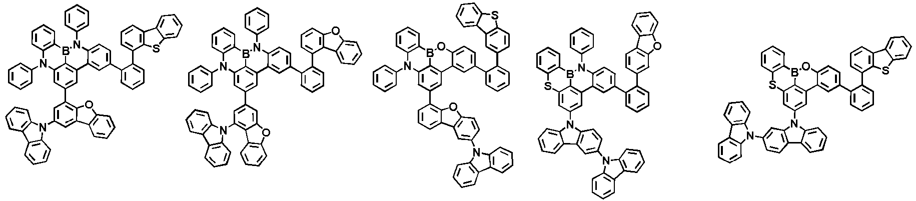

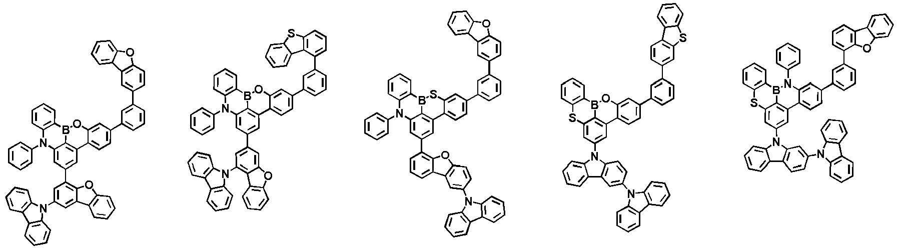

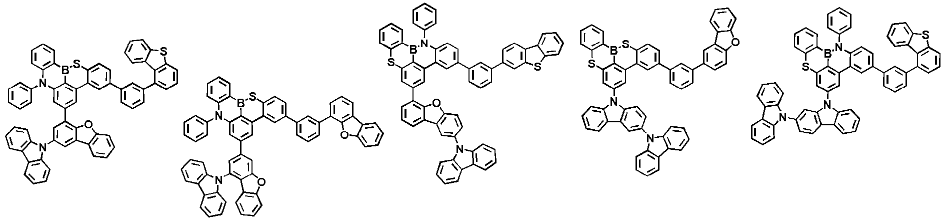

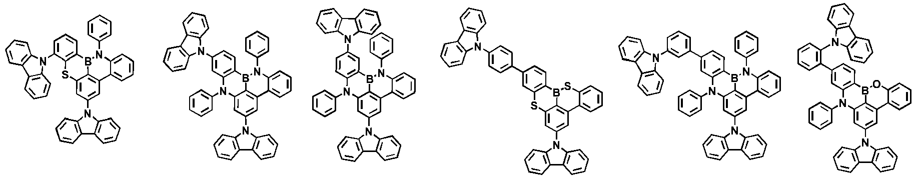

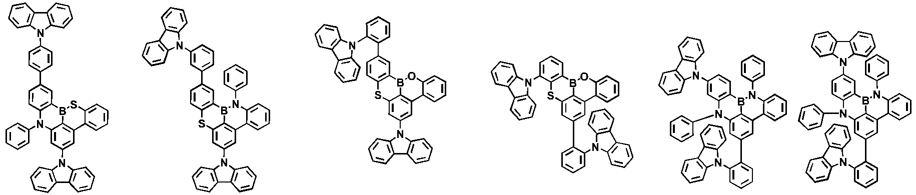

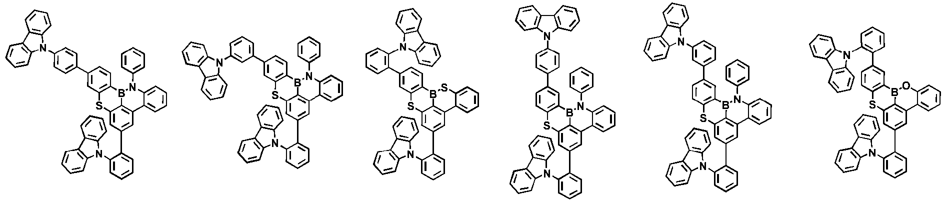

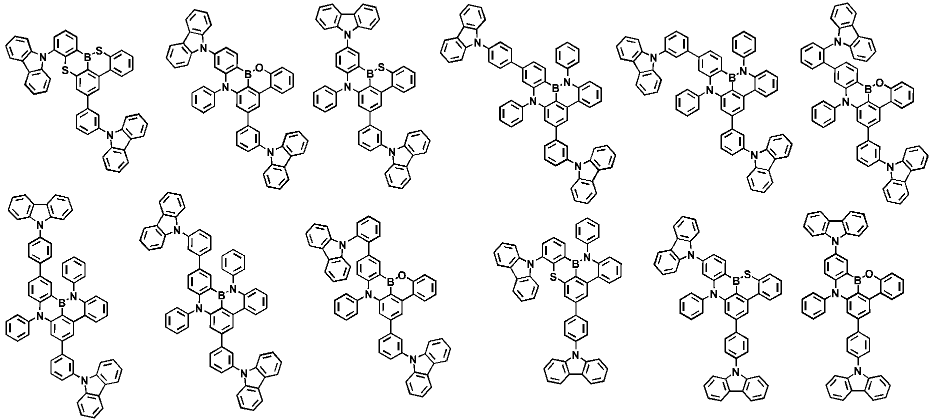

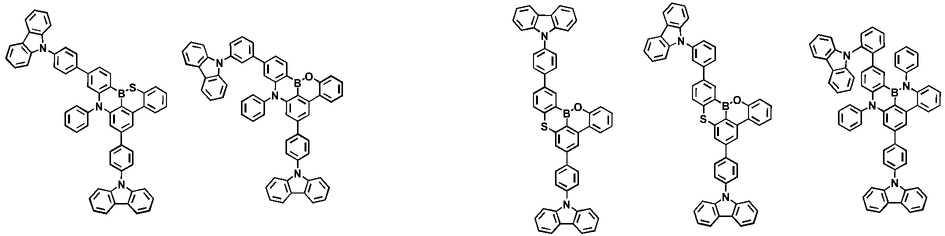

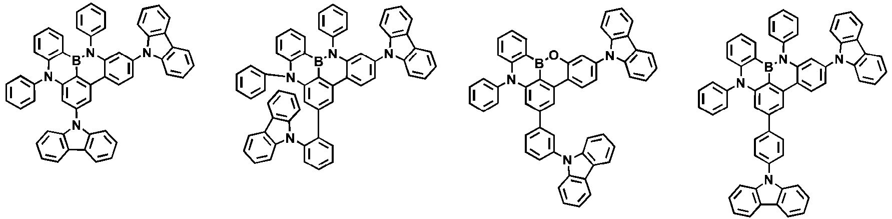

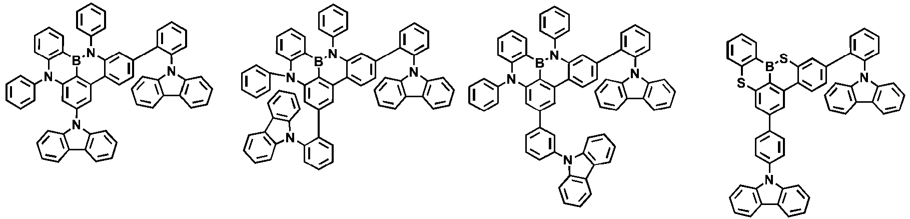

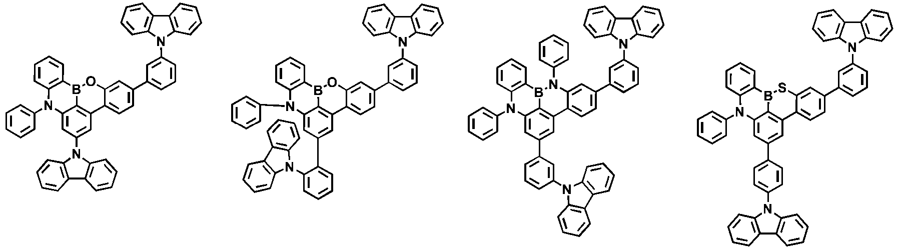

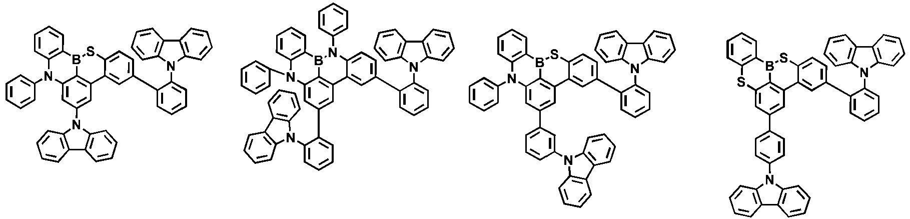

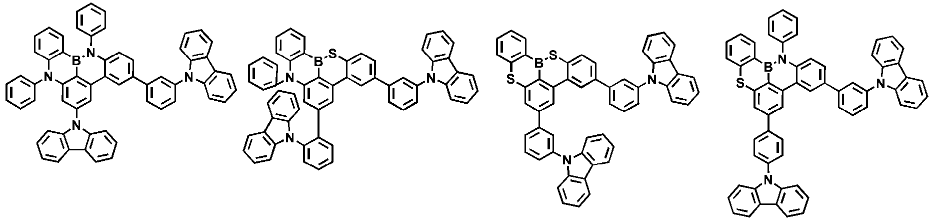

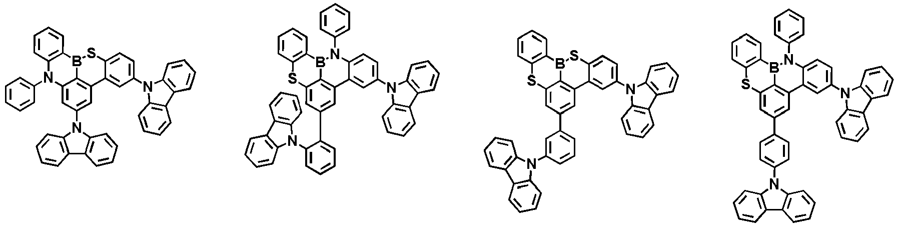

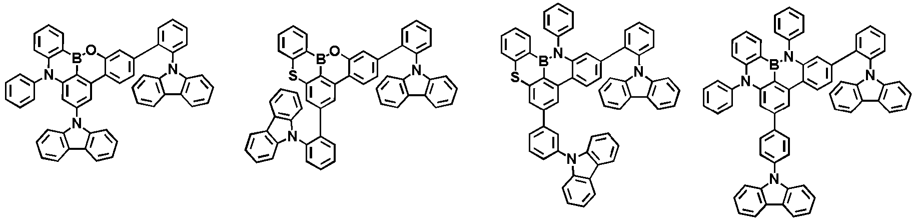

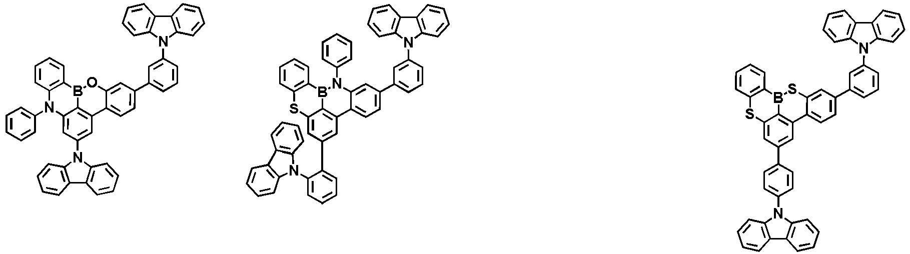

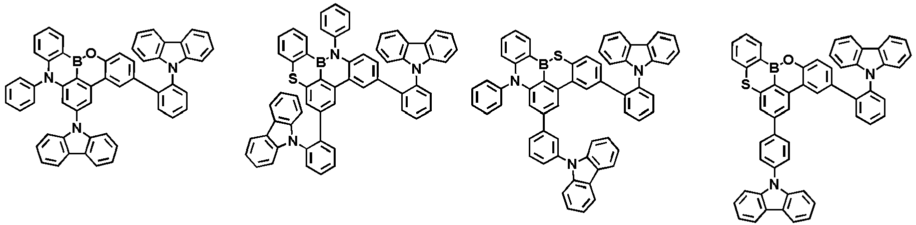

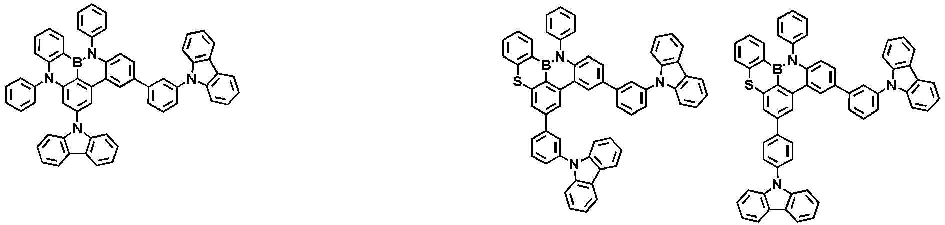

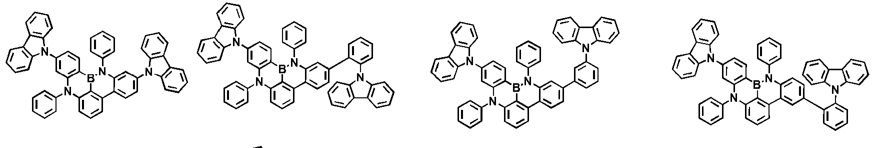

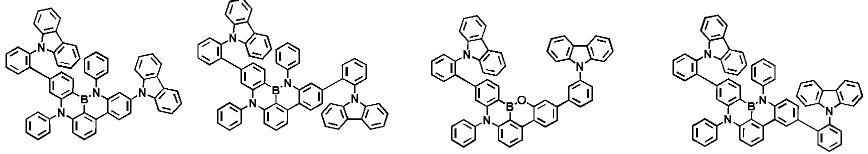

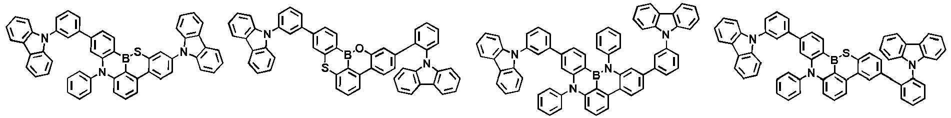

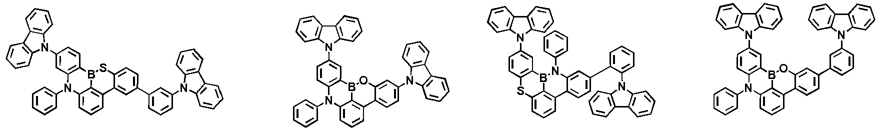

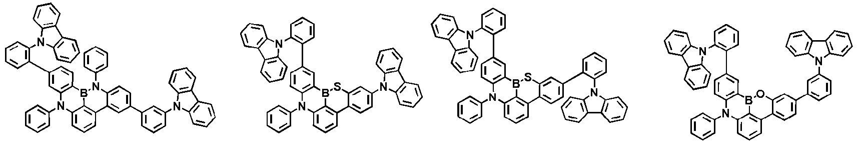

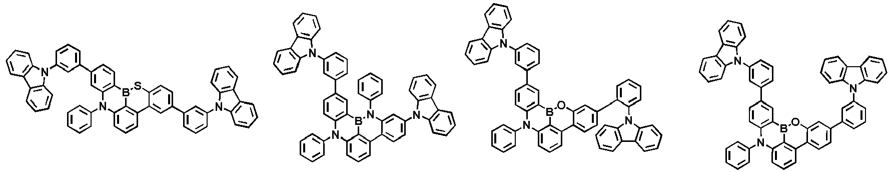

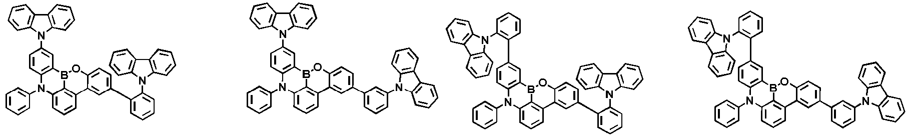

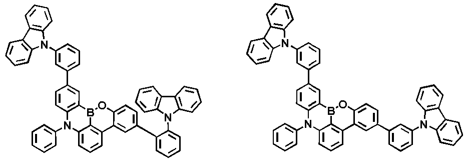

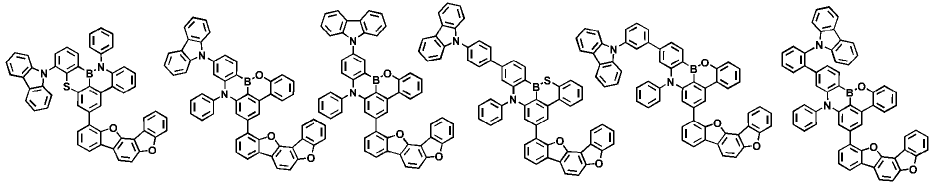

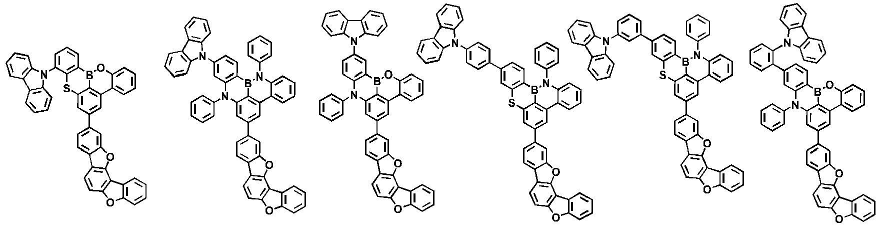

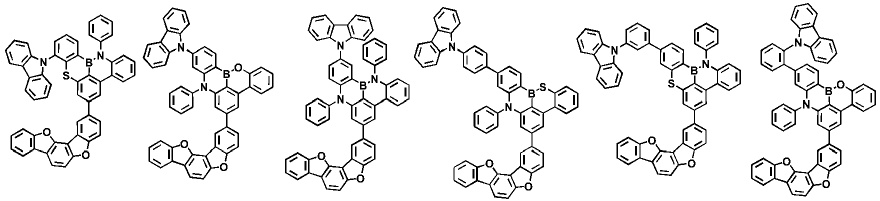

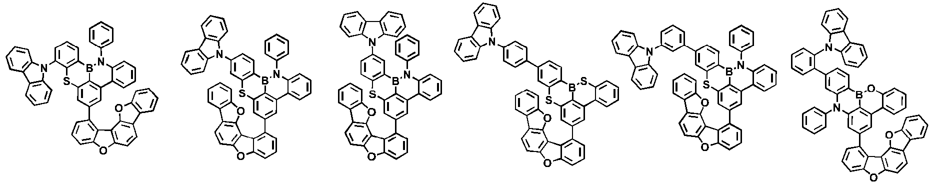

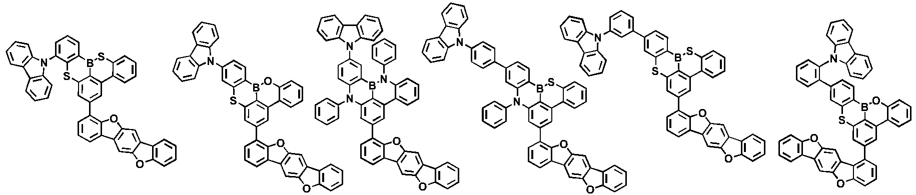

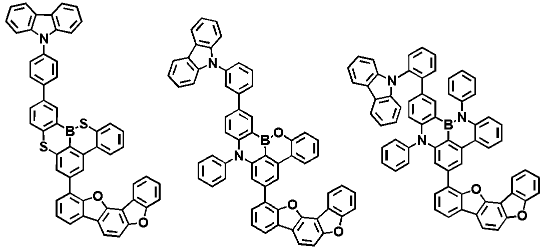

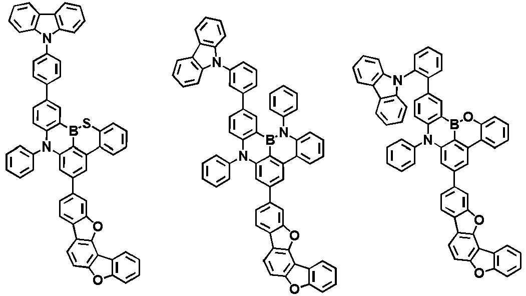

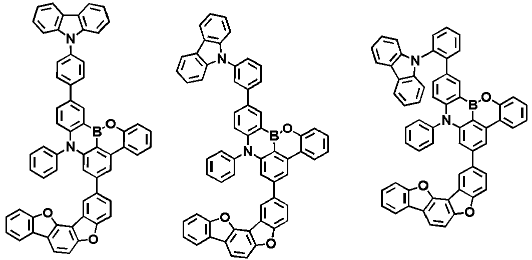

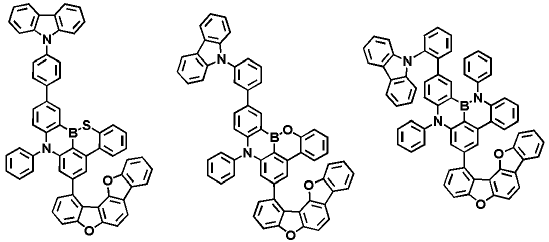

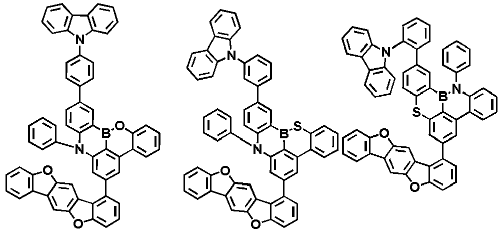

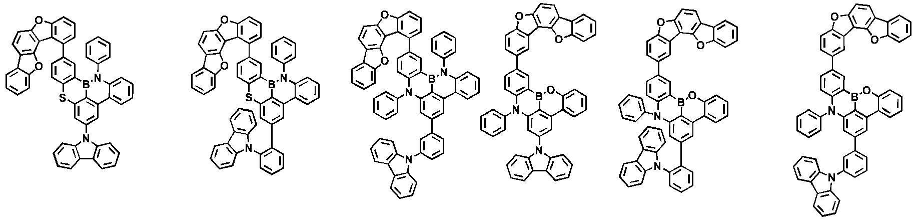

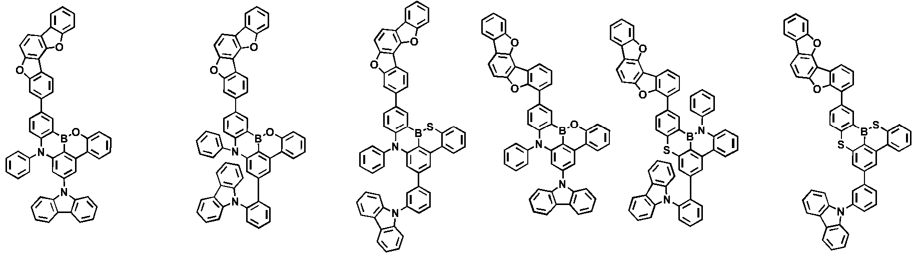

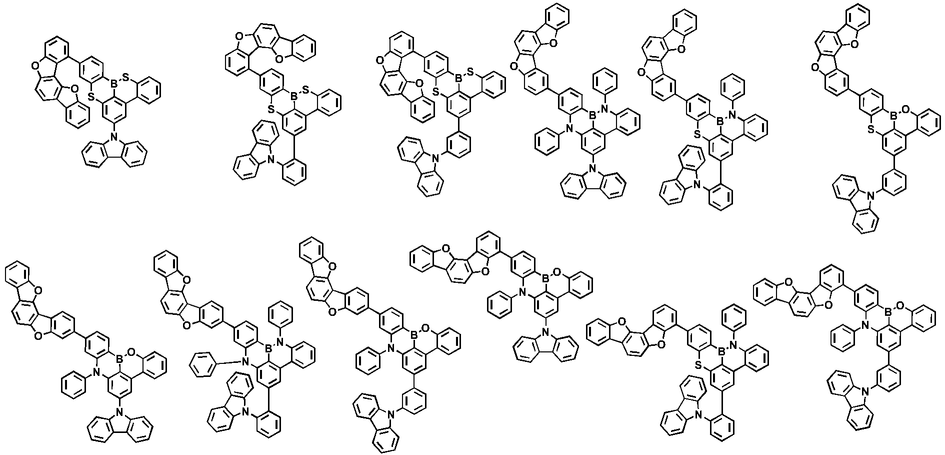

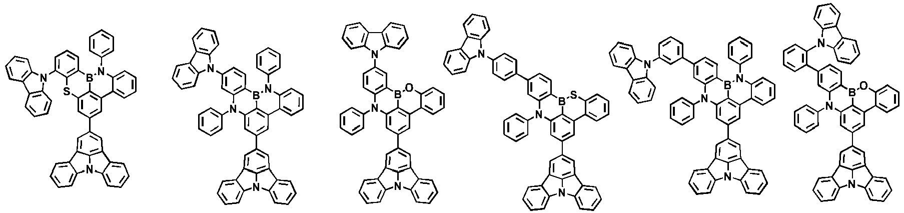

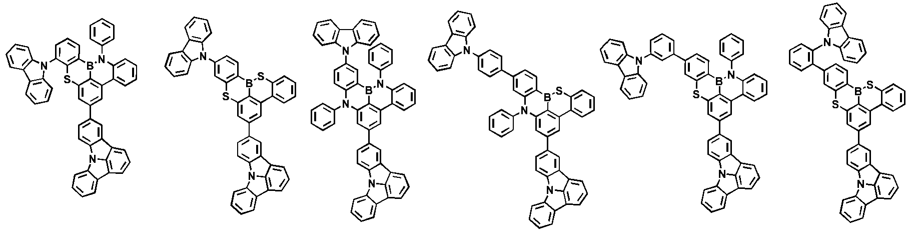

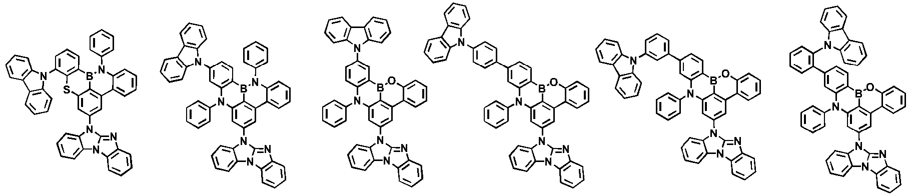

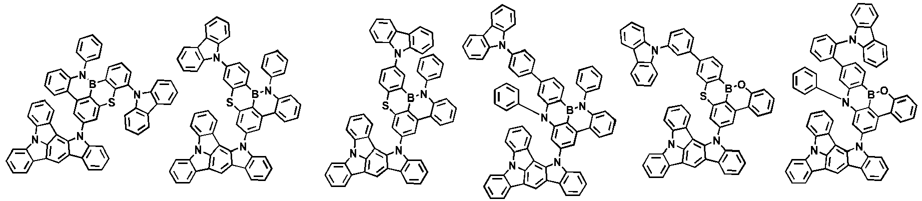

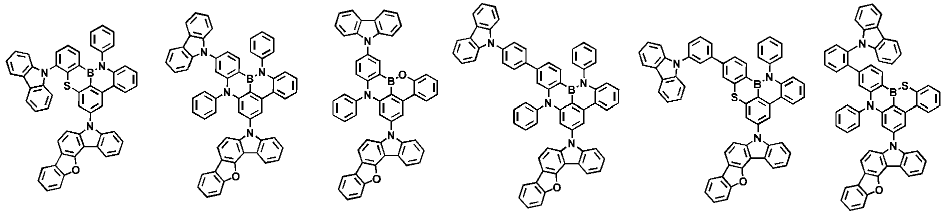

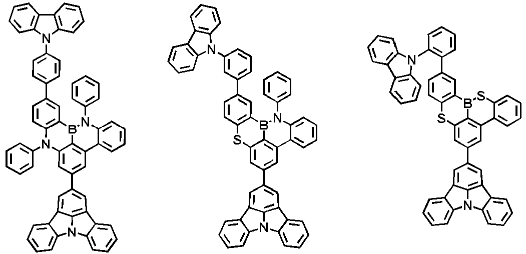

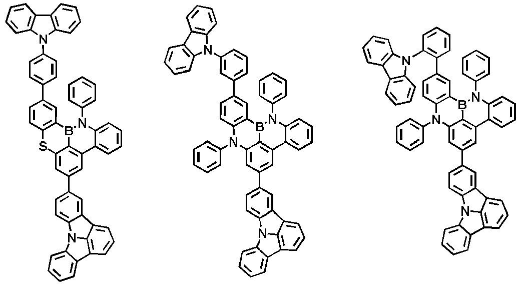

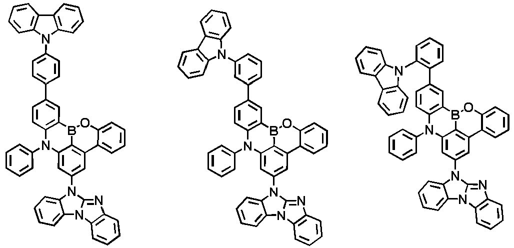

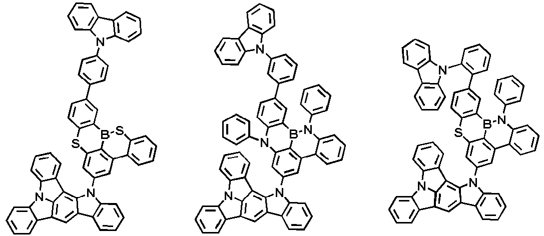

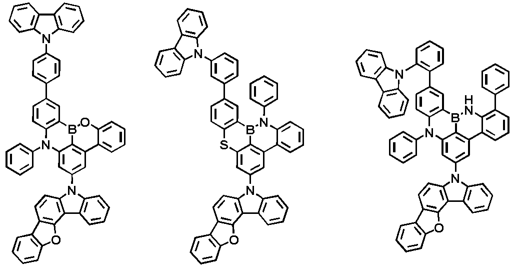

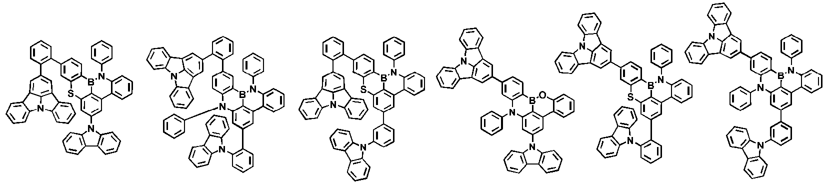

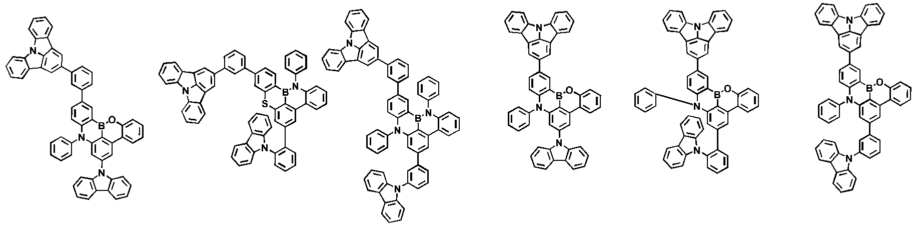

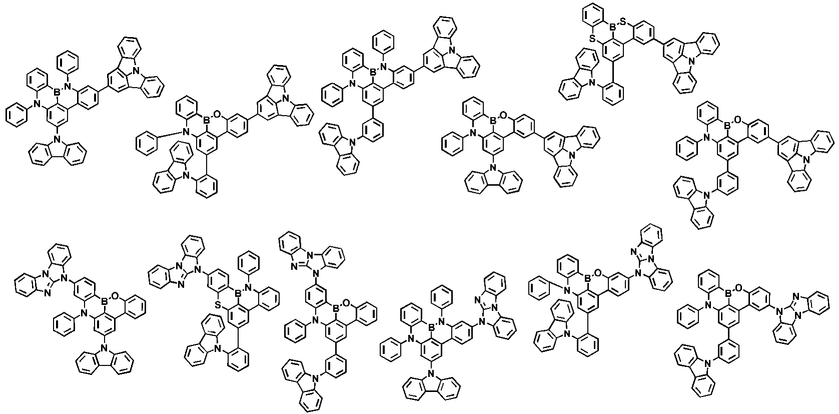

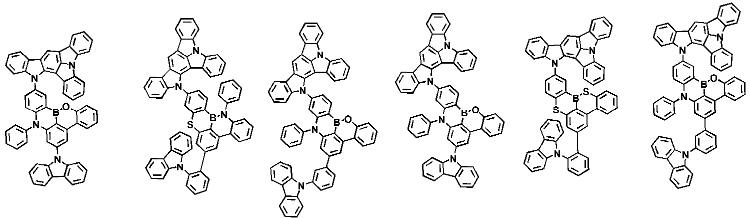

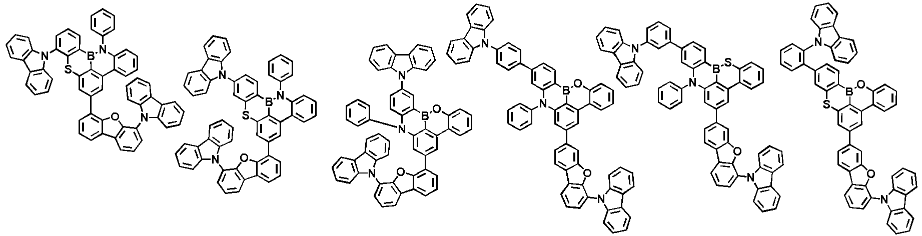

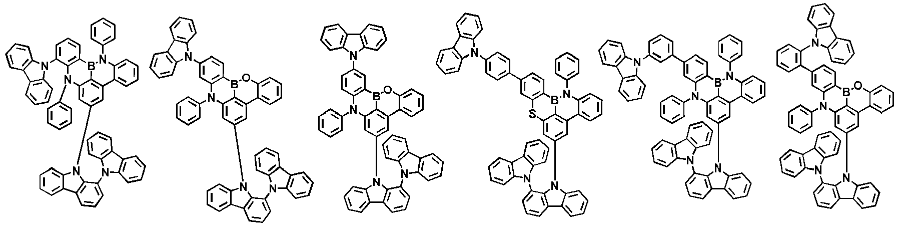

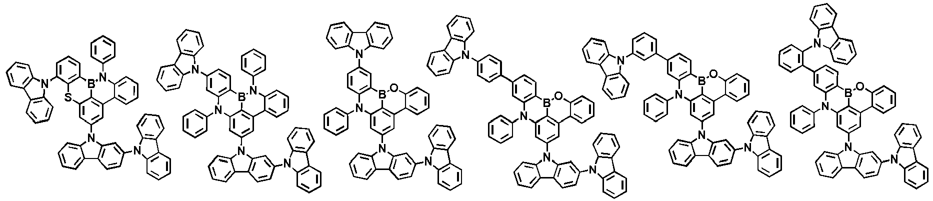

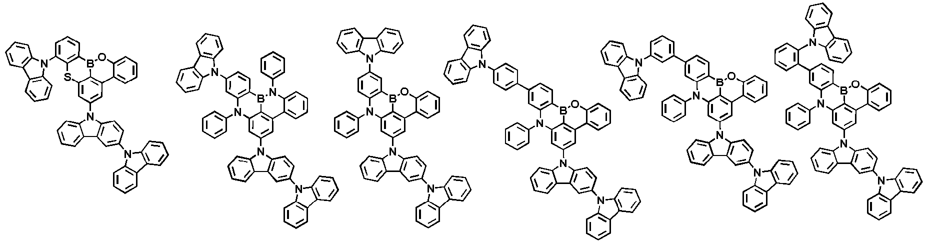

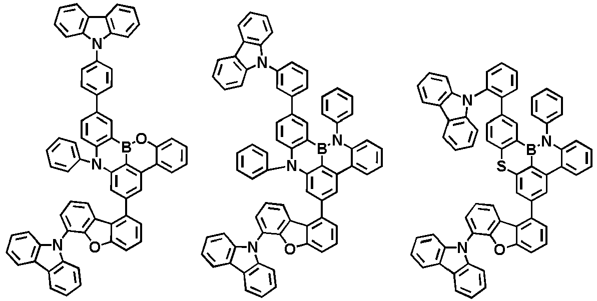

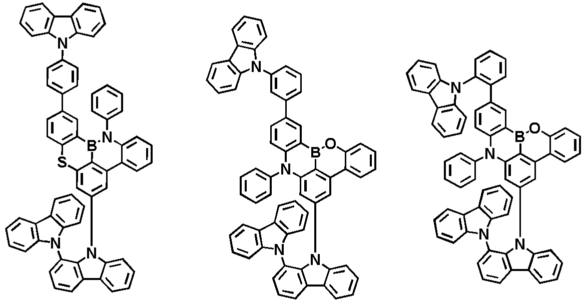

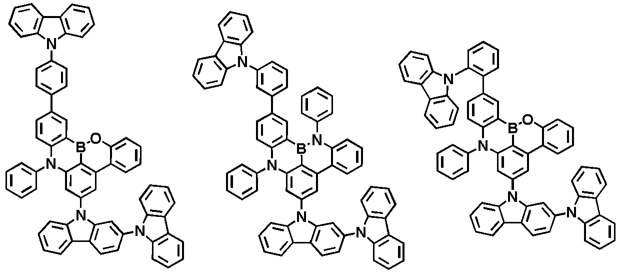

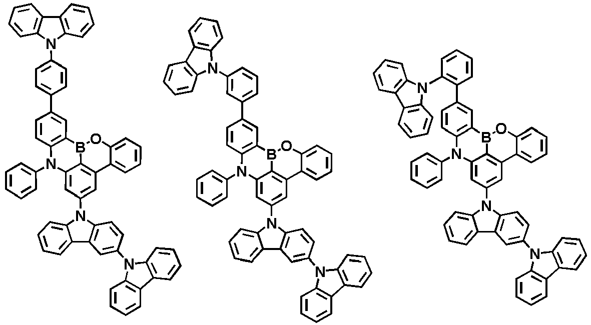

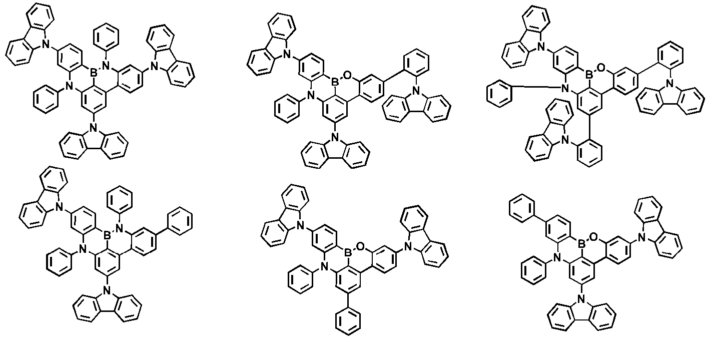

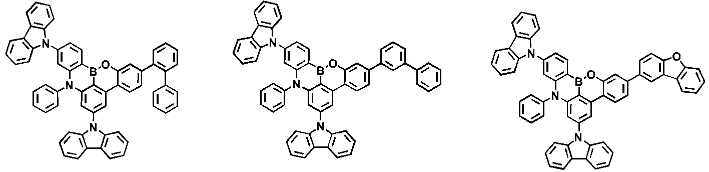

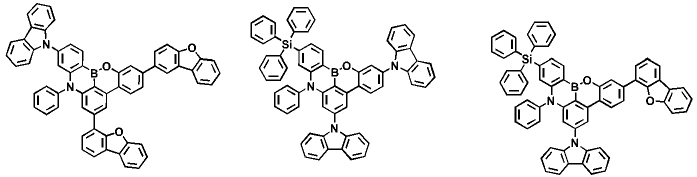

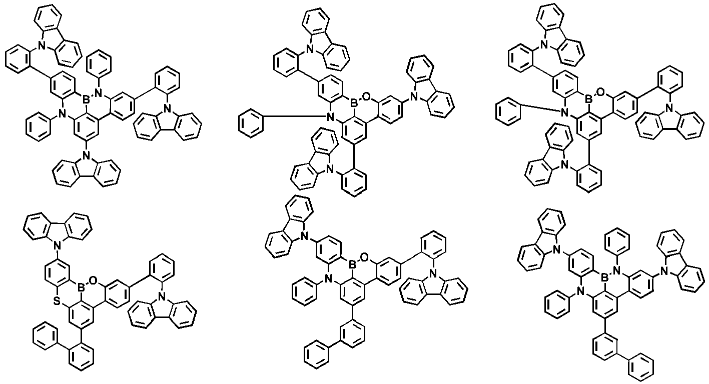

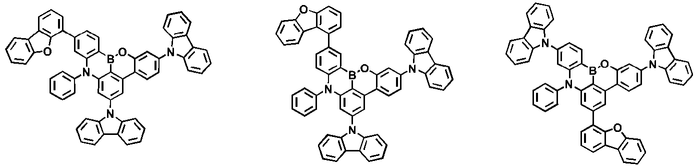

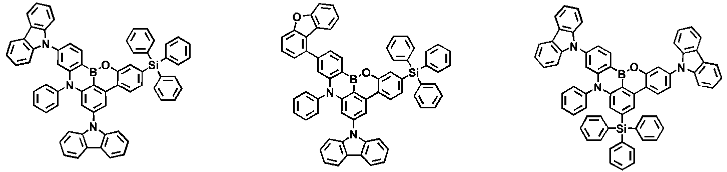

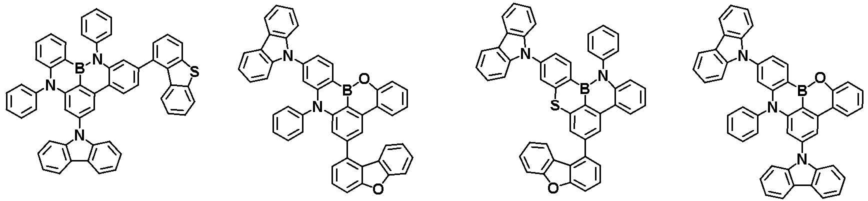

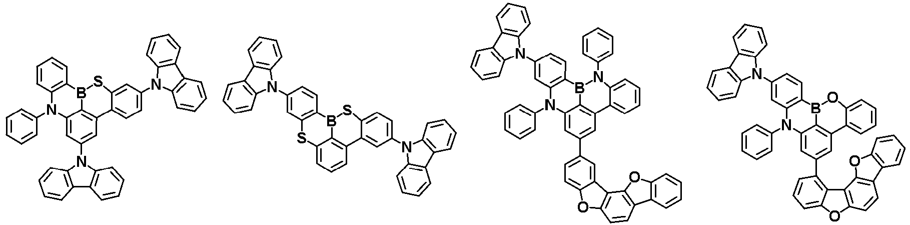

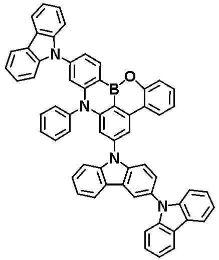

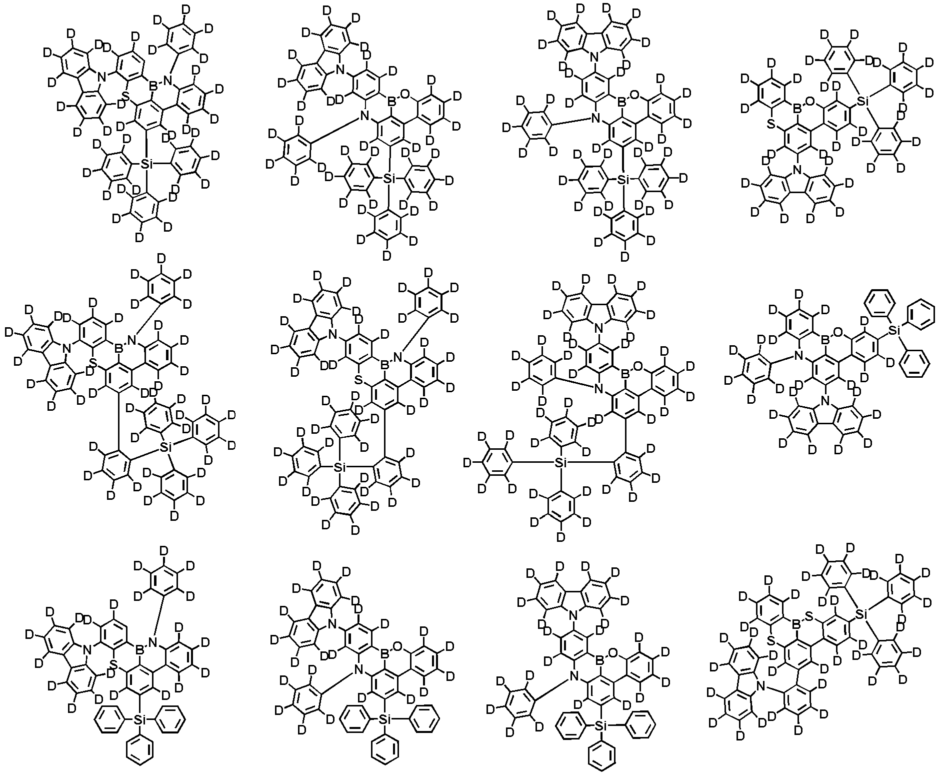

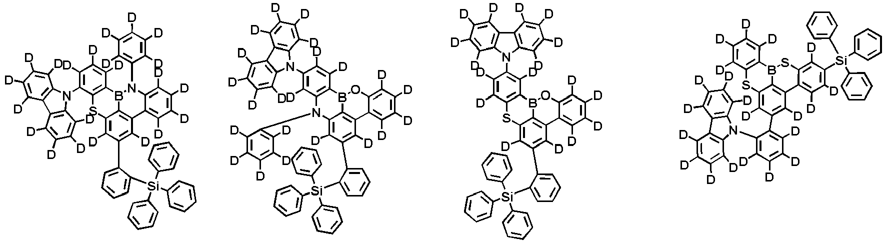

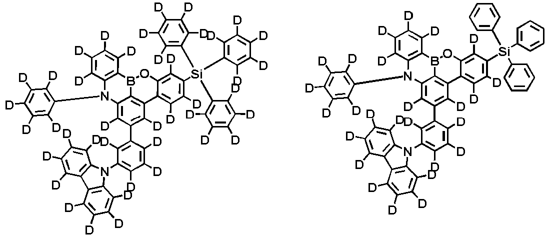

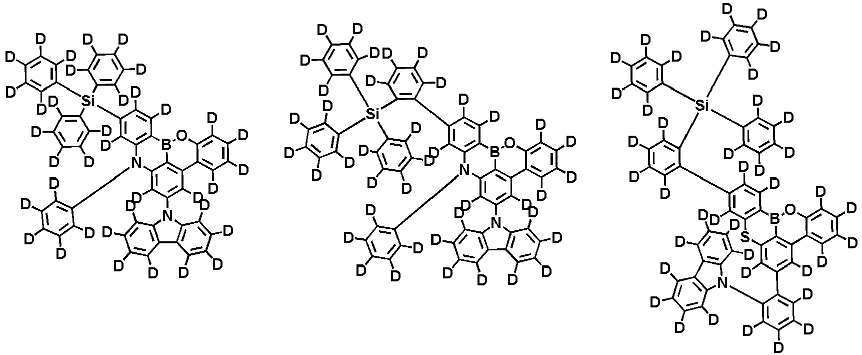

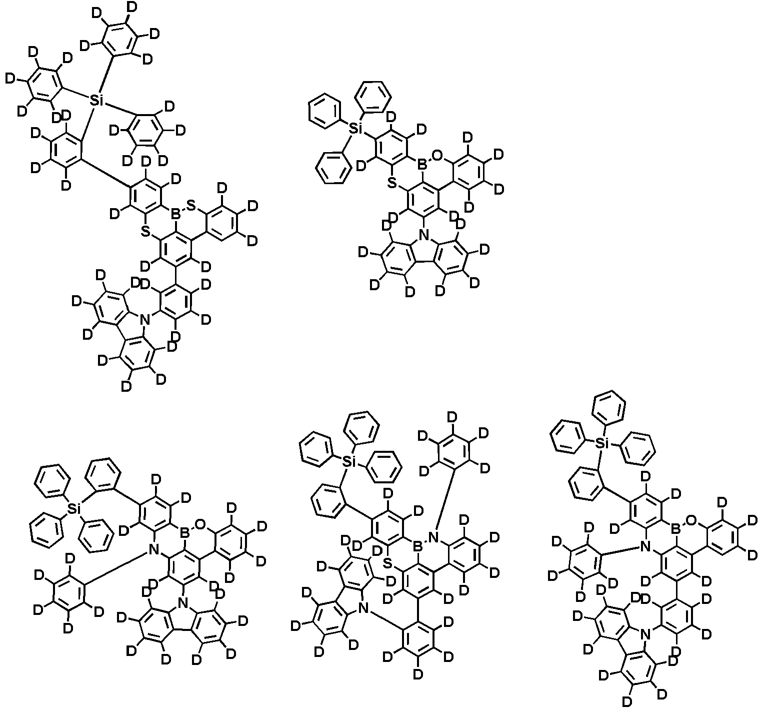

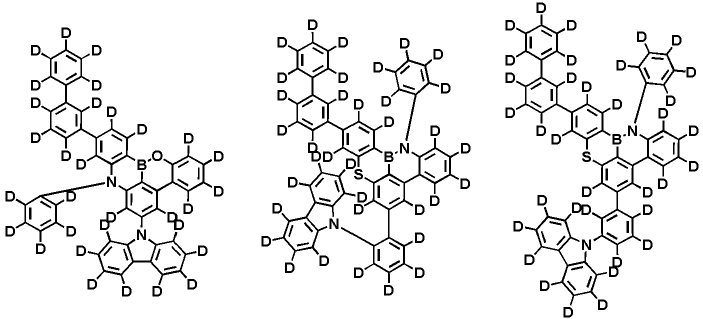

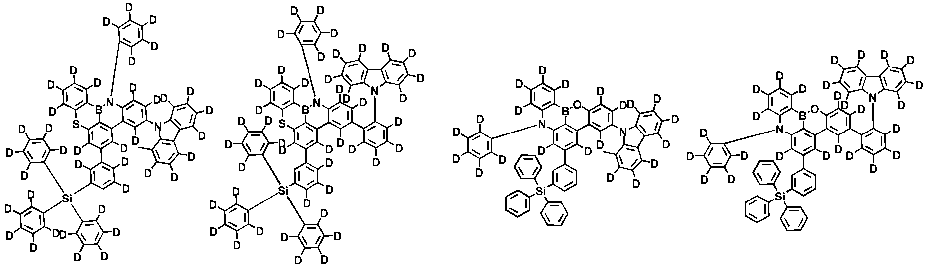

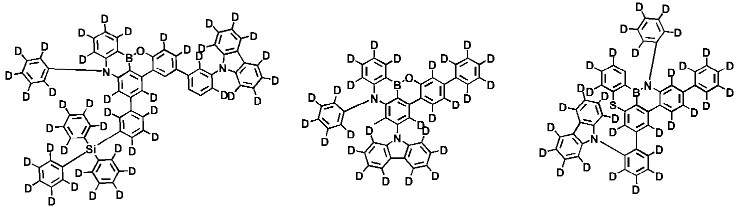

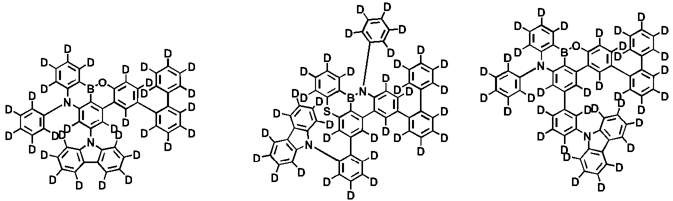

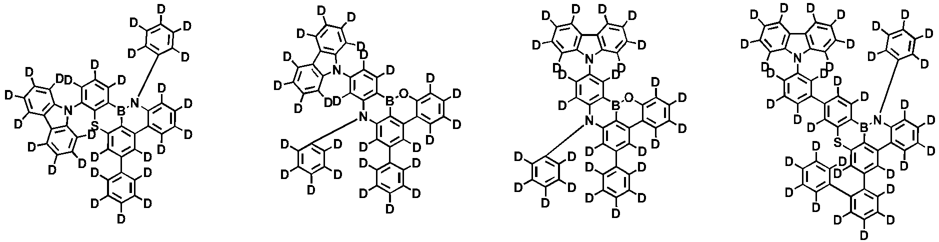

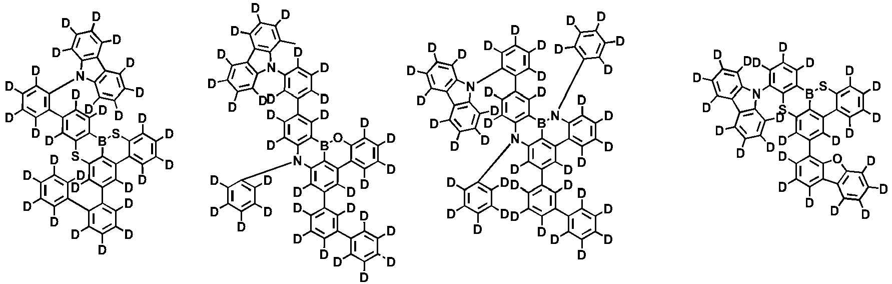

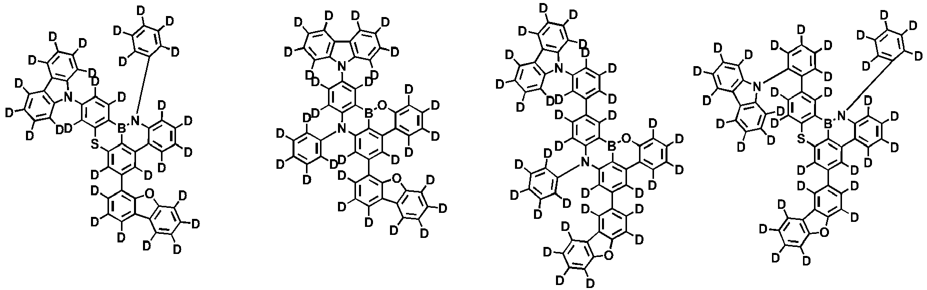

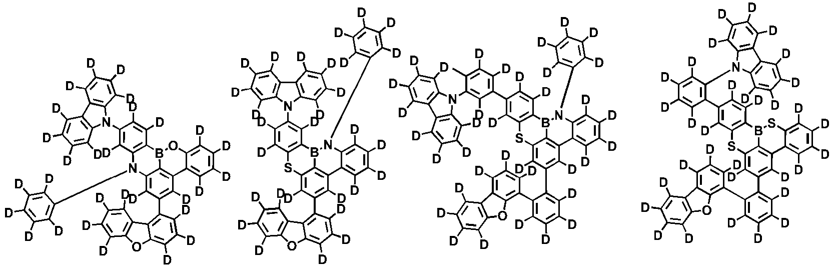

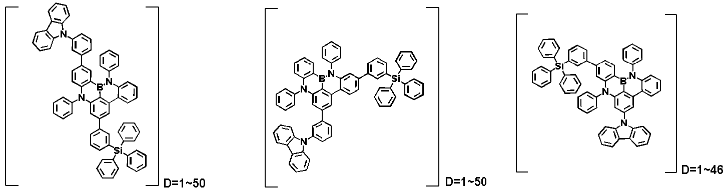

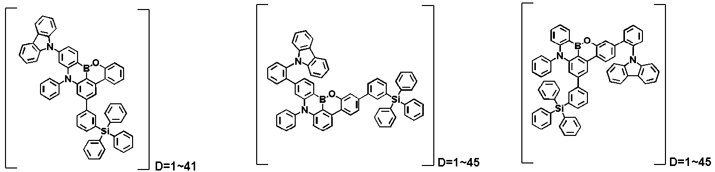

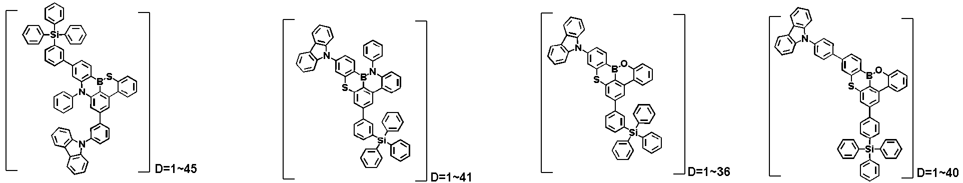

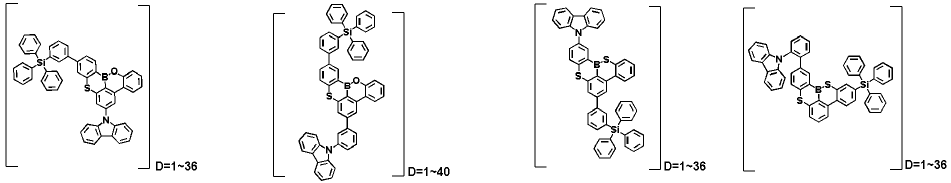

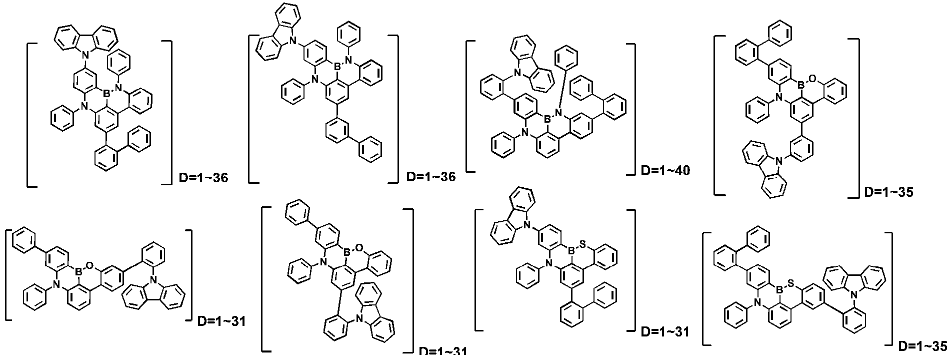

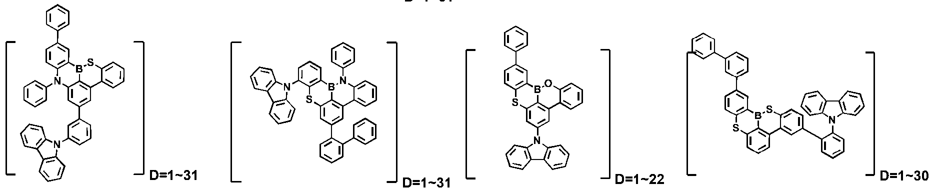

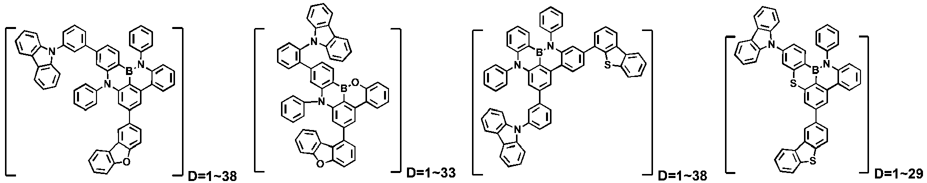

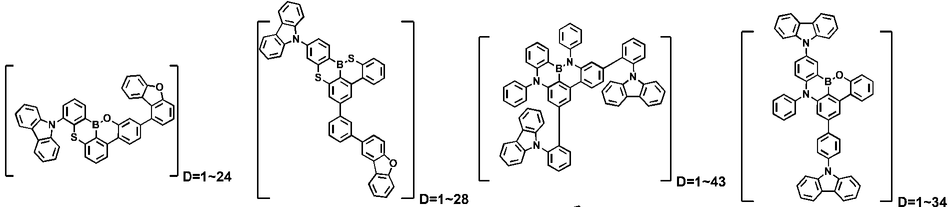

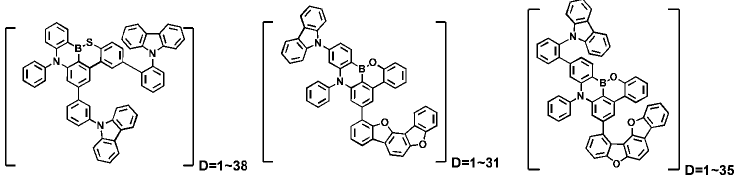

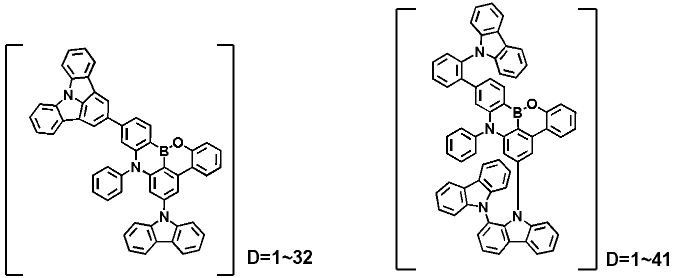

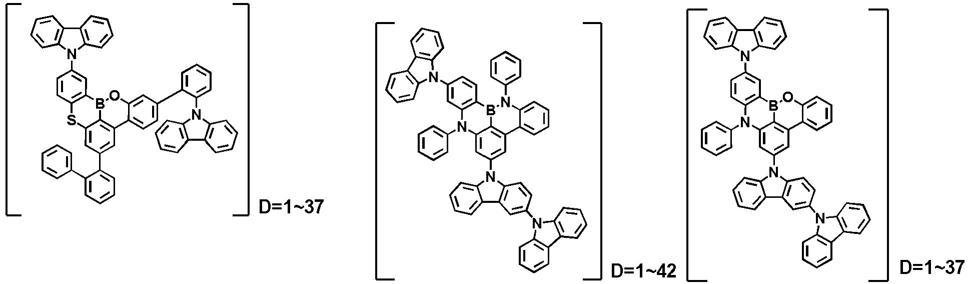

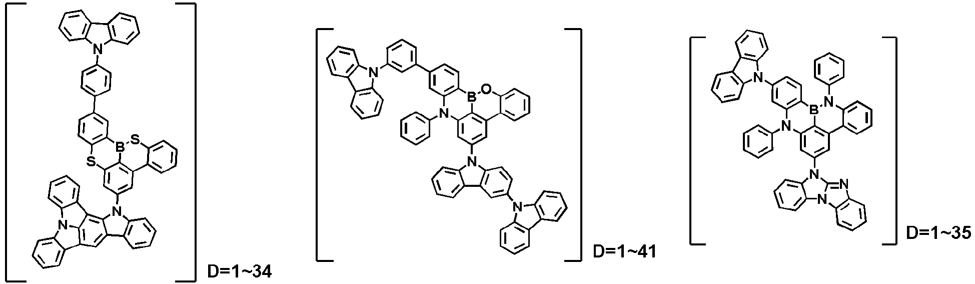

In the present specification, [ ]_{D=x1 to x2} means that a structure in the parenthesis comprises x1 to x2 deuteriums, and the value thereof is an integer. For example, [ ] _{D=1~41} means including 1 to 41 deuteriums. As an example, the structure includes 1 to 50 deuteriums.

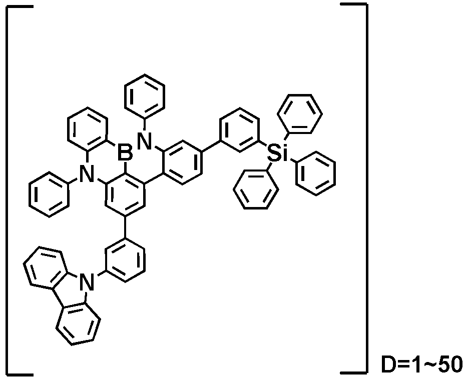

The compound represented by Chemical Formula 1 according to an exemplary embodiment of the present specification may be synthesized by a synthesis method known in the art using starting materials, intermediates, and the like known in the art, substituents may be bonded by a method known in the art, and the type, position, or number of substituents may be changed according to the technology known in the art.

In the present specification, compounds having various energy band gaps may be synthesized by introducing various substituents into the core structure of the compound represented by Chemical Formula 1. Further, in the present specification, various substituents may be introduced into the core structures having the structure described above to adjust the HOMO and LUMO energy levels of a compound.

Further, the present specification provides an organic light emitting device including the above-described compound.

When one member is disposed "on" another member in the present specification, this includes not only a case where the one member is brought into contact with another member, but also a case where still another member is present between the two members.

When one part "includes" one constituent element in the present specification, unless otherwise specifically described, this does not mean that another constituent element is excluded, but means that another constituent element may be further included.

An organic light emitting device according to the present specification is an organic light emitting device including: a first electrode; a second electrode; and an organic material layer having one or more layers provided between the first electrode and the second electrode, in which one or more layers of the organic material layer include the above-described compound represented by Chemical Formula 1.

The organic light emitting device of the present specification may be manufactured using typical manufacturing methods and materials of an organic light emitting device, except that the above-described compound of Chemical Formula 1 is used to form an organic material layer.

The organic material layer of the organic light emitting device of the present specification may also have a single-layered structure, but may have a multi-layered structure in which two or more organic material layers are stacked. For example, the organic light emitting device of the present invention may have a multi-layered structure including one or more layers of a hole transport layer, a hole injection layer, an electron blocking layer, a hole transport and injection layer, an electron transport layer, an electron injection layer, a hole blocking layer, and an electron transport and injection layer as organic material layers. However, the structure of the organic light emitting device of the present specification is not limited thereto, and may be a single-layered structure. Further, when an organic light emitting device is manufactured using the compound, the organic light emitting device may be manufactured to include a fewer number of layers by not only a vacuum deposition method, but also a method such as a solvent process, for example, spin coating, dip coating, doctor blading, screen printing, inkjet printing, or a thermal transfer method, but the method is not limited thereto.

In an exemplary embodiment of the present specification, the organic material layer including the compound of Chemical Formula 1 may have a thickness of 5 Å to 2000 Å, or 5 Å to 500 Å, and has a thickness of preferably 10 Å to 400 Å.

In another exemplary embodiment, the organic material layer may further include other organic compounds, metals or metal compounds in addition to the compound represented by Chemical Formula 1.

In an exemplary embodiment of the present specification, the organic material layer includes a light emitting layer, and the light emitting layer may include the compound represented by Chemical Formula 1.

In an exemplary embodiment of the present specification, the organic material layer includes a light emitting layer, and the light emitting layer may include the compound represented by Chemical Formula 1 as a host.

In an exemplary embodiment of the present specification, the organic material layer includes a light emitting layer, and the light emitting layer may include the compound represented by Chemical Formula 1 as an n-type host, and specifically as an n-type phosphorescent host.

In an exemplary embodiment of the present specification, the organic material layer includes a light emitting layer, and the light emitting layer includes the compound represented by Chemical Formula 1 as a first host and may further include an additional second host.

In an exemplary embodiment of the present specification, the organic material layer includes a light emitting layer, the light emitting layer includes the compound represented by Chemical Formula 1 as an n-type first host and may further include a p-type second host, specifically, the fist host is an n-type phosphorescent host, and the second host may be a p-type phosphorescent host.

In the present specification, the n-type may be defined as a material that can steal electrons from a matrix material (the material of an organic layer) and has characteristics capable of providing electrons to the lowest unoccupied molecular orbital (LUMO) energy level of the matrix.

In contrast, in the present specification, the p-type may be defined as a material that, when a layer is composed of only p-type materials, receives electrons at the highest occupied molecular orbital (HOMO) energy level of a material located in the adjacent cathode direction to generate holes in the material in the adjacent cathode direction, and the closer the HOMO level of the material located in the cathode direction is to the LUMO of a p-type material, the more easily electrons are stolen from the HOMO of the adjacent layer and holes are generated in the HOMO of the adjacent layer.

When any matrix is doped with a p-type material, the p-type may be defined as a material that receives electrons from the HOMO of the matrix material and generates holes as many as the electrons in the HOMO of the matrix, and the closer the LUMO of the p-type material is to the HOMO of the matrix, the more easily electrons are stolen and holes are generated in the matrix.

In an exemplary embodiment of the present specification, the p-type material may be any compound commonly known in the art, and may have a structure including, for example, an N-containing monocyclic ring; dibenzofuran; and/or carbazole.

In an exemplary embodiment of the present specification, the light emitting layer may include the first host and the second host at a weight ratio of 2:8 to 8:2, specifically, at a weight ratio of 4:6 to 6:4, and the first host may include the compound represented by Chemical Formula 1.

In an exemplary embodiment of the present specification, the light emitting layer includes the first host and the second host at a weight ratio of 1:1, and the first host may include the compound of Chemical Formula 1.

In an exemplary embodiment of the present specification, the second host may be a carbazole-based compound.

In an exemplary embodiment of the present specification, the second host may be a biscarbazole-based compound.

In an exemplary embodiment of the present specification, the second host may be a biscarbazole-based compound substituted with an aryl group.

In an exemplary embodiment of the present specification, the second host may be a compound represented by Chemical Formula EB-1 described below.

In an exemplary embodiment of the present specification, the organic material layer includes a light emitting layer, and the light emitting layer includes the compound represented by Chemical Formula 1 as a host, and may further include a dopant.

In an exemplary embodiment of the present specification, the light emitting layer includes the compound represented by Chemical Formula 1 as a first host, and may further include a second host and a dopant.

In an exemplary embodiment of the present specification, the dopant is a phosphorescent dopant.

In an exemplary embodiment of the present specification, the dopant may be included in an amount of 1 to 20 parts by weight with respect to 100 parts by weight of the host.

In an exemplary embodiment of the present specification, the light emitting layer includes a dopant, and the dopant may include a phosphorescent dopant.

In an exemplary embodiment of the present specification, the organic material layer includes a light emitting layer, the light emitting layer includes a host and a dopant, the host includes the compound, and the dopant may include the phosphorescent dopant.

In an exemplary embodiment of the present specification, the light emitting layer may be a blue light emitting layer.

In an exemplary embodiment of the present specification, the light emitting layer may include a host and a dopant at a weight ratio of 99:1 to 1:99. Specifically, the light emitting layer may include a host and a dopant at a weight ratio of 99:1 to 50:50, and more specially at a weight ratio of 99:1 to 86:14.

When the light emitting layer emits red light, phosphorescent materials such as bis(1-phenylisoquinoline)acetylacetonate iridium (PIQIr(acac)), bis(1-phenylquinoline)acetylacetonate iridium (PQIr(acac)), tris(1-phenylquinoline)iridium (PQIr) or octaethylporphyrin platinum (PtOEP), or fluorescent materials such as tris(8-hydroxyquinolino)aluminum (Alq₃) may be used as the light emitting dopant, however, the light emitting dopant is not limited thereto. When the light emitting layer emits green light, it is possible to use a phosphorescent material such as fac tris(2-phenylpyridine)iridium (Ir(ppy)₃), or a fluorescent material such as tris(8-hydroxyquinolino)aluminum (Alq₃), as the light emitting dopant, but the light emitting dopant is not limited thereto. When the light emitting layer emits blue light, it is possible to use a platinum complex compound, a phosphorescent material such as (4,6-F₂ppy)₂Irpic, or a fluorescent material such as spiro-DPVBi, spiro-6P, distyryl benzene (DSB), distyryl arylene (DSA), a PFO-based polymer or a PPV-based polymer as the light emitting dopant, but the light emitting dopant is not limited thereto.

In an exemplary embodiment of the present specification, the dopant may be a metal complex compound.

In an exemplary embodiment of the present specification, the dopant may be a platinum complex compound.

In an exemplary embodiment of the present specification, the dopant may be an iridium complex compound.

In an exemplary embodiment of the present specification, the dopant may be an iridium-based compound.

In an exemplary embodiment of the present specification, the dopant compound may be selected from the following structural formulae, but is not limited thereto.

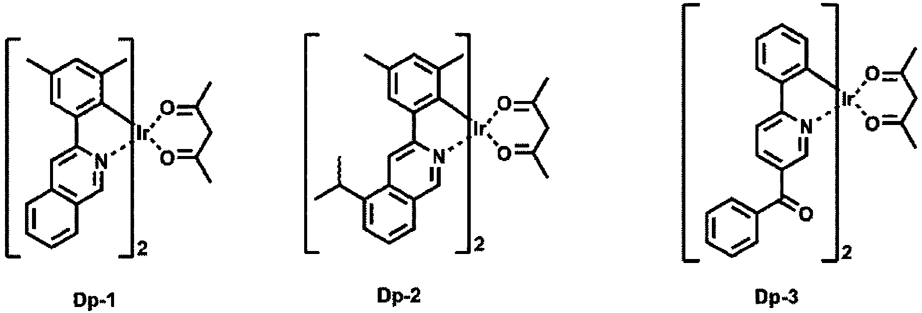

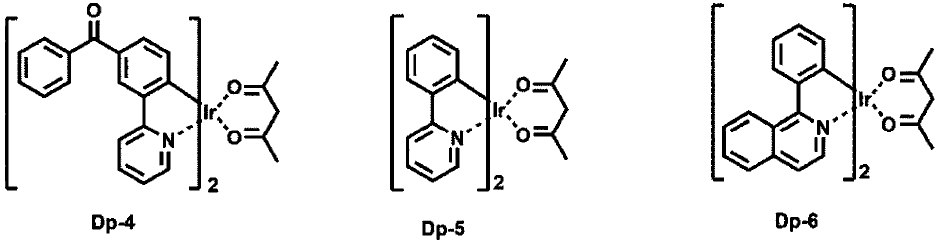

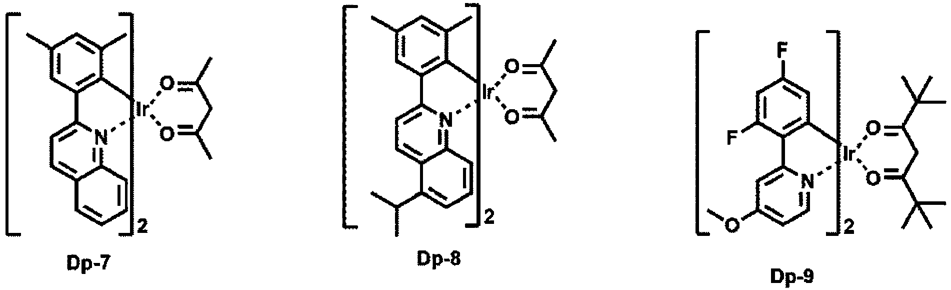

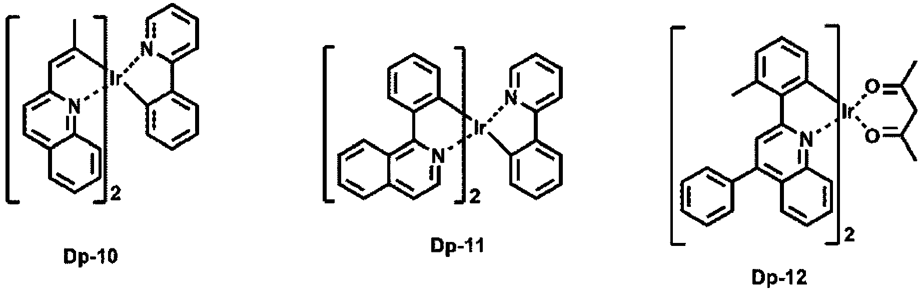

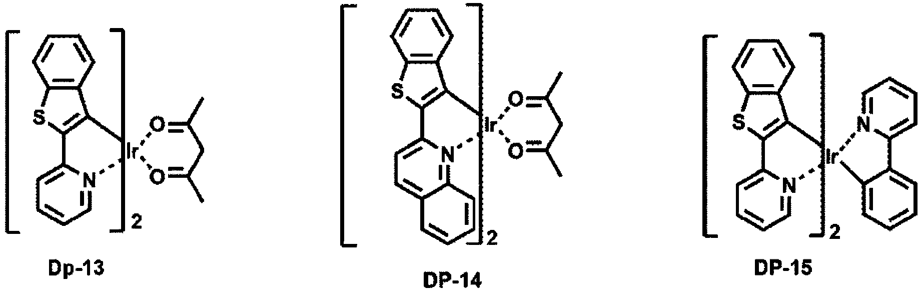

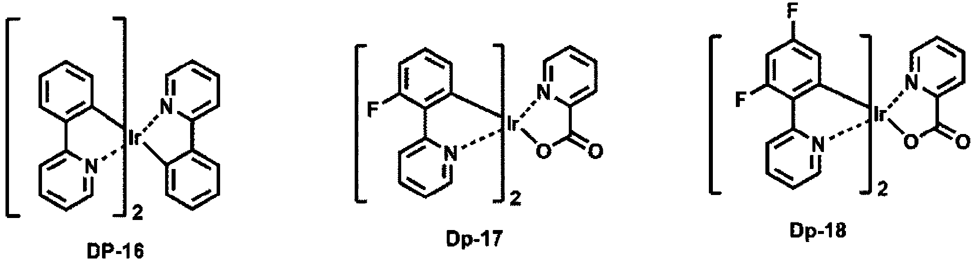

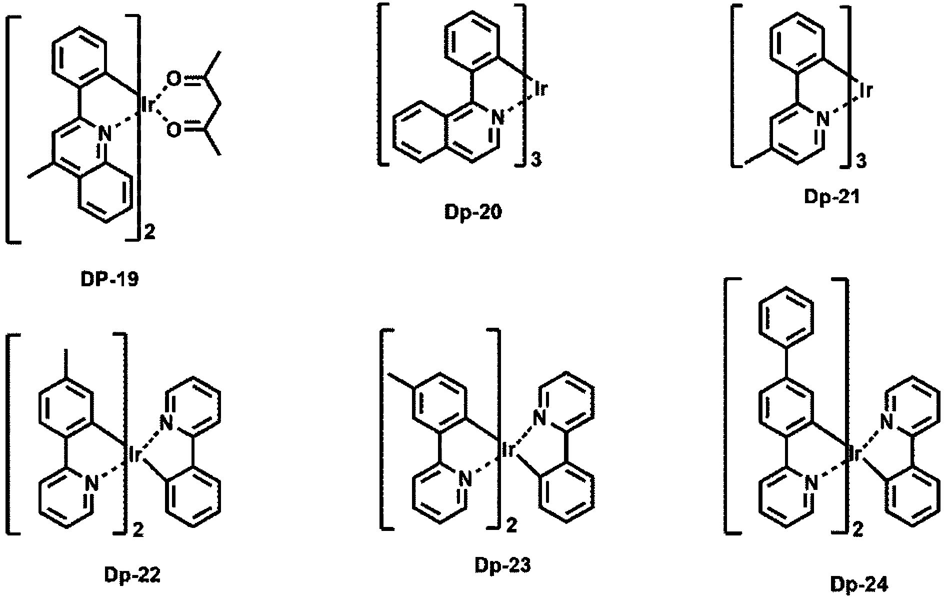

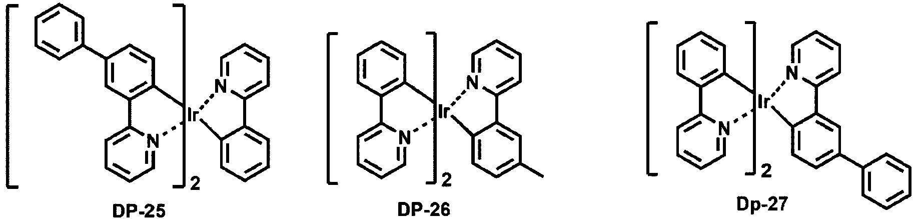

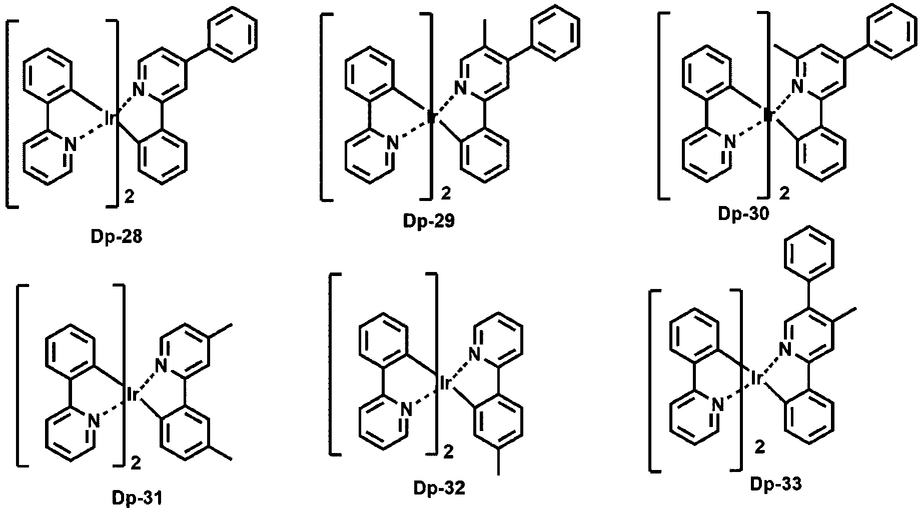

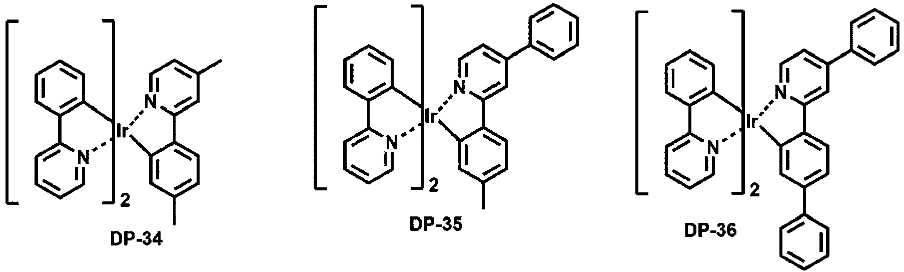

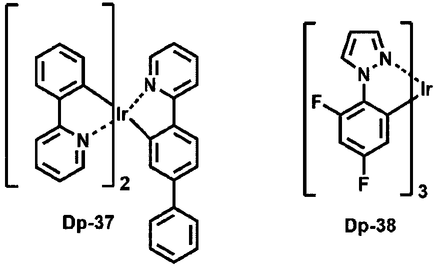

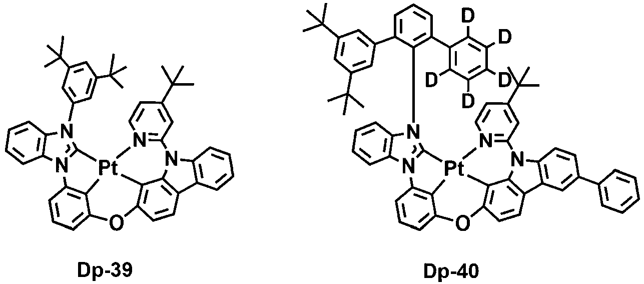

In an exemplary embodiment of the present specification, the organic material layer may include a hole blocking layer.

In an exemplary embodiment of the present specification, the organic material layer includes a hole blocking layer, and the hole blocking layer may include the compound represented by Chemical Formula 1.

In an exemplary embodiment of the present specification, the organic material layer includes a hole blocking layer, and the hole blocking layer may include the n-type compound represented by Chemical Formula 1.

In an exemplary embodiment of the present specification, the organic material layer includes a hole blocking layer, the hole blocking layer may include the n-type compound represented by Chemical Formula 1, and the n-type compound represented by Chemical Formula 1 may be a compound which is the same as or different from the n-type host included in the light emitting layer.

In an exemplary embodiment of the present specification, the organic material layer includes a light emitting layer and a hole blocking layer, and the light emitting layer and the hole blocking layer may include the compound represented by Chemical Formula 1.

In an exemplary embodiment of the present specification, the organic material layer may further include one or more layers selected from a hole injection layer, a hole transport layer, a hole injection and transport layer, an electron blocking layer, a light emitting layer, a hole blocking layer, an electron transport layer, an electron injection layer, and an electron injection and transport layer.

In an exemplary embodiment of the present specification, the organic light emitting device may include: a first electrode; a second electrode provided to face the first electrode; a light emitting layer provided between the first electrode and the second electrode; and an organic material layer having two or more layers provided between the light emitting layer and the first electrode, or between the light emitting layer and the second electrode.

In an exemplary embodiment of the present specification, as the organic material layer having two or more layers, two or more may be selected from the group consisting of a hole injection layer, a hole transport layer, a hole injection and transport layer, a light emitting layer, an electron transport layer, an electron injection layer, an electron injection and transport layer, a hole blocking layer, and an electron blocking layer.

In an exemplary embodiment of the present specification, a hole transport layer having two or more layers is included between the light emitting layer and the first electrode. The hole transport layer having two or more layers may include materials which are the same as or different from each other.

In an exemplary embodiment of the present specification, the first electrode is a positive electrode or a negative electrode.

In an exemplary embodiment of the present specification, the second electrode is a negative electrode or a positive electrode.

In an exemplary embodiment of the present specification, the organic light emitting device may be a normal type organic light emitting device in which a positive electrode, an organic material layer having one or more layers, and a negative electrode are sequentially stacked on a substrate.

In an exemplary embodiment of the present specification, the organic light emitting device may be an inverted type organic light emitting device in which a negative electrode, an organic material layer having one or more layers, and a positive electrode are sequentially stacked on a substrate.

The organic light emitting device may have, for example, the stacking structure described below, but the stacking structure is not limited thereto.
(1) First electrode/Hole transport layer/Light emitting layer/Second electrode
(2) First electrode/Hole injection layer/Hole transport layer/Light emitting layer/Second electrode
(3) First electrode/Hole injection layer/Hole buffer layer/Hole transport layer/Light emitting layer/Second electrode
(4) First electrode/Hole transport layer/Light emitting layer/Electron transport layer/Second electrode
(5) First electrode/Hole transport layer/Light emitting layer/Electron transport layer/Electron injection layer/Second electrode
(6) First electrode/Hole injection layer/Hole transport layer/Light emitting layer/Electron transport layer/Second electrode
(7) First electrode/Hole injection layer/Hole transport layer/Light emitting layer/Electron transport layer/Electron injection layer/Second electrode
(8) First electrode/Hole injection layer/Hole buffer layer/Hole transport layer/Light emitting layer/Electron transport layer/Second electrode
(9) First electrode/Hole injection layer/Hole buffer layer/Hole transport layer/Light emitting layer/Electron transport layer/Electron injection layer/Second electrode
(10) First electrode/Hole transport layer/Electron blocking layer/Light emitting layer/Electron transport layer/Second electrode
(11) First electrode/Hole transport layer/Electron blocking layer/Light emitting layer/Electron transport layer/Electron injection layer/Second electrode
(12) First electrode/Hole injection layer/Hole transport layer/Electron blocking layer/Light emitting layer/Electron transport layer/Second electrode
(13) First electrode/Hole injection layer/Hole transport layer/Electron blocking layer/Light emitting layer/Electron transport layer/Electron injection layer/Second electrode
(14) First electrode/Hole transport layer/Light emitting layer/Hole blocking layer/Electron transport layer/Second electrode
(15) First electrode/Hole transport layer/Light emitting layer/Hole blocking layer/Electron transport layer/Electron injection layer/Second electrode
(16) First electrode/Hole injection layer/Hole transport layer/Light emitting layer/Hole blocking layer/Electron transport layer/Second electrode
(17) First electrode/Hole injection layer/Hole transport layer/Light emitting layer/Hole blocking layer/Electron transport layer/Electron injection layer/Second electrode
(18) First electrode/Hole injection layer/Hole transport layer/Electron blocking layer/Light emitting layer/Hole blocking layer/Electron transport and injection layer/Second electrode

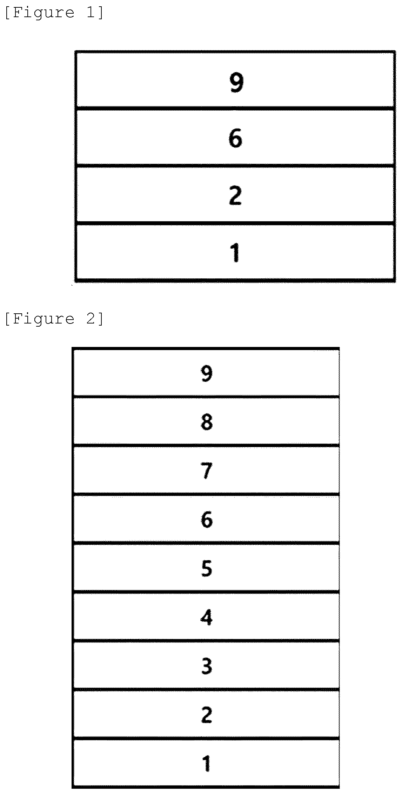

The organic light emitting device of the present specification may have structures illustrated in FIGS. 1 to 2, but is not limited thereto.

FIG. 1 illustrates an example of an organic light emitting device in which a substrate 1, a first electrode 2, a light emitting layer 6, and a second electrode 9 are sequentially stacked. In the structure described above, the compound may be included in the light emitting layer 6.

FIG. 2 illustrates an example of an organic light emitting device in which a substrate 1, a first electrode 2, a hole injection layer 3, a hole transport layer 4, an electron blocking layer 5, a light emitting layer 6, a hole blocking layer 7, an electron injection and transport layer 8, and a second electrode 9 are sequentially stacked. In the structure described above, the compound may be included in the light emitting layer 6 or the hole blocking layer 7.

In an exemplary embodiment of the present specification, the electron injection and transport layer and the light emitting layer may be provided adjacent to each other. For example, the electron injection and transport layer and the light emitting layer may be provided to be brought into physical contact with each other.

In an exemplary embodiment of the present specification, the hole blocking layer and the electron injection and transport layer may be provided adjacent to each other. For example, the hole blocking layer and the electron injection and transport layer may be brought into physical contact with each other.

In an exemplary embodiment of the present specification, the hole blocking layer and the light emitting layer may be provided adjacent to each other. For example, the hole blocking layer and the light emitting layer may be provided to be brought into physical contact with each other.

The organic light emitting device of the present specification may be manufactured by the materials and methods known in the art, except that one or more layers of the organic material layer include the compound, that is, the compound represented by Chemical Formula 1.

When the organic light emitting device includes a plurality of organic material layers, the organic material layers may be formed of the same material or different materials.

For example, the organic light emitting device according to the present specification may be manufactured by depositing a metal or a metal oxide having conductivity, or an alloy thereof on a substrate to form a first electrode, forming an organic material layer including a hole injection layer, a hole transport layer, an electron blocking layer, a light emitting layer, a hole blocking layer, and an electron injection and transport layer thereon, and then depositing a material, which may be used as a second electrode, thereon, by using a physical vapor deposition (PVD) method such as sputtering or e-beam evaporation. In addition to the method described above, an organic light emitting device may be made by sequentially depositing a second electrode material, an organic material layer, and a first electrode material on a substrate.

As the positive electrode material, materials having a high work function are usually preferred so as to facilitate the injection of holes into an organic material layer. Examples thereof include: a metal, such as vanadium, chromium, copper, zinc, and gold, or an alloy thereof; a metal oxide, such as zinc oxide, indium oxide, indium tin oxide (ITO), and indium zinc oxide (IZO); a combination of a metal and an oxide, such as ZnO:Al or SnO₂:Sb; a conductive polymer, such as poly(3-methylthiophene), poly[3,4-(ethylene-1,2-dioxy)thiophene] (PEDOT), polypyrrole, and polyaniline; and the like, but are not limited thereto.

As the negative electrode material, materials having a low work function are usually preferred so as to facilitate the injection of electrons into an organic material layer. Examples thereof include: a metal, such as magnesium, calcium, sodium, potassium, titanium, indium, yttrium, lithium, gadolinium, aluminum, silver, tin, and lead, or an alloy thereof; a multi-layer structured material, such as LiF/Al or LiO₂/Al; and the like, but are not limited thereto.

The light emitting layer may include a host material and a dopant material. When the organic light emitting device according to an exemplary embodiment of the present specification includes an additional light emitting layer other than a light emitting layer including Chemical Formula 1, examples of a host material include a fused aromatic ring derivative, a hetero ring-containing compound, and the like. Specific examples of the fused aromatic ring derivative include anthracene derivatives, pyrene derivatives, naphthalene derivatives, pentacene derivatives, phenanthrene compounds, fluoranthene compounds, and the like, and specific examples of the hetero ring-containing compound include dibenzofuran derivatives, ladder-type furan compounds, pyrimidine derivatives, and the like, but the examples are not limited thereto.

The hole injection layer is a layer which accepts holes from an electrode. It is preferred that hole injection material has an ability to transport holes, and has an effect of accepting holes from a positive electrode and an excellent hole injection effect for a light emitting layer or a light emitting material. Further, the hole injection material is preferably a material which is excellent in ability to prevent excitons produced from a light emitting layer from moving to an electron injection layer or an electron injection material. In addition, the hole injection material is preferably a material which is excellent in ability to form a thin film. In addition, the highest occupied molecular orbital (HOMO) of the hole injection material is preferably a value between the work function of the positive electrode material and the HOMO of the neighboring organic material layer. Specific examples of the hole injection material include: metal porphyrin, oligothiophene, and arylamine-based organic materials; hexanitrile hexaazatriphenylene-based organic materials; quinacridone-based organic materials; perylene-based organic materials; polythiophene-based conductive polymers such as anthraquinone and polyaniline; and the like, but are not limited thereto.

In an exemplary embodiment of the present specification, the hole injection layer may include a compound represented by the following Chemical Formula HI-1, but is not limited thereto.

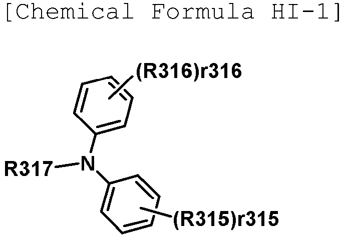

In Chemical Formula HI-1,
R315 to R317 are the same as or different from each other, and are each independently any one selected from the group consisting of hydrogen; deuterium; a substituted or unsubstituted alkyl group; a substituted or unsubstituted aryl group; a substituted or unsubstituted heteroaryl group; and a combination thereof, or are bonded to an adjacent group to form a substituted or unsubstituted ring,
r315 is an integer from 1 to 5, and when r315 is 2 or higher, two or more R315's are the same as or different from each other, and
r316 is an integer from 1 to 5, and when r316 is 2 or higher, two or more R316's are the same as or different from each other.

In an exemplary embodiment of the present specification, R317 is any one selected from the group consisting of a substituted or unsubstituted aryl group; a substituted or unsubstituted heteroaryl group; and a combination thereof.

In an exemplary embodiment of the present specification, R317 is any one selected from the group consisting of a carbazole group; a phenyl group; a biphenyl group; a triphenylene group; and a combination thereof.

In an exemplary embodiment of the present specification, R315 and R316 are the same as or different from each other, and are each independently a substituted or unsubstituted aryl group, or are bonded to an adjacent group to form an aromatic hydrocarbon ring substituted with an alkyl group.

In an exemplary embodiment of the present specification, R315 and R316 are the same as or different from each other, and are each independently a phenyl group or a biphenyl group, or are bonded to an adjacent group to form indene substituted with a methyl group.

In an exemplary embodiment of the present specification, Chemical Formula HI-1 may be represented by any one of the following compounds.

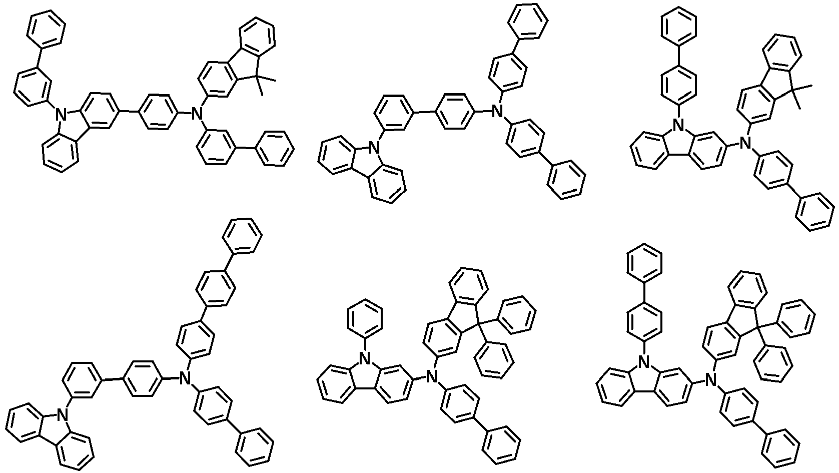

In an exemplary embodiment of the present specification, the hole injection layer may include a compound represented by the following Chemical Formula HI-2, but is not limited thereto.

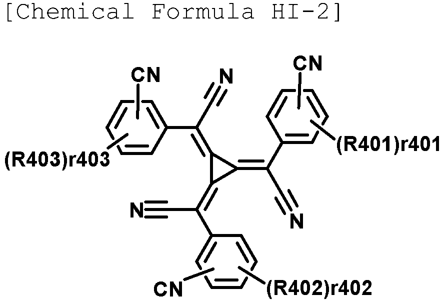

In Chemical Formula HI-2,
R401 to R403 are the same as or different from each other, and are each independently a halogen group, and
r401 to r403 are 4.

In an exemplary embodiment of the present specification, R401 to R403 are F.

In an exemplary embodiment of the present specification, Chemical Formula HI-2 may be represented by the following compound.

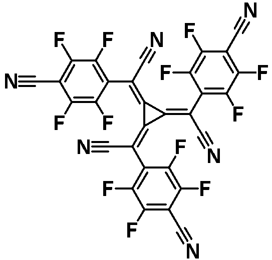

In an exemplary embodiment of the present specification, the hole injection layer may include the compound represented by Chemical Formula HI-1 and the compound represented by Chemical Formula HI-2.

In an exemplary embodiment of the present specification, the hole injection layer may include the compound represented by Chemical Formula HI-1 and the compound represented by Chemical Formula HI-2 at a weight ratio of 1:99 to 99:1, and specifically at a weight ratio of 5:95 to 95:5.

The hole transport layer is a layer which accepts holes from a hole injection layer and transports the holes to a light emitting layer. A hole transport material is preferably a material having high hole mobility which may accept holes from a positive electrode or a hole injection layer and transfer the holes to a light emitting layer. Specific examples thereof include arylamine-based organic materials, conductive polymers, block copolymers having both conjugated portions and non-conjugated portions, and the like, but are not limited thereto.

In an exemplary embodiment of the present specification, the hole transport layer may include the compound represented by Chemical Formula HI-1, but is not limited thereto.

In an exemplary embodiment of the present specification, the hole injection and transport layer is a layer that transports holes to the light emitting layer. Materials exemplified for the hole transport layer and the hole injection layer may be used, but the materials are not limited thereto.

The electron transport layer is a layer which accepts electrons from an electron injection layer and transports the electrons to a light emitting layer. An electron transport material is preferably a material having high electron mobility which may proficiently accept electrons from a negative electrode and transfer the electrons to a light emitting layer. Specific examples thereof include: Al complexes of 8-hydroxyquinoline; complexes including Alq₃; organic radical compounds; hydroxyflavone-metal complexes; and the like, but are not limited thereto. The electron transport layer may be used together with any desired cathode material as used in the art. In particular, an appropriate cathode material is a typical material which has a low work function, followed by an aluminum layer or a silver layer. Specific examples thereof include cesium, barium, calcium, ytterbium, and samarium, in each case followed by an aluminum layer or a silver layer.

The electron injection layer is a layer which accepts electrons from an electrode. It is preferred that an electron injection material is excellent in ability to transport electrons and has an effect of accepting electrons from the negative electrode and an excellent electron injection effect for a light emitting layer or a light emitting material. Further, the electron injection material is preferably a material which prevents excitons produced from a light emitting layer from moving to a hole injection layer and is excellent in ability to form a thin film. Specific examples thereof include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, metal complex compounds, nitrogen-containing 5-membered ring derivatives, and the like, but are not limited thereto.

Examples of the metal complex compounds include 8-hydroxyquinolinato lithium, bis(8-hydroxyquinolinato) zinc, bis(8-hydroxyquinolinato) copper, bis(8-hydroxyquinolinato) manganese, tris(8-hydroxyquinolinato) aluminum, tris(2-methyl-8-hydroxyquinolinato) aluminum, tris(8-hydroxyquinolinato) gallium, bis(10-hydroxybenzo[h]quinolinato) beryllium, bis(10-hydroxybenzo[h]quinolinato) zinc, bis(2-methyl-8-quinolinato) chlorogallium, bis(2-methyl-8-quinolinato) (o-cresolato) gallium, bis(2-methyl-8-quinolinato) (1-naphtholato) aluminum, bis(2-methyl-8-quinolinato) (2-naphtholato) gallium, and the like, but are not limited thereto.

In an exemplary embodiment of the present specification, the electron injection and transport layer is a layer that transports electrons to the light emitting layer. Materials exemplified for the electron transport layer and the electron injection layer may be used, but the materials are not limited thereto.

In an exemplary embodiment of the present specification, the electron injection and transport layer may include a compound represented by the following Chemical Formula ET-1, but is not limited thereto.

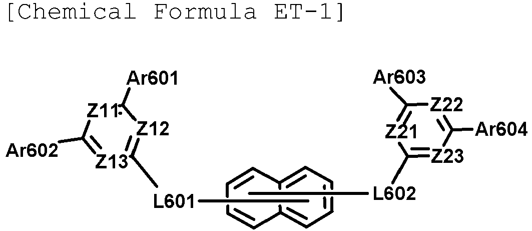

In Chemical Formula ET-1,
at least one of Z11 to Z13 is N, and the others are CH,
at least one of Z21 to Z23 is N, and the others are CH,
L601 and L602 are the same as or different from each other, and are each independently a direct bond; a substituted or unsubstituted arylene group; or a substituted or unsubstituted heteroarylene group, and
Ar601 to Ar604 are the same as or different from each other, and are each independently a substituted or unsubstituted aryl group; or a substituted or unsubstituted heteroaryl group.

In an exemplary embodiment of the present specification, Z11 to Z13 are all N.

In an exemplary embodiment of the present specification, Z21 to Z23 are all N.

In an exemplary embodiment of the present specification, L601 and L602 are the same as or different from each other, and are each independently a substituted or unsubstituted monocyclic or polycyclic arylene group having 6 to 20 carbon atoms. In an exemplary embodiment of the present specification, L601 and L602 are the same as or different from each other, and are each independently a substituted or unsubstituted monocyclic or polycyclic arylene group having 6 to 12 carbon atoms.

In an exemplary embodiment of the present specification, L601 and L602 are a substituted or unsubstituted phenylene group.

In an exemplary embodiment of the present specification, L601 and L602 are a phenylene group.

In an exemplary embodiment of the present specification, Ar601 to Ar604 are the same as or different from each other, and are each independently a substituted or unsubstituted monocyclic or polycyclic aryl group having 6 to 20 carbon atoms.

In an exemplary embodiment of the present specification, Ar601 to Ar604 are the same as or different from each other, and are each independently a substituted or unsubstituted monocyclic or polycyclic aryl group having 6 to 12 carbon atoms.

In an exemplary embodiment of the present specification, Ar601 to Ar604 are a substituted or unsubstituted phenyl group.

In an exemplary embodiment of the present specification, Ar601 to Ar604 are a phenyl group.

In an exemplary embodiment of the present specification, Chemical Formula ET-1 may be represented by the following compound.

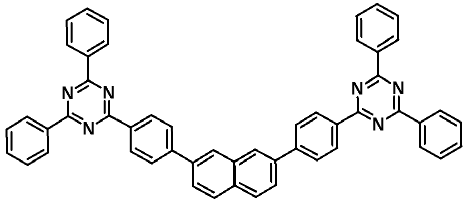

In an exemplary embodiment of the present specification, the electron injection and transport layer may further include a metal complex compound. The metal complex compound is as described above.

The electron blocking layer is a layer which may improve the service life and efficiency of a device by preventing electrons injected from an electron injection layer from passing through a light emitting layer and entering a hole injection layer. As a material having high triplet energy, any known material can be used without limitation, and the materials exemplified in the description of the hole injection layer may be used, but the material is not limited thereto. The electron blocking layer may be formed between a light emitting layer and a hole transport layer, between a light emitting layer and a hole injection layer, or between a light emitting layer and a layer which simultaneously injects and transports holes.

In an exemplary embodiment of the present specification, the electron blocking layer may include a compound represented by the following Chemical Formula EB-1, but is not limited thereto.

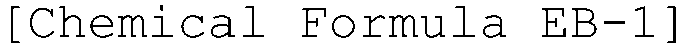

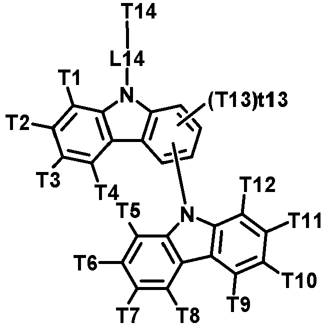

In Chemical Formula EB-1,
T1 to T14 are the same as or different from each other, and are each independently hydrogen; deuterium; a substituted or unsubstituted silyl group; a substituted or unsubstituted aryl group; or a substituted or unsubstituted heteroaryl group,
L14 is a direct bond; or a substituted or unsubstituted arylene group, and
t13 is an integer from 1 to 3, and when t13 is 2 or higher, two or more T13's are the same as or different from each other.

In an exemplary embodiment of the present specification, T1 to T14 are the same as or different from each other, and are each independently hydrogen; deuterium; a substituted or unsubstituted arylsilyl group having 6 to 30 carbon atoms; or a substituted or unsubstituted monocyclic or polycyclic aryl group having 6 to 30 carbon atoms.

In an exemplary embodiment of the present specification, T1 to T14 are the same as or different from each other, and are each independently hydrogen; deuterium; a substituted or unsubstituted arylsilyl group having 6 to 20 carbon atoms; or a substituted or unsubstituted monocyclic or polycyclic aryl group having 6 to 20 carbon atoms.

In an exemplary embodiment of the present specification, T1 to T14 are the same as or different from each other, and are each independently hydrogen; deuterium; a substituted or unsubstituted triphenylsilyl group; a substituted or unsubstituted phenyl group; a substituted or unsubstituted biphenyl group; or a substituted or unsubstituted naphthyl group.

In an exemplary embodiment of the present specification, T1 to T14 are the same as or different from each other, and are each independently hydrogen; deuterium; a triphenylsilyl group; a phenyl group; or a biphenyl group.

In an exemplary embodiment of the present specification, T1 to T13 are the same as or different from each other, and are each independently hydrogen; or deuterium.

In an exemplary embodiment of the present specification, T14 is an arylsilyl group having 6 to 20 carbon atoms; or a monocyclic or polycyclic aryl group having 6 to 20 carbon atoms.

In an exemplary embodiment of the present specification, T14 is a triphenylsilyl group; a phenyl group; a biphenyl group; or a naphthyl group.

In an exemplary embodiment of the present specification, T14 is a triphenylsilyl group; or a phenyl group.

In an exemplary embodiment of the present specification, L14 is a direct bond; or a substituted or unsubstituted arylene group having 6 to 20 carbon atoms.

In an exemplary embodiment of the present specification, L14 is a direct bond; or a substituted or unsubstituted arylene group having 6 to 12 carbon atoms.

In an exemplary embodiment of the present specification, L14 is a direct bond; or a substituted or unsubstituted phenylene group; or a substituted or unsubstituted naphthylene group.

In an exemplary embodiment of the present specification, L14 is a direct bond; or a phenylene group.

In an exemplary embodiment of the present specification, Chemical Formula EB-1 may be represented by the following compound.

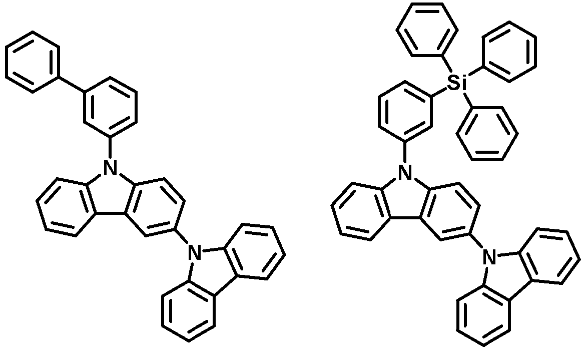

A hole blocking layer may be provided between the electron transport layer and the light emitting layer, and the hole blocking layer is a layer which blocks holes from reaching a cathode, and may be generally formed under the same conditions as those of the electron injection layer.

In an exemplary embodiment of the present specification, the hole blocking layer may include a compound represented by the following Chemical Formula HB-1 or the compound represented by Chemical Formula 1, but is not limited thereto.

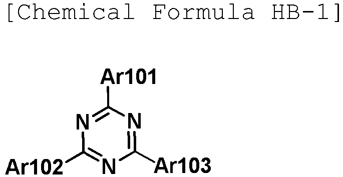

In Chemical Formula HB-1,
Ar101, Ar102, and Ar103 are the same as or different from each other, and are each independently hydrogen; deuterium; a substituted or unsubstituted silyl group; a substituted or unsubstituted aryl group; or a substituted or unsubstituted heteroaryl group.

In an exemplary embodiment of the present specification, Ar101, Ar102, and Ar103 are the same as or different from each other, and are each independently hydrogen; deuterium; a substituted or unsubstituted arylsilyl group having 6 to 30 carbon atoms; a substituted or unsubstituted aryl group having 6 to 30 carbon atoms; or a substituted or unsubstituted heteroaryl group having 2 to 30 carbon atoms.

In an exemplary embodiment of the present specification, Ar101, Ar102, and Ar103 are the same as or different from each other, and are each independently hydrogen; deuterium; a substituted or unsubstituted arylsilyl group having 6 to 20 carbon atoms; a substituted or unsubstituted aryl group having 6 to 20 carbon atoms; or a substituted or unsubstituted heteroaryl group having 2 to 20 carbon atoms.

In an exemplary embodiment of the present specification, Ar101, Ar102, and Ar103 are the same as or different from each other, and are each independently hydrogen; deuterium; a substituted or unsubstituted triphenylsilyl group; a substituted or unsubstituted phenyl group; a substituted or unsubstituted biphenyl group; or a substituted or unsubstituted carbazole group.

In an exemplary embodiment of the present specification, Ar101, Ar102, and Ar103 are the same as or different from each other, and are each independently hydrogen; deuterium; a triphenylsilyl group; or a carbazole group.

In an exemplary embodiment of the present specification, Chemical Formula HB-1 may be represented by the following compound.

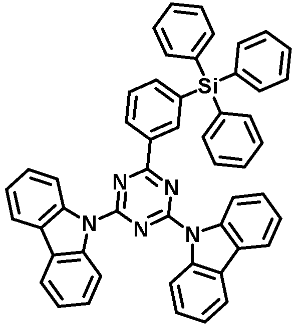

When the organic light emitting device according to an exemplary embodiment of the present specification includes an additional hole blocking layer other than the hole blocking layer including the compound represented by Chemical Formula HB-1 or the compound represented by Chemical Formula 1, specifically, an oxadiazole derivative or a triazole derivative, a phenanthroline derivative, an aluminum complex, and the like are used, but the compound is not limited thereto.

The organic light emitting device according to the present specification may be a top-emission type, a bottom-emission type or a dual-emission type depending on the materials used.

The organic light emitting device according to the present specification may be included and used in various electronic devices. For example, the electronic device may be a display panel, a touch panel, a solar module, a lighting device, and the like, and is not limited thereto.

### [Mode for Invention]

Hereinafter, the present specification will be described in detail with reference to Examples, Comparative Examples, and the like for specifically describing the present specification. However, the Examples and the Comparative Examples according to the present specification may be modified in various forms, and it is not interpreted that the scope of the present specification is limited to the Examples and the Comparative Examples described below in detail. The Examples and the Comparative Examples of the present specification are provided to more completely explain the present specification to a person with ordinary skill in the art.

### <Preparation Examples>

### Preparation Example of Compound 1 (F-1)

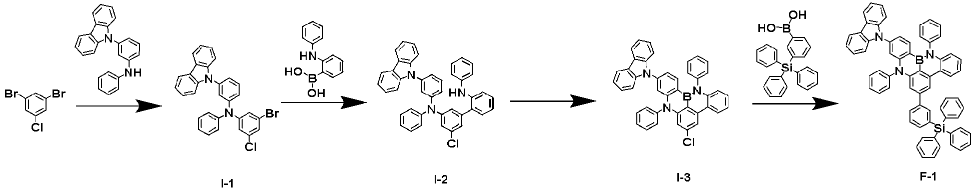

### Synthesis of I-1

After 40 g of 1,3-dibromo-5-chlorobenzene, 49.5 g of 3-(9H-carbazol-9-yl)-N-phenylaniline, 0.75 g of [bis(tri-tert-butylphosphine)palladium(0)], 28.4 g of sodium-tert-butoxide, and 800 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 58 g of I-1. (Yield 75%, Mass [M+]=524)

### Synthesis of I-2

After 25 g of I-1, 7.0 g of (2-(phenylamino)phenyl)boronic acid, 13.2 g of K₂CO₃, 0.24 g of [bis(tri-tert-butylphosphine)palladium(0)], 500 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 18 g of I-2. (Yield 62%, Mass [M+]=613)

### Synthesis of I-3

After 15 g of I-2, 20 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 8.2 g of I-3. (Yield 54%, Mass [M+]=621)

### Synthesis of F-1

After 8 g of I-3, 4.9 g of (3-(triphenylsilyl)phenyl)boronic acid, 3.6 g of K₂CO₃, 0.07 g of [bis(tri-tert-butylphosphine)palladium(0)], 160 mL of tetrahydrofuran, and 80 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 7.2 g of F-1. (Yield 61%, Mass [M+]=921)

### Preparation Example of Compound 2 (F-2)

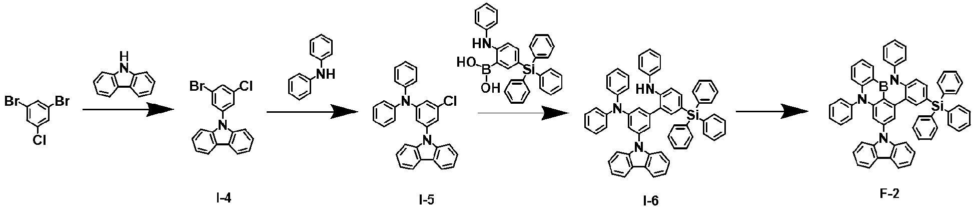

### Synthesis of I-4

After 40 g of 1,3-dibromo-5-chlorobenzene, 24.7 g of 9H-carbazole, 0.75 g of [bis(tri-tert-butylphosphine)palladium(0)], 28.4 g of sodium-tert-butoxide, and 800 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 38 g of I-4. (Yield 72%, Mass [M+]=357)

### Synthesis of I-5

After 25 g of I-4, 11.9 g of diphenylamine, 0.35 g of [bis(tri-tert-butylphosphine)palladium(0)], 16.9 g of sodium-tert-butoxide, and 800 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 22 g of I-5. (Yield 71%, Mass [M+]=445)

### Synthesis of I-6

After 20 g of I-5, 21.2 g of (2-(phenylamino)-5-(triphenylsilyl)phenyl)boronic acid, 12.4 g of K₂CO₃, 0.23 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 23 g of I-6. (Yield 61%, Mass [M+]=837)

### Synthesis of F-2

After 14 g of I-6, 11.2 g of boron triiodide, and 280 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.6 g of F-2. (Yield 47%, Mass [M+]=845)

### Preparation Example of Compound 3 (F-3)

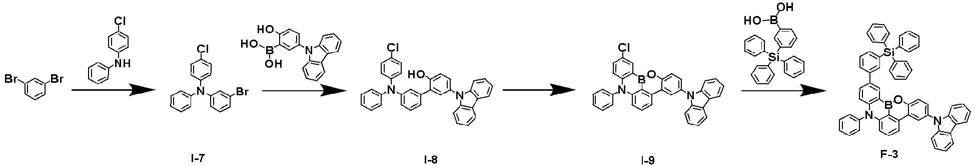

### Synthesis of I-7

After 40 g of 1,3-dibromobenzene, 34.5 g of 4-chloro-N-phenylaniline, 0.86 g of [bis(tri-tert-butylphosphine)palladium(0)], 32.6 g of sodium-tert-butoxide, and 800 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 43 g of I-7. (Yield 71%, Mass [M+]=359)

### Synthesis of I-8

After 20 g of I-7, 21.1 g of (5-(9H-carbazol-9-yl)-2-hydroxyphenyl)boronic acid, 19.3 g of K₂CO₃, 0.35 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 26 g of I-8. (Yield 69%, Mass [M+]=538)

### Synthesis of I-9

After 15 g of I-8, 18.6 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.7 g of I-9. (Yield 44%, Mass [M+]=546)

### Synthesis of F-3

After 6 g of I-9, 3.4 g of (3-(triphenylsilyl)phenyl)boronic acid, 3.1 g of K₂CO₃, 0.06 g of [bis(tri-tert-butylphosphine)palladium(0)], 120 mL of tetrahydrofuran, and 60 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 6 g of F-3. (Yield 64%, Mass [M+]=846)

### Preparation Example of Compound 4 (F-4)

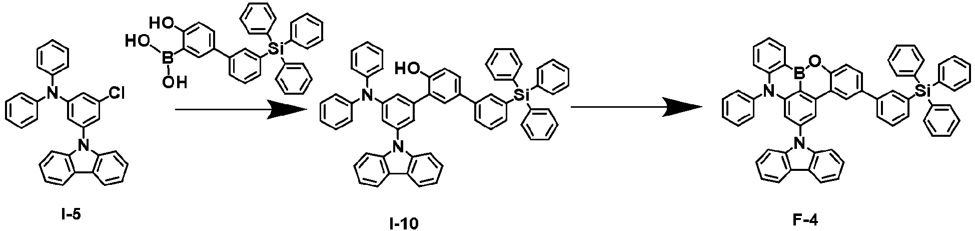

### Synthesis of I-10

After 15 g of I-5, 15.9 g of (4-hydroxy-3'-(triphenylsilyl)-[1,1'-biphenyl]-3-yl)boronic acid, 9.3 g of K₂CO₃, 0.17 g of [bis(tri-tert-butylphosphine)palladium(0)], 300 mL of tetrahydrofuran, and 150 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 19 g of I-10. (Yield 67%, Mass [M+]=838)

### Synthesis of F-4

After 15 g of I-10, 11.9 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.1 g of F-4. (Yield 40%, Mass [M+]=846)

### Preparation Example of Compound 5 (F-5)

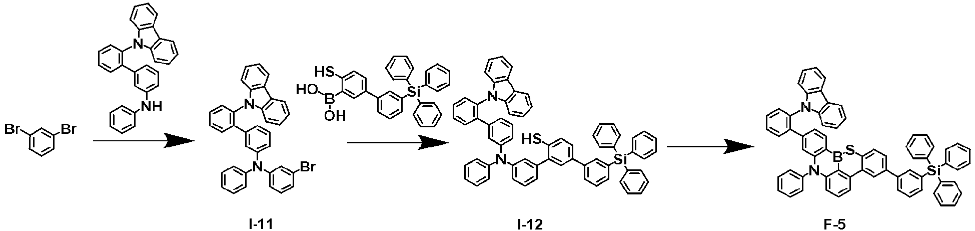

### Synthesis of I-11

After 40 g of 1,3-dibromobenzene, 69.6 g of 2'-(9H-carbazol-9-yl)-N-phenyl-[1,1'-biphenyl]-3-amine, 0.87 g of [bis(tri-tert-butylphosphine)palladium(0)], 32.6 g of sodium-tert-butoxide, and 800 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 66 g of I-11. (Yield 69%, Mass [M+]=566)

### Synthesis of I-12

After 20 g of I-11, 17.3 g of (4-mercapto-3'-(triphenylsilyl)-[1,1'-biphenyl]-3-yl)boronic acid, 9.8 g of K₂CO₃, 0.18 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 25 g of I-12. (Yield 76%, Mass [M+]=930)

### Synthesis of F-5

After 15 g of I-12, 10.7 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 5.6 g of F-5. (Yield 37%, Mass [M+]=938)

### Preparation Example of Compound 6 (F-6)

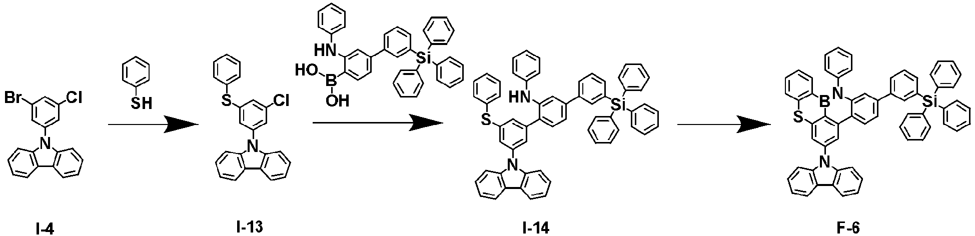

### Synthesis of I-13

After 30 g of I-4, 9.3 g of benzenethiol, 0.43 g of [bis(tri-tert-butylphosphine)palladium(0)], 16.2 g of sodium-tert-butoxide, and 800 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 24 g of I-13. (Yield 74%, Mass [M+]=387)

### Synthesis of I-14

After 20 g of I-13, 28.4 g of ((3-(phenylamino)-3'-(triphenylsilyl)-[1,1'-biphenyl]-4-yl)boronic acid, 14.3 g of K₂CO₃, 0.26 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 28 g of I-14. (Yield 63%, Mass [M+]=854)

### Synthesis of F-6

After 15 g of I-14, 11.7 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 5.8 g of F-6. (Yield 38%, Mass [M+]=862)

### Preparation Example of Compound 7 (F-7)

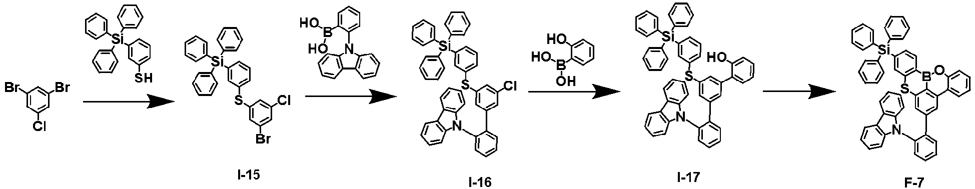

### Synthesis of I-15

After 30 g of 1,3-dibromo-5-chlorobenzene, 40.9 g of 3-(triphenylsilyl)benzenethiol, 0.57 g of [bis(tri-tert-butylphosphine)palladium(0)], 21.3 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 43 g of I-15. (Yield 69%, Mass [M+]=559)

### Synthesis of I-16

After 20 g of I-15, 10.3 g of (2-(9H-carbazol-9-yl)phenyl)boronic acid, 9.9 g of K₂CO₃, 0.18 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 17 g of I-16. (Yield 66%, Mass [M+]=721)

### Synthesis of I-17

After 15 g of I-16, 2.9 g of (2-hydroxyphenyl)boronic acid, 5.8 g of K₂CO₃, 0.1 g of [bis(tri-tert-butylphosphine)palladium(0)], 300 mL of tetrahydrofuran, and 150 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 12 g of I-17. (Yield 74%, Mass [M+]=779)

### Synthesis of F-7

After 12 g of I-17, 12.8 g of boron triiodide, and 240 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.2 g of F-7. (Yield 41%, Mass [M+]=787)

### Preparation Example of Compound 8 (F-8)

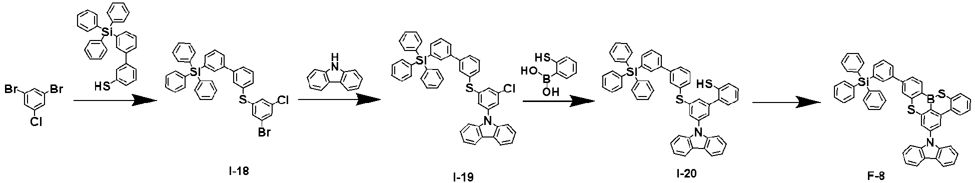

### Synthesis of I-18

After 30 g of 1,3-dibromo-5-chlorobenzene, 49.3 g of 3'-(triphenylsilyl)-[1,1'-biphenyl]-3-thiol, 0.57 g of [bis(tri-tert-butylphosphine)palladium(0)], 21.3 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 46 g of I-18. (Yield 65%, Mass [M+]=635)

### Synthesis of I-19

After 25 g of I-18, 6.6 g of 9H-carbazole, 0.2 g of [bis(tri-tert-butylphosphine)palladium(0)], 9.5 g of sodium-tert-butoxide, and 500 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 21 g of I-19. (Yield 74%, Mass [M+]=721)

### Synthesis of I-20

After 20 g of I-19, 8 g of (2-mercaptophenyl)boronic acid, 7.7 g of K₂CO₃, 0.15 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 16 g of I-20. (Yield 73%, Mass [M+]=795)

### Synthesis of F-8

After 15 g of I-20, 12.6 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.4 g of F-8. (Yield 42%, Mass [M+]=803)

### Preparation Example of Compound 9 (F-9)

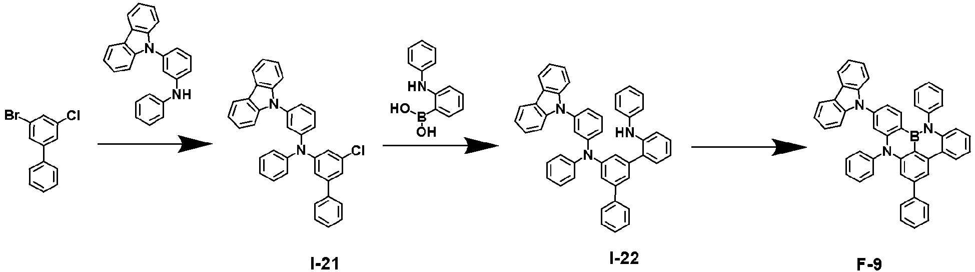

### Synthesis of I-21

After 30 g of 3-bromo-5-chloro-1,1'-biphenyl, 37.5 g of 3-(9H-carbazol-9-yl)-N-phenylaniline, 0.57 g of [bis(tri-tert-butylphosphine)palladium(0)], 21.6 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 45 g of I-21. (Yield 77%, Mass [M+]=522)

### Synthesis of I-22

After 20 g of I-21, 8.2 g of (2-(phenylamino)phenyl)boronic acid, 10.7 g of K₂CO₃, 0.20 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 17 g of I-22. (Yield 68%, Mass [M+]=655)

### Synthesis of F-9

After 15 g of I-22, 15.3 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.3 g of F-9. (Yield 42%, Mass [M+]=663)

### Preparation Example of Compound 10 (F-10)

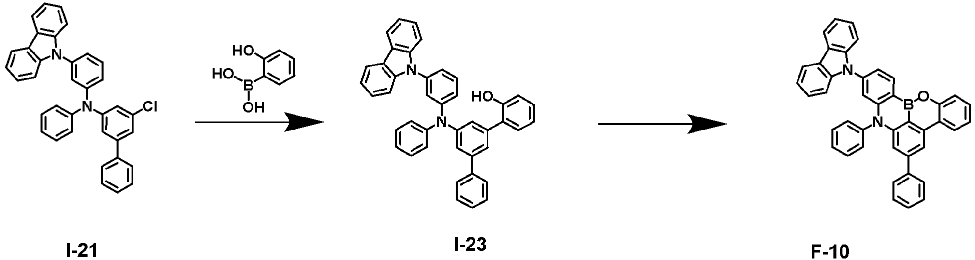

### Synthesis of I-23

After 20 g of I-21, 5.3 g of (2-hydroxyphenyl)boronic acid, 10.7 g of K₂CO₃, 0.20 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 18 g of I-23. (Yield 81%, Mass [M+]=580)

### Synthesis of F-10

After 15 g of I-23, 17.3 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.1 g of F-10. (Yield 40%, Mass [M+]=588)

### Preparation Example of Compound 11 (F-11)

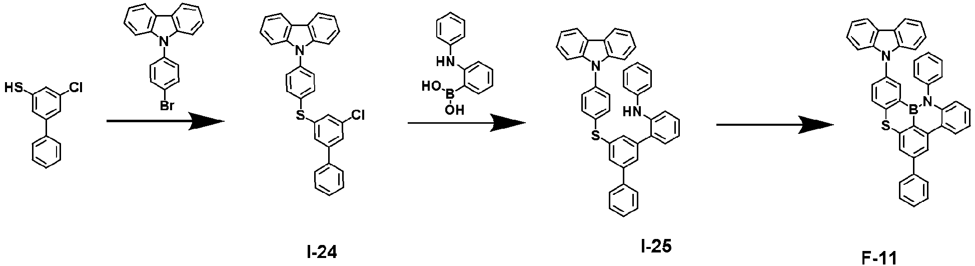

### Synthesis of I-24

After 30 g of 5-chloro-[1,1'-biphenyl]-3-thiol, 44 g of 9-(4-bromophenyl)-9H-carbazole, 0.7 g of [bis(tri-tert-butylphosphine)palladium(0)], 26.2 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 44 g of I-24. (Yield 70%, Mass [M+]=463)

### Synthesis of I-25

After 20 g of I-24, 9.2 g of (2-(phenylamino)phenyl)boronic acid, 12 g of K₂CO₃, 0.22 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 18 g of I-25. (Yield 70%, Mass [M+]=596)

### Synthesis of F-11

After 15 g of I-25, 17 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.2 g of F-11. (Yield 40%, Mass [M+]=604)

### Preparation Example of Compound 12 (F-12)

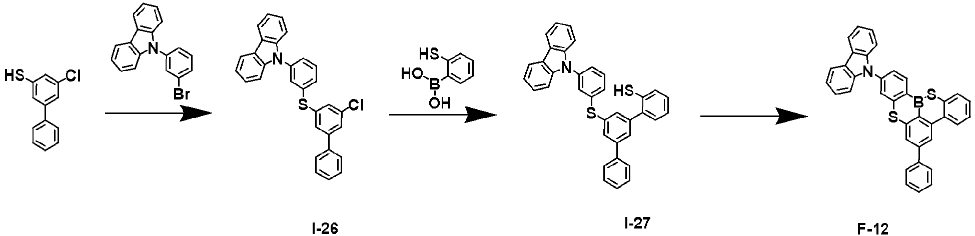

### Synthesis of I-26

After 30 g of 5-chloro-[1,1'-biphenyl]-3-thiol, 44 g of 9-(3-bromophenyl)-9H-carbazole, 0.7 g of [bis(tri-tert-butylphosphine)palladium(0)], 26.2 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 43 g of I-26. (Yield 68%, Mass [M+]=463)

### Synthesis of I-27

After 20 g of I-26, 6.7 g of (2-mercaptophenyl)boronic acid, 12 g of K₂CO₃, 0.22 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 16 g of I-27. (Yield 69%, Mass [M+]=537)

### Synthesis of F-12

After 15 g of I-27, 18.6 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.2 g of F-12. (Yield 41%, Mass [M+]=545)

### Preparation Example of Compound 13 (F-13)

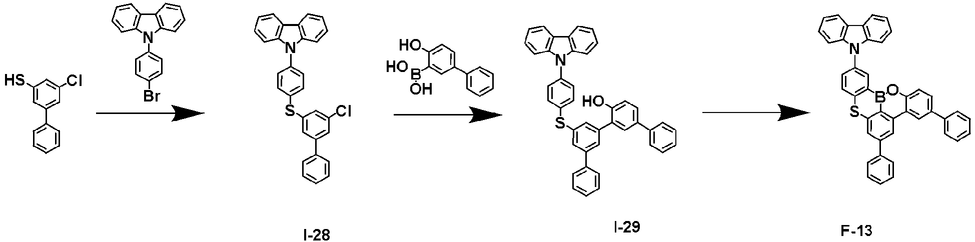

### Synthesis of I-28

After 30 g of 5-chloro-[1,1'-biphenyl]-3-thiol, 44 g of 9-(4-bromophenyl)-9H-carbazole, 0.7 g of [bis(tri-tert-butylphosphine)palladium(0)], 26.2 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 45 g of I-28. (Yield 72%, Mass [M+]=463)

### Synthesis of I-29

After 20 g of I-28, 9.3 g of (4-hydroxy-[1,1'-biphenyl]-3-yl)boronic acid, 12 g of K₂CO₃, 0.22 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 16 g of I-29. (Yield 62%, Mass [M+]=597)

### Synthesis of F-13

After 15 g of I-29, 16.7 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.4 g of F-13. (Yield 42%, Mass [M+]=605)

### Preparation Example of Compound 14 (F-14)

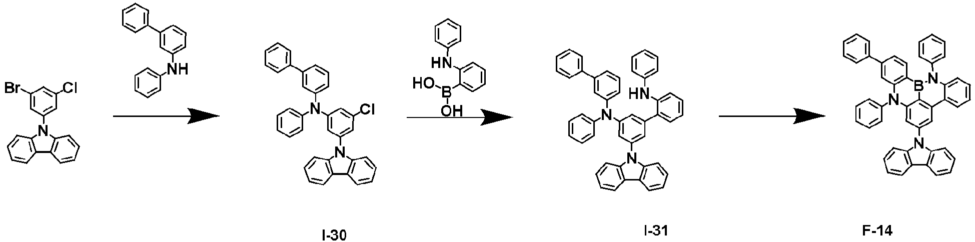

### Synthesis of I-30

After 30 g of 9-(3-bromo-5-chlorophenyl)-9H-carbazole, 20.6 g of N-phenyl-[1,1'-biphenyl]-3-amine, 0.43 g of [bis(tri-tert-butylphosphine)palladium(0)], 16.2 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 34 g of I-30. (Yield 78%, Mass [M+]=522)

### Synthesis of I-31

After 20 g of I-30, 8.2 g of (2-(phenylamino)phenyl)boronic acid, 11 g of K₂CO₃, 0.2 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 17 g of I-31. (Yield 68%, Mass [M+]=655)

### Synthesis of F-14

After 15 g of I-31, 15.3 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.1 g of F-14. (Yield 40%, Mass [M+]=663)

### Preparation Example of Compound 15 (F-15)

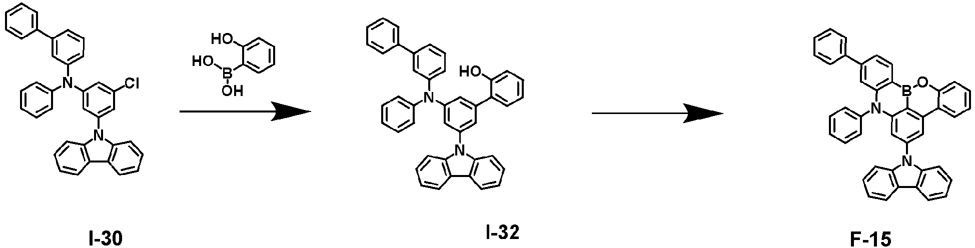

### Synthesis of I-32

After 20 g of I-30, 5.3 g of (2-hydroxyphenyl)boronic acid, 11 g of K₂CO₃, 0.2 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 16 g of I-32. (Yield 72%, Mass [M+]=580)

### Synthesis of F-15

After 15 g of I-32, 17.3 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.5 g of F-15. (Yield 43%, Mass [M+]=588)

### Preparation Example of Compound 16 (F-16)

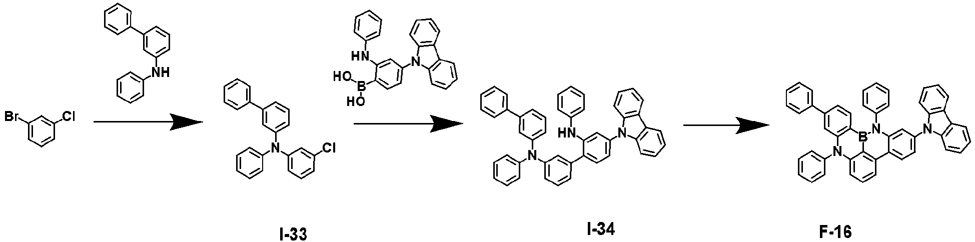

### Synthesis of I-33

After 30 g of 1-bromo-3-chlorobenzene, 38.5 g of N-phenyl-[1,1'-biphenyl]-3-amine, 0.8 g of [bis(tri-tert-butylphosphine)palladium(0)], 30.1 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 43 g of I-33. (Yield 77%, Mass [M+]=357)

### Synthesis of I-34

After 20 g of I-33, 21.3 g of (4-(9H-carbazol-9-yl)-2-(phenylamino)phenyl)boronic acid, 15.5 g of K₂CO₃, 0.3 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 27 g of I-34. (Yield 73%, Mass [M+]=655)

### Synthesis of F-16

After 15 g of I-34, 15.3 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.4 g of F-16. (Yield 42%, Mass [M+]=663)

### Preparation Example of Compound 17 (F-17)

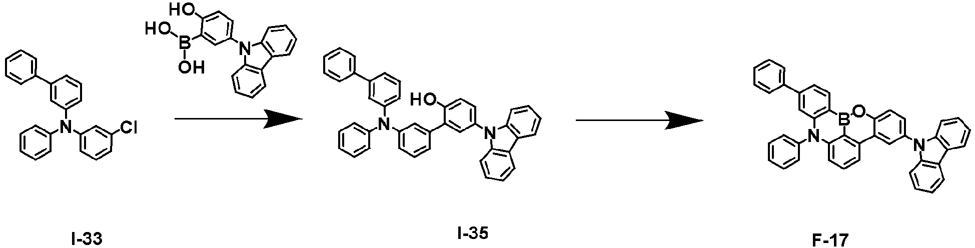

### Synthesis of I-35

After 20 g of I-33, 17 g of (5-(9H-carbazol-9-yl)-2-hydroxyphenyl)boronic acid, 15.5 g of K₂CO₃, 0.29 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 23 g of I-35. (Yield 71%, Mass [M+]=580)

### Synthesis of F-17

After 15 g of I-35, 17.3 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.2 g of F-17. (Yield 41%, Mass [M+]=588)

### Preparation Example of Compound 18 (F-18)

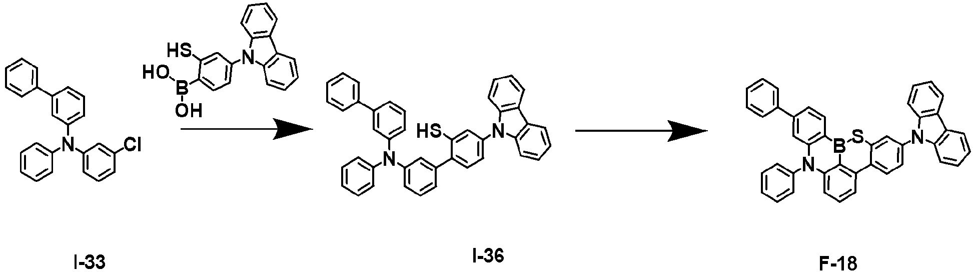

### Synthesis of I-36

After 20 g of I-33, 18 g of (4-(9H-carbazol-9-yl)-2-mercaptophenyl)boronic acid, 15.5 g of K₂CO₃, 0.29 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 23 g of I-36. (Yield 69%, Mass [M+]=596)

### Synthesis of F-18

After 15 g of I-36, 16.8 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.4 g of F-18. (Yield 41%, Mass [M+]=604)

### Preparation Example of Compound 19 (F-19)

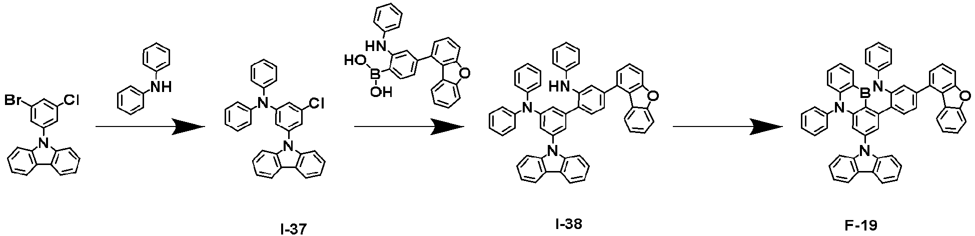

### Synthesis of I-37

After 20 g of 9-(3-bromo-5-chlorophenyl)-9H-carbazole, 9.5 g of diphenylamine, 0.29 g of [bis(tri-tert-butylphosphine)palladium(0)], 10.8 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 20 g of I-37. (Yield 80%, Mass [M+]=446)

### Synthesis of I-38

After 20 g of I-37, 17 g of (4-(dibenzo[b,d]furan-1-yl)-2-(phenylamino)phenyl)boronic acid, 12.4 g of K₂CO₃, 0.23 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 24 g of I-38. (Yield 72%, Mass [M+]=745)

### Synthesis of F-19

After 15 g of I-38, 13.4 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.3 g of F-19. (Yield 42%, Mass [M+]=753)

### Preparation Example of Compound 20 (F-20)

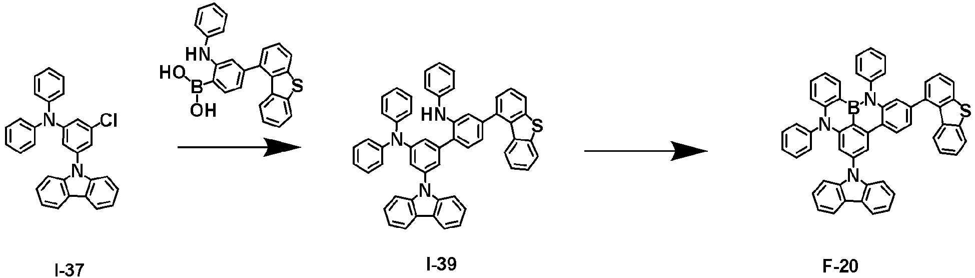

### Synthesis of I-39

After 20 g of I-37, 17.8 g of (4-(dibenzo[b,d]thiophen-1-yl)-2-(phenylamino)phenyl)boronic acid, 12.4 g of K₂CO₃, 0.23 g of [bis (tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 26 g of I-39. (Yield 76%, Mass [M+]=761)

### Synthesis of F-20

After 15 g of I-39, 13.2 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.6 g of F-20. (Yield 44%, Mass [M+]=769)

### Preparation Example of Compound 21 (F-21)

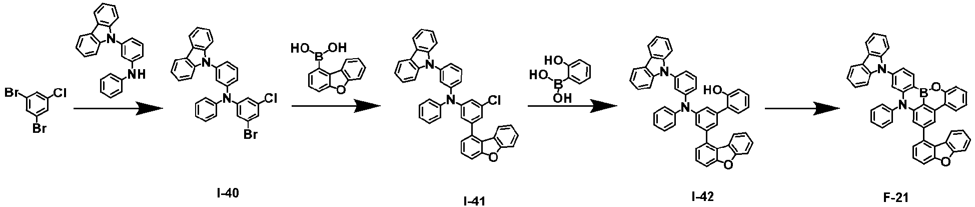

### Synthesis of I-40

After 40 g of 1,3-dibromo-5-chlorobenzene, 49.5 g of 3-(9H-carbazol-9-yl)-N-phenylaniline, 0.75 g of [bis(tri-tert-butylphosphine)palladium(0)], 28.4 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 56 g of I-40. (Yield 72%, Mass [M+]=525)

### Synthesis of I-41

After 30 g of I-40, 12.2 g of dibenzo[b,d]furan-1-ylboronic acid, 15.8 g of K₂CO₃, 0.3 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 26 g of I-41. (Yield 74%, Mass [M+]=612)

### Synthesis of I-42

After 25 g of I-41, 5.6 g of (2-hydroxyphenyl)boronic acid, 11.3 g of K₂CO₃, 0.2 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 21 g of I-42. (Yield 77%, Mass [M+]=670)

### Synthesis of F-21

After 15 g of I-42, 14.9 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.5 g of F-21. (Yield 43%, Mass [M+]=678)

### Preparation Example of Compound 22 (F-22)

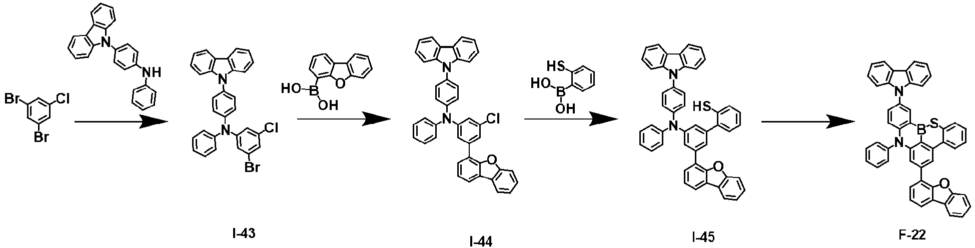

### Synthesis of I-43

After 40 g of 1,3-dibromo-5-chlorobenzene, 49.5 g of 4-(9H-carbazol-9-yl)-N-phenylaniline, 0.75 g of [bis(tri-tert-butylphosphine)palladium(0)], 28.4 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 55 g of I-43. (Yield 71%, Mass [M+]=525)

### Synthesis of I-44

After 30 g of I-43, 12.2 g of dibenzo[b,d]furan-4-ylboronic acid, 15.8 g of K₂CO₃, 0.3 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 28 g of I-44. (Yield 80%, Mass [M+]=612)

### Synthesis of I-45

After 25 g of I-44, 6.3 g of (2-mercaptophenyl)boronic acid, 11.3 g of K₂CO₃, 0.2 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 22 g of I-45. (Yield 79%, Mass [M+]=686)

### Synthesis of F-22

After 15 g of I-45, 14.6 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.2 g of F-22. (Yield 41%, Mass [M+]=694)

### Preparation Example of Compound 23 (F-23)

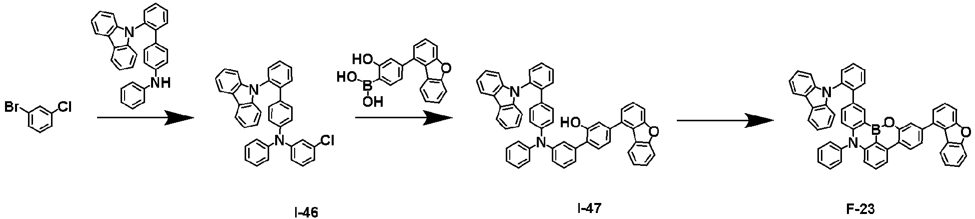

### Synthesis of I-46

After 40 g of 1-bromo-3-chlorobenzene, 85.8 g of 2'-(9H-carbazol-9-yl)-N-phenyl-[1,1'-biphenyl]-4-amine, 1.06 g of [bis (tri-tert-butylphosphine)palladium(0)], 40.2 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 58 g of I-46. (Yield 53%, Mass [M+]=522)

### Synthesis of I-47

After 30 g of I-46, 17.5 g of (4-(dibenzo[b,d]furan-1-yl)-2-hydroxyphenyl)boronic acid, 15.9 g of K₂CO₃, 0.3 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 33 g of I-47. (Yield 75%, Mass [M+]=746)

### Synthesis of F-23

After 15 g of I-47, 13.4 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.0 g of F-23. (Yield 40%, Mass [M+]=754)

### Preparation Example of Compound 24 (F-24)

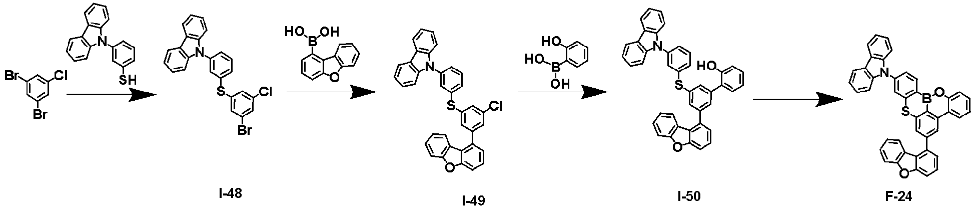

### Synthesis of I-48

After 40 g of 1,3-dibromo-5-chlorobenzene, 40.7 g of 3-(9H-carbazol-9-yl)benzenethiol, 0.75 g of [bis(tri-tert-butylphosphine)palladium(0)], 28.4 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 49 g of I-48. (Yield 71%, Mass [M+]=466)

### Synthesis of I-49

After 30 g of I-48, 13.7 g of dibenzo[b,d]furan-1-ylboronic acid, 17.8 g of K₂CO₃, 0.33 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 27 g of I-49. (Yield 76%, Mass [M+]=553)

### Synthesis of I-50

After 25 g of I-49, 6.3 g of (2-hydroxyphenyl)boronic acid, 12.5 g of K₂CO₃, 0.2 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 21 g of I-50. (Yield 76%, Mass [M+]=611)

### Synthesis of F-24

After 15 g of I-50, 16.4 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.6 g of F-24. (Yield 43%, Mass [M+]=619)

### Preparation Example of Compound 25 (F-25)

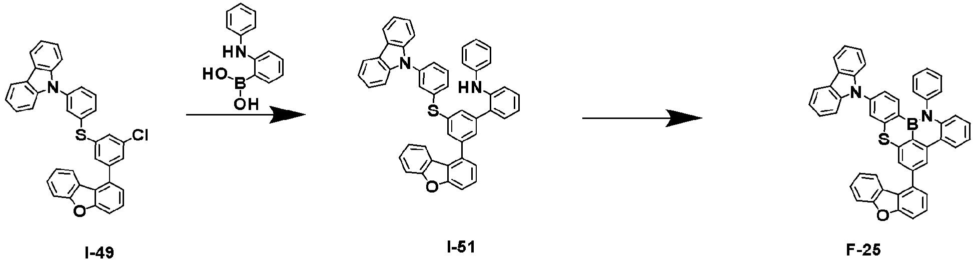

### Synthesis of I-51

After 25 g of I-49, 9.7 g of (2-(phenylamino)phenyl)boronic acid, 12.5 g of K₂CO₃, 0.2 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 23 g of I-51. (Yield 74%, Mass [M+]=686)

### Synthesis of F-25

After 15 g of I-51, 14.6 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.5 g of F-25. (Yield 43%, Mass [M+]=694)

### Preparation Example of Compound 26 (F-26)

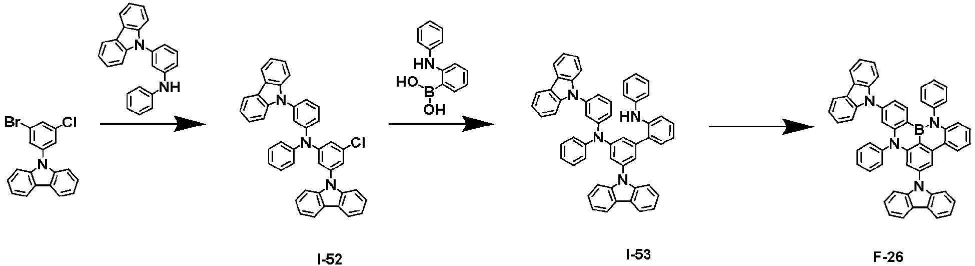

### Synthesis of I-52

After 40 g of 9-(3-bromo-5-chlorophenyl)-9H-carbazole, 30.9 g of 3-(9H-carbazol-9-yl)-N-phenylaniline, 0.58 g of [bis(tri-tert-butylphosphine)palladium(0)], 21.6 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 48 g of I-52. (Yield 70%, Mass [M+]=611)

### Synthesis of I-53

After 30 g of I-52, 10.5 g of (2-(phenylamino)phenyl)boronic acid, 13.6 g of K₂CO₃, 0.33 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 28 g of I-53. (Yield 77%, Mass [M+]=744)

### Synthesis of F-26

After 15 g of I-53, 13.4 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.6 g of F-26. (Yield 44%, Mass [M+]=752)

### Preparation Example of Compound 27 (F-27)

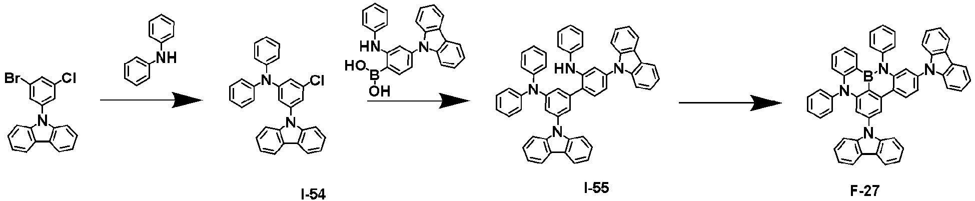

### Synthesis of I-54

After 40 g of 9-(3-bromo-5-chlorophenyl)-9H-carbazole, 19 g of diphenylamine, 0.6 g of [bis(tri-tert-butylphosphine)palladium(0)], 21.6 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 37 g of I-54. (Yield 74%, Mass [M+]=446)

### Synthesis of I-55

After 30 g of I-54, 25.5 g of (4-(9H-carbazol-9-yl)-2-(phenylamino)phenyl)boronic acid, 18.6 g of K₂CO₃, 0.33 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 35 g of I-55. (Yield 70%, Mass [M+]=744)

### Synthesis of F-27

After 15 g of I-55, 13.4 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.2 g of F-27. (Yield 41%, Mass [M+]=752)

### Preparation Example of Compound 28 (F-28)

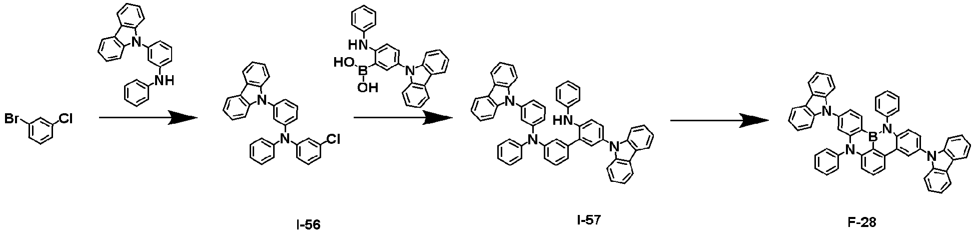

### Synthesis of I-56

After 40 g of 1-bromo-3-chlorobenzene, 70 g of 3-(9H-carbazol-9-yl)-N-phenylaniline, 1.1 g of [bis(tri-tert-butylphosphine)palladium(0)], 50.2 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 66 g of I-56. (Yield 71%, Mass [M+]=446)

### Synthesis of I-57

After 30 g of I-56, 25.5 g of (5-(9H-carbazol-9-yl)-2-(phenylamino)phenyl)boronic acid, 18.6 g of K₂CO₃, 0.33 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 36 g of I-57. (Yield 72%, Mass [M+]=744)

### Synthesis of F-28

After 15 g of I-57, 13.4 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.7 g of F-28. (Yield 43%, Mass [M+]=752)

### Preparation Example of Compound 29 (F-29)

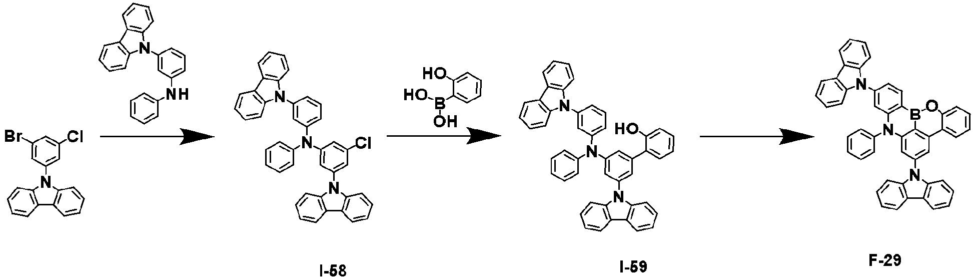

### Synthesis of I-58

After 40 g of 9-(3-bromo-5-chlorophenyl)-9H-carbazole, 37.5 g of 3-(9H-carbazol-9-yl)-N-phenylaniline, 0.6 g of [bis(tri-tert-butylphosphine)palladium(0)], 22 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 49 g of I-58. (Yield 72%, Mass [M+]=611)

### Synthesis of I-59

After 30 g of I-58, 6.8 g of (2-hydroxyphenyl)boronic acid, 13.6 g of K₂CO₃, 0.25 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 25 g of I-59. (Yield 76%, Mass [M+]=669)

### Synthesis of F-29

After 15 g of I-59, 15 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.6 g of F-29. (Yield 43%, Mass [M+]=677)

### Preparation Example of Compound 30 (F-30)

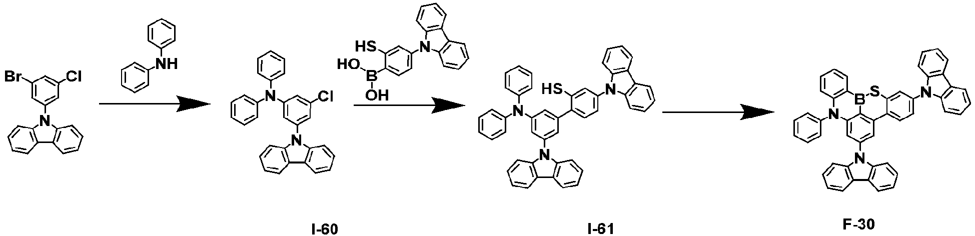

### Synthesis of I-60

After 40 g of 9-(3-bromo-5-chlorophenyl)-9H-carbazole, 19 g of diphenylamine, 0.6 g of [bis(tri-tert-butylphosphine)palladium(0)], 22 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 38 g of I-60. (Yield 76%, Mass [M+]=446)

### Synthesis of I-61

After 30 g of I-60, 21.5 g of (4-(9H-carbazol-9-yl)-2-mercaptophenyl)boronic acid, 18.6 g of K₂CO₃, 0.35 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 33 g of I-61. (Yield 72%, Mass [M+]=685)

### Synthesis of F-30

After 15 g of I-61, 15 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.8 g of F-30. (Yield 45%, Mass [M+]=693)

### Preparation Example of Compound 31 (F-31)

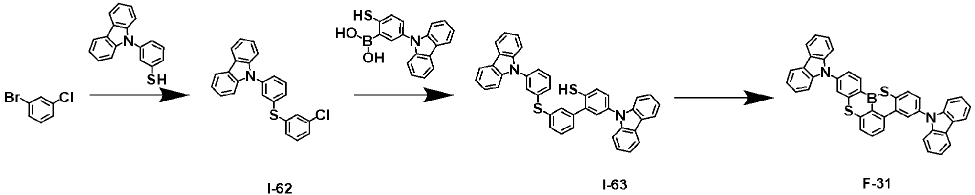

### Synthesis of I-62

After 40 g of 1-bromo-3-chlorobenzene, 57.5 g of 3-(9H-carbazol-9-yl)benzenethiol, 1.1 g of [bis(tri-tert-butylphosphine)palladium(0)], 40 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 58 g of I-62. (Yield 72%, Mass [M+]=387)

### Synthesis of I-63

After 30 g of I-62, 24.8 g of (5-(9H-carbazol-9-yl)-2-mercaptophenyl)boronic acid, 21.5 g of K₂CO₃, 0.4 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 34 g of I-63. (Yield 70%, Mass [M+]=626)

### Synthesis of F-31

After 15 g of I-63, 16 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.5 g of F-31. (Yield 43%, Mass [M+]=634)

### Preparation Example of Compound 32 (F-32)

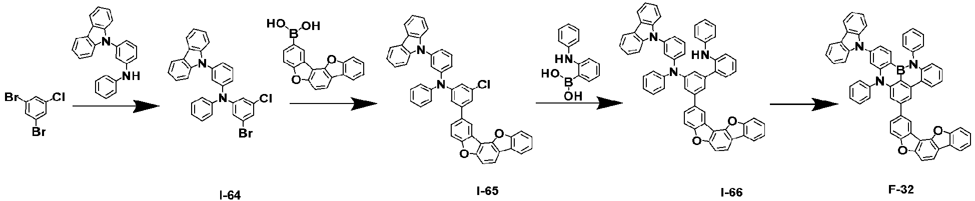

### Synthesis of I-64

After 40 g of 1,3-dibromo-5-chlorobenzene, 49.5 g of 3-(9H-carbazol-9-yl)-N-phenylaniline, 0.8 g of [bis(tri-tert-butylphosphine)palladium(0)], 28 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 57 g of I-64. (Yield 72%, Mass [M+]=534)

### Synthesis of I-65

After 30 g of I-64, 17 g of 2-tribenzodibenzofuran boronic acid, 15.6 g of K₂CO₃, 0.3 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 28 g of I-65. (Yield 71%, Mass [M+]=702)

### Synthesis of I-66

After 25 g of I-65, 7.6 g of (2-(phenylamino)phenyl)boronic acid, 9.9 g of K₂CO₃, 0.2 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 22 g of I-66. (Yield 74%, Mass [M+]=835)

### Synthesis of F-32

After 15 g of I-66, 12 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.6 g of F-32. (Yield 44%, Mass [M+]=843)

### Preparation Example of Compound 33 (F-33)

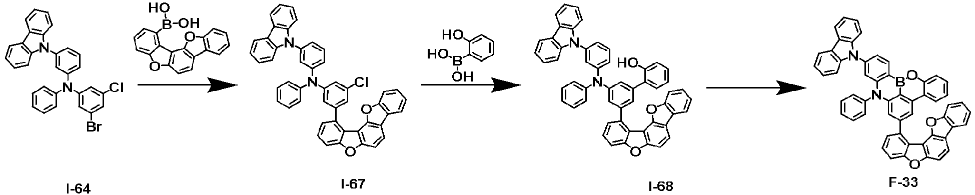

### Synthesis of I-67

After 30 g of I-64, 17 g of 1-tribenzodibenzofuran boronic acid, 15.6 g of K₂CO₃, 0.3 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 29 g of I-67. (Yield 73%, Mass [M+]=702)

### Synthesis of I-68

After 25 g of I-67, 4.92 g of (2-hydroxyphenyl)boronic acid, 9.9 g of K₂CO₃, 0.2 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 21 g of I-68. (Yield 78%, Mass [M+]=760)

### Synthesis of F-33

After 15 g of I-68, 13.2 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.7 g of F-33. (Yield 44%, Mass [M+]=768)

### Preparation Example of Compound 34 (F-34)

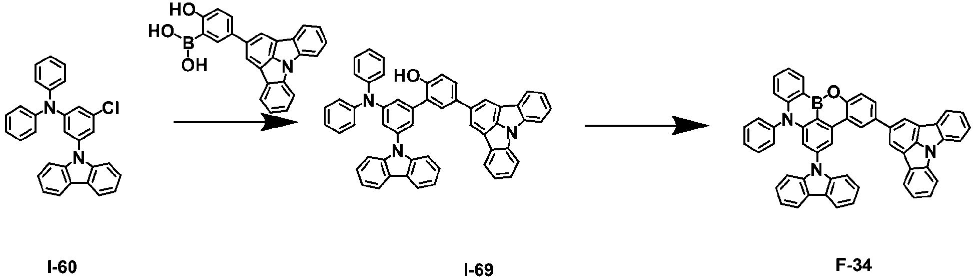

### Synthesis of I-69

After 25 g of I-60, 21.2 g of (2-hydroxy-5-(indolo[3,2,1-jk]carbazol-2-yl)phenyl)boronic acid, 15.5 g of K₂CO₃, 0.3 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 26 g of I-69. (Yield 62%, Mass [M+]=743)

### Synthesis of F-34

After 15 g of I-69, 13.5 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.1 g of F-34. (Yield 40%, Mass [M+]=751)

### Preparation Example of Compound 35 (F-35)

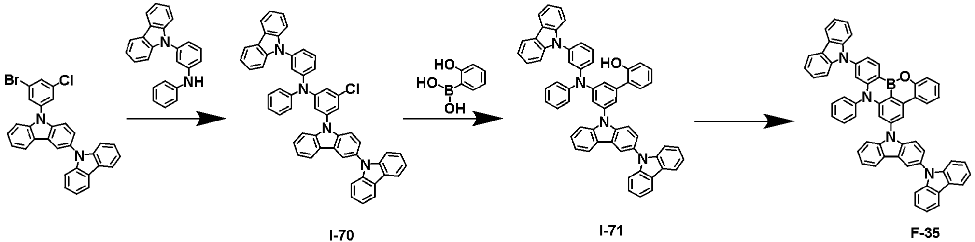

### Synthesis of I-70

After 30 g of 9-(3-bromo-5-chlorophenyl)-9H-3,9'-bicarbazole, 37.2 g of 3-(9H-carbazol-9-yl)-N-phenylaniline, 0.6 g of [bis(tri-tert-butylphosphine)palladium(0)], 22 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 58 g of I-70. (Yield 67%, Mass [M+]=776)

### Synthesis of I-71

After 30 g of I-70, 5.3 g of (2-hydroxyphenyl)boronic acid, 10.7 g of K₂CO₃, 0.2 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 22 g of I-71. (Yield 68%, Mass [M+]=834)

### Synthesis of F-35

After 15 g of I-71, 12 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6 g of F-35. (Yield 40%, Mass [M+]=842)

### Preparation Example of Compound 36 (F-36)

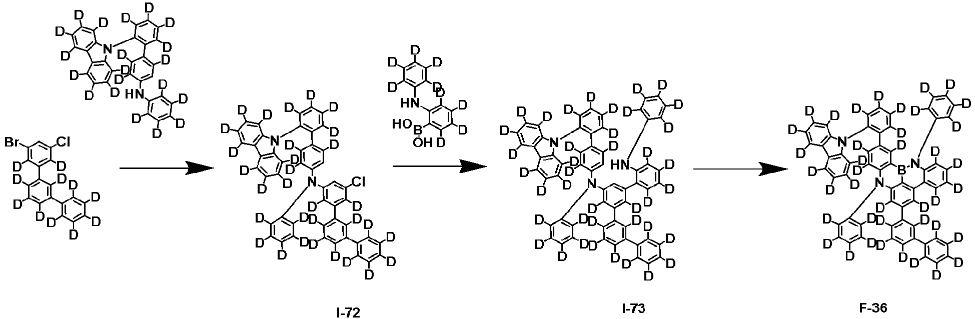

### Synthesis of I-72

After 30 g of 3-bromo-5-chloro-1,1':3',1"-terphenyl-2,2',2",3",4',4",5',5",6,6',6"-d11, 36.4 g of 2'-(9H-carbazol-9-yl-d8)-N-(phenyl-d5)-[1,1'-biphenyl]-2,3,3',4',5',6,6'-d7-4-amine, 0.43 g of [bis(tri-tert-butylphosphine)palladium(0)], 16.3 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 43 g of I-72. (Yield 72%, Mass [M+]=705)

### Synthesis of I-73

After 30 g of I-72, 9.4 g of (2-((phenyl-d5)amino)phenyl-3,4,5,6-d4)boronic acid, 11.7 g of K₂CO₃, 0.2 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 23 g of I-73. (Yield 64%, Mass [M+]=847)

### Synthesis of F-36

After 15 g of I-73, 12 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.1 g of F-36. (Yield 40%, Mass [M+]=855)

### Preparation Example of Compound 37 (F-37)

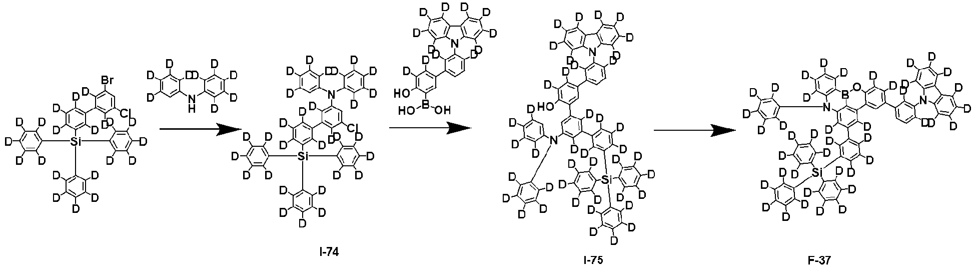

### Synthesis of I-74

After 30 g of (3'-bromo-5'-chloro-[1,1'-biphenyl]-3-yl-2,2',4,5,6,6'-d6)tris(phenyl-d5)silane, 9.8 g of N-(phenyl-2,3,4,5-d4)benzene-d5-amine, 0.3 g of [bis(tri-tert-butylphosphine)palladium(0)], 10.5 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 27 g of I-74. (Yield 76%, Mass [M+]=645)

### Synthesis of I-75

After 25 g of I-74, 15.2 g of (3'-(9H-carbazol-9-yl-d8)-4-hydroxy-[1,1'-biphenyl]-3-yl-2',4',5,6-d4)boronic acid, 11 g of K₂CO₃, 0.2 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 24 g of I-75. (Yield 65%, Mass [M+]=956)

### Synthesis of F-37

After 15 g of I-75, 10.5 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.6 g of F-37. (Yield 44%, Mass [M+]=964)

### Preparation Example of Compound 38 (F-38)

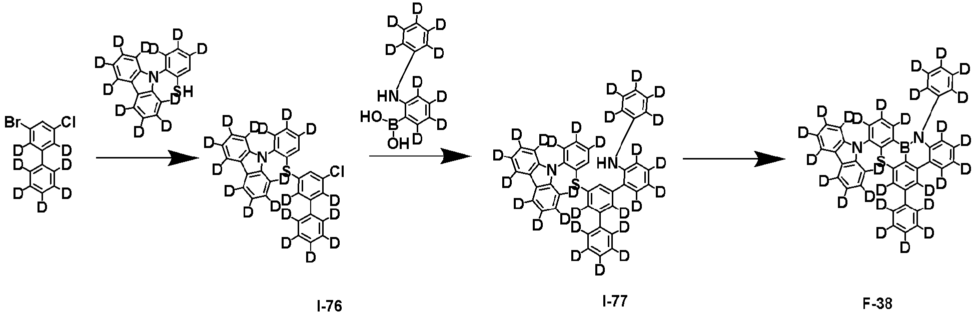

### Synthesis of I-76

After 30 g of 3-bromo-5-chloro-1,1'-biphenyl-2,2',3',4',5',6,6'-d7, 31.3 g of 2-(9H-carbazol-9-yl-d8)benzene-3,4,5-d3-thiol, 0.6 g of [bis(tri-tert-butylphosphine)palladium(0)], 21 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 33 g of I-76. (Yield 63%, Mass [M+]=481)

### Synthesis of I-77

After 25 g of I-76, 11.6 g of ((2-((phenyl-d5)amino)phenyl-3,4,5,6-d4)boronic acid, 14.4 g of K₂CO₃, 0.3 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 23 g of I-77. (Yield 71%, Mass [M+]=623)

### Synthesis of F-38

After 15 g of I-77, 16 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.6 g of F-38. (Yield 43%, Mass [M+]=631)

### Preparation Example of Compound 39 (F-39)

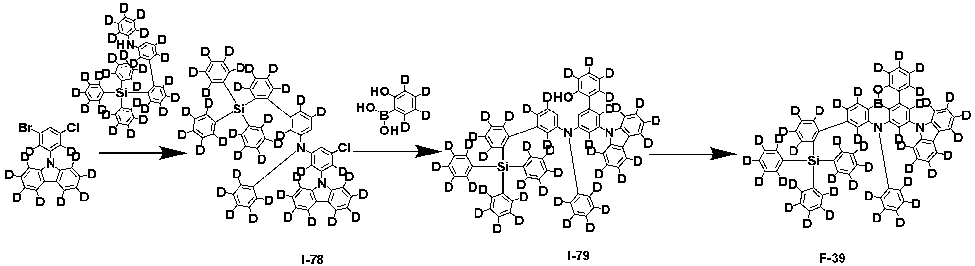

### Synthesis of I-78

After 30 g of 9-(3-bromo-5-chlorophenyl-2,6-d2)-9H-carbazole-1,2,3,4,5,6,7,8-d8, 44.1 g of N-(phenyl-d5)-2'-(tris(phenyl-d5)silyl)-[1,1'-biphenyl]-2,3',4',5,5',6,6'-d7-3-amine, 0.5 g of [bis(tri-tert-butylphosphine)palladium(0)], 16 g of sodium-tert-butoxide, and 600 mL of toluene were put into a flask under a nitrogen atmosphere, the resulting mixture was heated under reflux and stirred for 8 hours. After the reaction was terminated, the reaction solution was separated, and then treated with MgSO₄ (anhydrous), and filtered. The filtered solution was recrystallized to obtain 45 g of I-78. (Yield 67%, Mass [M+]=818)

### Synthesis of I-79

After 25 g of I-78, 4.3 g of (2-hydroxyphenyl-3,4,5,6-d4)boronic acid, 8.5 g of K₂CO₃, 0.2 g of [bis(tri-tert-butylphosphine)palladium(0)], 400 mL of tetrahydrofuran, and 250 mL of water were put into a flask, the resulting mixture was heated under reflux and stirred for 8 hours. After the reaction was terminated, all the solvent was removed, and then the reaction solution was separated by dissolving the resulting product in toluene, followed by treatment with MgSO₄ (anhydrous) and filtration. The filtered solution was recrystallized to obtain 19 g of I-79. (Yield 71%, Mass [M+]=880)

### Synthesis of F-39

After 15 g of I-79, 11.4 g of boron triiodide, and 300 mL of dichlorobenzene were put into a flask under a nitrogen atmosphere, the resulting mixture was heated under reflux and stirred for 8 hours. After the reaction was terminated, solutions were separated by adding the resulting product to water, and then treated with MgSO₄ (anhydrous) and filtered. The filtered solution was removed and then recrystallized to obtain 6.1 g of F-39. (Yield 40%, Mass [M+]=888)

### <Examples and Comparative Examples>

### Example 1

A glass substrate thinly coated with indium tin oxide (ITO) to have a thickness of 800 Å was put into distilled water in which a detergent was dissolved, and ultrasonically washed. In this case, a product manufactured by the Fischer Co., was used as the detergent, and distilled water twice filtered using a filter manufactured by Millipore Co., was used as the distilled water. After the ITO was washed for 30 minutes, ultrasonic washing was repeated twice by using distilled water for 10 minutes. After the washing using distilled water was completed, ultrasonic washing was conducted by using isopropyl alcohol, acetone, and methanol solvents, and the resulting product was dried and then transported to a plasma washing machine. Furthermore, the substrate was cleaned by using oxygen plasma for 5 minutes, and then was transported to a vacuum deposition machine.

Compounds of the following Compound HT1 and the following Compound HI1 were thermally vacuum deposited to have a thickness of 100 Å at a ratio of 95 : 5 (molar ratio) on a transparent ITO electrode, which is the positive electrode thus prepared, thereby forming a hole injection layer. A compound represented by the following Chemical Formula HT1 (300 Å) was vacuum deposited on the hole injection layer, thereby forming a hole transport layer. Subsequently, a compound of BH (p-type) was vacuum deposited to have a film thickness of 50 Å on the hole transport layer, thereby forming an electron blocking layer. Subsequently, on the electron blocking layer, a compound in which the following Chemical Formula BH (p-type) and Compound 1 (n-type) synthesized in Preparation Example 1 were mixed at 1:1 used as a host of the light emitting layer, and a compound represented by the following Chemical Formula BD as a dopant of the light emitting layer were vacuum deposited at a weight ratio of 86:14, thereby forming a light emitting layer. Compound 1 (n-type) synthesized in Preparation Example 1 was vacuum deposited to have a film thickness of 50 Å on the light emitting layer, thereby forming a hole blocking layer. Subsequently, a compound represented by the following Chemical Formula ET1 and a compound represented by the following Chemical Formula LiQ were vacuum deposited at a weight ratio of 1:1 on the hole blocking layer, thereby forming an electron injection and transport layer having a thickness of 300 Å. Lithium fluoride (LiF) and aluminum were sequentially deposited on the electron injection and transport layer to have a thickness of 10 Å and 800 Å, respectively, thereby forming a negative electrode.

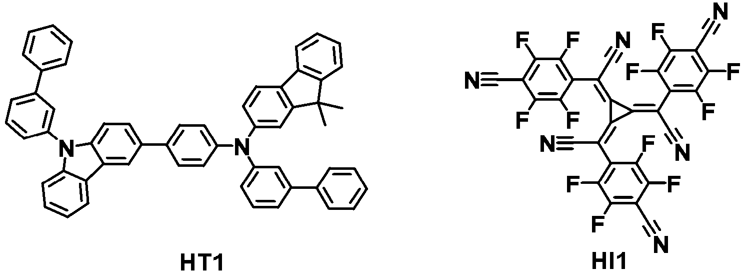

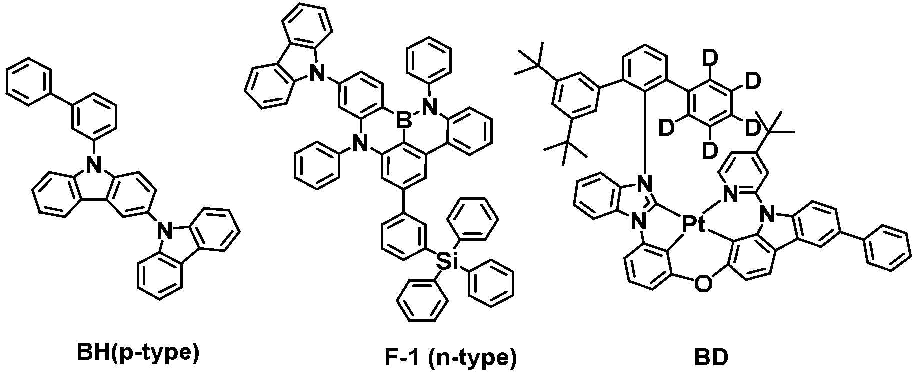

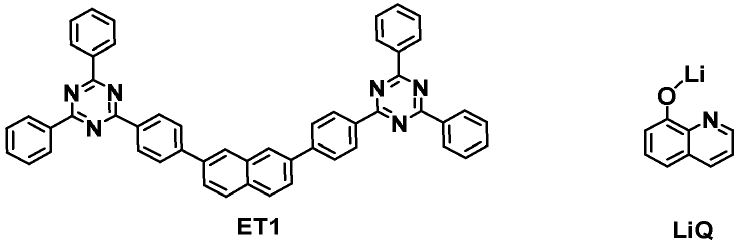

In the aforementioned procedure, the deposition rate of the organic material was maintained at 0.4 to 0.7 Å/sec, the deposition rates of lithium fluoride and aluminum of the negative electrode were maintained at 0.3 Å/sec and at 2 Å/sec, respectively, and the degree of vacuum during the deposition was maintained at 2 × 10⁻⁷ to 5 × 10⁻⁶ torr, thereby manufacturing an organic light emitting device.

### Examples 2 to 39

Organic light emitting devices were manufactured in the same manner as in Example 1, except that compounds described in the following Table 1 were used instead of Compound 1 as a host of the light emitting layer in Example 1.

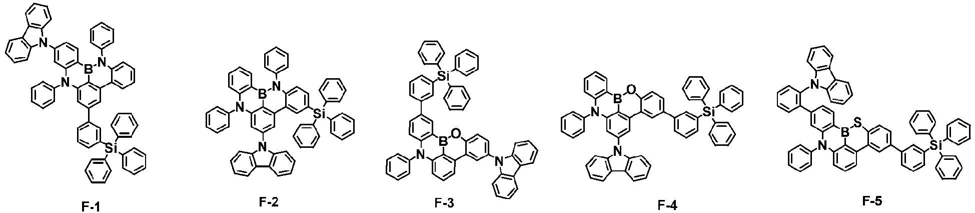

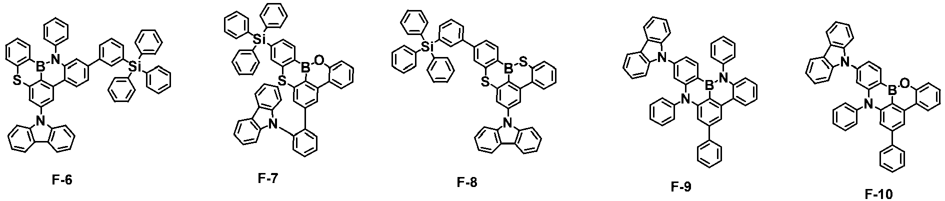

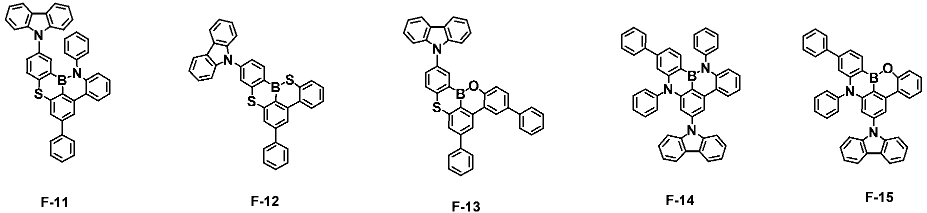

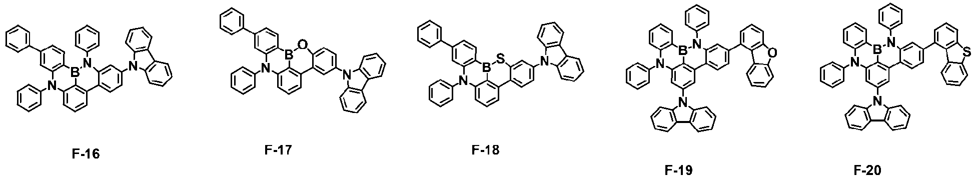

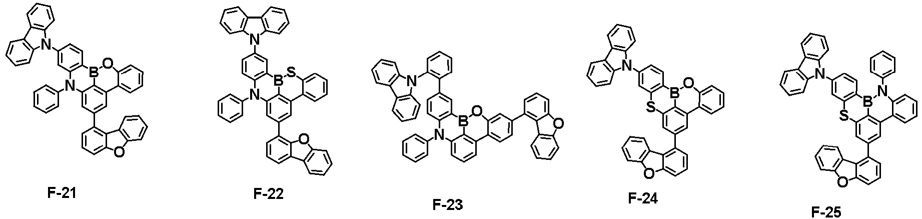

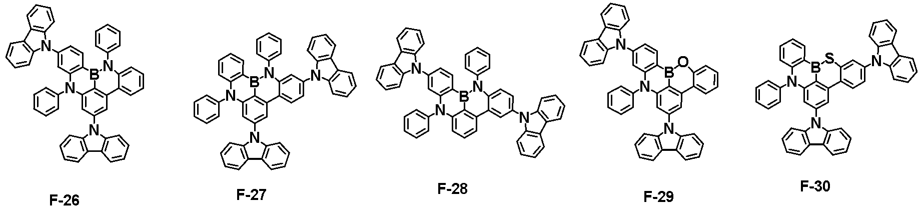

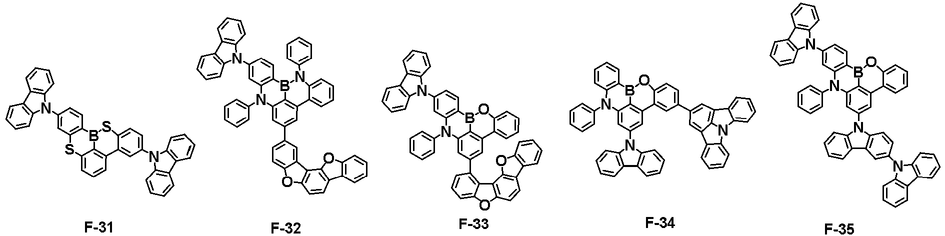

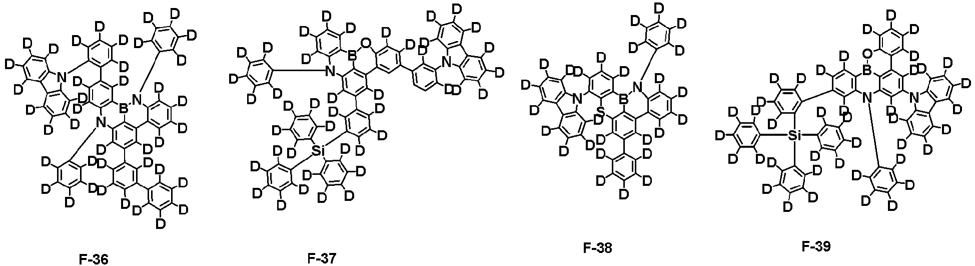

### Comparative Examples 1 to 6

Organic light emitting devices were manufactured in the same manner as in Example 1, except that compounds described in the following Table 1 were used instead of Compound 1 as a host of the light emitting layer in Example 1.

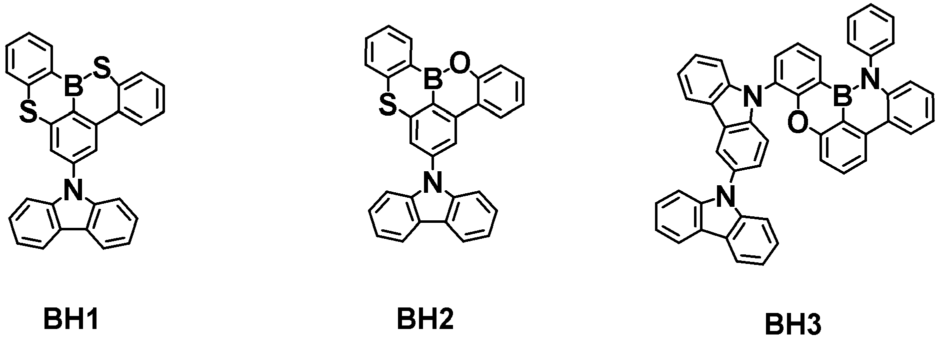

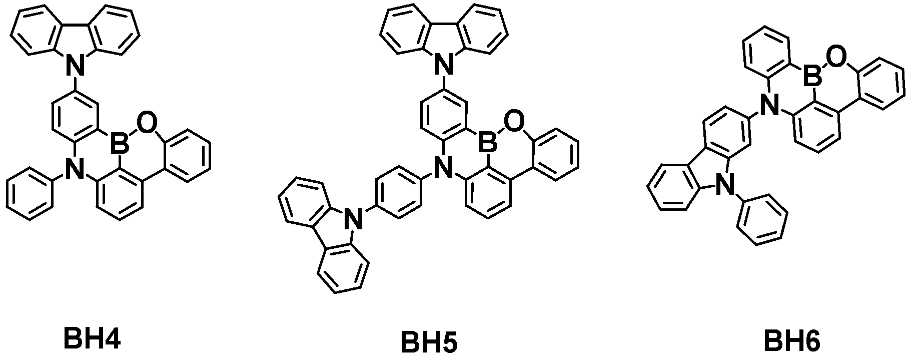

When current was applied to the organic light emitting devices manufactured in Examples 1 to 39 and Comparative Examples 1 to 6, the voltage, efficiency, and service life of each organic light emitting device were measured (based on 1600 nit), and the results thereof are shown in the following Table 1. Service life T90 means the time taken for the luminance to be reduced to 90% of the initial luminance (1600 nit).

**[Table 1]**

| | Host compound | Voltage (V) @10mA/cm² | Light emitting efficiency (Cd/A) @10mA/cm² | Service life, T90 (h) |
|---|---|---|---|---|
| Example 1 | Compound 1 (F-1) | 3.84 | 23.3 | 116 |
| Example 2 | Compound 2 (F-2) | 3.82 | 23.4 | 117 |
| Example 3 | Compound 3 (F-3) | 3.83 | 23.2 | 115 |
| Example 4 | Compound 4 (F-4) | 3.87 | 23.3 | 118 |
| Example 5 | Compound 5 (F-5) | 3.84 | 23.5 | 119 |
| Example 6 | Compound 6 (F-6) | 3.83 | 23.4 | 118 |
| Example 7 | Compound 7 (F-7) | 3.82 | 23.3 | 119 |
| Example 8 | Compound 8 (F-8) | 3.85 | 23.1 | 118 |
| Example 9 | Compound 9 (F-9) | 3.79 | 22.8 | 122 |
| Example 10 | Compound 10 (F-10) | 3.78 | 22.9 | 122 |
| Example 11 | Compound 11 (F-11) | 3.79 | 22.7 | 123 |
| Example 12 | Compound 12 (F-12) | 3.79 | 22.8 | 121 |
| Example 13 | Compound 13 (F-13) | 3.78 | 22.8 | 124 |
| Example 14 | Compound 14 (F-14) | 3.80 | 22.9 | 122 |
| Example 15 | Compound 15 (F-15) | 3.79 | 23.0 | 124 |
| Example 16 | Compound 16 (F-16) | 3.78 | 22.9 | 123 |
| Example 17 | Compound 17 (F-17) | 3.79 | 22.8 | 124 |
| Example 18 | Compound 18 (F-18) | 3.80 | 22.9 | 124 |
| Example 19 | Compound 19 (F-19) | 3.82 | 23.5 | 127 |
| Example 20 | Compound 20 (F-20) | 3.84 | 24.2 | 126 |
| Example 21 | Compound 21 (F-21) | 3.84 | 24.1 | 128 |
| Example 22 | Compound 22 (F-22) | 3.83 | 23.7 | 127 |
| Example 23 | Compound 23 (F-23) | 3.82 | 23.7 | 129 |
| Example 24 | Compound 24 (F-24) | 3.84 | 23.8 | 128 |
| Example 25 | Compound 25 (F-25) | 3.84 | 24.2 | 129 |
| Example 26 | Compound 26 (F-26) | 3.79 | 23.9 | 128 |
| Example 27 | Compound 27 (F-27) | 3.80 | 23.8 | 129 |
| Example 28 | Compound 28 (F-28) | 3.79 | 23.9 | 128 |
| Example 29 | Compound 29 (F-29) | 3.79 | 23.9 | 128 |
| Example 30 | Compound 30 (F-30) | 3.80 | 24.1 | 129 |
| Example 31 | Compound 31 (F-31) | 3.78 | 23.8 | 128 |
| Example 32 | Compound 32 (F-32) | 3.82 | 23.9 | 127 |
| Example 33 | Compound 33 (F-33) | 3.81 | 24.0 | 129 |
| Example 34 | Compound 34 (F-34) | 3.81 | 23.9 | 125 |
| Example 35 | Compound 35 (F-35) | 3.82 | 23.9 | 126 |
| Example 36 | Compound 36 (F-36) | 3.79 | 22.9 | 166 |
| Example 37 | Compound 37 (F-37) | 3.83 | 23.4 | 159 |
| Example 38 | Compound 38 (F-38) | 3.80 | 23.3 | 162 |
| Example 39 | Compound 39 (F-39) | 3.82 | 23.5 | 165 |
| Comparative Example 1 | BH1 | 4.32 | 17.1 | 92 |
| Comparative Example 2 | BH2 | 4.31 | 17.5 | 91 |
| Comparative Example 3 | BH3 | 4.31 | 17.4 | 85 |
| Comparative Example 4 | BH4 | 4.33 | 17.4 | 89 |
| Comparative Example 5 | BH5 | 4.37 | 18.2 | 88 |
| Comparative Example 6 | BH6 | 4.32 | 17.7 | 82 |

In the case of Compounds BH1 to BH5 used in the organic light emitting devices of Comparative Examples 1 to 5, any one of the benzene rings linked to boron of the core structure has a substituted structure, but as the benzene ring becomes unstable due to the electron-pulling properties of boron, service life reduction characteristics are increased. It can be confirmed from Table 1 above that as the service life reduction characteristics are increased, the voltage is increased and the efficiency is decreased.

In addition, in the case of the organic light emitting device of Comparative Example 6 using Compound BH6 in which any one of the benzene rings linked to boron of the core structure is not substituted, it can be confirmed that the compound is structurally unstable and thus shows the shortest service life characteristics.

However, in the case of the compound according to Chemical Formula 1 of the present application, at least one of the benzene rings directly or indirectly linked to the boron of the core structure may be substituted with a carbazole group, and at least one of the other rings is substituted with an aryl group, a silyl group, or a heterocyclic group to stabilize the unstable structure and serve to add hole characteristics, thereby enhancing the service life increasing characteristics. That is, the structural stability of the compound results in reduced voltage and increased efficiency at high currents.

### [Explanation of Reference Numerals and Symbols]

- 1:: Substrate
- 2:: First electrode
- 3:: Hole injection layer
- 4:: Hole Transport layer
- 5:: Electron blocking layer
- 6:: Light Emitting Layer
- 7:: Hole blocking layer
- 8:: Electron injection and transport layer
- 9:: Second electrode

## Claims

1. A compound represented by the following Chemical Formula 1: 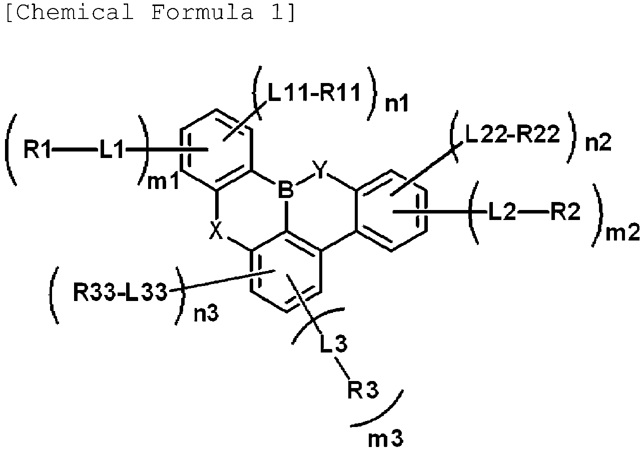 wherein, in Chemical Formula 1,
X is NR; or S,
Y is NR'; O; or S,
R and R' are the same as or different from each other, and are each independently hydrogen; deuterium; a substituted or unsubstituted alkyl group; a substituted or unsubstituted silyl group; or a substituted or unsubstituted aryl group,
L1 to L3 and L11 to L33 are the same as or different from each other, and are each independently a direct bond; a substituted or unsubstituted arylene group; or a substituted or unsubstituted divalent heterocyclic group,
R1 to R3 and R11 to R33 are the same as or different from each other, and are each independently hydrogen; deuterium; a halogen group; a nitrile group; a substituted or unsubstituted silyl group; a substituted or unsubstituted alkyl group; a substituted or unsubstituted cycloalkyl group; a substituted or unsubstituted aryl group; or a substituted or unsubstituted heterocyclic group,
at least one of R1 to R3 is a substituted or unsubstituted carbazole group,
at least one of R11 to R33 is a substituted or unsubstituted silyl group; a substituted or unsubstituted aryl group; or a substituted or unsubstituted heterocyclic group,
n1, n2, m1, and m2 are each an integer from 1 to 4,
n3 and m3 are each an integer from 1 to 3,
when n1 to n3 and m1 to m3 are each 2 or higher, substituents in the parenthesis are each the same as or different from each other, and
n1+m1 is 4 or less, n2+m2 is 4 or less, and n3+m3 is 3 or less.

2. The compound of claim 1, wherein L1 to L3 and L11 to L33 are the same as or different from each other, and are each independently a direct bond; a substituted or unsubstituted arylene group having 6 to 20 carbon atoms; or a substituted or unsubstituted divalent heterocyclic group having 2 to 20 carbon atoms, which comprises one or more of N, O, and S as a heteroatom.

3. The compound of claim 1, wherein L1 to L3 are the same as or different from each other, and are each independently a direct bond; a phenylene group unsubstituted or substituted with deuterium; a divalent dibenzofuran group unsubstituted or substituted with deuterium; a divalent dibenzothiophene group unsubstituted or substituted with deuterium; or a divalent carbazole group unsubstituted or substituted with deuterium.

4. The compound of claim 1, wherein L11 to L33 are the same as or different from each other, and are each independently a direct bond; a phenylene group unsubstituted or substituted with deuterium; or a divalent carbazole group unsubstituted or substituted with deuterium.

5. The compound of claim 1, wherein R1 to R3 and R11 to R33 are the same as or different from each other, and are each independently hydrogen; deuterium; a halogen group; a nitrile group; a substituted or unsubstituted alkylsilyl group having 1 to 20 carbon atoms; a substituted or unsubstituted arylsilyl group having 6 to 20 carbon atoms; a substituted or unsubstituted alkyl group having 1 to 20 carbon atoms; a substituted or unsubstituted cycloalkyl group having 3 to 20 carbon atoms; a substituted or unsubstituted aryl group having 6 to 20 carbon atoms; or a substituted or unsubstituted heterocyclic group having 2 to 30 carbon atoms, at least one of R1 to R3 is a substituted or unsubstituted carbazole group, and at least one of R11 to R33 is a substituted or unsubstituted alkylsilyl group having 1 to 20 carbon atoms; a substituted or unsubstituted arylsilyl group having 6 to 20 carbon atoms; a substituted or unsubstituted aryl group having 6 to 20 carbon atoms; or a substituted or unsubstituted heterocyclic group having 2 to 30 carbon atoms.

6. The compound of claim 1, wherein at least one of R11 to R33 is a triphenylsilyl group unsubstituted or substituted with deuterium; a phenyl group unsubstituted or substituted with deuterium; a biphenyl group unsubstituted or substituted with deuterium; a naphthyl group unsubstituted or substituted with deuterium; a carbazole group unsubstituted or substituted with deuterium; a dibenzofuran group unsubstituted or substituted with deuterium; a dibenzothiophene group unsubstituted or substituted with deuterium; or a heterocyclic group which comprises one or more of N and O as a heteroatom, has four to seven fused rings, and is unsubstituted or substituted with deuterium, and the others are the same as or different from each other, and are each independently hydrogen; or deuterium.

7. The compound of claim 1, wherein Chemical Formula 1 is represented by any one of the following Chemical Formulae 1-1 to 1-6: 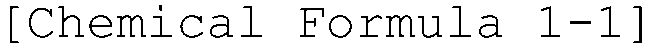 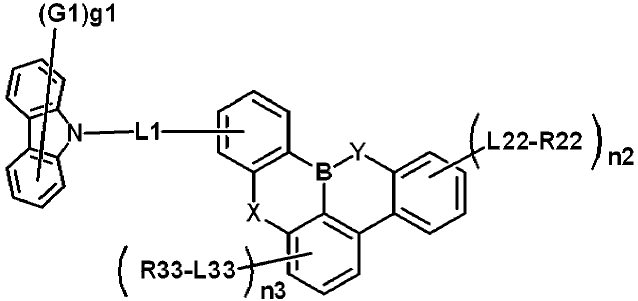 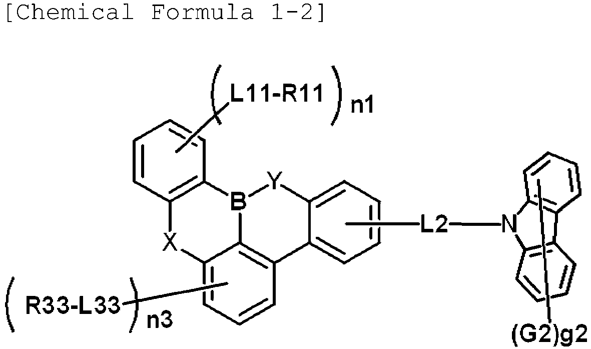 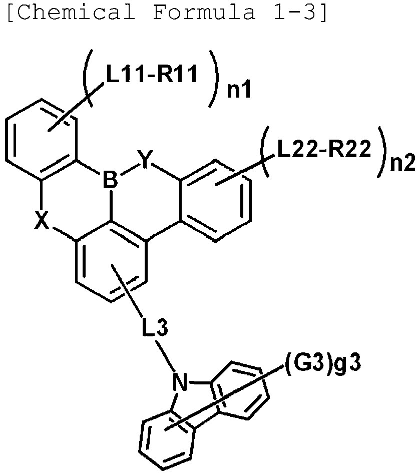 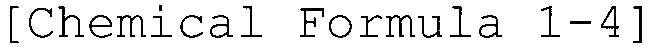 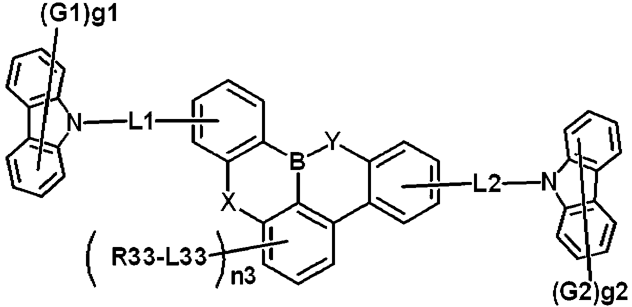 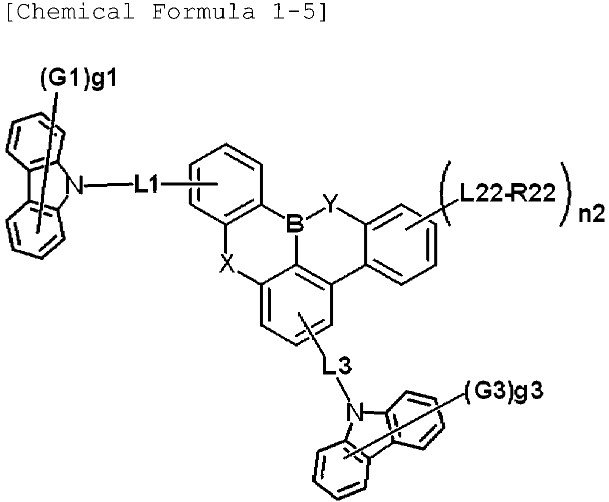 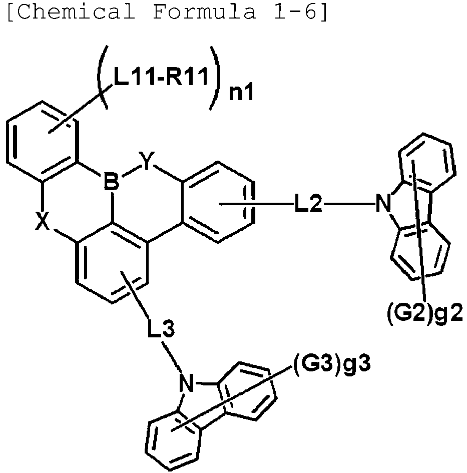
in Chemical Formulae 1-1 to 1-6,
the definitions of X, Y, R11 to R33, L1 to L3, L11 to L33, and n1 to n3 are the same as the definitions in Chemical Formula 1,
G1 to G3 are the same as or different from each other, and are each independently hydrogen; deuterium; a halogen group; a nitrile group; a substituted or unsubstituted silyl group; a substituted or unsubstituted alkyl group; a substituted or unsubstituted cycloalkyl group; a substituted or unsubstituted aryl group; or a substituted or unsubstituted heterocyclic group, and
g1 to g3 are each an integer from 1 to 8, and when g1 to g3 are each 2 or higher, G1 to G3 are each the same as or different from each other.

8. The compound of claim 1, wherein Chemical Formula 1 is represented by any one of the following compounds:

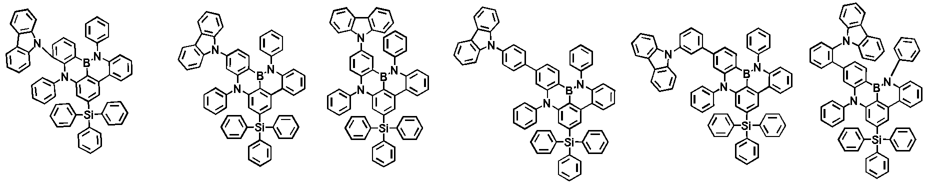

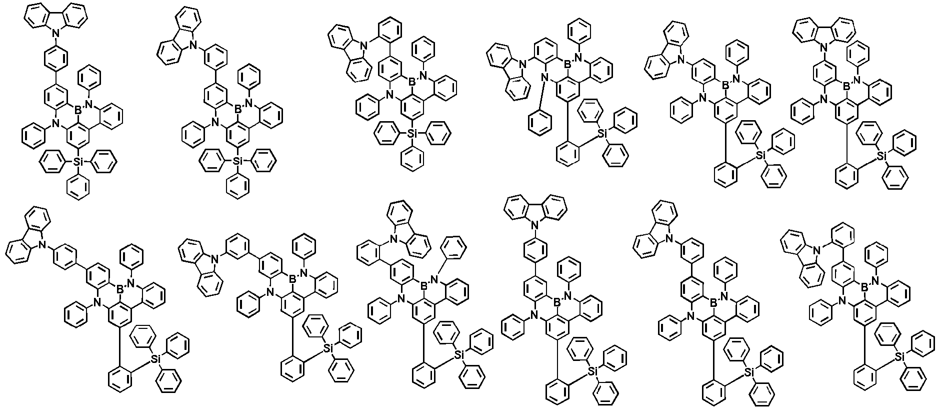

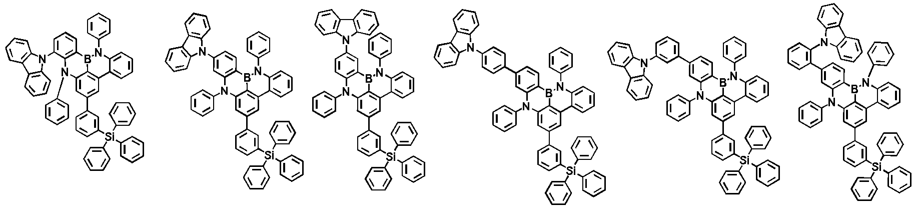

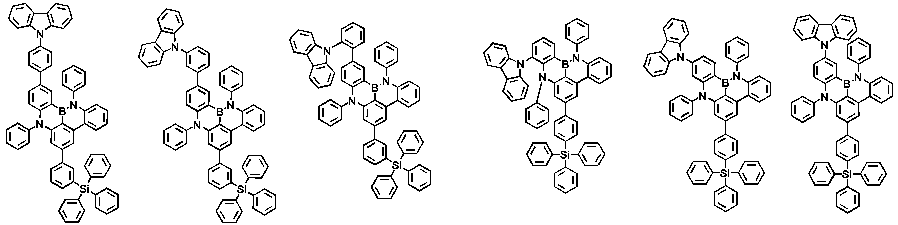

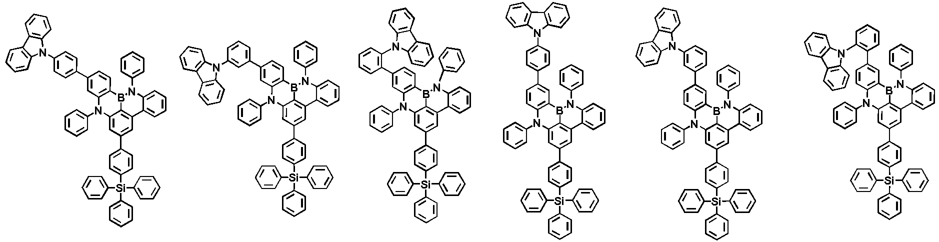

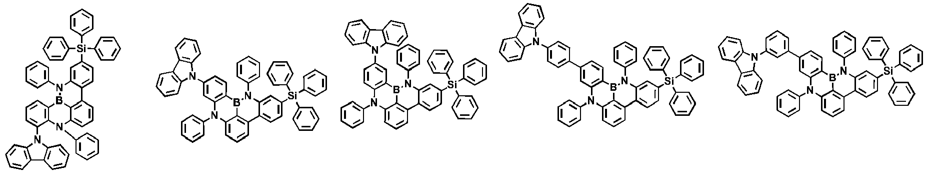

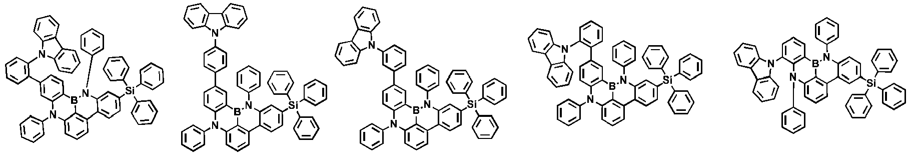

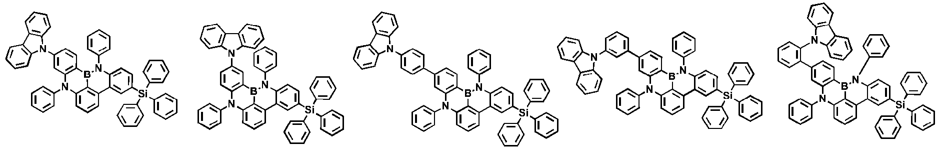

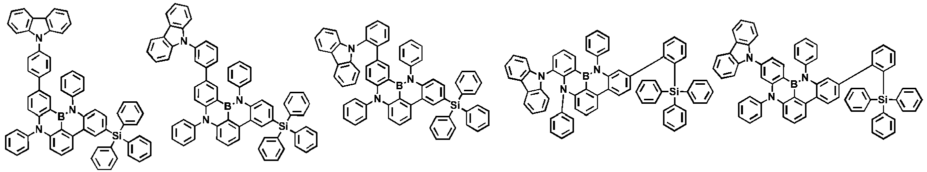

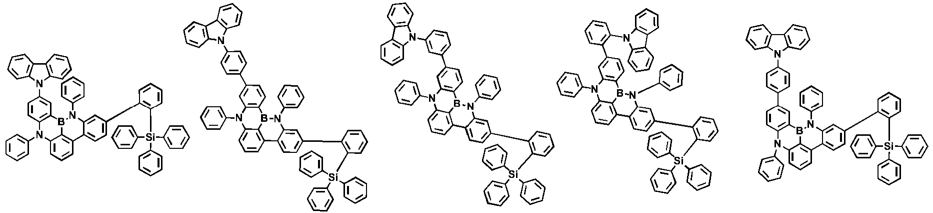

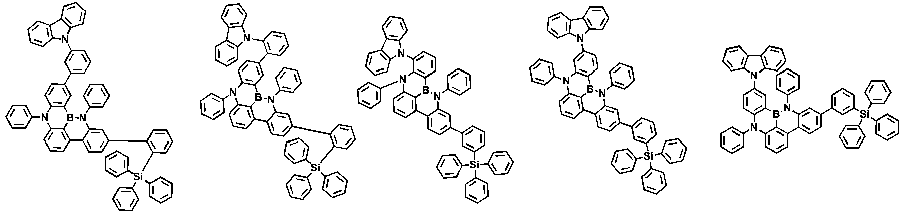

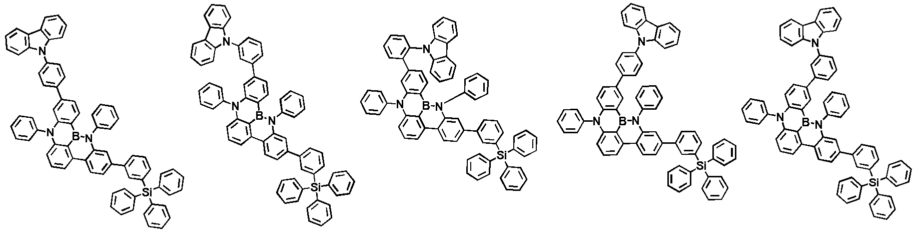

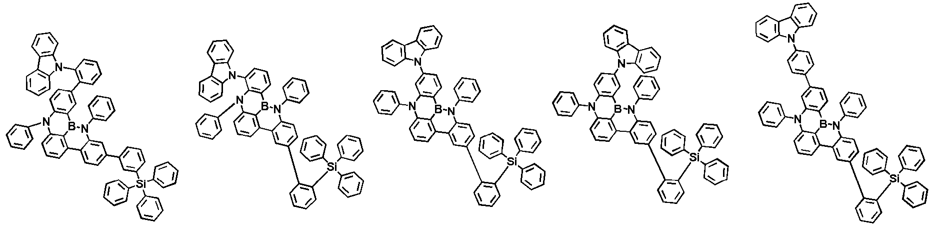

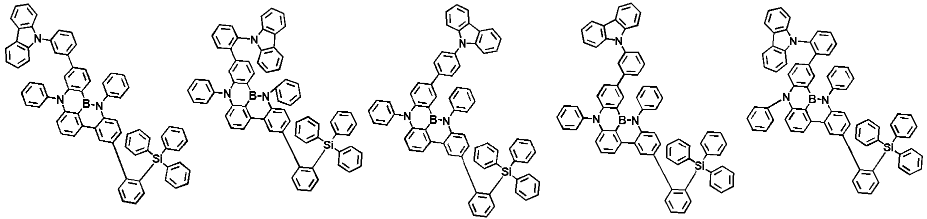

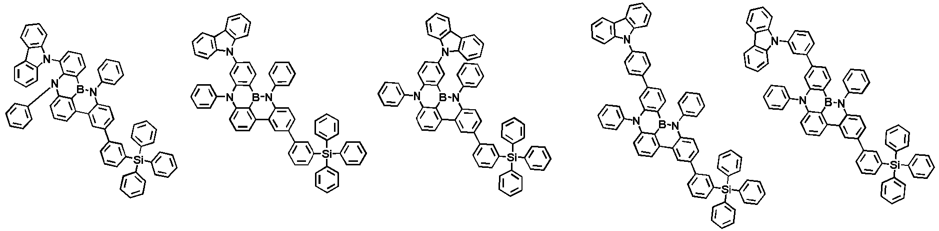

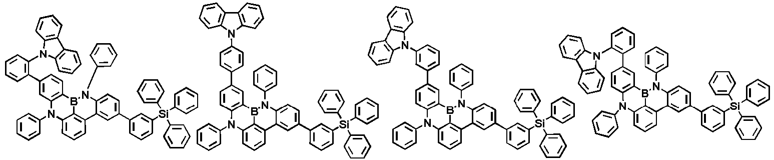

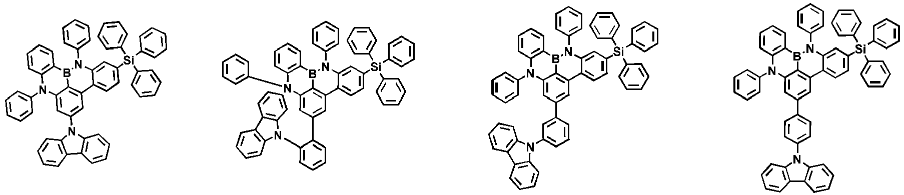

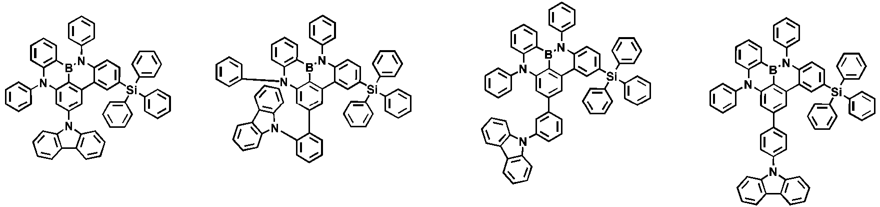

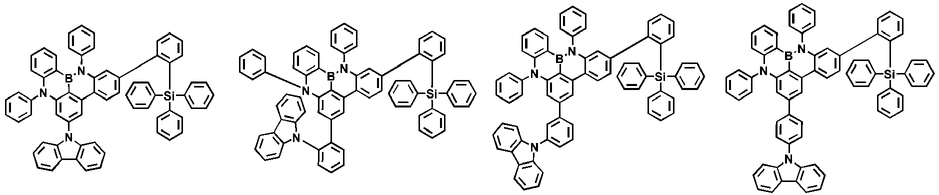

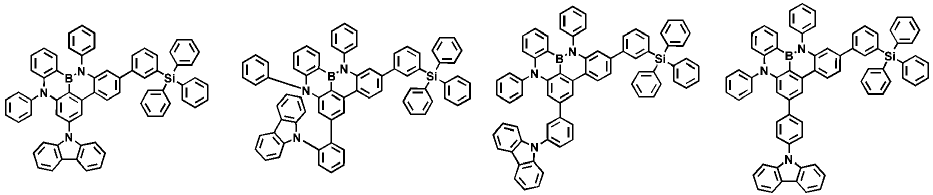

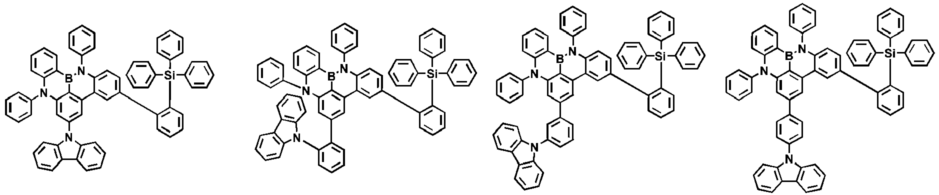

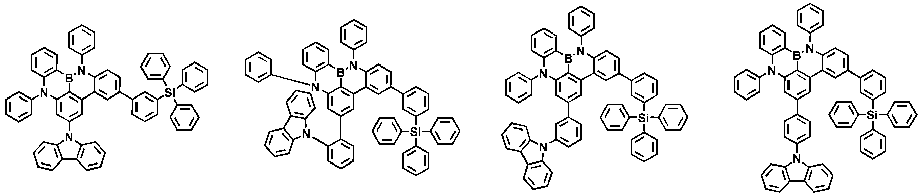

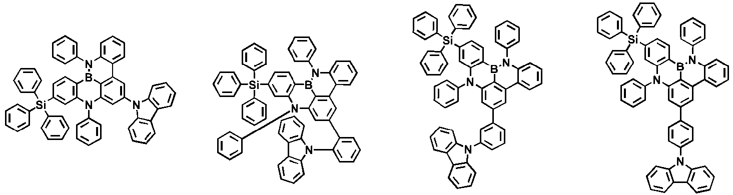

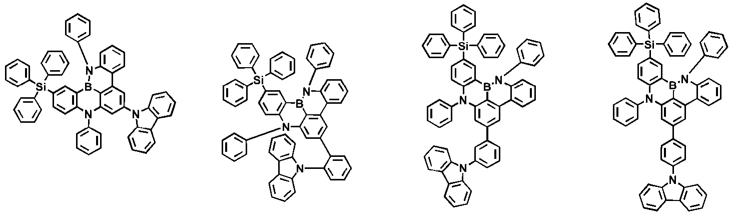

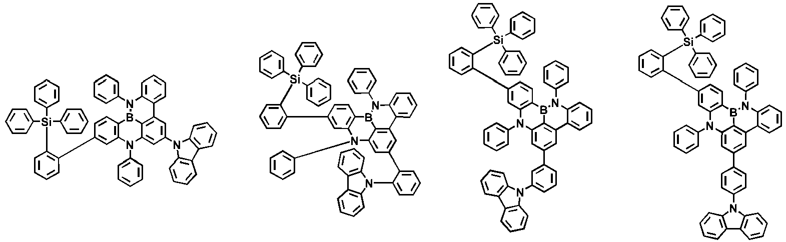

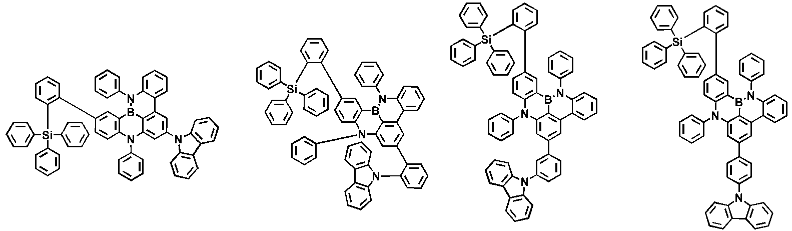

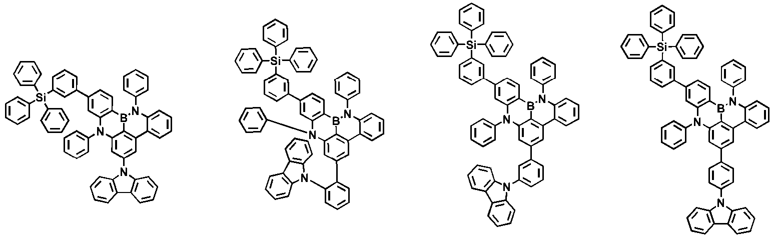

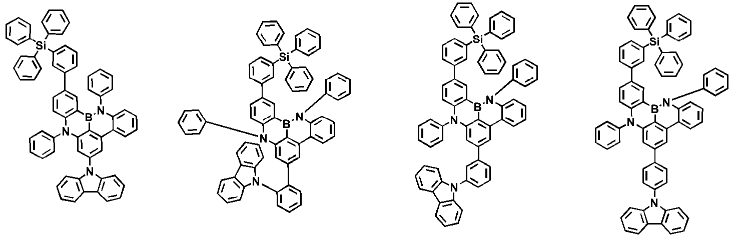

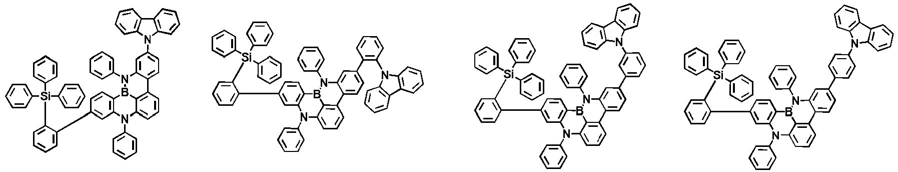

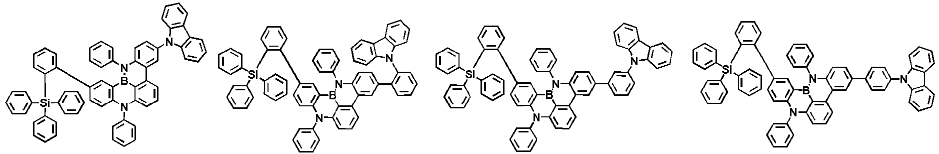

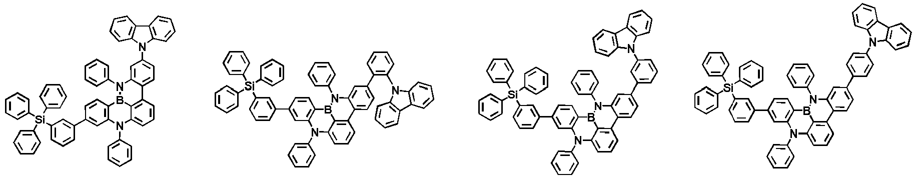

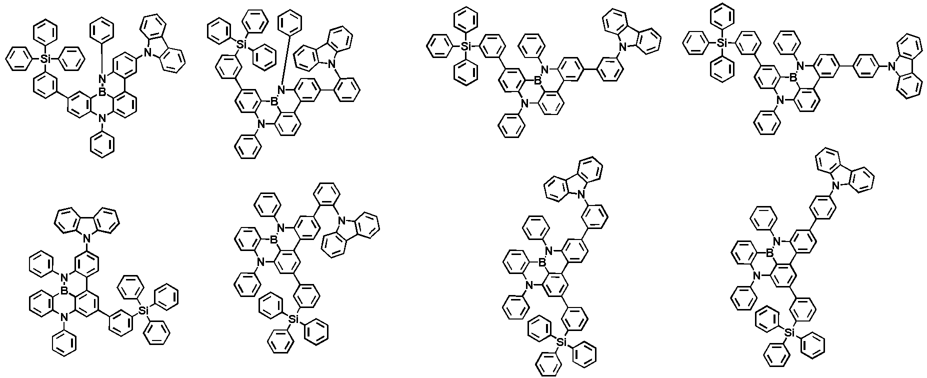

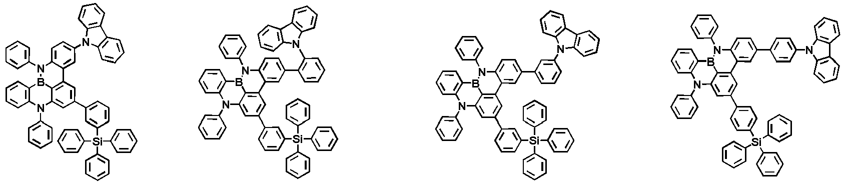

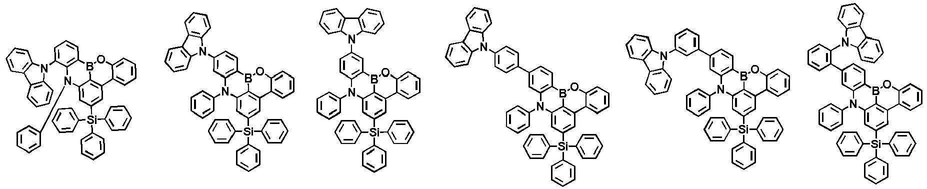

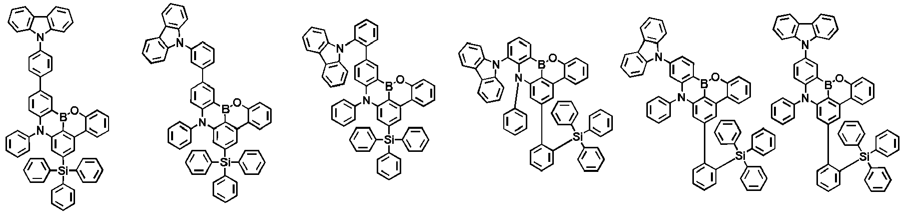

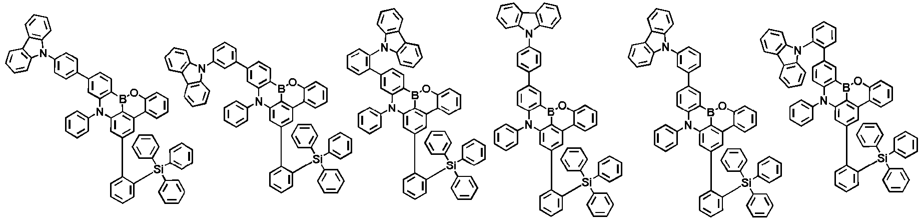

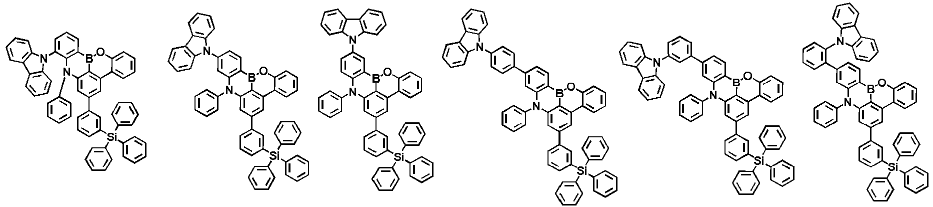

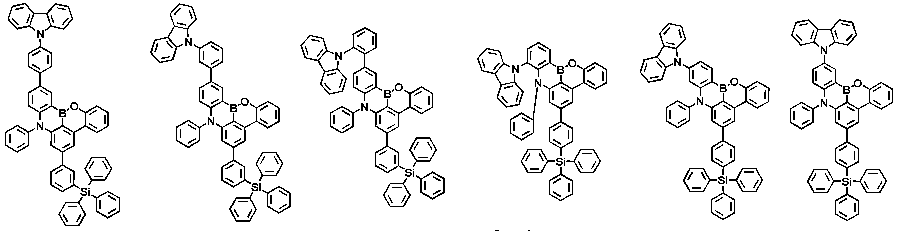

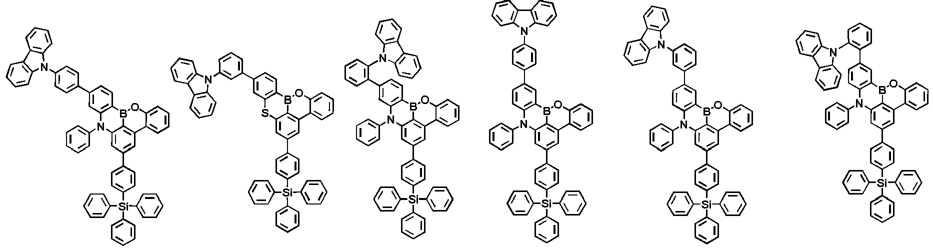

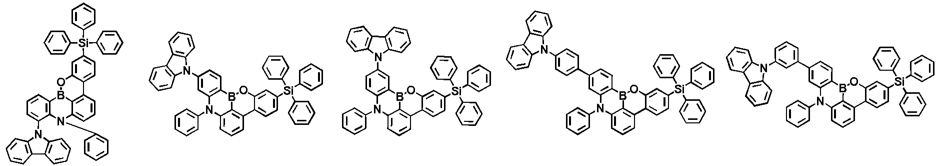

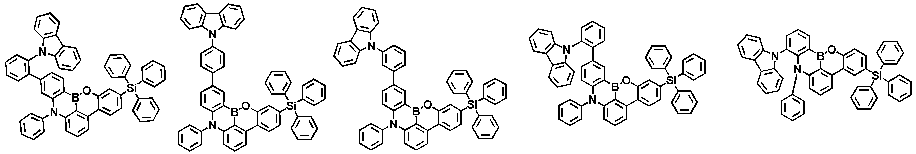

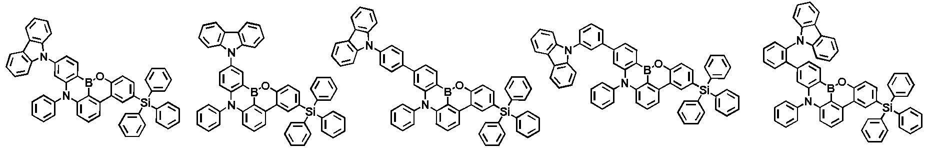

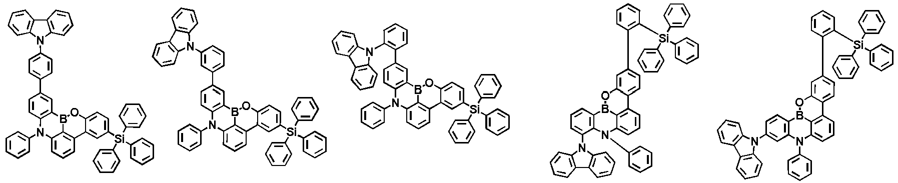

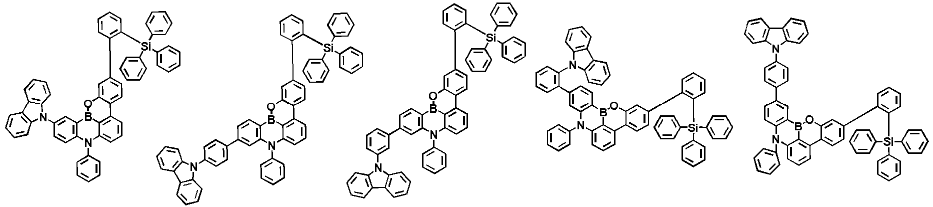

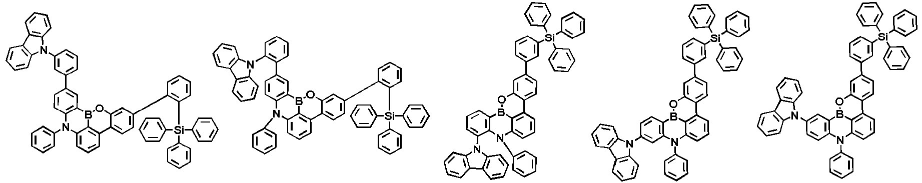

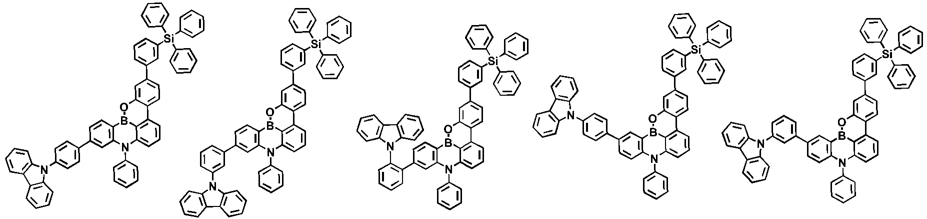

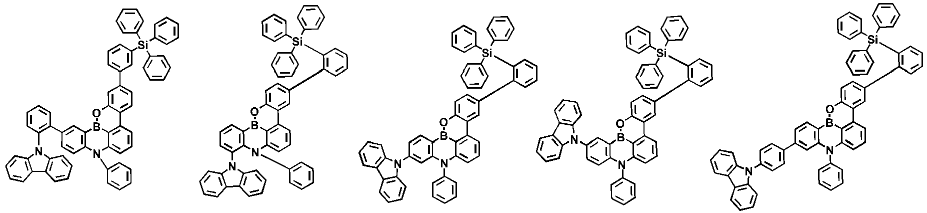

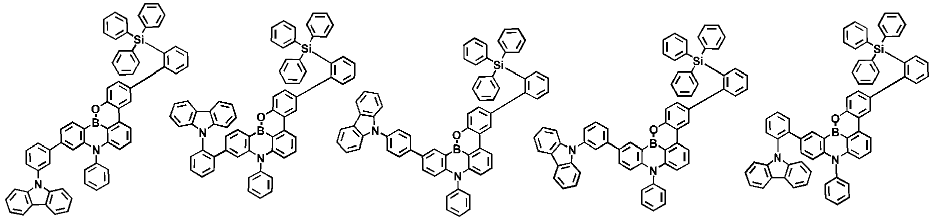

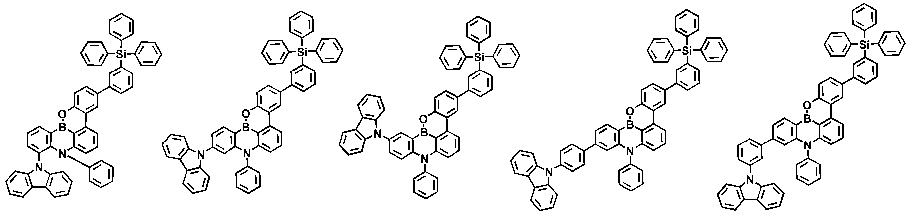

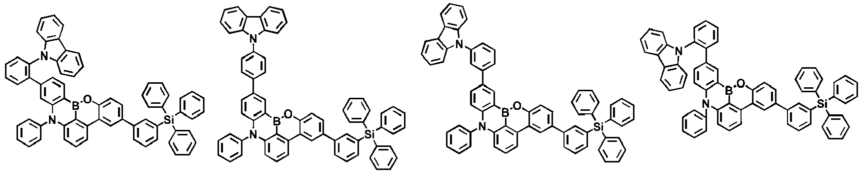

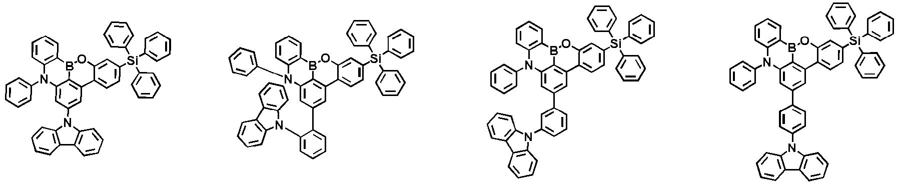

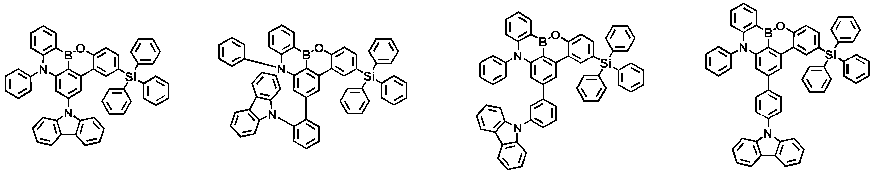

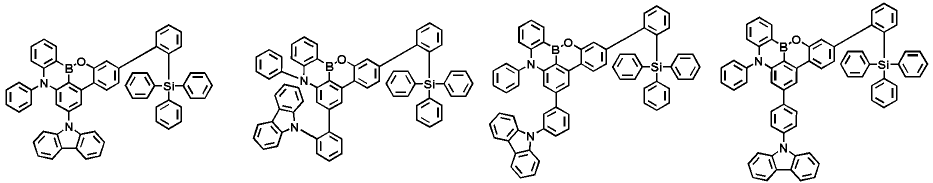

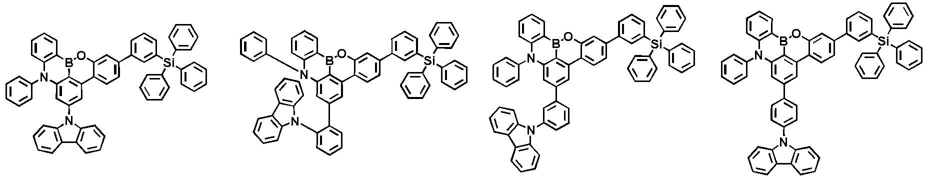

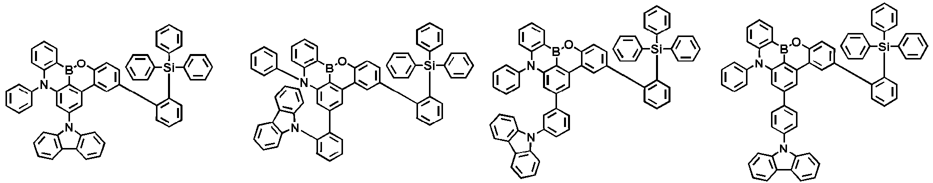

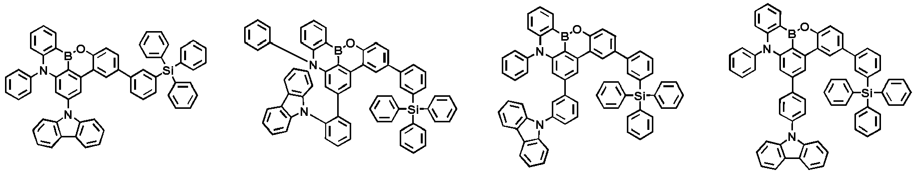

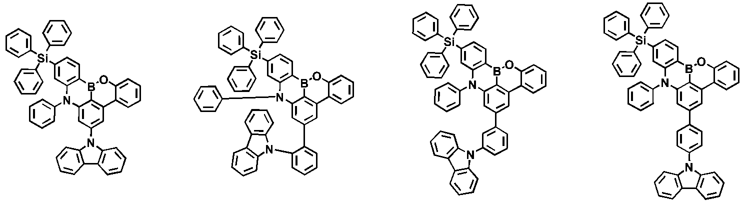

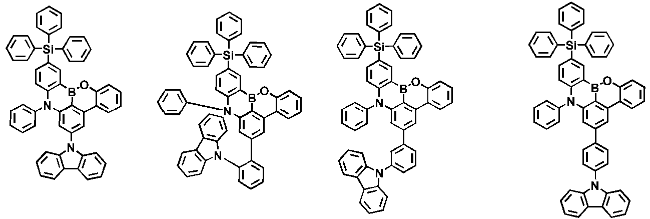

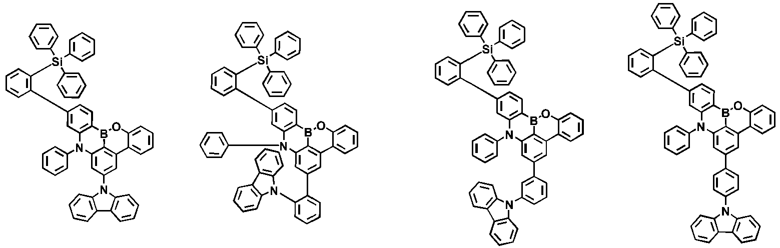

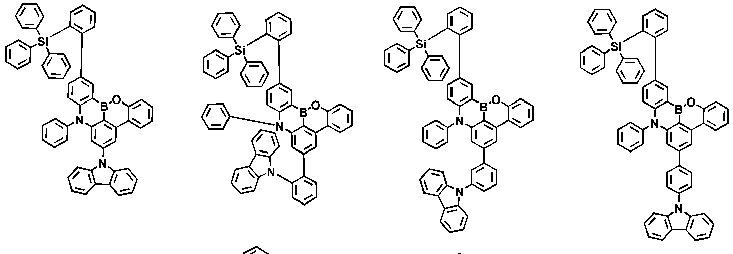

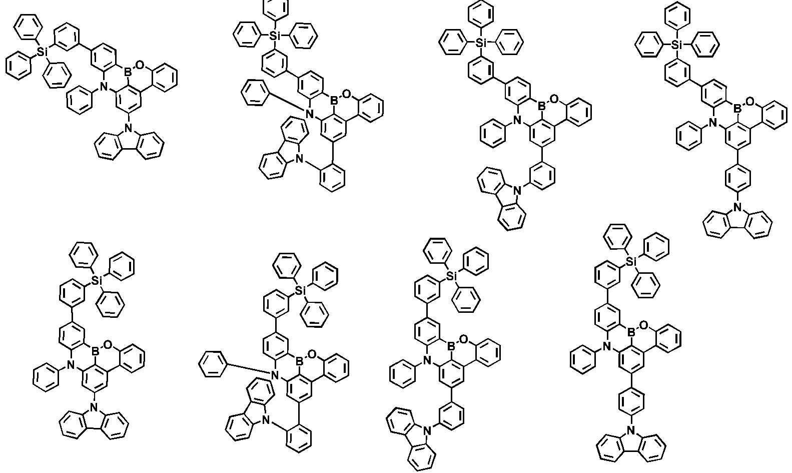

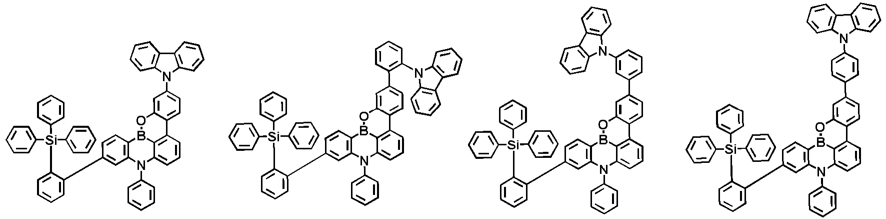

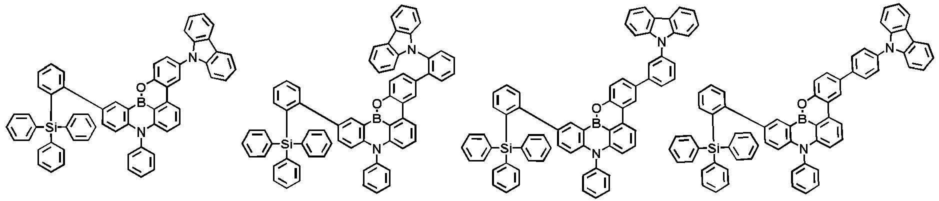

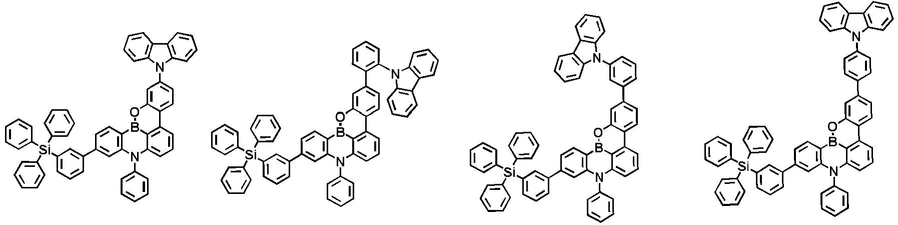

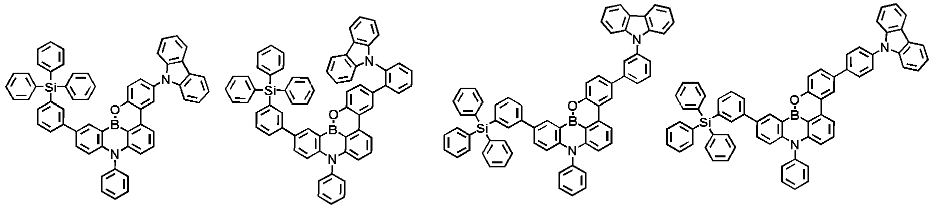

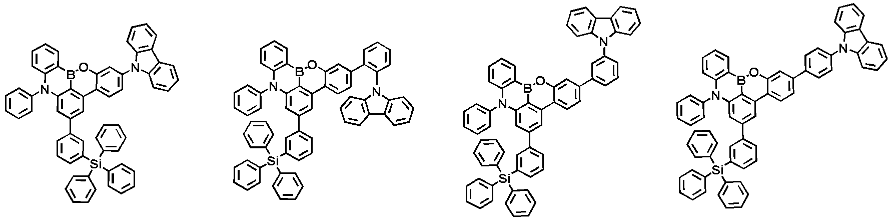

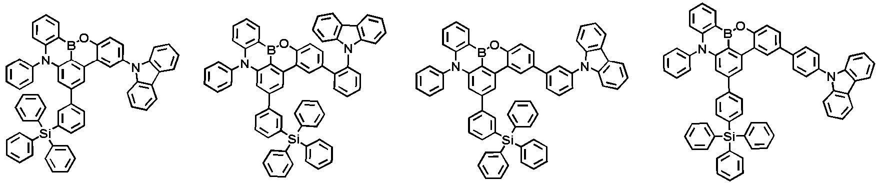

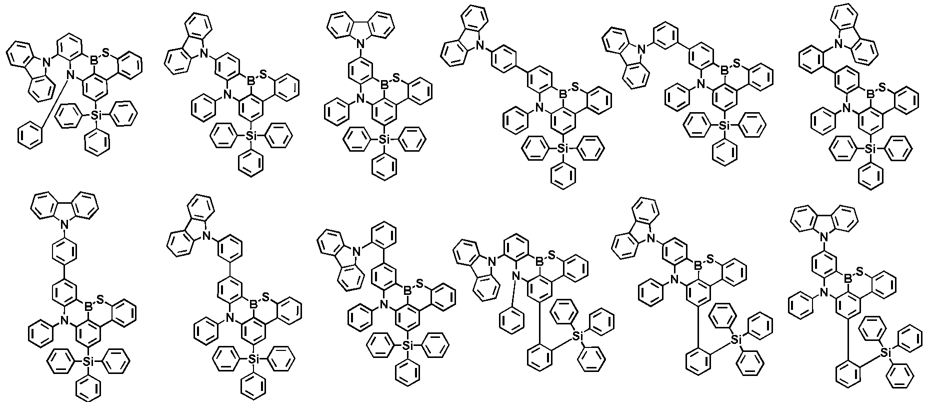

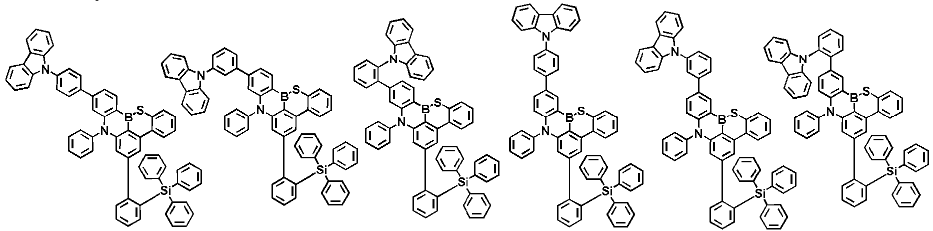

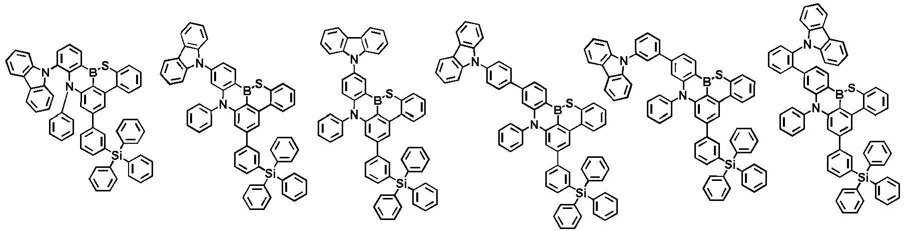

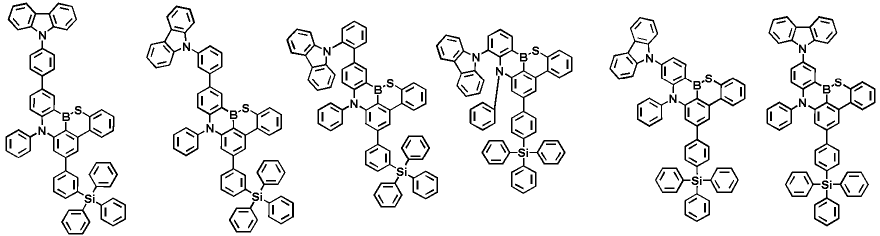

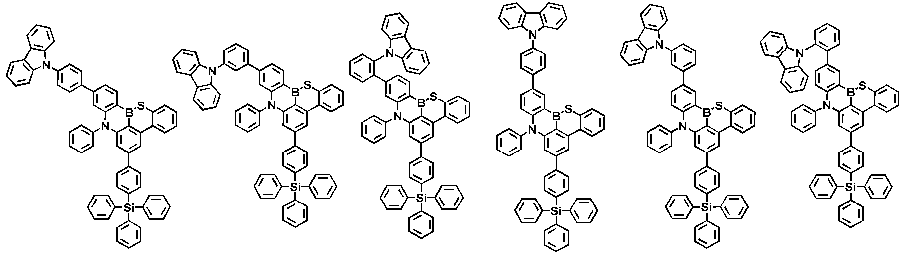

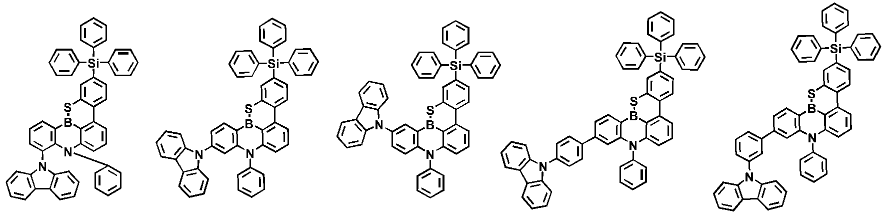

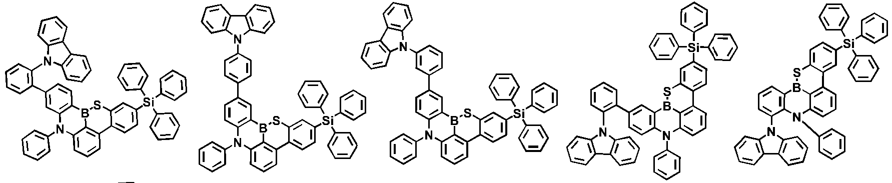

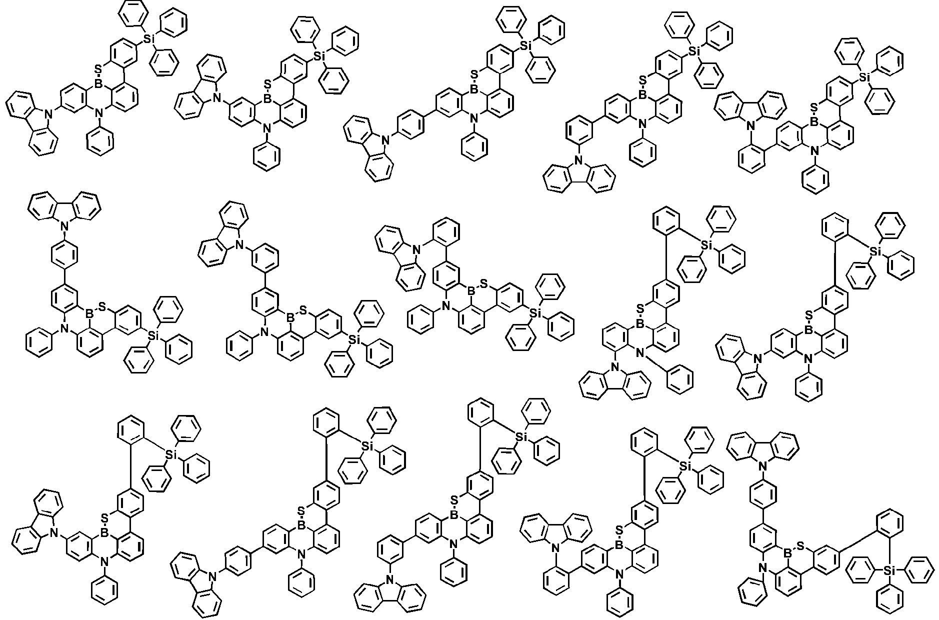

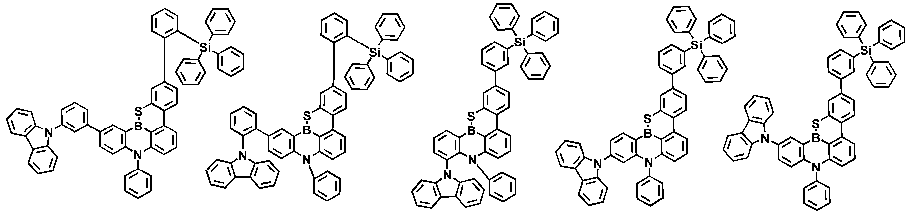

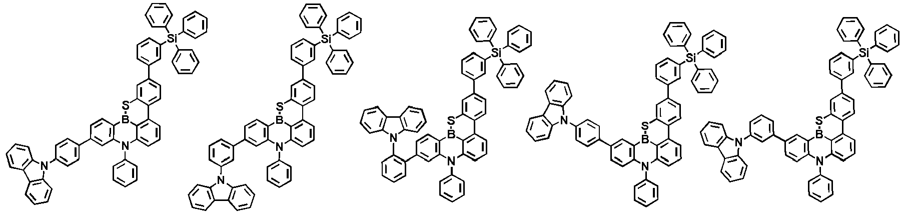

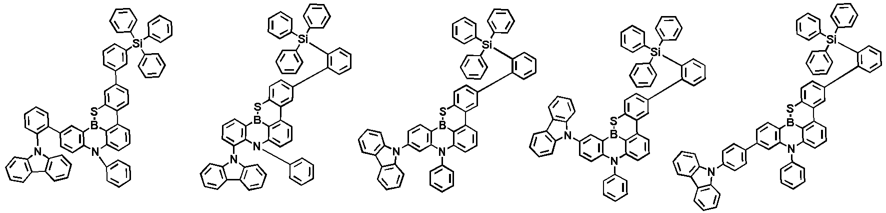

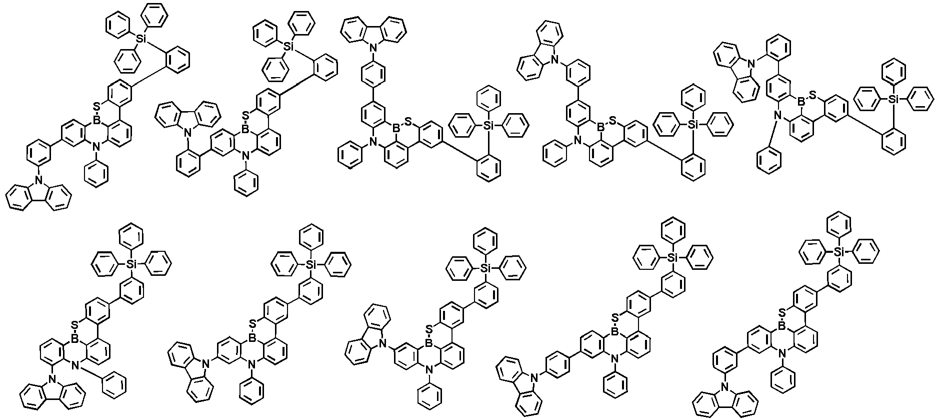

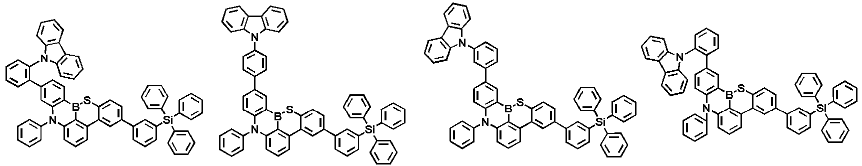

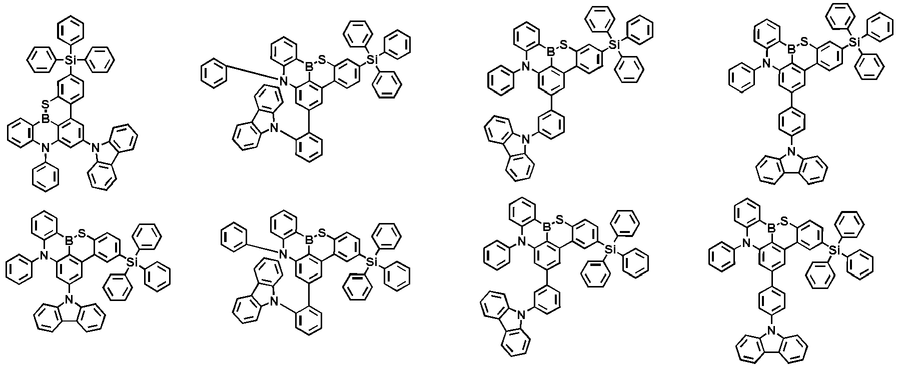

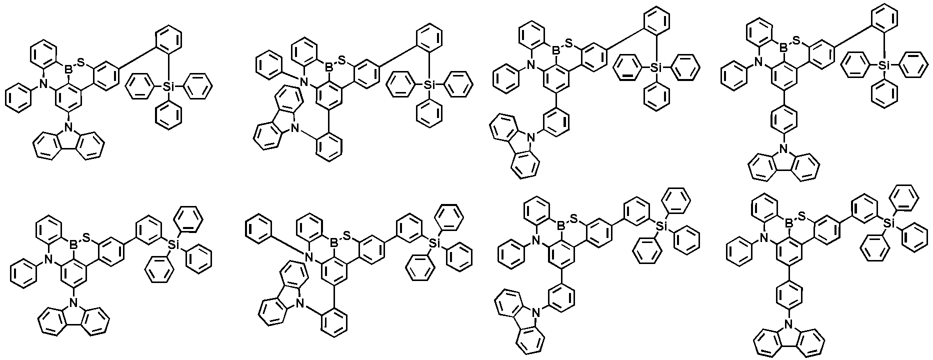

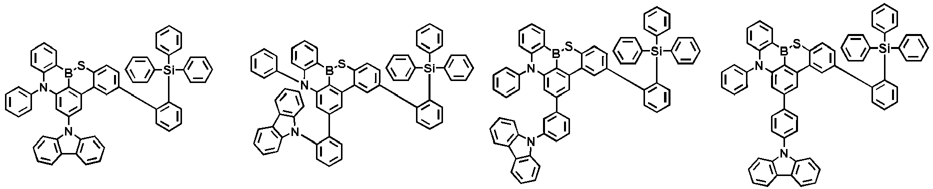

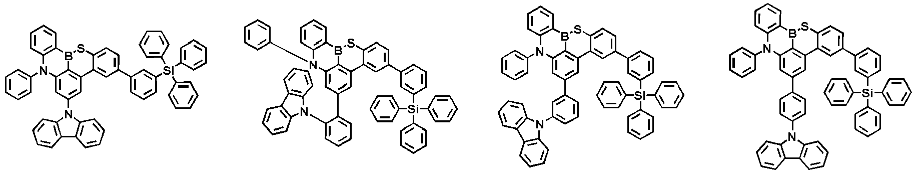

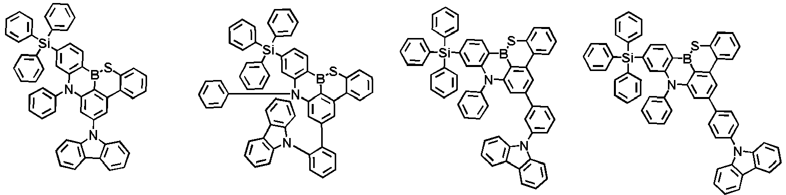

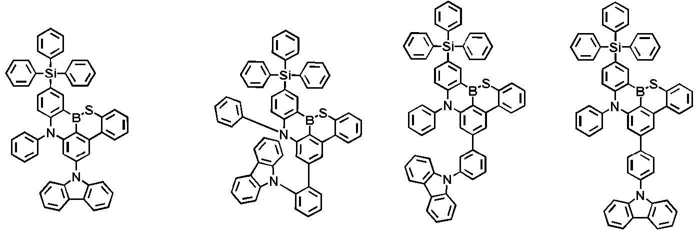

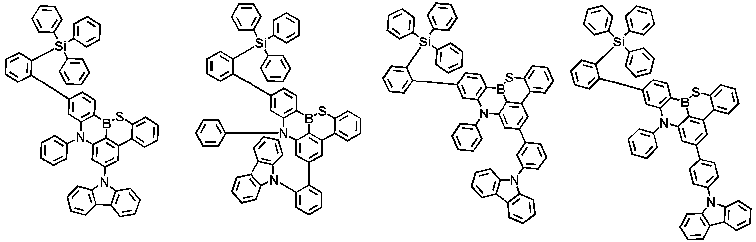

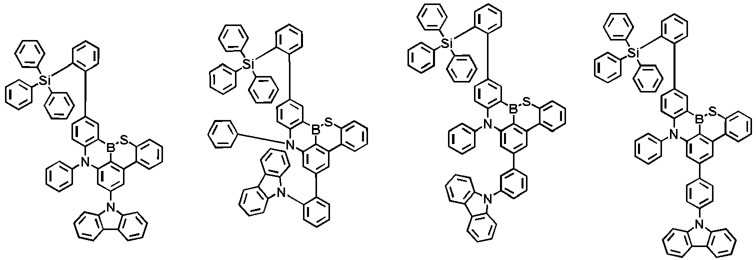

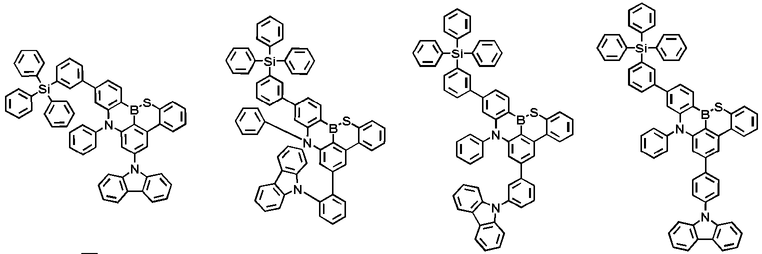

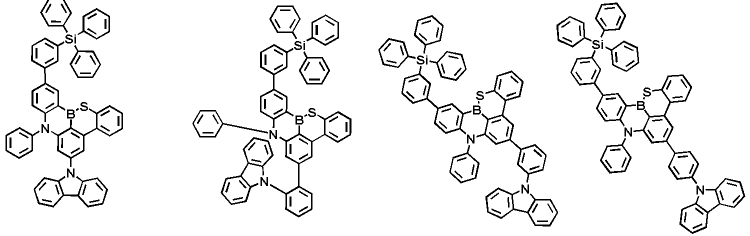

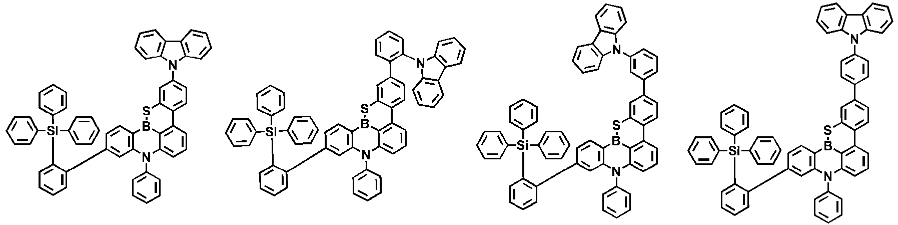

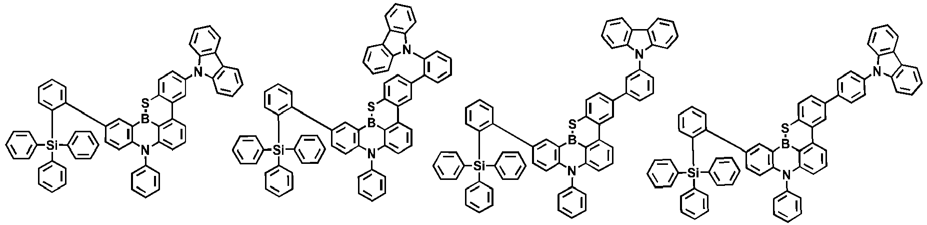

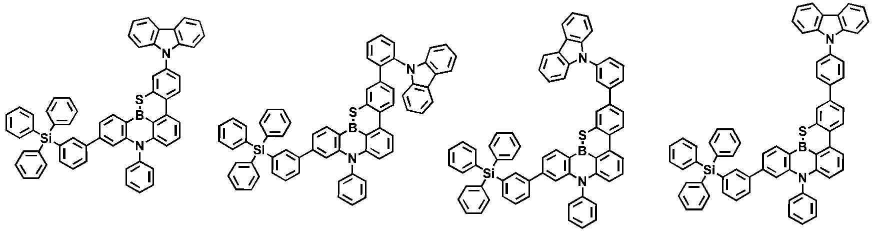

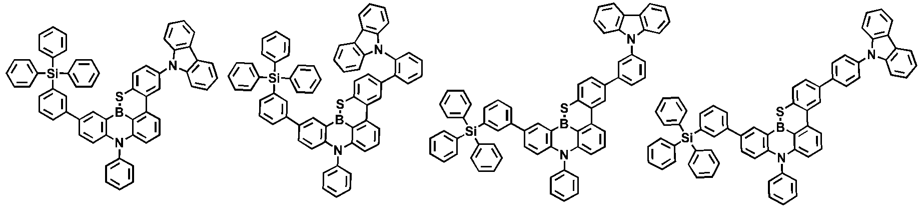

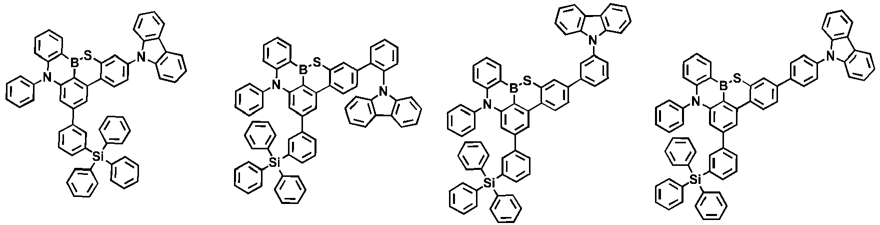

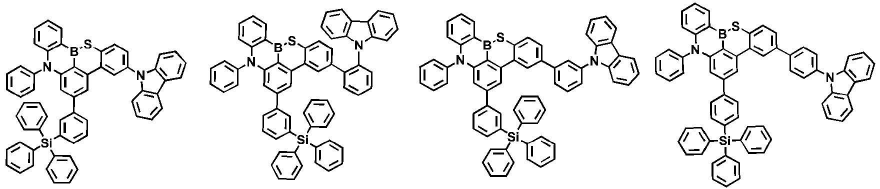

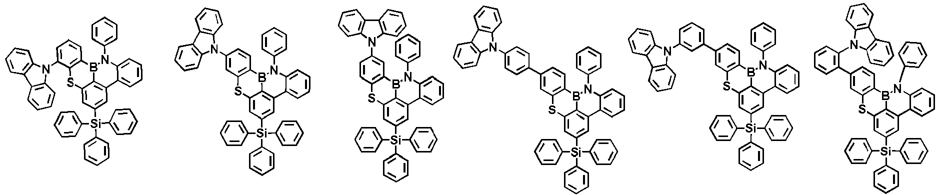

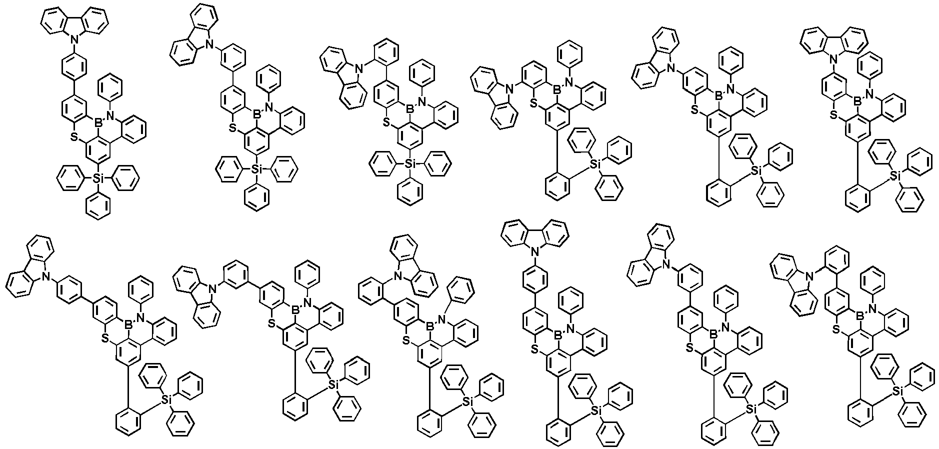

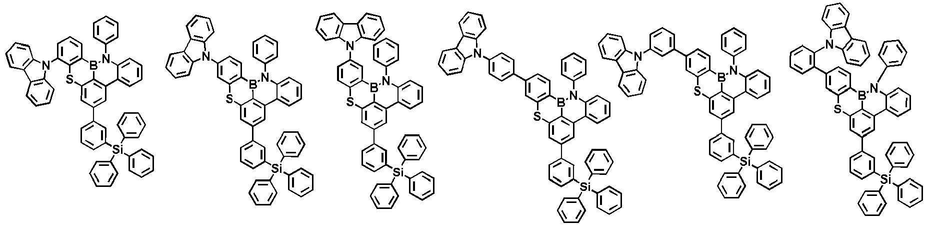

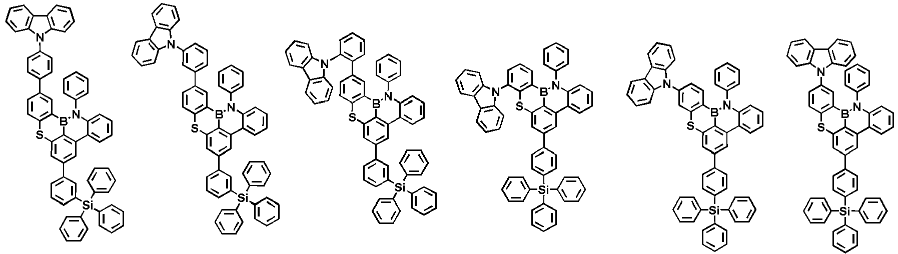

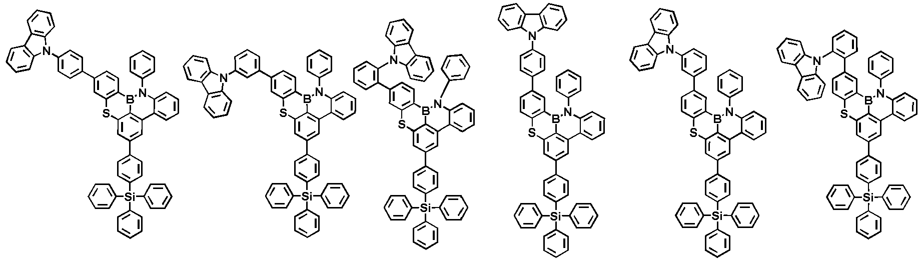

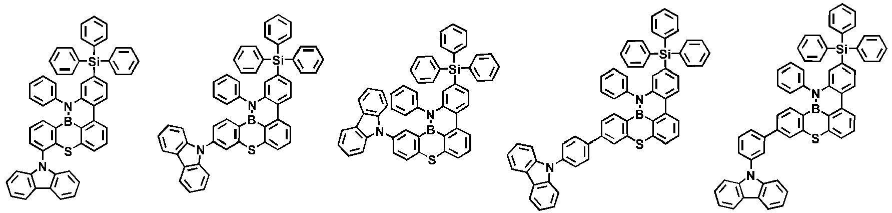

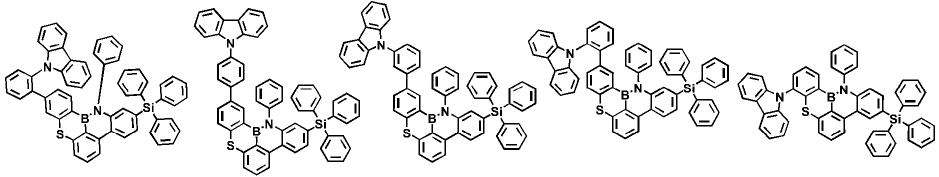

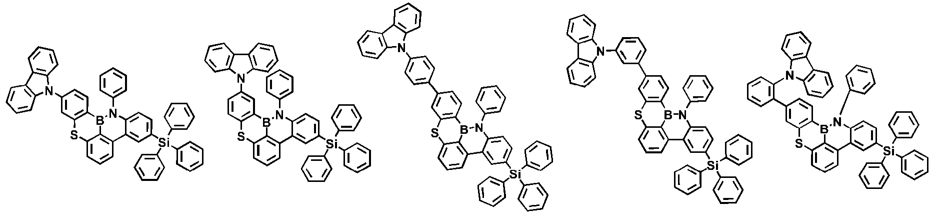

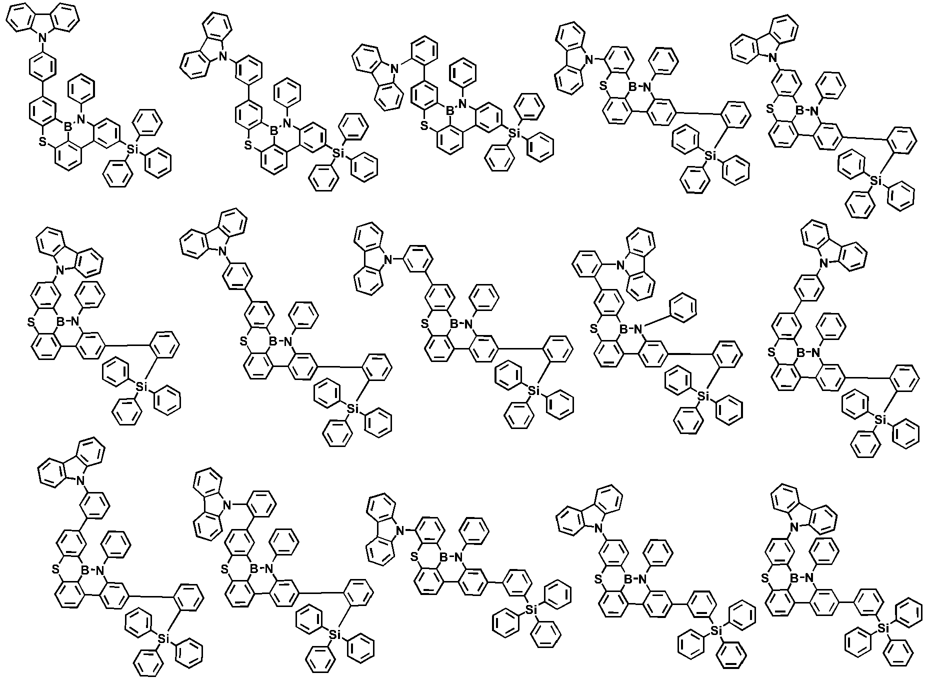

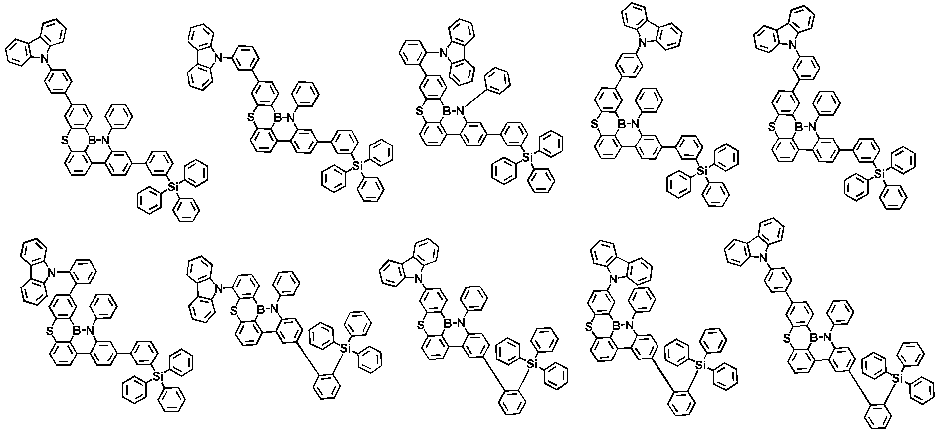

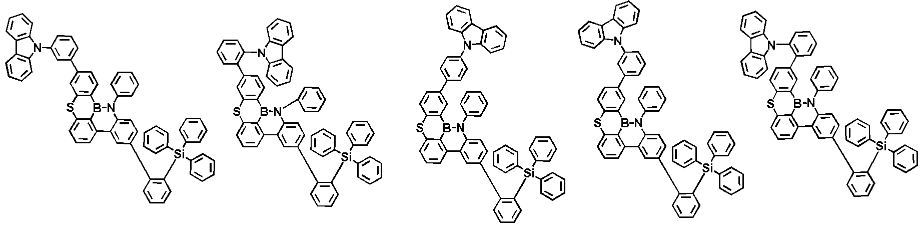

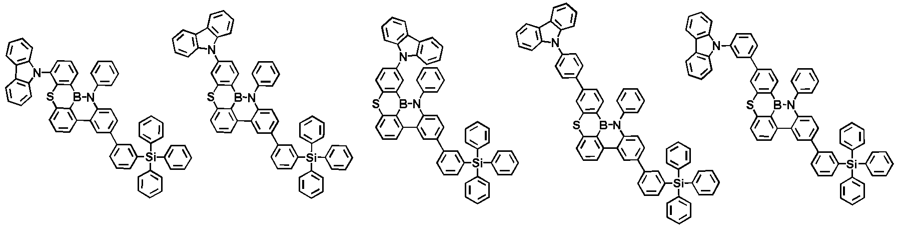

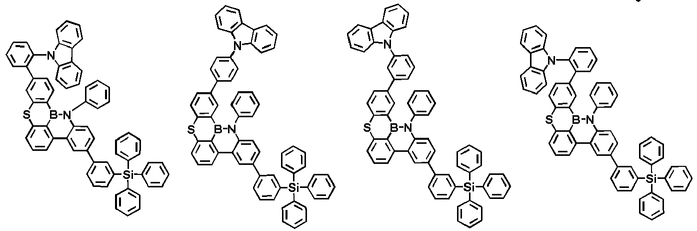

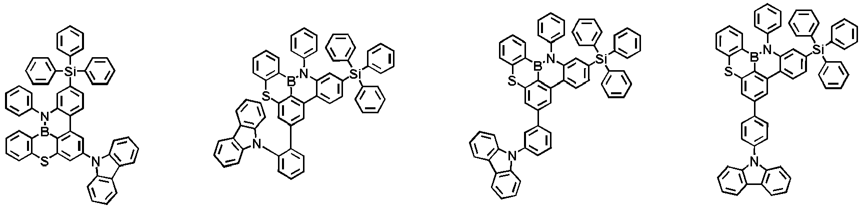

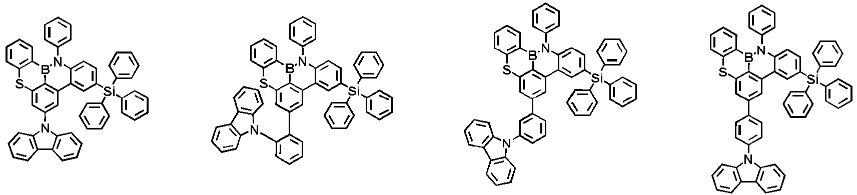

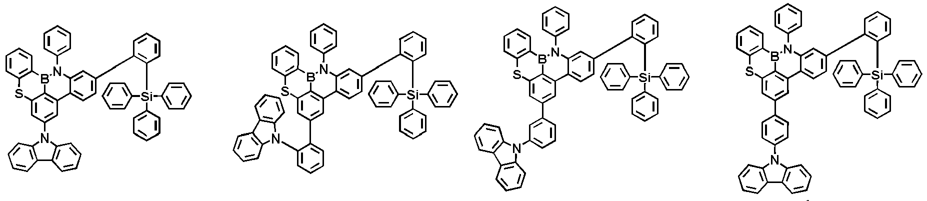

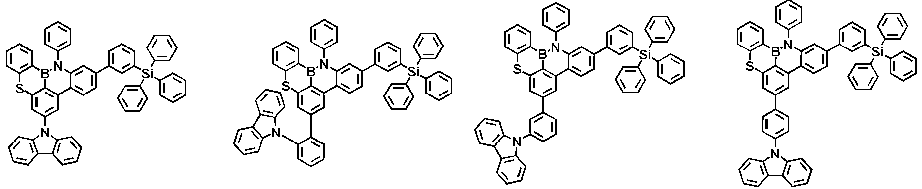

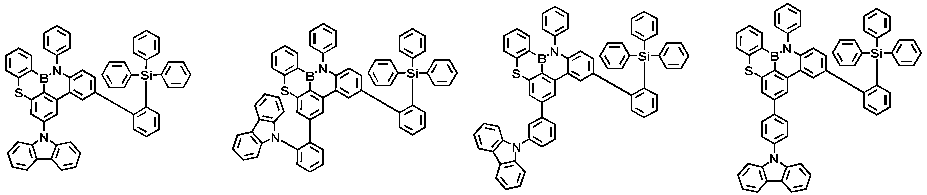

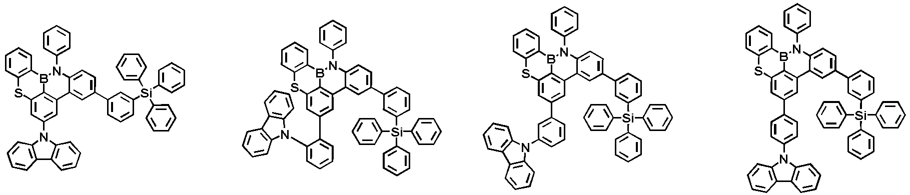

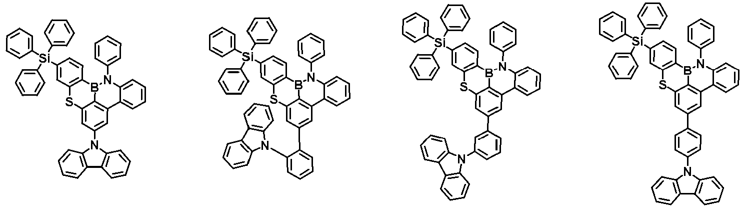

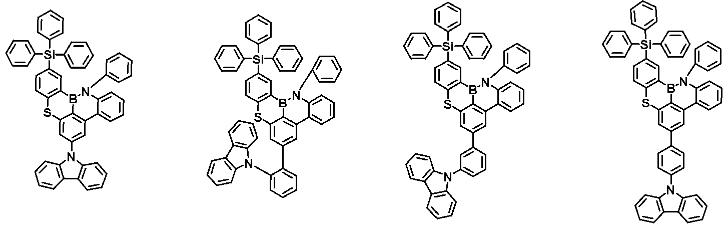

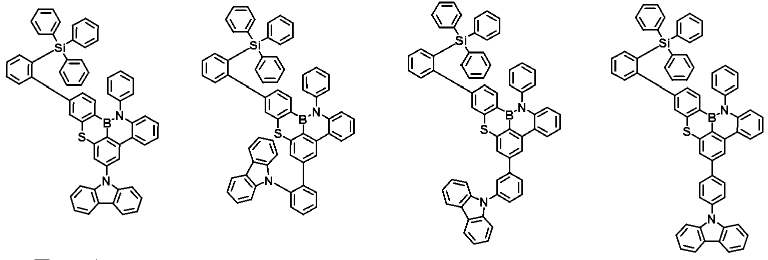

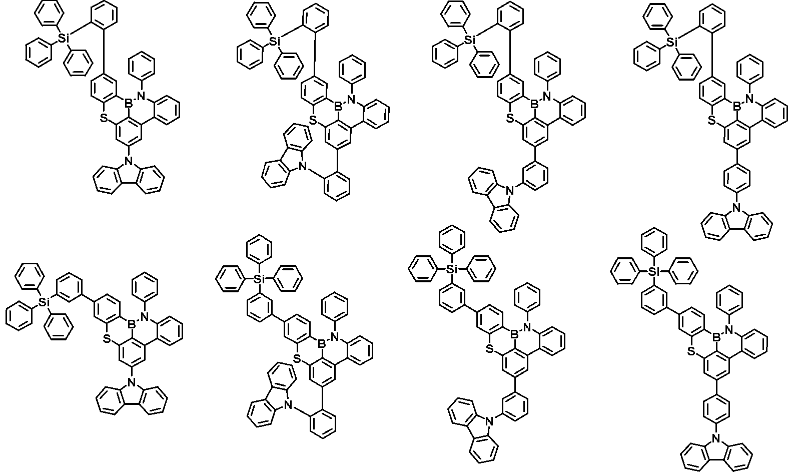

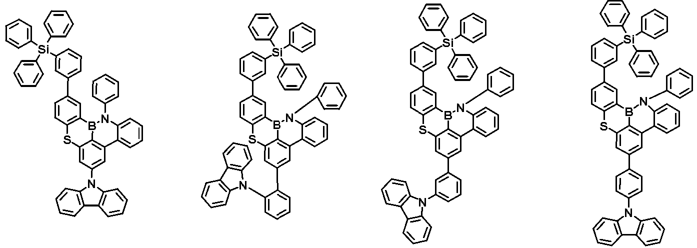

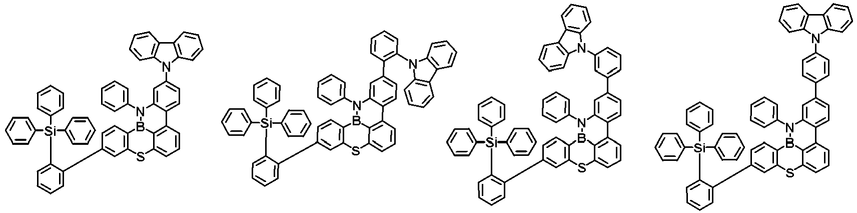

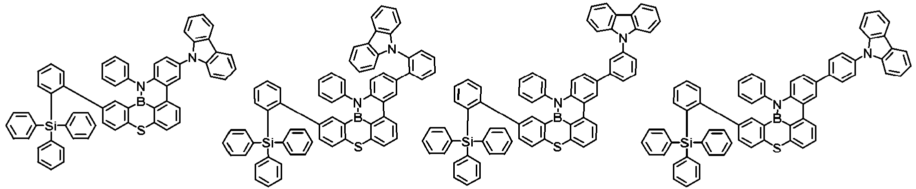

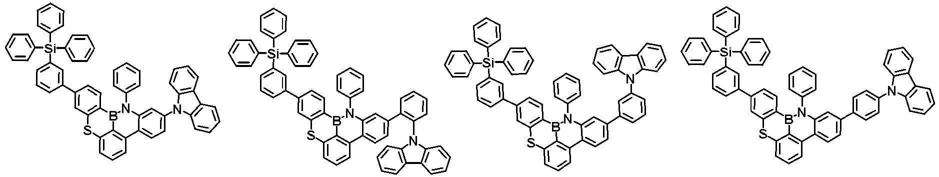

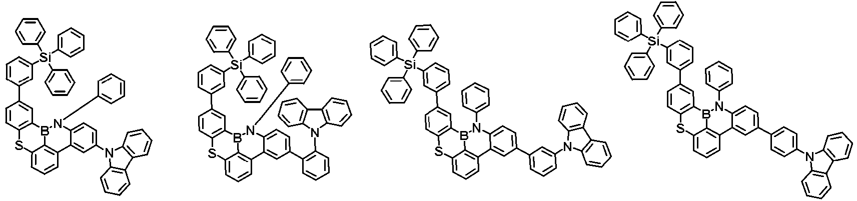

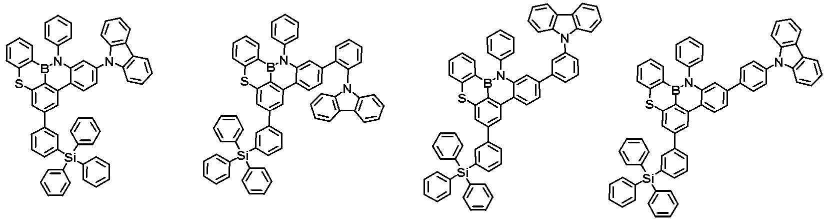

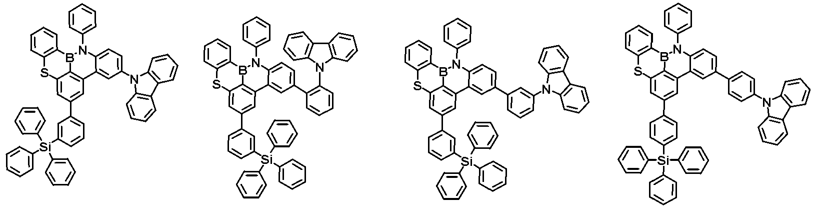

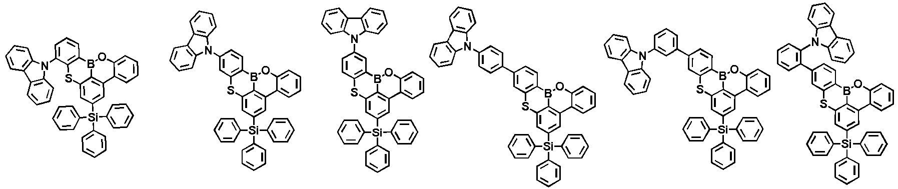

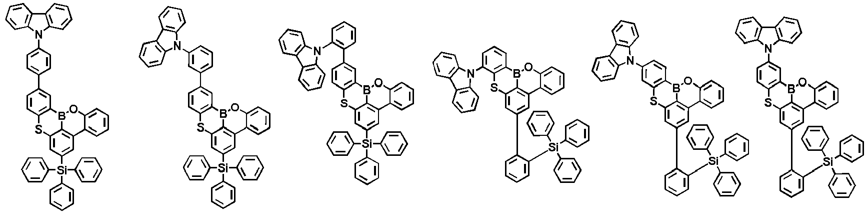

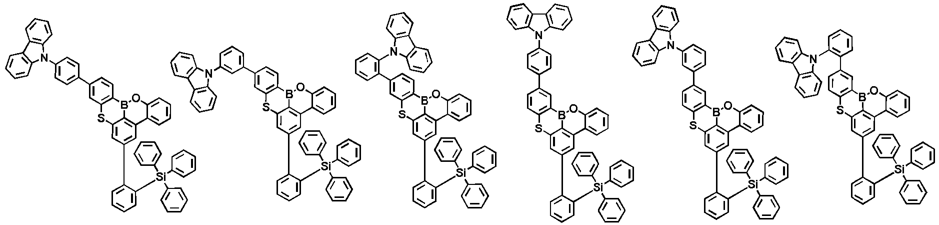

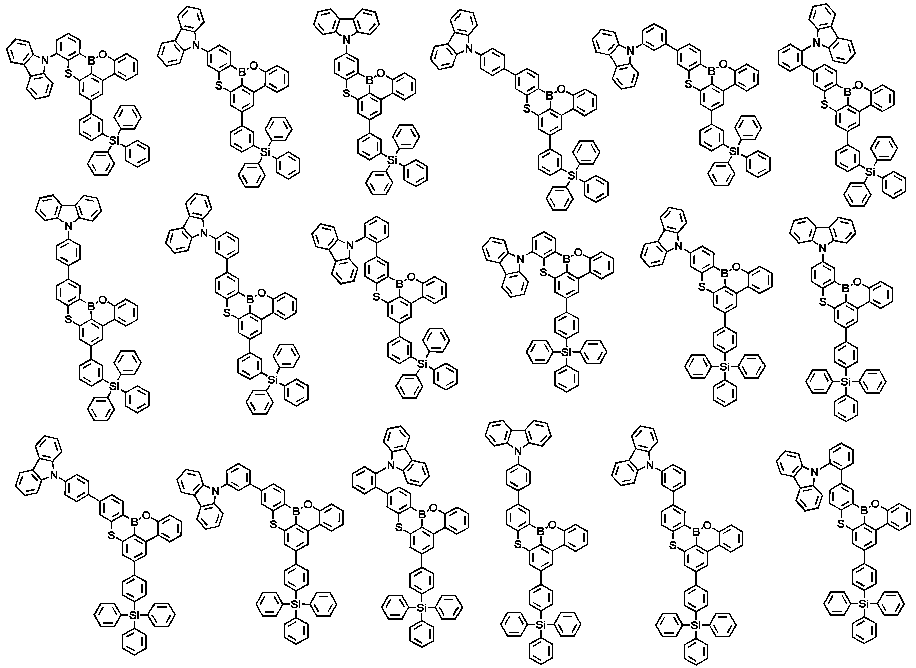

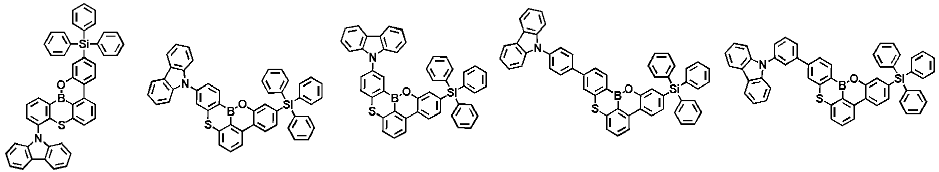

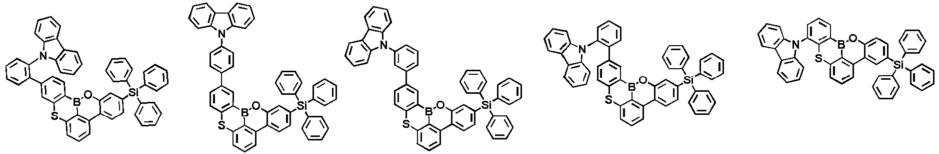

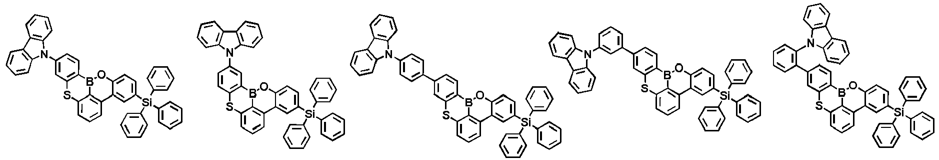

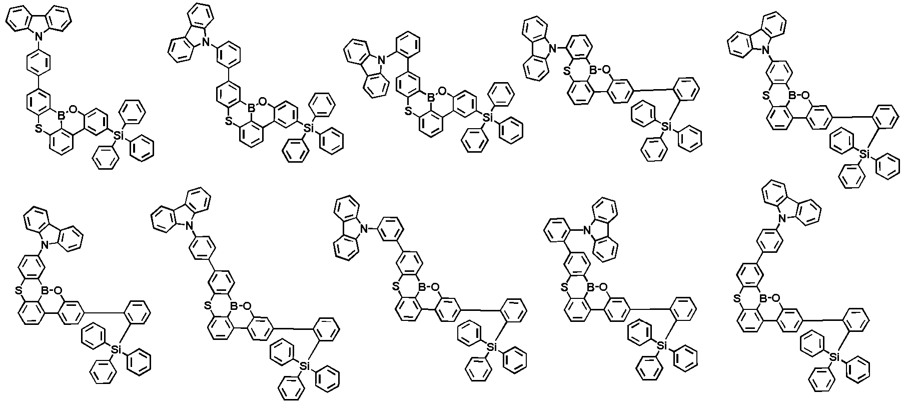

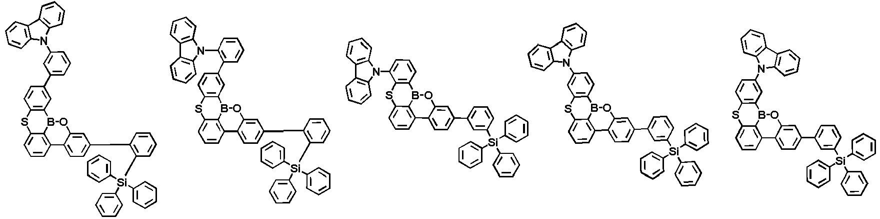

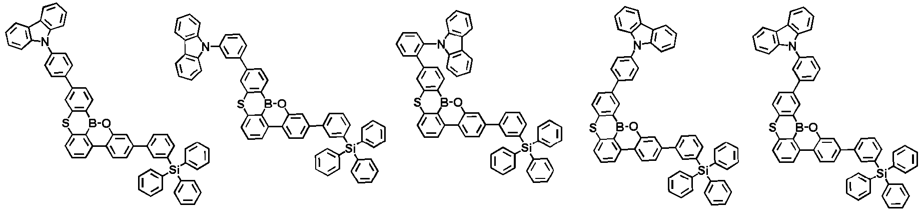

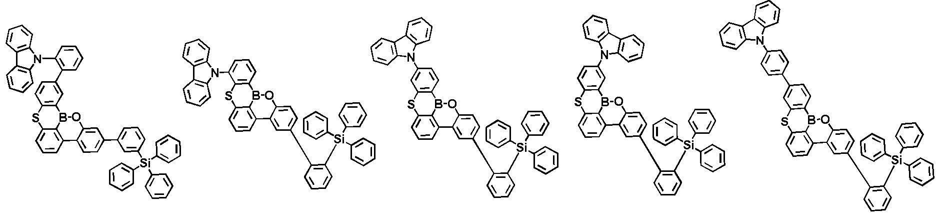

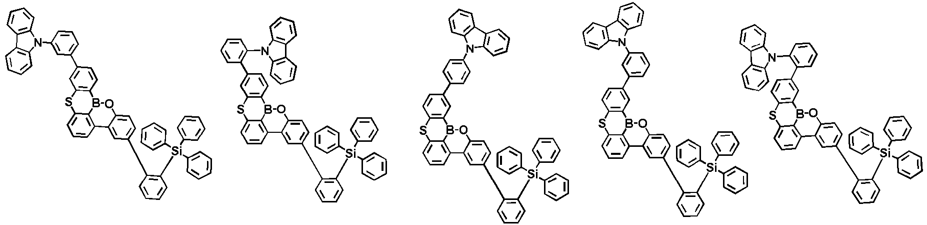

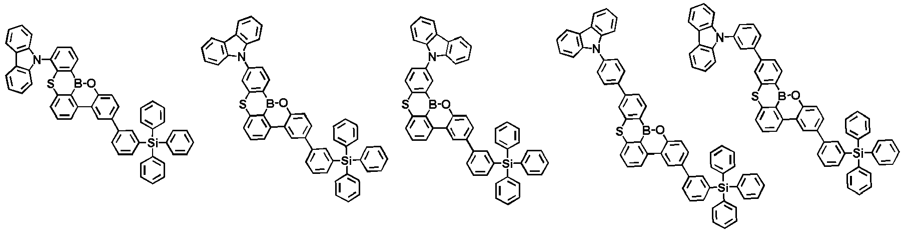

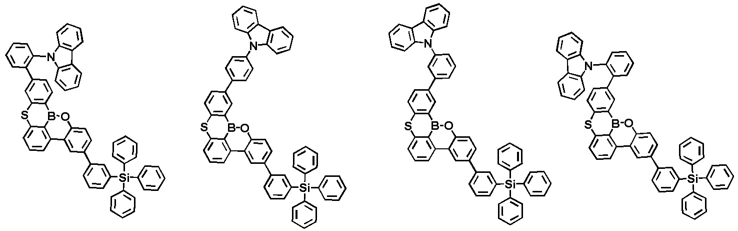

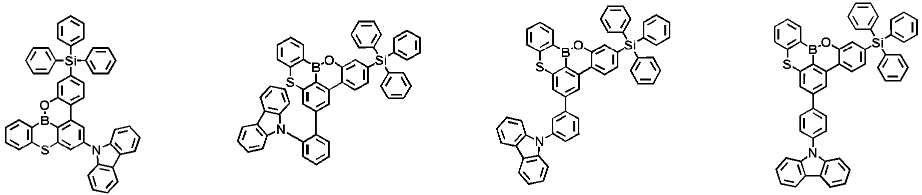

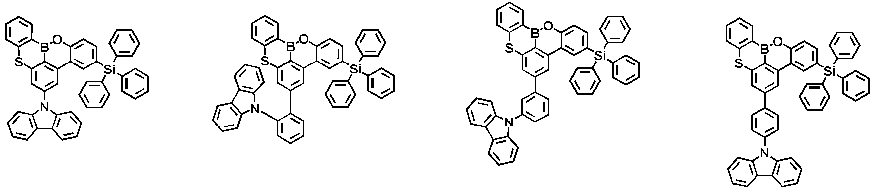

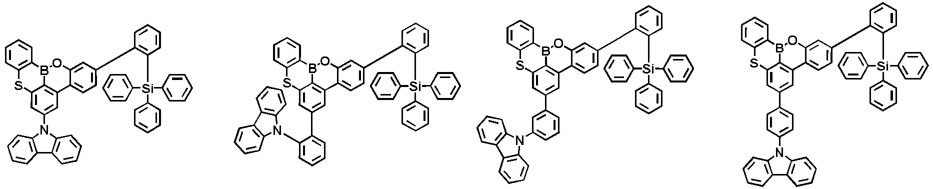

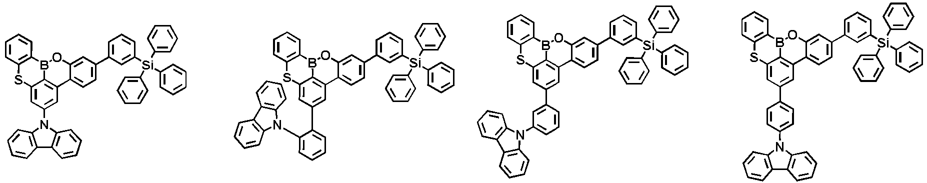

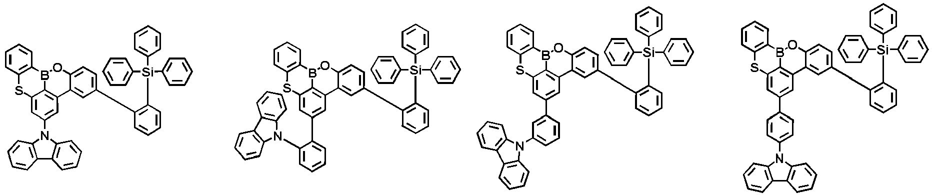

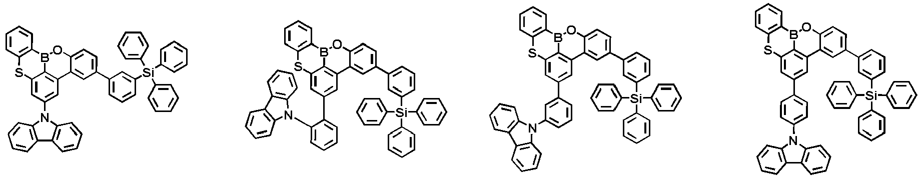

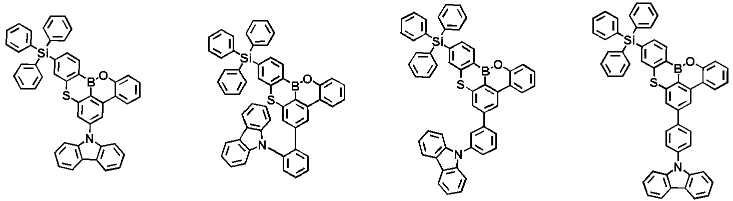

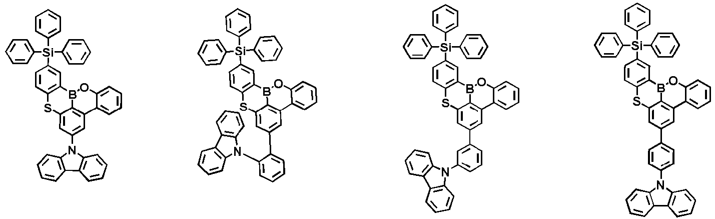

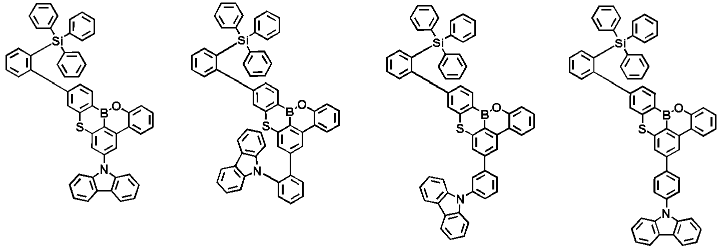

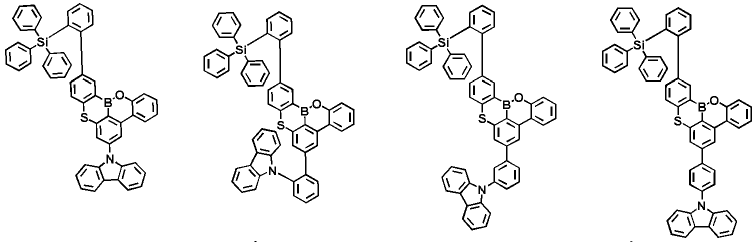

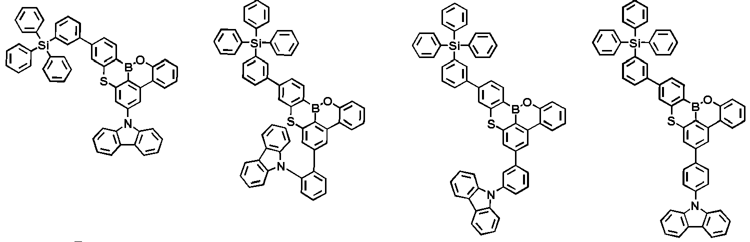

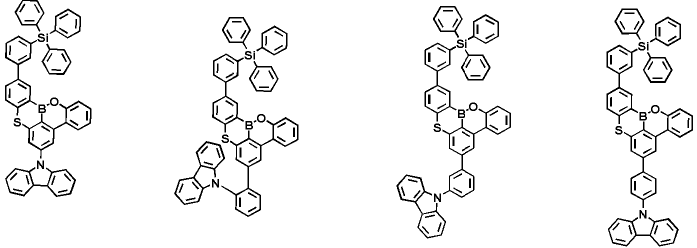

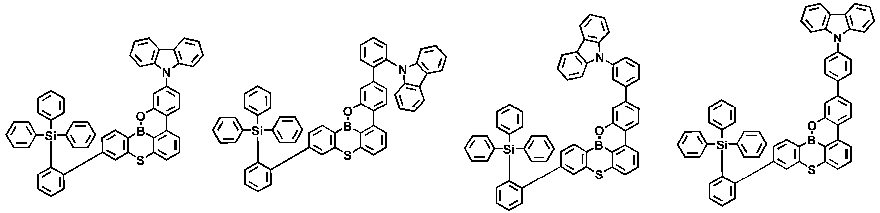

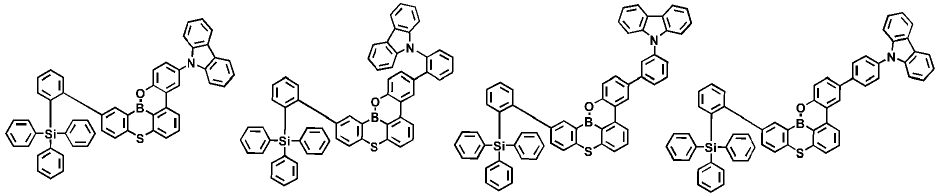

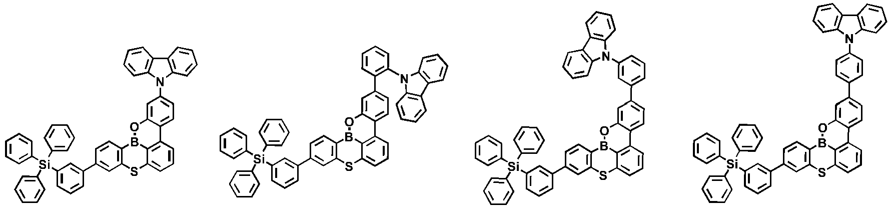

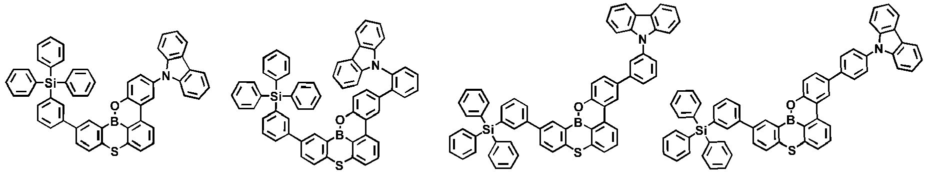

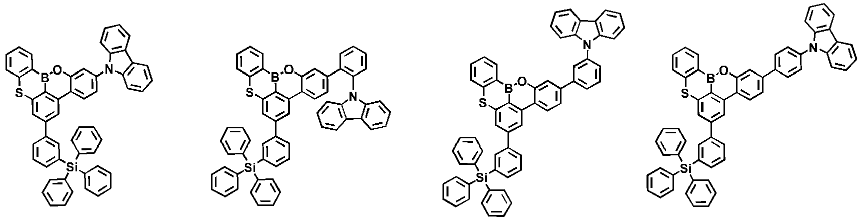

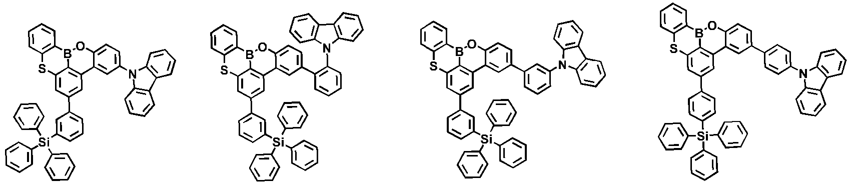

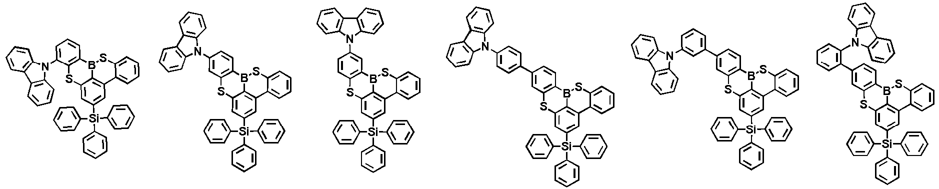

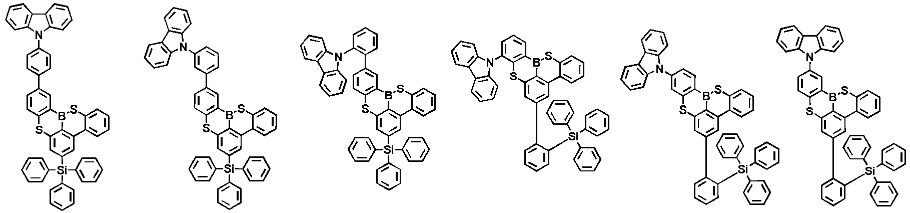

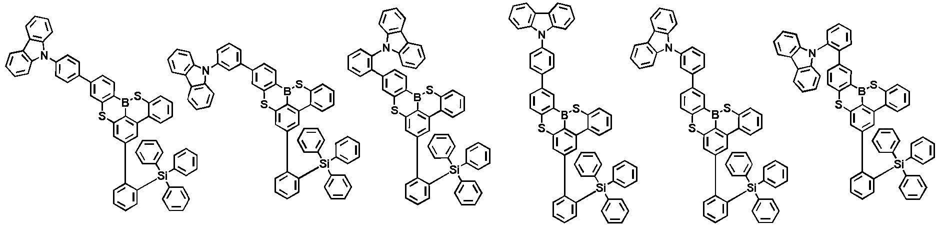

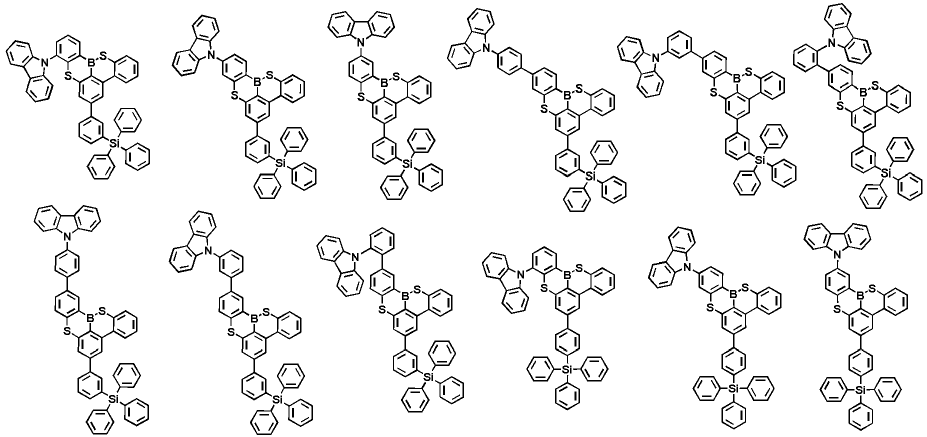

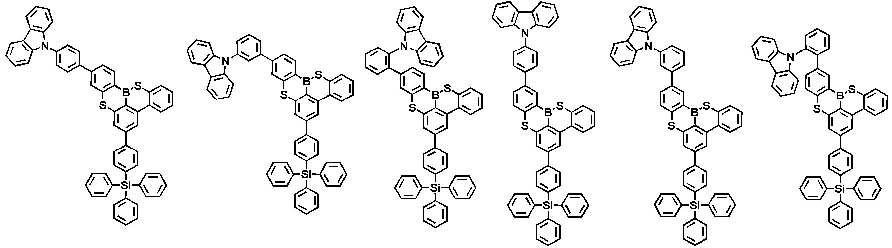

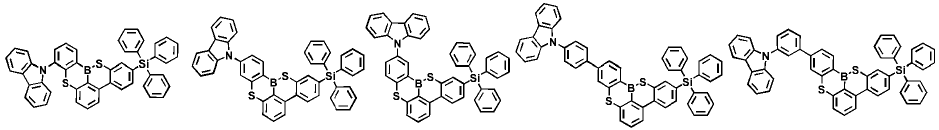

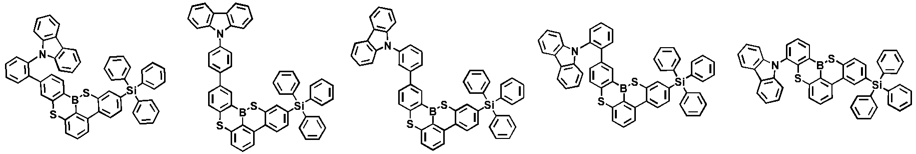

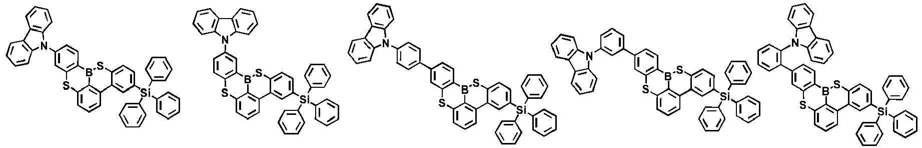

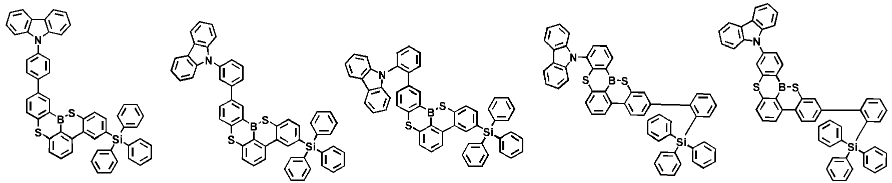

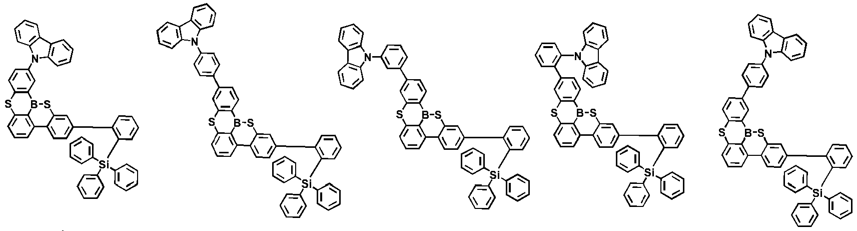

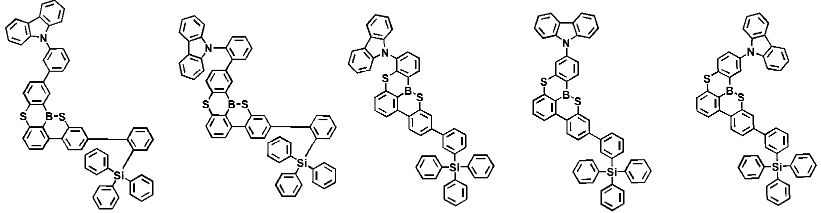

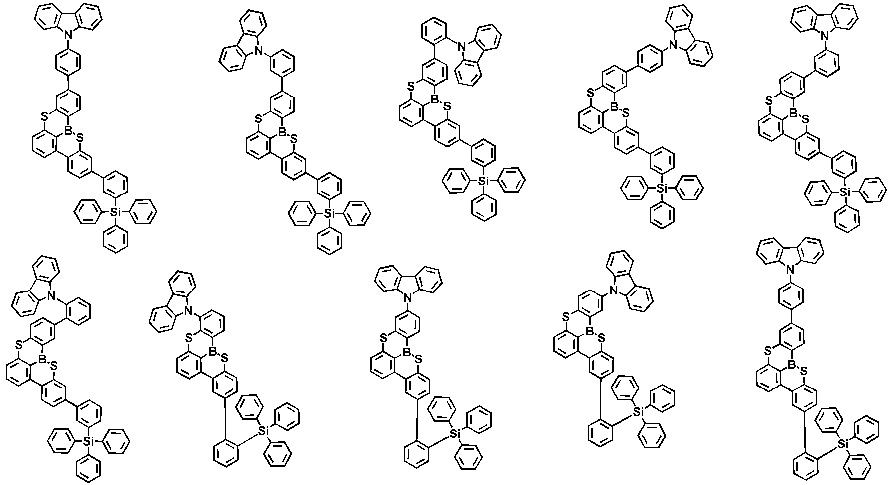

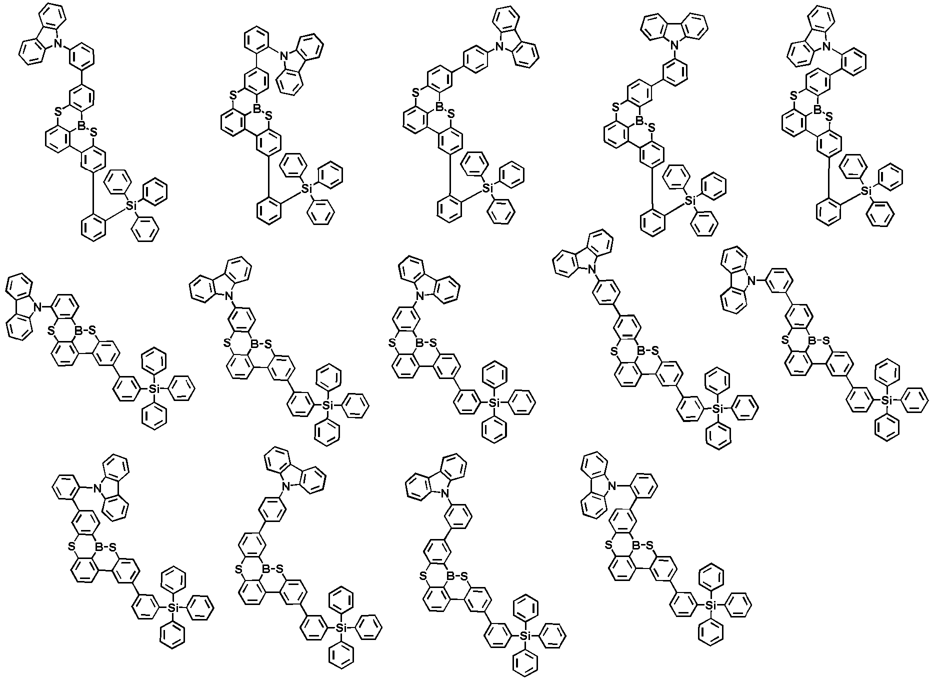

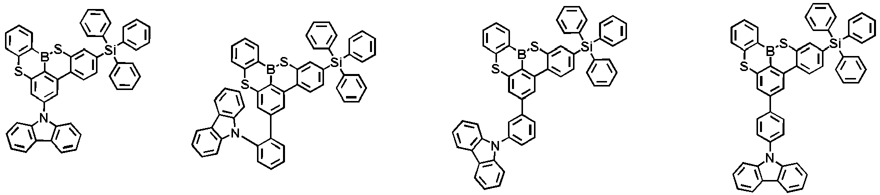

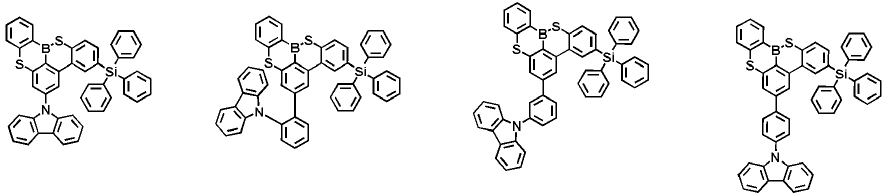

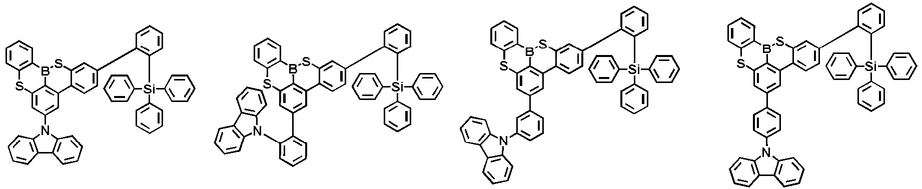

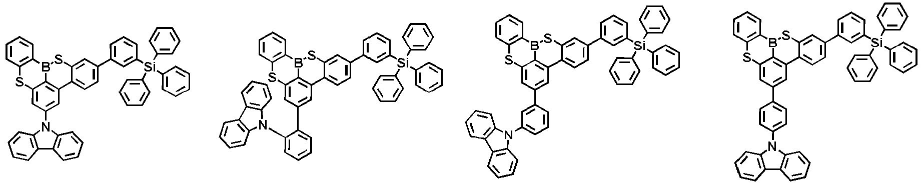

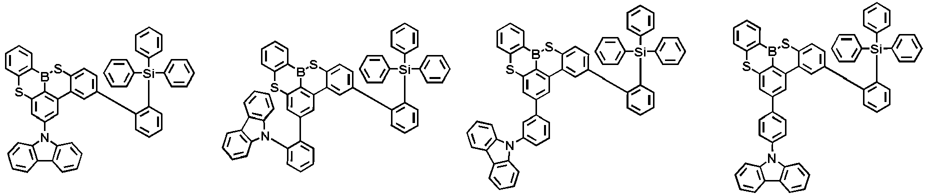

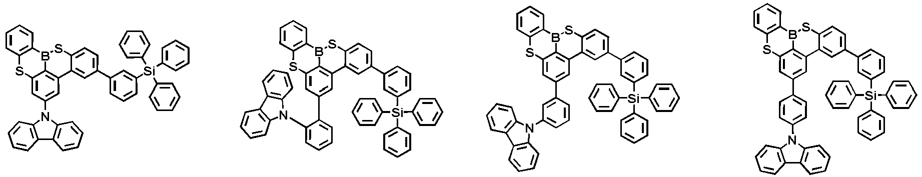

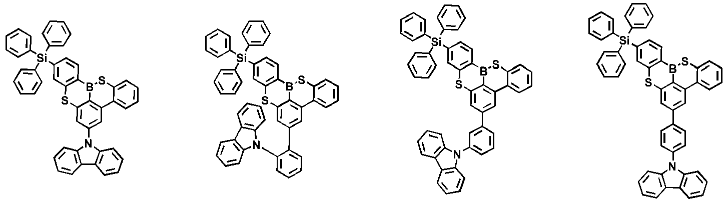

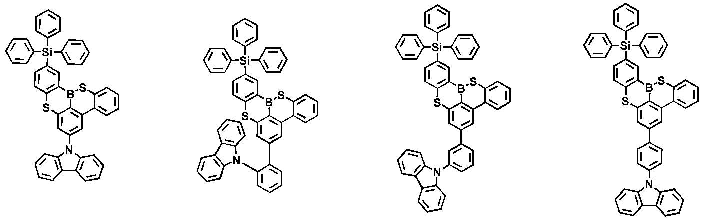

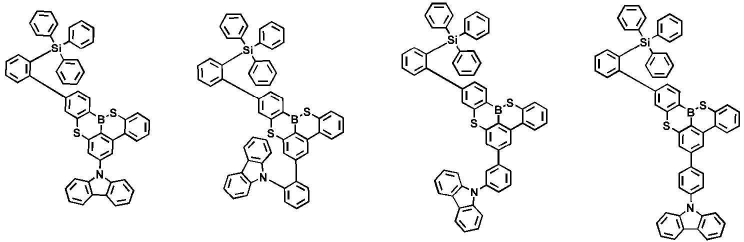

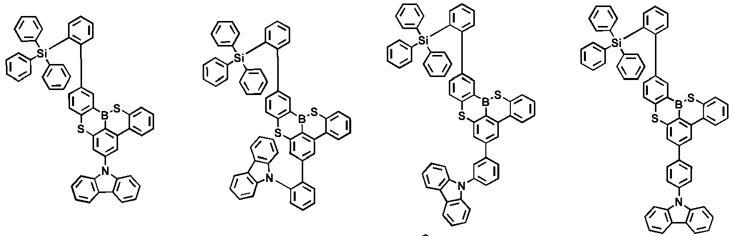

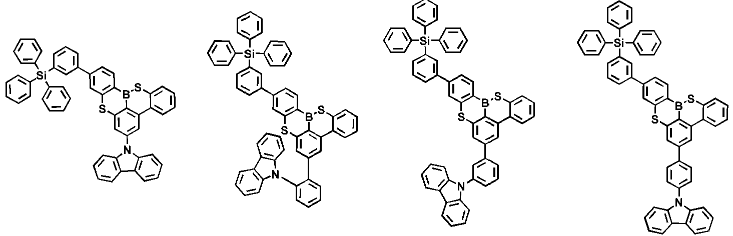

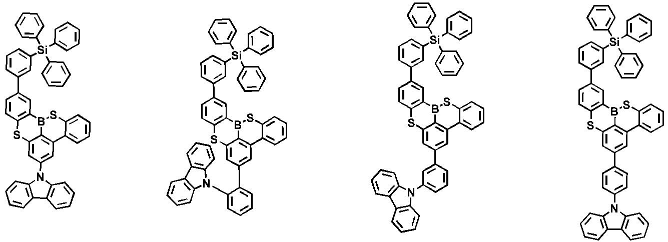

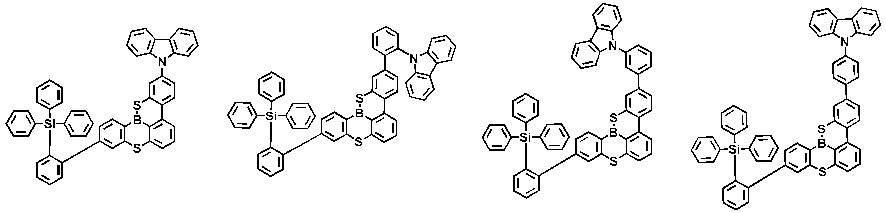

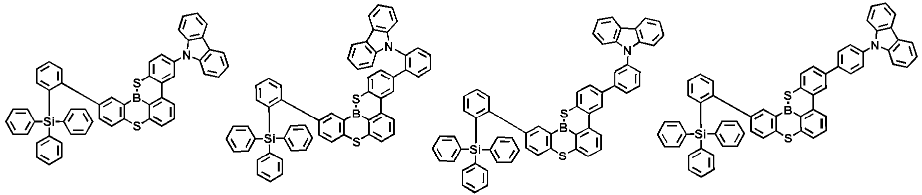

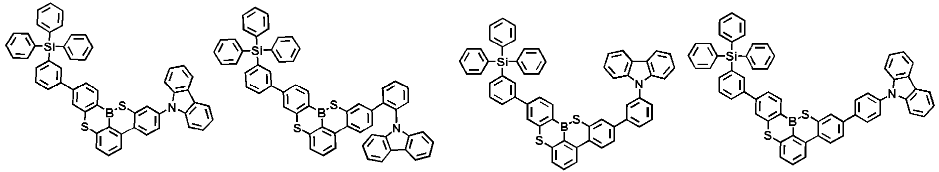

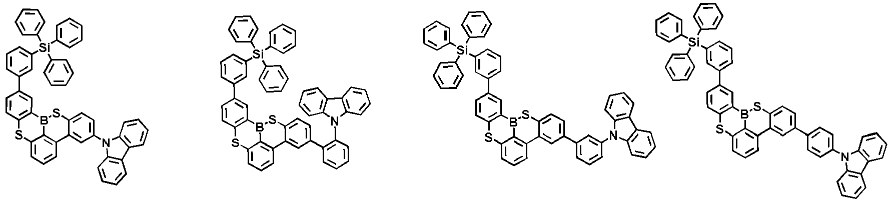

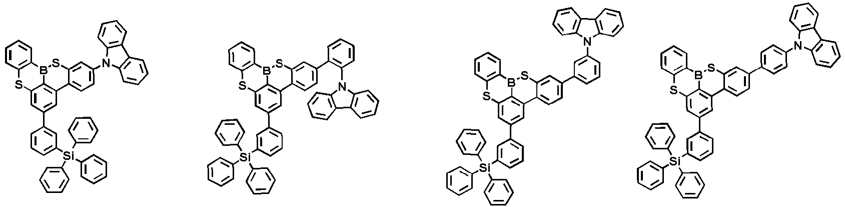

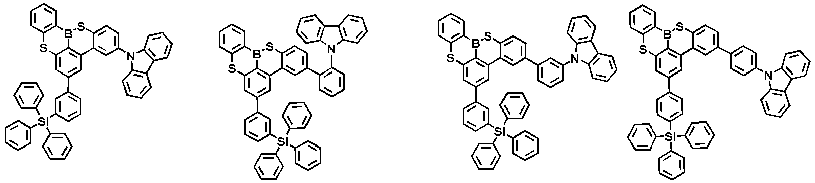

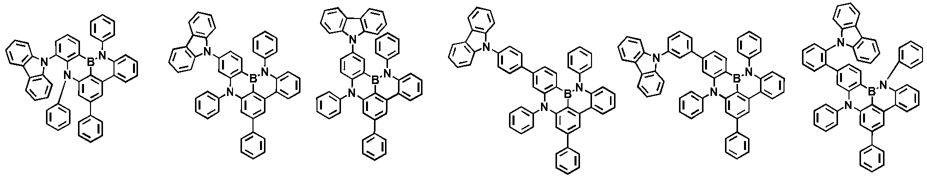

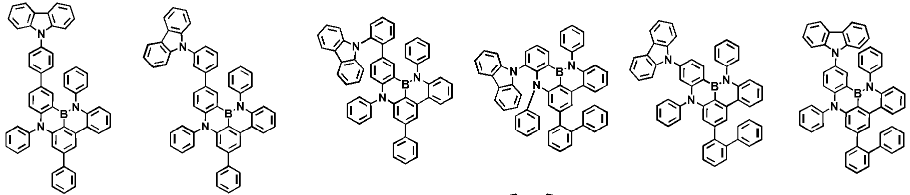

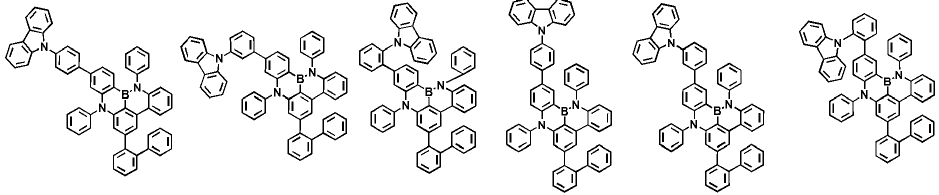

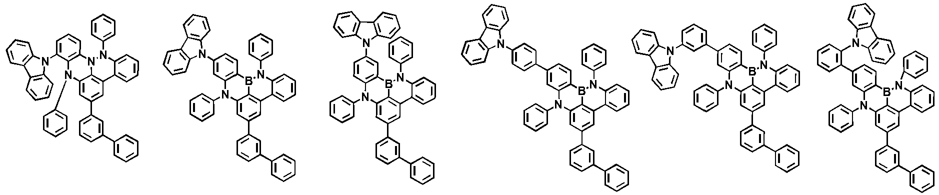

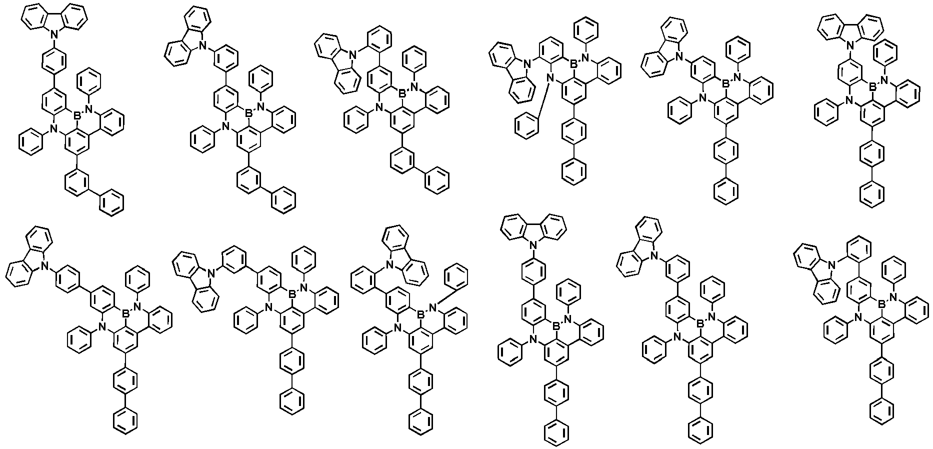

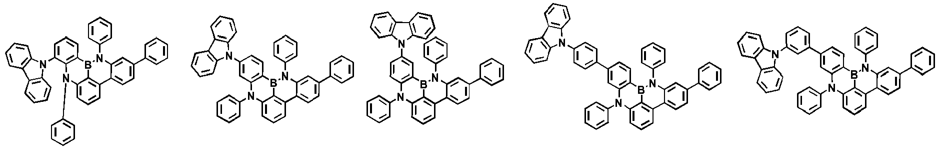

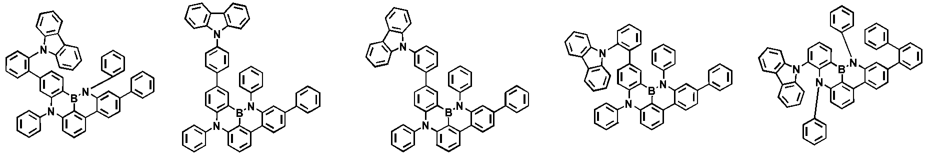

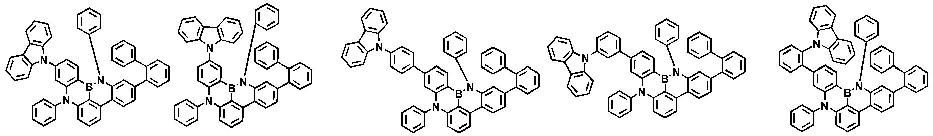

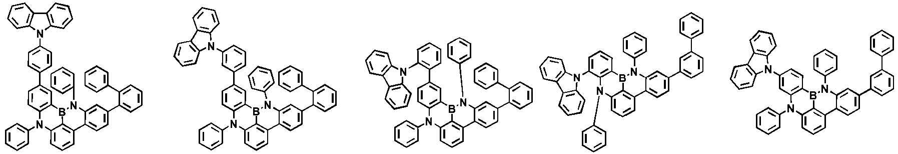

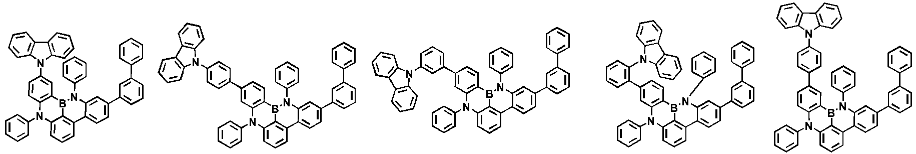

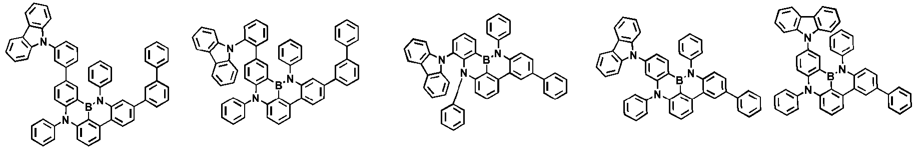

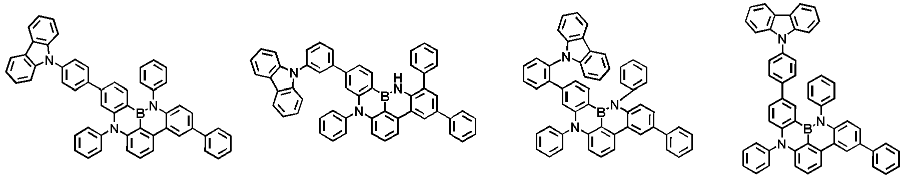

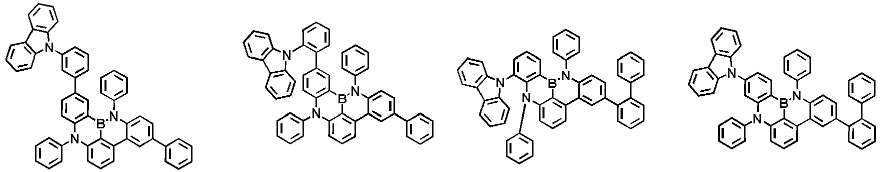

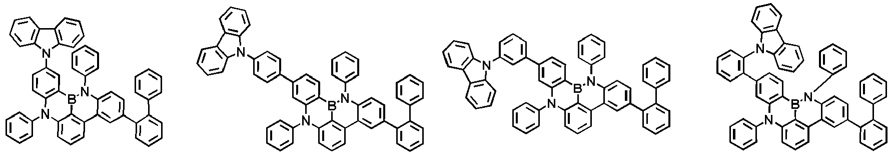

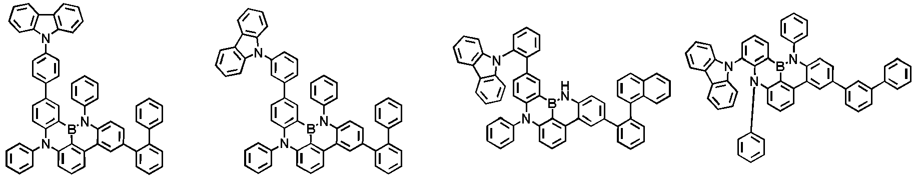

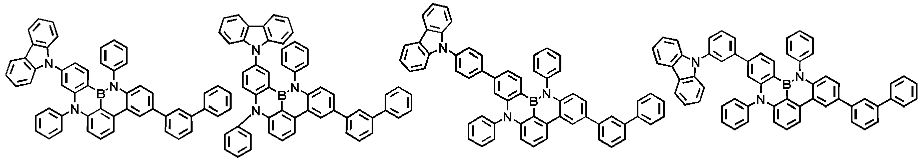

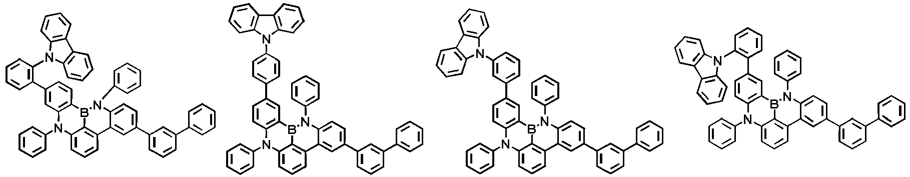

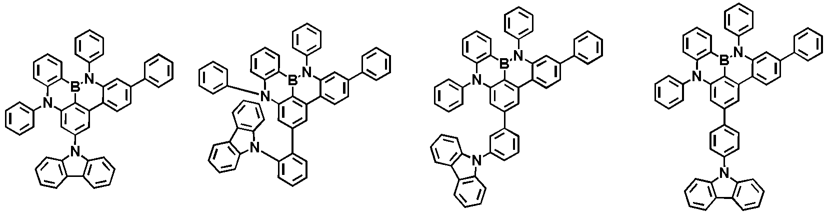

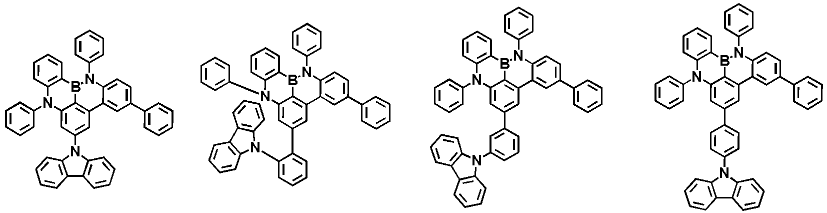

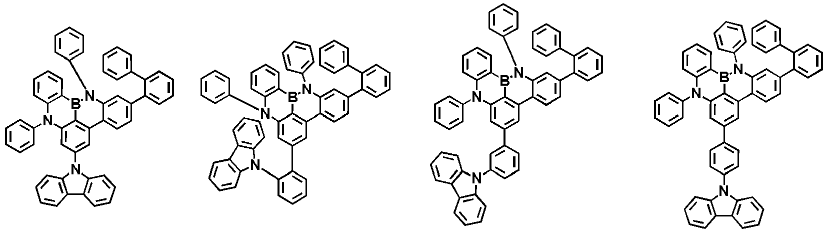

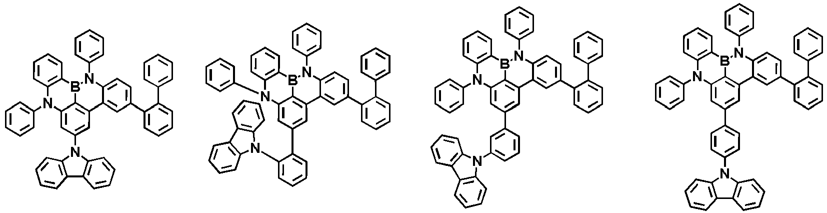

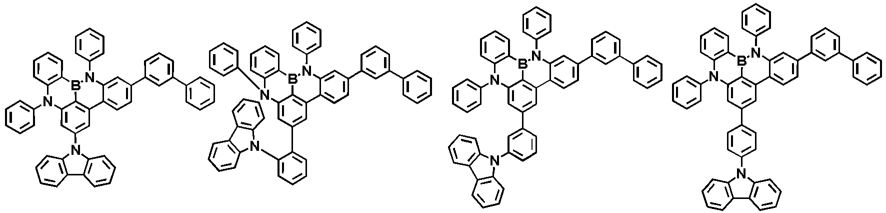

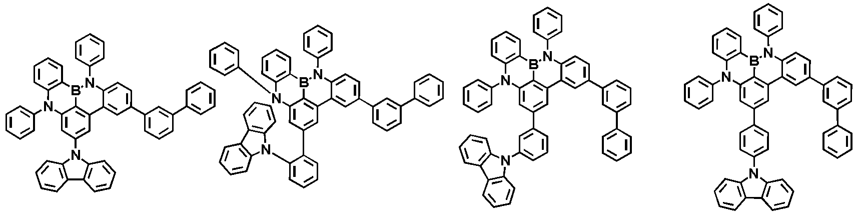

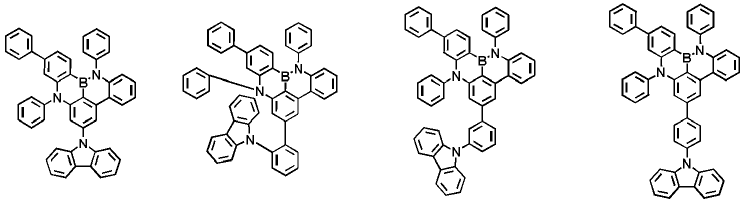

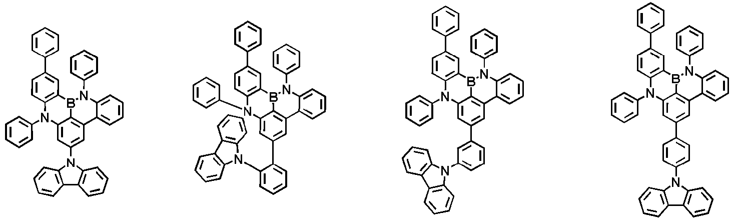

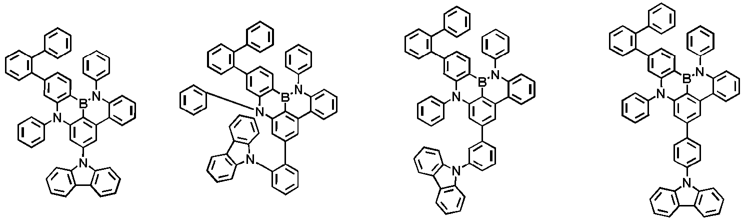

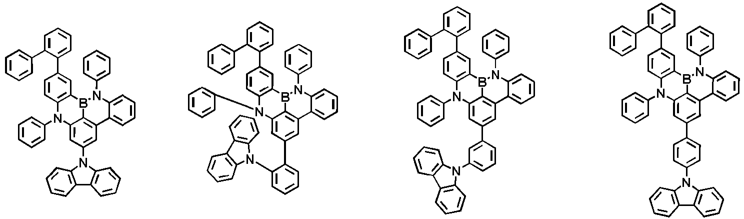

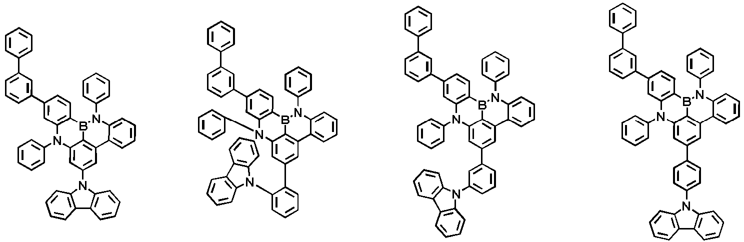

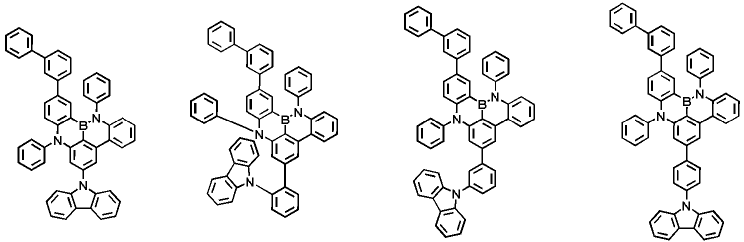

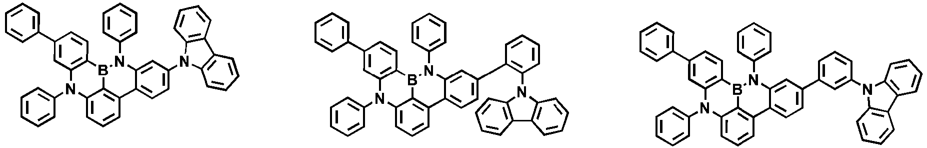

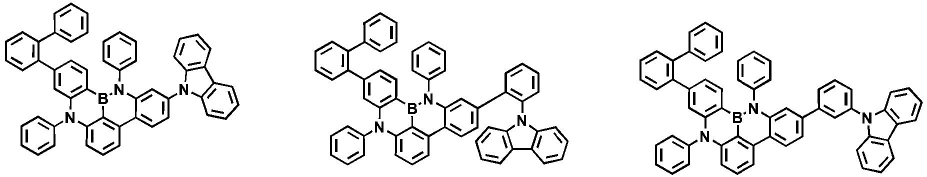

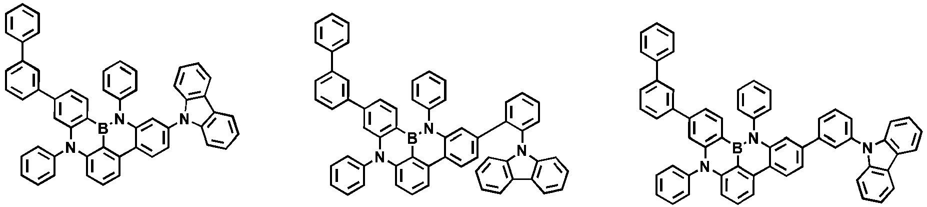

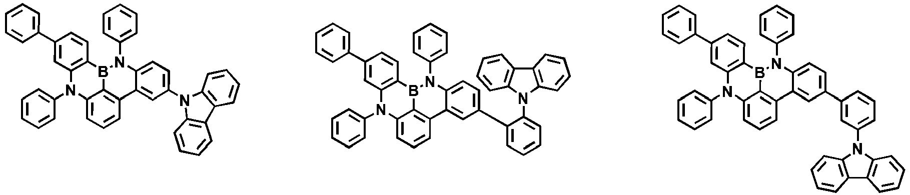

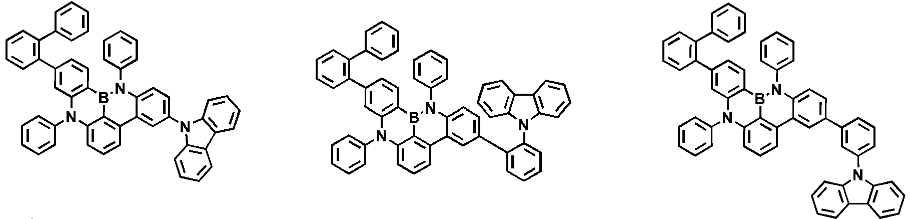

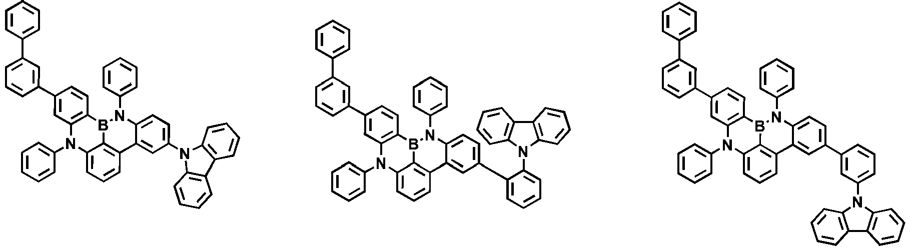

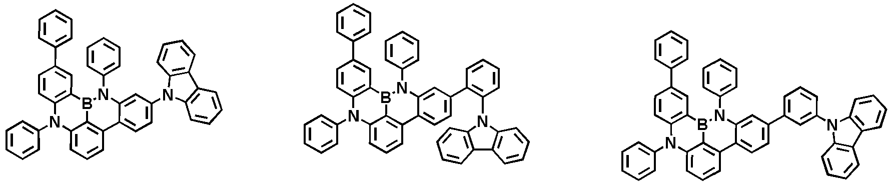

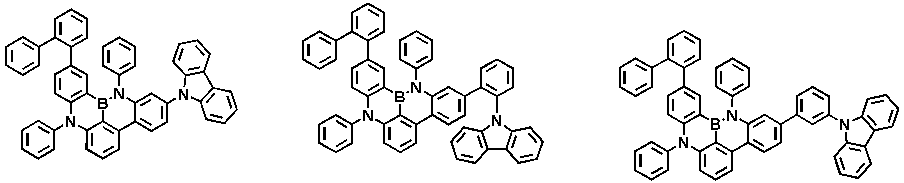

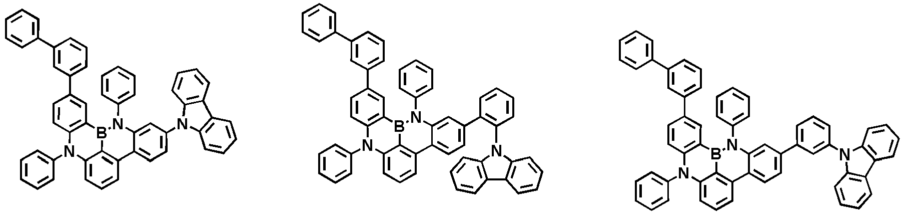

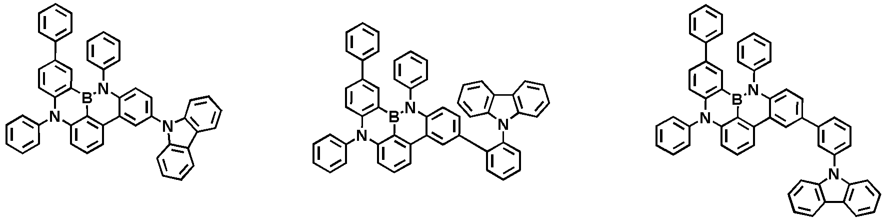

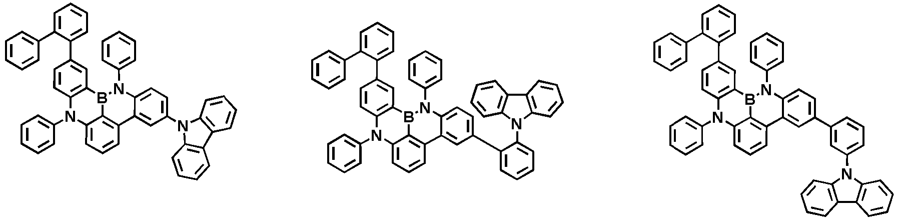

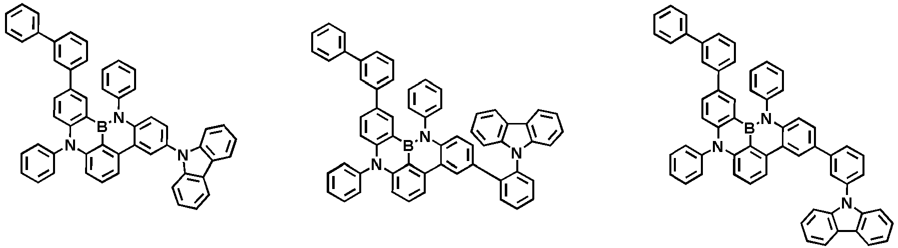

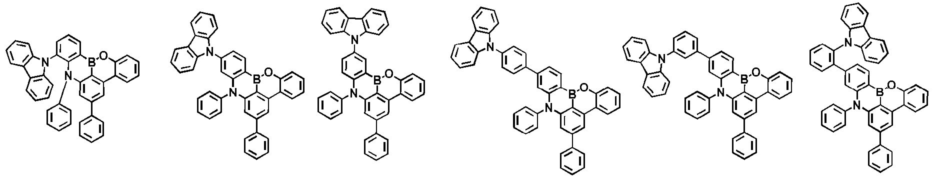

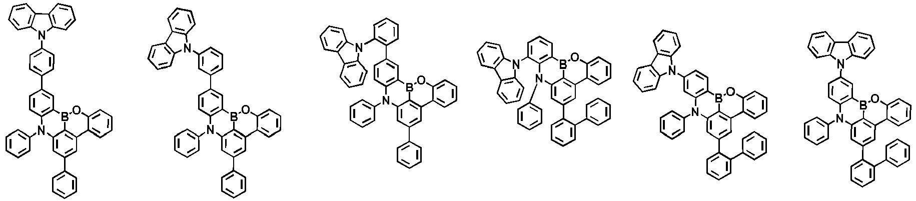

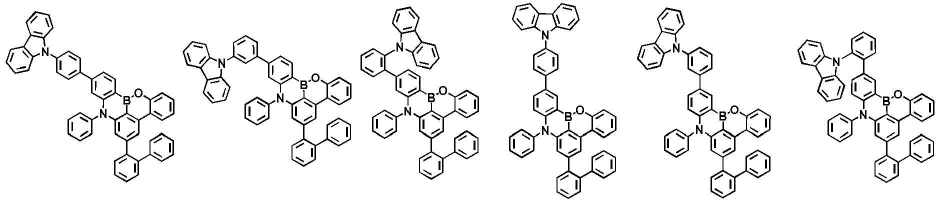

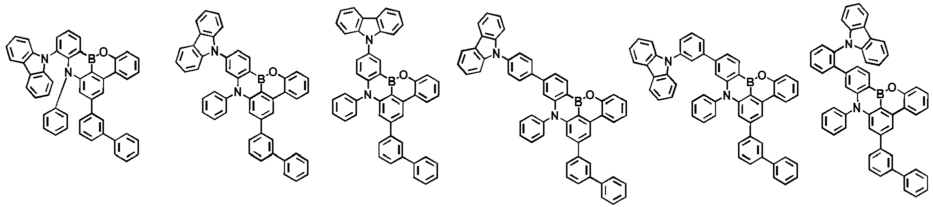

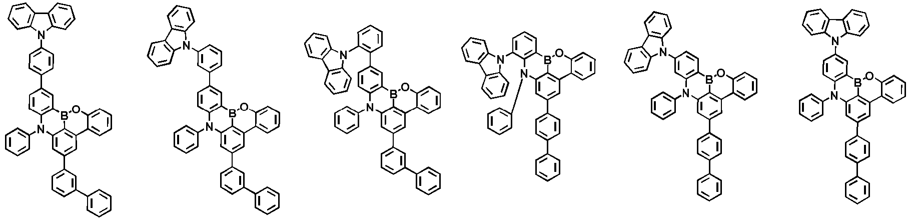

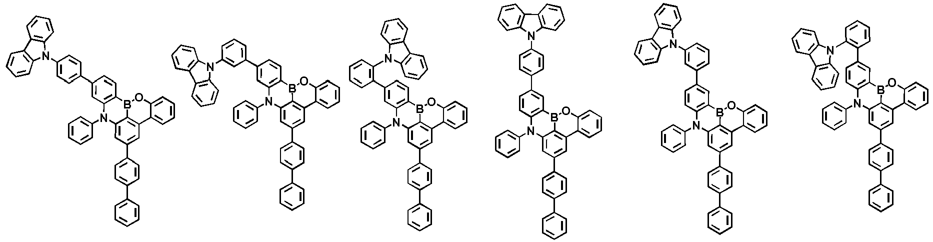

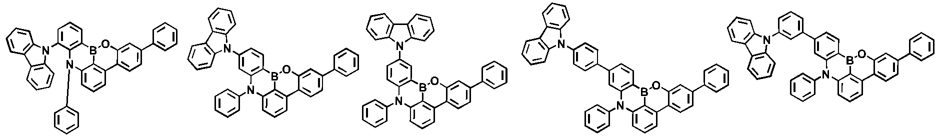

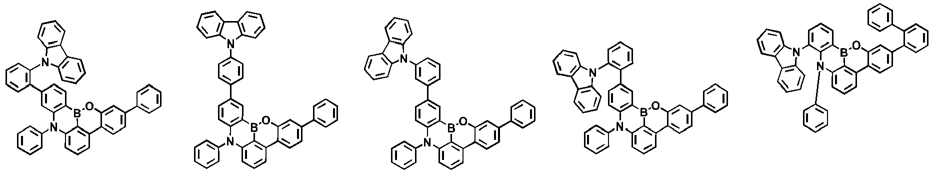

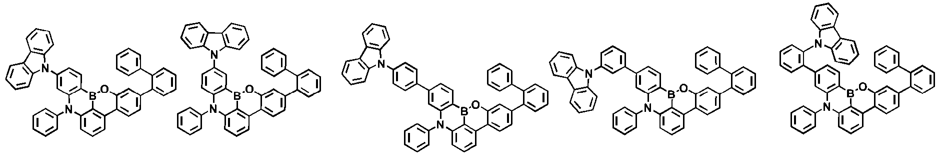

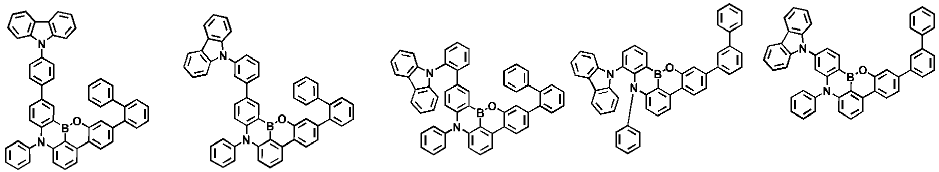

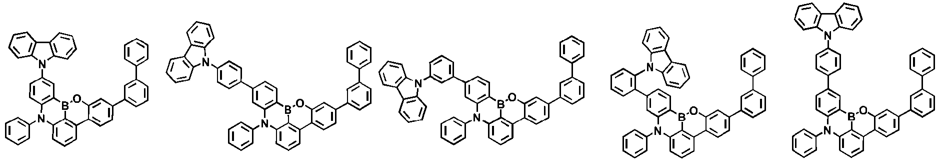

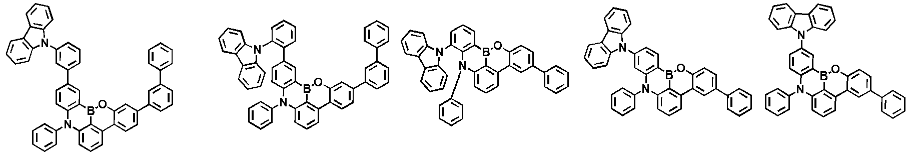

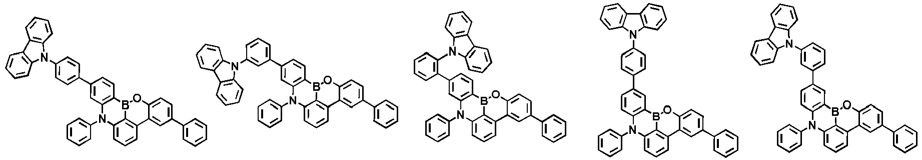

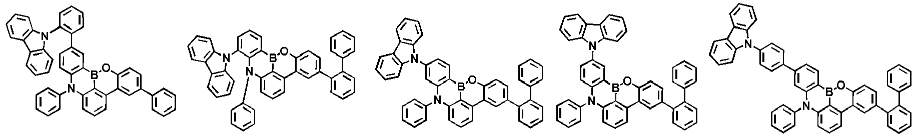

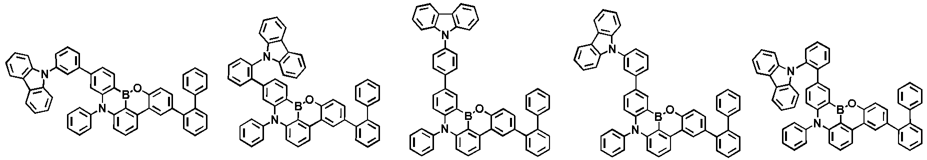

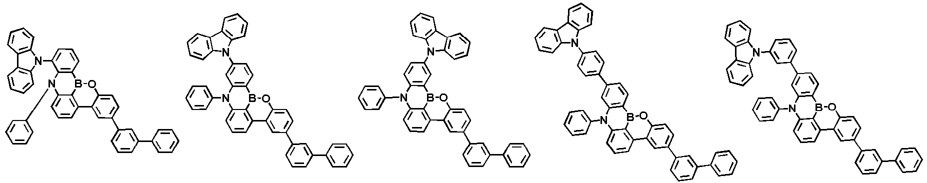

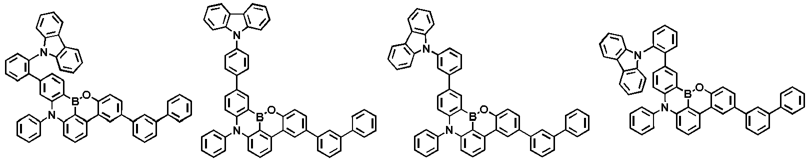

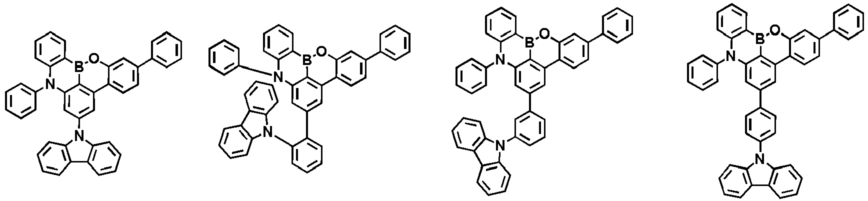

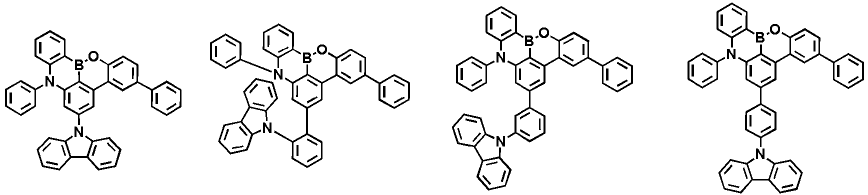

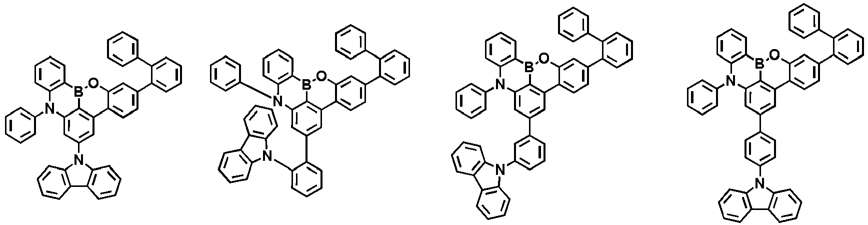

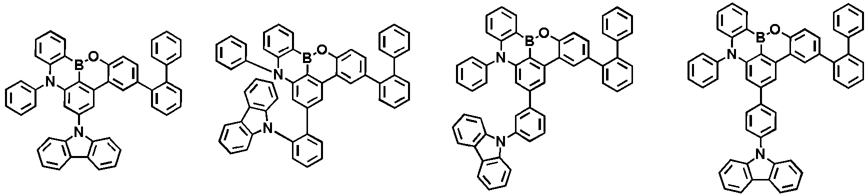

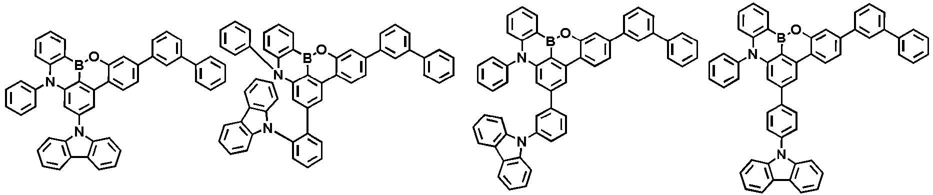

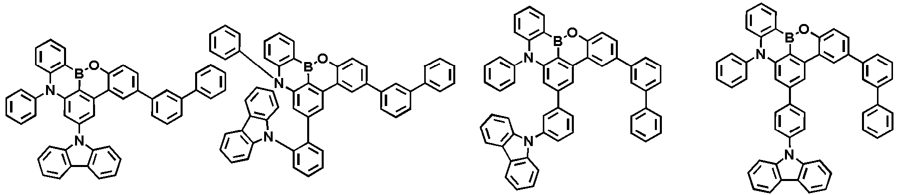

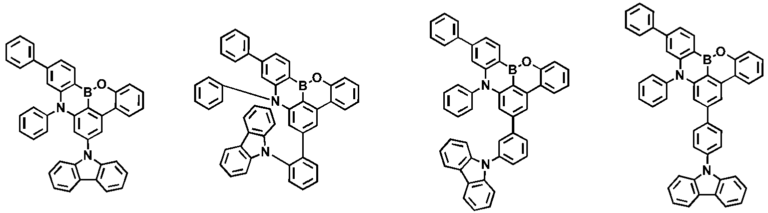

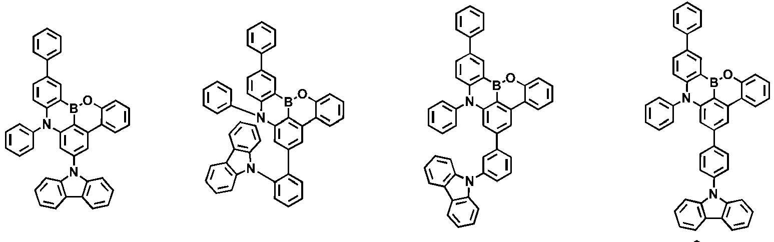

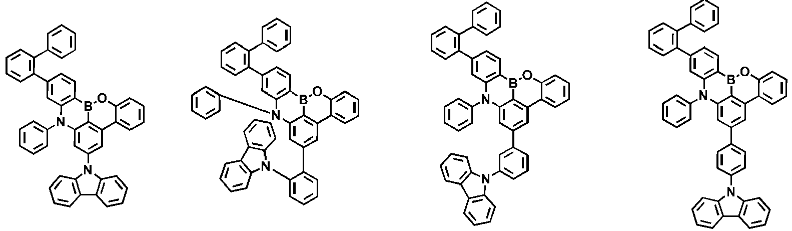

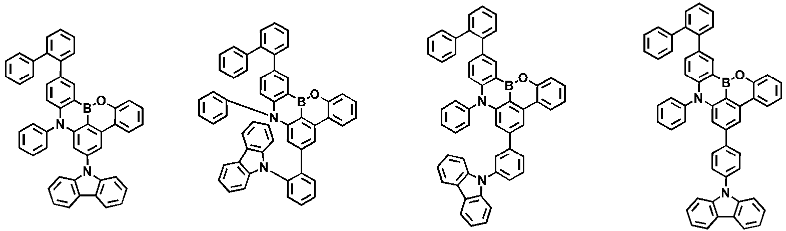

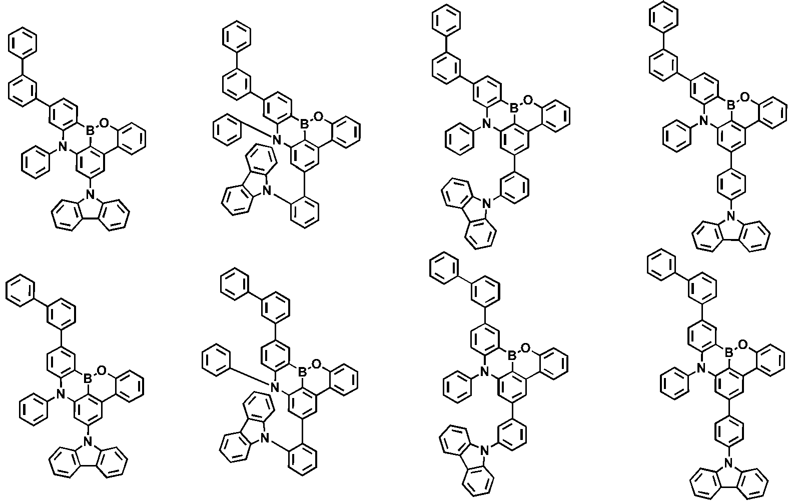

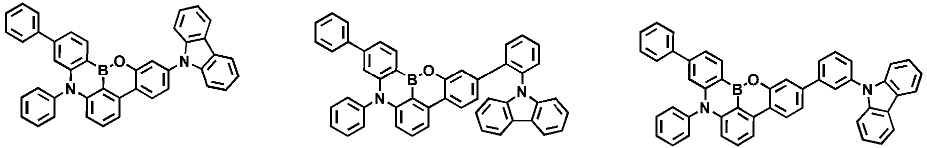

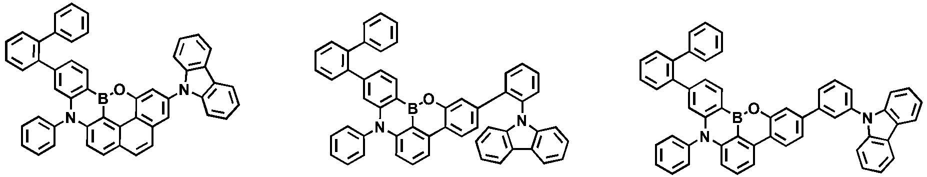

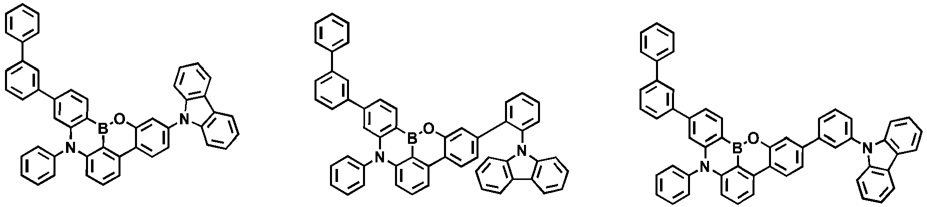

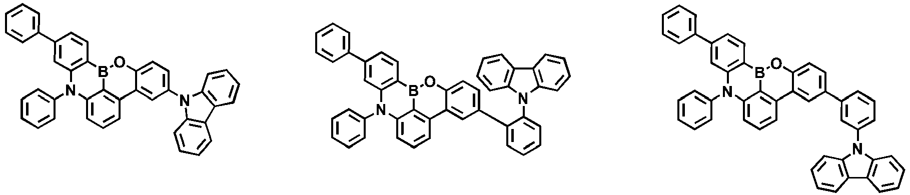

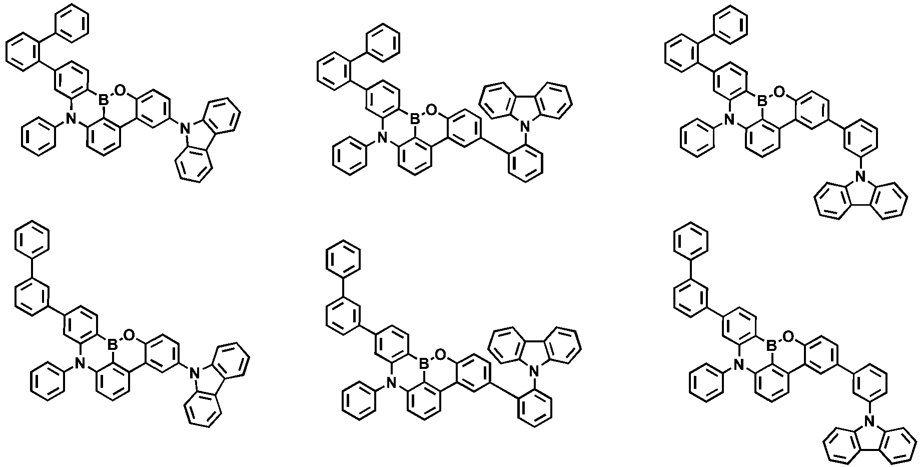

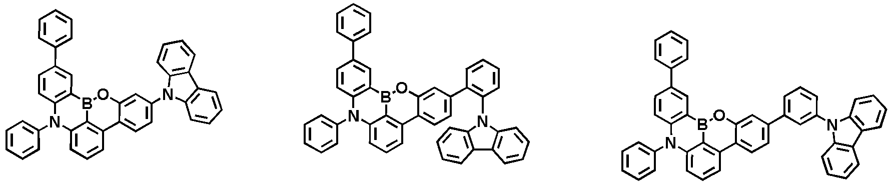

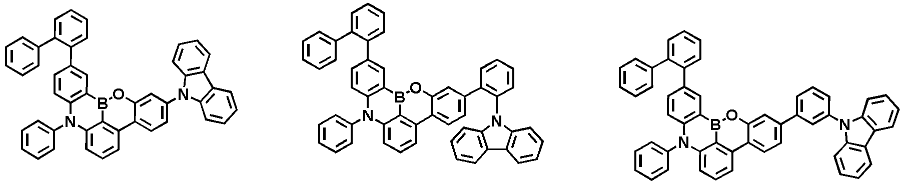

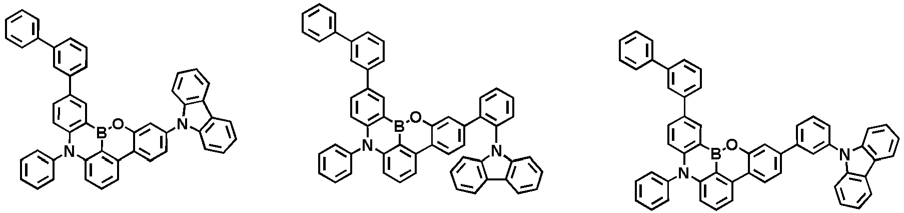

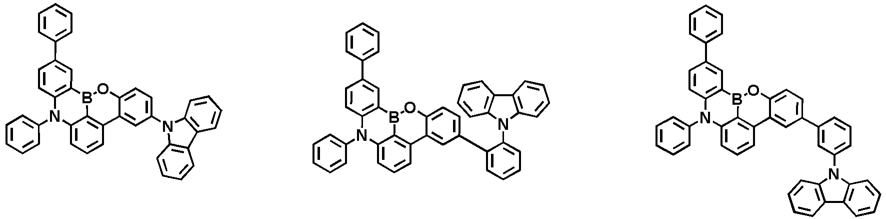

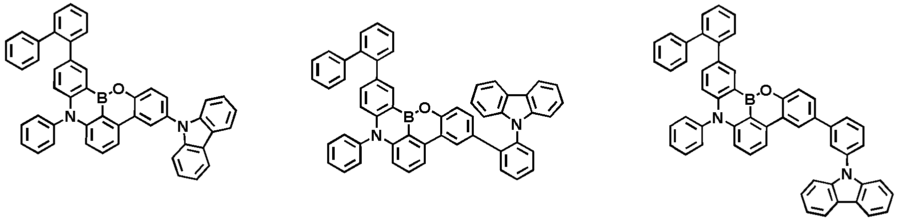

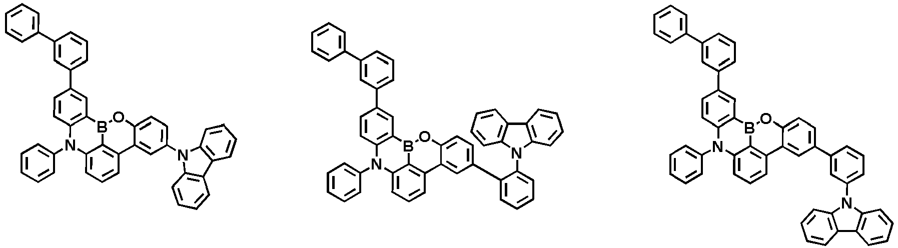

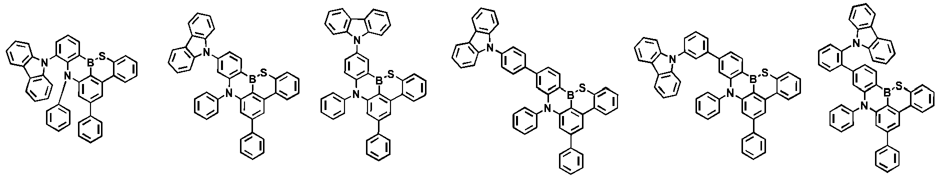

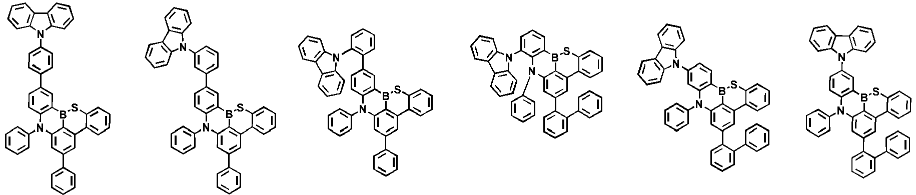

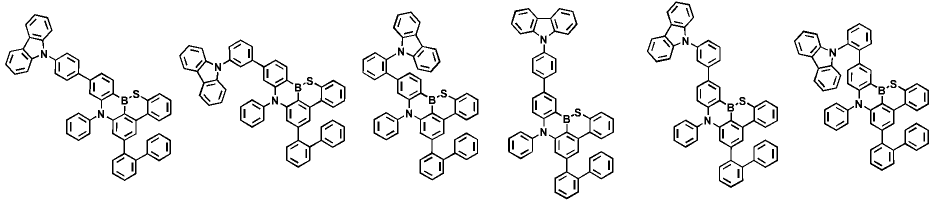

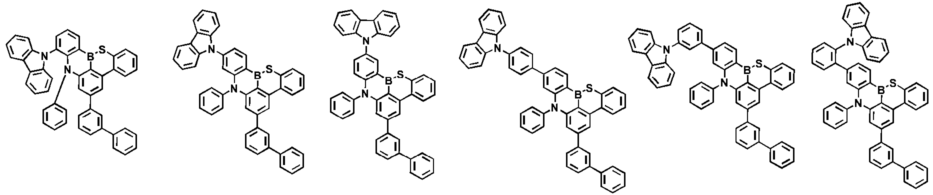

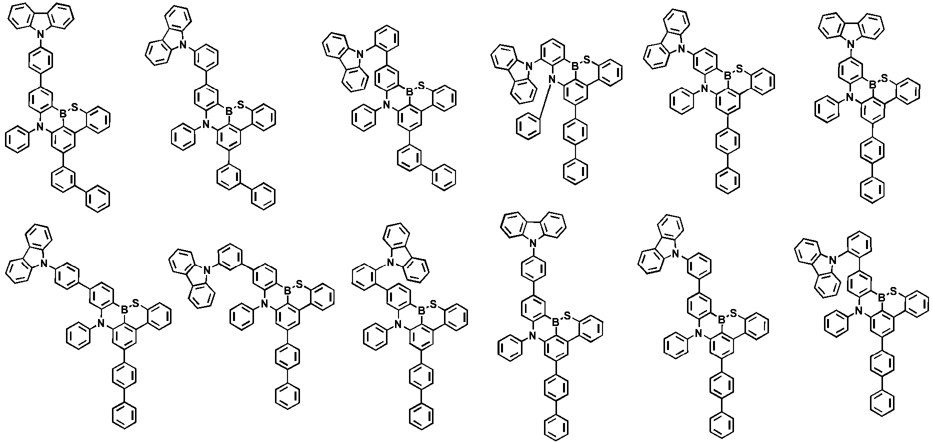

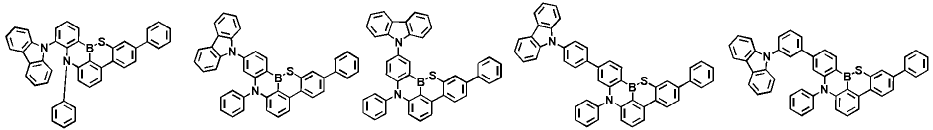

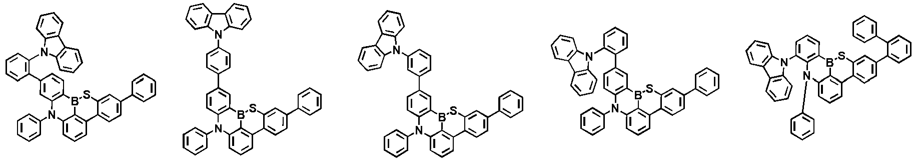

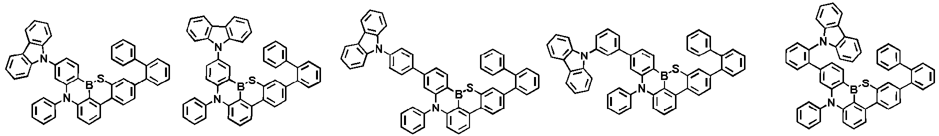

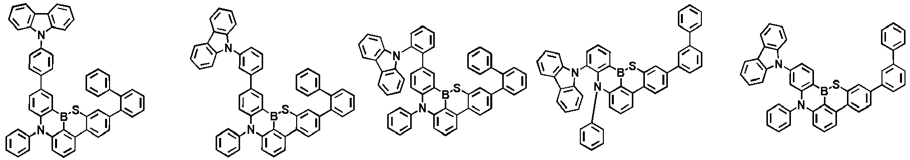

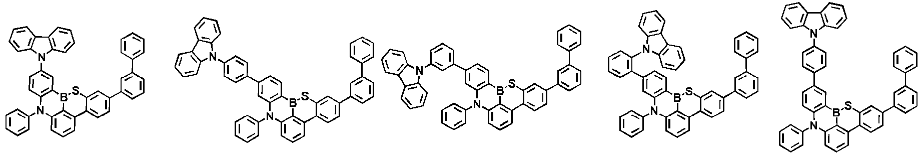

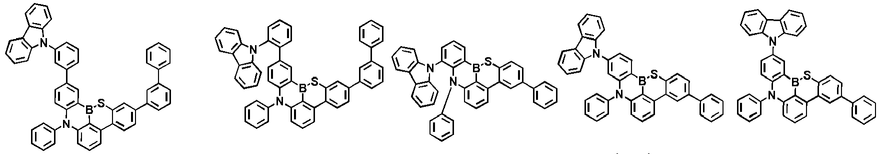

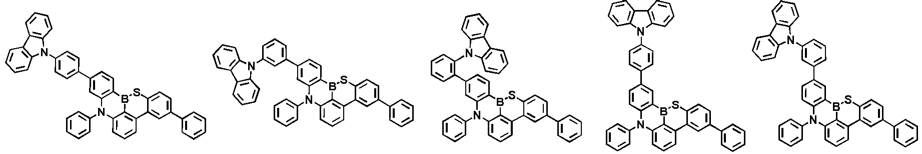

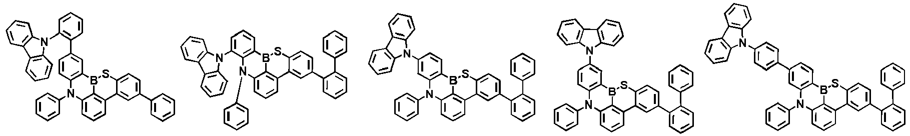

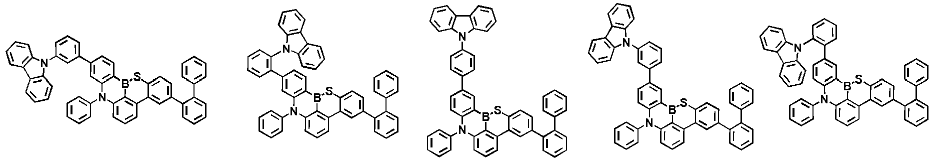

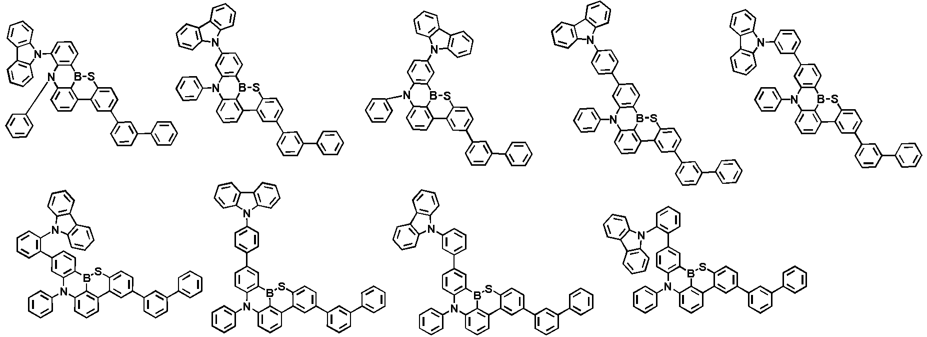

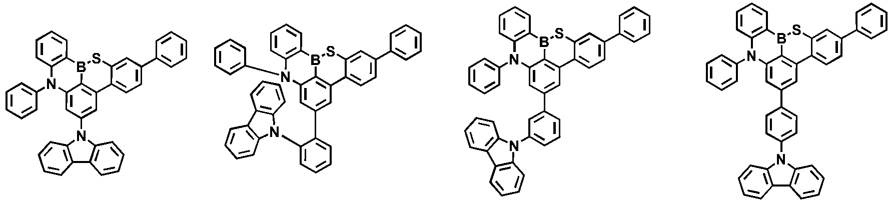

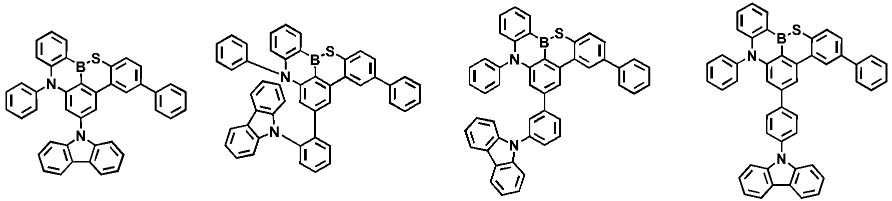

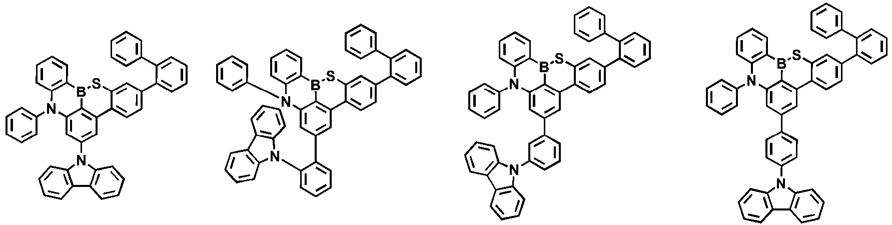

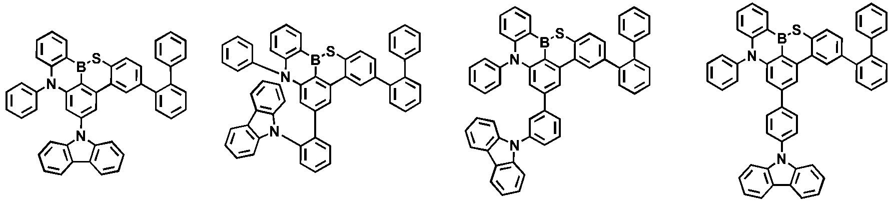

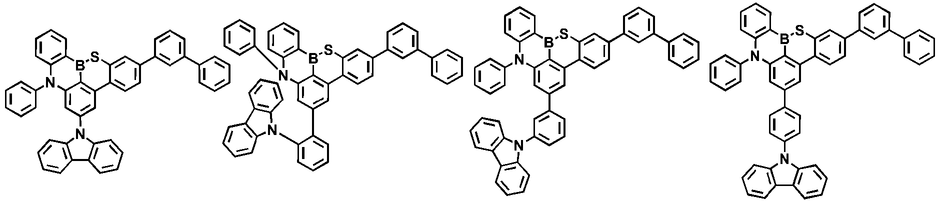

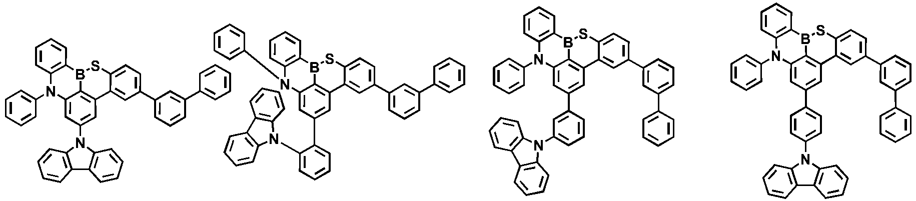

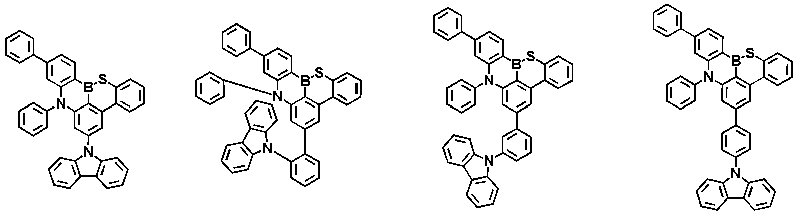

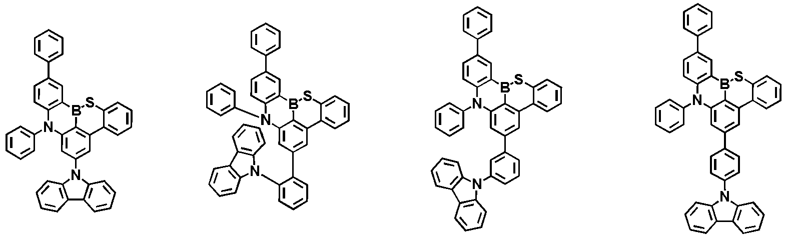

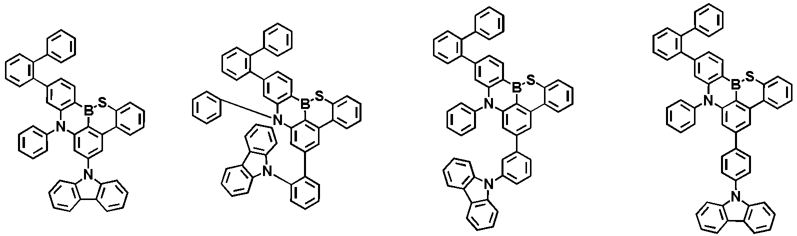

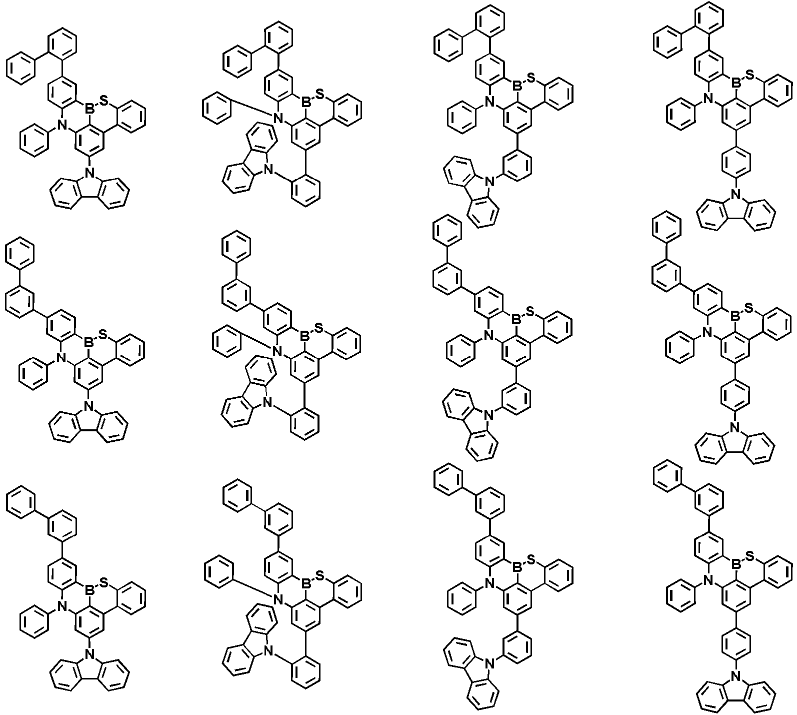

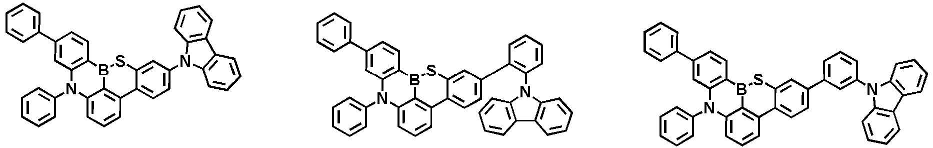

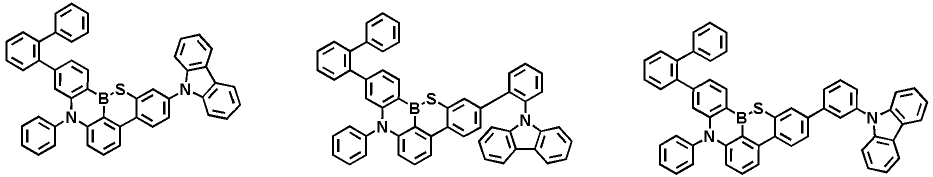

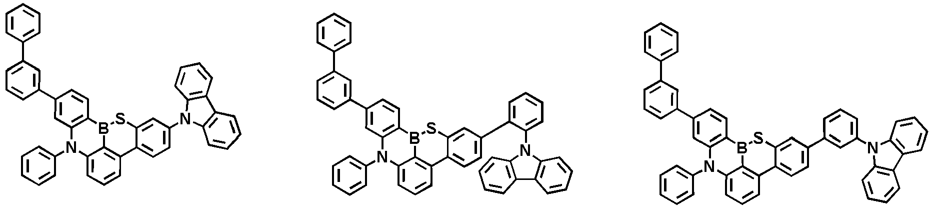

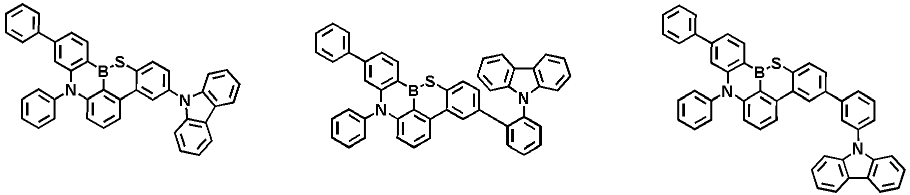

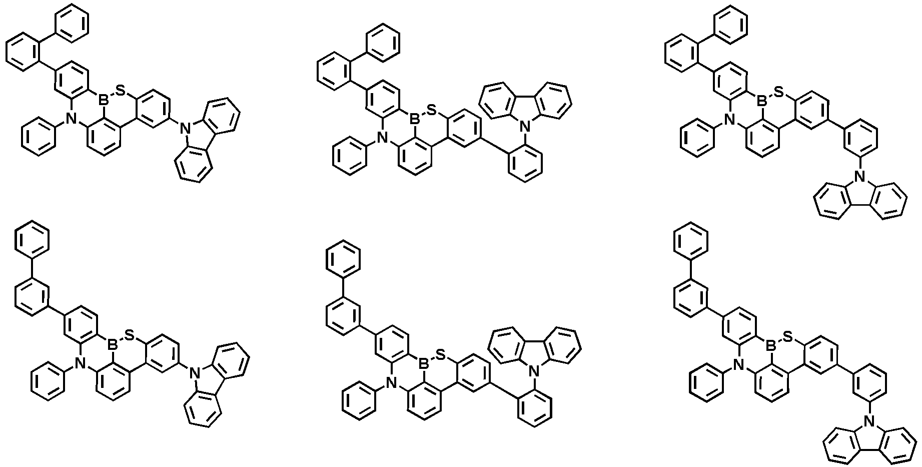

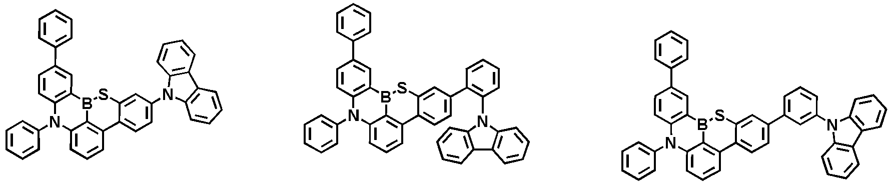

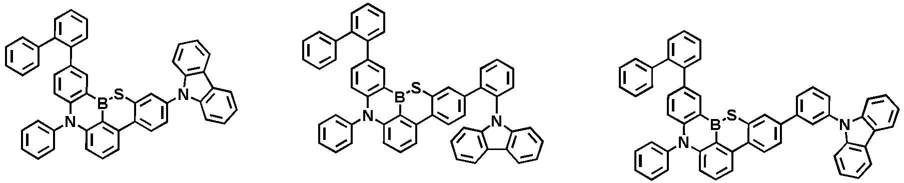

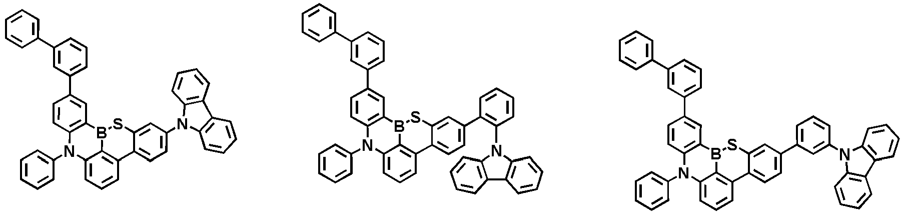

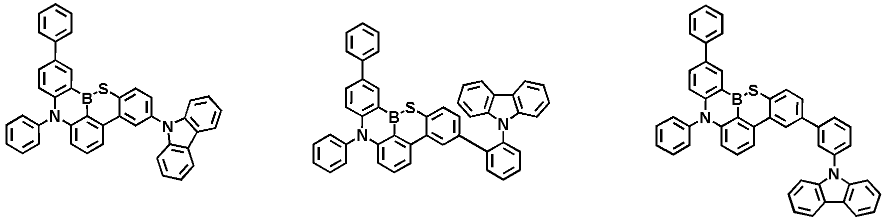

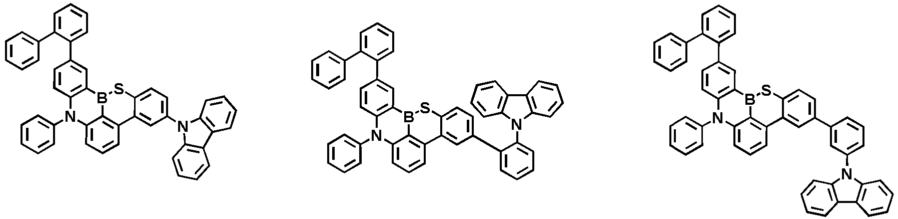

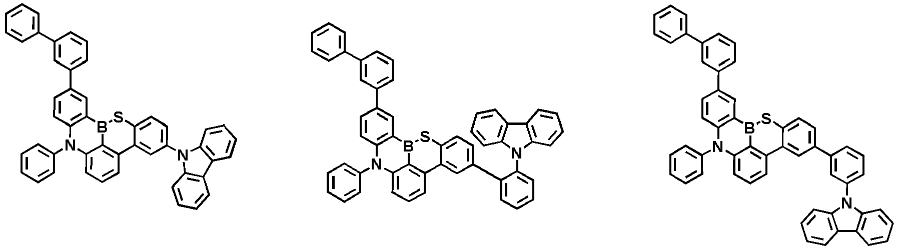

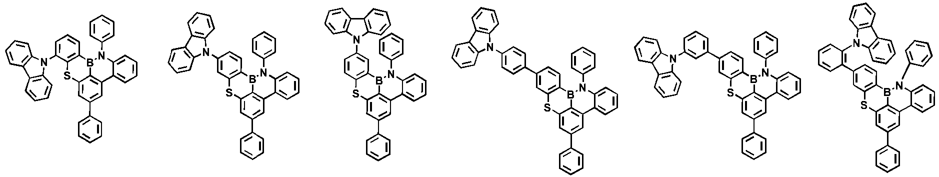

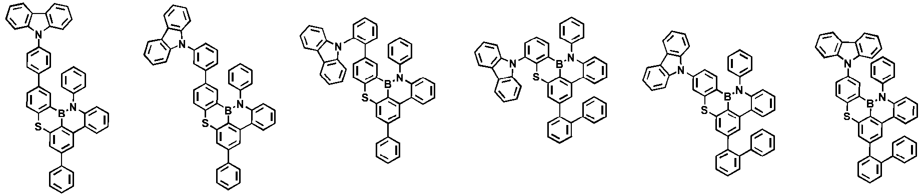

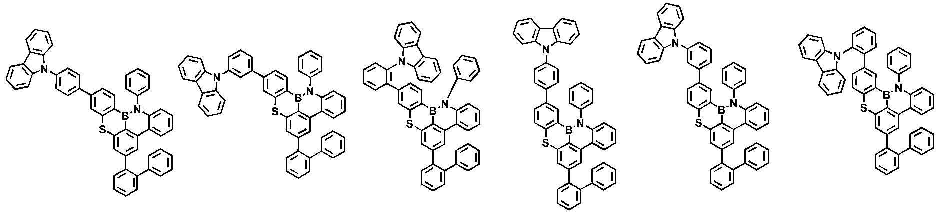

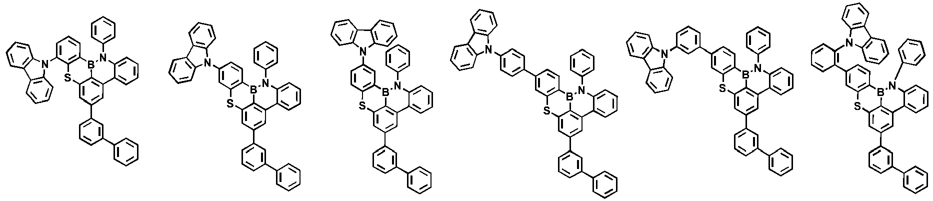

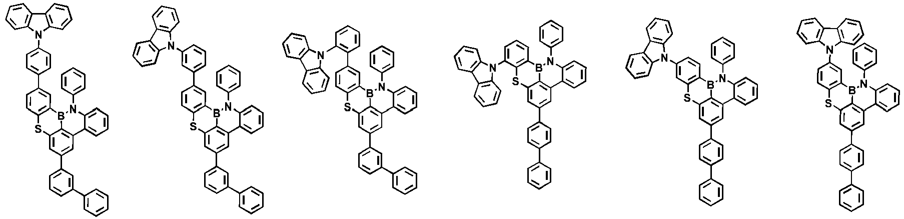

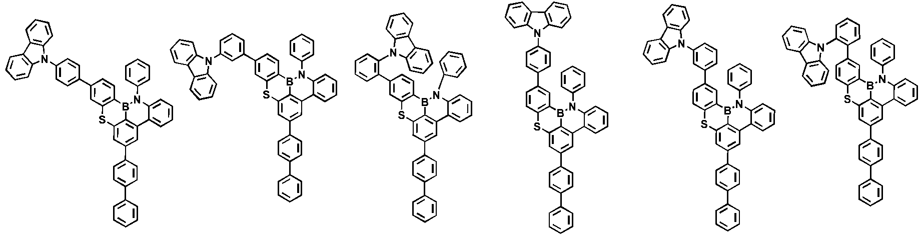

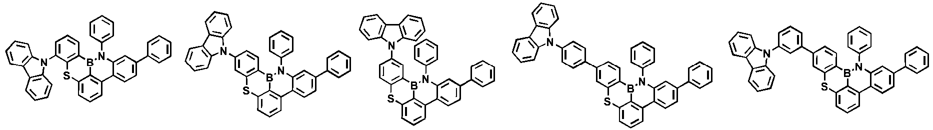

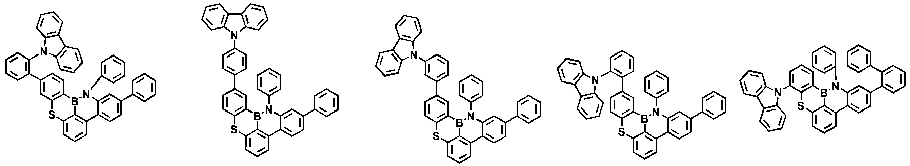

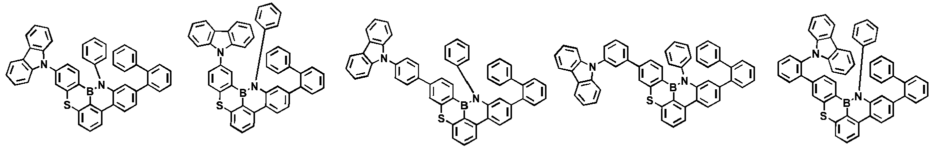

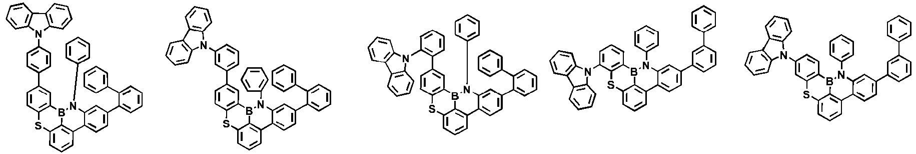

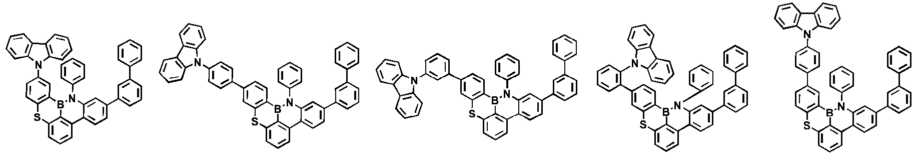

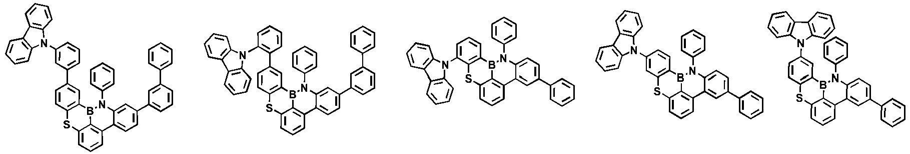

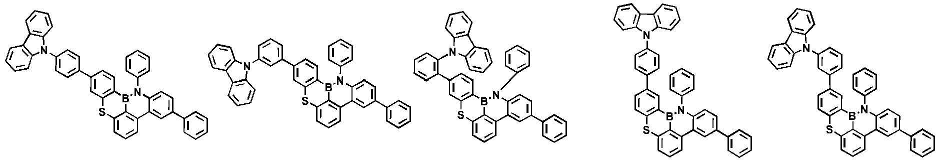

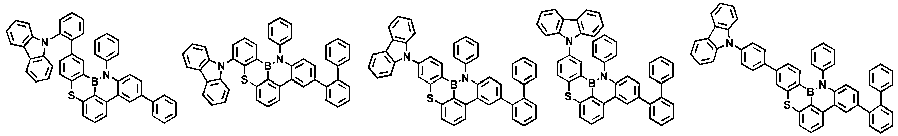

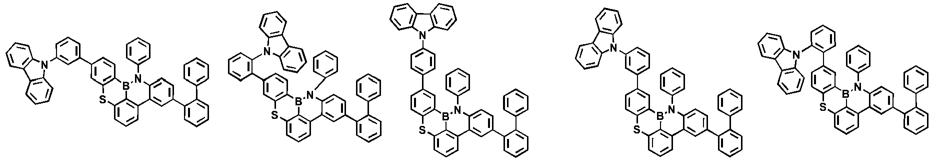

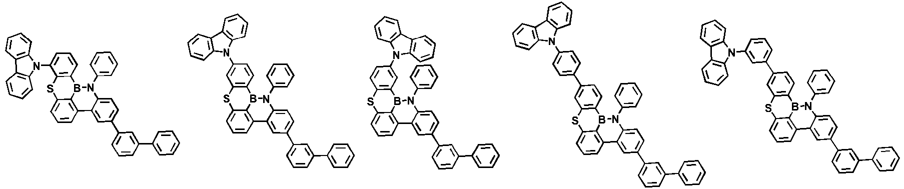

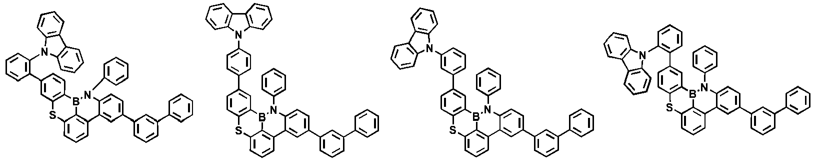

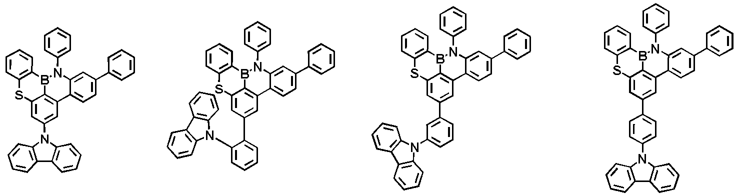

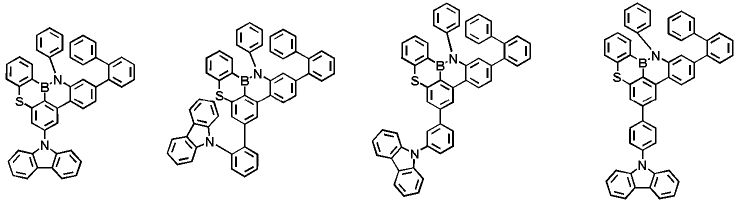

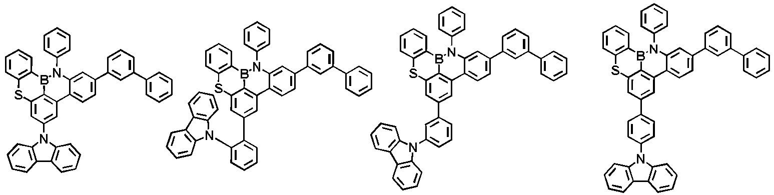

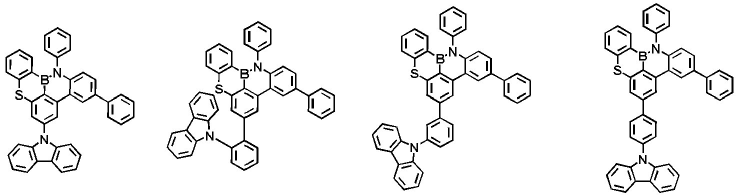

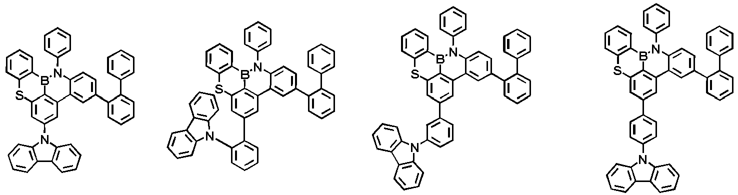

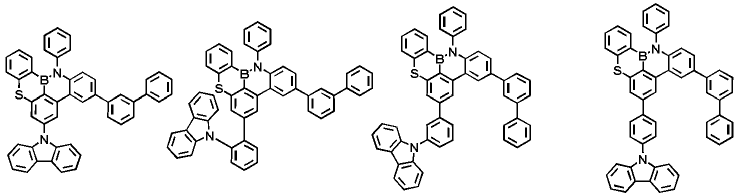

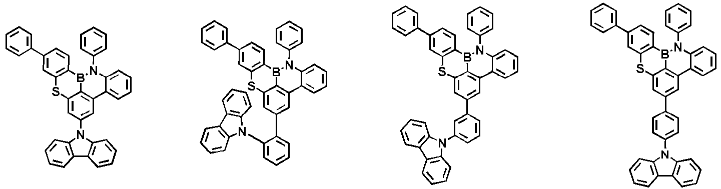

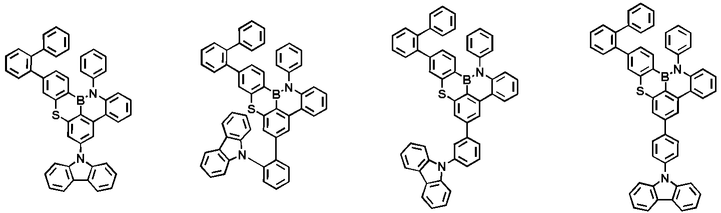

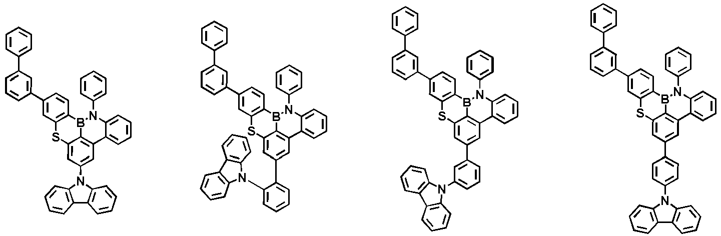

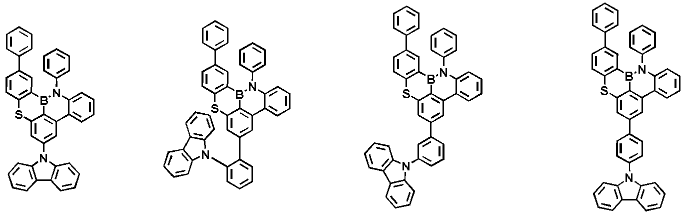

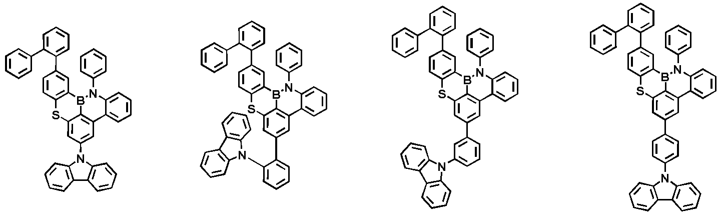

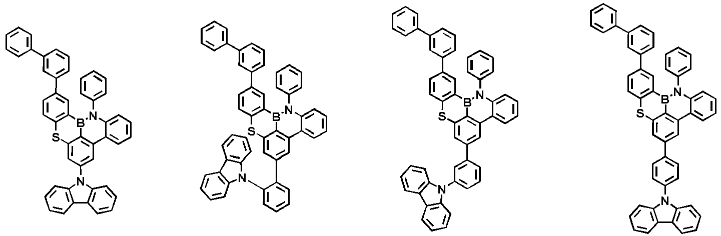

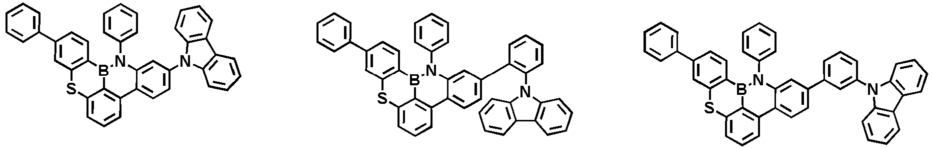

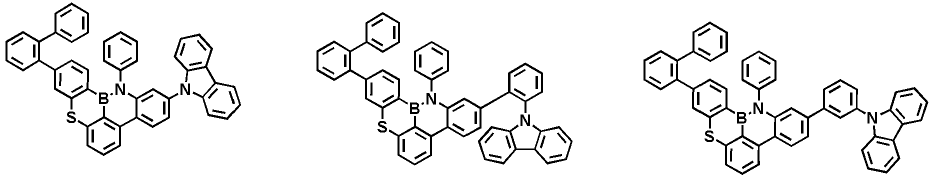

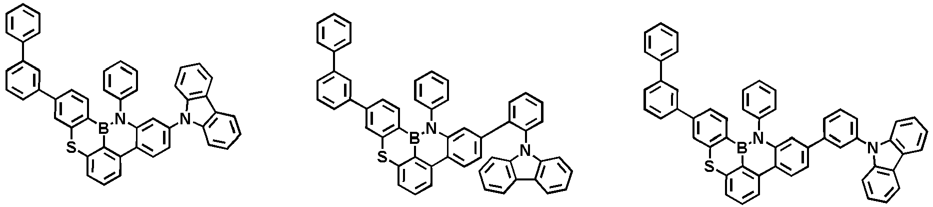

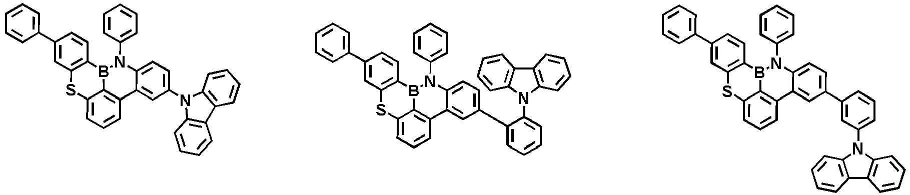

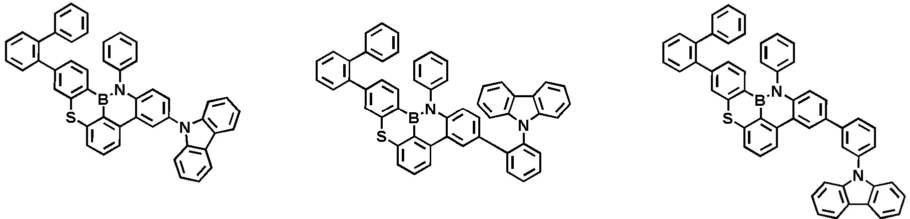

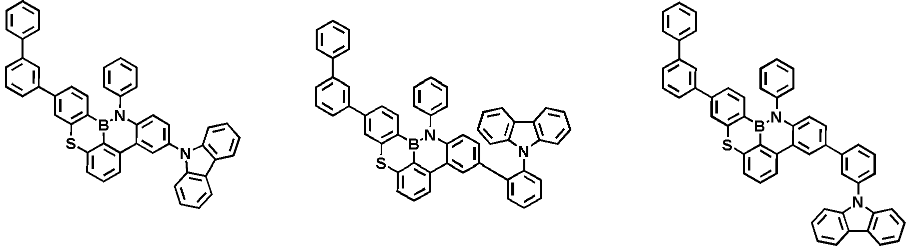

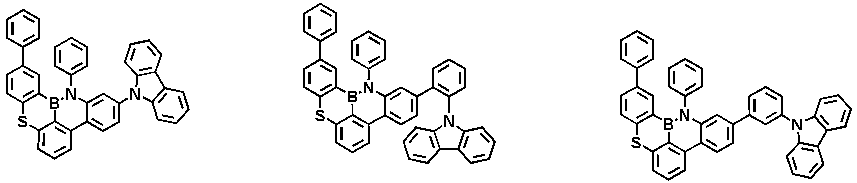

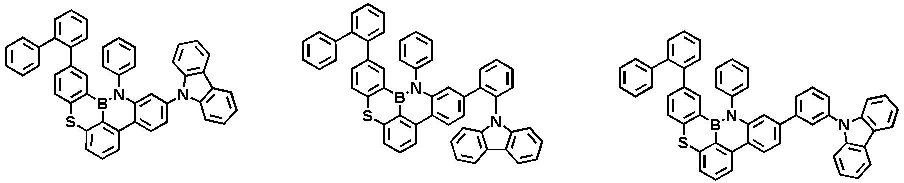

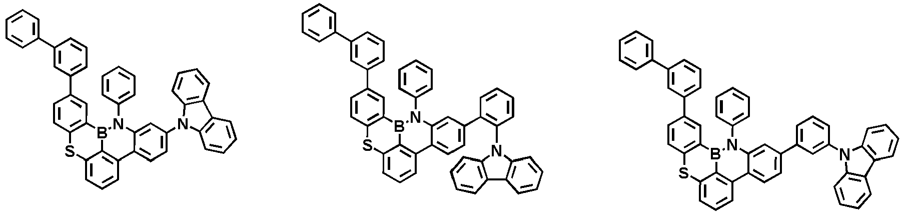

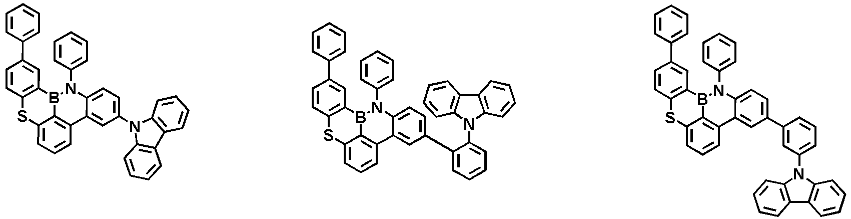

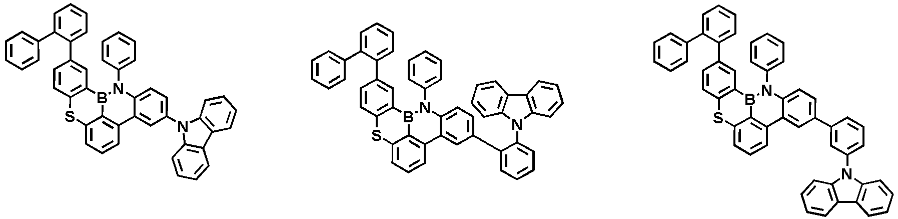

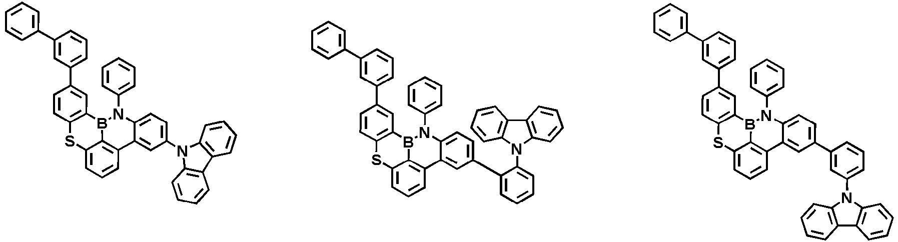

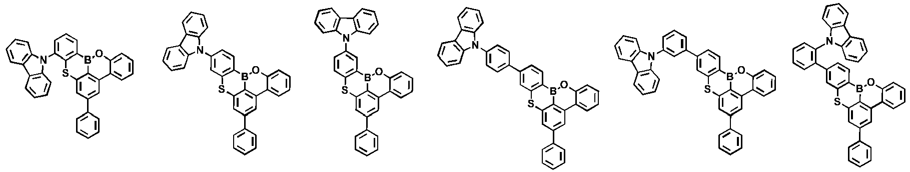

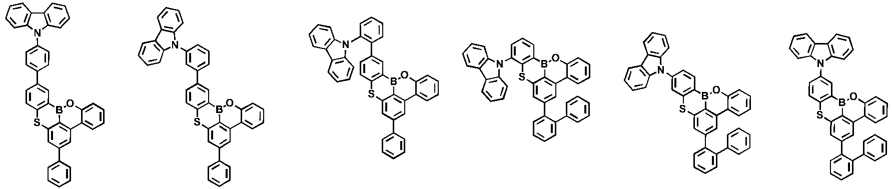

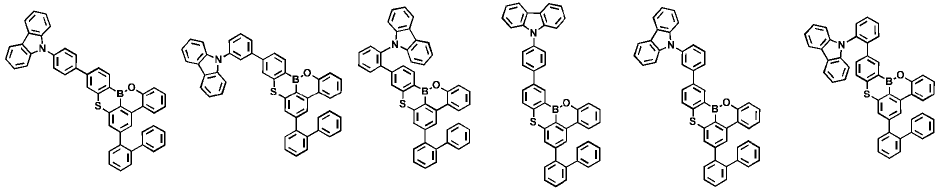

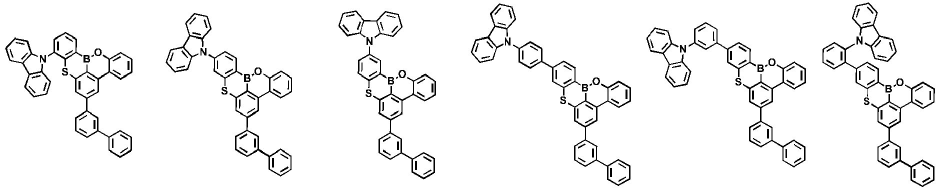

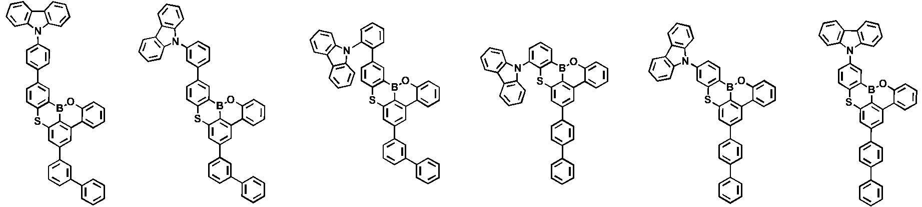

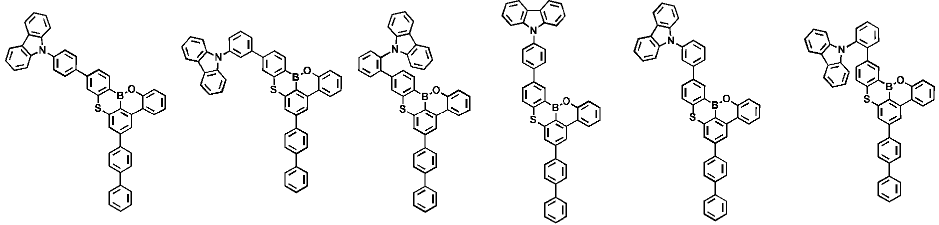

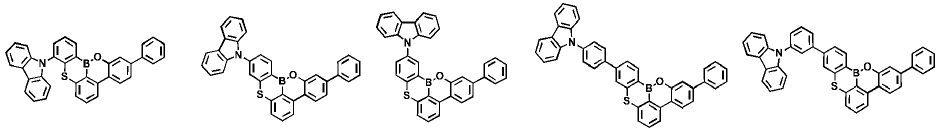

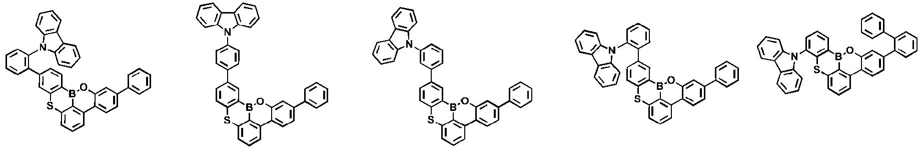

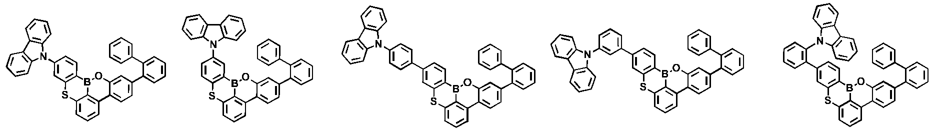

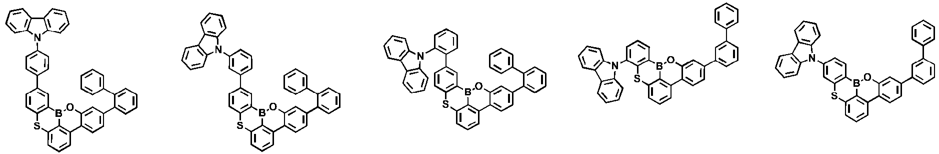

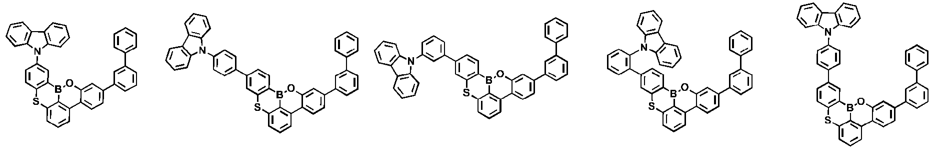

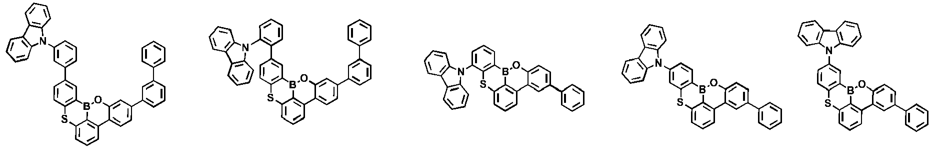

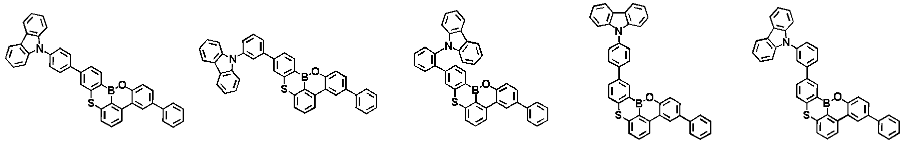

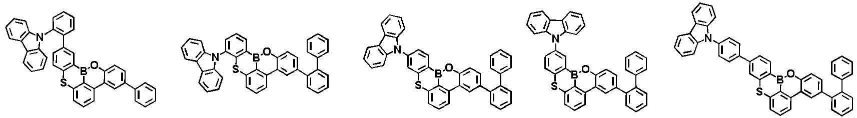

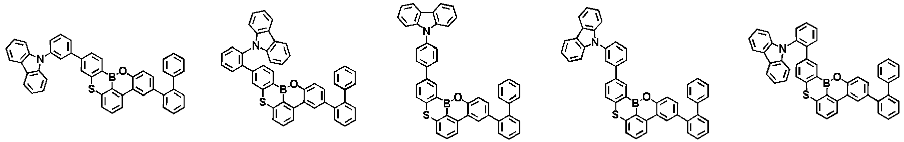

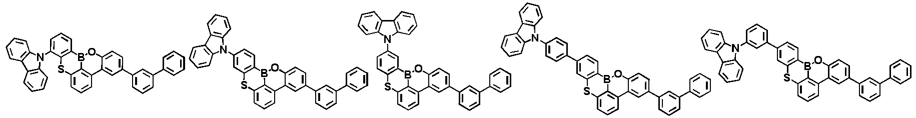

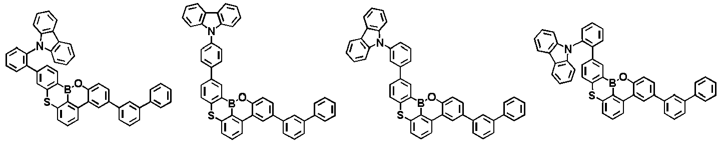

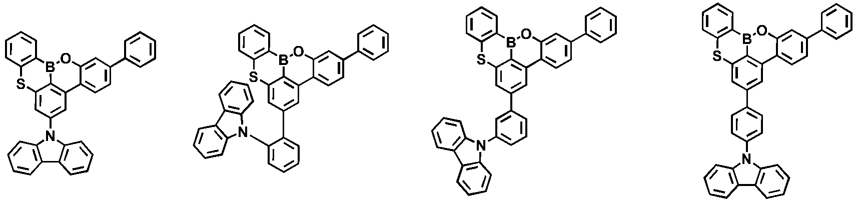

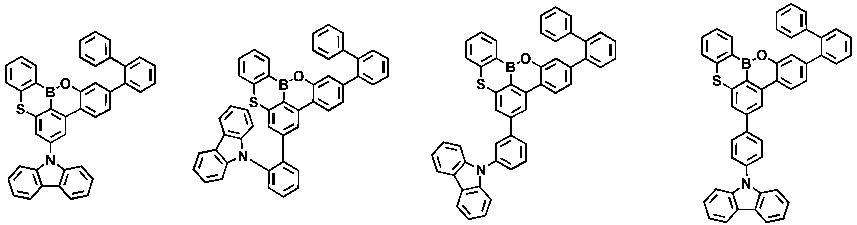

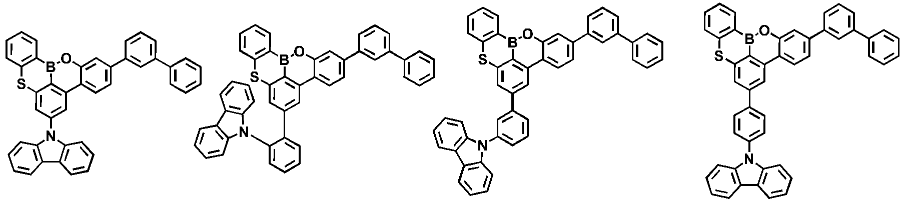

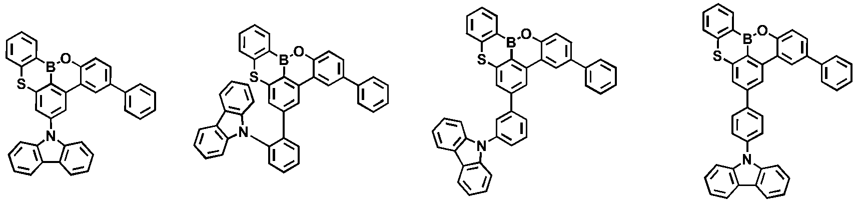

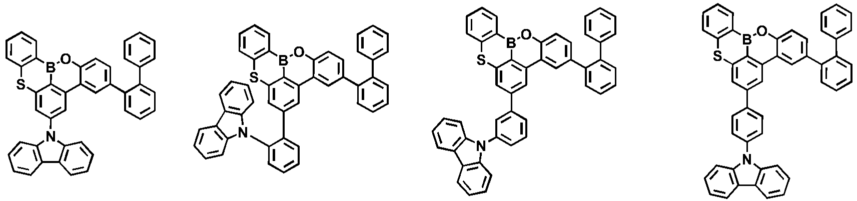

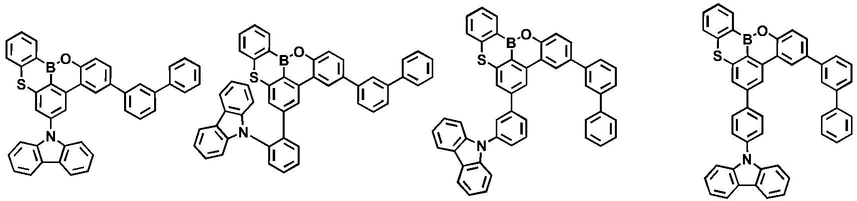

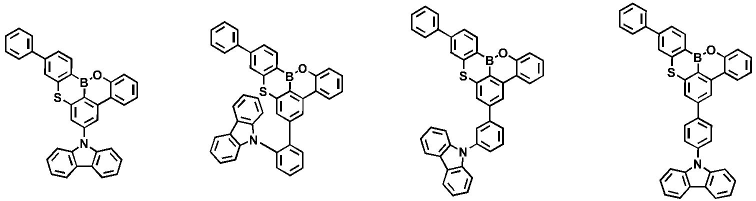

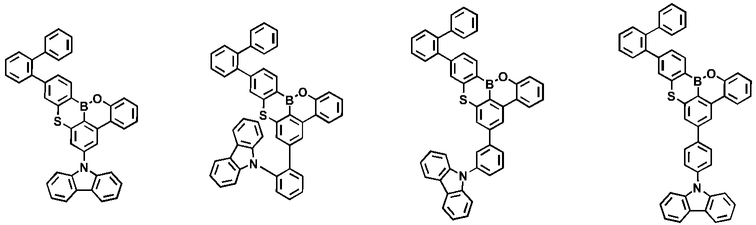

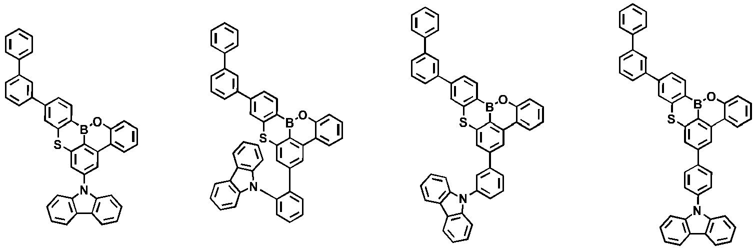

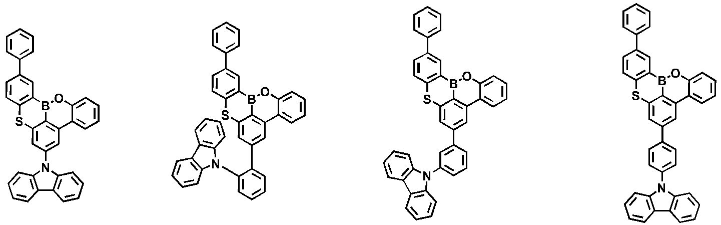

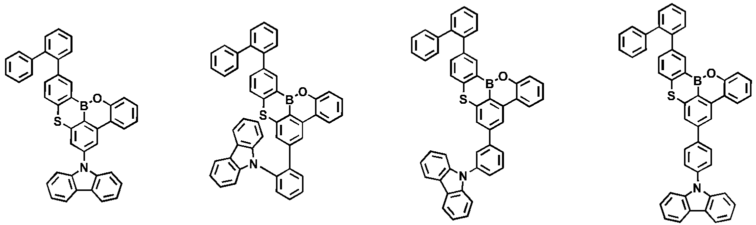

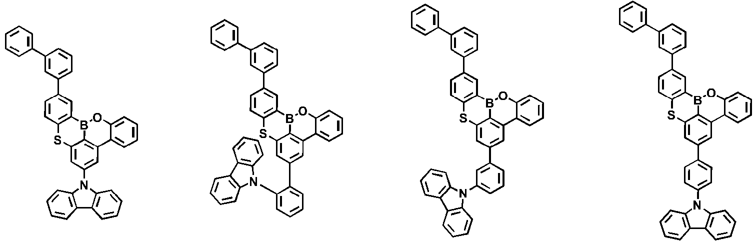

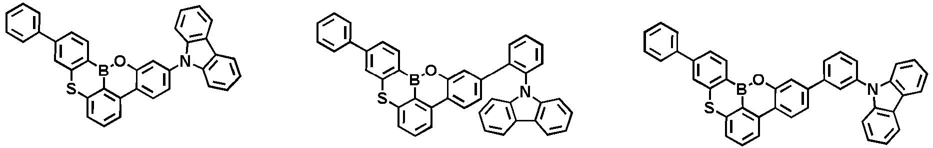

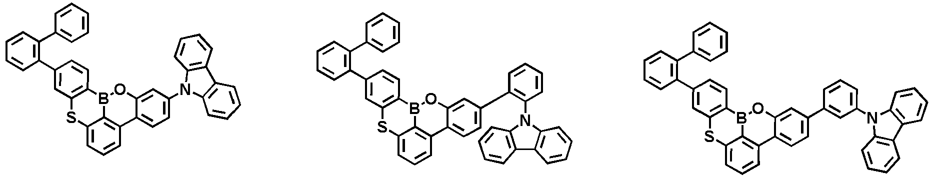

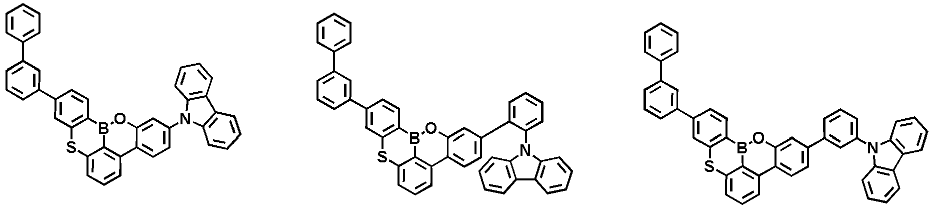

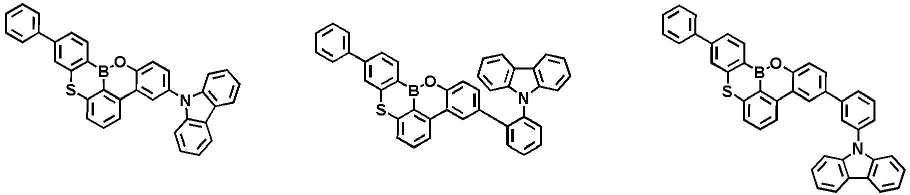

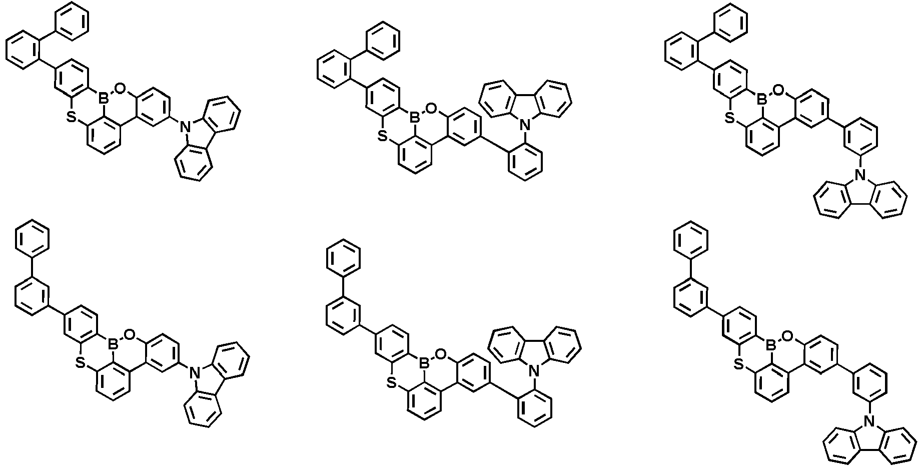

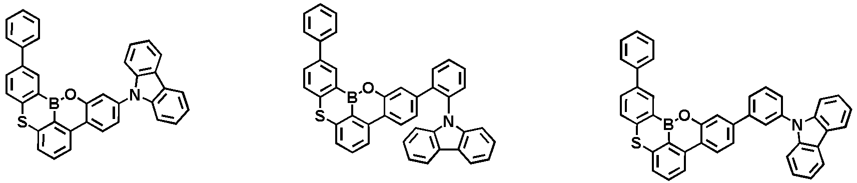

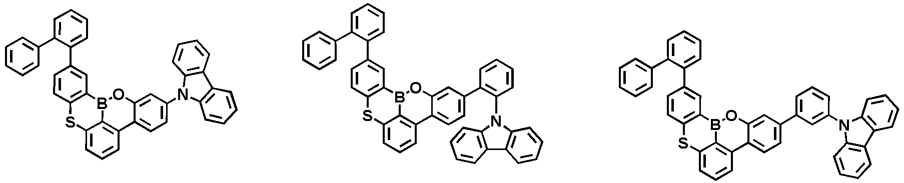

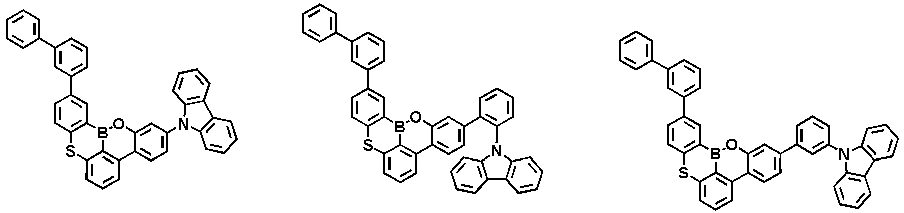

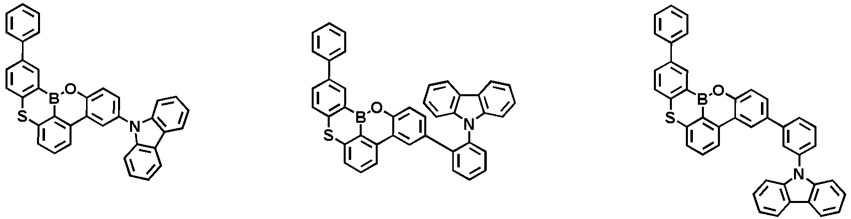

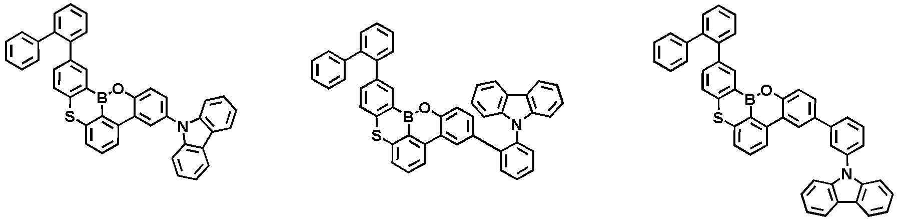

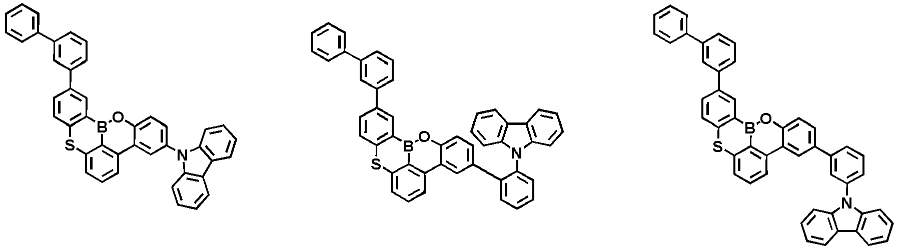

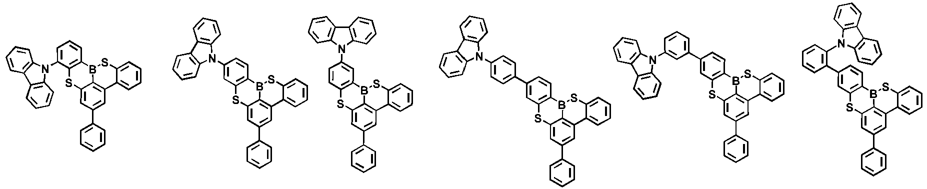

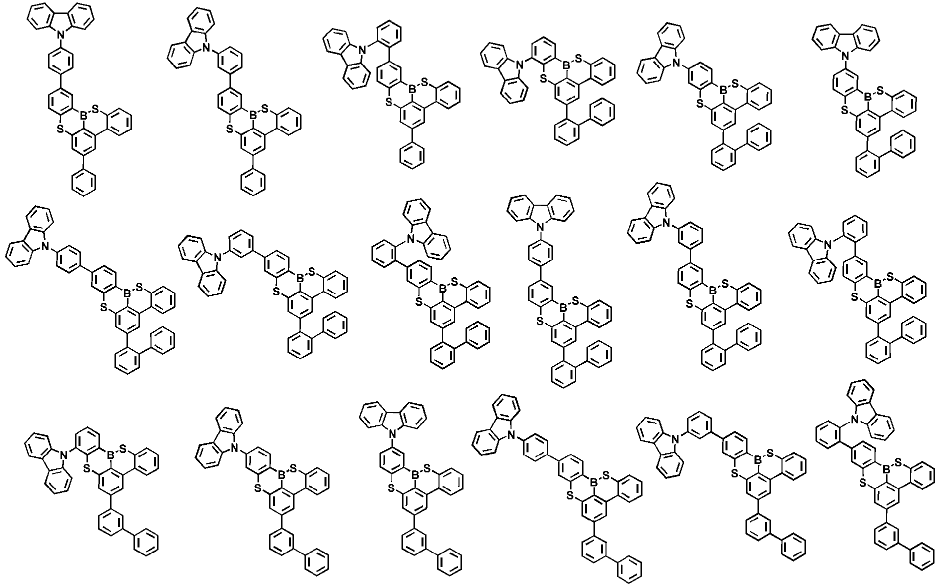

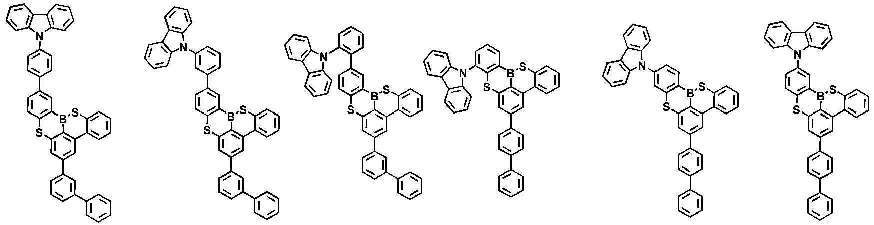

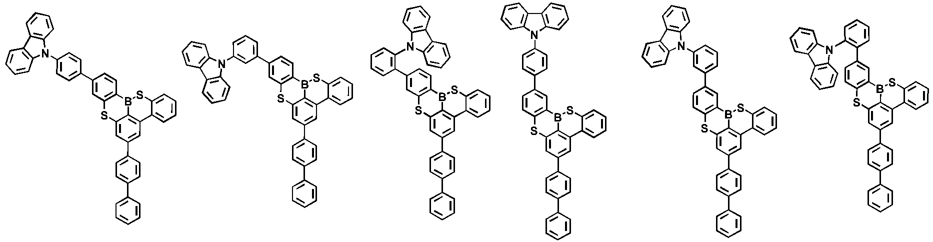

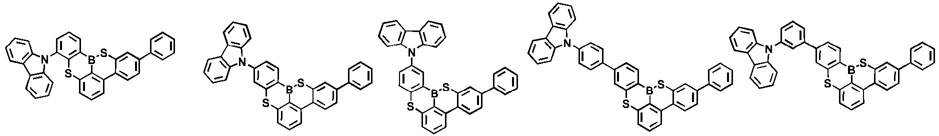

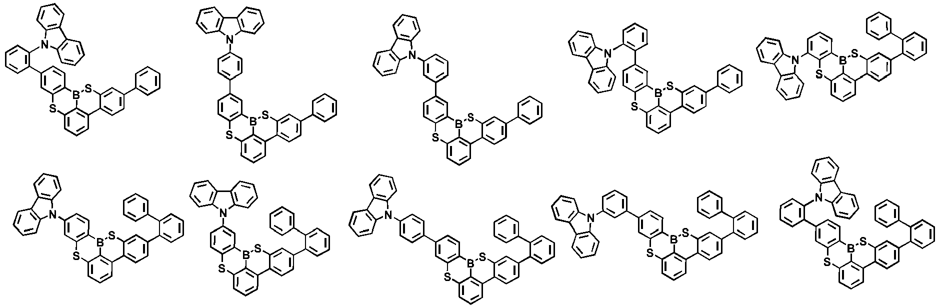

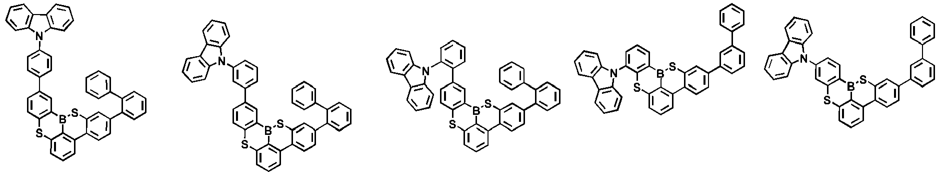

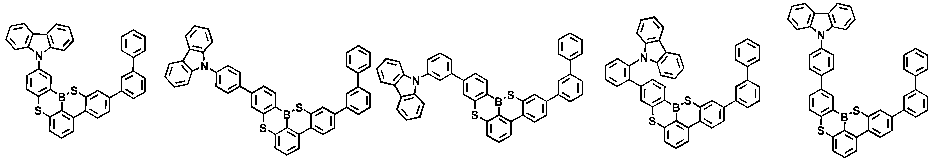

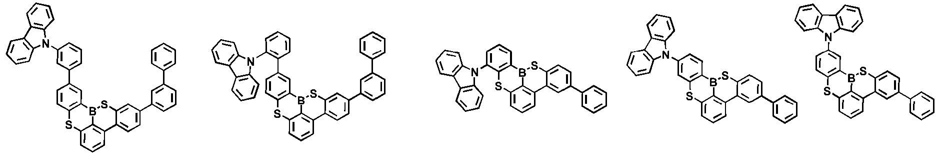

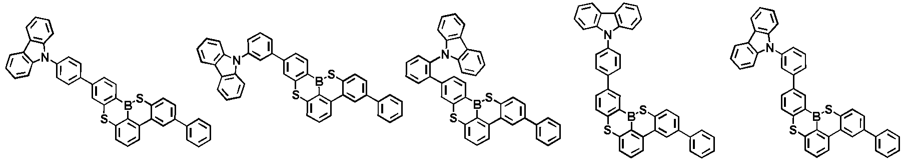

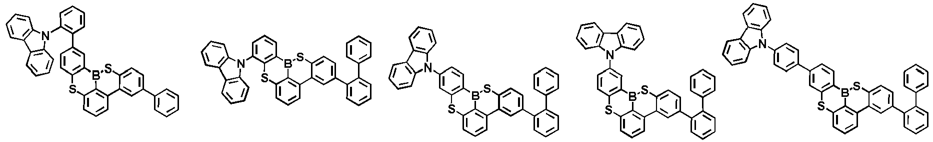

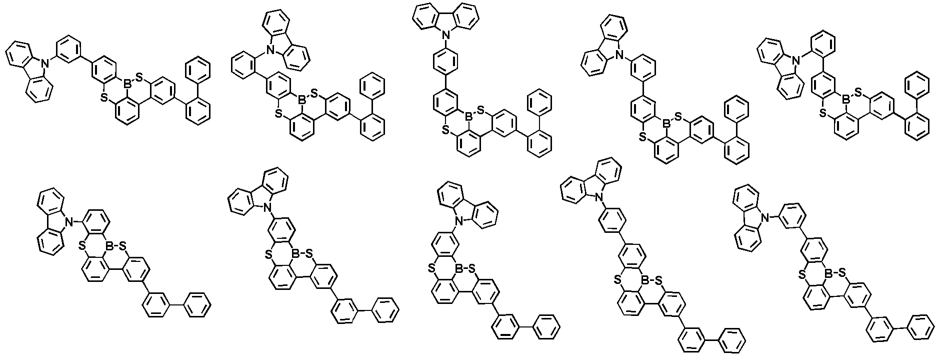

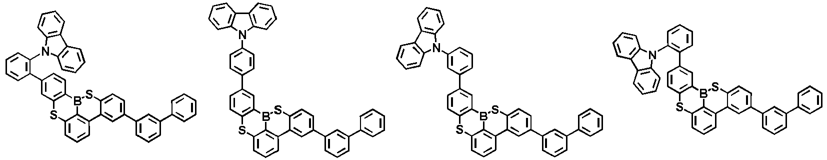

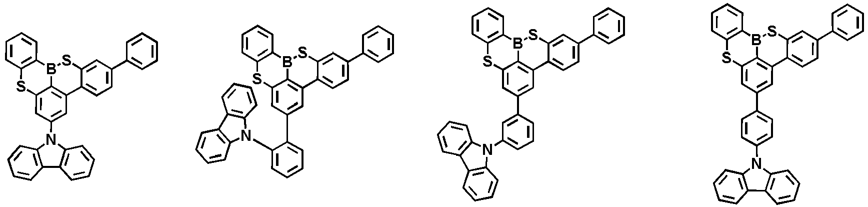

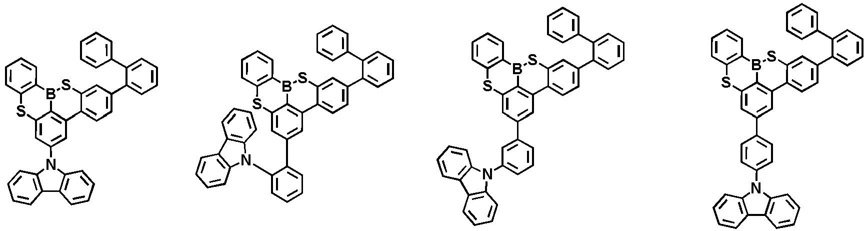

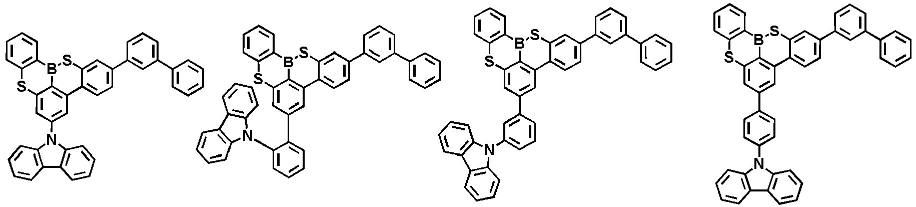

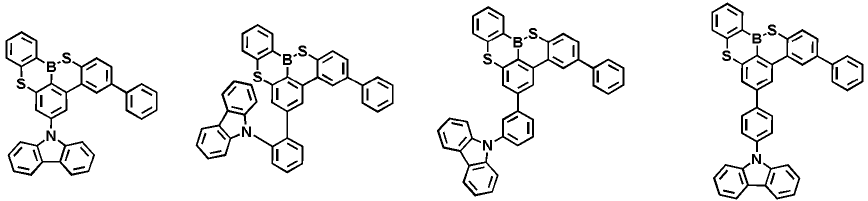

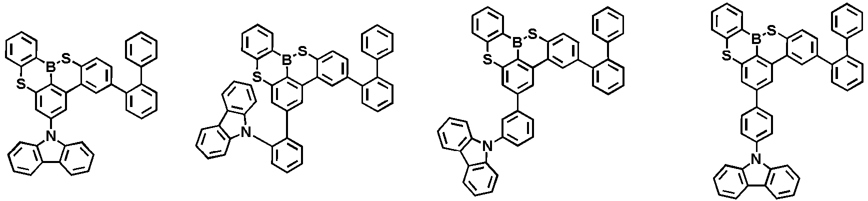

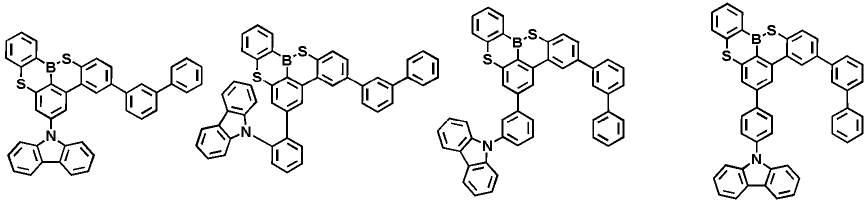

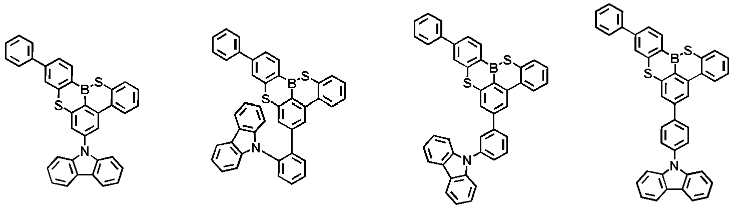

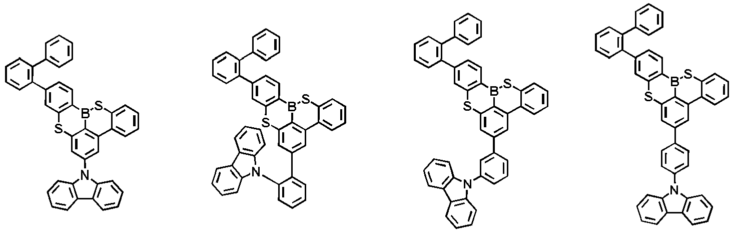

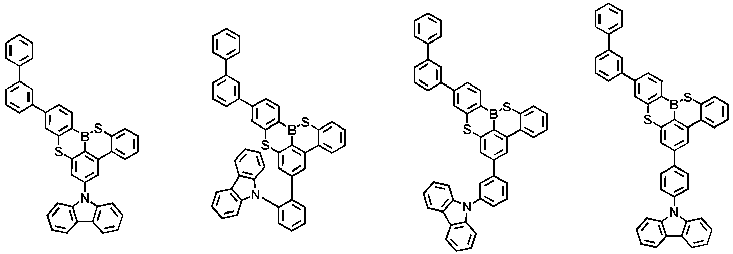

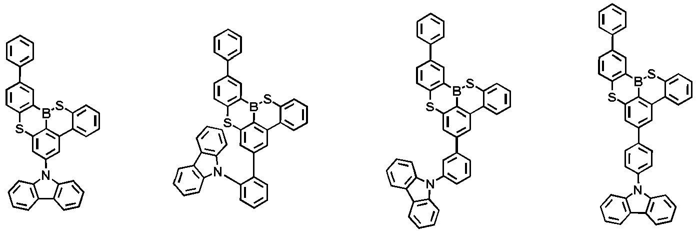

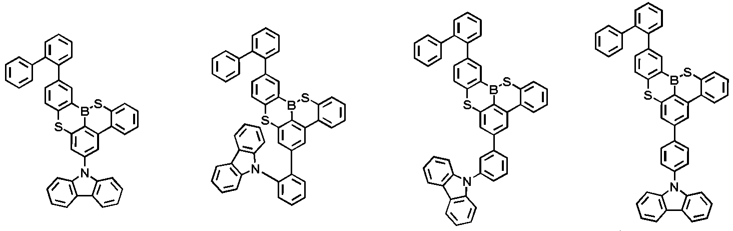

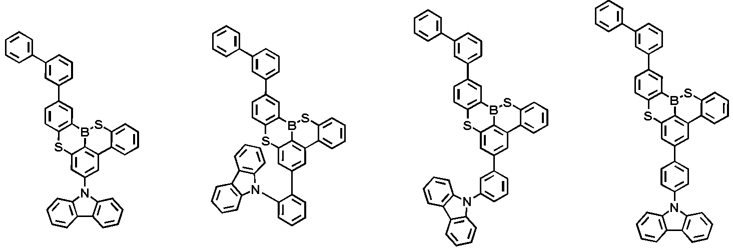

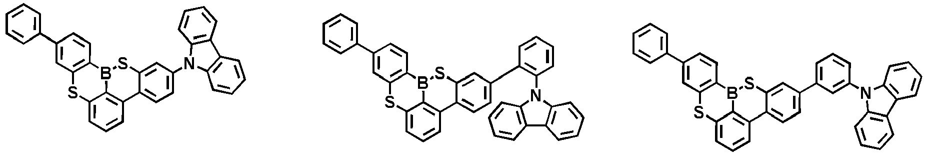

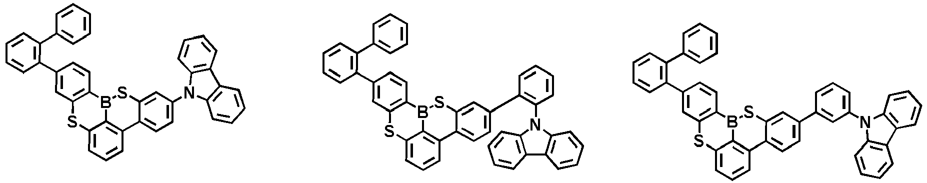

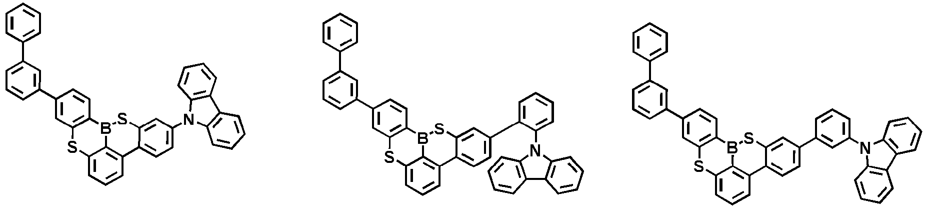

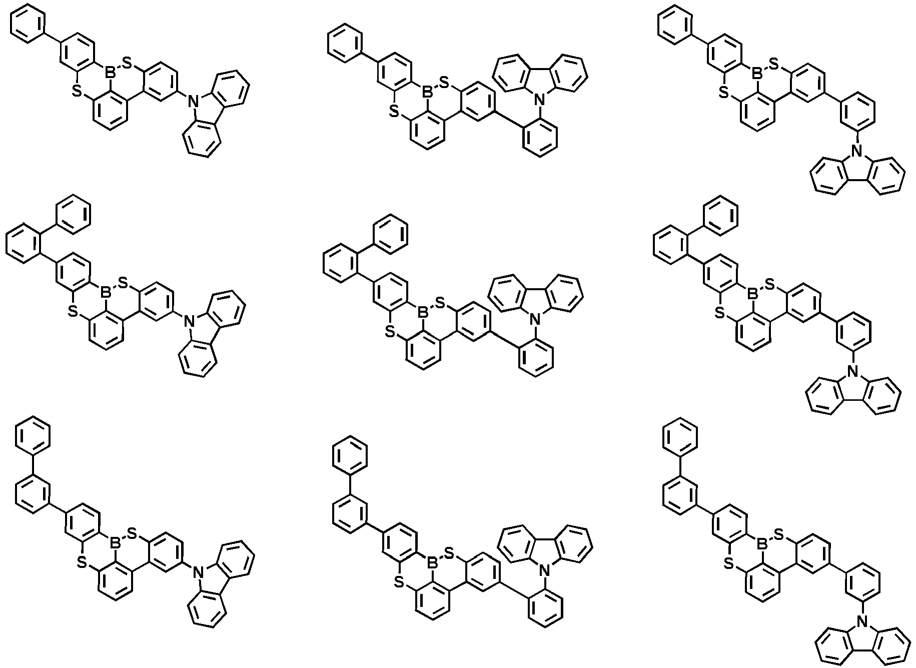

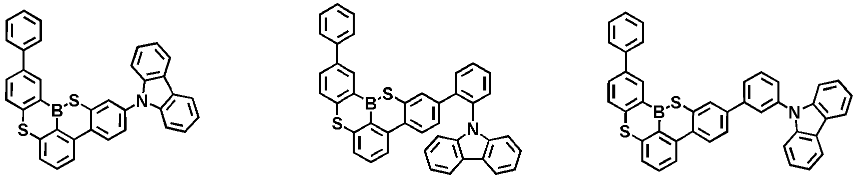

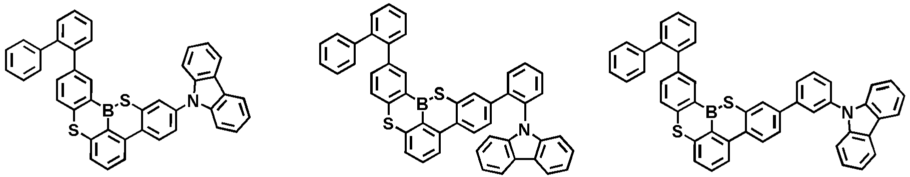

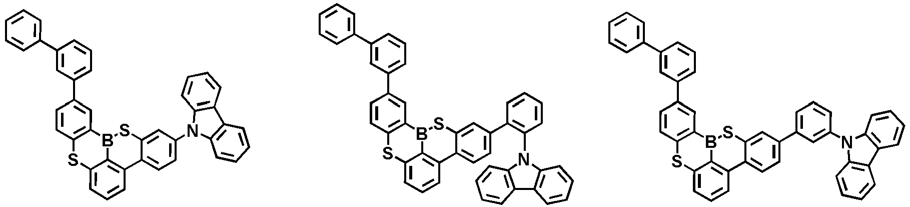

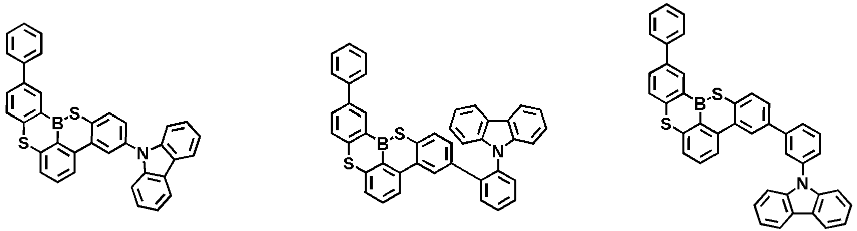

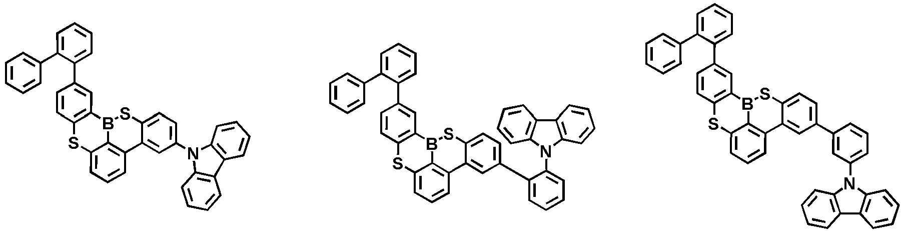

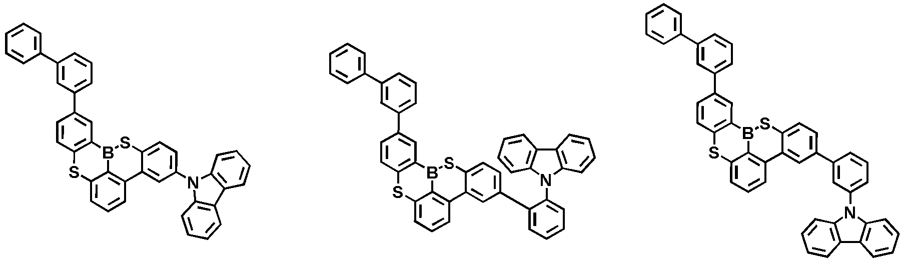

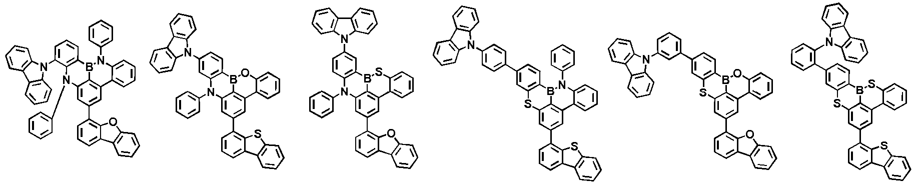

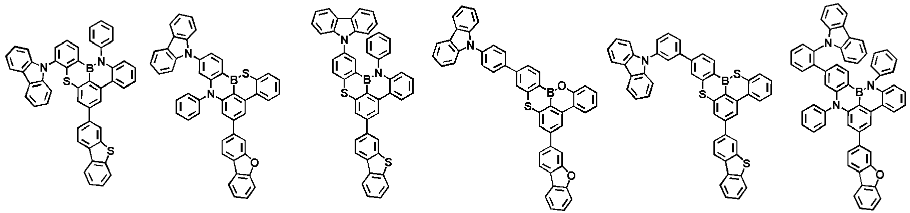

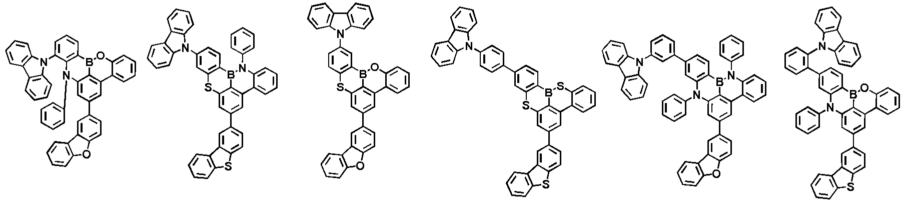

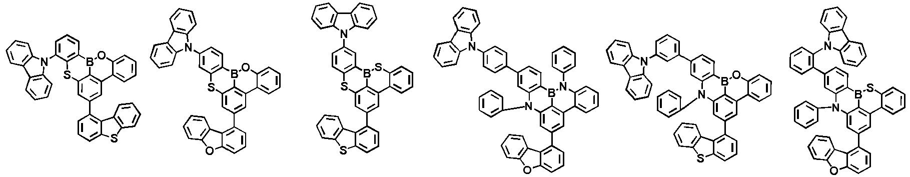

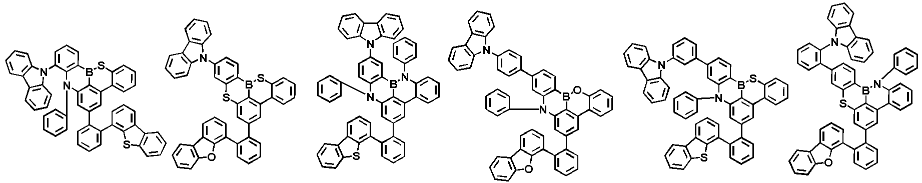

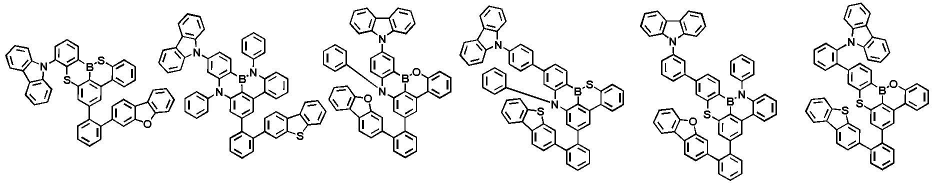

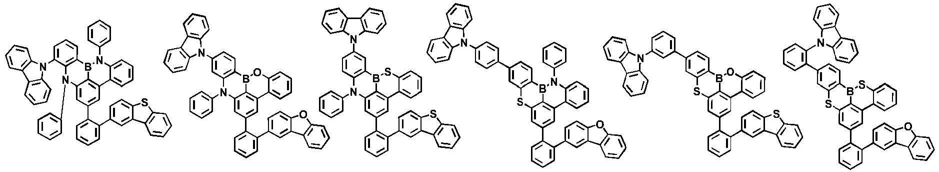

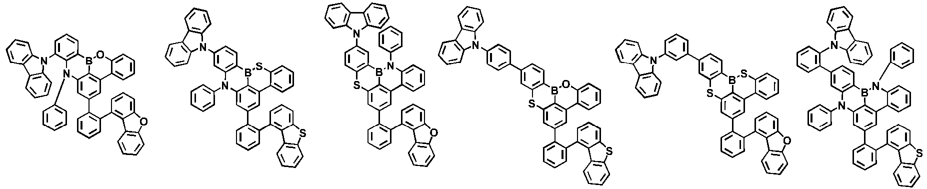

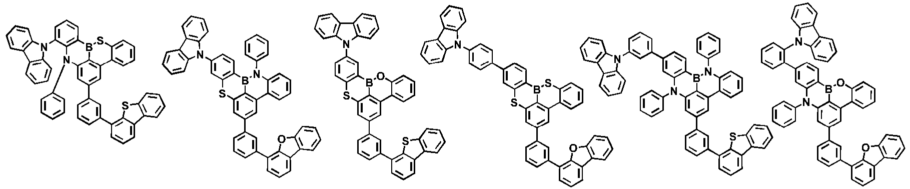

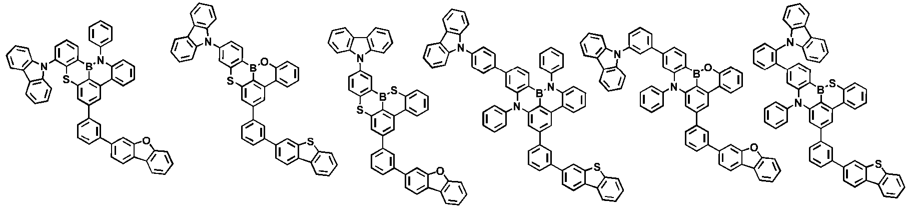

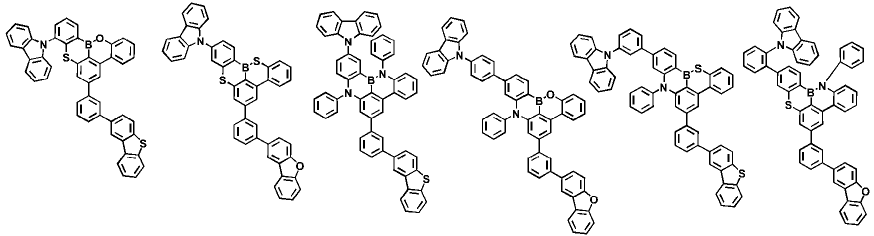

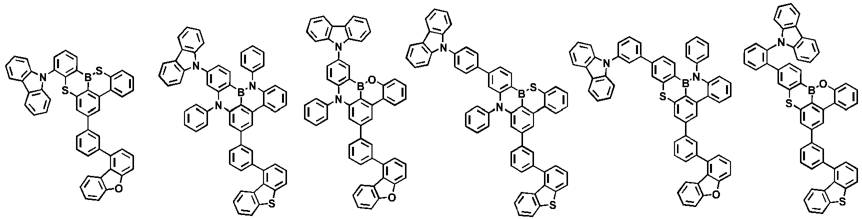

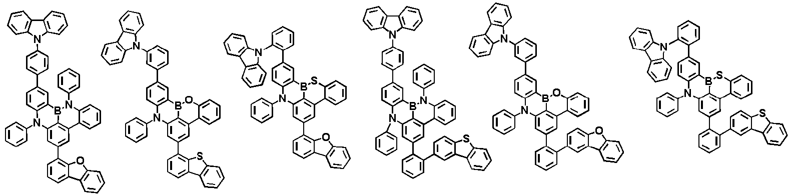

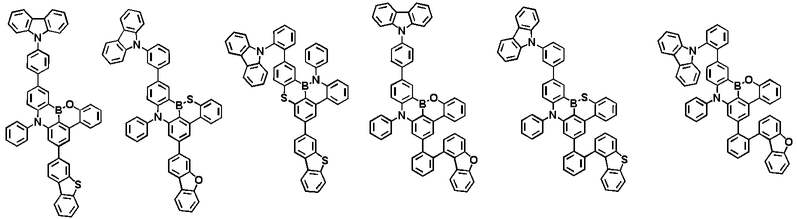

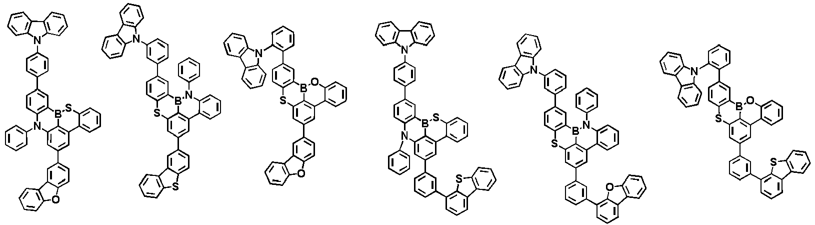

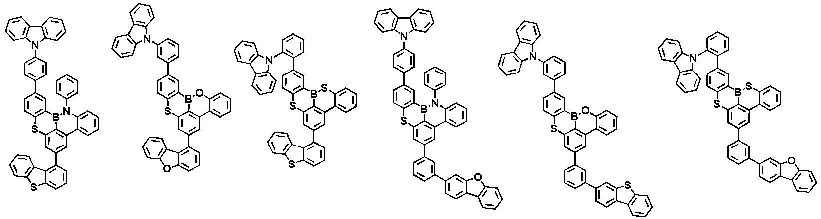

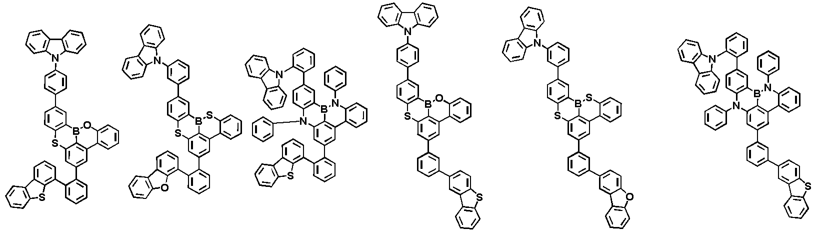

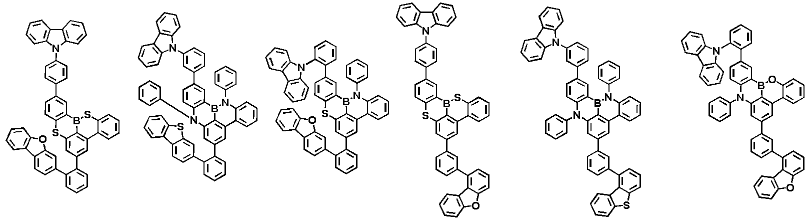

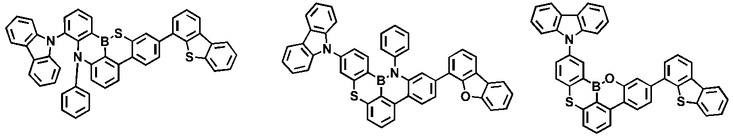

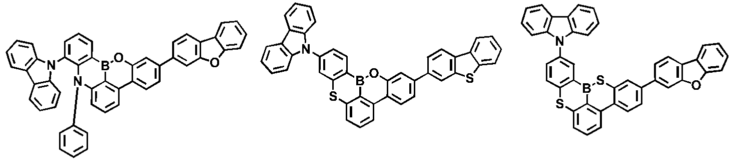

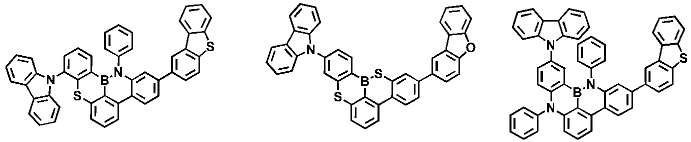

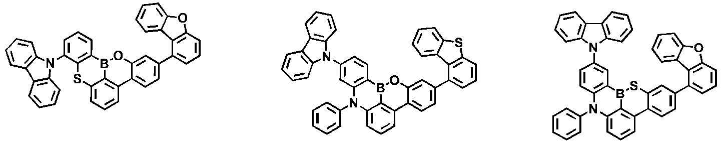

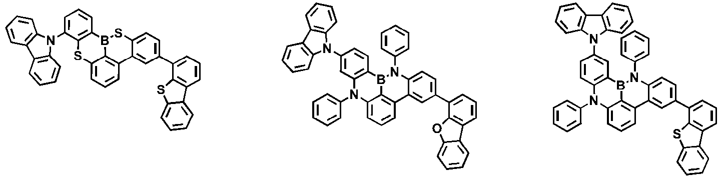

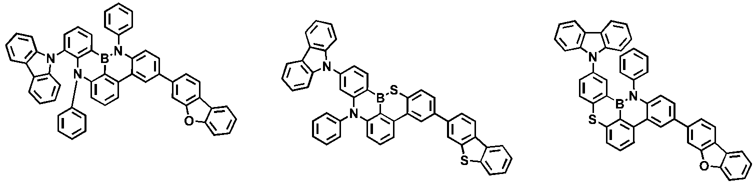

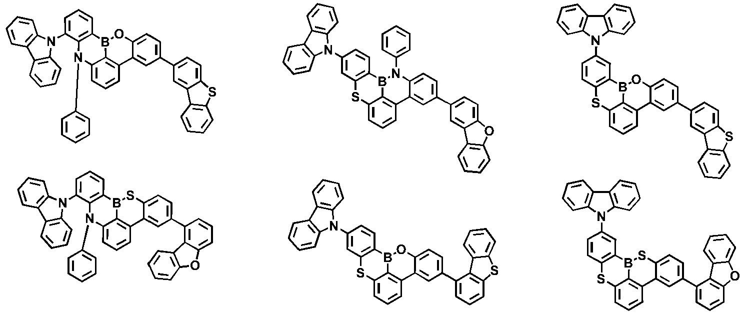

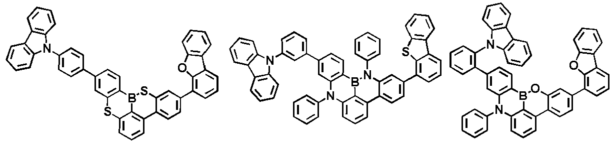

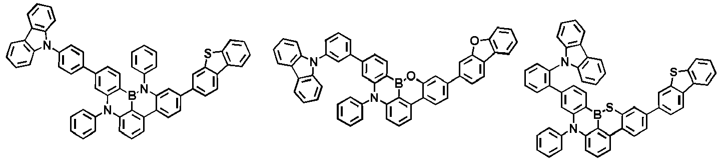

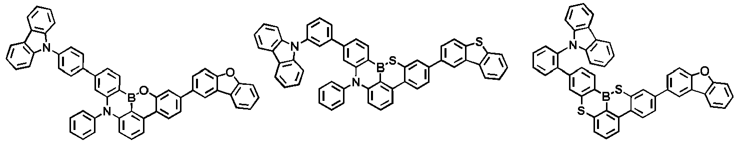

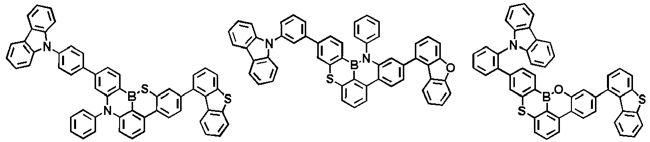

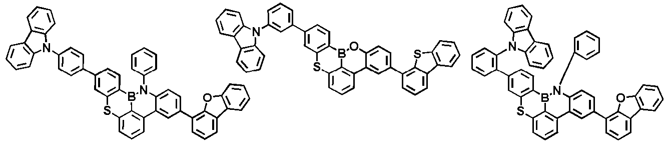

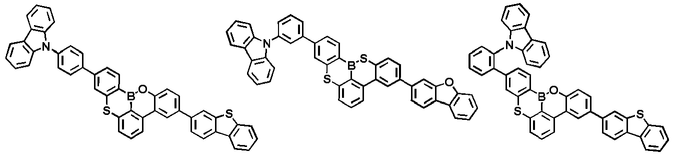

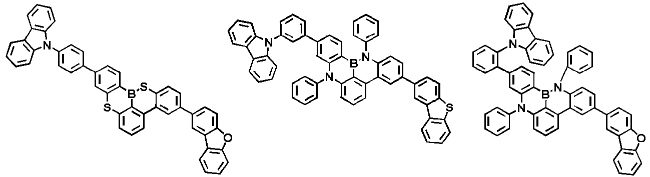

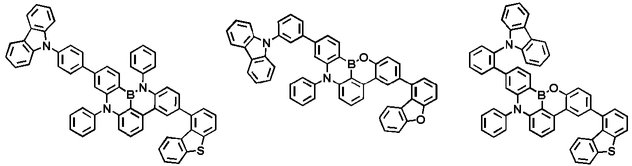

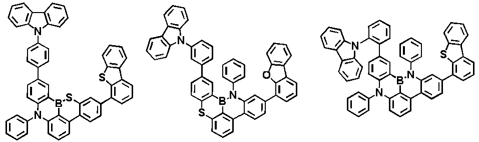

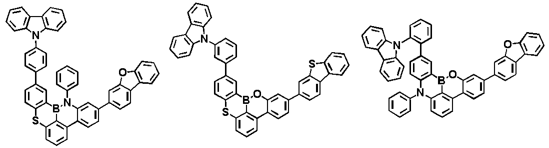

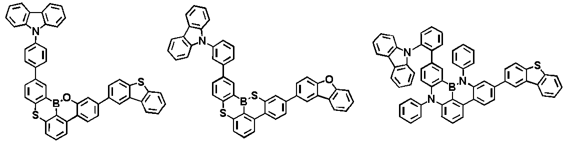

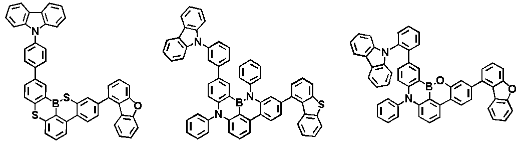

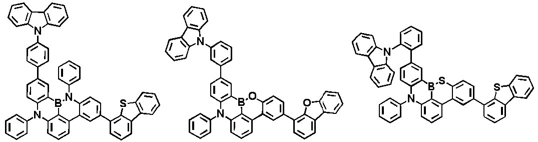

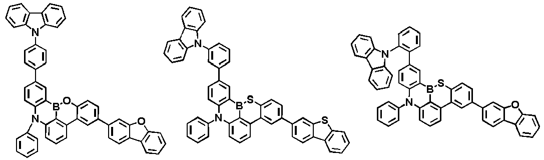

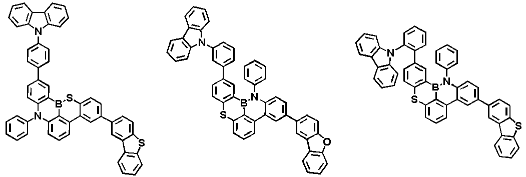

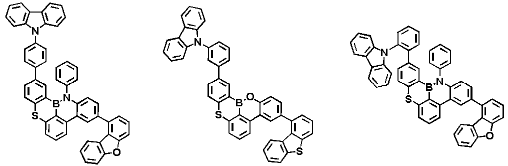

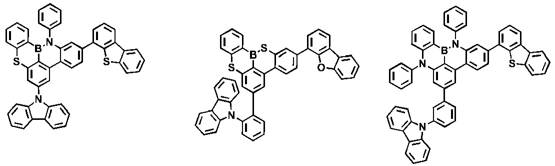

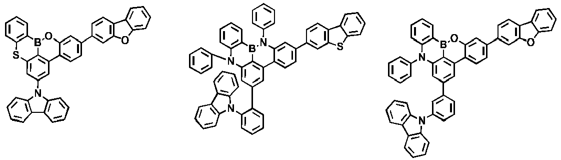

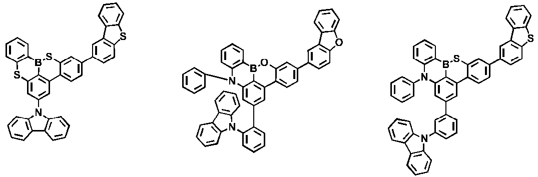

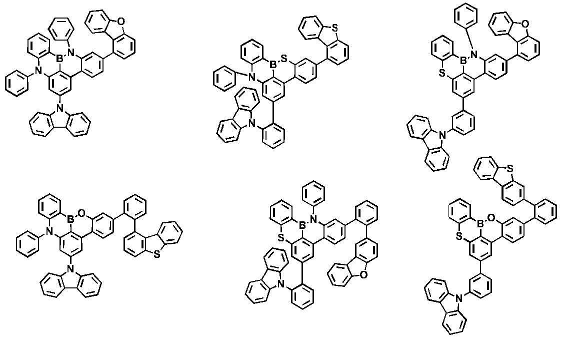

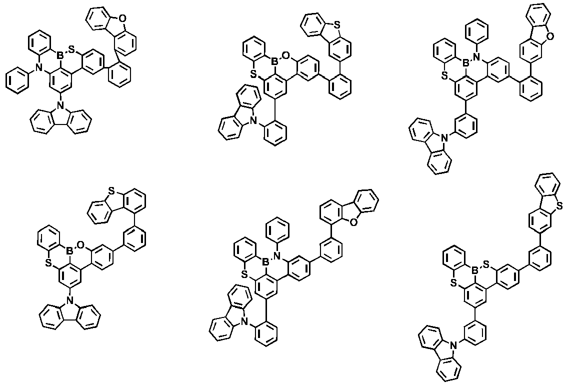

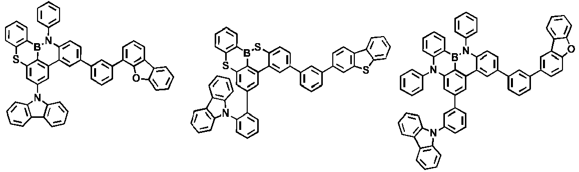

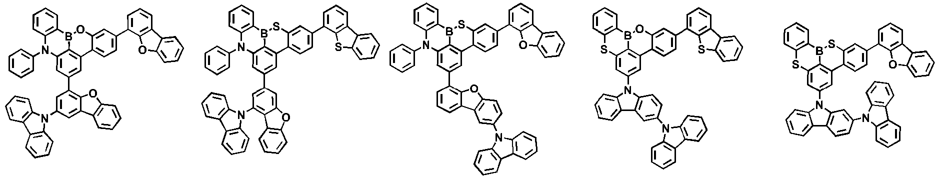

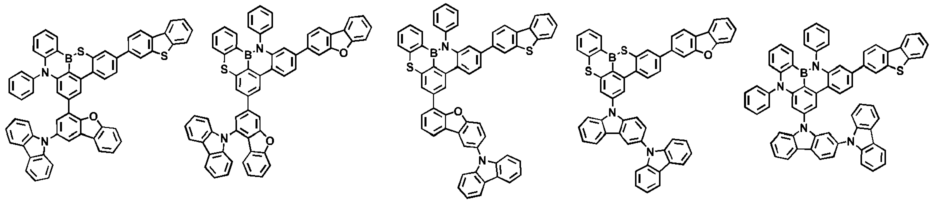

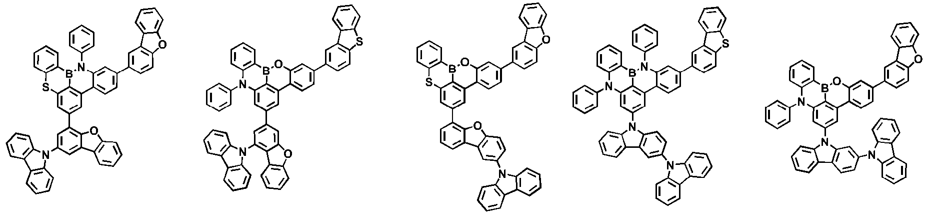

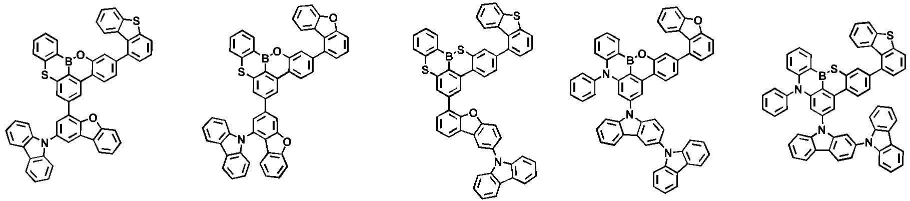

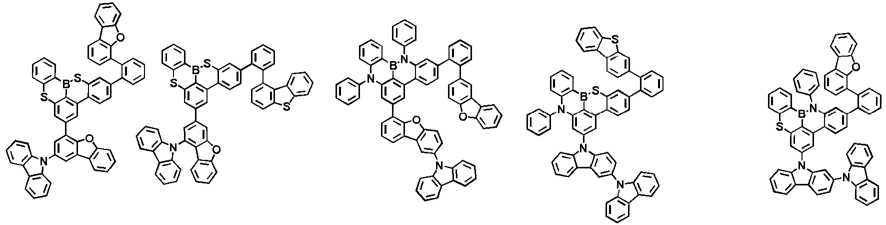

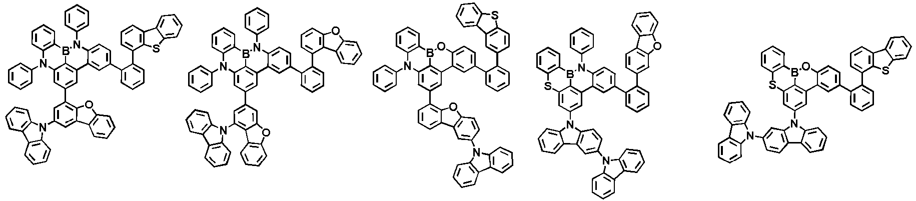

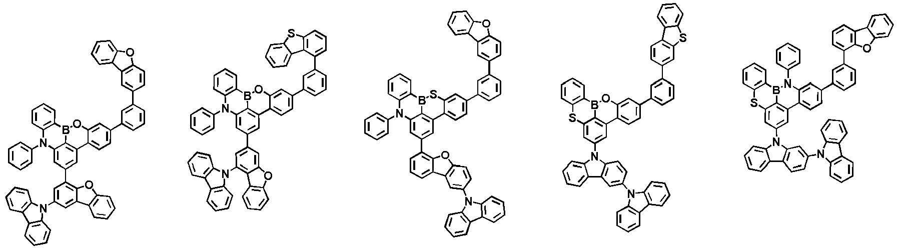

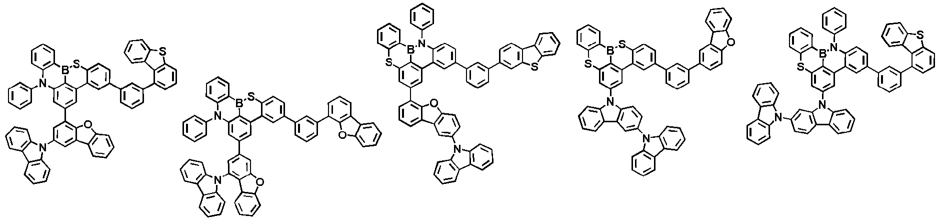

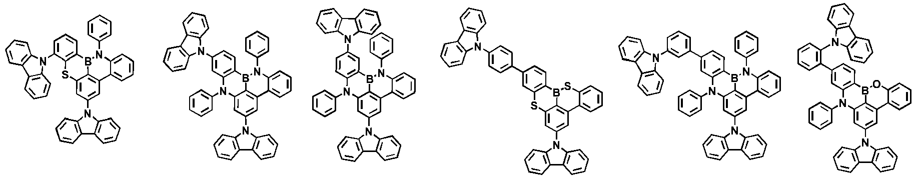

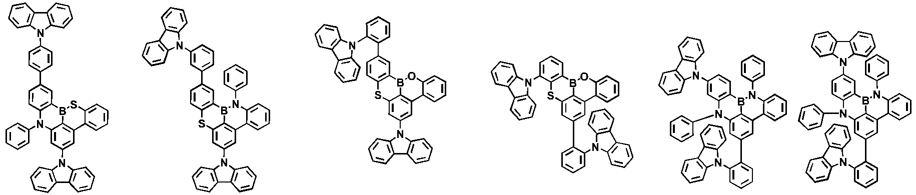

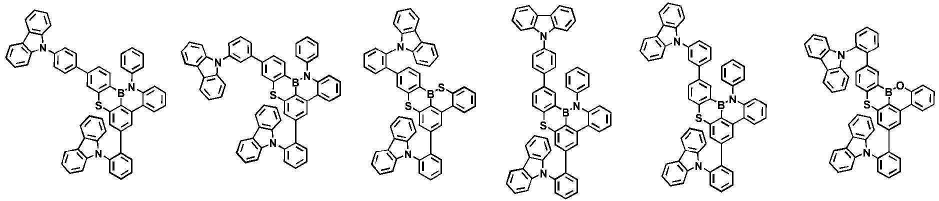

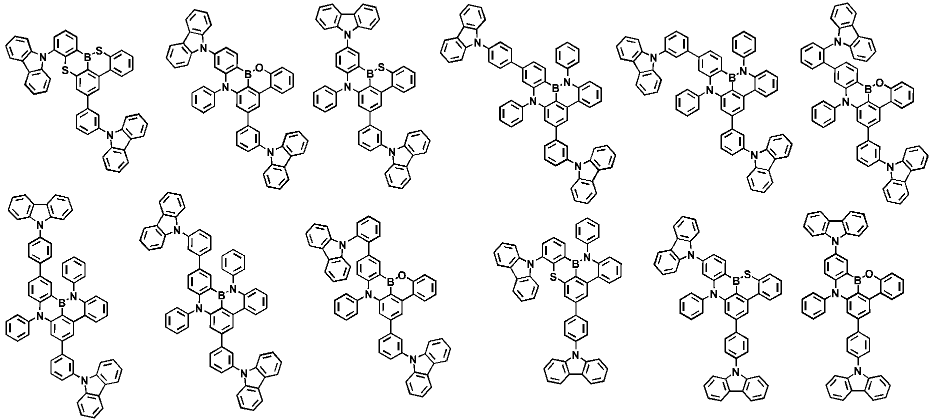

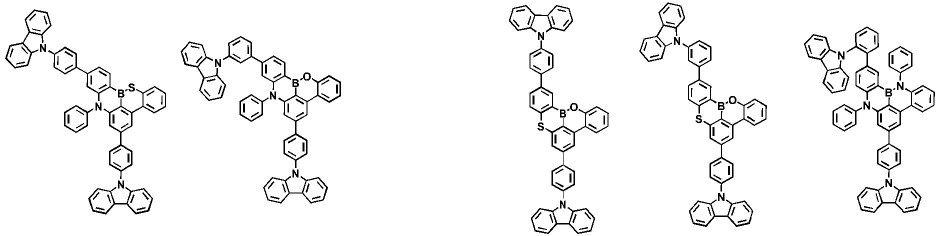

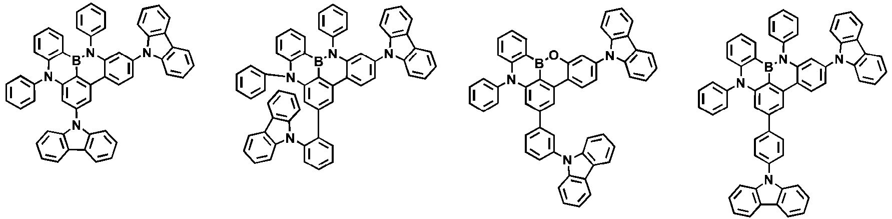

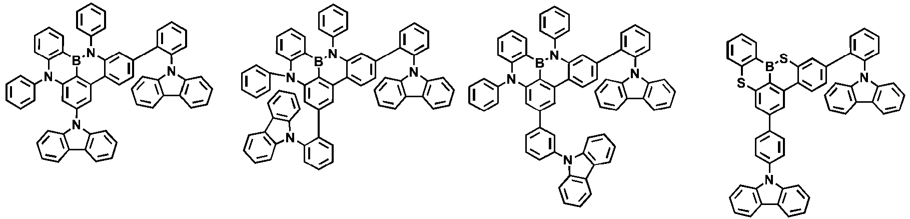

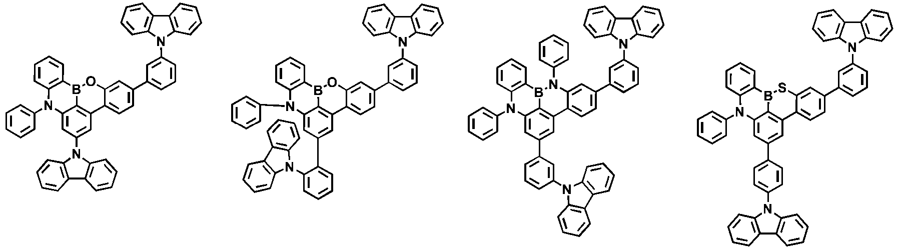

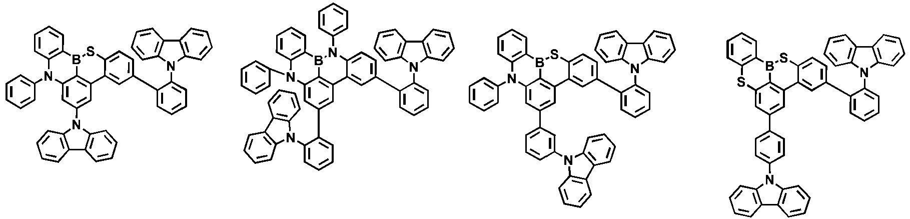

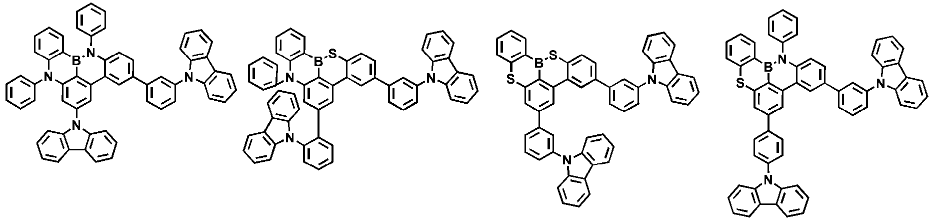

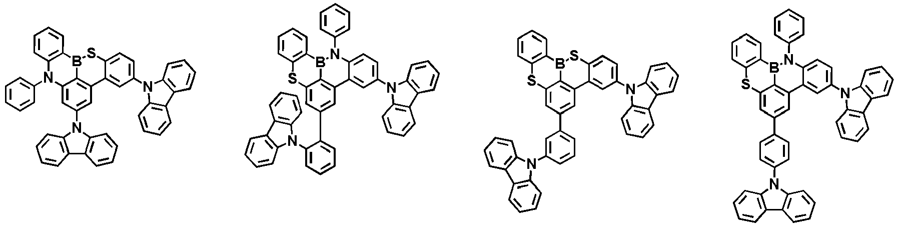

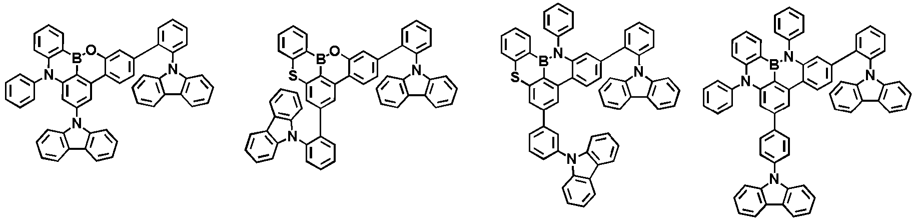

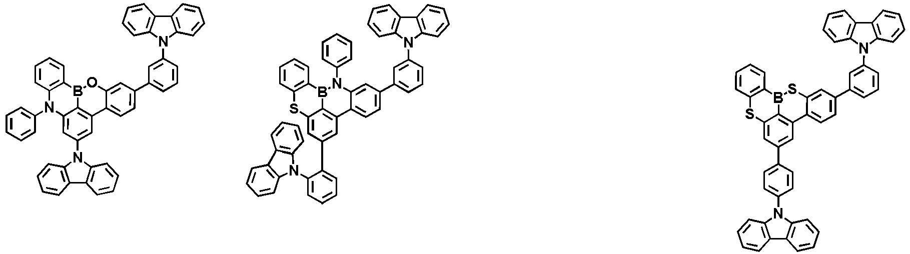

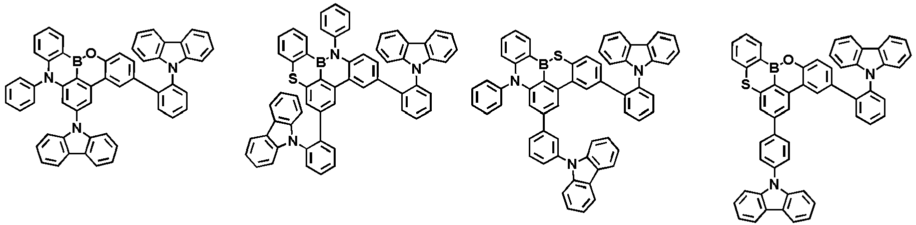

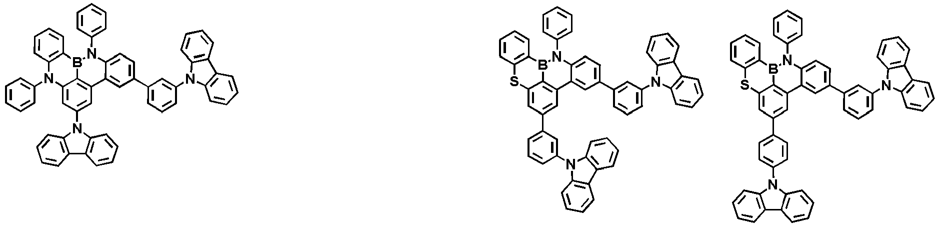

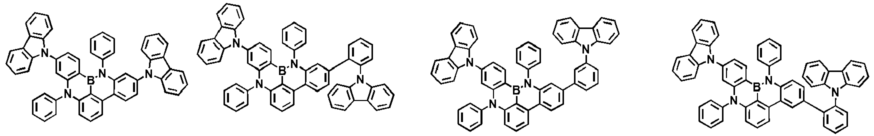

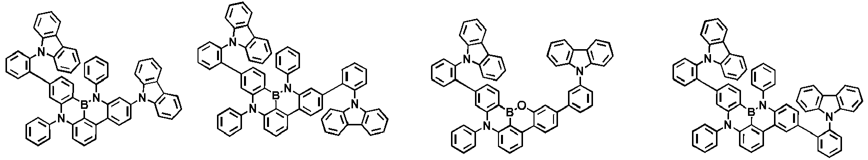

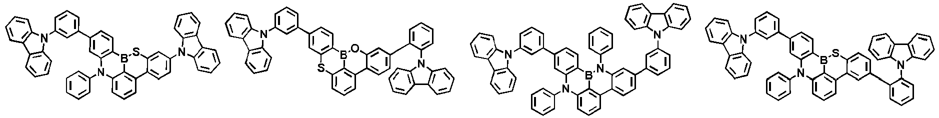

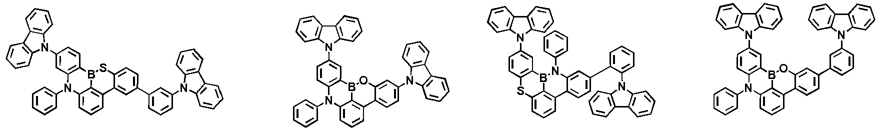

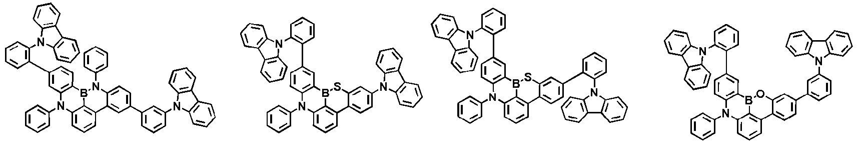

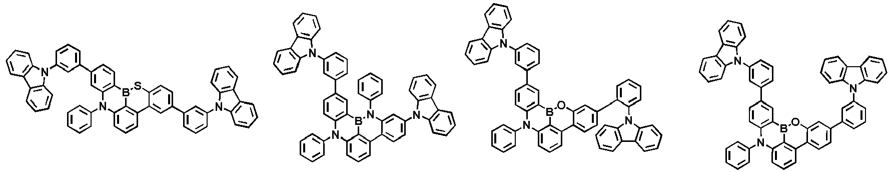

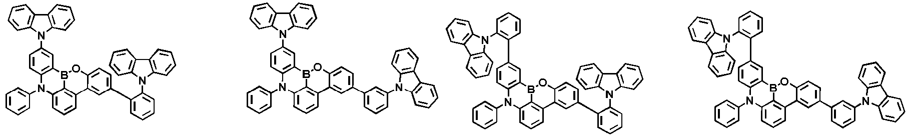

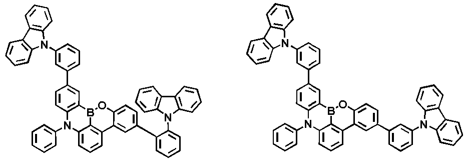

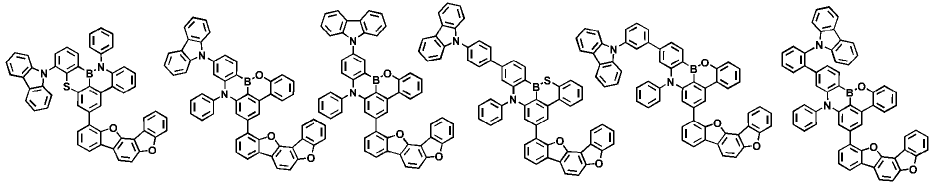

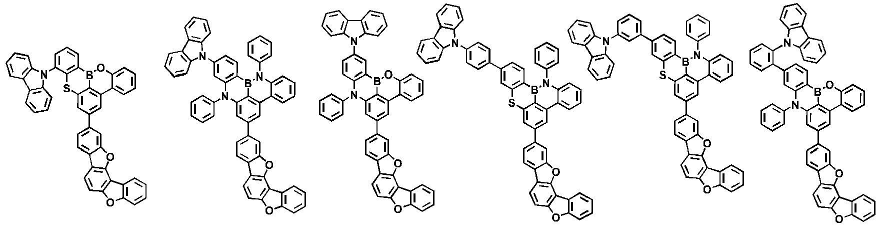

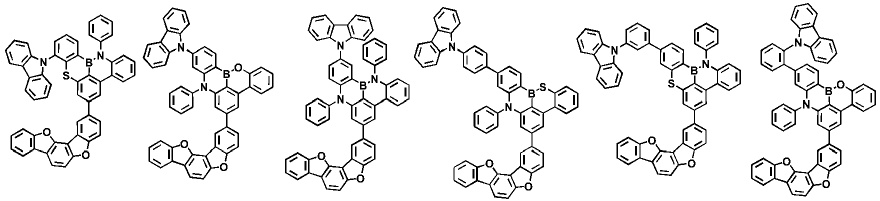

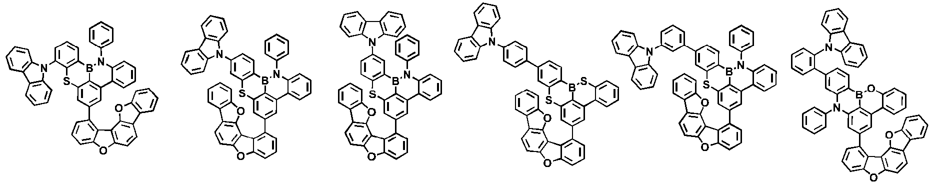

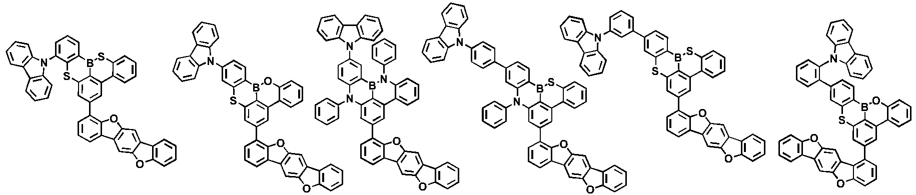

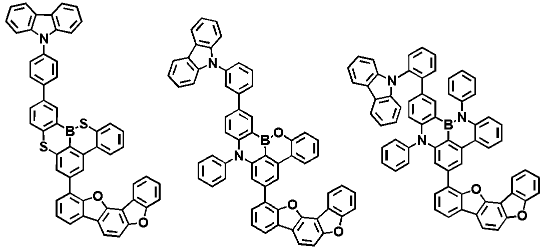

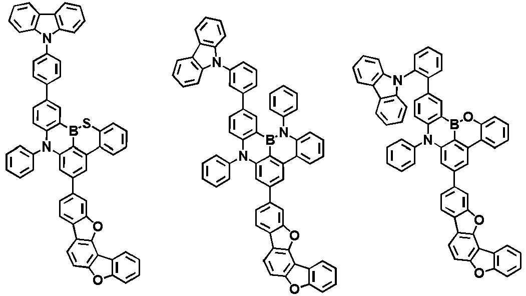

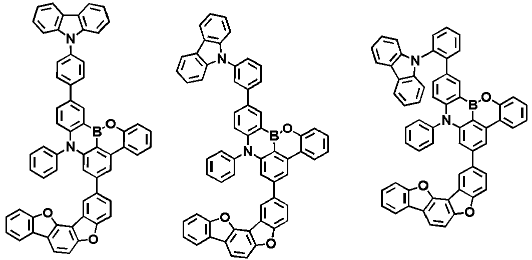

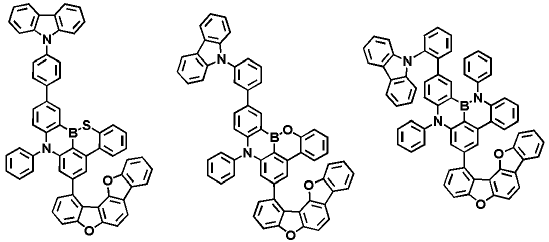

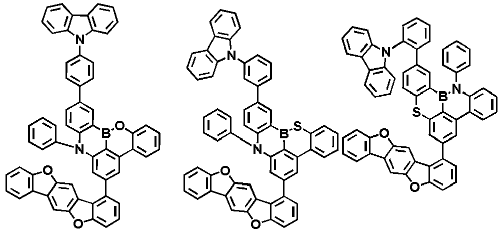

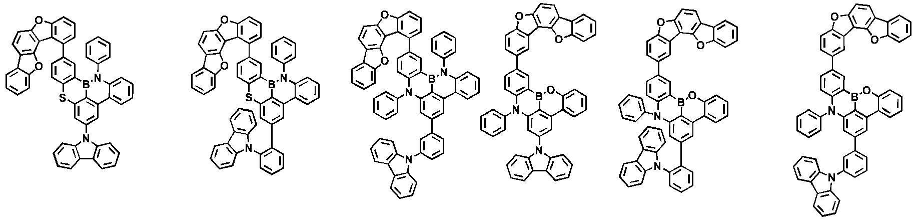

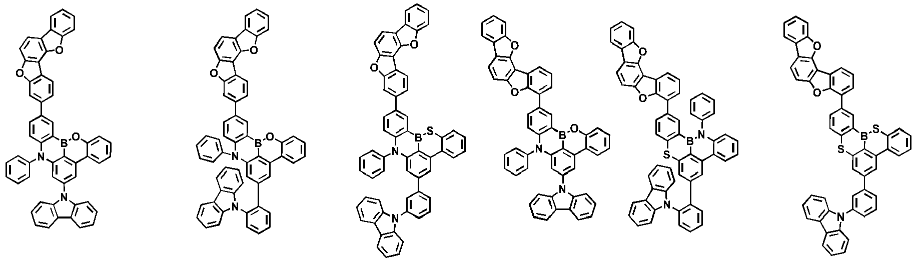

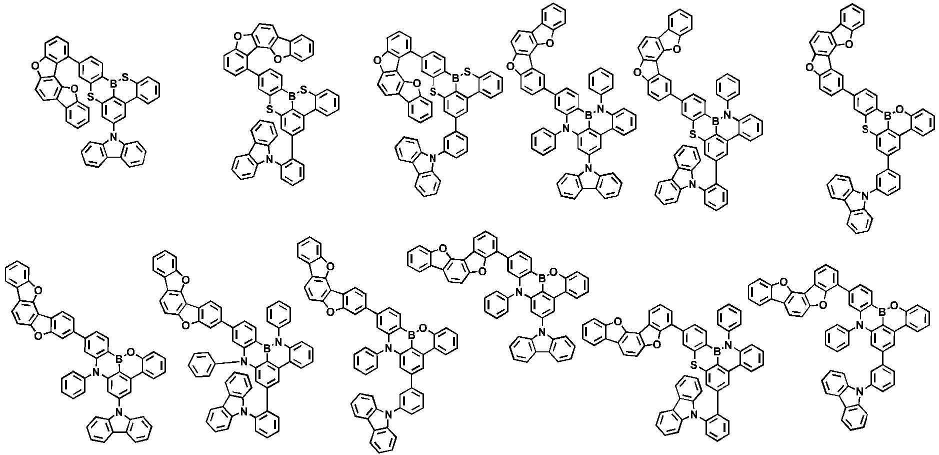

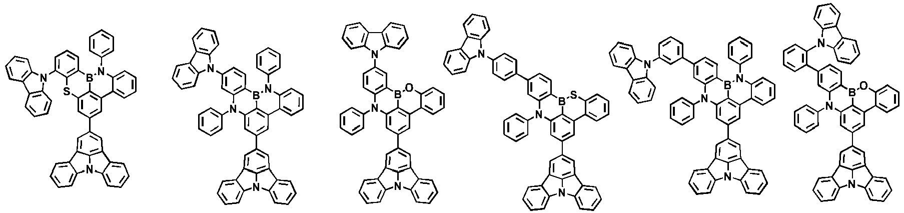

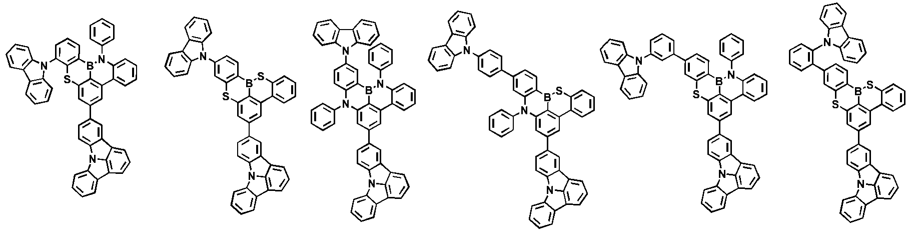

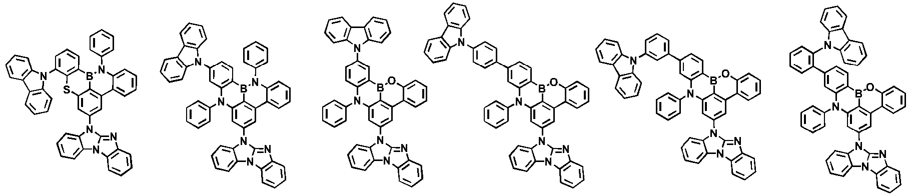

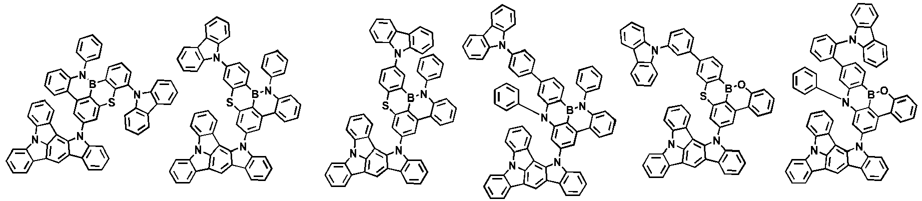

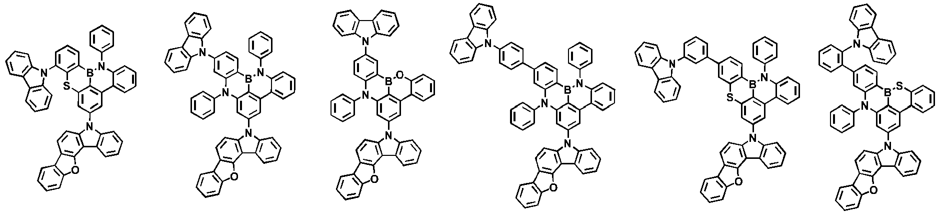

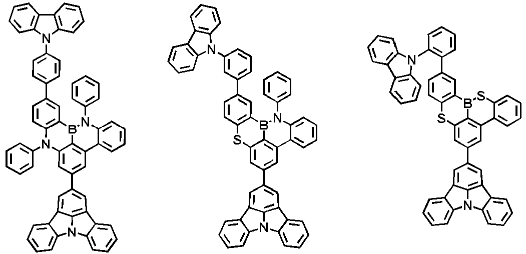

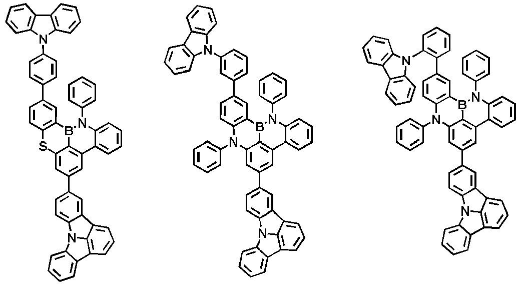

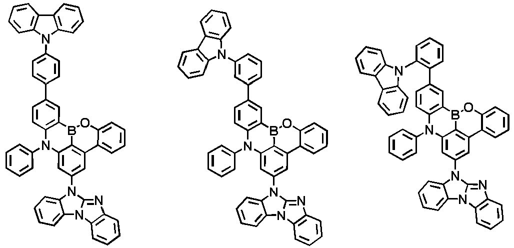

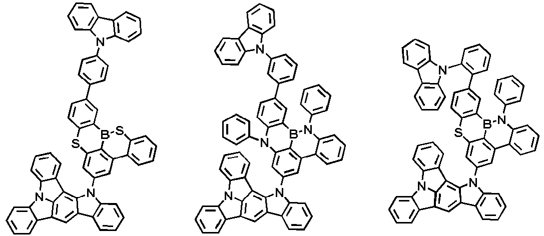

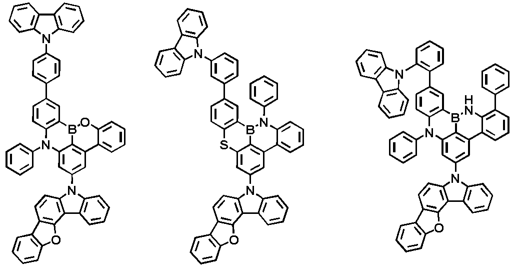

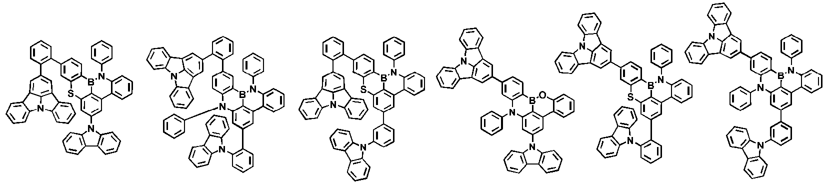

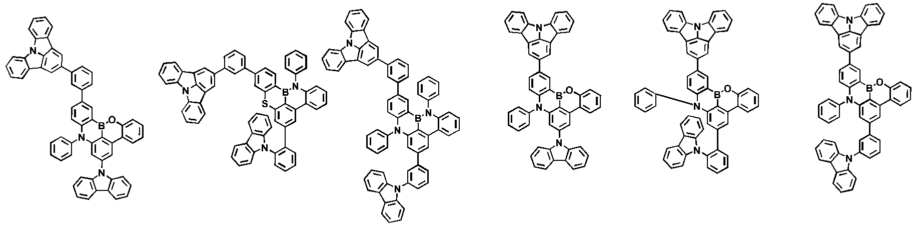

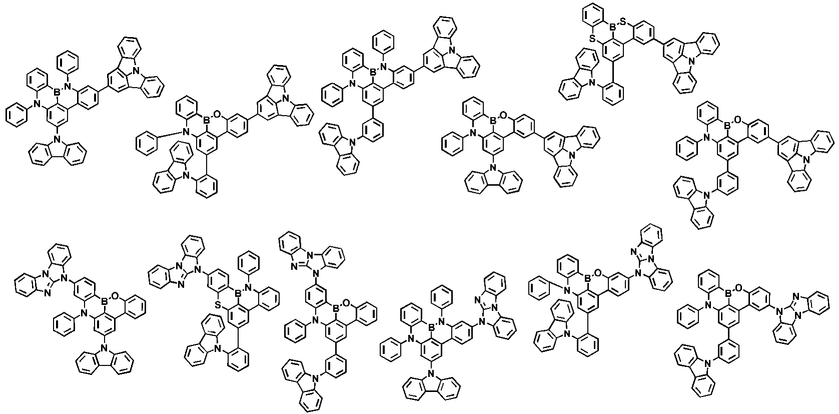

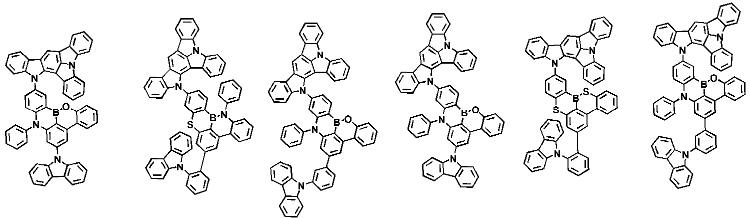

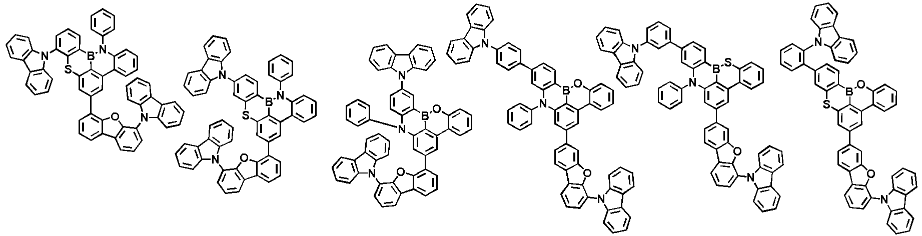

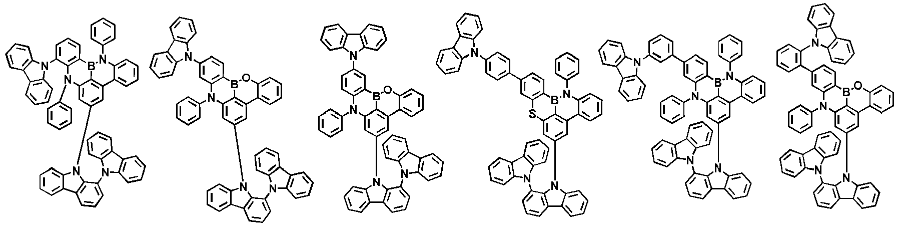

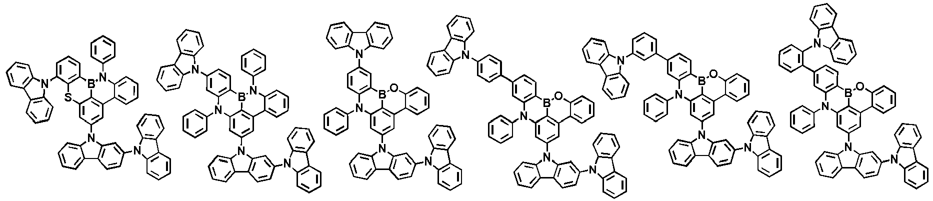

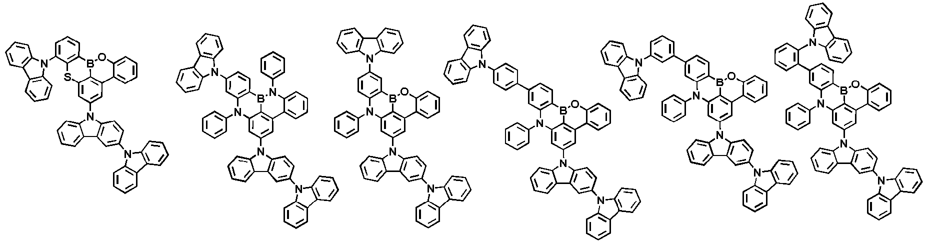

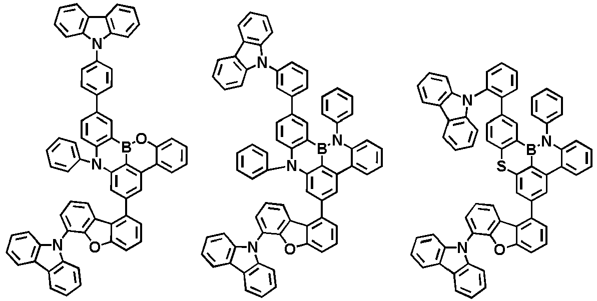

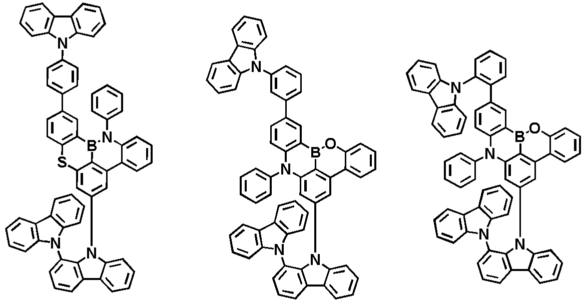

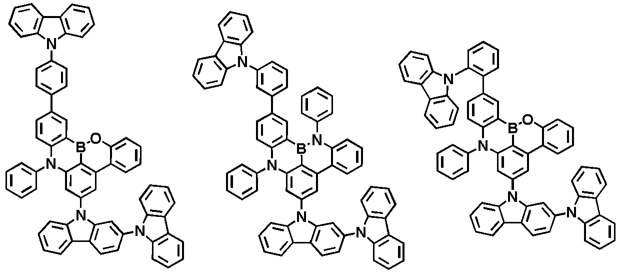

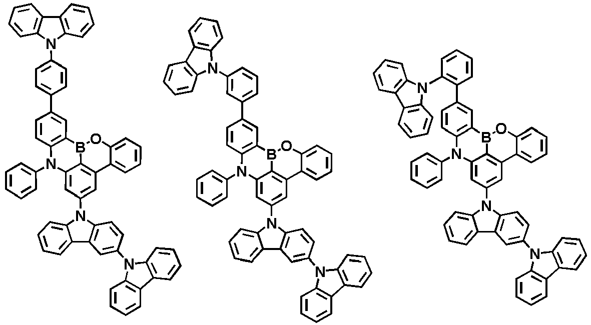

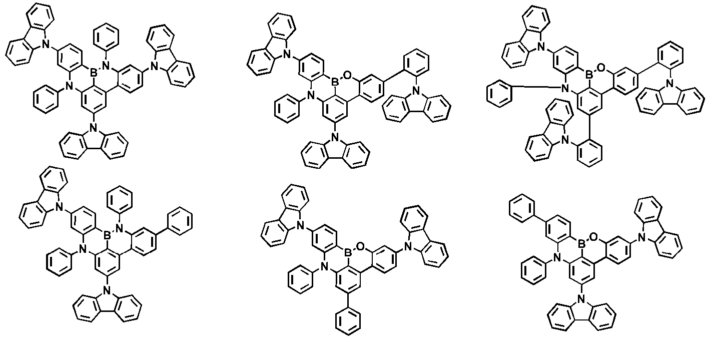

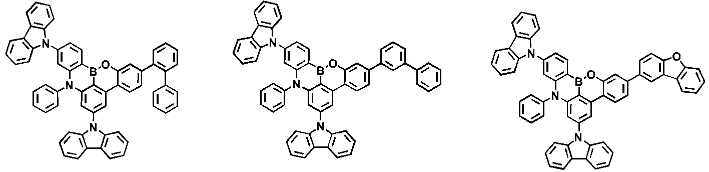

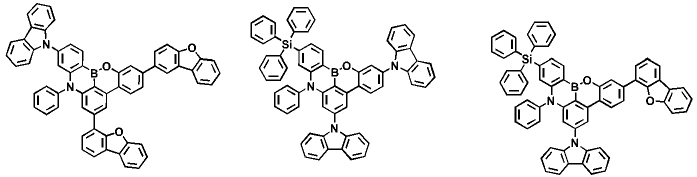

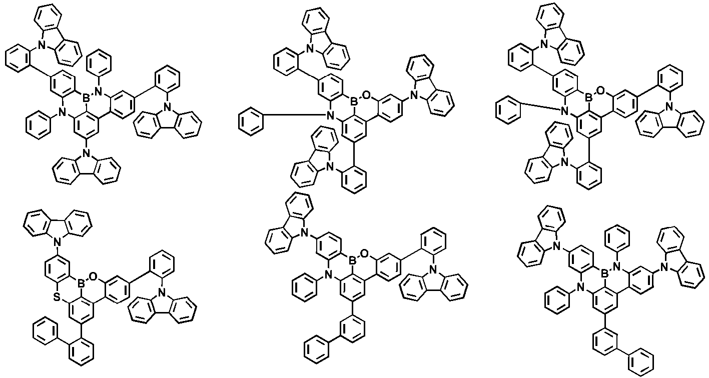

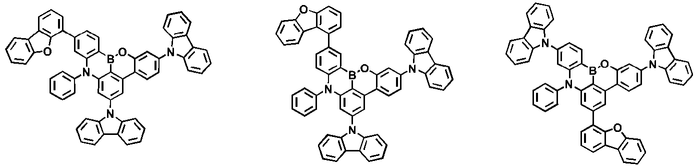

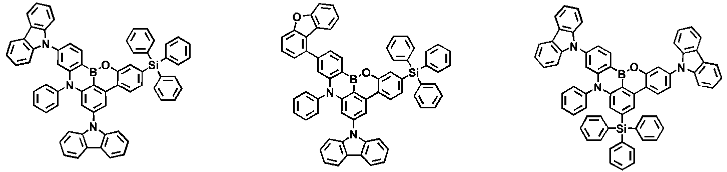

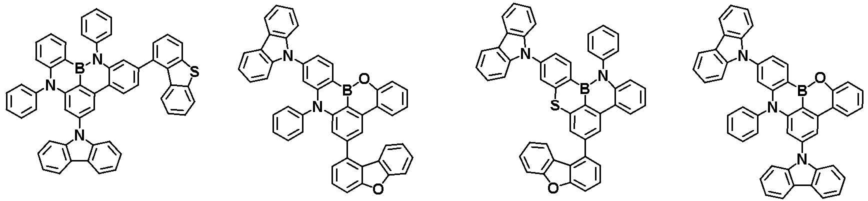

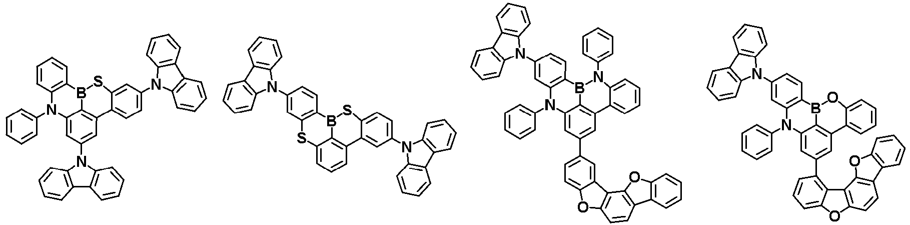

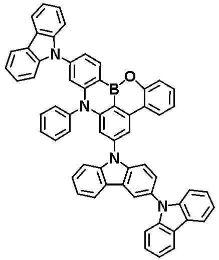

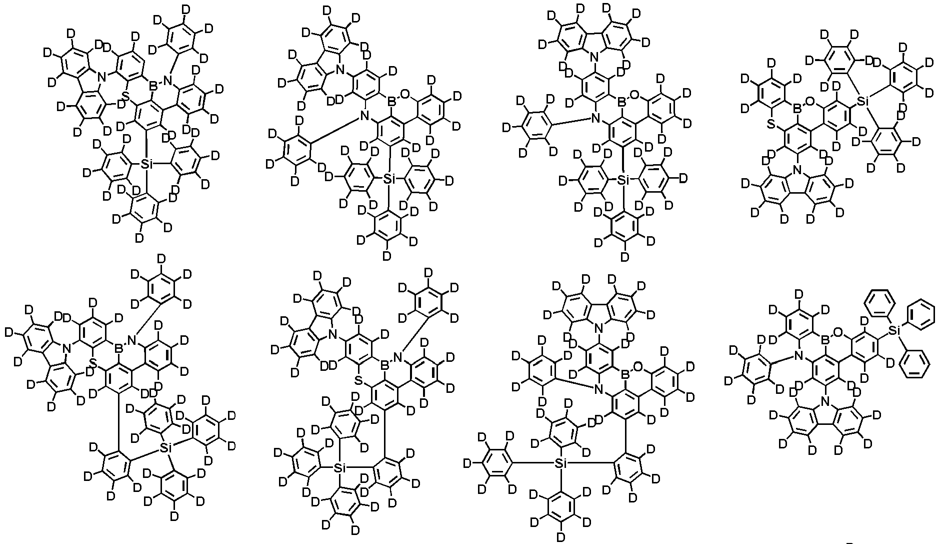

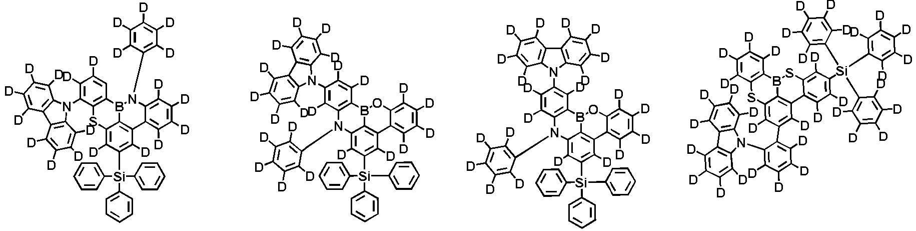

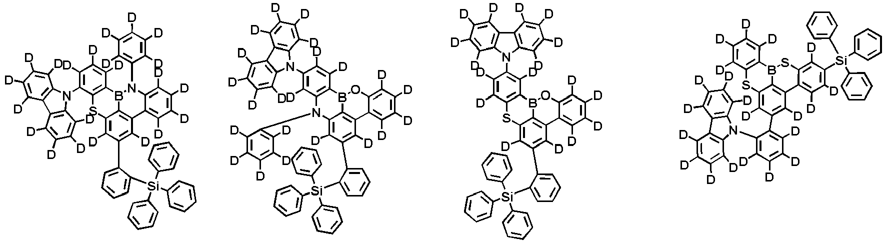

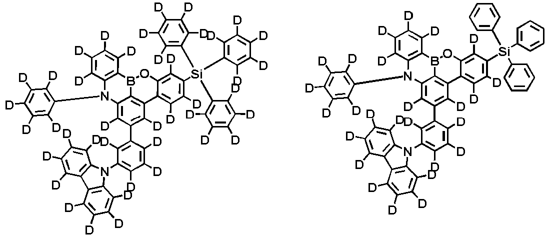

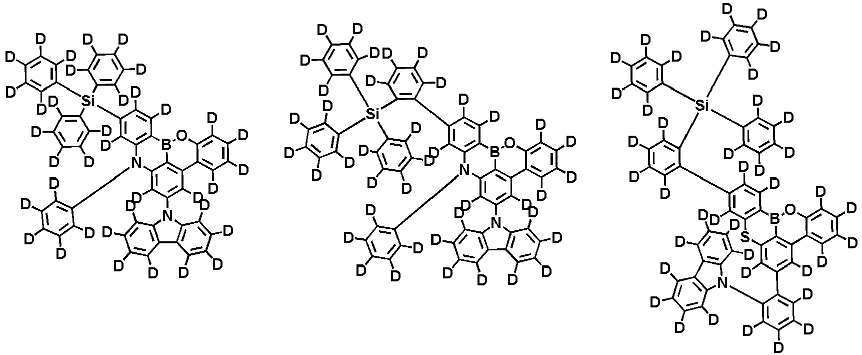

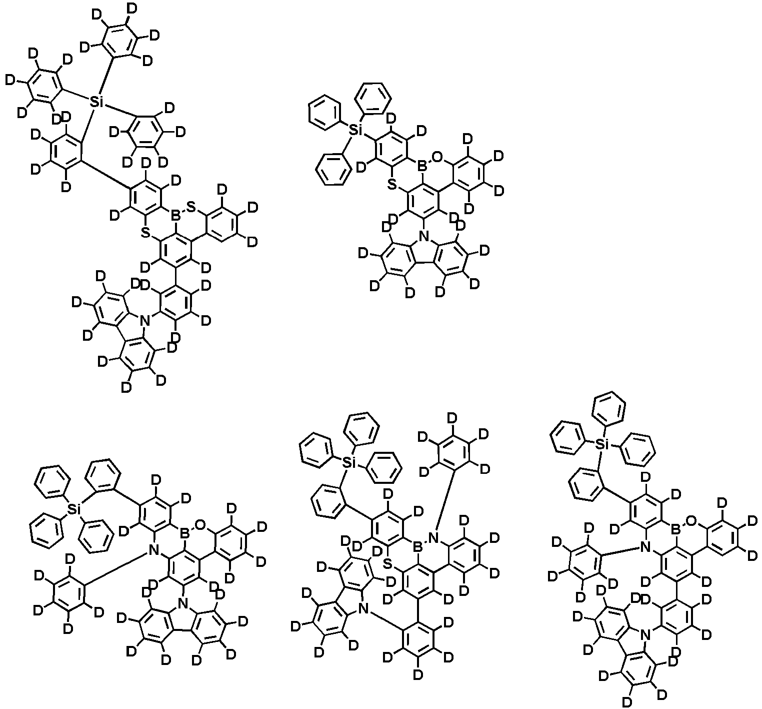

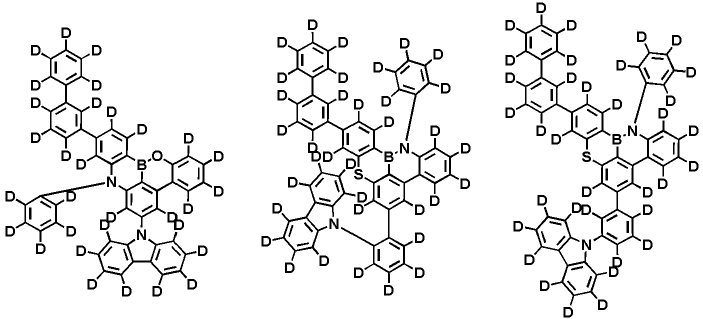

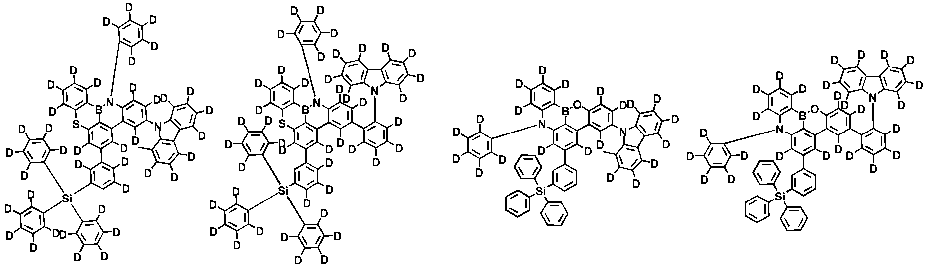

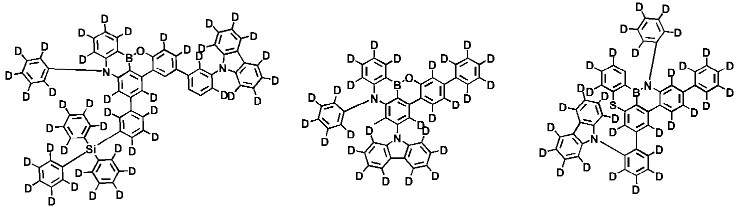

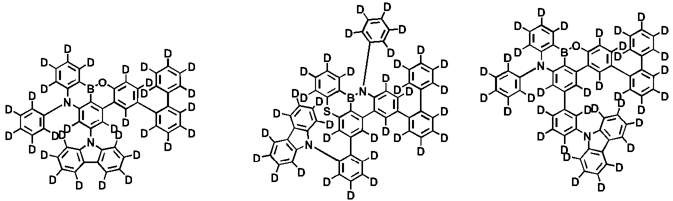

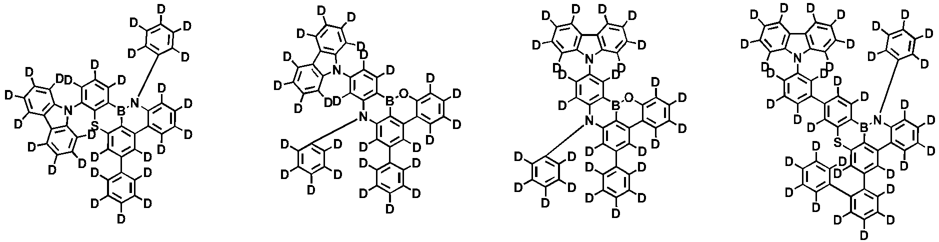

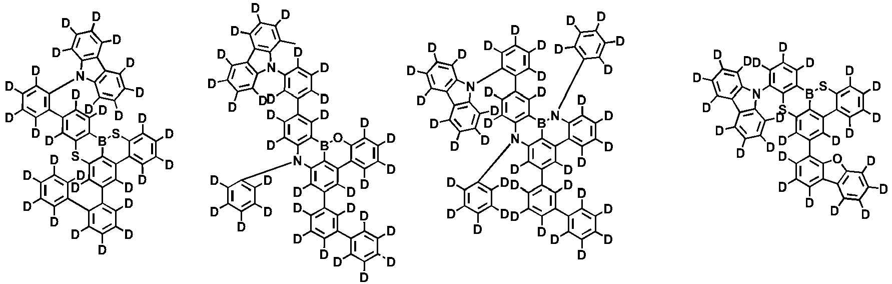

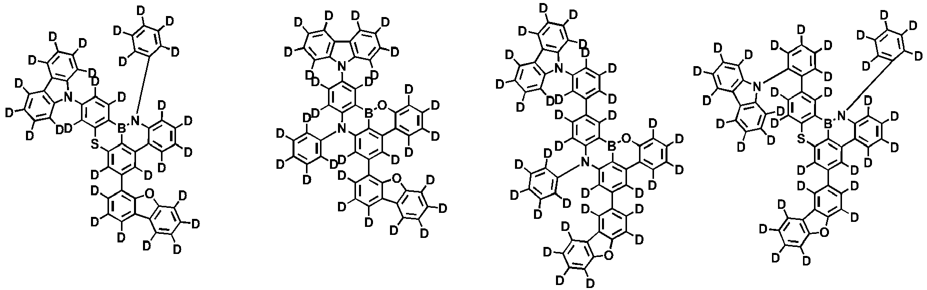

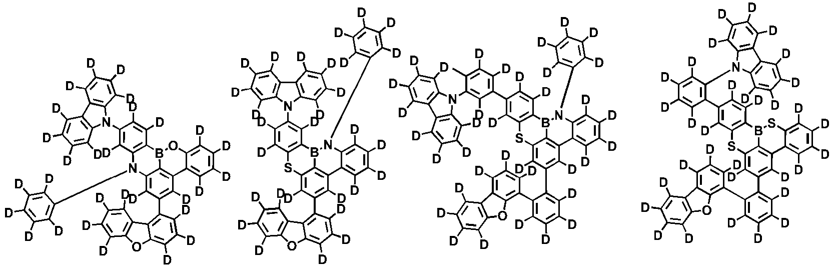

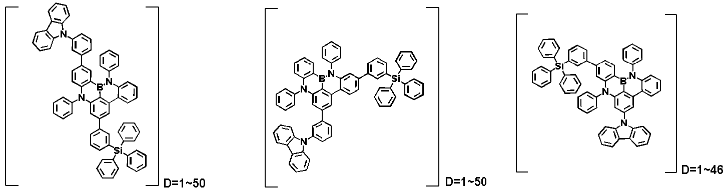

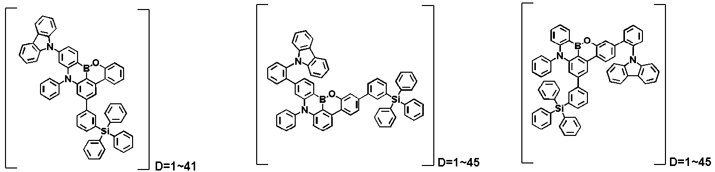

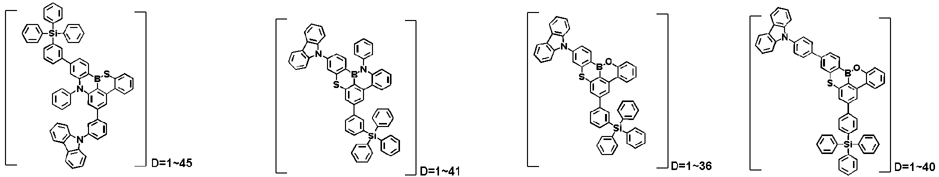

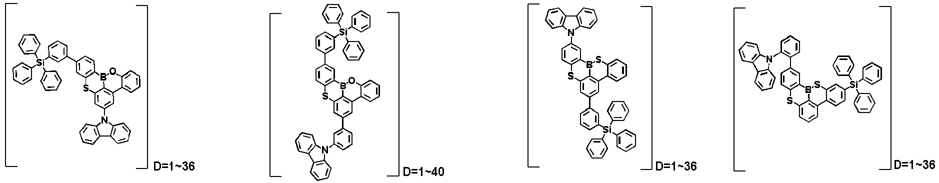

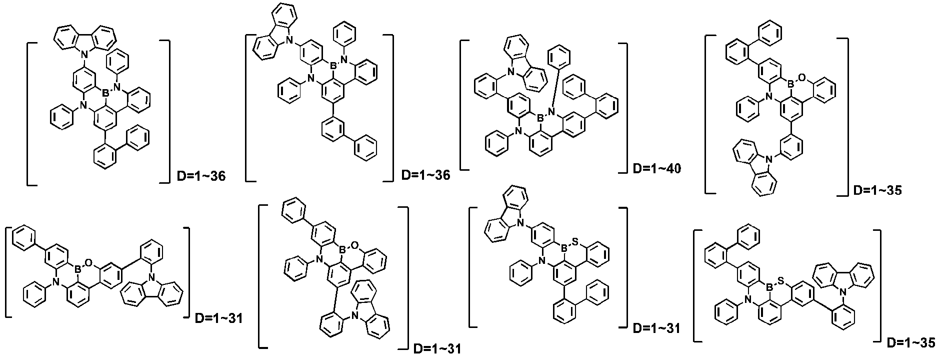

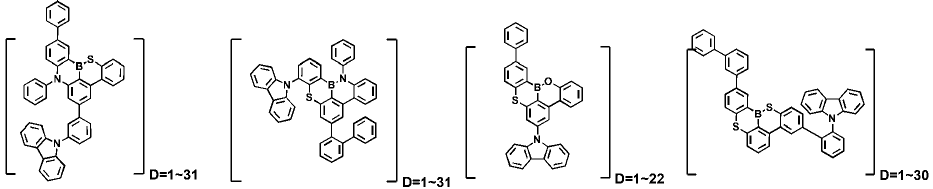

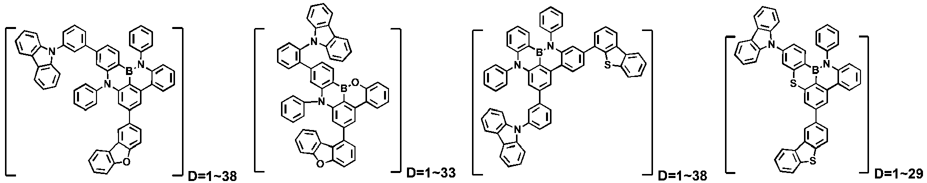

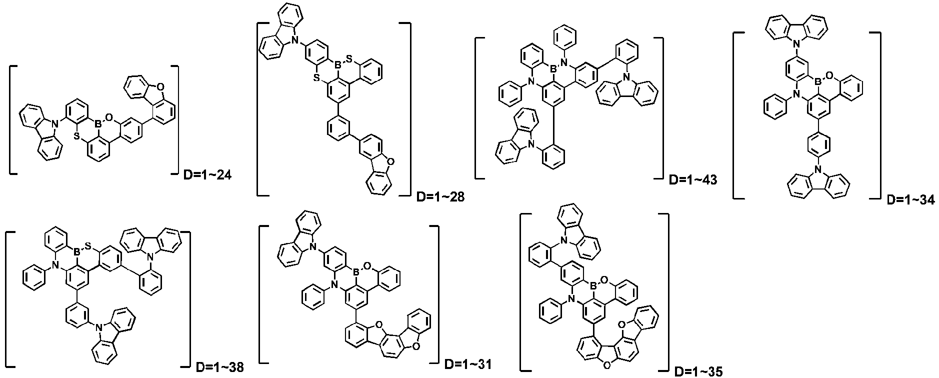

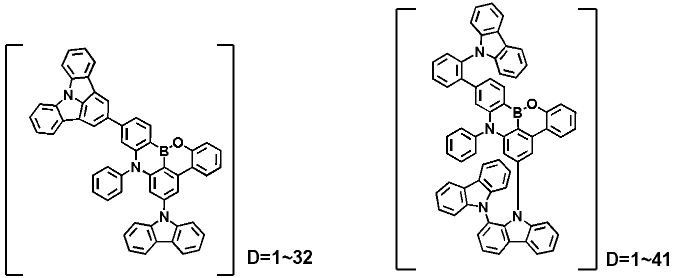

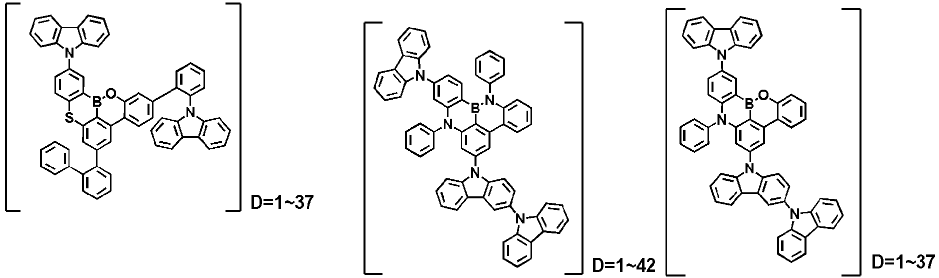

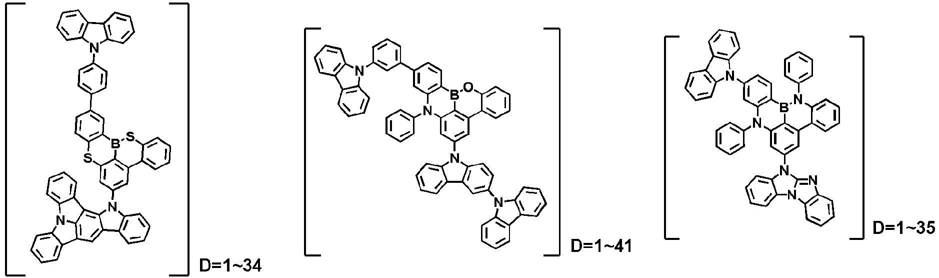

9. An organic light emitting device comprising:
a first electrode;
a second electrode; and
an organic material layer having one or more layers provided between the first electrode and the second electrode,
wherein one or more layers of the organic material layer comprise the compound of any one of claims 1 to 8.

10. The organic light emitting device of claim 9, wherein the organic material layer comprises one or more of an electron injection layer, an electron transport layer, an electron injection and transport layer, and a hole blocking layer, and one or more of the electron injection layer, the electron transport layer, the electron injection and transport layer, and the hole blocking layer comprise the compound.

11. The organic light emitting device of claim 9, wherein the organic material layer comprises a light emitting layer, and the light emitting layer comprises the compound.

12. The organic light emitting device of claim 9, wherein the organic material layer comprises a light emitting layer, and the light emitting layer comprises the compound as an n-type host and further comprises a p-type host.

13. The organic light emitting device of claim 9, wherein the organic material layer comprises a hole blocking layer, and the hole blocking layer comprises the compound.

14. The organic light emitting device of claim 9, wherein the organic material layer comprises a light emitting layer and a hole blocking layer, and the light emitting layer and the hole blocking layer comprise the compound.
